(19) Europäisches Patentamt
European Patent Office
Office européen des brevets

(11) EP 2 237 430 A2

(12) **EUROPEAN PATENT APPLICATION**

(43) Date of publication:
**06.10.2010 Bulletin 2010/40**

(21) Application number: **10167468.7**

(22) Date of filing: **26.11.2008**

(51) Int Cl.:
***H03M 13/27*** *(2006.01)* ***H04L 27/00*** *(2006.01)*
***H04L 1/00*** *(2006.01)* ***H04L 27/26*** *(2006.01)*

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**RS**

(30) Priority:
**26.11.2007 JP 2007304689**
**26.11.2007 JP 2007304690**
**18.03.2008 JP 2008070467**
**17.07.2008 JP 2008185605**
**05.11.2008 JP 2008284352**

(62) Document number(s) of the earlier application(s) in accordance with Art. 76 EPC:
**08854148.7 / 2 216 907**

(71) Applicant: **Sony Corporation**
**Minato-ku**
**Tokyo 108-0075 (JP)**

(72) Inventors:
- **Yokokawa, Takashi**
  **Minato-Ku Tokyo (JP)**
- **Yamamoto, Makiko**
  **Minato-Ku Tokyo (JP)**
- **Okada, Satoshi**
  **Minato-Ku Tokyo (JP)**
- **Ikegaya, Ryoji**
  **Minato-Ku Tokyo (JP)**

(74) Representative: **Robinson, Nigel Alexander Julian**
**D Young & Co LLP**
**120 Holborn**
**London EC1N 2DY (GB)**

Remarks:
This application was filed on 28-06-2010 as a divisional application to the application mentioned under INID code 62.

# (54) Data processing apparatus and data processing method

(57) The present invention relates to a data processing apparatus and a data processing method which can improve the tolerance to errors of data. A demultiplexer 25 replaces, in accordance with an allocation rule for allocating code bits of an LDPC code to symbol bits representative of symbols, mb bits from among the code bits and sets the code bits after the replacement as symbol bits of b symbols. For example, when m is 12 and b is 1, where the i+1th bits from the most significant bit of the $12 \times 1$ code bits and the $12 \times 1$ symbol bits of one symbol are represented as bits $b_i$ and $y_i$, replacement for allocating, for example, $b_0$ to $y_8$, $b_1$ to $y_0$, $b_2$ to $y_6$, $b_3$ to $y_1$, $b_4$ to $y_4$, $b_5$ to $y_5$, $b_6$ to $y_2$, $b_7$ to $y_3$, $b_8$ to $y_7$, bg to $y_{10}$, $b_{10}$ to $y_{11}$ and $b_{11}$ to $y_9$ is carried out. The present invention can be applied, for example, to a transmission system for transmitting an LDPC code and so forth.

FIG.7

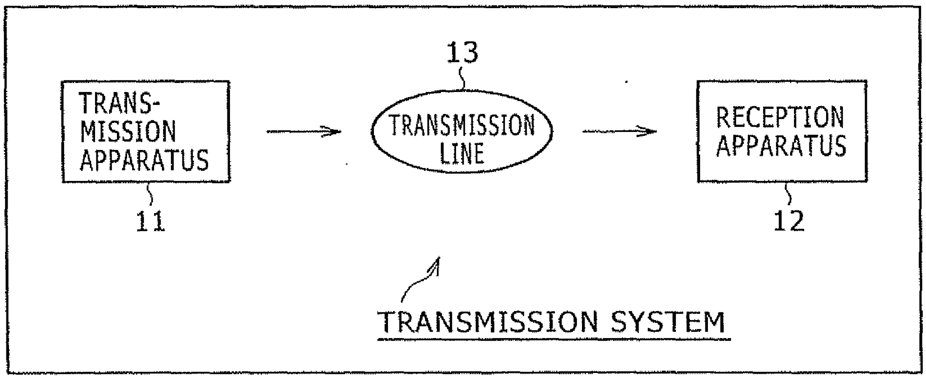


EP 2 237 430 A2

## Description

Technical Field

This invention relates to a data processing apparatus and a data processing method, and particularly to a data processing apparatus and a data processing method which make it possible to improve the tolerance to data errors, for example.

Background Art

The LDPC code has a high error correction capacity and, in recent years, begins to be adopted widely in transmission systems including satellite digital broadcasting systems such as, for example, the DVB (Digital Video Broadcasting)-S.2 system used in Europe (refer to, for example, Non-Patent Document 1). Further, it is investigated to adopt the LDPC code also in terrestrial digital broadcasting of the next generation.

It is being found by recent research that a performance proximate to the Shannon limit is provided by the LDPC code as the code length is increased similarly to a turbo code and so forth. Further, since the LDPC code has a property that the minimum distance increases in proportion to the code length, it has a characteristic that it has a superior block error probability characteristic. Also it is advantageous that a so-called error floor phenomenon which is observed in a decoding characteristic of the turbo code and so forth little occurs.

In the following, such an LDPC code as described above is described particularly. It is to be noted that the LDPC code is a linear code, and although it is not necessarily be a two-dimensional code, the following description is given under the assumption that it is a two-dimensional code.

The LDPC code has the most significant **characteristic in that** a parity check matrix which defines the LDPC code is a sparse matrix. Here, the sparse matrix is a matrix in which the number of those elements whose value is "1" is very small (matrix in which almost all elements are 0).

FIG. 1 shows an example of a parity check matrix H of an LDPC code.

In the parity check matrix H of FIG. 1, the weight of each column (column weight) (number of "1") (weight) is "3" and the weight of each row (row weight) is "6."

In encoding by LDPC codes (LDPC encoding), for example, a generator matrix G is produced based on a parity check matrix H and this generator matrix G is multiplied by two-dimensional information bits to produce a codeword (LDPC code).

In particular, an encoding apparatus which carries out LDPC encoding first calculates a generator matrix G which satisfies an expression $GH^T = 0$ together with a transposed matrix $H^T$ of a parity check matrix H. Here, if the generator matrix G is a $K \times N$ matrix, then the encoding apparatus multiplies the generator matrix G by a bit string (vector u) of K information bits to produce a codeword c (= uG) of N bits. The codeword (LDPC code) produced by the encoding apparatus is received by the reception side through a predetermined communication path.

Decoding of the LDPC code can be carried out using an algorithm proposed as probabilistic decoding (Probabilistic Decoding) by the Gallager, that is, a message passing algorithm by belief propagation on a so-called Tanner graph including a variable node (also called message node) and a check node. In the following description, each of the variable node and the check node is suitably referred to simply as node.

FIG. 2 illustrates a procedure of decoding of an LDPC code.

It is to be noted that, in the following description, a real number value where the "0" likelihood in the value of the nth code bit of an LDPC code (one codeword) received by the reception side is represented in a log likelihood ratio is suitably referred to as reception value $u_{oi}$. Further, a message outputted from a check node is represented by $u_j$ and a message outputted from a variable node is represented by $v_i$.

First, in decoding of an LDPC code, as seen in FIG. 2, an LDPC code is received and a message (check node message) $u_j$ is initialized to "0" and besides a variable k which assumes an integer as a counter of repeated processes is initialized to "0" at step S11, whereafter the processing advances to step S12. At step S12, mathematical operation represented by an expression (1) (variable node mathematical operation) is carried out based on the reception value $u_{oi}$ obtained by the reception of the LDPC code to determine a message (variable node message) $v_i$. Further, mathematical operation represented by an expression (2) (check node mathematical operation) is carried out based on the message $v_i$ to determine the message $u_j$.

[Expression 1]

$$v_i = u_{0i} + \sum_{j=1}^{d_v-1} u_j \qquad \cdots (1)$$

[Expression 2]

$$\tanh\left(\frac{u_j}{2}\right) = \prod_{i=1}^{d_c-1} \tanh\left(\frac{v_i}{2}\right) \qquad \cdots (2)$$

Here, $d_v$ and $d_c$ in the expression (1) and the expression (2) are parameters which can be selected arbitrarily and represent the number of "1s" in a vertical direction (column) and a horizontal direction (row) of the parity check matrix H. For example, in the case of a (3, 6) code, $d_v = 3$ and $d_c = 6$.

It is to be noted that, in the variable node mathematical operation of the expression (1) and the check node mathematical operation of the expression (2), the range of the mathematical operation is 1 to $d_v$ - 1 or 1 to $d_c$ - 1 because a massage inputted from an edge (line interconnecting a variable node and a check node) from which a message is to be outputted is not made an object of the mathematical operation. Meanwhile, the check node mathematical operation of the expression (2) is carried out by producing in advance a table of a function $R(v_1, v_2)$ represented by an expression (3) defined by one output with respect to two inputs $v_1$ and $v_2$ and using the table successively (recursively) as represented by an expression (4).

[Expression 3]

$$x = 2\tanh^{-1}\{\tanh(v_1/2)\tanh(v_2/2)\} = R(v_1, v_2) \qquad \cdots (3)$$

[Expression 4]

$$u_j = R(v_1, R(v_2, R(v_3, \ldots R(v_{d_c-2}, v_{d_c-1})))) \qquad \cdots (4)$$

At step S12, the variable k is incremented by "1" further, and the processing advances to step S13. At step S13, it is decided whether or not the variable k is higher than a predetermined repeated decoding time number C. If it is decided at step S13 that the variable k is not higher than C, then the processing returns to step S12, and similar processing is repeated thereafter.

On the other hand, if it is decided at step S13 that the variable k is higher than C, then the processing advances to step S14, at which a message $v_i$ as a decoding result to be outputted finally by carrying out mathematical operation represented by an expression (5) is determined and outputted, thereby ending the decoding process of the LDPC code.

[Expression 5]

$$v_i = u_{oi} + \sum_{j=1}^{d_v} u_j \qquad \ldots (5)$$

Here, the mathematical operation of the expression (5) is carried out, different from the variable node mathematical operation of the expression (1), using messages $u_j$ from all edges connecting to the variable node.

FIG. 3 illustrates an example of the parity check matrix H of a (3, 6) LDPC code (encoding rate: 1/2, code length: 12).

In the parity check matrix H of FIG. 3, the weight of a column is 3 and the weight of a row is 6 similarly as in FIG. 1.

FIG. 4 shows a Tanner graph of the parity check matrix H of FIG. 3.

Here, in FIG. 4, a check node is represented by "+," and a variable node is represented by "=." A check node and a variable node correspond to a row and a column of the parity check matrix H, respectively. A connection between a check node and a variable node is an edge and corresponds to "1" of an element of the parity check matrix.

In particular, where the element in the jth row of the ith column of the parity check matrix is 1, the ith variable node (node of "=") from above and the jth check node (node of "+") from above are connected by an edge. The edge represents that a code bit corresponding to the variable node has a constraint condition corresponding to the check node.

In the sum product algorithm (Sum Product Algorithm) which is a decoding method for LDPC codes, variable node mathematical operation and check node mathematical cooperation are carried out repetitively.

FIG. 5 illustrates the variable node mathematical operation carried out with regard to a variable node.

With regard to the variable node, a message $v_i$ corresponding to an edge to be calculated is determined by variable node mathematical operation of the expression (1) which uses messages $u_1$ and $u_2$ from the remaining edges connecting to the variable node and the reception value $u_{0i}$. Also a message corresponding to any other edge is determined similarly.

FIG. 6 illustrates the check node mathematical operation carried out at a check node.

Here, the check node mathematical operation of the expression (2) can be carried out by rewriting the expression (2) into an expression (6) using the relationship of an expression $a \times b = \exp\{\ln(|a|) + \ln(|b|)\} \times \mathrm{sign}(a) \times \mathrm{sign}(b)$. It is to be noted that sign(x) is 1 where $x \geq 0$ but is -1 where $x < 0$.

[Expression 6]

$$u_j = 2\tanh^{-1}\left(\prod_{i=1}^{d_c-1} \tanh\left(\frac{v_i}{2}\right)\right)$$

$$= 2\tanh^{-1}\left[\exp\left\{\sum_{i=1}^{d_c-1} In\left(\left|\tanh\left(\frac{v_i}{2}\right)\right|\right)\right\} \times \prod_{i=1}^{d_c-1} sign\left(\tanh\left(\frac{v_i}{2}\right)\right)\right]$$

$$= 2\tanh^{-1}\left[\exp\left\{-\left(\sum_{i=1}^{d_c-1} -In\left(\tanh\left(\frac{|v_i|}{2}\right)\right)\right)\right\}\right] \times \prod_{i=1}^{d_c-1} sign(v_i) \qquad \ldots (6)$$

Further, if, where $x \geq 0$, a function $\varphi(x)$ is defined as an expression $\varphi(x) = \ln(\tanh(x/2))$, then since an expression $\varphi^{-1}(x) = 2\tanh^{-1}(e^{-x})$ is satisfied, the expression (6) can be transformed into an expression (7).

[Expression 7]

$$u_j = \phi^{-1}\left(\sum_{i=1}^{d_c-1}\phi(|v_i|)\right) \times \prod_{i=1}^{d_c-1} sign(v_i) \qquad \cdots (7)$$

At the check node, the check node mathematical operation of the expression (2) is carried out in accordance with the expression (7).

In particular, at the check node, the message $u_j$ corresponding to the edge to be calculated is determined by check node mathematical operation of the expression (7) using messages $v_1$, $v_2$, $v_3$, $v_4$ and $v_5$ from the remaining edges connecting to the check node. Also a message corresponding to any other edge is determined in a similar manner.

It is to be noted that the function φ(x) of the expression (7) can be represented also as $\varphi(x) = \ln((e^x + 1)/(e^x - 1))$, and where x > 0, $\varphi(x) = \varphi^{-1}(x)$. When the functions φ(x) and $\varphi^{-1}(x)$ are incorporated in hardware, while they are sometimes incorporated using an LUT (Look Up Table), such LUTs become the same LUT.

Non-Patent Document 1: DVB-S.2: ETSI EN 302 307 V1.1.2 (2006-06)

Disclosure of Invention

Technical Problem

The LDPC code is adopted in DVB-S.2 which is a standard for satellite digital broadcasting and DVB-T.2 which is a standard for terrestrial digital broadcasting of the next generation. Further, it is planned to adopt the LDPC code in DVB-C.2 which is a standard for CATV (Cable Television) digital broadcasting of the next generation.

In digital broadcasting in compliance with a standard for DVB such as DVB-S.2, an LDPC code is converted (symbolized) into symbols of orthogonal modulation (digital modulation) such as QPSK (Quadrature Phase Shift Keying), and the symbols are mapped to signal points and transmitted.

In symbolization of an LDPC code, replacement of code bits of the LDPC code is carried out in a unit of two or more bits, and code bits after such replacement are determined as bits of a symbol.

As a method for replacement of code bits for symbolization of an LDPC code, various methods have been proposed. However, proposal of a new method which has an improved tolerance to errors is demanded.

The present invention has been made taking such a situation as described above into consideration and makes it possible to improve the tolerance of data of an LDPC code and so forth to errors.

Technical Solution

According to an aspect of the present invention, there is provided a data processing apparatus or a data processing method wherein: where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides a predetermined positive integer is represented by b, the storage means stores mb bits in the row direction and stores N/(mb) bits in the column direction; the code bits of the LDPC code being written in the column direction of the storage means and read out in the row direction; the data processing apparatus or the data processing method respectively including replacement means or a replacement step for replacing, where the mb code bits read out in the row direction of the storage means set as b symbols, the mb code bits such that the code bits after the replacement form the symbol bits representative of the symbols.

In the case that the LDPC code is an LDPC code which is prescribed in the DVB-S.2 or DVB-T.2 standard and which has a code length N of 64,800 bits and has an encoding rate of 5/6 or 9/10; the m bits are 12 bits while the integer b is 1; the 12 bits of the code bit are mapped as one symbol to ones of 4,096 signal points prescribed in 4096QAM; and the storage means has 12 columns to store 12 × 1 bits in the row direction and stores 64,800/(12 × 1) bits in the column direction; where the i+1th bit from the most significant bit of the 12 × 1 code bits read out in the row direction of the storage means is represented as bit $b_i$ and the i+1th bit from the most significant bit of the 12 × 1 symbol bits of one symbol is represented as bit $y_i$, replacement can be carried out for allocating the bit $b_0$ to the bit $y_8$, the bit $b_1$ to the bit $y_0$, the bit $b_2$ to the bit $y_6$, the bit $b_3$ to the bit $y_1$, the bit $b_4$ to the bit $y_4$, the bit $b_5$ to the bit $y_5$, the bit $b_6$ to the bit $y_2$, the bit $b_7$ to the bit $y_3$, the bit $b_8$ to the bit $y_7$, the bit $b_9$ to the bit $y_{10}$, the bit $b_{10}$ to the bit $y_{11}$, and the bit $b_{11}$ to the bit $y_9$, for

both of the LDPC code whose encoding rate is 5/6 and the LDPC code whose encoding rate is 9/10.

In the case that the LDPC code is an LDPC code which is prescribed in the DVB-S.2 or DVB-T.2 standard and which has a code length N of 64,800 bits and has an encoding rate of 5/6 or 9/10; the m bits are 12 bits while the integer b is 2; the 12 bits of the code bit are mapped as one symbol to ones of 4,096 signal points prescribed in 4096QAM; and the storage means has 24 columns for storing 12 × 2 bits in the row direction and stores 64,800/(12 × 2) bits in the column direction; where the i+1th bit from the most significant bit of the 12 × 2 code bits read out in the row direction of the storage means is represented as bit $b_i$ and the i+1th bit from the most significant bit of the 12 × 2 symbol bits of two successive symbols is represented as bit $y_i$, replacement can be carried out for allocating the bit $b_0$ to the bit $y_8$, the bit $b_2$ to the bit $y_0$, the bit $b_4$ to the bit $y_6$, the bit $b_6$ to the bit $y_1$, the bit $b_8$ to the bit $y_4$, the bit $b_{10}$ to the bit $y_5$, the bit $b_{12}$ to the bit $y_2$, the bit $b_{14}$ to the bit $y_3$, the bit $b_{16}$ to the bit $y_7$, the bit $b_{18}$ to the bit $y_{10}$, the bit $b_{20}$ to the bit $y_{11}$, the bit $b_{22}$ to the bit $y_9$, the bit $b_1$ to the bit $y_{20}$, the bit $b_3$ to the bit $y_{12}$, the bit $b_5$ to the bit $y_{18}$, the bit $b_7$ to the bit $y_{13}$, the bit $b_9$ to the bit $y_{16}$, the bit $b_{11}$ to the bit $y_{17}$, the bit $b_{13}$ to the bit $y_{14}$, the bit $b_{15}$ to the bit $y_{15}$, the bit $b_{17}$ to the bit $y_{19}$, the bit $b_{19}$ to the bit $y_{22}$, the bit $b_{21}$ to the bit $y_{23}$, and the bit $b_{23}$ to the bit $y_{21}$, for both of the LDPC code whose encoding rate is 5/6 and the LDPC code whose encoding rate is 9/10.

In the case that the LDPC code is an LDPC code which is prescribed in the DVB-S.2 or DVB-T.2 standard and which has a code length N of 16,200 bits and has an encoding rate of 3/4, 5/6 or 8/9, or which has a code length N of 64,800 bits and has an encoding rate of 3/4, 5/6 or 9/10; the m bits are 10 bits while the integer b is 2; the 10 bits of the code bit are mapped as one symbol to ones of 1,024 signal points prescribed in 1024QAM; and the storage means has 20 columns for storing 10 × 2 bits in the row direction and stores N/(10 × 2) bits in the column direction; where the i+1th bit from the most significant bit of the 10 × 2 code bits read out in the row direction of the storage means is represented as bit $b_i$ and the i+1th bit from the most significant bit of the 10 × 2 symbol bits of two successive symbols is represented as bit $y_i$, replacement can be carried out for allocating the bit $b_0$ to the bit $y_8$, the bit $b_1$ to the bit $y_3$, the bit $b_2$ to the bit $y_7$, the bit $b_3$ to the bit $y_{10}$, the bit $b_4$ to the bit $y_{19}$, the bit $b_5$ to the bit $y_4$, the bit $b_6$ to the bit $y_9$, the bit $b_7$ to the bit $y_5$, the bit $b_8$ to the bit $y_{17}$, the bit $b_9$ to the bit $y_6$, the bit $b_{10}$ to the bit $y_{14}$, the bit $b_{11}$, to the bit $y_{11}$, the bit $b_{12}$ to the bit $y_2$, the bit $b_{13}$ to the bit $y_{18}$, the bit $b_{14}$ to the bit $y_{16}$, the bit $b_{15}$ to the bit $y_{15}$, the bit $b_{16}$ to the bit $y_0$, the bit $b_{17}$ to the bit $y_1$, the bit $b_{18}$ to the bit $y_{13}$, and the bit $b_{19}$ to the bit $y_{12}$, for both of the LDPC code which has a code length N of 16,200 bits and encoding rate is 3/4, 5/6 or 8/9, or the LDPC code which has a code length N of 64,800 bits and encoding rate is 3/4, 5/6 or 9/10.

In the case that the LDPC code is an LDPC code which is prescribed in the DVB-S.2 or DVB-T.2 standard and which has a code length N of 16,200 bits and has an encoding rate of 5/6 or 8/9, or which has a code length N of 64,800 bits and has an encoding rate of 5/6 or 9/10; the m bits are 12 bits while the integer b is 2; the 12 bits of the code bit are mapped as one symbol to ones of 4,096 signal points prescribed in 4096QAM; and the storage means has 24 columns for storing 12 × 2 bits in the row direction and stores N/(12 × 2) bits in the column direction; where the i+1th bit from the most significant bit of the 12 × 2 code bits read out in the row direction of the storage means is represented as bit $b_i$ and the i+1th bit from the most significant bit of the 12 × 2 symbol bits of two successive symbols is represented as bit $y_i$, replacement can be carried out for allocating the bit $b_1$ to the bit $y_{10}$, the bit $b_1$ to the bit $y_{15}$, the bit $b_2$ to the bit $y_4$, the bit $b_3$ to the bit $y_{19}$, the bit $b_4$ to the bit $y_{21}$, the bit $b_5$ to the bit $y_{16}$, the bit $b_6$ to the bit $y_{23}$, the bit $b_7$ to the bit $y_{18}$, the bit $b_8$ to the bit $y_{11}$, the bit $b_9$ to the bit $y_{14}$, the bit $b_{10}$ to the bit $y_{22}$, the bit $b_{11}$ to the bit $y_5$, the bit $b_{12}$ to the bit $y_6$, the bit $b_{13}$ to the bit $y_{17}$, the bit $b_{14}$ to the bit $y_{13}$, the bit $b_{15}$ to the bit $y_{20}$, the bit $b_{16}$ to the bit $y_1$, the bit $b_{17}$ to the bit $y_3$, the bit $b_{18}$ to the bit $y_9$, the bit $b_{19}$ to the bit $y_2$, the bit $b_{20}$ to the bit $y_7$, the bit $b_{21}$ to the bit $y_8$, the bit $b_{22}$ to the bit $y_{12}$, and the bit $b_{23}$ to the bit $y_0$, for both of the LDPC code which has a code length N of 16,200 bits and encoding rate is 5/6 or 8/9, or the LDPC code which has a code length N of 64,800 bits and encoding rate is 5/6 or 9/10.

In the one aspect of the present invention, code bits of an LDPC (Low Density Parity Check) code whose code length is N bits are written in the column direction of the storage means and then read out in the row direction, and mb code bits read out in the row direction of the storage means are set as b symbols. Thereupon, the mb code bits are replaced in such a manner as described above, and the code bits after the replacement are determined as the symbol bits.

It is to be noted that the data processing apparatus may be an independent apparatus or may be an internal block which composes one apparatus. Advantageous Effect

According to the present invention, the tolerance to errors can be improved.

Brief Description of Drawings

[FIG. 1] FIG. 1 is a view illustrating a parity check matrix H of an LDPC code.
[FIG. 2] FIG. 2 is a flow chart illustrating a decoding procedure of an LDPC code.
[FIG. 3] FIG. 3 is a view illustrating an example of a parity error matrix of an LDPC code.
[FIG. 4] FIG. 4 is a view showing a Tanner graph of a parity check matrix.

[FIG. 5] FIG. 5 is a view showing a variable node.

[FIG. 6] FIG. 6 is a view showing a check node.

[FIG. 7] FIG. 7 is a view showing an example of a configuration of an embodiment of a transmission system to which the present invention is applied.

[FIG. 8] FIG. 8 is a block diagram showing an example of a configuration of a transmission apparatus 11.

[FIG. 9] FIG. 9 is a view illustrating a parity check matrix.

[FIG. 10] FIG. 10 is a view illustrating a parity matrix.

[FIG. 11] FIG. 11 is a view illustrating a parity check matrix of an LDPC code and column weights prescribed in the DVB-S.2 standard.

[FIG. 12] FIG. 12 is a view illustrating a signal point arrangement of 16QAM.

[FIG. 13] FIG. 13 is a view illustrating a signal point arrangement of 64QAM.

[FIG. 14] FIG. 14 is a view illustrating a signal point arrangement of 64QAM.

[FIG. 15] FIG. 15 is a view illustrating a signal point arrangement of 64QAM.

[FIG. 16] FIG. 16 is a view illustrating processing of a demultiplexer 25.

[FIG. 17] FIG. 17 is a view illustrating processing of the demultiplexer 25.

[FIG. 18] FIG. 18 is a view showing a Tanner graph regarding decoding of an LDPC code.

[FIG. 19] FIG. 19 is a view showing a parity matrix $H_T$ having a staircase structure and a Tanner graph corresponding to the parity matrix $H_T$.

[FIG. 20] FIG. 20 is a view showing the parity matrix $H_T$ of a parity check matrix H corresponding to the LDPC code after parity interleaving.

[FIG. 21] FIG. 21 is a view illustrating a conversion parity check matrix.

[FIG. 22] FIG. 22 is a view illustrating processing of a column twist interleaver 24.

[FIG. 23] FIG. 23 is a view illustrating column numbers of a memory 31 necessary for the column twist interleaving and addresses of writing starting positions.

[FIG. 24] FIG. 24 is a view illustrating column numbers of the memory 31 necessary for the column twist interleaving and addresses of writing starting positions.

[FIG. 25] FIG. 25 is a flow chart illustrating a transmission process.

[FIG. 26] FIG. 26 is a view showing a model of a communication path adopted in a simulation.

[FIG. 27] FIG. 27 is a view illustrating a relationship between an error rate obtained by the simulation and a Doppler frequency $f_d$ of a flutter.

[FIG. 28] FIG. 28 is a view illustrating a relationship between an error rate obtained by the simulation and a Doppler frequency $f_d$ of a flutter.

[FIG. 29] FIG. 29 is a block diagram showing an example of a configuration of an LDPC encoding section 21.

[FIG. 30] FIG. 30 is a flow chart illustrating a process of LDPC encoding section.

[FIG. 31] FIG. 31 is a view illustrating a parity check matrix initial value table of an encoding rate of 2/3 and a code length of 16,200.

[FIG. 32] FIG. 32 is a view illustrating a parity check matrix initial value table of an encoding rate of 2/3 and a code length of 64,800.

[FIG. 33] FIG. 33 is a view illustrating the parity check matrix initial value table of the encoding rate of 2/3 and the code length of 64,800.

[FIG. 34] FIG. 34 is a view illustrating the parity check matrix initial value table of the encoding rate of 2/3 and the code length of 64,800.

[FIG. 35] FIG. 35 is a view illustrating a parity check matrix initial value table of an encoding rate of 3/4 and a code length of 16,200.

[FIG. 36] FIG. 36 is a view illustrating a parity check matrix initial value table of an encoding rate of 3/4 and a code length of 64,800.

[FIG. 37] FIG. 37 is a view illustrating the parity check matrix initial value table of the encoding rate of 3/4 and the code length of 64,800.

[FIG. 38] FIG. 38 is a view illustrating the parity check matrix initial value table of the encoding rate of 3/4 and the code length of 64,800.

[FIG. 39] FIG. 39 is a view illustrating the parity check matrix initial value table of the encoding rate of 3/4 and the code length of 64,800.

[FIG. 40] FIG. 40 is a view illustrating a parity check matrix initial value table of an encoding rate of 4/5 and a code length of 16,200.

[FIG. 41] FIG. 41 is a view illustrating a parity check matrix initial value table of an encoding rate of 4/5 and a code length of 64,800.

[FIG. 42] FIG. 42 is a view illustrating the parity check matrix initial value table of the encoding rate of 4/5 and the code length of 64,800.

[FIG. 43] FIG. 43 is a view illustrating the parity check matrix initial value table of the encoding rate of 4/5 and the code length of 64,800.
[FIG. 44] FIG. 44 is a view illustrating the parity check matrix initial value table of the encoding rate of 4/5 and the code length of 64,800.
[FIG. 45] FIG. 45 is a view illustrating a parity check matrix initial value table of an encoding rate of 5/6 and a code length of 16,200.
[FIG. 46] FIG. 46 is a view illustrating a parity check matrix initial value table of an encoding rate of 5/6 and a code length of 64,800.
[FIG. 47] FIG. 47 is a view illustrating the parity check matrix initial value table of the encoding rate of 5/6 and the code length of 64,800.
[FIG. 48] FIG. 48 is a view illustrating the parity check matrix initial value table of the encoding rate of 5/6 and the code length of 64,800.
[FIG. 49] FIG. 49 is a view illustrating the parity check matrix initial value table of the encoding rate of 5/6 and the code length of 64,800.
[FIG. 50] FIG. 50 is a view illustrating a parity check matrix initial value table of an encoding rate of 8/9 and a code length of 16,200.
[FIG. 51] FIG. 51 is a view illustrating the parity check matrix initial value table of the encoding rate of 8/9 and the code length of 64,800.
[FIG. 52] FIG. 52 is a view illustrating the parity check matrix initial value table of the encoding rate of 8/9 and the code length of 64,800.
[FIG. 53] FIG. 53 is a view illustrating the parity check matrix initial value table of the encoding rate of 8/9 and the code length of 64,800.
[FIG. 54] FIG. 54 is a view illustrating the parity check matrix initial value table of the encoding rate of 8/9 and the code length of 64,800.
[FIG. 55] FIG. 55 is a view illustrating a parity check matrix initial value table of an encoding rate of 9/10 and a code length of 64,800.
[FIG. 56] FIG. 56 is a view illustrating the parity check matrix initial value table of the encoding rate of 9/10 and the code length of 64,800.
[FIG. 57] FIG. 57 is a view illustrating the parity check matrix initial value table of the encoding rate of 9/10 and the code length of 64,800.
[FIG. 58] FIG. 58 is a view illustrating the parity check matrix initial value table of the encoding rate of 9/10 and the code length of 64,800.
[FIG. 59] FIG. 59 is a view illustrating a method of determining a parity check matrix H from a parity check matrix initial table.
[FIG. 60] FIG. 60 is a view illustrating a replacement process in accordance with existing methods.
[FIG. 61] FIG. 61 is a view illustrating a replacement process in accordance with the existing methods.
[FIG. 62] FIG. 62 is a view illustrating a code bit group and a symbol bit group where an LDPC code having a code length of 16,200 and an encoding rate of 2/3 is modulated by 1024QAM.
[FIG. 63] FIG. 63 is a view illustrating an allocation rule where an LDPC code having a code length of 16,200 and an encoding rate of 2/3 is modulated by 1024QAM.
[FIG. 64] FIG. 64 is a view illustrating replacement of code bits in accordance with the allocation rule where an LDPC code having a code length of 16,200 and an encoding rate of 2/3 is modulated by 1024QAM and the multiple b is 1.
[FIG. 65] FIG. 65 is a view illustrating a code bit group and a symbol bit group where an LDPC code having a code length of 64,800 and an encoding rate of 2/3 is modulated by 1024QAM.
[FIG. 66] FIG. 66 is a view illustrating an allocation rule where an LDPC code having a code length of 64,800 and an encoding rate of 2/3 is modulated by 1024QAM.
[FIG. 67] FIG. 67 is a view illustrating replacement of code bits in accordance with the allocation rule where an LDPC code having a code length of 64,800 and an encoding rate of 2/3 is modulated by 1024QAM and the multiple b is 1.
[FIG. 68] FIG. 68 is a view illustrating a code bit group and a symbol bit group where an LDPC code having a code length of 16,200 and an encoding rate of 3/4 is modulated by 1024QAM.
[FIG. 69] FIG. 69 is a view illustrating an allocation rule where an LDPC code having a code length of 16,200 and an encoding rate of 3/4 is modulated by 1024QAM.
[FIG. 70] FIG. 70 is a view illustrating replacement of code bits in accordance with the allocation rule where an LDPC code having a code length of 16,200 and an encoding rate of 3/4 is modulated by 1024QAM and the multiple b is 1.
[FIG. 71] FIG. 71 is a view illustrating a code bit group and a symbol bit group where an LDPC code having a code length of 64,800 and an encoding rate of 3/4 is modulated by 1024QAM.
[FIG. 72] FIG. 72 is a view illustrating an allocation rule where an LDPC code having a code length of 64,800 and an encoding rate of 3/4 is modulated by 1024QAM.

[FIG. 73] FIG. 73 is a view illustrating replacement of code bits in accordance with the allocation rule where an LDPC code having a code length of 64,800 and an encoding rate of 3/4 is modulated by 1024QAM and the multiple b is 1.
[FIG. 74] FIG. 74 is a view illustrating a code bit group and a symbol bit group where an LDPC code having a code length of 16,200 and an encoding rate of 4/5 is modulated by 1024QAM.
[FIG. 75] FIG. 75 is a view illustrating an allocation rule where an LDPC code having a code length of 16,200 and an encoding rate of 4/5 is modulated by 1024QAM.
[FIG. 76] FIG. 76 is a view illustrating replacement of code bits in accordance with the allocation rule where an LDPC code having a code length of 16,200 and an encoding rate of 4/5 is modulated by 1024QAM and the multiple b is 1.
[FIG. 77] FIG. 77 is a view illustrating a code bit group and a symbol bit group where an LDPC code having a code length of 64,800 and an encoding rate of 4/5 is modulated by 1024QAM.
[FIG. 78] FIG. 78 is a view illustrating an allocation rule where an LDPC code having a code length of 64,800 and an encoding rate of 4/5 is modulated by 1024QAM.
[FIG. 79] FIG. 79 is a view illustrating replacement of code bits in accordance with the allocation rule where an LDPC code having a code length of 64,800 and an encoding rate of 4/5 is modulated by 1024QAM and the multiple b is 1.
[FIG. 80] FIG. 80 is a view illustrating a code bit group and a symbol bit group where an LDPC code having a code length of 16,200 and an encoding rate of 5/6 is modulated by 1024QAM.
[FIG. 81] FIG. 81 is a view illustrating an allocation rule where an LDPC code having a code length of 16,200 and an encoding rate of 5/6 is modulated by 1024QAM.
[FIG. 82] FIG. 82 is a view illustrating replacement of code bits in accordance with the allocation rule where an LDPC code having a code length of 16,200 and an encoding rate of 5/6 is modulated by 1024QAM and the multiple b is 1.
[FIG. 83] FIG. 83 is a view illustrating a code bit group and a symbol bit group where an LDPC code having a code length of 64,800 and an encoding rate of 5/6 is modulated by 1024QAM.
[FIG. 84] FIG. 84 is a view illustrating an allocation rule where an LDPC code having a code length of 64,800 and an encoding rate of 5/6 is modulated by 1024QAM.
[FIG. 85] FIG. 85 is a view illustrating replacement of code bits in accordance with the allocation rule where an LDPC code having a code length of 64,800 and an encoding rate of 5/6 is modulated by 1024QAM and the multiple b is 1.
[FIG. 86] FIG. 86 is a view illustrating a code bit group and a symbol bit group where an LDPC code having a code length of 16,200 and an encoding rate of 8/9 is modulated by 1024QAM.
[FIG. 87] FIG. 87 is a view illustrating an allocation rule where an LDPC code having a code length of 16,200 and an encoding rate of 8/9 is modulated by 1024QAM.
[FIG. 88] FIG. 88 is a view illustrating replacement of code bits in accordance with the allocation rule where an LDPC code having a code length of 16,200 and an encoding rate of 8/9 is modulated by 1024QAM and the multiple b is 1.
[FIG. 89] FIG. 89 is a view illustrating a code bit group and a symbol bit group where an LDPC code having a code length of 64,800 and an encoding rate of 8/9 is modulated by 1024QAM.
[FIG. 90] FIG. 90 is a view illustrating an allocation rule where an LDPC code having a code length of 64,800 and an encoding rate of 8/9 is modulated by 1024QAM.
[FIG. 91] FIG. 91 is a view illustrating replacement of code bits in accordance with the allocation rule where an LDPC code having a code length of 64,800 and an encoding rate of 8/9 is modulated by 1024QAM and the multiple b is 1.
[FIG. 92] FIG. 92 is a view illustrating a code bit group and a symbol bit group where an LDPC code having a code length of 64,800 and an encoding rate of 9/10 is modulated by 1024QAM.
[FIG. 93] FIG. 93 is a view illustrating an allocation rule where an LDPC code having a code length of 64,800 and an encoding rate of 9/10 is modulated by 1024QAM.
[FIG. 94] FIG. 94 is a view illustrating replacement of code bits in accordance with the allocation rule where an LDPC code having a code length of 64,800 and an encoding rate of 9/10 is modulated by 1024QAM and the multiple b is 1.
[FIG. 95] FIG. 95 is a view illustrating a code bit group and a symbol bit group where an LDPC code having a code length of 16,200 and an encoding rate of 2/3 is modulated by 4096QAM.
[FIG. 96] FIG. 96 is a view illustrating an allocation rule where an LDPC code having a code length of 16,200 and an encoding rate of 2/3 is modulated by 4096QAM.
[FIG. 97] FIG. 97 is a view illustrating replacement of code bits in accordance with the allocation rule where an LDPC code having a code length of 16,200 and an encoding rate of 2/3 is modulated by 4096QAM and the multiple b is 1.
[FIG. 98] FIG. 98 is a view illustrating a code bit group and a symbol bit group where an LDPC code having a code length of 64,800 and an encoding rate of 2/3 is modulated by 4096QAM.
[FIG. 99] FIG. 99 is a view illustrating an allocation rule where an LDPC code having a code length of 64,800 and an encoding rate of 2/3 is modulated by 4096QAM.
[FIG. 100] FIG. 100 is a view illustrating replacement of code bits in accordance with the allocation rule where an LDPC code having a code length of 64,800 and an encoding rate of 2/3 is modulated by 4096QAM and the multiple b is 1.
[FIG. 101] FIG. 101 is a view illustrating a code bit group and a symbol bit group where an LDPC code having a code length of 16,200 and an encoding rate of 3/4 is modulated by 4096QAM.

[FIG. 102] FIG. 102 is a view illustrating an allocation rule where an LDPC code having a code length of 16,200 and an encoding rate of 3/4 is modulated by 4096QAM.

[FIG. 103] FIG. 103 is a view illustrating replacement of code bits in accordance with the allocation rule where an LDPC code having a code length of 16,200 and an encoding rate of 3/4 is modulated by 4096QAM and the multiple b is 1.

[FIG. 104] FIG. 104 is a view illustrating a code bit group and a symbol bit group where an LDPC code having a code length of 64,800 and an encoding rate of 3/4 is modulated by 4096QAM.

[FIG. 105] FIG. 105 is a view illustrating an allocation rule where an LDPC code having a code length of 64,800 and an encoding rate of 3/4 is modulated by 4096QAM.

[FIG. 106] FIG. 106 is a view illustrating replacement of code bits in accordance with the allocation rule where an LDPC code having a code length of 64,800 and an encoding rate of 3/4 is modulated by 4096QAM and the multiple b is 1.

[FIG. 107] FIG. 107 is a view illustrating a code bit group and a symbol bit group where an LDPC code having a code length of 16,200 and an encoding rate of 4/5 is modulated by 4096QAM.

[FIG. 108] FIG. 108 is a view illustrating an allocation rule where an LDPC code having a code length of 16,200 and an encoding rate of 4/5 is modulated by 4096QAM.

[FIG. 109] FIG. 109 is a view illustrating replacement of code bits in accordance with the allocation rule where an LDPC code having a code length of 16,200 and an encoding rate of 4/5 is modulated by 4096QAM and the multiple b is 1.

[FIG. 110] FIG. 110 is a view illustrating a code bit group and a symbol bit group where an LDPC code having a code length of 64,800 and an encoding rate of 4/5 is modulated by 4096QAM.

[FIG. 111] FIG. 111 is a view illustrating an allocation rule where an LDPC code having a code length of 64,800 and an encoding rate of 4/5 is modulated by 4096QAM.

[FIG. 112] FIG. 112 is a view illustrating replacement of code bits in accordance with the allocation rule where an LDPC code having a code length of 64,800 and an encoding rate of 4/5 is modulated by 4096QAM and the multiple b is 1.

[FIG. 113] FIG. 113 is a view illustrating a code bit group and a symbol bit group where an LDPC code having a code length of 16,200 and an encoding rate of 5/6 is modulated by 4096QAM.

[FIG. 114] FIG. 114 is a view illustrating an allocation rule where an LDPC code having a code length of 16,200 and an encoding rate of 5/6 is modulated by 4096QAM.

[FIG. 115] FIG. 115 is a view illustrating replacement of code bits in accordance with the allocation rule where an LDPC code having a code length of 16,200 and an encoding rate of 5/6 is modulated by 4096QAM and the multiple b is 1.

[FIG. 116] FIG. 116 is a view illustrating a code bit group and a symbol bit group where an LDPC code having a code length of 64,800 and an encoding rate of 5/6 is modulated by 4096QAM,

[FIG. 117] FIG. 117 is a view illustrating an allocation rule where an LDPC code having a code length of 64,800 and an encoding rate of 5/6 is modulated by 4096QAM.

[FIG. 118] FIG. 118 is a view illustrating replacement of code bits in accordance with the allocation rule where an LDPC code having a code length of 64,800 and an encoding rate of 5/6 is modulated by 4096QAM and the multiple b is 1.

[FIG. 119] FIG. 119 is a view illustrating a code bit group and a symbol bit group where an LDPC code having a code length of 16,200 and an encoding rate of 8/9 is modulated by 4096QAM.

[FIG. 120] FIG. 120 is a view illustrating an allocation rule where an LDPC code having a code length of 16,200 and an encoding rate of 8/9 is modulated by 4096QAM.

[FIG. 121] FIG. 121 is a view illustrating replacement of code bits in accordance with the allocation rule where an LDPC code having a code length of 16,200 and an encoding rate of 8/9 is modulated by 4096QAM and the multiple b is 1.

[FIG. 122] FIG. 122 is a view illustrating a code bit group and a symbol bit group where an LDPC code having a code length of 64,800 and an encoding rate of 8/9 is modulated by 4096QAM.

[FIG. 123] FIG. 123 is a view illustrating an allocation rule where an LDPC code having a code length of 64,800 and an encoding rate of 8/9 is modulated by 4096QAM.

[FIG. 124] FIG. 124 is a view illustrating replacement of code bits in accordance with the allocation rule where an LDPC code having a code length of 64,800 and an encoding rate of 8/9 is modulated by 4096QAM and the multiple b is 1.

[FIG. 125] FIG. 125 is a view illustrating a code bit group and a symbol bit group where an LDPC code having a code length of 64,800 and an encoding rate of 9/10 is modulated by 4096QAM.

[FIG. 126] FIG. 126 is a view illustrating an allocation rule where an LDPC code having a code length of 64,800 and an encoding rate of 9/10 is modulated by 4096QAM.

[FIG. 127] FIG. 127 is a view illustrating replacement of code bits in accordance with the allocation rule where an LDPC code having a code length of 64,800 and an encoding rate of 9/10 is modulated by 4096QAM and the multiple b is 1.

[FIG. 128] FIG. 128 is a view illustrating arrangement of signal points where 1024QAM is carried out.

[FIG. 129] FIG. 129 is a view illustrating arrangement of signal points where 4096QAM is carried out.

[FIG. 130] FIG. 130 is a view illustrating a result of a simulation of the BER where a replacement process of the new replacement method is carried out and where a replacement process of the new replacement method is not carried out.

[FIG. 131] FIG. 131 is a view illustrating a result of a simulation of the BER where a replacement process of the new replacement method is carried out and where a replacement process of the new replacement method is not carried out.

[FIG. 132] FIG. 132 is a view illustrating a result of a simulation of the BER where a replacement process of the new replacement method is carried out and where a replacement process of the new replacement method is not carried out.

[FIG. 133] FIG. 133 is a view illustrating a result of a simulation of the BER where a replacement process of the new replacement method is carried out and where a replacement process of the new replacement method is not carried out.

[FIG. 134] FIG. 134 is a view illustrating replacement of code bits where the multiple b is 1.

[FIG. 135] FIG. 135 is a view illustrating replacement of code bits where the multiple b is 2 utilizing the replacement pattern of code bits where the multiple b is 1.

[FIG. 136] FIG. 136 is a view illustrating replacement of code bits where an LDPC code having a code length of 16,200 and an encoding rate of 2/3 is modulated by 1024QAM and the multiple b is 2.

[FIG. 137] FIG. 137 is a view illustrating replacement of code bits where an LDPC code having a code length of 64,800 and an encoding rate of 2/3 is modulated by 1024QAM and the multiple b is 2.

[FIG. 138] FIG. 138 is a view illustrating replacement of code bits where an LDPC code having a code length of 16,200 and an encoding rate of 3/4 is modulated by 1024QAM and the multiple b is 2.

[FIG. 139] FIG. 139 is a view illustrating replacement of code bits where an LDPC code having a code length of 64,800 and an encoding rate of 3/4 is modulated by 1024QAM and the multiple b is 2.

[FIG. 140] FIG. 140 is a view illustrating replacement of code bits where an LDPC code having a code length of 16,200 and an encoding rate of 4/5 is modulated by 1024QAM and the multiple b is 2.

[FIG. 141] FIG. 141 is a view illustrating replacement of code bits where an LDPC code having a code length of 64,800 and an encoding rate of 4/5 is modulated by 1024QAM and the multiple b is 2.

[FIG. 142] FIG. 142 is a view illustrating replacement of code bits where an LDPC code having a code length of 16,200 and an encoding rate of 5/6 is modulated by 1024QAM and the multiple b is 2.

[FIG. 143] FIG. 143 is a view illustrating replacement of code bits where an LDPC code having a code length of 64,800 and an encoding rate of 5/6 is modulated by 1024QAM and the multiple b is 2.

[FIG. 144] FIG. 144 is a view illustrating replacement of code bits where an LDPC code having a code length of 16,200 and an encoding rate of 8/9 is modulated by 1024QAM and the multiple b is 2.

[FIG. 145] FIG. 145 is a view illustrating replacement of code bits where an LDPC code having a code length of 64,800 and an encoding rate of 8/9 is modulated by 1024QAM and the multiple b is 2.

[FIG. 146] FIG. 146 is a view illustrating replacement of code bits where an LDPC code having a code length of 64,800 and an encoding rate of 9/10 is modulated by 1024QAM and the multiple b is 2.

[FIG. 147] FIG. 147 is a view illustrating replacement of code bits where an LDPC code having a code length of 16,200 and an encoding rate of 2/3 is modulated by 4096QAM and the multiple b is 2.

[FIG. 148] FIG. 148 is a view illustrating replacement of code bits where an LDPC code having a code length of 64,800 and an encoding rate of 2/3 is modulated by 4096QAM and the multiple b is 2.

[FIG. 149] FIG. 149 is a view illustrating replacement of code bits where an LDPC code having a code length of 16,200 and an encoding rate of 3/4 is modulated by 4096QAM and the multiple b is 2.

[FIG. 150] FIG. 150 is a view illustrating replacement of code bits where an LDPC code having a code length of 64,800 and an encoding rate of 3/4 is modulated by 4096QAM and the multiple b is 2.

[FIG. 151] FIG. 151 is a view illustrating replacement of code bits where an LDPC code having a code length of 16,200 and an encoding rate of 4/5 is modulated by 4096QAM and the multiple b is 2.

[FIG. 152] FIG. 152 is a view illustrating replacement of code bits where an LDPC code having a code length of 64,800 and an encoding rate of 4/5 is modulated by 4096QAM and the multiple b is 2.

[FIG. 153] FIG. 153 is a view illustrating replacement of code bits where an LDPC code having a code length of 16,200 and an encoding rate of 5/6 is modulated by 4096QAM and the multiple b is 2.

[FIG. 154] FIG. 154 is a view illustrating replacement of code bits where an LDPC code having a code length of 64,800 and an encoding rate of 5/6 is modulated by 4096QAM and the multiple b is 2.

[FIG. 155] FIG. 155 is a view illustrating replacement of code bits where an LDPC code having a code length of 16,200 and an encoding rate of 8/9 is modulated by 4096QAM and the multiple b is 2.

[FIG. 156] FIG. 156 is a view illustrating replacement of code bits where an LDPC code having a code length of 64,800 and an encoding rate of 8/9 is modulated by 4096QAM and the multiple b is 2.

[FIG. 157] FIG. 157 is a view illustrating replacement of code bits where an LDPC code having a code length of 64,800 and an encoding rate of 9/10 is modulated by 4096QAM and the multiple b is 2.

[FIG. 158] FIG. 158 is a view illustrating a result of a simulation of the BER where a replacement process of the new replacement method is carried out and where a replacement process of the new replacement method is not carried out.

[FIG. 159] FIG. 159 is a view illustrating a result of a simulation of the BER where a replacement process of the new replacement method is carried out and where a replacement process of the new replacement method is not carried out.

[FIG. 160] FIG. 160 is a view illustrating a result of a simulation of the BER where a replacement process of the new replacement method is carried out and where a replacement process of the new replacement method is not carried out.

[FIG. 161] FIG. 161 is a view illustrating a result of a simulation of the BER where a replacement process of the new replacement method is carried out and where a replacement process of the new replacement method is not carried out.

[FIG. 162] FIG. 162 is a block diagram showing an example of a configuration of a reception apparatus 12.

[FIG. 163] FIG. 163 is a flow chart illustrating a reception process.

[FIG. 164] FIG. 164 is a view illustrating an example of a parity check matrix of an LDPC code.

[FIG. 165] FIG. 165 is a view illustrating a matrix (conversion parity check matrix) obtained by applying row replacement and column replacement to a parity check matrix.

[FIG. 166] FIG. 166 is a view illustrating a conversion parity check matrix divided into a unit of $5 \times 5$ bits.

[FIG. 167] FIG. 167 is a block diagram showing an example of a configuration of a decoding apparatus in which node mathematical operation is carried out collectively for P nodes.

[FIG. 168] FIG. 168 is a block diagram showing an example of a configuration of a LDPC decoding section 56.

[FIG. 169] FIG. 169 is a block diagram showing an example of a configuration of an embodiment of a computer to which the present invention is applied.

[FIG. 170] FIG. 170 is a view illustrating an example of replacement of code bits.

[FIG. 171] FIG. 171 is a view illustrating another example of replacement of code bits.

[FIG. 172] FIG. 172 is a view illustrating a further example of replacement of code bits.

[FIG. 173] FIG. 173 is a view illustrating a still further example of replacement of code bits.

[FIG. 174] FIG. 174 is a view illustrating a simulation result of the BER.

[FIG. 175] FIG. 175 is a view illustrating another simulation result of the BER.

[FIG. 176] FIG. 176 is a view illustrating a further simulation result of the BER.

[FIG. 177] FIG. 177 is a view illustrating a still simulation result of the BER.

[FIG. 178] FIG. 178 is a view illustrating an example of a parity check matrix initial value table of an encoding rate of 2/3 and a code length of 16,200.

[FIG. 179] FIG. 179 is a view illustrating an example of a parity check matrix initial value table of an encoding rate of 2/3 and a code length of 64,800.

[FIG. 180] FIG. 180 is a view illustrating the example of the parity check matrix initial value table of the encoding rate of 2/3 and the code length of 64,800.

[FIG. 181] FIG. 181 is a view illustrating the example of the parity check matrix initial value table of the encoding rate of 2/3 and the code length of 64,800.

[FIG. 182] FIG. 182 is a view illustrating an example of a parity check matrix initial value table of an encoding rate of 3/4 and a code length of 16,200.

[FIG. 183] FIG. 183 is a view illustrating an example of a parity check matrix initial value table of an encoding rate of 3/4 and a code length of 64,800.

[FIG. 184] FIG. 184 is a view illustrating the example of the parity check matrix initial value table of the encoding rate of 3/4 and the code length of 64,800.

[FIG. 185] FIG. 185 is a view illustrating the example of the parity check matrix initial value table of the encoding rate of 3/4 and the code length of 64,800.

[FIG. 186] FIG. 186 is a view illustrating the example of the parity check matrix initial value table of the encoding rate of 3/4 and the code length of 64,800.

[FIG. 187] FIG. 187 is a view illustrating an example of a parity check matrix initial value table of an encoding rate of 4/5 and a code length of 16,200.

[FIG. 188] FIG. 188 is a view illustrating an example of a parity check matrix initial value table of an encoding rate of 4/5 and a code length of 64,800.

[FIG. 189] FIG. 189 is a view illustrating the example of the parity check matrix initial value table of the encoding rate of 4/5 and the code length of 64,800.

[FIG. 190] FIG. 190 is a view illustrating the example of the parity check matrix initial value table of the encoding rate of 4/5 and the code length of 64,800.

[FIG. 191] FIG. 191 is a view illustrating the example of the parity check matrix initial value table of the encoding rate of 4/5 and the code length of 64,800.

[FIG. 192] FIG. 192 is a view illustrating an example of a parity check matrix initial value table of an encoding rate of 5/6 and a code length of 16,200.

[FIG. 193] FIG. 193 is a view illustrating an example of a parity check matrix initial value table of an encoding rate of 5/6 and a code length of 64,800.

[FIG. 194] FIG. 194 is a view illustrating the example of the parity check matrix initial value table of the encoding rate of 5/6 and the code length of 64,800.

[FIG. 195] FIG. 195 is a view illustrating the example of the parity check matrix initial value table of the encoding rate of 5/6 and the code length of 64,800.

[FIG. 196] FIG. 196 is a view illustrating the example of the parity check matrix initial value table of the encoding rate of 5/6 and the code length of 64,800.

[FIG. 197] FIG. 197 is a view illustrating an example of a parity check matrix initial value table of an encoding rate of 8/9 and a code length of 16,200.

[FIG. 198] FIG. 198 is a view illustrating the example of the parity check matrix initial value table of the encoding rate of 8/9 and the code length of 64,800.

[FIG. 199] FIG. 199 is a view illustrating the example of the parity check matrix initial value table of the encoding rate of 8/9 and the code length of 64,800.

[FIG. 200] FIG. 200 is a view illustrating the example of the parity check matrix initial value table of the encoding rate of 8/9 and the code length of 64,800.

[FIG. 201] FIG. 201 is a view illustrating the example of the parity check matrix initial value table of the encoding rate of 8/9 and the code length of 64,800.

[FIG. 202] FIG. 202 is a view illustrating an example of a parity check matrix initial value table of an encoding rate of 9/10 and a code length of 64,800.

[FIG. 203] FIG. 203 is a view illustrating the example of the parity check matrix initial value table of the encoding rate of 9/10 and the code length of 64,800.

[FIG. 204] FIG. 204 is a view illustrating the example of the parity check matrix initial value table of the encoding rate of 9/10 and the code length of 64,800.

[FIG. 205] FIG. 205 is a view illustrating the example of the parity check matrix initial value table of the encoding rate of 9/10 and the code length of 64,800.

[FIG. 206] FIG. 206 is a view illustrating an example of a parity check matrix initial value table of an encoding rate of 1/4 and a code length of 64,800.

[FIG. 207] FIG. 207 is a view illustrating the example of the parity check matrix initial value table of the encoding rate of 1/4 and the code length of 64,800.

[FIG. 208] FIG. 208 is a view illustrating an example of a parity check matrix initial value table of an encoding rate of 1/3 and a code length of 64,800.

[FIG. 209] FIG. 209 is a view illustrating the example of the parity check matrix initial value table of the encoding rate of 1/3 and the code length of 64,800.

[FIG. 210] FIG. 210 is a view illustrating an example of a parity check matrix initial value table of an encoding rate of 2/5 and a code length of 64,800.

[FIG. 211] FIG. 211 is a view illustrating the example of the parity check matrix initial value table of the encoding rate of 2/5 and the code length of 64,800.

[FIG. 212] FIG. 212 is a view illustrating an example of a parity check matrix initial value table of an encoding rate of 1/2 and a code length of 64,800.

[FIG. 213] FIG. 213 is a view illustrating the example of the parity check matrix initial value table of the encoding rate of 1/2 and the code length of 64,800.

[FIG. 214] FIG. 214 is a view illustrating the example of the parity check matrix initial value table of the encoding rate of 1/2 and the code length of 64,800.

[FIG. 215] FIG. 215 is a view illustrating an example of a parity check matrix initial value table of an encoding rate of 3/5 and a code length of 64,800.

[FIG. 216] FIG. 216 is a view illustrating the example of the parity check matrix initial value table of the encoding rate of 3/5 and the code length of 64,800.

[FIG. 217] FIG. 217 is a view illustrating the example of the parity check matrix initial value table of the encoding rate of 3/5 and the code length of 64,800.

[FIG. 218] FIG. 218 is a view illustrating an example of a parity check matrix initial value table of an encoding rate of 1/4 and a code length of 16,200.

[FIG. 219] FIG. 219 is a view illustrating an example of a parity check matrix initial value table of an encoding rate of 1/3 and a code length of 16,200.

[FIG. 220] FIG. 220 is a view illustrating an example of a parity check matrix initial value table of an encoding rate of 2/5 and a code length of 16,200.

[FIG. 221] FIG. 221 is a view illustrating an example of a parity check matrix initial value table of an encoding rate of 1/2 and a code length of 16,200.

[FIG. 222] FIG. 222 is a view illustrating an example of a parity check matrix initial value table of an encoding rate of 3/5 and a code length of 16,200.

[FIG. 223] FIG. 223 is a view illustrating another example of the parity check matrix initial value table of the encoding rate of 3/5 and the code length of 16,200.

[FIG. 224] FIG. 224 is a view illustrating a method of determining a parity check matrix H from a parity check matrix initial table.

[FIG. 225] FIG. 225 is a view illustrating an example of replacement of code bits.

[FIG. 226] FIG. 226 is a view illustrating another example of replacement of code bits.

[FIG. 227] FIG. 227 is a view illustrating a further example of replacement of code bits.

[FIG. 228] FIG. 228 is a view illustrating a still further example of replacement of code bits.

[FIG. 229] FIG. 229 is a view illustrating a simulation result of the BER.

[FIG. 230] FIG. 230 is a view illustrating another simulation result of the BER.

[FIG. 231] FIG. 231 is a view illustrating a further simulation result of the BER.

[FIG. 232] FIG. 232 is a view illustrating a still simulation result of the BER.

[FIG. 233] FIG. 233 is a view illustrating an example of replacement of code bits.

[FIG. 234] FIG. 234 is a view illustrating another example of replacement of code bits.

[FIG. 235] FIG. 235 is a view illustrating a further example of replacement of code bits.

[FIG. 236] FIG. 236 is a view illustrating a still further example of replacement of code bits.

[FIG. 237] FIG. 237 is a view illustrating a yet further example of replacement of code bits.

[FIG. 238] FIG. 238 is a view illustrating a yet further example of replacement of code bits.

[FIG. 239] FIG. 239 is a view illustrating a yet further example of replacement of code bits.

[FIG. 240] FIG. 240 is a view illustrating a yet further example of replacement of code bits.

[FIG. 241] FIG. 241 is a view illustrating a yet further example of replacement of code bits.

[FIG. 242] FIG. 242 is a view illustrating a yet further example of replacement of code bits.

[FIG. 243] FIG. 243 is a view illustrating a yet further example of replacement of code bits.

[FIG. 244] FIG. 244 is a view illustrating a yet further example of replacement of code bits.

[FIG. 245] FIG. 245 is a view illustrating processing of a multiplexer 54 which composes a deinterleaver 53.

[FIG. 246] FIG. 246 is a view illustrating processing of a column twist deinterleaver 55.

[FIG. 247] FIG. 247 is a block diagram showing another example of a configuration of the reception apparatus 12.

[FIG. 248] FIG. 248 is a block diagram showing a first example of a configuration of a reception system which can be applied to the reception apparatus 12.

[FIG. 249] FIG. 249 is a block diagram showing a second example of the configuration of the reception system which can be applied to the reception apparatus 12.

[FIG. 250] FIG. 250 is a block diagram showing a third example of the configuration of the reception system which can be applied to the reception apparatus 12. Explanation of Reference Symbols

11 Transmission apparatus, 12 Reception apparatus, 21 LDPC encoding section, 22 Bit interleaver, 23 Parity interleaver, 24 Column twist interleaver, 25 Demultiplexer, 26 Mapping section, 27 Orthogonal modulation section, 31 Memory, 32 Replacement section, 51 Orthogonal demodulation section, 52 Demapping section, 53 Deinterleaver, 54 Multiplexer, 55 Column twist interleaver, 56 LDPC decoding section, 300 Edge data storage memory, 301 Selector, 302 Check node calculation section, 303 Cyclic shift circuit, 304 Edge data storage memory, 305 Selector, 306 Reception data memory, 307 Variable node calculation section, 308 Cyclic shift circuit, 309 Decoded word calculation section, 310 Reception data re-arrangement section, 311 Decoded data re-arrangement section, 601 Encoding processing block, 602 Storage block, 611 Encoding rate setting portion, 612 Initial value table reading out portion, 613 Parity check matrix production portion, 614 Information bit reading out portion, 615 Encoding parity mathematical operation portion, 616 Control portion, 701 Bus, 702 CPU, 703 ROM, 704 RAM, 705 Hard disk, 706 Outputting section, 707 Inputting section, 708 Communication section, 709 Drive, 710 Input/output interface, 711 Removable recording medium, 1001 Reverse replacement section, 1002 Memory, 1011 Parity deinterleaver, 1021 LDPC decoding section, 1101 Acquisition section, 1101 Transmission line decoding processing section, 1103 Information source decoding processing section, 1111 Outputting section, 1121 Recording section

Best Mode for Carrying Out the Invention

FIG. 7 shows an example of a configuration of an embodiment of a transmission system to which the present invention is applied (the term system signifies a logical aggregate of a plurality of apparatus irrespective of whether or not the individual component apparatus are included in the same housing).
Referring to FIG. 7, the transmission system includes a transmission apparatus 11 and a reception apparatus 12.
The transmission apparatus 11 carries out, for example, transmission (broadcast) (transfer) of a television broadcasting program. That is, the transmission apparatus 11, for example, encodes object data which are an object of transmission such as image data, sound data and so forth as a television broadcasting program into an LDPC code and transmits the resultant data through, for example, a communication path 13 such as a satellite channel, ground waves and CATV network.
The reception apparatus 12 is, for example, a tuner, a television receiver or a STB (Set Top Box) for receiving a television broadcasting program, and receives LDPC codes transmitted thereto from the transmission apparatus 11 through a communication path 13, decodes the LDPC codes into object data and outputs the object data.
Here, it has been known that LDPC codes utilized in the transmission system in FIG. 7 exhibit a very high capacity in an AWGN (Additive White Gaussian Noise) communication path.
However, in the communication path 13 such as ground waves, burst errors or erasure sometimes occurs. For example, in an OFDM (Orthogonal Frequency Division Multiplexing) system, in a multi-path environment wherein the D/U (Desired to Undesired Ratio) is 0 dB (power of Undesired = echo is equal to the power of Desired = main path), the power of a particular symbol becomes zero (erasure) in response to a delay of an echo (paths other than the main path).
Further, also in a flutter (communication path in which an echo whose delay is zero and to which a Doppler (dopper) frequency is applied is added), where the D/U is 0 dB, a case wherein the power of an entire OFDM symbol at a specific point of time is reduced to zero (erasure) by the Doppler frequency occurs.
Further, from a situation of wiring lines on the reception apparatus 12 side from a reception section (not shown) such as an antenna or the like for receiving a signal from the transmission apparatus 11 to the reception apparatus 12 or from instability of the power supply to the reception apparatus 12, burst errors sometimes appear.
Meanwhile, in decoding of LDPC codes, since variable node mathematical operation of the expression (1) wherein addition of (reception values $u_{oi}$ of) code bits of an LDPC code as seen in FIG. 5 above described is carried out in a column of the parity check matrix H and hence a variable node corresponding to a code bit of the LDPC code, if an error occurs with the code bit used for the variable node mathematical operation, then the accuracy of a message to be determined drops.
Then, since, in decoding of the LDPC code, the message determined at the variable node connecting to the check node is used to carry out check node mathematical operation of the expression (7) at the check node, if the number of check nodes where (code bits of the LDPC code corresponding to) a plurality of variable nodes connected thereto exhibit an error (including erasure) at the same time becomes great, then the performance of the decoding deteriorates.
For example, if two or more of the variable nodes connected to the check node suffer from erasure at the same time, then the check node returns a message that the probability that the value may be 0 and the probability that the value may be 1 are equal to each other to all variable nodes. In this instance, those check nodes to which the message of the equal probabilities does not contribute to one cycle of decoding processing (one set of variable node mathematical operation and check node mathematical operation), and as a result, an increased number of times of repetition of decoding processing are required. Consequently, the performance of the decoding deteriorates. Further, the power consumption of a reception apparatus 12 which carries out decoding of the LDPC code increases.
Accordingly, the transmission system shown in FIG. 7 is configured such that the tolerance to burst errors or erasure is improved while the performance in an AWGN communication path is maintained.
FIG. 8 shows an example of a configuration of the transmission apparatus 11 of FIG. 7.
Referring to FIG. 8, the transmission apparatus 11 includes an LDPC encoding section 21, a bit interleaver 22, a mapping section 26 and an orthogonal modulation section 27.
To the LDPC encoding section 21, object data are supplied.
The LDPC encoding section 21 carries out LDPC encoding of the object data supplied thereto in accordance with a parity check matrix in which a parity matrix which is a portion corresponding to parity bits of an LDPC code has a staircase structure and outputs an LDPC code wherein the object data are information bits.
In particular, the LDPC encoding section 21 carries out LDPC encoding of encoding the object data into an LDPC code prescribed, for example, in the DVB-S.2 or DVB-T.2 standards and outputs an LDPC code obtained as a result of the LDPC encoding.
Here, in the DVB-T.2 standard, it is scheduled to adopt the LDPC codes prescribed in the DVB-S.2 standard.

The LDPC code prescribed in the DVB-S.2 standard is an IRA (Irregular Repeat Accumulate) code, and the parity matrix in the parity check matrix of the LDPC code has a staircase structure. The parity matrix and the staircase structure are hereinafter described. Further, the IRA code is described, for example, in "Irregular Repeat-Accumulate Codes," H. Jin., A. Khandekar, and R. J. McEliece, in Proceedings of 2nd International Symposium on Turbo codes and Related Topics, pp.1-8, Sept. 2000.

The LDPC code outputted from the LDPC encoding section 21 is supplied to the bit interleaver 22.

The bit interleaver 22 is a data processing apparatus for interleaving data and includes a parity interleaver 23, a column twist interleaver 24 and a demultiplexer (DEMUX) 25.

The parity interleaver 23 carries out parity interleave of interleaving parity bits of the LDPC code from the LDPC encoding section 21 to positions of other parity bits and supplies the LDPC code after the parity interleave to the column twist interleaver 24.

The column twist interleaver 24 carries out column twist interleave for the LDPC code from the parity interleaver 23 and supplies the LDPC code after the column twist interleave to the demultiplexer 25.

In particular, the LDPC code is transmitted after two or more code bits thereof are mapped to signal points representing one symbol of orthogonal modulation by the mapping section 26 hereinafter described.

The column twist interleaver 24 carries out, for example, such column twist interleave as hereinafter described as a re-arranging process of re-arranging code bits of the LDPC code from the parity interleaver 23 such that a plurality of code bits of the LDPC code corresponding to the value 1 included in one arbitrary row of the parity check matrix used in the LDPC encoding section 21 are not included in one symbol.

The demultiplexer 25 carries out a replacing process of replacing the positions of two or more code bits of the LDPC code (which are to be a symbol) from the column twist interleaver 24 to obtain an LDPC code whose tolerance to AWGN is reinforced. Then, the demultiplexer 25 supplies two or more code bits of an LDPC code obtained by the replacement process as a symbol to the mapping section 26.

The mapping section 26 maps the symbol from the demultiplexer 25 to signal points determined by a modulation method of orthogonal modulation (multi-value modulation) carried out by the orthogonal modulation section 27.

In particular, the mapping section 26 maps the LDPC code from the demultiplexer 25 into a signal point determined by the modulation system, on an IQ plane (IQ constellation) defined by an I axis representative of an I component which is in phase with a carrier and a Q axis representative of a Q component which is orthogonal to the carrier wave.

Here, as the modulation method of orthogonal modulation carried out by the orthogonal modulation section 27, modulation methods including, for example, a modulation method defined in the DVB-T standards, that is, for example, QPSK (Quadrature Phase Shift Keying), 16QAM (Quadrature Amplitude Modulation), 64QAM, 256QAM, 1024QAM, 4096QAM and so forth are available. What modulation method should be used for orthogonal modulation to be carried out by the orthogonal modulation section 27 is set in advance, for example, in accordance with an operation of the transmission apparatus 11 by an operator. It is to be noted that the orthogonal modulation section 27 can carry out some other orthogonal modulation such as, for example, 4PAM (Pulse Amplitude Modulation).

The symbol mapped to a signal point by the mapping section 26 is supplied to the orthogonal modulation section 27.

The orthogonal modulation section 27 carries out orthogonal modulation of a carrier in accordance with (the symbol mapped to) the signal point from the mapping section 26 and transmits a modulation signal obtained by the orthogonal modulation through the communication path 13 (FIG. 7).

Now, FIG. 9 illustrates a parity check matrix H used in LDPC encoding by the LDPC encoding section 21 of FIG. 8.

The parity check matrix H has an LDGM (Low-Density Generation Matrix) structure and can be represented by an expression $H = [H_A|H_T]$ from an information matrix $H_A$ of a portion corresponding to information bits and a parity matrix $H_T$ corresponding to parity bits from among code bits of the LDPC code (matrix in which elements of the information matrix $H_A$ are elements on the left side and elements of the parity matrix $H_T$ are elements on the right side).

Here, the bit number of information bits and the bit number of parity bits from among code bits of one LDPC code (one codeword) are referred to as information length K and parity length M, and the bit number of code bits of one LDPC code is referred to as code length N (= K + M).

The information length K and the parity length M regarding an LDPC code of a certain code length N depend upon the encoding rate. Meanwhile, the parity check matrix H is a matrix whose rows $\times$ columns are $M \times N$. Then, the information matrix $H_A$ is an $M \times K$ matrix and the parity matrix $H_T$ is an $M \times M$ matrix.

FIG. 10 illustrates the parity matrix $H_T$ of the parity check matrix H of an LDPC code prescribed in the DVB-S. 2 (and DVB-T.2) standard.

The parity matrix $H_T$ of the parity check matrix H of the LDPC code prescribed in the DVB-S.2 standard has a staircase structure wherein elements of the value 1 are arranged like a staircase as seen in FIG. 10. The row weight of the parity matrix $H_T$ is 1 with regard to the first row but is 2 with regard to all of the remaining rows. Meanwhile, the column weight is 1 with regard to the last column but is 2 with regard to all of the remaining columns.

As described above, the LDPC code of the parity check matrix H wherein the parity matrix $H_T$ has a staircase structure can be produced readily using the parity check matrix H.

In particular, an LDPC code (one codeword) is represented by a row vector c and a column vector obtained by transposing the row vector is represented by $c^T$. Further, a portion of information bits from within the row vector c which is an LDPC code is represented by an row vector A and a portion of parity bits is represented by a row vector T.

Here, in this instance, the row vector c can be presented by an expression c = [A|T] from the row vector A as information bits and the row vector T as parity bits (row vector wherein the elements of the row vector A are elements on the left side and the elements of the row vector T are elements on the right side).

It is necessary for the parity check matrix H and the row vector c = [A|T] as the LDPC code to satisfy an expression $Hc^T = 0$, and where the parity matrix $H_T$ of the parity check matrix H = $[H_A|H_T]$ has such a staircase structure as shown in FIG. 10, the row vector T as parity bits which forms the row vector c = [A|T] which satisfies the expression $Hc^T = 0$ can be determined sequentially by successively setting the elements in the rows beginning with the elements in the first row of the column vector $Hc^T$ in the expression $Hc^T = 0$ to zero.

FIG. 11 illustrates the parity check matrix H of an LDPC code and column weights defined in the DVB-S.2 (and DVB-T.2) standard.

In particular, A of FIG. 11 illustrates the parity check matrix H of an LDPC code defined in the DVB-S.2 standard.

With regard to KX columns from the first column of the parity check matrix H, the column weight is X; with regard to succeeding K3 columns, the column weight is 3; with regard to succeeding M-1 rows, the column weight is 2; and with regard to the last one column, the column weight is 1.

Here, KX + K3 + M-1 + 1 is equal to the code length N.

In the DVB-S.2 standard, the column numbers KX, K3 and M (parity length) as well as the column weight X are prescribed in such a manner as seen in B of FIG. 11.

In particular, B of FIG. 11 illustrates the column numbers KX, K3 and M as well as the column weight X regarding different encoding rates of LDPC codes prescribed in the DVB-S.2 standard.

In the DVB-S.2 standard, LDPC codes of the code lengths N of 64,800 bits and 16,200 bits are prescribed.

And as seen in B of FIG. 11, for the LDPC code whose code length N is 64,800 bits, 11 encoding rates (nominal rates) 1/4, 1/3, 2/5, 1/2, 3/5, 2/3, 3/4, 4/5, 5/6, 8/9 and 9/10 are prescribed, and for the LDPC code whose code length N is 16,200 bits, 10 encoding rates 1/4, 1/3, 2/5, 1/2, 3/5, 2/3, 3/4, 4/5, 5/6 and 8/9 are prescribed.

Regarding LDPC codes, it is known that code bits corresponding to a column of the parity check matrix H which has a higher column weight exhibits a lower error rate.

The parity check matrix H prescribed in the DVB-S.2 standard and illustrated in FIG. 11 has a tendency that a column nearer to the head side (left side) has a higher column weight. Accordingly, the LDPC code corresponding to the parity check matrix H has a tendency that a code bit nearer to the head is higher in tolerance to an error (has a higher tolerance to an error) and a code bit nearer to the tail is lower in tolerance to an error.

FIG. 12 illustrates an arrangement of (signal points corresponding to) 16 symbols on the IQ plane where 16QAM is carried out by the orthogonal modulation section 27 of FIG. 8.

In particular, A of FIG. 12 illustrates symbols of 16QAM.

In 16QAM, one symbol represents 4 bits, and 16 (= $2^4$) symbols exist. Then, the 16 symbols are disposed such that they form a square shape of 4 × 4 symbols in the I direction × Q direction centered at the origin of the IQ plane.

Now, if the i+1th bit from the most significant bit of the bit string represented by one symbol is represented as bit $y_i$, then 4 bits represented by one symbol of 16QAM can be represented as bits $y_0$, $y_1$, $y_2$ and $y_3$ in order beginning with the most significant bit. Where the modulation method is 16QAM, 4 code bits of the LDPC code are set (symbolized) as a symbol (symbol value) of the 4 bits $y_0$ to $y_3$.

B of FIG. 12 indicates bit boundaries regarding the 4 bits (hereinafter, bit is also referred to as symbol bit) $y_0$ to $y_3$ represented by the symbol of the 16QAM.

Here, a bit boundary regarding a symbol bit $y_i$ (in FIG. 12, i = 0, 1, 2, 3) signifies a boundary between a symbol whose bit $y_i$ is 0 and another symbol whose bit $y_i$ is 1.

As seen in B of FIG. 12, as regards the most significant symbol bit $y_0$ from among the 4 symbol bits $y_0$ to $y_3$ represented by the symbol of 16QAM, only one location of the Q axis on the IQ plane makes a bit boundary, and as regards the second symbol bit $y_1$ (second from the most significant bit), only one location of the I axis on the IQ plane makes a bit boundary.

Further, as regards the third symbol bit $y_3$, each of two locations between the first and second columns and between the third and fourth columns from the left of the 4 × 4 symbols makes a boundary.

Furthermore, as regards the fourth symbol bit $y_3$, each of two locations between the first and second rows and between the third and fourth rows of the 4 × 4 symbols makes a boundary.

The symbol bit $y_1$ represented by a symbol is less likely to become erroneous and becomes lower in error probability as the number of symbols spaced away from a bit boundary increases but is more likely to become erroneous and becomes higher in error probability as the number of symbols positioned nearer to a bit boundary increases.

If a bit which is less likely to become erroneous (is tolerant to an error) is referred to as "strong bit" but a bit which is more likely to become erroneous (is less tolerant to an error) is referred to as "weak bit," then as regards the 4 symbol bits $y_0$ to $y_3$ represented by symbols of 16QAM, the most significant symbol bit $y_0$ and the second symbol bit $y_1$ are strong bits and the third symbol bit $y_2$ and the fourth symbol bit $y_3$ are weak bits.

FIGS. 13 to 15 illustrate arrangements of (signal points corresponding to) 64 symbols on the IQ plane where 64QAM is carried out by the orthogonal modulation section 27 of FIG. 8.

In 64QAM, one symbol represents 6 bits, and 64 (= $2^6$) symbols exist. Then, the 64 symbols are arranged such that they make a square of 8 $\times$ 8 symbols in the I direction $\times$ Q direction centered at the origin of the IQ plane.

The symbol bits represented by one symbol of 64QAM can be represented as bits $y_0$, $y_1$, $y_2$, $y_3$, $y_4$, and $y_5$ in order beginning with the most significant bit. Where the modulation method is 64QAM, 6 code bits of the LDPC code are set (symbolized) as a symbol (symbol value) of the 6 bits $y_0$ to $y_5$.

Here, FIG. 13 indicates bit boundaries regarding the most significant symbol bit $y_0$ and the second symbol bit $y_1$ from among the symbol bits $y_0$ to $y_5$ of symbols of 64QAM; FIG. 14 indicates bit boundaries regarding the third symbol bit $y_2$ and the fourth symbol bit $y_3$; and FIG. 15 indicates bit boundaries regarding the fifth symbol bit $y_4$ and the sixth symbol bit $y_5$.

As seen in FIG. 13, the number of bit boundaries with regard to each of the most significant symbol bit $y_0$ and the second symbol bit $y_1$ is one. Meanwhile, as seen in FIG. 14, the number of bit boundaries with regard to each of the third symbol bit $y_2$ and the fourth symbol bit $y_3$ is two, and as seen in FIG. 15, the number of bit boundaries with regard to each of the fifth symbol bit $y_4$ and the sixth symbol bit $y_5$ is four.

Accordingly, among the symbol bits $y_0$ to $y_5$ of symbols of 64QAM, the most significant symbol bit $y_0$ and the second symbol bit $y_1$ are the strongest bits, and the third symbol bit $y_2$ and the fourth symbol bit $y_3$ are the second strongest bits. Then, the fifth symbol bit $y_4$ and the sixth symbol bit $y_5$ are the weakest bits.

From FIG. 12 and further from FIGS. 13 to 15, it can be seen that, as regards symbol bits of symbols of orthogonal modulation, there is a tendency that a high-order bit is a strong bit and a low-order bit is a weak bit.

Here, as described hereinabove with reference to FIG. 11, an LDPC code outputted from the LDPC encoding section 21 (FIG. 8) includes code bits which are tolerant to errors and code bits which are less tolerant to errors.

Meanwhile, as described hereinabove with reference to FIGS. 12 to 15, symbol bits of symbols of orthogonal modulation carried out by the orthogonal modulation section 27 include strong bits and weak bits.

Accordingly, if a code bit of the LDPC code which is low in tolerance to an error is allocated to a weak symbol bit of a symbol of orthogonal modulation, then the tolerance to an error drops as a whole.

Therefore, an interleaver has been proposed which interleaves code bits of an LDPC code such that code bits of the LDPC code which are low in tolerance to an error are allocated to strong bits (symbol bits) of a symbol of orthogonal modulation.

The demultiplexer 25 of FIG. 8 carries out processing of the interleaver.

FIG. 16 is a view illustrating processing of the demultiplexer 25 of FIG. 8.

In particular, A of FIG. 16 shows an example of a functional configuration of the demultiplexer 25.

The demultiplexer 25 includes a memory 31 and a replacement section 32.

To the memory 31, an LDPC code from the LDPC encoding section 21 is supplied.

The memory 31 has a storage capacity for storing mb bits in the (horizontal) direction of a row and storing N/(mb) bits in the (vertical) direction of a column. The memory 31 writes code bits of the LDPC code supplied thereto into the column direction and reads out the code bits in the row direction and then supplies the read out code bits to the replacement section 32.

Here, N (= information length K + parity length M) represents the code length of the LDPC code as described hereinabove.

In addition, m represents the bit number of code bits of an LDPC code to be one symbol, and b is a predetermined positive integer and is a multiple to be used for multiplying m by the integer. The multiplexer 25 converts (symbolizes) the code bits of the LDPC code into symbols as described above, and the multiple b represents the number of symbols obtained in a way by single time symbolization by the multiplexer 25.

A of FIG. 16 shows an example of a configuration of the demultiplexer 25 where the modulation system is 64QAM, and accordingly, the bit number m of code bits of the LDPC code to be one symbol is 6 bits.

Further, in A of FIG. 16, the multiple b is 1, and accordingly, the memory 31 has a storage capacity of N/(6 $\times$ 1) $\times$ (6 $\times$ 1) bits in the column direction $\times$ row direction.

Here, a storage region of the memory 31 which extends in the column direction and includes one bit in the row direction is hereinafter referred to suitably as column. In A of FIG. 16, the memory 31 includes six (= 6 $\times$ 1) columns.

The demultiplexer 25 carries out writing of the code bits of the LDPC code in a downward direction from above of a column which forms the memory 31 (in a column direction) beginning with a left side column toward a right side column.

Then, if the writing of the code bits ends with the lowermost bit in the rightmost column, then the code bits are read out and supplied to the replacement section 32 in a unit of 6 bits (mb bits) in the row direction beginning with the first row of all of the columns which form the memory 31.

The replacement section 32 carries out a replacement process of replacing the position of code bits of 6 bits from the memory 31 and outputs the 6 bits obtained by the replacement as 6 symbol bits $y_0$, $y_1$, $y_2$, $y_3$, $y_4$ and $y_5$ representative of one symbol of 64QAM.

In particular, while mb code bits (here, 6 bits) are read out in the row direction from the memory 31, if the ith bit (i = 0, 1, ..., mb-1) from the most significant bit from among the mb code bits read out from the memory 31 is represented by bit $b_i$, then the 6 code bits read out in the row direction from the memory 31 can be represented as bits $b_0$, $b_1$, $b_2$, $b_3$, $b_4$ and $b_5$ in order beginning with the most significant bit.

A relationship of the column weight described hereinabove with reference to FIG. 11 leads that the code bit positioned in the direction of the bit $b_0$ is a code bit high in tolerance to an error while the code bit in the direction of the bit $b_5$ is a code bit low in tolerance to an error.

The replacement section 32 carries out a replacement process of replacing the position of the 6 code bits $b_0$ to $b_5$ from the memory 31 such that a code bit which is low in tolerance to an error from among the 6 code bits $b_0$ to $b_5$ from the memory 31 may be allocated to a bit which is high in tolerance from among the symbol bits $y_0$ to $y_5$ of one symbol of 64QAM.

Here, for a replacement method for replacing the 6 code bits $b_0$ to $b_5$ from the memory 31 so as to be allocated to the 6 symbol bits $y_0$ to $y_5$ representative of one symbol of 64QAM, various systems have been proposed.

B of FIG. 16 illustrates a first replacement method; C of FIG. 16 illustrates a second replacement method; and D of FIG. 16 illustrates a third replacement method.

In B of FIG. 16 to D of FIG. 16 (similarly also in FIG. 17 hereinafter described), a line segment interconnecting the bits bit and $y_j$ signifies that the code bit $b_i$ is allocated to the symbol bit $y_j$ of the symbol (is replaced into the position of the symbol bit $y_j$).

As the first replacement method of B of FIG. 16, it is proposed to adopt one of three kinds of replacement methods, and as the second replacement method of C of FIG. 16, it is proposed to adopt one of two kinds of replacement methods.

As the third replacement method of D of FIG. 16, it is proposed to select and use six kinds of replacement methods in order.

FIG. 17 illustrates an example of a configuration of the demultiplexer 25 in a case wherein the modulation method is 64QAM (accordingly, the bit number m of code bits of an LDPC code mapped to one symbol is 6 similarly as in FIG. 16) and the multiple b is 2, and a fourth replacement method.

Where the multiple b is 2, the memory 31 has a storage capacity of N/(6 $\times$ 2) $\times$ (6 $\times$ 2) bits in the column direction $\times$ row direction and includes 12 (= 6 $\times$ 2) columns.

A of FIG. 17 illustrates a writing order of an LDPC code into the memory 31.

The demultiplexer 25 carries out writing of code bits of an LDPC code in a downward direction from above of a column which forms the memory 31 (in the column direction) beginning with a left side column toward a right side column as described hereinabove with reference to FIG. 16.

Then, if the writing of code bits ends with the lowermost bit in the rightmost column, then the code bits are read out and supplied to the replacement section 32 in a unit of 12 bits (mb bits) in the row direction beginning with the first row of all of the columns which form the memory 31.

The replacement section 32 carries out a replacement process of replacing the position of 12 code bits from the memory 31 in accordance with the fourth replacement method and outputs the 12 bits obtained by the replacement as 12 bits representative of two symbols (b symbols) of 64QAM, in particular, as 6 symbol bits $y_0$, $y_1$, $y_2$, $y_3$, $y_4$ and $y_5$ representative of one symbol of 64QAM and 6 symbol bits $y_0$, $y_1$, $y_2$, $y_3$, $y_4$ and $y_5$ representative of a next one symbol.

Here, B of FIG. 17 illustrates the fourth replacement method of the replacement process by the replacement section 32 of A of FIG. 17.

It is to be noted that, where the multiple b is 2 (similarly also where the multiple b is equal to or higher than 3), in the replacement process, mb code bits are allocated to mb symbol bits of b successive symbols. In the following description including description given with reference to FIG. 17, the i+1th bit from the most significant bit from among the mb symbol bits of the b successive symbols is represented as bit (symbol bit) $y_i$ for the convenience of description.

Moreover, which replacement method is optimum, that is, which replacement method provides improved error rate in an AWGN communication path, differs depends upon the encoding rate, code length and modulation method of LDPC code and so forth.

Now, parity interleave by the parity interleaver 23 of FIG. 8 is described with reference to FIGS. 18 to 20.

FIG. 18 shows (part of) a Tanner graph of the parity check matrix of the LDPC code.

If a plurality of (code bits corresponding to) variable nodes connecting to a check node such as two variable nodes suffer from an error such as erasure at the same time as shown in FIG. 18, then the check node returns a message of an equal probability representing that the probability that the value may be 0 and the probability that the value may be 1 are equal to each other to all variable nodes connecting to the check node. Therefore, if a plurality of variable nodes connecting to the same check node are placed into an erasure state or the like at the same time, then the performance in decoding is deteriorated.

Incidentally, an LDPC code outputted from the LDPC encoding section 21 of FIG. 8 and prescribed in the DVB-S.2 standard is an IRA code, and the parity matrix $H_T$ of the parity check matrix H has a staircase structure as shown in FIG. 10.

FIG. 19 illustrates a parity matrix $H_T$ having a staircase structure and a Tanner graph corresponding to the parity matrix $H_T$.

In particular, A of FIG. 19 illustrates a parity matrix $H_T$ having a staircase structure and B of FIG. 19 shows a Tanner graph corresponding to the parity matrix $H_T$ of A of FIG. 19.

Where the parity matrix $H_T$ has a staircase structure, in the Tanner graph of the parity matrix $H_T$, variable nodes of the LDPC code which correspond to a column of an element of the parity matrix $H_T$ having the value of 1 and whose message is determined using adjacent code bits (parity bits) are connected to the same check node.

Accordingly, if the adjacent parity bits described above are placed into an error state by burst errors, erasure or the like, then since a check node connecting to a plurality of variable nodes corresponding to the plural parity bits which have become an error (variable nodes whose message are to be determined using parity bits) returns a message of an equal probability representing that the probability that the value may be 0 and the probability that the value is 1 may be equal to each other to the variable nodes connecting to the check node, the performance of the decoding deteriorates. Then, where the burst length (number of bits which are made an error by a burst) is great, the performance of the decoding further deteriorates.

Therefore, in order to prevent the deterioration in performance of decoding described above, the parity interleaver 23 (FIG. 8) carries out interleave of interleaving parity bits of the LDPC code from the LDPC encoding section 21 to positions of other parity bits.

FIG. 20 illustrates a parity matrix $H_T$ of a parity check matrix H corresponding to the LDPC code after the parity interleave carried out by the parity interleaver 23 of FIG. 8.

Here, the information matrix $H_A$ of the parity check matrix H corresponding to the LDPC code prescribed in the DVB-S.2 standard and outputted from the LDPC encoding section 21 has a cyclic structure.

The cyclic structure signifies a structure wherein a certain column coincides with another column in a cyclically operated state and includes, for example, a structure wherein, for every P columns, the positions of the value 1 in the rows of the P columns coincide with positions to which the first one of the P columns is cyclically shifted in the column direction by a value which increases in proportion to a value q obtained by dividing the parity length M. In the following, the number of P columns in a cyclic structure is hereinafter referred to suitably as a unit column number of the cyclic structure.

As an LDPC code prescribed in the DVB-S.2 standard and outputted from the LDPC encoding section 21, two LDPC codes are available including those whose code length N is 64,800 bits and 16,200 bits as described hereinabove with reference to FIG. 11.

Now, if attention is paid to the LDPC code whose code length N is 64,800 bits from the two different LDPC codes whose code length N is 64,800 bits and 16,200 bits, then eleven different encoding rates are available as the encoding rate of the LDPC code whose code length N is 64,800 bits as described hereinabove with reference to FIG. 11.

With regard to LDPC codes whose code length N is 64,800 bits and which have the eleven different encoding rates, it is prescribed in the DVB-S.2 standard that the column number P of the cyclic structure is prescribed to 360 which is one of divisors of the parity length M except 1 and M.

Further, with regard to LDPC codes whose code length N is 64,800 bits and which have the eleven different encoding rates, the parity length M has a value other than prime numbers and represented by an expression $M = q \times P = q \times 360$ using the value q which is different depending upon the encoding rate. Accordingly, also the value q is one of the divisors of the parity length M except 1 and M similarly to the column number P of the cyclic structure and is obtained by dividing the parity length M by the column number P of the cyclic structure (the product of P and q which are divisors of the parity length M is the parity length M).

Where the information length is represented by K and an integer higher than 0 but lower than P is represented by x while an integer higher than 0 but lower than q is represented by y, the parity interleaver 23 interleaves, as parity interleave, the K+qx+y+1th code bit from among parity bits which are K+1th to K+Mth (K + M = N) bits of the LDPC code from the LDPC encoding section 21 to the position of the K+Py+x+1th code bit.

According to such parity interleave, since the (parity bits corresponding to) variable nodes connecting to the same check node are spaced by a distance corresponding to the column number P of the cyclic structure, here, by 360 bits, where the burst length is smaller than 360 bits, such a situation that a plurality of variable nodes connecting to the same check node are rendered erroneous at the same time can be prevented. As a result, the tolerance to a burst error can be improved.

It is to be noted that the LDPC code after the parity interleave by which the K+qx+y+1th code bit is interleaved to the position of the K+Py+x+1th code bit coincides with the LDPC code of a parity check matrix (hereinafter referred to also as conversion parity check matrix) obtained by column replacement of replacing the K+qx+y+1th column of the original parity check matrix H into the K+Py+x+1th column.

Further, in the parity matrix of the conversion parity check matrix, a pseudo cyclic structure whose unit is P columns (in FIG. 20, 360 columns) appears as seen in FIG. 20.

Here, the pseudo cyclic structure signifies a structure which has a portion having a cyclic structure except part thereof. In a conversion parity check column obtained by applying column replacement corresponding to parity interleave to the parity check matrix of the LDPC code prescribed in the DVB-S.2 standard, a portion of 360 rows × 360 columns (shift matrix hereinafter described) at a right corner portion is short of one element of 1 (which has the value of 0). Therefore, the conversion parity check matrix does not have a (complete) cyclic structure but has a pseudo cyclic structure.

It is to be noted that the conversion parity check matrix of FIG. 20 is a matrix to which also replacement of rows (row replacement) for configuring the conversion parity check matrix from a configuration matrix hereinafter described is applied to the original parity check matrix H in addition to the column replacement which corresponds to parity interleave.

Now, column twist interleave as a re-arrangement process by the column twist interleaver 24 of FIG. 8 is described with reference to FIGS. 21 to 24.

In the transmission apparatus 11 of FIG. 8, two or more of the code bits of the LDPC code are transmitted as one symbol as described hereinabove in order to improve the utilization efficiency of frequencies. In particular, for example, where 2 bits of the code bits are used to form one symbol, for example, QPSK is used as the modulation method, but where 4 bits of the code bits are used to form one symbol, for example, 16QAM is used as the modulation method.

Where two or more ones of the code bits are transmitted as one symbol in this manner, if erasure or the like occurs with a certain symbol, the all of the code bits of the symbol become an error (erasure).

Accordingly, in order to lower the probability that a plurality of (code bits corresponding to) variable nodes connecting to the same check node may suffer from erasure at the same time to improve the performance in decoding, it is necessary to avoid the variable nodes corresponding to code bits of one symbol from connecting to the same check node.

Meanwhile, in the parity check matrix H of an LDPC code prescribed in the DVB-S.2 standard and outputted from the LDPC encoding section 21, the information matrix $H_A$ has a cyclic structure and the parity matrix $H_T$ has a staircase structure as described hereinabove. Then, in a conversion parity check matrix which is a parity check matrix of the LDPC code after parity interleave, a cyclic structure (accurately, a pseudo cyclic structure as described hereinabove) appears also in the parity matrix as described in FIG. 20.

FIG. 21 shows a conversion parity check matrix.

In particular, A of FIG. 21 illustrates a conversion parity check matrix of a parity check matrix H which has a code length N of 64,800 bits and an encoding rate (r) of 3/4.

In A of FIG. 21, the position of an element having the value of 1 in the conversion parity check matrix is indicated by a dot (·).

In FIG. 21B, a process carried out by the demultiplexer 25 (FIG. 8) for the LDPC code of the conversion parity matrix of A of FIG. 21, that is, the LDPC code after the parity interleave.

In FIG. 21B, the code bits of the LDPC code after the parity interleave are written in the column direction in four columns which form the memory 31 of the demultiplexer 25 using 16QAM as the modulation method.

The code bits written in the column direction in the four columns which form the memory 31 are read out in the row direction in a unit of 4 bits which make one symbol.

In this instance, the 4 code bits $B_0$, $B_1$, $B_2$ and $B_3$ which make one symbol sometimes make code bits corresponding to 1 and included in one arbitrary row of the parity check matrix after the conversion of A of FIG. 21, and in this instance, variable nodes corresponding to the code bits $B_0$, $B_1$, $B_2$ and $B_3$ are connected to the same check node.

Accordingly, where the 4 code bits $B_0$, $B_1$, $B_2$ and $B_3$ of one symbol become code bits corresponding to 1 and included in one arbitrary row, if erasure occurs with the symbol, then the same check node to which the variable nodes corresponding to the code bits $B_0$, $B_1$, $B_2$ and $B_3$ are connected cannot determine an appropriate message. As a result, the performance in decoding deteriorates.

Also with regard to the encoding rates other than the encoding rate of 3/4, a plurality of code bits corresponding to a plurality of variable nodes connecting to the same check node sometimes make one symbol of 16QAM similarly.

Therefore, the column twist interleaver 24 carries out column twist interleave wherein the code bits of the LDPC code after the parity interleave from the parity interleaver 23 are interleaved such that a plurality of code bits corresponding to 1 and included in one arbitrary row of the conversion parity check matrix are not included to one symbol.

FIG. 22 is a view illustrating the column twist interleave.

In particular, FIG. 22 illustrates the memory 31 (FIGS. 16 and 17) of the demultiplexer 25.

The memory 31 has a storage capacity for storing mb bits in the column (vertical) direction and stores N/(mb) bits in the row (horizontal) direction and includes mb columns as described in FIG. 16. Then, the column twist interleaver 24 writes the code bits of the LDPC code in the column direction into the memory 31 and controls the writing starting position when the code bits are read out in the row direction to carry out column twist interleave.

In particular, the column twist interleaver 24 suitably changes the writing starting position at which writing of code bits is to be started for each of a plurality of columns so that a plurality of code bits read out in the row direction and used to make one symbol may not become code bits corresponding to 1 and included in one arbitrary row of the conversion parity check matrix (re-arranges the code bits of the LDPC code such that a plurality of code bits corresponding to 1 and included in one arbitrary row of the parity check matrix may not be included in the same symbol).

Here, FIG. 22 shows an example of a configuration of the memory 31 where the modulation method is 16QAM and besides the multiple b described hereinabove with reference to FIG. 16 is 1. Accordingly, the bit number m of code bits of an LDPC code to be one symbol is 4 bits, and the memory 31 is formed from four (= mb) columns.

The column twist interleaver 24 (instead of the demultiplexer 25 shown in FIG. 16) carries out writing of the code bits of the LDPC code in a downward direction (column direction) from above into the four columns which form the memory 31 beginning with a left side column towards a right side column.

Then, when the writing of code bits ends to the rightmost column, the column twist interleaver 24 reads out the code bits in a unit of 4 bits (mb bits) in the row direction beginning with the first row of all columns which form the memory 31 and outputs the code bits as an LDPC code after the column twist interleave to the replacement section 32 (FIGS. 16 and 17) of the demultiplexer 25.

However, if the address of the head (uppermost) position of each column is represented by 0 and the addresses of the positions in the column direction are represented by integers of an ascending order, then the column twist interleaver 24 sets, for the leftmost column, the writing starting position to the position whose address is 0; sets, for the second column (from the left), the writing starting position to the position whose address is 2; sets, for the third column, the writing starting position to the position whose address is 4; and sets, for the fourth column, the writing starting position to the position whose address is 7.

It is to be noted that, with regard to the columns for which the writing starting position is any other position than the position whose address is 0, after the code bits are written down to the lowermost position, the writing position returns to the top (position whose address is 0) and writing down to a position immediately preceding to the writing starting position is carried out. Thereafter, writing into the next (right) column is carried out.

By carrying out such column twist interleave as described above, such a situation that a plurality of code bits corresponding to a plurality of variable nodes connecting to the same check node are made one symbol of 16QAM (included into the same symbol) with regard to LDPC codes of all encoding rates whose code length N is 64,800 as prescribed in the DVB-S.2 standard can be prevented, and as a result, the performance in decoding in a communication path which provides erasure can be improved.

FIG. 23 illustrates the number of columns of the memory 31 necessary for column twist interleave and the address of the writing starting position for each modulation method with regard to LDPC codes of the eleven different encoding rates having the code length N of 64,800 as prescribed in the DVB-S.2 standard.

Where the multiple b is 1 and besides, since, for example, QPSK is adopted as the modulation method, the bit number m of one symbol is 2 bits, according to FIG. 23, the memory 31 has two columns for storing $2 \times 1$ (= mb) bits in the row direction and stores $64{,}800/(-2 \times 1)$ bits in the column direction.

Then, the writing starting position for the first one of the two columns of the memory 31 is set to the position whose address is 0, and the writing starting position for the second column is set to the position whose address is 2.

It is to be noted that the multiple b is 1, for example, where one of the first to third replacement methods of FIG. 16 is adopted as the replacement method of the replacement process of the demultiplexer 25 (FIG. 8) or in a like case.

Where the multiple b is 2 and besides, since, for example, QPSK is adopted as the modulation method, the bit number m of one symbol is 2 bits, according to FIG. 23, the memory 31 has four columns for storing $2 \times 2$ bits in the row direction and stores $64{,}800/(2 \times 2)$ bits in the column direction.

Then, the writing starting position for the first one of the four columns of the memory 31 is set to the position whose address is 0, the writing starting position for the second column is set to the position whose address is 2, the writing starting position for the third column is set to the position whose address is 4, and the writing starting position for the fourth column is set to the position whose address is 7.

It is to be noted that the multiple b is 2, for example, where fourth replacement method of FIG. 17 is adopted as the replacement method of the replacement process of the demultiplexer 25 (FIG. 8).

Where the multiple b is 1 and besides, since, for example, 16QAM is adopted as the modulation method, the bit number m of one symbol is 4 bits, according to FIG. 23, the memory 31 has four columns for storing $4 \times 1$ bits in the row direction and stores $64{,}800/(4 \times 1)$ bits in the column direction.

Then, the writing starting position for the first one of the four columns of the memory 31 is set to the position whose address is 0, the writing starting position for the second column is set to the position whose address is 2, the writing starting position for the third column is set to the position whose address is 4, and the writing starting position for the fourth column is set to the position whose address is 7.

Where the multiple b is 2 and besides, since, for example, 16QAM is adopted as the modulation method, the bit number m of one symbol is 4 bits, according to FIG. 23, the memory 31 has eight columns for storing $4 \times 2$ bits in

the row direction and stores 64,800/(4 × 2) bits in the column direction.

Then, the writing starting position for the first one of the eight columns of the memory 31 is set to the position whose address is 0, the writing starting position for the second column is set to the position whose address is 0, the writing starting position for the third column is set to the position whose address is 2, the writing starting position for the fourth column is set to the position whose address is 4, the writing starting position for the fifth column is set to the position whose address is 4, the writing starting position for the sixth column is set to the position whose address is 5, the writing starting position for the seventh column is set to the position whose address is 7, and the writing starting position for the eighth column is set to the position whose address is 7.

Where the multiple b is 1 and besides, since, for example, 64QAM is adopted as the modulation method, the bit number m of one symbol is 6 bits, according to FIG. 23, the memory 31 has six columns for storing 6 × 1 bits in the row direction and stores 64,800/(6 × 1) bits in the column direction.

Then, the writing starting position for the first one of the six columns of the memory 31 is set to the position whose address is 0, the writing starting position for the second column is set to the position whose address is 2, the writing starting position for the third column is set to the position whose address is 5, the writing starting position for the fourth column is set to the position whose address is 9 the writing starting position for the fifth column is set to the position whose address is 10, and the writing starting position for the sixth column is set to the position whose address is 13.

Where the multiple b is 2 and besides, since, for example, 64QAM is adopted as the modulation method, the bit number m of one symbol is 6 bits, according to FIG. 23, the memory 31 has twelve columns for storing 6 × 2 bits in the row direction and stores 64,800/(6 × 2) bits in the column direction.

Then, the writing starting position for the first one of the twelve columns of the memory 31 is set to the position whose address is 0, the writing starting position for the second column is set to the position whose address is 0, the writing starting position for the third column is set to the position whose address is 2, the writing starting position for the fourth column is set to the position whose address is 2, the writing starting position for the fifth column is set to the position whose address is 3, the writing starting position for the sixth column is set to the position whose address is 4, the writing starting position for the seventh column is set to the position whose address is 4, the writing starting position for the eighth column is set to the position whose address is 5, the writing starting position for the ninth column is set to the position whose address is 5, the writing starting position for the tenth column is set to the position whose address is 7, the writing starting position for the eleventh column is set to the position whose address is 8, and the writing starting position for the twelfth column is set to the position whose address is 9.

Where the multiple b is 1 and besides, since, for example, 256QAM is adopted as the modulation method, the bit number m of one symbol is 8 bits, according to FIG. 23, the memory 31 has eight columns for storing 8 × 1 bits in the row direction and stores 64,800/(8 × 1) bits in the column direction.

Then, the writing starting position for the first one of the eight columns of the memory 31 is set to the position whose address is 0, the writing starting position for the second column is set to the position whose address is 0, the writing starting position for the third column is set to the position whose address is 2, the writing starting position for the fourth column is set to the position whose address is 4, the writing starting position for the fifth column is set to the position whose address is 4, the writing starting position for the sixth column is set to the position whose address is 5, the writing starting position for the seventh column is set to the position whose address is 7, and the writing starting position for the eighth column is set to the position whose address is 7.

Where the multiple b is 2 and besides, since, for example, 256QAM is adopted as the modulation method, the bit number m of one symbol is 8 bits, according to FIG. 23, the memory 31 has sixteenth columns for storing 8 × 2 bits in the row direction and stores 64,800/(8 × 2) bits in the column direction.

Then, the writing starting position for the first one of the sixteen columns of the memory 31 is set to the position whose address is 0, the writing starting position for the second column is set to the position whose address is 2, the writing starting position for the third column is set to the position whose address is 2, the writing starting position for the fourth column is set to the position whose address is 2, the writing starting position for the fifth column is set to the position whose address is 2, the writing starting position for the sixth column is set to the position whose address is 3, the writing starting position for the seventh column is set to the position whose address is 7, the writing starting position for the eighth column is set to the position whose address is 15, the writing starting position for the ninth column is set to the position whose address is 16, the writing starting position for the tenth column is set to the position whose address is 20, the writing starting position for the eleventh column is set to the position whose address is 22, the writing starting position for the twelfth column is set to the position whose address is 22, the writing starting position for the thirteenth column is set to the position whose address is 27, the writing starting position for the fourteenth column is set to the position whose address is 27, the writing starting position for the fifteenth column is set to the position whose address is 28, and the writing starting position for the sixteenth column is set to the position whose address is 32.

Where the multiple b is 1 and besides, since, for example, 1024QAM is adopted as the modulation method, the bit number m of one symbol is 10 bits, according to FIG. 23, the memory 31 has ten columns for storing 10 × 1 bits in the row direction and stores 64,800/(10 × 1) bits in the column direction.

Then, the writing starting position for the first one of the ten columns of the memory 31 is set to the position whose address is 0, the writing starting position for the second column is set to the position whose address is 3, the writing starting position for the third column is set to the position whose address is 6, the writing starting position for the fourth column is set to the position whose address is 8, the writing starting position for the fifth column is set to the position whose address is 11, the writing starting position for the sixth column is set to the position whose address is 13, the writing starting position for the seventh column is set to the position whose address is 15, the writing starting position for the eighth column is set to the position whose address is 17, the writing starting position for the ninth column is set to the position whose address is 18, and the writing starting position for the tenth column is set to the position whose address is 20.

Where the multiple b is 2 and besides, since, for example, 1024QAM is adopted as the modulation method, the bit number m of one symbol is 10 bits, according to FIG. 23, the memory 31 has twenty columns for storing $10 \times 2$ bits in the row direction and stores $64{,}800/(10 \times 2)$ bits in the column direction.

Then, the writing starting position for the first one of the twenty columns of the memory 31 is set to the position whose address is 0, the writing starting position for the second column is set to the position whose address is 1, the writing starting position for the third column is set to the position whose address is 3, the writing starting position for the fourth column is set to the position whose address is 4, the writing starting position for the fifth column is set to the position whose address is 5, the writing starting position for the sixth column is set to the position whose address is 6, the writing starting position for the seventh column is set to the position whose address is 6, the writing starting position for the eighth column is set to the position whose address is 9, the writing starting position for the ninth column is set to the position whose address is 13, the writing starting position for the tenth column is set to the position whose address is 14, the writing starting position for the eleventh column is set to the position whose address is 14, the writing starting position for the twelfth column is set to the position whose address is 16, the writing starting position for the thirteenth column is set to the position whose address is 21, the writing starting position for the fourteenth column is set to the position whose address is 21, the writing starting position for the fifteenth column is set to the position whose address is 23, the writing starting position for the sixteenth column is set to the position whose address is 25, the writing starting position for the seventeenth column is set to the position whose address is 25, the writing starting position for the eighteenth column is set to the position whose address is 26, the writing starting position for the nineteenth column is set to the position whose address is 28, and the writing starting position for the twentieth column is set to the position whose address is 30.

Where the multiple b is 1 and besides, since, for example, 4096QAM is adopted as the modulation method, the bit number m of one symbol is 12 bits, according to FIG. 23, the memory 31 has twelve columns for storing $12 \times 1$ bits in the row direction and stores $64{,}800/(12 \times 1)$ bits in the column direction.

Then, the writing starting position for the first one of the twelve columns of the memory 31 is set to the position whose address is 0, the writing starting position for the second column is set to the position whose address is 0, the writing starting position for the third column is set to the position whose address is 2, the writing starting position for the fourth column is set to the position whose address is 2, the writing starting position for the fifth column is set to the position whose address is 3, the writing starting position for the sixth column is set to the position whose address is 4, the writing starting position for the seventh column is set to the position whose address is 4, the writing starting position for the eighth column is set to the position whose address is 5, the writing starting position for the ninth column is set to the position whose address is 5, the writing starting position for the tenth column is set to the position whose address is 7, the writing starting position for the eleventh column is set to the position whose address is 8, and the writing starting position for the twelfth column is set to the position whose address is 9.

Where the multiple b is 2 and besides, since, for example, 4096QAM is adopted as the modulation method, the bit number m of one symbol is 12 bits, according to FIG. 23, the memory 31 has twenty-four columns for storing $12 \times 2$ bits in the row direction and stores $64{,}800/(12 \times 2)$ bits in the column direction.

Then, the writing starting position for the first one of the twenty-four columns of the memory 31 is set to the position whose address is 0, the writing starting position for the second column is set to the position whose address is 5, the writing starting position for the third column is set to the position whose address is 8, the writing starting position for the fourth column is set to the position whose address is 8, the writing starting position for the fifth column is set to the position whose address is 8, the writing starting position for the sixth column is set to the position whose address is 8, the writing starting position for the seventh column is set to the position whose address is 10, the writing starting position for the eighth column is set to the position whose address is 10, the writing starting position for the ninth column is set to the position whose address is 10, the writing starting position for the tenth column is set to the position whose address is 12, the writing starting position for the eleventh column is set to the position whose address is 13, the writing starting position for the twelfth column is set to the position whose address is 16, the writing starting position for the thirteenth column is set to the position whose address is 17, the writing starting position for the fourteenth column is set to the position whose address is 19, the writing starting position for the fifteenth column is set to the position whose address is 21, the writing starting position for the sixteenth column is set to the position whose address is 22, the writing starting position for the seventeenth column is set to the position whose address is 23, the writing starting position for the eighteenth column is set to the position whose address is 26, the writing starting position for the nineteenth column is set to the position whose address is 37, the writing starting position for the twentieth column is set to the position whose address is 39, the writing starting position for the twenty-first column is set to the position whose address is 40, the writing starting position for the twenty-second column is set to the position whose address is 41, the writing starting position for the twenty-third column is set to the position whose address is 41, and the writing starting position for the twenty-fourth column is set to the position whose address is 41.

FIG. 24 indicates the number of columns of the memory 31 necessary for column twist interleave and the address of the writing starting position for each modulation method with regard to the LDPC codes of the 10 different encoding rates having the code length N of 16,200 as prescribed in the DVB-S.2 standard.

Where the multiple b is 1 and besides, since, for example, QPSK is adopted as the modulation method, the bit number m of one symbol is 2 bits, according to FIG. 24, the memory 31 has two columns for storing $2 \times 1$ bits in the row direction and stores $16{,}200/(2 \times 1)$ bits in the column direction.

Then, the writing starting position for the first one of the two columns of the memory 31 is set to the position whose address is 0, and the writing starting position for the second column is set to the position whose address is 0.

Where the multiple b is 2 and besides, since, for example, QPSK is adopted as the modulation method, the bit number m of one symbol is 2 bits, according to FIG. 24, the memory 31 has four columns for storing $2 \times 2$ bits in the row direction and stores $16{,}200/(2 \times 2)$ bits in the column direction.

Then, the writing starting position for the first one of the four columns of the memory 31 is set to the position whose address is 0, the writing starting position for the second column is set to the position whose address is 2, the writing starting position for the third column is set to the position whose address is 3, and the writing starting position for the fourth column is set to the position whose address is 3.

Where the multiple b is 1 and besides, since, for example, 16QAM is adopted as the modulation method, the bit number m of one symbol is 4 bits, according to FIG. 24, the memory 31 has four columns for storing $4 \times 1$ bits in the row direction and stores $16{,}200/(4 \times 1)$ bits in the column direction.

Then, the writing starting position for the first one of the four columns of the memory 31 is set to the position whose address is 0, the writing starting position for the second column is set to the position whose address is 2, the writing starting position for the third column is set to the position whose address is 3, and the writing starting position for the fourth column is set to the position whose address is 3.

Where the multiple b is 2 and besides, since, for example, 16QAM is adopted as the modulation method, the bit number m of one symbol is 4 bits, according to FIG. 24, the memory 31 has eight columns for storing $4 \times 2$ bits in the row direction and stores $16{,}200/(4 \times 2)$ bits in the column direction.

Then, the writing starting position for the first one of the eight columns of the memory 31 is set to the position whose address is 0, the writing starting position for the second column is set to the position whose address is 0, the writing starting position for the third column is set to the position whose address is 0, the writing starting position for the fourth column is set to the position whose address is 1, the writing starting position for the fifth column is set to the position whose address is 7, the writing starting position for the sixth column is set to the position whose address is 20, the writing starting position for the seventh column is set to the position whose address is 20, and the writing starting position for the eighth column is set to the position whose address is 21.

Where the multiple b is 1 and besides, since, for example, 64QAM is adopted as the modulation method, the bit number m of one symbol is 6 bits, according to FIG. 24, the memory 31 has six columns for storing $6 \times 1$ bits in the row direction and stores $16{,}200/(6 \times 1)$ bits in the column direction.

Then, the writing starting position for the first one of the six columns of the memory 31 is set to the position whose address is 0, the writing starting position for the second column is set to the position whose address is 0, the writing starting position for the third column is set to the position whose address is 2, the writing starting position for the fourth column is set to the position whose address is 3

the writing starting position for the fifth column is set to the position whose address is 7, and the writing starting position for the sixth column is set to the position whose address is 7.

Where the multiple b is 2 and besides, since, for example, 64QAM is adopted as the modulation method, the bit number m of one symbol is 6 bits, according to FIG. 24, the memory 31 has twelve columns for storing $6 \times 2$ bits in the row direction and stores $16{,}200/(6 \times 2)$ bits in the column direction.

Then, the writing starting position for the first one of the twelve columns of the memory 31 is set to the position whose address is 0, the writing starting position for the second column is set to the position whose address is 0, the writing starting position for the third column is set to the position whose address is 0, the writing starting position for the fourth column is set to the position whose address is 2, the writing starting position for the fifth column is set to the position whose address is 2, the writing starting position for the sixth column is set to the position whose address is 2, the writing starting position for the seventh column is set to the position whose address is 3, the writing starting position for the eighth column is set to the position whose address is 3, the writing starting position for the ninth column is set to the position whose address is 3, the writing starting position for the tenth column is set to the position whose address is 6, the writing starting position for the eleventh column is set to the position whose address is 7, and the writing starting position for the twelfth column is set to the position whose address is 7.

Where the multiple b is 1 and besides, since, for example, 256QAM is adopted as the modulation method, the bit number m of one symbol is 8 bits, according to FIG. 24, the memory 31 has eight columns for storing 8 × 1 bits in the row direction and stores 16,200/(8 × 1) bits in the column direction.

Then, the writing starting position for the first one of the eight columns of the memory 31 is set to the position whose address is 0, the writing starting position for the second column is set to the position whose address is 0, the writing starting position for the third column is set to the position whose address is 0, the writing starting position for the fourth column is set to the position whose address is 1, the writing starting position for the fifth column is set to the position whose address is 7, the writing starting position for the sixth column is set to the position whose address is 20, the writing starting position for the seventh column is set to the position whose address is 20, and the writing starting position for the eighth column is set to the position whose address is 21.

Where the multiple b is 1 and besides, since, for example, 1024QAM is adopted as the modulation method, the bit number m of one symbol is 10 bits, according to FIG. 24, the memory 31 has ten columns for storing 10 × 1 bits in the row direction and stores 16,200/(10 × 1) bits in the column direction.

Then, the writing starting position for the first one of the ten columns of the memory 31 is set to the position whose address is 0, the writing starting position for the second column is set to the position whose address is 1, the writing starting position for the third column is set to the position whose address is 2, the writing starting position for the fourth column is set to the position whose address is 2, the writing starting position for the fifth column is set to the position whose address is 3, the writing starting position for the sixth column is set to the position whose address is 3, the writing starting position for the seventh column is set to the position whose address is 4, the writing starting position for the eighth column is set to the position whose address is 4, the writing starting position for the ninth column is set to the position whose address is 5, and the writing starting position for the tenth column is set to the position whose address is 7.

Where the multiple b is 2 and besides, since, for example, 1024QAM is adopted as the modulation method, the bit number m of one symbol is 10 bits, according to FIG. 24, the memory 31 has twenty columns for storing 10 × 2 bits in the row direction and stores 16,200/(10 × 2) bits in the column direction.

Then, the writing starting position for the first one of the twenty columns of the memory 31 is set to the position whose address is 0, the writing starting position for the second column is set to the position whose address is 0, the writing starting position for the third column is set to the position whose address is 0, the writing starting position for the fourth column is set to the position whose address is 2, the writing starting position for the fifth column is set to the position whose address is 2, the writing starting position for the sixth column is set to the position whose address is 2, the writing starting position for the seventh column is set to the position whose address is 2, the writing starting position for the eighth column is set to the position whose address is 2, the writing starting position for the ninth column is set to the position whose address is 5, the writing starting position for the tenth column is set to the position whose address is 5, the writing starting position for the eleventh column is set to the position whose address is 5, the writing starting position for the twelfth column is set to the position whose address is 5, the writing starting position for the thirteenth column is set to the position whose address is 5, the writing starting position for the fourteenth column is set to the position whose address is 7, the writing starting position for the fifteenth column is set to the position whose address is 7, the writing starting position for the sixteenth column is set to the position whose address is 7, the writing starting position for the seventeenth column is set to the position whose address is 7, the writing starting position for the eighteenth column is set to the position whose address is 8, the writing starting position for the nineteenth column is set to the position whose address is 8, and the writing starting position for the twentieth column is set to the position whose address is 10.

Where the multiple b is 1 and besides, since, for example, 4096QAM is adopted as the modulation method, the bit number m of one symbol is 12 bits, according to FIG. 24, the memory 31 has twelve columns for storing 12 × 1 bits in the row direction and stores 16,200/(12 × 1) bits in the column direction.

Then, the writing starting position for the first one of the twelve columns of the memory 31 is set to the position whose address is 0, the writing starting position for the second column is set to the position whose address is 0, the writing starting position for the third column is set to the position whose address is 0, the writing starting position for the fourth column is set to the position whose address is 2, the writing starting position for the fifth column is set to the position whose address is 2, the writing starting position for the sixth column is set to the position whose address is 2, the writing starting position for the seventh column is set to the position whose address is 3, the writing starting position for the eighth column is set to the position whose address is 3, the writing starting position for the ninth column is set to the position whose address is 3, the writing starting position for the tenth column is set to the position whose address is 6, the writing starting position for the eleventh column is set to the position whose address is 7, and the writing starting position for the twelfth column is set to the position whose address is 7.

Where the multiple b is 2 and besides, since, for example, 4096QAM is adopted as the modulation method, the bit number m of one symbol is 12 bits, according to FIG. 24, the memory 31 has twenty-four columns for storing 12 $\times$ 2 bits in the row direction and stores 16,200/(12 $\times$ 2) bits in the column direction.

Then, the writing starting position for the first one of the twenty-four columns of the memory 31 is set to the position whose address is 0, the writing starting position for the second column is set to the position whose address is 0, the writing starting position for the third column is set to the position whose address is 0, the writing starting position for the fourth column is set to the position whose address is 0, the writing starting position for the fifth column is set to the position whose address is 0, the writing starting position for the sixth column is set to the position whose address is 0, the writing starting position for the seventh column is set to the position whose address is 0, the writing starting position for the eighth column is set to the position whose address is 1, the writing starting position for the ninth column is set to the position whose address is 1, the writing starting position for the tenth column is set to the position whose address is 1, the writing starting position for the eleventh column is set to the position whose address is 2, the writing starting position for the twelfth column is set to the position whose address is 2, the writing starting position for the thirteenth column is set to the position whose address is 2, the writing starting position for the fourteenth column is set to the position whose address is 3, the writing starting position for the fifteenth column is set to the position whose address is 7, the writing starting position for the sixteenth column is set to the position whose address is 9, the writing starting position for the seventeenth column is set to the position whose address is 9, the writing starting position for the eighteenth column is set to the position whose address is 9, the writing starting position for the nineteenth column is set to the position whose address is 10, the writing starting position for the twentieth column is set to the position whose address is 10, the writing starting position for the twenty-first column is set to the position whose address is 10, the writing starting position for the twenty-second column is set to the position whose address is 10, the writing starting position for the twenty-third column is set to the position whose address is 10, and the writing starting position for the twenty-fourth column is set to the position whose address is 11.

Now, a transmission process carried out by the transmission apparatus 11 of FIG. 8 is described with reference to a flow chart of FIG. 25.

The LDPC encoding section 21 waits that object data are supplied thereto and, at step S101, encodes the object data into LDPC codes and supplies the LDCP codes to the bit interleaver 22. Thereafter, the processing advances to step S102.

At step S102, the bit interleaver 22 carries out bit interleave for the LDPC codes from the LDPC encoding section 21 and supplies to the mapping section 26 a symbol in which the LDPC codes after the interleave are symbolized. Thereafter, the processing advances to step S103.

In particular, at step S102, the parity interleaver 23 in the bit interleaver 22 carries out parity interleave for the LDPC codes from the LDPC encoding section 21 and supplies the LDPC codes after the parity interleave to the column twist interleaver 24.

The column twist interleaver 24 carries out column twist interleave for the LDPC code from the parity interleaver 23 and supplies a result of the column twist interleave to the demultiplexer 25.

The demultiplexer 25 carries out a replacement process of replacing the code bits of the LDPC code after the column twist interleave by the column twist interleaver 24 and converting the code bits after the replacement into symbol bits (bits representative of symbols) of symbols.

Here, the replacement process by the demultiplexer 25 can be carried out in accordance with the first to fourth replacement methods described hereinabove with reference to FIGS. 16 and 17 and besides can be carried out in accordance with an allocation rule. The allocation rule is a rule for allocating code bits of an LDPC code to symbol bits representative of symbols, and details of the allocation rule are hereinafter described.

The symbols obtained by the replacement process by the demultiplexer 25 are supplied from the demultiplexer 25 to the mapping section 26.

At step S103, the mapping section 26 maps the symbol from the demultiplexer 25 to signal points defined by the modulation method of orthogonal modulation carried out by the orthogonal modulation section 27 and supplies the mapped symbol to the orthogonal modulation section 27. Then, the processing advances to step S104.

At step S104, the orthogonal modulation section 27 carries out orthogonal modulation of a carrier in accordance with the signal points from the mapping section 26. Then, the processing advances to step S105, at which the modulation signal obtained as a result of the orthogonal modulation is transmitted, whereafter the processing is ended.

It is to be noted that the transmission process of FIG. 25 is carried out by pipeline repetitively.

By carrying out the parity interleave and the column twist interleave as described above, the tolerance to erasure or burst errors where a plurality of code bits of an LDPC codes are transmitted as one symbol can be improved.

Here, while, in FIG. 8, the parity interleaver 23 which is a block for carrying out parity interleave and the column twist interleaver 24 which is a block for carrying out column twist interleave are configured separately from each other for the convenience of description, the parity interleaver 23 and the column twist interleaver 24 may otherwise be configured integrally with each other.

In particular, both of the parity interleave and the column twist interleave can be carried out by writing and reading out of code bits into and from a memory and can be represented by a matrix for converting addresses (write addresses) into which writing of code bits is to be carried out into addresses (readout addresses) from which reading out of code bits is to be carried out.

Accordingly, if a matrix obtained by multiplying a matrix representative of the parity interleave and a matrix representative of the column twist interleave is determined in advance, then if the matrix is used to convert code bits, then a result when parity interleave is carried out and then LDPC codes after the parity interleave are column twist interleaved can be obtained.

Further, in addition to the parity interleaver 23 and the column twist interleaver 24, also the demultiplexer 25 may be configured integrally.

In particular, also the replacement process carried out by the demultiplexer 25 can be represented by a matrix for converting a write address of the memory 31 for storing an LDPC code into a read address.

Accordingly, if a matrix obtained by multiplication of a matrix representative of the parity interleave, another matrix representative of the column twist interleave and a further matrix representative of the replacement process is determined in advance, then the parity interleave, column twist interleave and replacement process can be carried out collectively by the determined matrix.

It is to be noted that it is possible to carry-out only one of or no one of the parity interleave and the column twist interleave.

Now, a simulation carried out with regard to the transmission apparatus 11 of FIG. 8 for measuring the error rate (bit error rate) is described with reference to FIGS. 26 to 28.

The simulation was carried out adopting a communication path which has a flutter whose D/U is 0 dB.

FIG. 26 shows a model of the communication path adopted in the simulation.

In particular, A of FIG. 26 shows a model of the flutter adopted in the simulation.

Meanwhile, B of FIG. 26 shows a model of a communication path which has the flutter represented by the model of A of FIG. 26.

It is to be noted that, in B of FIG. 26, H represents the model of the flutter of A of FIG. 26. Further, in B of FIG. 26, N represents ICI (Inter Carrier Interference), and in the simulation, an expected value $E[N^2]$ of the power was approximated by AWGN.

FIGS. 27 and 28 illustrate relationships between the error rate obtained by the simulation and the Doppler frequency $f_d$ of the flutter.

It is to be noted that FIG. 27 illustrates a relationship between the error rate and the Doppler frequency $f_d$ where the modulation method is 16QAM and the encoding rate (r) is (3/4) and besides the replacement method is the first replacement method. Meanwhile, FIG. 28 illustrates the relationship between the error rate and the Doppler frequency $f_d$ where the modulation method is 64QAM and the encoding rate (r) is (5/6) and besides the replacement method is the first replacement method.

Further, in FIGS. 27 and 28, a thick line curve indicates the relationship between the error rate and the Doppler frequency $f_d$ where all of the parity interleave, column twist interleave and replacement process were carried out, and a thin line curve indicates the relationship between the error rate and the Doppler frequency $f_d$ where only the replacement process from among the parity interleave, column twist interleave and replacement process was carried out.

In both of FIGS. 27 and 28, it can be recognized that the error rate improves (decreases) where all of the parity interleave, column twist interleave and replacement process are carried out rather than where only the replacement process is carried out.

Now, the LDPC encoding section 21 of FIG. 8 is described furthermore.

As described referring to FIG. 11, in the DVB-S.2 standard, LDPC encoding of the two different code lengths N of 64,800 bits and 16,200 bits are prescribed.

And, for the LDPC code whose code length N is 64,800 bits, the 11 encoding rates 1/4, 1/3, 2/5, 1/2, 3/5, 2/3, 3/4, 4/5, 5/6, 8/9 and 9/10 are prescribed, and for the LDPC code whose code length N is 16,200 bits, the 10 encoding rates 1/4, 1/3, 2/5, 1/2, 3/5, 2/3, 3/4, 4/5, 5/6 and 8/9 are prescribed (B of FIG. 11).

The LDPC encoding section 21 carries out encoding (error correction encoding) into LDPC codes of the different encoding rates whose code length N is 64,800 bits or 16,200 bits in accordance with a parity check matrix H prepared for each code length N and for each encoding rate.

FIG. 29 shows an example of a configuration of the LDPC encoding section 21 of FIG. 8.

The LDPC encoding section 21 includes an encoding processing block 601 and a storage block 602.

The encoding processing block 601 includes an encoding rate setting portion 611, an initial value table reading out portion 612, a parity check matrix production portion 613, an information bit reading out portion 614, an encoding parity mathematical operation portion 615, and a control portion 616, and carries out LDPC encoding of object data supplied to the LDPC encoding section 21 and supplies an LDPC code obtained as a result of the LDPC encoding to the bit interleaver 22 (FIG. 8).

In particular, the encoding rate setting portion 611 sets a code length N and an encoding rate for LDPC codes, for example, in response to an operation of an operator.

The initial value table reading out portion 612 reads out a parity check matrix initial value table hereinafter described which corresponds to the code length N and the encoding rate set by the encoding rate setting portion 611 from the storage block 602.

The parity check matrix production portion 613 places, based on the parity check matrix initial value table read out by the initial value table reading out portion 612, elements of the value 1 of an information matrix $H_A$ corresponding to an information length K (= code length N - parity length M) corresponding to the code length N and the encoding rate set by the encoding rate setting portion 611 in a period of 360 columns (unit column number P of the cyclic structure) in the column direction to produce a parity check matrix H, and stores the parity check matrix H into the storage block 602.

The information bit reading out portion 614 reads out (extracts) information bits for the information length K from the object data supplied to the LDPC encoding section 21.

The encoding parity mathematical operation portion 615 reads out the parity check matrix H produced by the parity check matrix production portion 613 from the storage block 602 and calculates parity bits corresponding to the information bits read out by the information bit reading out portion 614 in accordance with a predetermined expression to produce a codeword (LDPC code).

The control portion 616 controls the blocks which compose the encoding processing block 601.

In the storage block 602, a plurality of parity check matrix initial value tables and so forth individually corresponding to the plural encoding rates illustrated in FIG. 11 in regard to individual ones of the two code lengths N of 64,800 bits and 16,200 bits are stored. Further, the storage block 602 temporarily stores data necessary for processing of the encoding processing block 601.

FIG. 30 is a flow chart illustrating a reception process carried out by the reception apparatus 12 of FIG. 29.

At step S201, the encoding rate setting portion 611 determines (sets) a code length N and an encoding rate r used for carrying out LDPC encoding.

At step S202, the initial value table reading out portion 612 reads out from the storage block 602 a predetermined parity check matrix initial value table corresponding to the code length N and the encoding rate r determined by the encoding rate setting portion 611.

At step S203, the parity check matrix production portion 613 determines (produces) a parity check matrix H for an LDPC code having the code length N and the encoding rate r determined by the encoding rate setting portion 611 using the parity check matrix initial value table read out from the storage block 602 by the initial value table reading out portion 612, and supplies the parity check matrix H to the storage block 602 so as to be stored.

At step S204, the information bit reading out portion 614 reads out information bits of the information length K (= N × r) corresponding to the code length N and the encoding rate r determined by the encoding rate setting portion 611 from among the object data supplied to the LDPC encoding section 21 and reads out the parity check matrix H determined by the parity check matrix production portion 613 from the storage block 602, and supplies the information bits and the parity check matrix H to the encoding parity mathematical operation portion 615.

At step S205, the encoding parity mathematical operation portion 615 successively mathematically operates a parity bit of a codeword c which satisfies an expression (8).

$$Hc^T = 0 \qquad \dots (8)$$

In the expression (8), c indicates a row vector as the codeword (LDPC code), and $c^T$ indicates inversion of the row vector c.

Here, as described above, where, from within the row vector c as an LDPC code (one codeword), a portion corresponding to the information bits is represented by a row vector A and a portion corresponding to the parity bits is represented by a row vector T, the row vector c can be represented by an expression c = [A|T] from the row vector A as the information bits and the row vector T as the parity bits.

It is necessary for the parity check matrix H and the row vector c = [A|T] as an LDPC code to satisfy the expression $Hc^T = 0$, and where the parity matrix $H_T$ of the parity check matrix H = $[H_A|H_T]$ has a staircase structure shown in FIG. 10, the row vector T as parity bits which configures the row vector c = [A|T] which satisfies the expression $Hc^T = 0$ can be determined sequentially by setting the elements of each row to zero in order beginning with the elements in the first row of the column vector $Hc^T$ in the expression $Hc^T = 0$.

If the encoding parity mathematical operation portion 615 determines a parity bit T for an information bit A, then it outputs a codeword c = [A|T] represented by the information bit A and the parity bit T as an LDPC encoding result of the information bit A.

It is to be noted that the codeword c has 64,800 bits or 16,200 bits.

Thereafter, at step S206, the control portion 616 decides whether or not the LDPC encoding should be ended. If it is decided at step S206 that the LDPC encoding should not be ended, that is, for example, if there remain object data to be LDPC encoded, then the processing returns to step S201, and thereafter, the processes at steps S201 to S206 are repeated.

On the other hand, if it is decided at step S206 that the LDPC encoding should be ended, that is, for example, if there remains no object data to be LDPC encoded, the LDPC encoding section 21 ends the processing.

As described above, the parity check matrix initial value tables corresponding to the code lengths N and the encoding rates r are prepared, and the LDPC encoding section 21 carries out LDPC encoding for a predetermined code length N and a predetermined encoding rate r using a parity check matrix H produced from a parity check matrix initial value table corresponding to the predetermined code length N and the predetermined encoding rate r.

Each parity check matrix initial value table is a table which represents the position of elements of the value 1 of the information matrix $H_A$ corresponding to the information length K corresponding to the code length N and the encoding rate r of the LDPC code of the parity check matrix H (LDPC code defined by the parity check matrix H) for every 360 rows (unit column number P of the periodic structure), and is produced in advance for a parity check matrix H for each code length N and each encoding rate r.

FIGS. 31 to 58 illustrate some of the parity check matrix initial value tables prescribed in the DVB-S.2 standard.

In particular, FIG. 31 shows the parity check matrix initial value table for a parity check matrix H prescribed in the DVB-S.2 standard and having a code length N of 16,200 bits and an encoding rate r of 2/3.

FIGS. 32 to 34 show the parity check matrix initial value table for a parity check matrix H prescribed in the DVB-S.2 standard and having a code length N of 64,800 bits and an encoding rate r of 2/3.

It is to be noted that FIG. 33 is a view continuing from FIG. 32 and FIG. 34 is a view continuing from FIG. 33.

FIG. 35 shows the parity check matrix initial value table for a parity check matrix H prescribed in the DVB-S.2 standard and having a code length N of 16,200 bits and an encoding rate r of 3/4.

FIGS. 36 to 39 show the parity check matrix initial value table for a parity check matrix H prescribed in the DVB-S.2 standard and having a code length N of 64,800 bits and an encoding rate r of 3/4.

It is to be noted that FIG. 37 is a view continuing from FIG. 36 and FIG. 38 is a view continuing from FIG. 37. Further, FIG. 39 is a view continuing from FIG. 38.

FIG. 40 shows the parity check matrix initial value table for a parity check matrix H prescribed in the DVB-S.2 standard and having a code length N of 16,200 bits and an encoding rate r of 4/5.

FIGS. 41 to 44 show the parity check matrix initial value table for a parity check matrix H prescribed in the DVB-S.2 standard and having a code length N of 64,800 bits and an encoding rate r of 4/5.

It is to be noted that FIG. 42 is a view continuing from FIG. 41 and FIG. 43 is a view continuing from FIG. 42. Further, FIG. 44 is a view continuing from FIG. 43.

FIG. 45 shows the parity check matrix initial value table for a parity check matrix H prescribed in the DVB-S.2 standard and having a code length N of 16,200 bits and an encoding rate r of 5/6.

FIGS. 46 to 49 show the parity check matrix initial value table for a parity check matrix H prescribed in the DVB-S.2 standard and having a code length N of 64,800 bits and an encoding rate r of 5/6.

It is to be noted that FIG. 47 is a view continuing from FIG. 46 and FIG. 48 is a view continuing from FIG. 47. Further, FIG. 49 is a view continuing from FIG. 48.

FIG. 50 shows the parity check matrix initial value table for a parity check matrix H prescribed in the DVB-S.2 standard and having a code length N of 16,200 bits and an encoding rate r of 8/9.

FIGS. 51 to 54 show the parity check matrix initial value table for a parity check matrix H prescribed in the DVB-S.2 standard and having a code length N of 64,800 bits and an encoding rate r of 8/9.

It is to be noted that FIG. 52 is a view continuing from FIG. 51 and FIG. 53 is a view continuing from FIG. 52. Further, FIG. 54 is a view continuing from FIG. 53.

FIGS. 55 to 58 show the parity check matrix initial value table for a parity check matrix H prescribed in the DVB-S.2 standard and having a code length N of 64,800 bits and an encoding rate r of 9/10.

It is to be noted that FIG. 56 is a view continuing from FIG. 55 and FIG. 57 is a view continuing from FIG. 56. Further, FIG. 58 is a view continuing from FIG. 57.

The parity check matrix production portion 613 (FIG. 29) determines a parity check matrix H in the following manner using the parity check matrix initial value tables.

In particular, FIG. 59 illustrates a method for determining a parity check matrix H from a parity check matrix initial value table.

It is to be noted that the parity check matrix initial value table of FIG. 59 indicates the parity check matrix initial value table for a parity check matrix H prescribed in the DVB-S.2 standard and having a code length N of 16,200 bits and an encoding rate r of 2/3 shown in FIG. 31.

As described above, the parity check matrix initial value table is a table which represents the position of elements of the value 1 of a information matrix $H_A$ (FIG. 9) corresponding to the information length K corresponding to the code length N and the encoding rate r of the LDPC code for every 360 columns (for every unit column number P of the cyclic structure), and in the first row of the parity check matrix initial value table, a number of row numbers of elements of the value 1 in the 1+360×(i-1)th column of the parity check matrix H (row numbers where the row number of the first row of the parity check matrix H is 0) equal to the number of column weights which the 1+360×(i-1)th column has.

Here, since the parity matrix $H_T$ (FIG. 9) of the parity check matrix H which corresponds to the parity length M is determined as illustrated in FIG. 19, according to the parity check matrix initial value table, the information matrix $H_A$ (FIG. 9) of the parity check matrix H corresponding to the information length K is determined.

The row number k+1 of the parity check matrix initial value table differs depending upon the information length K.

The information length K and the row number k+1 of the parity check matrix initial value table satisfy a relationship given by an expression (9).

$$K = (k + 1) \times 360 \quad ...(9)$$

Here, 360 in the expression (9) is the unit column number P of the cyclic structure described referring to FTG. 20.

In the parity check matrix initial value table of FIG. 59, 13 numerical values are listed in the first to third rows, and three numerical values are listed in the fourth to k+1th (in FIG. 59, 30th) rows.

Accordingly, the number of column weights in the parity check matrix H determined from the parity check matrix initial value table of FIG. 59 is 13 in the first to 1+360×(3-1)-1th rows but is 3 in the 1+360×(3-1)th to Kth rows.

The first row of the parity check matrix initial value table of FIG. 59 includes 0, 2084, 1613, 1548, 1286, 1460, 3196, 4297, 2481, 3369, 3451, 4620 and 2622, and this indicates that, in the first column of the parity check matrix H, the elements in rows of the row numbers of 0, 2084, 1613, 1548, 1286, 1460, 3196, 4297, 2481, 3369, 3451, 4620 and 2622 have the value 1 (and besides the other elements have the value 0).

Meanwhile, the second row of the parity check matrix initial value table of FIG. 59 includes 1, 122, 1516, 3448, 2880, 1407, 1847, 3799, 3529, 373, 971, 4358 and 3108, and this indicates that, in the 361st (= 1+360×(2-1)th) column of the parity check matrix H, the elements in rows of the row numbers of 1, 122, 1546, 3448, 2880, 1407, 1847, 3799, 3529, 373, 971, 4358 and 3108 have the value 1.

As given above, the parity check matrix initial value table represents the position of elements of the value 1 of the information matrix $H_A$ of the parity check matrix H for every 360 columns.

Each of the columns of the parity check matrix H other than the 1+360×(i-1)th column, that is, each of the columns from 2+360×(i-1)th to 360×ith columns, includes elements of the value of 1 obtained by cyclically shifting the elements of the value of 1 of the 1+360×(i-1)th column which depend upon the parity check matrix initial value table periodically in the downward direction (in the downward direction of the column) in accordance with the parity length M.

In particular, for example, the 2+360×(i-1)th column is a column obtained by cyclically shifting the 1+360×(i-1)th column in the downward direction by M/360. (= q), and the next 3+360×(i-1)th is a column obtained by cyclically shifting the 1+360×(i-1)th column in the downward direction by 2 × M/360 (= 2 × q) and then cyclically shifting the cyclically shifted column (2+360×(i-1)th column) in the downward direction by M/360 (= q).

Now, if it is assumed that the numeral value in the jth column (jth from the left) in the ith row (ith row from above) of the parity check matrix initial value table is represented by $b_{i,j}$ and the row number of the jth element of the value 1 in the wth column of the parity check matrix H is represented by $H_{w-j}$, then the row number $H_{w-j}$ of the element of the value 1 in the wth column which is a column other than the 1+360×(i-1)th column of the parity check matrix H can be determined in accordance with an expression (10).

$$H_{w-j} = \mathrm{mod}\{h_{i,j} + \mathrm{mod}((w-1),P) \times q, M\} \quad ...(10)$$

Here, mod(x,y) signifies a remainder when x is divided by y.

Meanwhile, P is a unit number of columns of the cyclic structure described hereinabove and is, for example, in the DVB-S.2 standard, as described above, 360. Further, q is a value M/360 obtained by dividing the parity length M by the unit column number P (= 360) of the cyclic structure.

The parity check matrix production portion 613 (FIG. 29) specifies the row number of the elements of the value 1 in the 1+360×(i-1)th column of the parity check matrix H from the parity check matrix initial value table.

Further, the parity check matrix production portion 613 (FIG. 29) determines the row number $H_{w-j}$ of the element of the value 1 in the wth column which is a column other than the 1+360×(i-1)th column of the parity check matrix H in accordance with the expression (10) and produces a parity check matrix H in which the elements of the row numbers obtained by the foregoing have the value 1.

Incidentally, it is anticipated that DVB-C.2 which is a standard for CATV digital broadcasting of the next generation adopts a high encoding rate such as, for example, 2/3 to 9/10 and a modulation method having many signal points such as 1024QAM or 4096QAM.

In a modulation method having a high encoding rate or many signal points, generally since the tolerance of the communication path 13 (FIG. 7) to errors is low, it is desirable to take a countermeasure for improving the tolerance to errors.

As a countermeasure for improving the tolerance to errors, for example, a replacement process which is carried out by the demultiplexer 25 (FIG. 8) is available.

In the replacement process, as a replacement method for replacing code bits of an LDPC code, for example, the first to fourth replacement methods described hereinabove are available. However, it is demanded to propose a method which has a further improved tolerance to errors in comparison with methods proposed already including the first to fourth replacement methods.

Thus, the demultiplexer 25 (FIG. 8) is configured such that it can carry out a replacement process in accordance with an allocation rule as described hereinabove with reference to FIG. 25.

In the following, before a replacement process in accordance with an allocation rule is described, a replacement process by replacement methods (hereinafter referred to existing methods) proposed already is described.

A replacement process where it is assumed that the replacement process is carried out in accordance with the existing methods by the demultiplexer 25 is described with reference to FIGS. 60 and 61.

FIG. 60 shows an example of the replacement process of an existing method where the LDPC code is an LDPC code having a code length N of 64,800 bits and an encoding rate of 3/5.

In particular, A of FIG. 60 illustrates an example of the replacement method of an existing method where the LDPC code is an LDPC code having a code length N of 64,800 bits and an encoding rate of 3/5 and besides the modulation method is 16QAM and the multiple b is 2.

Where the modulation method is 16QAM, 4 (= m) bits from among the code bits are mapped as one symbol to some of 16 signal points prescribed by 16QAM.

Further, where the code length N is 64,800 bits and the multiple b is 2, the memory 31 (FIGS. 16 and 17) of the demultiplexer 25 has eight columns for storing 4 × 2 (= mb) bits in the row direction and stores 64,800/(4 × 2) bits in the column direction.

In the demultiplexer 25, when the code bits of the LDPC code are written in the column direction of the memory 31 and writing of the 64,800 code bits (one codeword) ends, the code bits written in the memory 31 are read out in a unit of 4 × 2 (= mb) bits in the row direction and supplied to the replacement section 32 (FIGS. 16 and 17).

The replacement section 32 replaces the 4 × 2 (= mb) code bits $b_0$, $b_1$, $b_2$, $b_3$, $b_4$, $b_5$, $b_6$ and $b_7$ read out from the memory 31 such that the 4 × 2 (= mb) code bits $b_0$ to $b_7$ are allocated to 4 × 2 (= mb) symbol bits $y_0$, $y_1$, $y_2$, $y_3$, $y_4$, $y_5$, $y_6$ and $y_7$ of successive two (= b) symbols.

In particular, the replacement section 32 carries out replacement for allocating
the code bit $b_0$ to the symbol bit $y_7$,
the code bit $b_1$ to the symbol bit $y_1$,
the code bit $b_2$ to the symbol bit $y_4$,
the code bit $b_3$ to the symbol bit $y_2$,
the code bit $b_4$ to the symbol bit $y_5$,
the code bit $b_5$ to the symbol bit $y_3$,
the code bit $b_6$ to the symbol bit $y_6$, and
the code bit $b_7$ to the symbol bit $y_0$.

In particular, B of FIG. 60 illustrates an example of the replacement method of an existing method where the LDPC code is an LDPC code having a code length N of 64,800 bits and an encoding rate of 3/5 and besides the modulation method is 64QAM and the multiple b is 2.

Where the modulation method is 64QAM, 6 (= m) bits from among the code bits are mapped as one symbol to some of 64 signal points prescribed by 64QAM.

Further, where the code length N is 64,800 bits and the multiple b is 2, the memory 31 (FIGS. 16 and 17) of the demultiplexer 25 has 12 columns for storing 6 × 2 (= mb) bits in the row direction and stores 64,800/(6 × 2) bits in the column direction.

In the demultiplexer 25, when the code bits of the LDPC code are written in the column direction of the memory 31 and writing of the 64,800 code bits (one codeword) ends, the code bits written in the memory 31 are read out in a unit of 6 × 2 (= mb) bits in the row direction and supplied to the replacement section 32 (FIGS. 16 and 17).

The replacement section 32 replaces the 6 × 2 (= mb) code bits $b_0$, $b_1$, $b_2$, $b_3$, $b_4$, $b_5$, $b_6$, $b_7$, $b_8$, $b_9$, $b_{10}$ and

$b_{11}$ read out from the memory 31 such that the 6 × 2 (= mb) code bits $b_0$ to $b_1$, are allocated to 6 × 2 (= mb) symbol bits $y_0$, $y_0$, $y_2$, $y_3$, $y_4$, $y_5$, $y_6$, $y_7$, $y_8$, $y_9$, $y_{10}$ and $y_{11}$ of successive two (= b) symbols.

In particular, the replacement section 32 carries out replacement for allocating
the code bit $b_0$ to the symbol bit $y_{11}$,
the code bit $b_1$ to the symbol bit $y_7$,
the code bit $b_2$ to the symbol bit $y_3$,
the code bit $b_3$ to the symbol bit $y_{10}$,
the code bit $b_4$ to the symbol bit $y_6$, the code bit $b_5$ to the symbol bit $y_2$,
the code bit $b_6$ to the symbol bit $y_9$,
the code bit $b_7$ to the symbol bit $y_5$,
the code bit $b_8$ to the symbol bit $y_1$,
the code bit $b_9$ to the symbol bit $y_8$,
the code bit $b_{10}$ to the symbol bit $y_4$, and
the code bit $b_{11}$ to the symbol bit $y_0$.

In particular, C of FIG. 60 illustrates an example of the replacement method of an existing method where the LDPC code is an LDPC code having a code length N of 64,800 bits and an encoding rate of 3/5 and besides the modulation method is 256QAM and the multiple b is 2.

Where the modulation method is 256QAM, 8 (= m) bits from among the code bits are mapped as one symbol to some of 256 signal points prescribed by 256QAM.

Further, where the code length N is 64,800 bits and the multiple b is 2, the memory 31 (FIGS. 16 and 17) of the demultiplexer 25 has 16 columns for storing 8 × 2 (= mb) bits in the row direction and stores 64,800/(8 × 2) bits in the column direction.

In the demultiplexer 25, when the code bits of the LDPC code are written in the column direction of the memory 31 and writing of the 64,800 code bits (one codeword) ends, the code bits written in the memory 31 are read out in a unit of 8 × 2 (= mb) bits in the row direction and supplied to the replacement section 32 (FIGS. 16 and 17).

The replacement section 32 replaces the 8 × 2 (= mb) code bits $b_0$, $b_1$, $b_2$, $b_3$, $b_4$, $b_5$, $b_6$, $b_7$, $b_8$, $b_9$, $b_{10}$, $b_{11}$, $b_{12}$, $b_{13}$, $b_{14}$ and $b_{15}$ read out from the memory 31 such that the 8 × 2 (= mb) code bits $b_0$ to $b_{15}$ are allocated to 8 × 2 (= mb) symbol bits $y_0$, $y_1$, $y_2$, $y_3$, $y_4$, $y_5$, $y_6$, $y_7$, $y_8$, $y_9$, $y_{10}$, $y_{11}$, $y_{12}$, $y_{13}$, $y_{14}$ and $y_{15}$ of successive two (= b) symbols.

In particular, the replacement section 32 carries out replacement for allocating
the code bit $b_0$ to the symbol bit $y_{15}$,
the code bit $b_1$ to the symbol bit $y_1$,
the code bit $b_2$ to the symbol bit $y_{13}$,
the code bit $b_3$ to the symbol bit $y_3$,
the code bit $b_4$ to the symbol bit $y_8$,
the code bit $b_5$ to the symbol bit $y_{11}$,
the code bit $b_6$ to the symbols bit $y_9$,
the code bit $b_7$ to the symbol bit $y_5$,
the code bit $b_8$ to the symbol bit $y_{10}$,
the code bit $b_9$ to the symbol bit $y_6$,
the code bit $b_{10}$ to the symbol bit $y_4$,
the code bit $b_{11}$ to the symbol bit $y_7$,
the code bit $b_{12}$ to the symbol bit $y_{12}$,
the code bit $b_{13}$ to the symbol bit $y_2$,
the code bit $b_{14}$ to the symbol bit $y_{14}$, and
the code bit $b_{15}$ to the symbol bit $y_0$.

FIG. 61 shows an example of the replacement process of an existing method where the LDPC code is an LDPC code having a code length N of 16,200 bits and an encoding rate of 3/5.

In particular, A of FIG. 61 illustrates an example of the replacement method of an existing method where the LDPC code is an LDPC code having a code length N of 16,200 bits and an encoding rate of 3/5 and besides the modulation method is 16QAM and the multiple b is 2.

Where the modulation method is 16QAM, 4 (= m) bits from among the code bits are mapped as one symbol to some of 16 signal points prescribed by 16QAM.

Further, where the code length N is 16,200 bits and the multiple b is 2, the memory 31 (FIGS. 16 and 17) of the demultiplexer 25 has 8 columns for storing 4 × 2 (= mb) bits in the row direction and stores 16,200/(4 × 2) bits in the column direction.

In the demultiplexer 25, when the code bits of the LDPC code are written in the column direction of the memory 31 and writing of the 16,200 code bits (one codeword) ends, the code bits written in the memory 31 are read out in a unit of 4 × 2 (= mb) bits in the row direction and supplied to the replacement section 32 (FIGS. 16 and 17).

The replacement section 32 replaces the 4 × 2 (= mb) code bits $b_0$, $b_1$, $b_2$, $b_3$, $b_4$, $b_5$, $b_6$ and $b_7$ read out from the memory 31 such that the 4 × 2 (= mb) code bits $b_0$ to $b_7$ are allocated to 4 × 2 (= mb) symbol bits $y_0$, $y_1$, $y_2$, $y_3$, $y_4$, $y_5$, $y_6$ and $y_7$ of successive two (= b) symbols.

In particular, the replacement section 32 carries out replacement for allocating the code bits $b_0$ to $b_7$ to the symbol bits $y_0$ to $y_7$ as in the case of A of FIG. 60 described above.

In particular, B of FIG. 61 illustrates an example of the replacement method of an existing method where the LDPC code is an LDPC code having a code length N of 16,200 bits and an encoding rate of 3/5 and besides the modulation method is 64QAM and the multiple b is 2.

Where the modulation method is 64QAM, 6 (= m) bits from among the code bits are mapped as one symbol to some of 64 signal points prescribed by 64QAM.

Further, where the code length N is 16,200 bits and the multiple b is 2, the memory 31 (FIGS. 16 and 17) of the demultiplexer 25 has 12 columns for storing 6 × 2 (= mb) bits in the row direction and stores 16,200/(6 × 2) bits in the column direction.

In the demultiplexer 25, when the code bits of the LDPC code are written in the column direction of the memory 31 and writing of the 16,200 code bits (one codeword) ends, the code bits written in the memory 31 are read out in a unit of 6 × 2 (= mb) bits in the row direction and supplied to the replacement section 32 (FIGS. 16 and 17).

The replacement section 32 replaces the 6 × 2 (= mb) code bits $b_0$, $b_1$, $b_2$, $b_3$, $b_4$, $b_5$, $b_6$, $b_7$, $b_8$, $b_9$, $b_{10}$ and $b_{11}$ read out from the memory 31 such that the 6 × 2 (= mb) code bits $b_0$ to $b_{11}$ are allocated to 6 × 2 (= mb) symbol bits $y_0$, $y_1$, $y_2$, $y_3$, $y_4$, $y_5$, $y_6$, $y_7$, $y_8$, $y_9$, $y_{10}$ and $y_{11}$ of successive two (= b) symbols.

In particular, the replacement section 32 carries out replacement for allocating the code bits $b_0$ to $b_{11}$ to the symbol bits $y_0$ to $y_{11}$ as in the case of B of FIG. 60 described above.

In particular, C of FIG. 61 illustrates an example of the replacement method of an existing method where the LDPC code is an LDPC code having a code length N of 16,200 bits and an encoding rate of 3/5 and besides the modulation method is 256QAM and the multiple b is 1.

Where the modulation method is 256QAM, 8 (= m) bits from among the code bits are mapped as one symbol to some of 256 signal points prescribed by 256QAM.

Further, where the code length N is 16,200 bits and the multiple b is 1, the memory 31 (FIGS. 16 and 17) of the demultiplexer 25 has 8 columns for storing 8 × 1 (= mb) bits in the row direction and stores 16,200/(8 × 1) bits in the column direction.

In the demultiplexer 25, when the code bits of the LDPC code are written in the column direction of the memory 31 and writing of the 16,200 code bits (one codeword) ends, the code bits written in the memory 31 are read out in a unit of 8 × 1 (= mb) bits in the row direction and supplied to the replacement section 32 (FIGS. 16 and 17).

The replacement section 32 replaces the 8 × 1 (= mb) code bits $b_0$, $b_1$, $b_2$, $b_3$, $b_4$, $b_5$, $b_6$, and $b_7$ read out from the memory 31 such that the 8 × 1 (= mb) code bits $b_0$ to $b_7$ are allocated to 8 × 1 (= mb) symbol bits $y_0$, $y_1$, $y_2$, $y_3$, $y_4$, $y_5$, $y_6$ and $y_7$ of successive one (= b) symbols.

In particular, the replacement section 32 carries out replacement for allocating
the code bit $b_0$ to the symbol bit $y_7$,
the code bit $b_1$ to the symbol bit $y_3$,
the code bit $b_2$ to the symbol bit $y_1$,
the code bit $b_3$ to the symbol bit $y_5$,
the code bit $b_4$ to the symbol bit $y_2$,
the code bit $b_5$ to the symbol bit $y_6$,
the code bit $b_6$ to the symbol bit $y_4$, and
the code bit $b_7$ to the symbol bit $y_0$.

Now, a replacement process in accordance with an allocation rule (hereinafter referred to also as replacement process in accordance with the new replacement method) is described.

FIGS. 62 to 64 are views illustrating the new replacement method.

In the new replacement method, the replacement section 32 of the demultiplexer 25 carries out replacement of mb code bits in accordance with an allocation rule determined in advance.

The allocation rule is a rule for allocating code bits of an LDPC code to symbol bits. In the allocation rule, a group set which is a combination of a code bit group of code bits and a symbol bit group of symbol bits to which the code bits of the code bit group are allocated and a bit number (hereinafter referred to also as group bit number) of code bits and symbol bits of the code bit group and the symbol bit group of the group set are prescribed.

Here, the code bits are different in error probability thereamong and also the symbol bits are different in error probability thereamong as described above. The code bit group is a group into which the code bits are grouped in accordance with the error probability and the symbol bit group is a group into which the symbol bits are grouped in accordance with the error probability.

FIG. 62 illustrates code bit groups and symbol bit groups where the LDPC code is an LDPC code having a code length N of 16,200 bits and an encoding rate of 2/3 and besides the modulation method is 1024QAM and the multiple b is 1.

In this instance, 10 × 1 (= mb) code bits read out from the memory 31 can be grouped into four code bit groups $Gb_1$, $Gb_2$, $Gb_3$ and $Gb_4$ as seen in A of FIG. 62 in accordance with the difference in error probability.

Here, the code bit group $Gb_i$ is a group in which code bits belonging to the code bit group $Gb_i$ have a better (lower) error probability as the suffix i thereof has a lower value.

In A of FIG. 62, to the code bit group $Gb_1$, the code bit $b_0$ belongs; to the code bit group $Gb_2$, the code bits $b_1$, $b_2$, $b_3$, $b_4$ and $b_5$ belong; to the code bit group $Gb_3$, the code bit $b_6$ belongs; and to the code bit group $Gb_4$, the code bits $b_7$, $b_8$ and $b_9$ belong.

Where the modulation method is 1024QAM and the multiple b is 1, the 10 × 1 (= mb) symbol bits can be grouped into five symbol bit groups $Gy_1$, $Gy_2$, $Gy_3$, $Gy_4$ and $Gy_5$ as seen in B of FIG. 62 in accordance with the difference in error probability.

Here, the symbol bit group $Gy_i$ is a group in which symbol bits belonging to the symbol bit group $Gy_i$ have a better error probability as the suffix i thereof has a lower value similarly to the code bit group.

In B of FIG. 62, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; and to the symbol bit group $Gy_5$, the symbol bits $y_8$ and $y_9$ belong.

FIG. 63 illustrates an allocation rule where the LDPC code is an LDPC code having a code length N of 16,200 bits and an encoding rate of 2/3 and besides the modulation method is 1024QAM and the multiple b is 1.

In the allocation rule of FIG. 63, the combination of the code bit group $Gb_1$ and the symbol bit group $Gy_5$ is defined as one group set. Further, the group bit number of the group set is prescribed to 1 bit.

In the following description, a group set and a group bit number of the group set are collectively referred to as group set information. For example, the group set of the code bit group $Gb_1$ and the symbol bit group $Gy_5$ and 1 bit which is the group bit number of the group set are described as group set information ($Gb_1$, $Gy_5$, 1).

In the allocation rule of FIG. 63, group set information ($Gb_2$, $Gy_1$, 2), ($Gb_2$, $Gy_2$, 2), ($Gb_2$, $Gy_3$, 1), ($Gb_3$, $Gy_4$, 1), ($Gb_4$, $Gy_3$, 1), ($Gb_4$, $Gy_4$, 1) and ($Gb_4$, $Gy_5$, 1) is prescribed in addition to the group set information ($Gb_1$, $Gy_5$, 1).

For example, the group set information ($Gb_1$, $Gy_5$, 1) signifies that one code bit belonging to the code bit group $Gb_1$ is allocated to one symbol bit belonging to the symbol bit group $Gy_1$.

Accordingly, according to the allocation rule of FIG. 63, it is prescribed that,

depending upon the group set information ($Gb_1$, $Gy_5$, 1), one code bit of the code bit group $Gb_1$ which is best in error probability is allocated to one symbol bit of the symbol bit group $Gy_5$ which is fifth best (worst) in error probability, that

depending upon the group set information ($Gb_2$, $Gy_1$, 2), two code bits of the code bit group $Gb_2$ which is second best in error probability is allocated to two symbol bits of the symbol bit group $Gy_1$ which is best in error probability, that

depending upon the group set information ($Gb_2$, $Gy_2$, 2), two code bits of the code bit group $Gb_2$ which is second best in error probability are allocated to two symbol bits of the symbol bit group $Gy_2$ which is second best in error probability, that

depending upon the group set information ($Gb_2$, $Gy_3$, 1), one code bit of the code bit group $Gb_2$ which is second best in error probability is allocated to one symbol bit of the symbol bit group $Gy_3$ which is third best in error probability, that

depending upon the group set information ($Gb_3$, $Gy_4$, 1), one code bit of the code bit group $Gb_3$ which is third best in error probability is allocated to one symbol bit of the symbol bit group $Gy_4$ which is fourth best in error probability, that

depending upon the group set information ($Gb_4$, $Gy_3$, 1), one code bit of the code bit group $Gb_4$ which is fourth best in error probability is allocated to one symbol bit of the symbol bit group $Gy_3$ which is third best in error probability, that

depending upon the group set information ($Gb_4$, $Gy_4$, 1), one code bit of the code bit group $Gb_4$ which is fourth best in error probability is allocated to one symbol bit of the symbol bit group $Gy_4$ which is fourth best in error probability, and that

depending upon the group set information ($Gb_4$, $Gy_5$, 1), one code bit of the code bit group $Gb_4$ which is fourth best in error probability is allocated to one symbol bit of the symbol bit group $Gy_5$ which is fifth best in error probability.

As described above, the code bit group is a group into which code bits are grouped in accordance with the error probability, and the symbol bit group is a group into which symbol bits are grouped in accordance with the error probability. Accordingly, also it can be considered that the allocation rule prescribes a combination of the error probability of code bits and the error probability of symbol bits to which the code bits are allocated.

In this manner, the allocation rule which prescribes a combination of the error probability of code bits and the error probability of symbol bits to which the code bits are allocated is determined such that the tolerance to errors (tolerance to noise) is made better, for example, through a simulation wherein the BER is measured or the like.

It is to be noted that, even if the allocation destination of a code bit of a certain code bit group is changed among bits of the same symbol bit group, the tolerance to errors is not (little) influenced thereby.

Accordingly, in order to improve the tolerance to errors, group set information which minimizes the BER (Bit Error Rate), that is, a combination (group set) of a code bit group of code bits and a symbol set of symbol bits to which the code bits of the code bit group are allocated and the bit number (group bit number) of code bits and symbol bits of the code set group and the symbol bit group of the group set should be prescribed as the allocation rule, and replacement of the code bits should be carried out such that the code bits are allocated to the symbol bits in accordance with the allocation rule.

However, a particular allocation method in regard to to which symbol each code bit should be allocated in accordance with the allocation rule need be determined in advance between the transmission apparatus 11 and the reception apparatus 12 (FIG. 7).

FIG. 64 illustrates an example of replacement of code bits in accordance with the allocation rule of FIG. 63.

In particular, A of FIG. 64 illustrates a first example of replacement of code bits in accordance with the allocation rule of FIG. 63 where the LDPC code is an LDPC code having a code length N of 16,200 bits and an encoding rate of 2/3 and besides the modulation method is 1024QAM and the multiple b is 1.

Where the LDPC code is an LDPC code having a code length N of 16,200 bits and an encoding rate of 2/3 and besides the modulation method is 1024QAM and the multiple b is 1, in the demultiplexer 25, code bits written in the memory 31 for (16,200/(10 $\times$ 1)) $\times$ (10 $\times$ 1) bits in the column direction $\times$ row direction are read out in a unit of 10 $\times$ 1 (= mb) bits in the row direction and are supplied to the replacement section 32 (FIGS. 16 and 17).

The replacement section 32 replaces the 10 $\times$ 1 (= mb) code bits $b_0$ to $b_9$ read out from the memory 31 in accordance with the allocation rule of FIG. 63 such that the 10 $\times$ 1 (= mb) code bits $b_0$ to $b_9$ are allocated, for example, to the 10 $\times$ 1 (= mb) symbol bits $y_0$ to $y_9$ of one (= b) symbol as seen in A of FIG. 64.

In particular, the replacement section 32 carries out replacement for allocating
the code bit $b_0$ to the symbol bit $y_8$,
the code bit $b_1$ to the symbol bit $y_0$,
the code bit $b_2$ to the symbol bit $y_1$,
the code bit $b_3$ to the symbol bit $y_2$,
the code bit $b_4$ to the symbol bit $y_3$,
the code bit $b_5$ to the symbol bit $y_4$,
the code bit $b_6$ to the symbol bit $y_6$,
the code bit $b_7$ to the symbol bit $y_5$,
the code bit $b_8$ to the symbol bit $y_9$, and
the code bit $b_9$ to the symbol bit $y_7$.

B of FIG. 64 illustrates a second example of replacement of code bits in accordance with the allocation rule of FIG. 63 where the LDPC code is an LDPC code having a code length N of 16,200 bits and an encoding rate of 2/3 and besides the modulation method is 1024QAM and the multiple b is 1.

According to B of FIG. 64, the replacement section 32 carries out replacement for allocating the 10 $\times$ 1 (= mb) code bits $b_0$ to $b_9$ read out from the memory 31 in accordance with the allocation rule of FIG. 63 in such a manner as to allocate
the code bit $b_0$ to the symbol bit $y_9$,
the code bit $b_1$ to the symbol bit $y_2$,
the code bit $b_2$ to the symbol bit $y_3$,
the code bit $b_3$ to the symbol bit $y_1$,
the code bit $b_4$ to the symbol bit $y_5$,
the code bit $b_5$ to the symbol bit $y_0$,
the code bit $b_6$ to the symbol bit $y_7$,
the code bit $b_7$ to the symbol bit $y_4$,
the code bit $b_8$ to the symbol bit $y_8$, and
the code bit $b_9$ to the symbol bit $y_6$.

Here, the allocation methods of the code bits $b_i$ to the symbol bits $y_i$ illustrated in A of FIG. 64 and B of FIG. 64 observe the allocation rule of FIG. 63 (follow the allocation rule).

FIG. 65 illustrates code bit groups and symbol bit groups where the LDPC code is an LDPC code having a code length N of 64,800 bits and an encoding rate of 2/3 and besides the modulation method is 1024QAM and the multiple b is 1.

In this instance, 10 $\times$ 1 (= mb) code bits read out from the memory 31 can be grouped into four code bit groups $Gb_1$, $Gb_2$, $Gb_3$ and $Gb_4$ as seen in A of FIG. 65 in accordance with the difference in error probability.

In A of FIG. 65, to the code bit group $Gb_1$, the code bit $b_0$ belongs; to the code bit group $Gb_2$, the code bits $b_1$ to $b_5$ belong; to the code bit group $Gb_3$, the code bit $b_6$ belongs; and to the code bit group $Gb_4$, the code bits $b_7$ to $b_9$ belong.

Where the modulation method is 1024QAM and the multiple b is 1, the 10 $\times$ 1 (= mb) symbol bits can be grouped into five symbol bit groups $Gy_1$, $Gy_2$, $Gy_3$, $Gy_4$ and $Gy_5$ as seen in B of FIG. 65 in accordance with the difference in error probability.

In B of FIG. 65, as with B of FIG. 62, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; and to the symbol bit group $Gy_5$, the symbol bits $y_8$ and

$y_9$ belong.

FIG. 66 illustrates an allocation rule where the LDPC code is an LDPC code having a code length N of 64,800 bits and an encoding rate of 2/3 and besides the modulation method is 1024QAM and the multiple b is 1.

In the allocation rule of FIG. 66, group set information ($Gb_1$, $Gy_5$, 1), ($Gb_2$, $Gy_1$, 2), ($Gb_2$, $Gy_2$, 2), ($Gb_2$, $Gy_3$, 1), ($Gb_3$, $Gy_4$, 1), ($Gb_4$, $Gy_3$, 1), ($Gb_4$, $Gy_4$, 1) and ($Gb_4$, $Gy_5$, 1) is prescribed.

Accordingly, according to the allocation rule of FIG. 66, it is prescribed that, depending upon the group set information ($Gb_1$, $Gy_5$, 1), one code bit of the code bit group $Gb_1$ which is best in error probability is allocated to one symbol bit of the symbol bit group $Gy_5$ which is fifth best in error probability, that
depending upon the group set information ($Gb_2$, $Gy_1$, 2), two code bits of the code bit group $Gb_2$ which is second best in error probability is allocated to two symbol bits of the symbol bit group $Gy_1$ which is best in error probability, that
depending upon the group set information ($Gb_2$, $Gy_2$, 2), two code bits of the code bit group $Gb_2$ which is second best in error probability are allocated to two symbol bits of the symbol bit group $Gy_2$ which is second best in error probability, that
depending upon the group set information ($Gb_2$, $Gy_3$, 1), one code bit of the code bit group $Gb_2$ which is second best in error probability is allocated to one symbol bit of the symbol bit group $Gy_3$ which is third best in error probability, that
depending upon the group set information ($Gb_3$, $Gy_4$, 1), one code bit of the code bit group $Gb_3$ which is third best in error probability is allocated to one symbol bit of the symbol bit group $Gy_4$ which is fourth best in error probability, that
depending upon the group set information ($Gb_4$, $Gy_3$, 1), one code bit of the code bit group $Gb_4$ which is fourth best in error probability is allocated to one symbol bit of the symbol bit group $Gy_3$ which is third best in error probability, that
depending upon the group set information ($Gb_4$, $Gy_4$, 1), one code bit of the code bit group $Gb_4$ which is fourth best in error probability is allocated to one symbol bit of the symbol bit group $Gy_4$ which is fourth best in error probability, and that
depending upon the group set information ($Gb_4$, $Gy_5$, 1), one code bit of the code bit group $Gb_4$ which is fourth best in error probability is allocated to one symbol bit of the symbol bit group $Gy_5$ which is fifth best in error probability.

FIG. 67 illustrates an example of replacement of code bits in accordance with the allocation rule of FIG. 66.

In particular, A of FIG. 67 illustrates a first example of replacement of code bits in accordance with the allocation rule of FIG. 66 where the LDPC code is an LDPC code having a code length N of 64,800 bits and an encoding rate of 2/3 and besides the modulation method is 1024QAM and the multiple b is 1.

Where the LDPC code is an LDPC code having a code length N of 64,800 bits and an encoding rate of 2/3 and besides the modulation method is 1024QAM and the multiple b is 1, in the demultiplexer 25, code bits written in the memory 31 for $(64{,}800/(10 \times 1)) \times (10 \times 1)$ bits in the column direction row direction are read out in a unit of $10 \times 1$ (= mb) bits in the row direction and are supplied to the replacement section 32 (FIGS. 16 and 17).

The replacement section 32 replaces the $10 \times 1$ (= mb) code bits $b_0$ to $b_9$ read out from the memory 31 in accordance with the allocation rule of FIG. 66 such that the $10 \times 1$ (= mb) code bits $b_0$ to $b_9$ are allocated, for example, to the $10 \times 1$ (= mb) symbol bits $y_0$ to $y_9$ of one (= b) symbol as seen in A of FIG. 67.

In particular, the replacement section 32 carries out replacement for allocating
the code bit $b_0$ to the symbol bit $y_8$,
the code bit $b_1$ to the symbol bit $y_0$,
the code bit $b_2$ to the symbol bit $y_1$,
the code bit $b_3$ to the symbol bit $y_2$,
the code bit $b_4$ to the symbol bit $y_3$,
the code bit $b_5$ to the symbol bit $y_4$,
the code bit $b_6$ to the symbol bit $y_6$,
the code bit $b_7$ to the symbol bit $y_5$,
the code bit $b_8$ to the symbol bit $y_9$, and
the code bit $b_9$ to the symbol bit $y_7$.

B of FIG. 67 illustrates a second example of replacement of code bits in accordance with the allocation rule of FIG. 66 where the LDPC code is an LDPC code having a code length N of 64,800 bits and an encoding rate of 2/3 and besides the modulation method is 1024QAM and the multiple b is 1.

According to B of FIG. 67, the replacement section 32 carries out replacement for allocating the $10 \times 1$ (= mb) code bits $b_0$ to $b_9$ read out from the memory 31 in accordance with the allocation rule of FIG. 66 in such a manner as to allocate
the code bit $b_0$ to the symbol bit $y_9$,
the code bit $b_1$ to the symbol bit $y_2$,
the code bit $b_2$ to the symbol bit $y_3$,
the code bit $b_3$ to the symbol bit $y_1$,
the code bit $b_4$ to the symbol bit $y_5$,
the code bit $b_5$ to the symbol bit $y_0$,
the code bit $b_6$ to the symbol bit $y_7$,
the code bit $b_7$ to the symbol bit $y_4$,

the code bit $b_8$ to the symbol bit $y_8$, and
the code bit $b_9$ to the symbol bit $y_6$.

FIG. 68 illustrates code bit groups and symbol bit groups where the LDPC code is an LDPC code having a code length N of 16,200 bits and an encoding rate of 3/4 and besides the modulation method is 1024QAM and the multiple b is 1.

In this instance, 10 × 1 (= mb) code bits read out from the memory 31 can be grouped into four code bit groups $Gb_1$, $Gb_2$, $Gb_3$ and $Gb_4$ as seen in A of FIG. 68 in accordance with the difference in error probability.

In A of FIG. 68, to the code bit group $Gb_1$, the code bit $b_0$ belongs; to the code bit group $Gb_2$, the code bits $b_1$ to $b_6$ belong; to the code bit group $Gb_3$, the code bit $b_7$ belongs; and to the code bit group $Gb_4$, the code bits $b_8$ and $b_9$ belong.

Where the modulation method is 1024QAM and the multiple b is 1, the 10 × 1 (= mb) symbol bits can be grouped into five symbol bit groups $Gy_1$, $Gy_2$, $Gy_3$, $Gy_4$ and $Gy_5$ as seen in FIG. 68B in accordance with the difference in error probability.

In FIG. 68B, as with B of FIG. 62, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; and to the symbol bit group $Gy_5$, the symbol bits $y_8$ and $y_9$ belong.

FIG. 69 illustrates an allocation rule where the LDPC code is an LDPC code having a code length N of 16,200 bits and an encoding rate of 3/4 and besides the modulation method is 1024QAM and the multiple b is 1.

In the allocation rule of FIG. 69, group set information ($Gb_1$, $Gy_4$, 1), ($Gb_2$, $Gy_1$, 2), ($Gb_2$, $Gy_2$, 1), ($Gb_2$, $Gy_3$, 2), ($Gb_2$, $Gy_5$, 1), ($Gb_3$, $Gy_2$, 1), ($Gb_4$, $Gy_4$, 1) and ($Gb_4$, $Gy_5$, 1) is prescribed.

Accordingly, according to the allocation rule of FIG. 69, it is prescribed that,
depending upon the group set information ($Gb_1$, $Gy_4$, 1), one code bit of the code bit group $Gb_1$ which is best in error probability is allocated to one symbol bit of the symbol bit group $Gy_4$ which is fourth best in error probability, that
depending upon the group set information ($Gb_2$, $Gy_1$, 2), two code bits of the code bit group $Gb_2$ which is second best in error probability is allocated to two symbol bits of the symbol bit group $Gy_1$ which is best in error probability, that
depending upon the group set information ($Gb_2$, $Gy_2$, 1), one code bit of the code bit group $Gb_2$ which is second best in error probability are allocated to one symbol bit of the symbol bit group $Gy_2$ which is second best in error probability, that
depending upon the group set information ($Gb_2$, $Gy_3$, 2), two code bits of the code bit group $Gb_2$ which is second best in error probability is allocated to two symbol bits of the symbol bit group $Gy_3$ which is third best in error probability, that
depending upon the group set information ($Gb_2$, $Gy_5$, 1), one code bit of the code bit group $Gb_2$ which is second best in error probability is allocated to one symbol bit of the symbol bit group $Gy_5$ which is fifth best in error probability, that
depending upon the group set information ($Gb_3$, $Gy_2$, 1), one code bit of the code bit group $Gb_3$ which is third best in error probability is allocated to one symbol bit of the symbol bit group $Gy_2$ which is second best in error probability, that
depending upon the group set information ($Gb_4$, $Gy_4$, 1), one code bit of the code bit group $Gb_4$ which is fourth best in error probability is allocated to one symbol bit of the symbol bit group $Gy_4$ which is fourth best in error probability, and that
depending upon the group set information ($Gb_4$, $Gy_5$, 1), one code bit of the code bit group $Gb_4$ which is fourth best in error probability is allocated to one symbol bit of the symbol bit group $Gy_5$ which is fifth best in error probability.

FIG. 70 illustrates an example of replacement of code bits in accordance with the allocation rule of FIG. 69.

In particular, A of FIG. 70 illustrates a first example of replacement of code bits in accordance with the allocation rule of FIG. 69 where the LDPC code is an LDPC code having a code length N of 16,200 bits and an encoding rate of 3/4 and besides the modulation method is 1024QAM and the multiple b is 1.

Where the LDPC code is an LDPC code having a code length N of 16,200 bits and an encoding rate of 3/4 and besides the modulation method is 1024QAM and the multiple b is 1, in the demultiplexer 25, code bits written in the memory 31 for (16,200/(10 × 1)) × (10 × 1) bits in the column direction × row direction are read out in a unit of 10 × 1 (= mb) bits in the row direction and are supplied to the replacement section 32 (FIGS. 16 and 17).

The replacement section 32 replaces the 10 × 1 (= mb) code bits $b_0$ to $b_9$ read out from the memory 31 in accordance with the allocation rule of FIG. 69 such that the 10 × 1 (= mb) code bits $b_0$ to $b_9$ are allocated, for example, to the 10 × 1 (= mb) symbol bits $y_0$ to $y_9$ of one (= b) symbol as seen in A of FIG. 70.

In particular, the replacement section 32 carries out replacement for allocating
the code bit $b_0$ to the symbol bit $y_6$,
the code bit $b_1$ to the symbol bit $y_4$,
the code bit $b_2$ to the symbol bit $y_8$,
the code bit $b_3$ to the symbol bit $y_5$,
the code bit $b_4$ to the symbol bit $y_0$,
the code bit $b_5$ to the symbol bit $y_2$,
the code bit $b_6$ to the symbol bit $y_1$,
the code bit $b_7$ to the symbol bit $y_3$,
the code bit $b_8$ to the symbol bit $y_9$, and

the code bit $b_9$ to the symbol bit $y_7$.

B of FIG. 70 illustrates a second example of replacement of code bits in accordance with the allocation rule of FIG. 69 where the LDPC code is an LDPC code having a code length N of 16,200 bits and an encoding rate of 3/4 and besides the modulation method is 1024QAM and the multiple b is 1.

According to B of FIG. 70, the replacement section 32 carries out replacement for allocating the 10 × 1 (= mb) code bits $b_0$ to $b_9$ read out from the memory 31 in accordance with the allocation rule of FIG. 69 in such a manner as to allocate

the code bit $b_0$ to the symbol bit $y_7$,
the code bit $b_1$ to the symbol bit $y_9$,
the code bit $b_2$ to the symbol bit $y_4$,
the code bit $b_3$ to the symbol bit $y_1$,
the code bit $b_4$ to the symbol bit $y_5$,
the code bit $b_5$ to the symbol bit $y_0$,
the code bit $b_6$ to the symbol bit $y_2$,
the code bit $b_7$ to the symbol bit $y_3$,
the code bit $b_8$ to the symbol bit $y_8$, and
the code bit $b_9$ to the symbol bit $y_6$.

FIG. 71 illustrates code bit groups and symbol bit groups where the LDPC code is an LDPC code having a code length N of 64,800 bits and an encoding rate of 3/4 and besides the modulation method is 1024QAM and the multiple b is 1.

In this instance, 10 × 1 (= mb) code bits read out from the memory 31 can be grouped into four code bit groups $Gb_1$, $Gb_2$, $Gb_3$ and $Gb_4$ as seen in A of FIG. 71 in accordance with the difference in error probability.

In A of FIG. 71, to the code bit group $Gb_1$, the code bit $b_0$ belongs; to the code bit group $Gb_2$, the code bits $b_1$ to $b_6$ belong; to the code bit group $Gb_3$, the code bit $b_7$ belongs; and to the code bit group $Gb_4$, the code bits $b_8$ and $b_9$ belong.

Where the modulation method is 1024QAM and the multiple b is 1, the 10 × 1 (= mb) symbol bits can be grouped into five symbol bit groups $Gy_1$, $Gy_2$, $Gy_3$, $Gy_4$ and $Gy_5$ as seen in B of FIG. 71 in accordance with the difference in error probability.

In B of FIG. 71, as with B of FIG. 62, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; and to the symbol bit group $Gy_5$, the symbol bits $y_8$ and $y_9$ belong.

FIG. 72 illustrates an allocation rule where the LDPC code is an LDPC code having a code length N of 64,800 bits and an encoding rate of 3/4 and besides the modulation method is 1024QAM and the multiple b is 1.

In the allocation rule of FIG. 72, group set information ($Gb_1$, $Gy_4$, 1), ($Gb_2$, $Gy_1$, 2), ($Gb_2$, $Gy_2$, 1), ($Gb_2$, $Gy_3$, 2), ($Gb_2$, $Gy_5$, 1), ($Gb_3$, $Gy_2$, 1), ($Gb_4$, $Gy_4$, 1) and ($Gb_4$, $Gy_5$, 1) is prescribed.

Accordingly, according to the allocation rule of FIG. 72, it is prescribed that,
depending upon the group set information ($Gb_1$, $Gy_4$, 1), one code bit of the code bit group $Gb_1$ which is best in error probability is allocated to one symbol bit of the symbol bit group $Gy_4$ which is fourth best in error probability, that
depending upon the group set information ($Gb_2$, $Gy_1$, 2), two code bits of the code bit group $Gb_2$ which is second best in error probability is allocated to two symbol bits of the symbol bit group $Gy_1$ which is best in error probability, that
depending upon the group set information ($Gb_2$, $Gy_2$, 1), one code bit of the code bit group $Gb_2$ which is second best in error probability are allocated to one symbol bit of the symbol bit group $Gy_2$ which is second best in error probability, that
depending upon the group set information ($Gb_2$, $Gy_3$, 2), two code bits of the code bit group $Gb_2$ which is second best in error probability is allocated to two symbol bits of the symbol bit group $Gy_3$ which is third best in error probability, that
depending upon the group set information ($Gb_2$, $Gy_5$, 1), one code bit of the code bit group $Gb_2$ which is second best in error probability is allocated to one symbol bit of the symbol bit group $Gy_5$ which is fifth best in error probability, that
depending upon the group set information ($Gb_3$, $Gy_2$, 1), one code bit of the code bit group $Gb_3$ which is third best in error probability is allocated to one symbol bit of the symbol bit group $Gy_2$ which is second best in error probability, that
depending upon the group set information ($Gb_4$, $Gy_4$, 1), one code bit of the code bit group $Gb_4$ which is fourth best in error probability is allocated to one symbol bit of the symbol bit group $Gy_4$ which is fourth best in error probability, and that
depending upon the group set information ($Gb_4$, $Gy_5$, 1), one code bit of the code bit group $Gb_4$ which is fourth best in error probability is allocated to one symbol bit of the symbol bit group $Gy_5$ which is fifth best in error probability.

FIG. 73 illustrates an example of replacement of code bits in accordance with the allocation rule of FIG. 72.

In particular, A of FIG. 73 illustrates a first example of replacement of code bits in accordance with the allocation rule of FIG. 72 where the LDPC code is an LDPC code having a code length N of 64,800 bits and an encoding rate of 3/4 and besides the modulation method is 1024QAM and the multiple b is 1.

Where the LDPC code is an LDPC code having a code length N of 64,800 bits and an encoding rate of 3/4 and besides the modulation method is 1024QAM and the multiple b is 1, in the demultiplexer 25, code bits written in the memory 31 for (64,800/(10 × 1)) × (10 × 1) bits in the column direction × row direction are read out in a unit of 10 × 1 (= mb) bits in the row direction and are supplied to the replacement section 32 (FIGS. 16 and 17).

The replacement section 32 replaces the 10 × 1 (= mb) code bits $b_0$ to $b_9$ read out from the memory 31 in accordance with the allocation rule of FIG. 72 such that the 10 × 1 (= mb) code bits $b_0$ to $b_9$ are allocated, for example, to the 10 × 1 (= mb) symbol bits $y_0$ to $y_9$ of one (= b) symbol as seen in A of FIG. 73.

In particular, the replacement section 32 carries out replacement for allocating
the code bit $b_0$ to the symbol bit $y_6$,
the code bit $b_1$ to the symbol bit $y_4$,
the code bit $b_2$ to the symbol bit $y_8$,
the code bit $b_3$ to the symbol bit $y_5$,
the code bit $b_4$ to the symbol bit $y_0$,
the code bit $b_5$ to the symbol bit $y_2$,
the code bit $b_6$ to the symbol bit $y_1$,
the code bit $b_7$ to the symbol bit $y_{3,}$
the code bit $b_8$ to the symbol bit $y_9$, and
the code bit $b_9$ to the symbol bit $y_7$.

B of FIG. 73 illustrates a second example of replacement of code bits in accordance with the allocation rule of FIG. 72 where the LDPC code is an LDPC code having a code length N of 64,800 bits and an encoding rate of 3/4 and besides the modulation method is 1024QAM and the multiple b is 1.

According to B of FIG. 73, the replacement section 32 carries out replacement for allocating the 10 × 1 (= mb) code bits $b_0$ to $b_9$ read out from the memory 31 in accordance with the allocation rule of FIG. 72 in such a manner as to allocate
the code bit $b_0$ to the symbol bit $y_7$,
the code bit $b_1$ to the symbol bit $y_9$,
the code bit $b_2$ to the symbol bit $y_4$,
the code bit $b_3$ to the symbol bit $y_1$,
the code bit $b_4$ to the symbol bit $y_5$,
the code bit $b_5$ to the symbol bit $y_0$,
the code bit $b_6$ to the symbol bit $y_2$,
the code bit $b_7$ to the symbol bit $y_3$,
the code bit $b_8$ to the symbol bit $y_8$, and
the code bit $b_9$ to the symbol bit $y_6$.

FIG. 74 illustrates code bit groups and symbol bit groups where the LDPC code is an LDPC code having a code length N of 16,200 bits and an encoding rate of 4/5 and besides the modulation method is 1024QAM and the multiple b is 1.

In this instance, 10 × 1 (= mb) code bits read out from the memory 31 can be grouped into three code bit groups $Gb_1$, $Gb_2$ and $Gb_3$ as seen in A of FIG. 74 in accordance with the difference in error probability.

In A of FIG. 74, to the code bit group $Gb_1$, the code bits $b_0$ to $b_6$ belong; to the code bit group $Gb_2$, the code bit $b_7$ belongs; and to the code bit group $Gb_3$, the code bits bus and $b_9$ belong.

Where the modulation method is 024QAM and the multiple b is 1, the 10 × 1 (= mb) symbol bits can be grouped into five symbol bit groups $Gy_1$, $Gy_2$, $Gy_3$ $Gy_4$ and $Gy_5$ as seen in B of FIG. 74 in accordance with the difference in error probability.

In B of FIG. 74, as with B of FIG. 62, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; and to the symbol bit group $Gy_5$, the symbol bits $y_8$ and $y_9$ belong.

FIG. 75 illustrates an allocation rule where the LDPC code is an LDPC code having a code length N of 16,200 bits and an encoding rate of 4/5 and besides the modulation method is 1024QAM and the multiple b is 1.

In the allocation rule of FIG. 75, group set information ($Gb_1$, $Gy_1$, 2), ($Gb_1$, $GY_2$, 1), ($Gb_1$, $Gy_3$, 2), ($Gb_1$, $GY_4$, 1), ($Gb_1$, $Gy_5$, 1), ($Gb_2$, $Gy_2$, 1), ($Gb_3$, $Gy_4$ 1) and ($Gb_3$, $Gy_5$, 1) is prescribed.

Accordingly, according to the allocation rule of FIG. 75, it is prescribed that,
depending upon the group set information ($Gb_1$, $Gy_1$, 2), two code bits of the code bit group $Gb_1$ which is best in error probability is allocated to two symbol bits of the symbol bit group $Gy_1$ which is best in error probability, that
depending upon the group set information ($Gb_1$, $Gy_2$, 1), one code bit of the code bit group $Gb_1$ which is best in error probability is allocated to one symbol bit of the symbol bit group $Gy_2$ which is second best in error probability, that
depending upon the group set information ($Gb_1$, $Gy_3$, 2), two code bits of the code bit group $Gb_1$ which is best in error probability are allocated to two symbol bits of the symbol bit group $Gy_3$ which is third best in error probability, that

depending upon the group set information ($Gb_1$ $Gy_4$ 1), one code bit of the code bit group $Gb_1$ which is best in error probability is allocated to one symbol bit of the symbol bit group $Gy_4$ which is fourth best in error probability, that depending upon the group set information ($Gb_1$, $Gy_5$, 1), one code bit of the code bit group $Gb_1$ which is best in error probability is allocated to one symbol bit of the symbol bit group $Gy_5$ which is fifth best in error probability, that depending upon the group set information ($Gb_2$, $Gy_2$, 1), one code bit of the code bit group $Gb_2$ which is second best in error probability is allocated to one symbol bit of the symbol bit group $Gy_2$ which is second best in error probability, that depending upon the group set information ($Gb_3$, $Gy_4$, 1), one code bit of the code bit group $Gb_3$ which is third best in error probability is allocated to one symbol bit of the symbol bit group $Gy_4$ which is fourth best in error probability, and that depending upon the group set information ($Gb_3$, $Gy_5$, 1), one code bit of the code bit group $Gb_3$ which is third best in error probability is allocated to one symbol bit of the symbol bit group $Gy_5$ which is fifth best in error probability.

FIG. 76 illustrates an example of replacement of code bits in accordance with the allocation rule of FIG. 75.

In particular, A of FIG. 76 illustrates a first example of replacement of code bits in accordance with the allocation rule of FIG. 75 where the LDPC code is an LDPC code having a code length N of 16,200 bits and an encoding rate of 4/5 and besides the modulation method is 1024QAM and the multiple b is 1.

Where the LDPC code is an LDPC code having a code length N of 16,200 bits and an encoding rate of 4/5 and besides the modulation method is 1024QAM and the multiple b is 1, in the demultiplexer 25, code bits written in the memory 31 for $(16,200/(10 \times 1)) \times (10 \times 1)$ bits in the column direction × row direction are read out in a unit of $10 \times 1$ (= mb) bits in the row direction and are supplied to the replacement section 32 (FIGS. 16 and 17).

The replacement section 32 replaces the $10 \times 1$ (= mb) code bits $b_0$ to $b_9$ read out from the memory 31 in accordance with the allocation rule of FIG. 75 such that the $10 \times 1$ (= mb) code bits $b_0$ to $b_9$ are allocated, for example, to the $10 \times 1$ (= mb) symbol bits $y_0$ to $y_9$ of one (= b) symbol as seen in A of FIG. 76.

In particular, the replacement section 32 carries out replacement for allocating
the code bit $b_0$ to the symbol bit $y_6$,
the code bit $b_1$ to the symbol bit $y_4$,
the code bit $b_2$ to the symbol bit $y_8$,
the code bit $b_3$ to the symbol bit $y_5$,
the code bit $b_4$ to the symbol bit $y_0$,
the code bit $b_5$ to the symbol bit $y_2$,
the code bit $b_6$ to the symbol bit $y_{1,}$
the code bit $b_7$ to the symbol bit $y_3$,
the code bit $b_8$ to the symbol bit $y_9$, and
the code bit $b_9$ to the symbol bit $y_7$.

B of FIG. 76 illustrates a second example of replacement of code bits in accordance with the allocation rule of FIG. 75 where the LDPC code is an LDPC code having a code length N of 16,200 bits and an encoding rate of 4/5 and besides the modulation method is 1024QAM and the multiple b is 1.

According to B of FIG. 76, the replacement section 32 carries out replacement for allocating the $10 \times 1$ (= mb) code bits $b_0$ to $b_9$ read out from the memory 31 in accordance with the allocation rule of FIG. 75 in such a manner as to allocate
the code bit $b_0$ to the symbol bit $y_9$,
the code bit $b_1$ to the symbol bit $y_7$,
the code bit $b_2$ to the symbol bit $y_3$,
the code bit $b_3$ to the symbol bit $y_1$,
the code bit $b_4$ to the symbol bit $y_5$,
the code bit $b_5$ to the symbol bit $y_0$,
the code bit $b_6$ to the symbol bit $y_4$,
the code bit $b_7$ to the symbol bit $y_2$,
the code bit $b_8$ to the symbol bit $y_8$, and
the code bit $b_9$ to the symbol bit $y_{6.}$

FIG. 77 illustrates code bit groups and symbol bit groups where the LDPC code is an LDPC code having a code length N of 64,800 bits and an encoding rate of 4/5 and besides the modulation method is 1024QAM and the multiple b is 1.

In this instance, $10 \times 1$ (= mb) code bits read out from the memory 31 can be grouped into three code bit groups $Gb_1$, $Gb_2$ and $Gb_3$ as seen in A of FIG. 77 in accordance with the difference in error probability.

In A of FIG. 77, to the code bit group $Gb_1$, the code bit $b_0$ belongs; to the code bit group $Gb_{2,}$ the code bits $b_1$ to $b_7$ belong; and to the code bit group $Gb_3$, the code bits $b_8$ and $b_9$ belong.

Where the modulation method is 1024QAM and the multiple b is 1, the $10 \times 1$ (= mb) symbol bits can be grouped into five symbol bit groups $Gy_1$, $Gy_2$, $Gy_3$, $Gy_4$ and $Gy_5$ as seen in B of FIG. 77 in accordance with the difference in error probability.

In B of FIG. 77, as with B of FIG. 62, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; and to the symbol bit group $Gy_5$, the symbol bits $y_8$ and $y_9$ belong.

FIG. 78 illustrates an allocation rule where the LDPC code is an LDPC code having a code length N of 64,800 bits and an encoding rate of 4/5 and besides the modulation method is 1024QAM and the multiple b is 1.

In the allocation rule of FIG. 78, group set information ($Gb_1$, $Gy_4$, 1), ($Gb_2$, $Gy_1$, 2), ($Gb_{2,}$ $Gy_{2,}$ 2) ($Gb_2$, $Gy_3$, 2), ($Gb_2$, $Gy_5$, 1), ($Gb_3$, $Gy_4$, 1) and ($Gb_3$, $Gy_5$, 1) is prescribed.

Accordingly, according to the allocation rule of FIG. 78, it is prescribed that,

depending upon the group set information ($Gb_1$, $Gy_4$, 1), one code bit of the code bit group $Gb_1$ which is best in error probability is allocated to one symbol bit of the symbol bit group $Gy_4$ which is fourth best in error probability, that depending upon the group set information ($Gb_2$, $Gy_1$, 2), two code bits of the code bit group $Gb_2$ which is second best in error probability is allocated to two symbol bits of the symbol bit group $Gy_1$ which is best in error probability, that depending upon the group set information ($Gb_2$, $Gy_2$, 2), two code bits of the code bit group $Gb_2$ which is second best in error probability are allocated to two symbol bits of the symbol bit group $Gy_2$ which is second best in error probability, that depending upon the group set information ($Gb_2$, $Gy_3$, 2), two code bits of the code bit group $Gb_2$ which is second best in error probability is allocated to two symbol bits of the symbol bit group $Gy_3$ which is third best in error probability, that depending upon the group set information ($Gb_2$, $Gy_5$, 1), one code bit of the code bit group $Gb_2$ which is second best in error probability is allocated to one symbol bit of the symbol bit group $Gy_5$ which is fifth best in error probability, that depending upon the group set information ($Gb_3$, $Gy_4$, 1), one code bit of the code bit group $Gb_3$ which is third best in error probability is allocated to one symbol bit of the symbol bit group $Gy_4$ which is fourth best in error probability, and that depending upon the group set information ($Gb_3$, $Gy_5$, 1), one code bit of the code bit group $Gb_3$ which is third best in error probability is allocated to one symbol bit of the symbol bit group $Gy_5$ which is fifth best in error probability.

FIG. 79 illustrates an example of replacement of code bits in accordance with the allocation rule of FIG. 78.

In particular, A of FIG. 79 illustrates a first example of replacement of code bits in accordance with the allocation rule of FIG. 78 where the LDPC code is an LDPC code having a code length N of 64,800 bits and an encoding rate of 4/5 and besides the modulation method is 1024QAM and the multiple b is 1.

Where the LDPC code is an LDPC code having a code length N of 64,800 bits and an encoding rate of 4/5 and besides the modulation method is 1024QAM and the multiple b is 1, in the demultiplexer 25, code bits written in the memory 31 for $(64,800/(10 \times 1)) \times (10 \times 1)$ bits in the column direction × row direction are read out in a unit of $10 \times 1$ (= mb) bits in the row direction and are supplied to the replacement section 32 (FIGS. 16 and 17).

The replacement section 32 replaces the $10 \times 1$ (= mb) code bits $b_0$ to $b_9$ read out from the memory 31 in accordance with the allocation rule of FIG. 78 such that the $10 \times 1$ (= mb) code bits $b_0$ to $b_9$ are allocated, for example, to the $10 \times 1$ (= mb) symbol bits $y_0$ to $y_9$ of one (= b) symbol as seen in A of FIG. 79.

In particular, the replacement section 32 carries out replacement for allocating
the code bit $b_0$ to the symbol bit $y_6$,
the code bit $b_1$ to the symbol bit $y_4$,
the code bit $b_2$ to the symbol bit $y_8$,
the code bit $b_3$ to the symbol bit $y_5$,
the code bit $b_4$ to the symbol bit $y_0$,
the code bit $b_5$ to the symbol bit $y_2$, the code bit $b_6$ to the symbol bit $y_1$,
the code bit $b_7$ to the symbol bit $y_3$,
the code bit $b_8$ to the symbol bit $y_5$, and
the code bit $b_9$ to the symbol bit $y_7$.

B of FIG. 79 illustrates a second example of replacement of code bits in accordance with the allocation rule of FIG. 78 where the LDPC code is an LDPC code having a code length N of 64,800 bits and an encoding rate of 4/5 and besides the modulation method is 1024QAM and the multiple b is 1.

According to B of FIG. 79, the replacement section 32 carries out replacement for allocating the $10 \times 1$ (= mb) code bits $b_0$ to $b_9$ read out from the memory 31 in accordance with the allocation rule of FIG. 78 in such a manner as to allocate
the code bit $b_0$ to the symbol bit $y_7$,
the code bit $b_1$ to the symbol bit $y_1$,
the code bit $b_2$ to the symbol bit $y_3$,
the code bit $b_3$ to the symbol bit $y_4$,
the code bit $b_4$ to the symbol bit $y_5$,
the code bit $b_5$ to the symbol bit $y_0$,
the code bit $b_6$ to the symbol bit $y_2$,
the code bit $b_7$ to the symbol bit $y_9$,

the code bit $b_8$ to the symbol bit $y_8$, and
the code bit $b_9$ to the symbol bit $y_6$.

FIG. 80 illustrates code bit groups and symbol bit groups where the LDPC code is an LDPC code having a code length N of 16,200 bits and an encoding rate of 5/6 and besides the modulation method is 1024QAM and the multiple b is 1.

In this instance, 10 × 1 (= mb) code bits read out from the memory 31 can be grouped into four code bit groups $Gb_1$, $Gb_2$, $Gb_3$ and $Gb_4$ as seen in A of FIG. 80 in accordance with the difference in error probability.

In A of FIG. 80, to the code bit group $Gb_1$, the code bit $b_0$ belongs; to the code bit group $Gb_2$, the code bits $b_1$ to $b_7$ belong; to the code bit group $Gb_3$, the code bit $b_8$ belongs; and to the code bit group $Gb_4$, the code bit $b_9$ belongs.

Where the modulation method is 1024QAM and the multiple b is 1, the 10 × 1 (= mb) symbol bits can be grouped into five symbol bit groups $Gy_1$, $Gy_2$, $Gy_3$, $Gy_4$ and $Gy_5$ as seen in B of FIG. 80 in accordance with the difference in error probability.

In B of FIG. 80, as with B of FIG. 62, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; and to the symbol bit group $Gy_5$, the symbol bits $y_8$ and $y_9$ belong.

FIG. 81 illustrates an allocation rule where the LDPC code is an LDPC code having a code length N of 16,200 bits and an encoding rate of 5/6 and besides the modulation method is 1024QAM and the multiple b is 1.

In the allocation rule of FIG. 81, group set information ($Gb_1$, $Gy_4$, 1), ($Gb_2$, $Gy_1$, 2), ($Gb_2$, $Gy_2$, 2), ($Gb_2$, $Gy_3$, 2), ($Gb_2$, $Gy_5$, 1), ($Gb_3$, $Gy_5$, 1) and ($Gb_4$, $Gy_4$, 1) is prescribed.

Accordingly, according to the allocation rule of FIG. 81, it is prescribed that,
depending upon the group set information ($Gb_1$, $Gy_4$, 1), one code bit of the code bit group $Gb_1$ which is best in error probability is allocated to one symbol bit of the symbol bit group $Gy_4$ which is fourth best in error probability, that
depending upon the group set information ($Gb_2$, $Gy_1$, 2), two code bits of the code bit group $Gb_2$ which is second best in error probability is allocated to two symbol bits of the symbol bit group $Gy_1$ which is best in error probability, that
depending upon the group set information ($Gb_2$, $Gy_2$, 2), two code bits of the code bit group $Gb_2$ which is second best in error probability are allocated to two symbol bits of the symbol bit group $Gy_2$ which is second best in error probability, that
depending upon the group set information ($Gb_2$, $Gy_3$, 2), two code bits of the code bit group $Gb_2$ which is second best in error probability is allocated to two symbol bits of the symbol bit group $Gy_3$ which is third best in error probability, that
depending upon the group set information ($Gb_2$, $Gy_5$, 1), one code bit of the code bit group $Gb_2$ which is second best in error probability is allocated to one symbol bit of the symbol bit group $Gy_5$ which is fifth best in error probability, that
depending upon the group set information ($Gb_3$, $Gy_5$, 1), one code bit of the code bit group $Gb_3$ which is third best in error probability is allocated to one symbol bit of the symbol bit group $Gy_5$ which is fifth best in error probability, and that
depending upon the group set information ($Gb_4$, $Gy_4$, 1), one code bit of the code bit group $Gb_4$ which is fourth best in error probability is allocated to one symbol bit of the symbol bit group $Gy_4$ which is fourth best in error probability.

FIG. 82 illustrates an example of replacement of code bits in accordance with the allocation rule of FIG. 81.

In particular, A of FIG. 82 illustrates a first example of replacement of code bits in accordance with the allocation rule of FIG. 81 where the LDPC code is an LDPC code having a code length N of 16,200 bits and an encoding rate of 5/6 and besides the modulation method is 1024QAM and the multiple b is 1.

Where the LDPC code is an LDPC code having a code length N of 16,200 bits and an encoding rate of 5/6 and besides the modulation method is 1024QAM and the multiple b is 1, in the demultiplexer 25, code bits written in the memory 31 for (16,200/(10 × 1)) × (10 × 1) bits in the column direction × row direction are read out in a unit of 10 × 1 (= mb) bits in the row direction and are supplied to the replacement section 32 (FIGS. 16 and 17).

The replacement section 32 replaces the 10 × 1 (= mb) code bits $b_0$ to $b_9$ read out from the memory 31 in accordance with the allocation rule of FIG. 81 such that the 10 × 1 (= mb) code bits $b_0$ to $b_9$ are allocated, for example, to the 10 × 1 (= mb) symbol bits $y_0$ to $y_9$ of one (= b) symbol as seen in A of FIG. 82.

In particular, the replacement section 32 carries out replacement for allocating
the code bit $b_0$ to the symbol bit $y_6$,
the code bit $b_1$ to the symbol bit $y_4$,
the code bit $b_2$ to the symbol bit $y_8$,
the code bit $b_3$ to the symbol bit $y_5$,
the code bit $b_4$ to the symbol bit $y_0$,
the code bit $b_5$ to the symbol bit $y_2$,
the code bit $b_6$ to the symbol bit $y_1$,
the code bit $b_7$ to the symbol bit $y_3$,
the code bit $b_8$ to the symbol bit $y_9$, and
the code bit $b_9$ to the symbol bit $y_7$,

B of FIG. 82 illustrates a second example of replacement of code bits in accordance with the allocation rule of FIG. 81 where the LDPC code is an LDPC code having a code length N of 16,200 bits and an encoding rate of 5/6 and besides the modulation method is 1024QAM and the multiple b is 1.

According to B of FIG. 82, the replacement section 32 carries out replacement for allocating the 10 × 1 (= mb) code bits $b_0$ to $b_9$ read out from the memory 31 in accordance with the allocation rule of FIG. 81 in such a manner as to allocate

the code bit $b_0$ to the symbol bit $y_7$,
the code bit $b_1$ to the symbol bit $y_8$,
the code bit $b_2$ to the symbol bit $y_3$,
the code bit $b_3$ to the symbol bit $y_4$,
the code bit $b_4$ to the symbol bit $y_5$,
the code bit $b_5$ to the symbol bit $y_0$,
the code bit $b_6$ to the symbol bit $y_2$,
the code bit $b_7$ to the symbol bit $y_{1,}$
the code bit bus to the symbol bit $y_9$, and
the code bit $b_9$ to the symbol bit $y_6$.

FIG. 83 illustrates code bit groups and symbol bit groups where the LDPC code is an LDPC code having a code length N of 64,800 bits and an encoding rate of 5/6 and besides the modulation method is 1024QAM and the multiple b is 1.

In this instance, 10 × 1 (= mb) code bits read out from the memory 31 can be grouped into four code bit groups $Gb_1$, $Gb_2$, $Gb_3$ and $Gb_4$ as seen in A of FIG. 83 in accordance with the difference in error probability.

In A of FIG.. 83, to the code bit group $Gb_1$, the code bit $b_0$ belongs; to the code bit group $Gb_2$, the code bits $b_1$ to $b_7$ belong; to the code bit group $Gb_3$, the code bit $b_8$ belongs; and to the code bit group $Gb_4$, the code bit $b_9$ belongs.

Where the modulation method is 1024QAM and the multiple b is 1, the 10 × 1 (= mb) symbol bits can be grouped into five symbol bit groups $Gy_1$, $Gy_2$, $Gy_3$, $Gy_4$ and $Gy_5$ as seen in B of FIG. 83 in accordance with the difference in error probability.

In B of FIG. 83, as with B of FIG. 62, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$, and $y_5$ belong; to the symbol bit group $Gy_4$, the symbol bits $y_6$ and $y_7$ belong; and to the symbol bit group $Gy_5$, the symbol bits $y_8$ and $y_9$ belong.

FIG. 84 illustrates an allocation rule where the LDPC code is an LDPC code having a code length N of 64,800 bits and an encoding rate of 5/6 and besides the modulation method is 1024QAM and the multiple b is 1.

In the allocation rule of FIG. 84, group set information ($Gb_1$, $Gy_{4,}$ 1), ($Gb_2$, $Gy_1$, 2), ($Gb_2$, $Gy_2$, 2), ($Gb_2$, $Gy_3$, 2), ($Gb_2$, $Gy_5$, 1), ($Gb_3$, $Gy_5$, 1) and ($Gb_4$, $Gy_{4,}$ 1) is prescribed.

Accordingly, according to the allocation rule of FIG. 84, it is prescribed that,
depending upon the group set information ($Gb_1$, $Gy_{4,}$ 1), one code bit of the code bit group $Gb_1$ which is best in error probability is allocated to one symbol bit of the symbol bit group $Gy_4$ which is fourth best in error probability, that
depending upon the group set information ($Gb_2$, $Gy_1$, 2), two code bits of the code bit group $Gb_2$ which is second best in error probability is allocated to two symbol bits of the symbol bit group $Gy_1$ which is best in error probability, that
depending upon the group set information ($Gb_2$, $Gy_2$, 2), two code bits of the code bit group $Gb_2$ which is, second best in error probability are allocated to two symbol bits of the symbol bit group $Gy_2$ which is second best in error probability, that
depending upon the group set information ($Gb_2$, $Gy_{3,}$ 2), two code bits of the code bit group $Gb_2$ which is second best in error probability is allocated to two symbol bits of the symbol bit group $Gy_3$ which is third best in error probability, that
depending upon the group set information ($Gb_2$, $Gy_5$, 1), one code bit of the code bit group $Gb_2$ which is second best in error probability is allocated to one symbol bit of the symbol bit group $Gy_5$ which is fifth best in error probability, that
depending upon the group set information ($Gb_3$, $Gy_5$, 1), one code bit of the code bit group $Gb_3$ which is third best in error probability is allocated to one symbol bit of the symbol bit group $Gy_5$ which is fifth best in error probability, and that
depending upon the group set information ($Gb_4$, $Gy_4$, 1), one code bit of the code bit group $Gb_4$ which is fourth best in error probability is allocated to one symbol bit of the symbol bit group $Gy_4$ which is fourth best in error probability.

FIG. 85 illustrates an example of replacement of code bits in accordance with the allocation rule of FIG. 84.

In particular, A of FIG. 85 illustrates a first example of replacement of code bits in accordance with the allocation rule of FIG. 84 where the LDPC code is an LDPC code having a code length N of 64,800 bits and an encoding rate of 5/6 and besides the modulation method is 1024QAM and the multiple b is 1.

Where the LDPC code is an LDPC code having a code length N of 64,800 bits and an encoding rate of 5/6 and besides the modulation method is 1024QAM and the multiple b is 1, in the demultiplexer 25, code bits written in the memory 31 for (64,800/(10 × 1)) × (10 × 1) bits in the column direction × row direction are read out in a unit of 10 × 1 (= mb) bits in the row direction and are supplied to the replacement section 32 (FIGS. 16 and 17).

The replacement section 32 replaces the 10 × 1 (= mb) code bits $b_0$ to $b_9$ read out from the memory 31 in accordance with the allocation rule of FIG. 84 such that the 10 × 1 (= mb) code bits $b_0$ to $b_9$ are allocated, for example, to the 10 × 1 (= mb) symbol bits $y_0$ to $y_9$ of one (= b) symbol as seen in A of FIG. 85.

In particular, the replacement section 32 carries out replacement for allocating
the code bit $b_0$ to the symbol bit $y_6$,
the code bit $b_1$ to the symbol bit $y_4$,
the code bit $b_2$ to the symbol bit $y_8$,
the code bit $b_3$ to the symbol bit $y_5$,
the code bit $b_4$ to the symbol bit $y_0$,
the code bit $b_5$ to the symbol bit $y_2$,
the code bit $b_6$ to the symbol bit $y_1$,
the code bit $b_7$ to the symbol bit $y_3$,
the code bit $b_8$ to the symbol bit $y_9$, and
the code bit $b_9$ to the symbol bit $y_7$.

B of FIG. 85 illustrates a second example of replacement of code bits in accordance with the allocation rule of FIG. 84 where the LDPC code is an LDPC code having a code length N of 64,800 bits and an encoding rate of 5/6 and besides the modulation method is 1024QAM and the multiple b is 1.

According to B of FIG. 85, the replacement section 32 carries out replacement for allocating the 10 × 1 (= mb) code bits $b_0$ to $b_9$ read out from the memory 31 in accordance with the allocation rule of FIG. 84 in such a manner as to allocate
the code bit $b_0$ to the symbol bit $y_7$,
the code bit $b_1$ to the symbol bit $y_8$,
the code bit $b_2$ to the symbol bit $y_3$,
the code bit $b_3$ to the symbol bit $y_4$,
the code bit $b_4$ to the symbol bit $y_5$,
the code bit $b_5$ to the symbol bit $y_0$, the code bit $b_6$ to the symbol bit $y_2$,
the code bit $b_7$ to the symbol bit $y_1$,
the code bit $b_8$ to the symbol bit $y_9$, and
the code bit $b_9$ to the symbol bit $y_6$.

FIG. 86 illustrates code bit groups and symbol bit groups where the LDPC code is an LDPC code having a code length N of 16,200 bits and an encoding rate of 8/9 and besides the modulation method is 1024QAM and the multiple b is 1.

In this instance, 10 × 1 (= mb) code bits read out from the memory 31 can be grouped into five code bit groups $Gb_1$, $Gb_2$, $Gb_3$, $Gb_4$ and $Gb_5$ as seen in A of FIG. 86 in accordance with the difference in error probability.

In A of FIG. 86, to the code bit group $Gb_1$, the code bit $b_0$ belongs; to the code bit group $Gb_2$, the code bit $b_1$ belongs; to the code bit group $Gb_3$, the code bits $b_2$ to $b_7$ belong; to the code bit group $Gb_4$, the code bit $b_8$ belongs; and to the code bit group $Gb_5$, the code bit $b_9$ belongs.

Where the modulation method is 1024QAM and the multiple b is 1, the 10 × 1 (= mb) symbol bits can be grouped into five symbol bit groups $Gy_1$, $Gy_2$, $Gy_3$, $Gy_4$ and $Gy_5$ as seen in B of FIG. 86 in accordance with the difference in error probability.

In B of FIG. 86, as with B of FIG. 62, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; and to the symbol bit group $Gy_5$, the symbol bits $y_8$ and $y_9$ belong.

FIG. 87 illustrates an allocation rule where the LDPC code is an LDPC code having a code length N of 16,200 bits and an encoding rate of 8/9 and besides the modulation method is 1024QAM and the multiple b is 1.

In the allocation rule of FIG. 87, group set information ($Gb_1$, $Gy_5$, 1), ($Gb_2$, $Gy_1$, 1), ($Gb_3$, $Gy_1$, 1), ($Gb_3$, $Gy_2$, 2), ($Gb_3$, $Gy_3$, 2), ($Gb_3$, $Gy_4$, 1), ($Gb_4$, $Gy_5$, 1) and ($Gb_5$, $Gy_4$, 1) is prescribed.

Accordingly, according to the allocation rule of FIG. 87, it is prescribed that,
depending upon the group set information ($Gb_1$, $Gy_5$, 1), one code bit of the code bit group $Gb_1$ which is best in error probability is allocated to one symbol bit of the symbol bit group $Gy_5$ which is fifth best in error probability, that
depending upon the group set information ($Gb_2$, $Gy_1$, 1), one code bit of the code bit group $Gb_2$ which is second best in error probability is allocated to one symbol bit of the symbol bit group $Gy_1$ which is best in error probability, that
depending upon the group set information ($Gb_3$, $Gy_1$, 1), one code bit of the code bit group $Gb_3$ which is third best in error probability are allocated to one symbol bit of the symbol bit group $Gy_1$ which is best in error probability, that
depending upon the group set information ($Gb_3$, $Gy_2$, 2), two code bits of the code bit group $Gb_3$ which is third best in error probability is allocated to two symbol bits of the symbol bit group $Gy_2$ which is second best in error probability, that
depending upon the group set information ($Gb_3$, $Gy_3$, 2), two code bits of the code bit group $Gb_3$ which is third best in error probability is allocated to two symbol bits of the symbol bit group $Gy_3$ which is third best in error probability, that
depending upon the group set information ($Gb_3$, $Gy_4$, 1), one code bit of the code bit group $Gb_3$ which is third best in error probability is allocated to one symbol bit of the symbol bit group $Gy_4$ which is fourth best in error probability, that depending upon the group set information ($Gb_4$, $Gy_5$, 1), one code bit of the code bit group $Gb_4$ which is fourth best in error probability is allocated to one symbol bit of the symbol bit group $Gy_5$ which is fifth best in error probability, and that depending upon the group set information ($Gb_5$, $Gy_4$, 1), one code bit of the code bit group $Gb_5$ which is fifth best in error probability is allocated to one symbol bit of the symbol bit group $Gy_4$ which is fourth best in error probability.

FIG. 88 illustrates an example of replacement of code bits in accordance with the allocation rule of FIG. 87.

In particular, A of FIG. 88 illustrates a first example of replacement of code bits in accordance with the allocation rule of FIG. 87 where the LDPC code is an LDPC code having a code length N of 16,200 bits and an encoding rate of 8/9 and besides the modulation method is 1024QAM and the multiple b is 1.

Where the LDPC code is an LDPC code having a code length N of 16,200 bits and an encoding rate of 8/9 and besides the modulation method is 1024QAM and the multiple b is 1, in the demultiplexer 25, code bits written in the memory 31 for $(16{,}200/(10 \times 1)) \times (10 \times 1)$ bits in the column direction × row direction are read out in a unit of $10 \times 1$ (= mb) bits in the row direction and are supplied to the replacement section 32 (FIGS. 16 and 17).

The replacement section 32 replaces the $10 \times 1$ (= mb) code bits $b_0$ to $b_9$ read out from the memory 31 in accordance with the allocation rule of FIG. 87 such that the $10 \times 1$ (= mb) code bits $b_0$ to $b_9$ are allocated, for example, to the 10 1 (= mb) symbol bits $y_0$ to $y_9$ of one (= b) symbol as seen in A of FIG. 88.

In particular, the replacement section 32 carries out replacement for allocating
the code bit $b_0$ to the symbol bit $y_8$,
the code bit $b_1$ to the symbol bit $y_0$,
the code bit $b_2$ to the symbol bit $y_1$,
the code bit $b_3$ to the symbol bit $y_2$,
the code bit $b_4$ to the symbol bit $y_3$,
the code bit $b_5$ to the symbol bit $y_4$,
the code bit $b_6$ to the symbol bit $y_6$,
the code bit $b_7$ to the symbol bit $y_5$,
the code bit $b_8$ to the symbol bit $y_9$, and
the code bit $b_9$ to the symbol bit $y_7$.

B of FIG. 88 illustrates a second example of replacement of code bits in accordance with the allocation rule of FIG. 87 where the LDPC code is an LDPC code having a code length N of 16,200 bits and an encoding rate of 8/9 and besides the modulation method is 1024QAM and the multiple b is 1.

According to B of FIG. 88, the replacement section 32 carries out replacement for allocating the $10 \times 1$ (= mb) code bits $b_0$ to $b_9$ read out from the memory 31 in accordance with the allocation rule of FIG. 87 in such a manner as to allocate
the code bit $b_0$ to the symbol bit $y_9$,
the code bit $b_1$ to the symbol bit $y_1$,
the code bit $b_2$ to the symbol bit $y_3$,
the code bit $b_3$ to the symbol bit $y_4$,
the code bit $b_4$ to the symbol bit $y_5$,
the code bit $b_5$ to the symbol bit $y_0$,
the code bit $b_6$ to the symbol bit $y_2$,
the code bit $b_7$ to the symbol bit $y_7$,
the code bit $b_8$ to the symbol bit $y_8$, and
the code bit $b_9$ to the symbol bit $y_6$.

FIG. 89 illustrates code bit groups and symbol bit groups where the LDPC code is an LDPC code having a code length N of 64,800 bits and an encoding rate of 8/9 and besides the modulation method is 1024QAM and the multiple b is 1.

In this instance, $10 \times 1$ (= mb) code bits read out from the memory 31 can be grouped into five code bit groups $Gb_1$, $Gb_2$, $Gb_3$, $Gb_4$ and $Gb_5$ as seen in A of FIG. 89 in accordance with the difference in error probability.

In A of FIG. 89, to the code bit group $Gb_1$, the code bit $b_0$ belongs; to the code bit group $Gb_2$, the code bit $b_1$ belongs; to the code bit group $Gb_3$, the code bits $b_2$ to $b_7$ belong; to the code bit group $Gb_4$, the code bit $b_8$ belongs; and to the code bit group $Gb_5$, the code bit $b_9$ belongs.

Where the modulation method is 1024QAM and the multiple b is 1, the $10 \times 1$ (= mb) symbol bits can be grouped into five symbol bit groups $Gy_1$, $Gy_2$, $Gy_3$, $Gy_4$ and $Gy_5$ as seen in B of FIG. 89 in accordance with the difference in error probability.

In B of FIG. 89, as with B of FIG. 62, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; and to the symbol bit group $Gy_5$, the symbol bits $y_8$ and $y_9$ belong.

FIG. 90 illustrates an allocation rule where the LDPC code is an LDPC code having a code length N of 64,800 bits and an encoding rate of 8/9 and besides the modulation method is 1024QAM and the multiple b is 1.

In the allocation rule of FIG. 90, group set information ($Gb_1$, $Gy_5$, 1), ($Gb_2$, $Gy_1$, 1), ($Gb_3$, $Gy_1$, 1), ($Gb_3$, $Gy_2$, 2), ($Gb_3$, $Gy_3$, 2), ($Gb_3$, $Gy_4$, 1), ($Gb_4$, $Gy_5$, 1) and ($Gb_5$, $Gy_4$, 1) is prescribed.

Accordingly, according to the allocation rule of FIG. 90, it is prescribed that,
depending upon the group set information ($Gb_1$, $Gy_5$, 1), one code bit of the code bit group $Gb_1$ which is best in error probability is allocated to one symbol bit of the symbol bit group $Gy_5$ which is fifth best in error probability, that
depending upon the group set information ($Gb_2$, $Gy_1$, 1), one code bit of the code bit group $Gb_2$ which is second best in error probability is allocated to one symbol bit of the symbol bit group $Gy_1$ which is best in error probability, that
depending upon the group set information ($Gb_3$, $Gy_1$, 1), one code bit of the code bit group $Gb_3$ which is third best in error probability are allocated to one symbol bit of the symbol bit group $Gy_1$ which is best in error probability, that
depending upon the group set information ($Gb_3$, $Gy_2$, 2), two code bits of the code bit group $Gb_3$ which is third best in error probability is allocated to two symbol bits of the symbol bit group $Gy_2$ which is second best in error probability, that
depending upon the group set Information ($Gb_3$, $Gy_3$, 2), two code bits of the code bit group $Gb_3$ which is third best in error probability is allocated to two symbol bits of the symbol bit group $Gy_3$ which is third best in error probability, that
depending upon the group set information ($Gb_3$, $Gy_4$, 1), one code bit of the code bit group $Gb_3$ which is third best in error probability is allocated to one symbol bit of the symbol bit group $Gy_4$ which is fourth best in error probability, that
depending upon the group set information ($Gb_4$, $Gy_5$, 1), one code bit of the code bit group $Gb_4$ which is fourth best in error probability is allocated to one symbol bit of the symbol bit group $Gy_5$ which is fifth best in error probability, and that
depending upon the group set information ($Gb_5$, $Gy_4$, 1), one code bit of the code bit group $Gb_5$ which is fifth best in error probability is allocated to one symbol bit of the symbol bit group $Gy_4$ which is fourth best in error probability.

FIG. 91 illustrates an example of replacement of code bits in accordance with the allocation rule of FIG. 90.

In particular, A of FIG. 91 illustrates a first example of replacement of code bits in accordance with the allocation rule of FIG. 90 where the LDPC code is an LDPC code having a code length N of 64,800 bits and an encoding rate of 8/9 and besides the modulation method is 1024QAM and the multiple b is 1.

Where the LDPC code is an LDPC code having a code length N of 64,800 bits and an encoding rate of 8/9 and besides the modulation method is 1024QAM and the multiple b is 1, in the demultiplexer 25, code bits written in the memory 31 for $(64{,}800/(10 \times 1)) \times (10 \times 1)$ bits in the column direction × row direction are read out in a unit of $10 \times 1$ (= mb) bits in the row direction and are supplied to the replacement section 32 (FIGS. 16 and 17).

The replacement section 32 replaces the $10 \times 1$ (= mb) code bits $b_0$ to $b_9$ read out from the memory 31 in accordance with the allocation rule of FIG. 90 such that the $10 \times 1$ (= mb) code bits $b_0$ to $b_9$ are allocated, for example, to the $10 \times 1$ (= mb) symbol bits $y_0$ to $y_9$ of one (= b) symbol as seen in A of FIG. 91.

In particular, the replacement section 32 carries out replacement for allocating
the code bit $b_0$ to the symbol bit $y_8$,
the code bit $b_1$ to the symbol bit $y_0$,
the code bit $b_2$ to the symbol bit $y_1$, the code bit $b_3$ to the symbol bit $y_2$,
the code bit $b_4$ to the symbol bit $y_3$,
the code bit $b_5$ to the symbol bit $y_4$,
the code bit $b_6$ to the symbol bit $y_6$,
the code bit $b_7$ to the symbol bit $y_5$,
the code bit $b_8$ to the symbol bit $y_9$, and
the code bit $b_9$ to the symbol bit $y_7$.

B of FIG. 91 illustrates a second example of replacement of code bits in accordance with the allocation rule of FIG. 90 where the LDPC code is an LDPC code having a code length N of 64,800 bits and an encoding rate of 8/9 and besides the modulation method is 1024QAM and the multiple b is 1.

According to B of FIG. 91, the replacement section 32 carries out replacement for allocating the $10 \times 1$ (= mb) code bits $b_0$ to $b_9$ read out from the memory 31 in accordance with the allocation rule of FIG. 90 in such a manner as to allocate
the code bit $b_0$ to the symbol bit $y_9$,
the code bit $b_1$ to the symbol bit $y_1$,
the code bit $b_2$ to the symbol bit $y_3$,
the code bit $b_3$ to the symbol bit $y_4$,
the code bit $b_4$ to the symbol bit $y_5$,
the code bit $b_5$ to the symbol bit $y_0$,
the code bit $b_6$ to the symbol bit $y_2$, the code bit $b_7$ to the symbol bit $y_7$,
the code bit $b_8$ to the symbol bit $y_8$, and
the code bit $b_9$ to the symbol bit $y_6$.

FIG. 92 illustrates code bit groups and symbol bit groups where the LDPC code is an LDPC code having a code length N of 64,800 bits and an encoding rate of 9/10 and besides the modulation method is 1024QAM and the multiple b is 1.

In this instance, 10 × 1 (= mb) code bits read out from the memory 31 can be grouped into three code bit groups $Gb_1$, $Gb_2$ and $Gb_3$ as seen in A of FIG. 92 in accordance with the difference in error probability.

In A of FIG. 92, to the code bit group $Gb_1$, the code bit $b_0$ belongs; to the code bit group $Gb_2$, the code bits $b_1$ to $b_8$ belong; and to the code bit group $Gb_3$, the code bit $b_9$ belongs.

Where the modulation method is 1024QAM and the multiple b is 1, the 10 × 1 (= mb) symbol bits can be grouped into five symbol bit groups $Gy_1$, $Gy_2$, $Gy_3$, $Gy_4$ and $Gy_5$ as seen in B of FIG. 92 in accordance with the difference in error probability.

In B of FIG. 92, as with B of FIG. 62, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; and to the symbol bit group $Gy_5$, the symbol bits $y_8$ and $y_9$ belong.

FIG. 93 illustrates an allocation rule where the LDPC code is an LDPC code having a code length N of 64,800 bits and an encoding rate of 9/10 and besides the modulation method is 1024QAM and the multiple b is 1.

In the allocation rule of FIG. 93, group set information ($Gb_1$, $Gy_5$, 1), ($Gb_2$, $Gy_1$, 2), ($Gb_2$, $Gy_2$, 2), ($Gb_2$, $Gy_3$, 2), ($Gb_2$, $Gy_4$, 1), ($Gb_2$, $Gy_5$, 1) and ($Gb_3$, $Gy_4$, 1) is prescribed.

Accordingly, according to the allocation rule of FIG. 93, it is prescribed that,

depending upon the group set information ($Gb_1$, $Gy_5$, 1), one code bit of the code bit group $Gb_1$ which is best in error probability is allocated to one symbol bit of the symbol bit group $Gy_5$ which is fifth best in error probability, that

depending upon the group set information ($Gb_2$, $Gy_1$, 2), two code bits of the code bit group $Gb_2$ which is second best in error probability is allocated to two symbol bits of the symbol bit group $Gy_1$ which is best in error probability, that

depending upon the group set information ($Gb_2$, $Gy_2$, 2), two code bits of the code bit group $Gb_2$ which is second best in error probability are allocated to two symbol bits of the symbol bit group $Gy_2$ which is second best in error probability, that

depending upon the group set information ($Gb_2$, $Gy_3$, 2), two code bits of the code bit group $Gb_2$ which is second best in error probability is allocated to two symbol bits of the symbol bit group $Gy_3$ which is third best in error probability, that

depending upon the group set information ($Gb_2$, $Gy_4$, 1), one code bit of the code bit group $Gb_2$ which is second best in error probability is allocated to one symbol bit of the symbol bit group $Gy_4$ which is fourth best in error probability, that

depending upon the group set information ($Gb_2$, $Gy_5$, 1), one code bit of the code bit group $Gb_2$ which is second best in error probability is allocated to one symbol bit of the symbol bit group $Gy_5$ which is fifth best in error probability, and that

depending upon the group set information ($Gb_3$, $Gy_4$, 1), one code bit of the code bit group $Gb_3$ which is third best in error probability is allocated to one symbol bit of the symbol bit group $Gy_4$ which is fourth best in error probability.

FIG. 94 illustrates an example of replacement of code bits in accordance with the allocation rule of FIG. 93.

In particular, A of FIG. 94 illustrates a first example of replacement of code bits in accordance with the allocation rule of FIG. 93 where the LDPC code is an LDPC code having a code length N of 64,800 bits and an encoding rate of 9/10 and besides the modulation method is 1024QAM and the multiple b is 1.

Where the LDPC code is an LDPC code having a code length N of 64,800 bits and an encoding rate of 9/10 and besides the modulation method is 1024QAM and the multiple b is 1, in the demultiplexer 25, code bits written in the memory 31 for (64,800/(10 × 1)) × (10 × 1) bits in the column direction × row direction are read out in a unit of 10 × 1 (= mb) bits in the row direction and are supplied to the replacement section 32 (FIGS. 16 and 17).

The replacement section 32 replaces the 10 × 1 (= mb) code bits $b_0$ to $b_9$ read out from the memory 31 in accordance with the allocation rule of FIG. 93 such that the 10 × 1 (= mb) code bits $b_0$ to $b_9$ are allocated, for example, to the 10 × 1 (= mb) symbol bits $y_0$ to $y_9$ of one (= b) symbol as seen in A of FIG. 94.

In particular, the replacement section 32 carries out replacement for allocating

the code bit $b_0$ to the symbol bit $y_8$,
the code bit $b_1$ to the symbol bit $y_0$,
the code bit $b_2$ to the symbol bit $y_1$,
the code bit $b_3$ to the symbol bit $y_2$,
the code bit $b_4$ to the symbol bit $y_3$,
the code bit $b_5$ to the symbol bit $y_4$,
the code bit $b_6$ to the symbol bit $y_6$, the code bit $b_7$ to the symbol bit $y_5$,
the code bit $b_8$ to the symbol bit $y_9$, and
the code bit $b_9$ to the symbol bit $y_7$.

B of FIG. 94 illustrates a second example of replacement of code bits in accordance with the allocation rule of FIG. 93 where the LDPC code is an LDPC code having a code length N of 64,800 bits and an encoding rate of 9/10 and besides the modulation method is 1024QAM and the multiple b is 1.

According to B of FIG. 94, the replacement section 32 carries out replacement for allocating the 10 × 1 (= mb) code bits $b_0$ to $b_5$ read out from the memory 31 in accordance with the allocation rule of FIG. 93 in such a manner as to allocate
the code bit $b_0$ to the symbol bit $y_8$,
the code bit $b_1$ to the symbol bit $y_6$,
the code bit $b_2$ to the symbol bit $y_9$,
the code bit $b_3$ to the symbol bit $y_4$,
the code bit $b_4$ to the symbol bit $y_5$,
the code bit $b_5$ to the symbol bit $y_0$,
the code bit $b_6$ to the symbol bit $y_2$,
the code bit $b_7$ to the symbol bit $y_1$,
the code bit $b_8$ to the symbol bit $y_3$, and
the code bit $b_9$ to the symbol bit $y_7$.

FIG. 95 illustrates code bit groups and symbol bit groups where the LDPC code is an LDPC code having a code length N of 16,200 bits and an encoding rate of 2/3 and besides the modulation method is 4096QAM and the multiple b is 1.

In this instance, $12 \times 1$ (= mb) code bits read out from the memory 31 can be grouped into three code bit groups $Gb_1$, $Gb_2$ and $Gb_3$ as seen in A of FIG. 95 in accordance with the difference in error probability.

In A of FIG. 95, to the code bit group $Gb_1$, the code bit $b_0$ belongs; to the code bit group $Gb_2$, the code bits $b_1$ to $b_7$ belong; and to the code bit group $Gb_3$, the code bits $b_8$ to $b_{11}$ belong.

Where the modulation method is 4096QAM and the multiple b is 1, the $12 \times 1$ (= mb) symbol bits can be grouped into six symbol bit groups $Gy_1$, $Gy_2$, $Gy_3$, $Gy_4$, $Gy_5$ and $Gy_6$ as seen in B of FIG. 95 in accordance with the difference in error probability.

In B of FIG. 95, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; to the symbol bit group $Gy_5$, the symbol bits $y_8$ and $y_9$ belong; and to the symbol bit group $Gy_6$, the symbol bits $y_{10}$ and $y_{11}$ belong.

FIG. 96 illustrates an allocation rule where the LDPC code is an LDPC code having a code length N of 16,200 bits and an encoding rate of 2/3 and besides the modulation method is 4096QAM and the multiple b is 1.

In the allocation rule of FIG. 96, group set information ($Gb_1$, $Gy_6$, 1), ($Gb_2$, $Gy_1$, 2), ($Gb_2$, $Gy_2$, 2), ($Gb_2$, $Gy_3$, 2), ($Gb_2$, $Gy_4$, 1), ($Gb_3$, $Gy_4$, 1), ($Gb_3$, $Gy_5$, 2) and ($Gb_3$, $Gy_6$, 1) is prescribed.

Accordingly, according to the allocation rule of FIG. 96, it is prescribed that,
depending upon the group set information ($Gb_1$, $Gy_6$, 1), one code bit of the code bit group $Gb_1$ which is best in error probability is allocated to one symbol bit of the symbol bit group $Gy_6$ which is sixth best in error probability, that
depending upon the group set information ($Gb_2$, $Gy_1$, 2), two code bits of the code bit group $Gb_2$ which is second best in error probability is allocated to two symbol bits of the symbol bit group-$Gy_1$ which is best in error probability, that
depending upon the group set information ($Gb_2$, $Gy_2$, 2), two code bits of the code bit group $Gb_2$ which is second best in error probability are allocated to two symbol bits of the symbol bit group $Gy_2$ which is second best in error probability, that
depending upon the group set information ($Gb_2$, $Gy_3$, 2), two code bits of the code bit group $Gb_2$ which is second best in error probability is allocated to two symbol bits of the symbol bit group $Gy_3$ which is third best in error probability, that
depending upon the group set information ($Gb_2$, $Gy_4$, 1), one code bit of the code bit group $Gb_2$ which is second best in error probability is allocated to one symbol bit of the symbol bit group $Gy_4$ which is fourth best in error probability, that
depending upon the group set information ($Gb_3$, $Gy_4$, 1), one code bit of the code bit group $Gb_3$ which is third best in error probability is allocated to one symbol bit of the symbol bit group $Gy_4$ which is fourth best in error probability, that
depending upon the group set information ($Gb_3$, $Gy_5$, 2), two code bits of the code bit group $Gb_3$ which is third best in error probability is allocated to two symbol bits of the symbol bit group $Gy_5$ which is fifth best in error probability, and that
depending upon the group set information ($Gb_3$, $Gy_6$, 1), one code bit of the code bit group $Gb_3$ which is third best in error probability is allocated to one symbol bit of the symbol bit group $Gy_6$ which is sixth best in error probability.

FIG. 97 illustrates an example of replacement of code bits in accordance with the allocation rule of FIG. 96.

In particular, A of FIG. 97 illustrates a first example of replacement of code bits in accordance with the allocation rule of FIG. 96 where the LDPC code is an LDPC code having a code length N of 16,200 bits and an encoding rate of 2/3 and besides the modulation method is 4096QAM and the multiple b is 1.

Where the LDPC code is an LDPC code having a code length N of 16,200 bits and an encoding rate of 2/3 and besides the modulation method is 4096QAM and the multiple b is 1, in the demultiplexer 25, code bits written in the memory 31 for $(16{,}200/(12 \times 1)) \times (12 \times 1)$ bits in the column direction $\times$ row direction are read out in a unit of $12 \times 1$ (= mb) bits in the row direction and are supplied to the replacement section 32 (FIGS. 16 and 17).

The replacement section 32 replaces the $12 \times 1$ (= mb) code bits $b_0$ to $b_{11}$ read out from the memory 31 in accordance with the allocation rule of FIG. 96 such that the $12 \times 1$ (= mb) code bits $b_0$ to $b_{11}$ are allocated, for example, to the $12 \times 1$ (= mb) symbol bits $y_0$ to $y_{11}$ of one (= b) symbol as seen in A of FIG. 97.

In particular, the replacement section 32 carries out replacement for allocating

the code bit $b_0$ to the symbol bit $y_{10}$,
the code bit $b_1$ to the symbol bit $y_0$,
the code bit $b_2$ to the symbol bit $y_1$,
the code bit $b_3$ to the symbol bit $y_2$,
the code bit $b_4$ to the symbol bit $y_3$,
the code bit $b_5$ to the symbol bit $y_4$,
the code bit $b_6$ to the symbol bit $y_5$,
the code bit $b_7$ to the symbol bit $y_6$,
the code bit $b_8$ to the symbol bit $y_8$,
the code bit $b_9$ to the symbol bit $y_7$,
the code bit $b_{10}$ to the symbol bit $y_{11}$, and
the code bit $b_{11}$ to the symbol bit $y_9$.

B of FIG. 97 illustrates a second example of replacement of code bits in accordance with the allocation rule of FIG. 96 where the LDPC code is an LDPC code having a code length N of 16,200 bits and an encoding rate of 2/3 and besides the modulation method is 4096QAM and the multiple b is 1.

According to B of FIG. 97, the replacement section 32 carries out replacement for allocating the 12 × 1 (= mb) code bits $b_0$ to $b_{11}$ read out from the memory 31 in accordance with the allocation rule of FIG. 96 in such a manner as to allocate
the code bit $b_0$ to the symbol bit $y_{11}$,
the code bit $b_1$ to the symbol bit $y_1$,
the code bit $b_2$ to the symbol bit $y_3$,
the code bit $b_3$ to the symbol bit $y_4$,
the code bit $b_4$ to the symbol bit $y_5$,
the code bit $b_5$ to the symbol bit $y_0$,
the code bit $b_6$ to the symbol bit $y_2$,
the code bit $b_7$ to the symbol bit $y_7$,
the code bit $b_8$ to the symbol bit $y_9$,
the code bit $b_9$ to the symbol bit $y_6$,
the code bit $b_{10}$ to the symbol bit $y_{10}$, and
the code bit $b_{11}$ to the symbol bit $y_8$.

FIG. 98 illustrates code bit groups and symbol bit groups where the LDPC code is an LDPC code having a code length N of 64,800 bits and an encoding rate of 2/3 and besides the modulation method is 4096QAM and the multiple b is 1.

In this instance, 12 × 1 (= mb) code bits read out from the memory 31 can be grouped into three code bit groups $Gb_1$, $Gb_2$ and $Gb_3$ as seen in A of Fig. 98 in accordance with the difference in error probability.

In A of FIG. 98, to the code bit group $Gb_1$, the code bit $b_0$ belongs; to the code bit group $Gb_2$, the code bits $b_1$ to $b_7$ belong; and to the code bit group $Gb_3$, the code bits $b_8$ to $b_{11}$ belong.

Where the modulation method is 4096QAM and the multiple b is 1, the 12 × 1 (= mb) symbol bits can be grouped into six symbol bit groups $Gy_1$, $Gy_2$, $Gy_3$, $Gy_4$, $Gy_5$ and $Gy_6$ as seen in B of FIG. 98 in accordance with the difference in error probability.

In B of FIG. 98, as with the case in B of FIG. 95, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; to the symbol bit group $Gy_5$, the symbol bits $y_8$ and $y_9$ belong; and to the symbol bit group $Gy_6$, the symbol bits $y_{10}$ and $y_{11}$ belong.

FIG. 99 illustrates an allocation rule where the LDPC code is an LDPC code having a code length N of 64,800 bits and an encoding rate of 2/3 and besides the modulation method is 4096QAM and the multiple b is 1.

In the allocation rule of FIG. 99, group set information ($Gb_1$, $Gy_6$, 1), ($Gb_2$, $Gy_1$, 2), ($Gb_2$, $Gy_2$, 2), ($Gb_2$, $Gy_3$, 2), ($Gb_2$, $Gy_4$, 1), ($Gb_3$, $Gy_4$, 1), ($Gb_3$, $Gy_5$, 2) and ($Gb_3$, $Gy_6$, 1) is prescribed.

Accordingly, according to the allocation rule of FIG. 99, it is prescribed that,
depending upon the group set information ($Gb_1$, $Gy_6$, 1), one code bit of the code bit group $Gb_1$ which is best in error probability is allocated to one symbol bit of the symbol bit group $Gy_6$ which is sixth best in error probability, that
depending upon the group set information ($Gb_2$, $Gy_1$, 2), two code bits of the code bit group $Gb_2$ which is second best in error probability is allocated to two symbol bits of the symbol bit group $Gy_1$ which is best in error probability, that
depending upon the group set information ($Gb_2$, $Gy_2$, 2), two code bits of the code bit group $Gb_2$ which is second best in error probability are allocated to two symbol bits of the symbol bit group $Gy_2$ which is second best in error probability, that
depending upon the group set information ($Gb_2$, $Gy_3$, 2), two code bits of the code bit group $Gb_2$ which is second best in error probability is allocated to two symbol bits of the symbol bit group $Gy_3$ which is third best in error probability, that
depending upon the group set information ($Gb_2$, $Gy_4$, 1), one code bit of the code bit group $Gb_2$ which is second best in error probability is allocated to one symbol bit of the symbol bit group $Gy_4$ which is fourth best in error probability, that depending upon the group set information ($Gb_3$, $Gy_4$, 1), one code bit of the code bit group $Gb_3$ which is third best in error probability is allocated to one symbol bit of the symbol bit group $Gy_4$ which is fourth best in error probability, that depending upon the group set information ($Gb_3$, $Gy_5$, 2), two code bits of the code bit group $Gb_3$ which is third best in error probability is allocated to two symbol bits of the symbol bit group $Gy_5$ which is fifth best in error probability, and that depending upon the group set information ($Gb_3$, $Gy_6$, 1), one code bit of the code bit group $Gb_3$ which is third best in error probability is allocated to one symbol bit of the symbol bit group $Gy_6$ which is sixth best in error probability.

FIG. 100 illustrates an example of replacement of code bits in accordance with the allocation rule of FIG. 99.

In particular, A of FIG. 100 illustrates a first example of replacement of code bits in accordance with the allocation rule of FIG. 99 where the LDPC code is an LDPC code having a code length N of 64,800 bits and an encoding rate of 2/3 and besides the modulation method is 4096QAM and the multiple b is 1.

Where the LDPC code is an LDPC code having a code length N of 64,800 bits and an encoding rate of 2/3 and besides the modulation method is 4096QAM and the multiple b is 1, in the demultiplexer 25, code bits written in the memory 31 for $(64{,}800/(12 \times 1)) \times (12 \times 1)$ bits in the column direction × row direction are read out in a unit of $12 \times 1$ (= mb) bits in the row direction and are supplied to the replacement section 32 (FIGS. 16 and 17).

The replacement section 32 replaces the $12 \times 1$ (= mb) code bits $b_0$ to $b_{11}$ read out from the memory 31 in accordance with the allocation rule of FIG. 99 such that the $12 \times 1$ (= mb) code bits $b_0$ to $b_{11}$ are allocated, for example, to the $12 \times 1$ (= mb) symbol bits $y_0$ to $y_{11}$ of one (= b) symbol as seen in A of FIG. 100.

In particular, the replacement section 32 carries out replacement for allocating
the code bit $b_0$ to the symbols bit $y_{10}$,
the code bit $b_1$ to the symbols bit $y_0$,
the code bit $b_2$ to the symbol bit $y_1$,
the code bit $b_3$ to the symbol bit $y_2$,
the code bit $b_4$ to the symbol bit $y_3$,
the code bit $b_5$ to the symbol bit $y_4$,
the code bit $b_6$ to the symbol bit $y_5$,
the code bit $b_7$ to the symbol bit $y_6$,
the code bit $b_8$ to the symbol bit $y_8$,
the code bit $b_9$ to the symbol bit $y_7$,
the code bit $b_{10}$ to the symbol bit $y_{11}$, and
the code bit $b_{11}$ to the symbol bit $y_9$.

B of FIG. 100 illustrates a second example of replacement of code bits in accordance with the allocation rule of FIG. 99 where the LDPC code is an LDPC code having a code length N of 64,800 bits and an encoding rate of 2/3 and besides the modulation method is 4096QAM and the multiple b is 1.

According to B of FIG. 100, the replacement section 32 carries out replacement for allocating the $12 \times 1$ (= mb) code bits $b_0$ to $b_{11}$ read out from the memory 31 in accordance with the allocation rule of FIG. 99 in such a manner as to allocate
the code bit $b_0$ to the symbol bit $y_{11}$,
the code bit $b_1$ to the symbol bit $y_1$,
the code bit $b_2$ to the symbol bit $y_3$,
the code bit $b_3$ to the symbol bit $y_4$,
the code bit $b_4$ to the symbol bit $y_5$,
the code bit $b_5$ to the symbol bit $y_0$,
the code bit $b_6$ to the symbol bit $y_2$,
the code bit $b_7$ to the symbol bit $y_7$,
the code bit $b_8$ to the symbol bit $y_9$,
the code bit $b_9$ to the symbol bit $y_6$,
the code bit $b_{10}$ to the symbol bit $y_{10}$, and
the code bit $b_{11}$ to the symbol bit $y_8$.

FIG. 101 illustrates code bit groups and symbol bit groups where the LDPC code is an LDPC code having a code length N of 16,200 bits and an encoding rate of 3/4 and besides the modulation method is 4096QAM and the multiple b is 1.

In this instance, $12 \times 1$ (= mb) code bits read out from the memory 31 can be grouped into four code bit groups $Gb_1$, $Gb_2$, $Gb_3$ and $Gb_4$ as seen in A of FIG. 101 in accordance with the difference in error probability.

In A of FIG. 101, to the code bit group $Gb_1$, the code bit $b_0$ belongs; to the code bit group $Gb_2$, the code bits $b_1$ to $b_7$ belong; to the code bit group $Gb_3$, the code bit $b_8$ belongs; and to the code bit group $Gb_4$, the code bits $b_9$ to $b_{11}$ belong.

Where the modulation method is 4096QAM and the multiple b is 1, the $12 \times 1$ (= mb) symbol bits can be grouped into six symbol bit groups $Gy_1$, $Gy_2$, $Gy_3$, $Gy_4$, $Gy_5$ and $Gy_6$ as seen in B of FIG. 101 in accordance with the difference in error probability.

In B of FIG. 101, as with the case in B of FIG. 95, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; to the symbol bit group $Gy_5$, the symbol bits $y_8$ and $y_9$ belong; and to the symbol bit group $Gy_6$, the symbol bits $y_{10}$ and $y_{11}$ belong.

FIG. 102 illustrates an allocation rule where the LDPC code is an LDPC code having a code length N of 16,200 bits and an encoding rate of 3/4 and besides the modulation method is 4096QAM and the multiple b is 1.

In the allocation rule of FIG. 102, group set information ($Gb_1$, $Gy_5$, 1), ($Gb_2$, $Gy_1$, 2), ($Gb_2$, $Gy_2$, 2), ($Gb_2$, $Gy_3$, 2), ($Gb_2$, $Gy_4$, 1), ($Gb_3$, $Gy_4$, 1), ($Gb_4$, $Gy_5$, 1) and ($Gb_4$, $Gy_6$, 2) is prescribed.

Accordingly, according to the allocation rule of FIG. 102, it is prescribed that, depending upon the group set information ($Gb_1$, $Gy_5$, 1), one code bit of the code bit group $Gb_1$ which is best in error probability is allocated to one symbol bit of the symbol bit group $Gy_5$ which is fifth best in error probability, that
depending upon the group set information ($Gb_2$, $Gy_1$, 2), two code bits of the code bit group $Gb_2$ which is second best in error probability is allocated to two symbol bits of the symbol bit group $Gy_1$ which is best in error probability, that
depending upon the group set information ($Gb_2$, $Gy_2$, 2), two code bits of the code bit group $Gb_2$ which is second best in error probability are allocated to two symbol bits of the symbol bit group $Gy_2$ which is second best in error probability, that
depending upon the group set information ($Gb_2$, $Gy_3$, 2), two code bits of the code bit group $Gb_2$ which is second best in error probability is allocated to two symbol bits of the symbol bit group $Gy_3$ which is third best in error probability, that
depending upon the group set information ($Gb_2$, $Gy_4$, 1), one code bit of the code bit group $Gb_2$ which is second best in error probability is allocated to one symbol bit of the symbol bit group $Gy_4$ which is fourth best in error probability, that
depending upon the group set information ($Gb_3$, $Gy_4$, 1), one code bit of the code bit group $Gb_3$ which is third best in error probability is allocated to one symbol bit of the symbol bit group $Gy_4$ which is fourth best in error probability, that
depending upon the group set information ($Gb_4$, $Gy_5$, 1), one code bit of the code bit group $Gb_4$ which is fourth best in error probability is allocated to one symbol bit of the symbol bit group $Gy_5$ which is fifth best in error probability, and that
depending upon the group set information ($Gb_4$, $Gy_6$, 2), two code bits of the code bit group $Gb_4$ which is fourth best in error probability is allocated to two symbol bits of the symbol bit group $Gy_6$ which is sixth best in error probability.

FIG. 103 illustrates an example of replacement of code bits in accordance with the allocation rule of FIG. 102.

In particular, A of FIG. 103 illustrates a first example of replacement of code bits in accordance with the allocation rule of FIG. 102 where the LDPC code is an LDPC code having a code length N of 16,200 bits and an encoding rate of 3/4 and besides the modulation method is 4096QAM and the multiple b is 1.

Where the LDPC code is an LDPC code having a code length N of 16,200 bits and an encoding rate of 3/4 and besides the modulation method is 4096QAM and the multiple b is 1, in the demultiplexer 25, code bits written in the memory 31 for $(16,200/(12 \times 1)) \times (12 \times 1)$ bits in the column direction $\times$ row direction are read out in a unit of $12 \times 1$ (= mb) bits in the row direction and are supplied to the replacement section 32 (FIGS. 16 and 17).

The replacement section 32 replaces the $12 \times 1$ (= mb) code bits $b_0$ to $b_{11}$ read out from the memory 31 in accordance with the allocation rule of FIG. 102 such that the $12 \times 1$ (= mb) code bits $b_0$ to $b_{11}$ are allocated, for example, to the $12 \times 1$ (= mb) symbol bits $y_0$ to $y_{11}$ of one (= b) symbol as seen in A of FIG. 103.

In particular, the replacement section 32 carries out replacement for allocating
the code bit $b_0$ to the symbol bit $y_8$,
the code bit $b_1$ to the symbol bit $y_0$,
the code bit $b_2$ to the symbol bit $y_6$,
the code bit $b_3$ to the symbol bit $y_1$,
the code bit $b_4$ to the symbol bit $y_4$,
the code bit $b_5$ to the symbol bit $y_5$,
the code bit $b_6$ to the symbol bit $y_2$,
the code bit $b_7$ to the symbol bit $y_3$,
the code bit $b_8$ to the symbol bit $y_7$,
the code bit $b_9$ to the symbol bit $y_{10}$,
the code bit $b_{10}$ to the symbol bit $y_{11}$, and
the code bit $b_{11}$ to the symbol bit $y_9$.

B of FIG. 103 illustrates a second example of replacement of code bits in accordance with the allocation rule of FIG. 102 where the LDPC code is an LDPC code having a code length N of 16,200 bits and an encoding rate of 3/4 and besides the modulation method is 4096QAM and the multiple b is 1.

According to B of FIG. 103, the replacement section 32 carries out replacement for allocating the $12 \times 1$ (= mb) code bits $b_0$ to $b_{11}$ read out from the memory 31 in accordance with the allocation rule of FIG. 102 in such a manner as to allocate
the code bit $b_1$ to the symbol bit $y_9$,

the code bit $b_1$ to the symbol bit $y_1$,
the code bit $b_2$ to the symbol bit $y_3$,
the code bit $b_3$ to the symbol bit $y_4$,
the code bit $b_4$ to the symbol bit $y_5$, the code bit $b_5$ to the symbol bit $y_0$,
the code bit $b_6$ to the symbol bit $y_2$,
the code bit $b_7$ to the symbol bit $y_7$,
the code bit $b_8$ to the symbol bit $y_6$,
the code bit $b_9$ to the symbol bit $y_{11}$,
the code bit $b_{10}$ to the symbol bit $y_{10}$, and
the code bit $b_{11}$ to the symbol bit $y_8$.

FIG. 104 illustrates code bit groups and symbol bit groups where the LDPC code is an LDPC code having a code length N of 64,800 bits and an encoding rate of 3/4 and besides the modulation method is 4096QAM and the multiple b is 1.

In this instance, 12 × 1 (= mb) code bits read out from the memory 31 can be grouped into three code bit groups $Gb_1$, $Gb_2$ and $Gb_3$ as seen in A of FIG. 104 in accordance with the difference in error probability.

In A of FIG. 104, to the code bit group $Gb_1$, the code bit $b_0$ belongs; to the code bit group $Gb_2$, the code bits $b_1$ to $b_8$ belong; and to the code bit group $Gb_3$, the code bits $b_9$ to $b_{11}$ belong.

Where the modulation method is 4096QAM and the multiple b is 1, the 12 × 1 (= mb) symbol bits can be grouped into six symbol bit groups $Gy_1$, $Gy_2$, $Gy_3$, $Gy_4$, $Gy_5$ and $Gy_6$ as seen in B of FIG. 104 in accordance with the difference in error probability.

In B of FIG. 104, as with the case in B of FIG. 95, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; to the symbol bit group $Gy_5$, the symbol bits $y_8$ and $y_9$ belong; and to the symbol bit group $Gy_6$, the symbol bits $y_{10}$ and $y_{11}$ belong.

FIG. 105 illustrates an allocation rule where the LDPC code is an LDPC code having a code length N of 64,800 bits and an encoding rate of 3/4 and besides the modulation method is 1024QAM and the multiple b is 1.

In the allocation rule of FIG. 105, group set information ($Gb_1$, $Gy_5$, 1), ($Gb_2$, $Gy_1$, 2), ($Gb_2$, $Gy_2$, 2), ($Gb_2$, $Gy_3$, 2), ($Gb_2$, $Gy_4$, 2), ($Gb_3$, $Gy_5$, 1) and ($Gb_3$, $Gy_6$, 2) is prescribed.

Accordingly, according to the allocation rule of FIG. 105, it is prescribed that,
depending upon the group set information ($Gb_1$, $Gy_5$, 1), one code bit of the code bit group $Gb_1$ which is best in error probability is allocated to one symbol bit of the symbol bit group $Gy_5$ which is fifth best in error probability, that
depending upon the group set information ($Gb_2$, $Gy_1$, 2), two code bits of the code bit group $Gb_2$ which is second best in error probability is allocated to two symbol bits of the symbol bit group $Gy_1$ which is best in error probability, that
depending upon the group set information ($Gb_2$, $Gy_2$, 2), two code bits of the code bit group $Gb_2$ which is second best in error probability are allocated to two symbol bits of the symbol bit group $Gy_2$ which is second best in error probability, that
depending upon the group set information ($Gb_2$, $Gy_3$, 2), two code bits of the code bit group $Gb_2$ which is second best in error probability is allocated to two symbol bits of the symbol bit group $Gy_3$ which is third best in error probability, that
depending upon the group set information ($Gb_2$, $Gy_4$, 2), two code bits of the code bit group $Gb_2$ which is second best in error probability is allocated to two symbol bits of the symbol bit group $Gy_4$ which is fourth best in error probability, that
depending upon the group set information ($Gb_3$, $Gy_5$, 1), one code bit of the code bit group $Gb_3$ which is third best in error probability is allocated to one symbol bit of the symbol bit group $Gy_5$ which is fifth best in error probability, and that
depending upon the group set information ($Gb_3$, $Gy_6$, 2), two code bits of the code bit group $Gb_3$ which is third best in error probability is allocated to two symbol bits of the symbol bit group $Gy_6$ which is sixth best in error probability.

FIG. 106 illustrates an example of replacement of code bits in accordance with the allocation rule of FIG. 105.

In particular, A of FIG. 106 illustrates a first example of replacement of code bits in accordance with the allocation rule of FIG. 105 where the LDPC code is an LDPC code having a code length N of 64,800 bits and an encoding rate of 3/4 and besides the modulation method is 4096QAM and the multiple b is 1.

Where the LDPC code is an LDPC code having a code length N of 64,800 bits and an encoding rate of 3/4 and besides the modulation method is 4096QAM and the multiple b is 1, in the demultiplexer 25, code bits written in the memory 31 for (64,800/(12 × 1)) × (12 × 1) bits in the column direction × row direction are read out in a unit of 12 × 1 (= mb) bits in the row direction and are supplied to the replacement section 32 (FIGS. 16 and 17).

The replacement section 32 replaces the 12 × 1 (= mb) code bits $b_0$ to $b_{11}$ read out from the memory 31 in accordance with the allocation rule of FIG. 105 such that the 12 × 1 (= mb) code bits $b_0$ to $b_{11}$ are allocated, for example, to the 12 × 1 (= mb) symbol bits $y_0$ to $y_{11}$ of one (= b) symbol as seen in A of FIG. 106.

In particular, the replacement section 32 carries out replacement for allocating
the code bit $b_0$ to the symbol bit $y_8$,
the code bit $b_1$ to the symbol bit $y_0$,
the code bit $b_2$ to the symbol bit $y_6$,

the code bit $b_3$ to the symbol bit $y_1$,
the code bit $b_4$ to the symbol bit $y_4$,
the code bit $b_5$ to the symbol bit $y_5$,
the code bit $b_6$ to the symbol bit $y_2$, the code bit $b_7$ to the symbol bit $y_3$,
the code bit $b_8$ to the symbol bit $y_7$,
the code bit $b_9$ to the symbol bit $y_{10}$,
the code bit $b_{10}$ to the symbol bit $y_{11}$, and
the code bit $b_{11}$ to the symbol bit $y_9$.

B of FIG. 106 illustrates a second example of replacement of code bits in accordance with the allocation rule of FIG. 105 where the LDPC code is an LDPC code having a code length N of 64,800 bits and an encoding rate of 3/4 and besides the modulation method is 4096QAM and the multiple b is 1.

According to B of FIG. 106, the replacement section 32 carries out replacement for allocating the 12 × 1 (= mb) code bits $b_0$ to $b_{11}$ read out from the memory 31 in accordance with the allocation rule of FIG. 105 in such a manner as to allocate
the code bit $b_0$ to the symbol bit $y_9$,
the code bit $b_1$ to the symbol bit $y_1$,
the code bit $b_2$ to the symbol bit $y_3$,
the code bit $b_3$ to the symbol bit $y_4$,
the code bit $b_4$ to the symbol bit $y_5$,
the code bit $b_5$ to the symbol bit $y_0$,
the code bit $b_6$ to the symbol bit $y_2$,
the code bit $b_7$ to the symbol bit $y_7$,
the code bit $b_8$ to the symbol bit $y_6$,
the code bit $b_9$ to the symbol bit $y_{11}$,
the code bit $b_{10}$ to the symbol bit $y_{10}$, and
the code bit $b_{11}$ to the symbol bit $y_8$.

FIG. 107 illustrates code bit groups and symbol bit groups where the LDPC code is an LDPC code having a code length N of 16,200 bits and an encoding rate of 4/5 and besides the modulation method is 4096QAM and the multiple b is 1.

In this instance, 12 × 1 (= mb) code bits read out from the memory 31 can be grouped into three code bit groups $Gb_1$, $Gb_2$ and $Gb_3$ as seen in A of FIG. 107 in accordance with the difference in error probability.

In A of FIG. 107, to the code bit group $Gb_1$, the code bits $b_0$ to $b_8$ belong; to the code bit group $Gb_2$, the code bit $b_9$ belongs; and to the code bit group $Gb_3$, the code bits $b_{10}$ and $b_{11}$ belong.

Where the modulation method is 4096QAM and the multiple b is 1, the 12 × 1 (= mb) symbol bits can be grouped into six symbol bit groups $Gy_1$, $Gy_2$, $Gy_3$, $Gy_4$, $Gy_5$ and $Gy_6$ as seen in B of FIG. 107 in accordance with the difference in error probability.

In B of FIG. 107, as with the case in B of FIG. 95, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; to the symbol bit group $Gy_5$, the symbol bits $y_8$ and $y_9$ belong; and to the symbol bit group $Gy_6$, the symbol bits $y_{10}$ and $y_{11}$ belong.

FIG. 108 illustrates an allocation rule where the LDPC code is an LDPC code having a code length N of 16,200 bits and an encoding rate of 4/5 and besides the modulation method is 4096QAM and the multiple b is 1.

In the allocation rule of FIG. 108, group set information ($Gb_1$, $Gy_1$, 2), ($Gb_1$, $Gy_2$, 2), ($Gb_1$, $Gy_3$, 2), ($Gb_1$, $Gy_4$, 2), ($Gb_1$, $Gy_5$, 1), ($Gb_2$, $Gy_6$, 1), ($Gb_3$, $Gy_5$, 1) and ($Gb_3$, $Gy_6$, 1) is prescribed.

Accordingly, according to the allocation rule of FIG. 108, it is prescribed that,
depending upon the group set information ($Gb_1$, $Gy_1$, 2), two code bits of the code bit group $Gb_1$ which is best in error probability is allocated to two symbol bits of the symbol bit group $Gy_1$ which is best in error probability, that
depending upon the group set information ($Gb_1$, $Gy_2$, 2), two code bits of the code bit group $Gb_1$ which is best in error probability is allocated to two symbol bits of the symbol bit group $Gy_2$ which is second best in error probability, that
depending upon the group set information ($Gb_1$, $Gy_3$, 2), two code bits of the code bit group $Gb_1$ which is best in error probability are allocated to two symbol bits of the symbol bit group $Gy_3$ which is third best in error probability, that
depending upon the group set information ($Gb_1$, $Gy_4$, 2), two code bits of the code bit group $Gb_1$ which is best in error probability is allocated to two symbol bits of the symbol bit group $Gy_4$ which is fourth best in error probability, that
depending upon the group set information ($Gb_1$, $Gy_5$, 1), one code bit of the code bit group $Gb_1$ which is best in error probability is allocated to one symbol bit of the symbol bit group $Gy_5$ which is fifth best in error probability, that
depending upon the group set information ($Gb_2$, $Gy_6$, 1), one code bit of the code bit group $Gb_2$ which is second best in error probability is allocated to one symbol bit of the symbol bit group $Gy_6$ which is sixth best in error probability, that
depending upon the group set information ($Gb_3$, $Gy_5$, 1), one code bit of the code bit group $Gb_3$ which is third best in error probability is allocated to one symbol bit of the symbol bit group $Gy_5$ which is fifth best in error probability, and that depending upon the group set information ($Gb_3$, $Gy_6$, 1), one code bit of the code bit group $Gb_3$ which is third best in error probability is allocated to one symbol bit of the symbol bit group $Gy_6$ which is sixth best in error probability.

FIG. 109 illustrates an example of replacement of code bits in accordance with the allocation rule of FIG. 108.

In particular, A of FIG. 109 illustrates a first example of replacement of code bits in accordance with the allocation rule of FIG. 108 where the LDPC code is an LDPC code having a code length N of 16,200 bits and an encoding rate of 4/5 and besides the modulation method is 4096QAM and the multiple b is 1.

Where the LDPC code is an LDPC code having a code length N of 16,200 bits and an encoding rate of 4/5 and besides the modulation method is 4096QAM and the multiple b is 1, in the demultiplexer 25, code bits written in the memory 31 for $(16{,}200/(12 \times 1)) \times (12 \times 1)$ bits in the column direction × row direction are read out in a unit of $12 \times 1$ (= mb) bits in the row direction and are supplied to the replacement section 32 (FIGS. 16 and 17).

The replacement section 32 replaces the $12 \times 1$ (= mb) code bits $b_0$ to $b_{11}$ read out from the memory 31 in accordance with the allocation rule of FIG. 108 such that the $12 \times 1$ (= mb) code bits $b_0$ to $b_{11}$ are allocated, for example, to the $12 \times 1$ (= mb) symbol bits $y_0$ to $y_{11}$ of one (= b) symbol as seen in A of FIG. 109.

In particular, the replacement section 32 carries out replacement for allocating
the code bit $b_0$ to the symbol bit $y_8$,
the code bit $b_1$ to the symbol bit $y_0$,
the code bit $b_2$ to the symbol bit $y_6$,
the code bit $b_3$ to the symbol bit $y_1$,
the code bit $b_4$ to the symbol bit $y_4$,
the code bit $b_5$ to the symbol bit $y_5$,
the code bit $b_6$ to the symbol bit $y_2$,
the code bit $b_7$ to the symbol bit $y_3$,
the code bit $b_8$ to the symbol bit $y_7$,
the code bit $b_9$ to the symbol bit $y_{10}$,
the code bit $b_{10}$ to the symbol bit $y_{11}$, and
the code bit $b_{11}$ to the symbol bit $y_9$.

B of FIG. 109 illustrates a second example of replacement of code bits in accordance with the allocation rule of FIG. 108 where the LDPC code is an LDPC code having a code length N of 16,200 bits and an encoding rate of 4/5 and besides the modulation method is 4096QAM and the multiple b is 1.

According to B of FIG. 109, the replacement section 32 carries out replacement for allocating the $12 \times 1$ (= mb) code bits $b_0$ to $b_{11}$ read out from the memory 31 in accordance with the allocation rule of FIG. 108 in such a manner as to allocate
the code bit $b_0$ to the symbol bit $y_6$,
the code bit $b_1$ to the symbol bit $y_1$,
the code bit $b_2$ to the symbol bit $y_3$,
the code bit $b_3$ to the symbol bit $y_4$,
the code bit $b_4$ to the symbol bit $y_5$,
the code bit $b_5$ to the symbol bit $y_0$,
the code bit $b_6$ to the symbol bit $y_2$,
the code bit $b_7$ to the symbol bit $y_7$,
the code bit $b_8$ to the symbol bit $y_9$,
the code bit $b_9$ to the symbol bit $y_{11}$,
the code bit $b_{10}$ to the symbol bit $y_{10}$, and
the code bit $b_{11}$ to the symbol bit $y_8$.

FIG. 110 illustrates code bit groups and symbol bit groups where the LDPC code is an LDPC code having a code length N of 64,800 bits and an encoding rate of 4/5 and besides the modulation method is 4096QAM and the multiple b is 1.

In this instance, $12 \times 1$ (= mb) code bits read out from the memory 31 can be grouped into five code bit groups $Gb_1$, $Gb_2$, $Gb_3$, $Gb_4$ and $Gb_5$ as seen in A of FIG. 110 in accordance with the difference in error probability.

In A of FIG. 110, to the code bit group $Gb_1$, the code bit $b_0$ belongs; to the code bit group $Gb_2$, the code bit $b_1$ belongs; to the code bit group $Gb_3$, the code bits $b_2$ to $b_8$ belong; to the code bit group $Gb_4$, the code bit $b_9$ belongs; and to the code bit group $Gb_5$, the code bits $b_{10}$ and $b_{11}$ belong.

Where the modulation method is 4096QAM and the multiple b is 1, the $12 \times 1$ (= mb) symbol bits can be grouped into six symbol bit groups $Gy_1$, $Gy_2$, $Gy_3$, $Gy_4$, $Gy_5$ and $Gy_6$ as seen in B of FIG. 110 in accordance with the difference in error probability.

In B of FIG. 110, as with the case in B of FIG. 95, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$

belong; to the symbol bit group $Gy_4$, the symbol bits $y_6$ and $y_7$ belong; to the symbol bit group $Gy_5$, the symbol bits $y_8$ and $y_9$ belong; and to the symbol bit group $Gy_6$, the symbol bits $y_{10}$ and $y_{10}$ belong.

FIG. 111 illustrates an allocation rule where the LDPC code is an LDPC code having a code length N of 64,800 bits and an encoding rate of 4/5 and besides the modulation method is 4096QAM and the multiple b is 1.

In the allocation rule of FIG. 111, group set information ($Gb_1$, $Gy_5$, 1), ($Gb_2$, $Gy_1$, 1), ($Gb_3$, $Gy_1$, 1), ($Gb_3$, $Gy_2$, 2), ($Gb_3$, $Gy_3$, 2), ($Gb_3$, $Gy_4$, 2), ($Gb_4$, $Gy_6$, 1), ($Gb_5$, $Gy_5$, 1) and ($Gb_5$, $Gy_6$, 1) is prescribed.

Accordingly, according to the allocation rule of FIG. 111, it is prescribed that,

depending upon the group set information ($Gb_1$, $Gy_5$, 1), one code bit of the code bit group $Gb_1$ which is best in error probability is allocated to one symbol bit of the symbol bit group $Gy_5$ which is fifth best in error probability, that

depending upon the group set information ($Gb_2$, $Gy_1$, 1), one code bit of the code bit group $Gb_2$ which is second best in error probability is allocated to one symbol bit of the symbol bit group $Gy_1$ which is best in error probability, that

depending upon the group set information ($Gb_3$, $Gy_1$, 1), one code bit of the code bit group $Gb_3$ which is third best in error probability are allocated to one symbol bit of the symbol bit group $Gy_1$ which is best in error probability, that

depending upon the group set information ($Gb_3$, $Gy_2$, 2), two code bits of the code bit group $Gb_3$ which is third best in error probability is allocated to two symbol bits of the symbol bit group $Gy_2$ which is second best in error probability, that

depending upon the group set information ($Gb_3$, $Gy_3$, 2), two code bits of the code bit group $Gb_3$ which is third best in error probability is allocated to two symbol bits of the symbol bit group $Gy_3$ which is third best in error probability, that

depending upon the group set information ($Gb_3$, $Gy_4$, 2), two code bits of the code bit group $Gb_3$ which is third best in error probability is allocated to two symbol bits of the symbol bit group $Gy_4$ which is fourth best in error probability, that

depending upon the group set information ($Gb_4$, $Gy_6$, 1), one code bit of the code bit group $Gb_4$ which is fourth best in error probability is allocated to one symbol bit of the symbol bit group $Gy_6$ which is sixth best in error probability, that

depending upon the group set information ($Gb_5$, $Gy_5$, 1), one code bit of the code bit group $Gb_5$ which is fifth best in error probability is allocated to one symbol bit of the symbol bit group $Gy_5$ which is fifth best in error probability, and that

depending upon the group set information ($Gb_5$, $Gy_6$, 1), one code bit of the code bit group $Gb_5$ which is fifth best in error probability is allocated to one symbol bit of the symbol bit group $Gy_6$ which is sixth best in error probability.

FIG. 112 illustrates an example of replacement of code bits in accordance with the allocation rule of FIG. 111.

In particular, A of FIG. 112 illustrates a first example of replacement of code bits in accordance with the allocation rule of FIG. 111 where the LDPC code is an LDPC code having a code length N of 64,800 bits and an encoding rate of 4/5 and besides the modulation method is 4096QAM and the multiple b is 1.

Where the LDPC code is an LDPC code having a code length N of 64,800 bits and an encoding rate of 4/5 and besides the modulation method is 4096QAM and the multiple b is 1, in the demultiplexer 25, code bits written in the memory 31 for $(64,800/(12 \times 1)) \times (12 \times 1)$ bits in the column direction $\times$ row direction are read out in a unit of $12 \times 1$ (= mb) bits in the row direction and are supplied to the replacement section 32 (FIGS. 16 and 17).

The replacement section 32 replaces the $12 \times 1$ (= mb) code bits $b_0$ to $b_{11}$ read out from the memory 31 in accordance with the allocation rule of FIG. 111 such that the $12 \times 1$ (= mb) code bits $b_0$ to $b_{11}$ are allocated, for example, to the $12 \times 1$ (= mb) symbol bits $y_0$ to $y_{11}$ of one (= b) symbol as seen in A of FIG. 112.

In particular, the replacement section 32 carries out replacement for allocating

the code bit $b_0$ to the symbol bit $y_8$,
the code bit $b_1$ to the symbol bit $y_0$,
the code bit $b_2$ to the symbol bit $y_6$,
the code bit $b_3$ to the symbol bit $y_1$,
the code bit $b_4$ to the symbol bit $y_4$,
the code bit $b_5$ to the symbol bit $y_5$,
the code bit $b_6$ to the symbol bit $y_2$,
the code bit $b_7$ to the symbol bit $y_3$,
the code bit $b_8$ to the symbol bit $y_7$,
the code bit $b_9$ to the symbol bit $y_{10}$.
the code bit $b_{10}$ to the symbol bit $y_{11}$, and
the code bit $b_{11}$ to the symbol bit $y_9$.

B of FIG. 112 illustrates a second example of replacement of code bits in accordance with the allocation rule of FIG. 111 where the LDPC code is an LDPC code having a code length N of 64,800 bits and an encoding rate of 4/5 and besides the modulation method is 4096QAM and the multiple b is 1.

According to B of FIG. 112, the replacement section 32 carries out replacement for allocating the $12 \times 1$ (= mb) code bits $b_0$ to $b_{11}$ read out from the memory 31 in accordance with the allocation rule of FIG. 111 in such a manner as to allocate

the code bit $b_0$ to the symbol bit $y_9$,
the code bit $b_1$ to the symbol bit $y_1$,
the code bit $b_2$ to the symbol bit $y_3$,

the code bit $b_3$ to the symbol bit $y_4$,
the code bit $b_4$ to the symbol bit $y_5$,
the code bit $b_5$ to the symbol bit $y_0$,
the code bit $b_6$ to the symbol bit $y_2$,
the code bit $b_7$ to the symbol bit $y_7$,
the code bit $b_8$ to the symbol bit $y_6$,
the code bit $b_9$ to the symbol bit $y_{11}$,
the code bit $b_{10}$ to the symbol bit $y_{10}$, and
the code bit $b_{11}$ to the symbol bit $y_8$.

FIG. 113 illustrates code bit groups and symbol bit groups where the LDPC code is an LDPC code having a code length N of 16,200 bits and an encoding rate of 5/6 and besides the modulation method is 4096QAM and the multiple b is 1.

In this instance, 12 × 1 (= mb) code bits read out from the memory 31 can be grouped into four code bit groups $Gb_1$, $Gb_2$, $Gb_3$ and $Gb_4$ as seen in A of FIG. 113 in accordance with the difference in error probability.

In A of FIG. 113, to the code bit group $Gb_1$, the code bit $b_0$ belongs; to the code bit group $Gb_2$, the code bits $b_1$ to $b_8$ belong; to the code bit group $Gb_3$, the code bit $b_9$ belongs; and to the code bit group $Gb_4$, the code bits $b_{10}$ and $b_{11}$ belong.

Where the modulation method is 4096QAM and the multiple b is 1, the 12 × 1 (= mb) symbol bits can be grouped into six symbol bit groups $Gy_1$, $Gy_2$, $Gy_3$, $Gy_4$, $Gy_5$ and $Gy_6$ as seen in B of FIG. 113 in accordance with the difference in error probability.

In B of FIG. 113, as with the case in B of FIG. 95, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; to the symbol bit group $Gy_5$, the symbol bits $y_8$ and $y_5$ belong; and to the symbol bit group $Gy_6$, the symbol bits $y_{10}$ and $y_{11}$ belong.

FIG. 114 illustrates an allocation rule where the LDPC code is an LDPC code having a code length N of 16,200 bits and an encoding rate of 5/6 and besides the modulation method is 4096QAM and the multiple b is 1.

In the allocation rule of FIG. 114, group set information ($Gb_1$, $Gy_5$, 1), ($Gb_2$, $Gy_1$, 2), ($Gb_2$, $Gy_2$, 2), ($Gb_2$, $Gy_3$, 2), ($Gb_2$, $Gy_4$, 2), ($Gb_3$, $Gy_6$, 1), ($Gb_4$, $Gy_5$, 1) and ($Gb_4$, $Gy_6$, 1) is prescribed.

Accordingly, according to the allocation rule of FIG. 114, it is prescribed that,
depending upon the group set information ($Gb_1$, $Gy_5$, 1), one code bit of the code bit group $Gb_1$ which is best in error probability is allocated to one symbol bit of the symbol bit group $Gy_5$ which is fifth best in error probability, that
depending upon the group set information ($Gb_2$, $Gy_1$, 2), two code bits of the code bit group $Gb_2$ which is second best in error probability is allocated to two symbol bits of the symbol bit group $Gy_1$ which is best in error probability, that
depending upon the group set information ($Gb_2$, $Gy_2$, 2), two code bits of the code bit group $Gb_2$ which is second best in error probability are allocated to two symbol bits of the symbol bit group $Gy_2$ which is second best in error probability, that
depending upon the group set information ($Gb_2$, $Gy_3$, 2), two code bits of the code bit group $Gb_2$ which is second best in error probability is allocated to two symbol bits of the symbol bit group $Gy_3$ which is third best in error probability, that
depending upon the group set information ($Gb_2$, $Gy_4$, 2), two code bits of the code bit group $Gb_2$ which is second best in error probability is allocated to two symbol bits of the symbol bit group $Gy_4$ which is fourth best in error probability, that
depending upon the group set information ($Gb_3$, $Gy_6$, 1), one code bit of the code bit group $Gb_3$ which is third best in error probability is allocated to one symbol bit of the symbol bit group $Gy_6$ which is sixth best in error probability, that
depending upon the group set information ($Gb_4$, $Gy_5$, 1), one code bit of the code bit group $Gb_4$ which is fourth best in error probability is allocated to one symbol bit of the symbol bit group $Gy_5$ which is fifth best in error probability, and that
depending upon the group set information ($Gb_4$, $Gy_6$, 1), one code bit of the code bit group $Gb_4$ which is fourth best in error probability is allocated to one symbol bit of the symbol bit group $Gy_6$ which is sixth best in error probability.

FIG. 115 illustrates an example of replacement of code bits in accordance with the allocation rule of FIG. 114.

In particular, A of FIG. 115 illustrates a first example of replacement of code bits in accordance with the allocation rule of FIG. 114 where the LDPC code is an LDPC code having a code length N of 16,200 bits and an encoding rate of 5/6 and besides the modulation method is 4096QAM and the multiple b is 1.

Where the LDPC code is an LDPC code having a code length N of 16,200 bits and an encoding rate of 5/6 and besides the modulation method is 4096QAM and the multiple b is 1, in the demultiplexer 25, code bits written in the memory 31 for (16,200/(12 × 1)) × (12 × 1) bits in the column direction × row direction are read out in a unit of 12 × 1 (= mb) bits in the row direction and are supplied to the replacement section 32 (FIGS. 16 and 17).

The replacement section 32 replaces the 12 × 1 (= mb) code bits $b_0$ to $b_{11}$ read out from the memory 31 in accordance with the allocation rule of FIG. 114 such that the 12 × 1 (= mb) code bits $b_0$ to $b_{11}$ are allocated, for example, to the 12 × 1 (= mb) symbol bits $y_0$ to $y_{11}$ of one (= b) symbol as seen in A of FIG. 115.

In particular, the replacement section 32 carries out replacement for allocating
the code bit $b_0$ to the symbol bit $y_8$,

the code bit $b_1$ to the symbol bit $y_0$,
the code bit $b_2$ to the symbol bit $y_6$,
the code bit $b_3$ to the symbol bit $y_1$,
the code bit $b_4$ to the symbol bit $y_4$,
the code bit $b_5$ to the symbol bit $y_5$,
the code bit $b_6$ to the symbol bit $y_2$,
the code bit $b_7$ to the symbol bit $y_3$,
the code bit $b_8$ to the symbol bit $y_7$,
the code bit $b_9$ to the symbol bit $y_{10}$,
the code bit $b_{10}$ to the symbol bit $y_{11}$, and
the code bit $b_{11}$ to the symbol bit $y_9$.

B of FIG. 115 illustrates a second example of replacement of code bits in accordance with the allocation rule of FIG. 114 where the LDPC code is an LDPC code having a code length N of 16,200 bits and an encoding rate of 5/6 and besides the modulation method is 4096QAM and the multiple b is 1.

According to B of FIG. 115, the replacement section 32 carries out replacement for allocating the 12 $\times$ 1 (= mb) code bits $b_0$ to $b_{11}$ read out from the memory 31 in accordance with the allocation rule of FIG. 114 in such a manner as to allocate
the code bit $b_0$ to the symbol bit $y_9$,
the code bit $b_1$ to the symbol bit $y_1$,
the code bit $b_2$ to the symbol bit $y_3$,
the code bit $b_3$ to the symbol bit $y_4$,
the code bit $b_4$ to the symbol bit $y_5$,
the code bit $b_5$ to the symbol bit $y_0$,
the code bit $b_6$ to the symbol bit $y_2$, the code bit $b_7$ to the symbol bit $y_7$,
the code bit $b_8$ to the symbol bit $y_6$,
the code bit $b_9$ to the symbol bit $y_{11}$,
the code bit $b_{10}$ to the symbol bit $y_{10}$, and
the code bit $b_{11}$ to the symbol bit $y_8$.

FIG. 116 illustrates code bit groups and symbol bit groups where the LDPC code is an LDPC code having a code length N of 64,800 bits and an encoding rate of 5/6 and besides the modulation method is 4096QAM and the multiple b is 1.

In this instance, 12 $\times$ 1 (= mb) code bits read out from the memory 31 can be grouped into three code bit groups $Gb_1$, $Gb_2$ and $Gb_3$ as seen in A of FIG. 116 in accordance with the difference in error probability.

In A of FIG. 116, to the code bit group $Gb_1$, the code bit $b_0$ belongs; to the code bit group $Gb_2$, the code bits $b_1$ to $b_9$ belong; and to the code bit group $Gb_3$, the code bits $b_{10}$ and $b_{11}$ belong.

Where the modulation method is 4096QAM and the multiple b is 1, the 12 $\times$ 1 (= mb) symbol bits can be grouped into six symbol bit groups $Gy_1$, $Gy_2$, $Gy_3$, $Gy_4$, $Gy_5$ and $Gy_6$ as seen in B of FIG. 116 in accordance with the difference in error probability.

In B of FIG. 116, as with the case in B of FIG. 95, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; to the symbol bit group $Gy_5$, the symbol bits $y_8$ and $y_9$ belong; and to the symbol bit group $Gy_6$, the symbol bits $y_{10}$ and $y_{11}$ belong.

FIG. 117 illustrates an allocation rule where the LDPC code is an LDPC code having a code length N of 64,800 bits and an encoding rate of 5/6 and besides the modulation method is 4096QAM and the multiple b is 1.

In the allocation rule of FIG. 117, group set information ($Gb_1$, $Gy_5$, 1), ($Gb_2$, $Gy_1$, 2), ($Gb_2$, $Gy_2$, 2), ($Gb_2$, $Gy_3$, 2), ($Gb_2$, $Gy_4$, 2), ($Gb_2$, $Gy_6$, 1), ($Gb_3$, $Gy_5$, 1) and ($Gb_3$, $Gy_6$, 1) is prescribed.

Accordingly, according to the allocation rule of FIG. 117, it is prescribed that,
depending upon the group set information ($Gb_1$, $Gy_5$, 1), one code bit of the code bit group $Gb_1$ which is best in error probability is allocated to one symbol bit of the symbol bit group $Gy_5$ which is fifth best in error probability, that
depending upon the group set information ($Gb_2$, $Gy_1$, 2), two code bits of the code bit group $Gb_2$ which is second best in error probability is allocated to two symbol bits of the symbol bit group $Gy_1$ which is best in error probability, that
depending upon the group set information ($Gb_2$, $Gy_2$, 2), two code bits of the code bit group $Gb_2$ which is second best in error probability are allocated to two symbol bits of the symbol bit group $Gy_2$ which is second best in error probability, that
depending upon the group set information ($Gb_2$, $Gy_3$, 2), two code bits of the code bit group $Gb_2$ which is second best in error probability is allocated to two symbol bits of the symbol bit group $Gy_3$ which is third best in error probability, that
depending upon the group set information ($Gb_2$, $Gy_4$, 2), two code bits of the code bit group $Gb_2$ which is second best in error probability is allocated to two symbol bits of the symbol bit group $Gy_4$ which is fourth best in error probability, that
depending upon the group set information ($Gb_2$, $Gy_6$, 1), one code bit of the code bit group $Gb_2$ which is second best in error probability is allocated to one symbol bit of the symbol bit group $Gy_6$ which is sixth best in error probability, that depending upon the group set information ($Gb_3$, $Gy_5$, 1), one code bit of the code bit group $Gb_3$ which is third best in error probability is allocated to one symbol bit of the symbol bit group $Gy_5$ which is fifth best in error probability, and that depending upon the group set information ($Gb_3$, $Gy_6$, 1), one code bit of the code bit group $Gb_3$ which is third best in error probability is allocated to one symbol bit of the symbol bit group $Gy_6$ which is sixth best in error probability.

FIG. 118 illustrates an example of replacement of code bits in accordance with the allocation rule of FIG. 117.

In particular, A of FIG. 118 illustrates a first example of replacement of code bits in accordance with the allocation rule of FIG. 117 where the LDPC code is an LDPC code having a code length N of 64,800 bits and an encoding rate of 5/6 and besides the modulation method is 4096QAM and the multiple b is 1.

Where the LDPC code is an LDPC code having a code length N of 64,800 bits and an encoding rate of 5/6 and besides the modulation method is 4096QAM and the multiple b is 1, in the demultiplexer 25, code bits written in the memory 31 for $(64,800/(12 \times 1)) \times (12 \times 1)$ bits in the column direction × row direction are read out in a unit of $12 \times 1$ (= mb) bits in the row direction and are supplied to the replacement section 32 (FIGS. 16 and 17).

The replacement section 32 replaces the $12 \times 1$ (= mb) code bits $b_0$ to $b_{11}$ read out from the memory 31 in accordance with the allocation rule of FIG. 117 such that the $12 \times 1$ (= mb) code bits $b_0$ to $b_{11}$ are allocated, for example, to the $12 \times 1$ (= mb) symbol bits $y_0$ to $y_{11}$ of one (= b) symbol as seen in A of FIG. 118.

In particular, the replacement section 32 carries out replacement for allocating
the code bit $b_0$ to the symbol bit $y_8$,
the code bit $b_1$ to the symbol bit $y_0$,
the code bit $b_2$ to the symbol bit $y_6$,
the code bit $b_3$ to the symbol bit $y_1$,
the code bit $b_4$ to the symbol bit $y_4$,
the code bit $b_5$ to the symbol bit $y_5$,
the code bit $b_6$ to the symbol bit $y_2$, the code bit $b_7$ to the symbol bit $y_3$,
the code bit $b_8$ to the symbol bit $y_7$,
the code bit $b_9$ to the symbol bit $y_{10}$,
the code bit $b_{10}$ to the symbol bit $y_{11}$, and
the code bit $b_{11}$ to the symbol bit $y_9$.

B of FIG. 118 illustrates a second example of replacement of code bits in accordance with the allocation rule of FIG. 117 where the LDPC code is an LDPC code having a code length N of 64,800 bits and an encoding rate of 5/6 and besides the modulation method is 4096QAM and the multiple b is 1.

According to B of FIG. 118, the replacement section 32 carries out replacement for allocating the $12 \times 1$ (= mb) code bits $b_0$ to $b_{11}$ read out from the memory 31 in accordance with the allocation rule of FIG. 117 in such a manner as to allocate
the code bit $b_0$ to the symbol bit $y_9$,
the code bit $b_1$ to the symbol bit $y_1$,
the code bit $b_2$ to the symbol bit $y_3$,
the code bit $b_3$ to the symbol bit $y_4$,
the code bit $b_4$ to the symbol bit $y_5$,
the code bit $b_5$ to the symbol bit $y_0$,
the code bit $b_6$ to the symbol bit $y_2$,
the code bit $b_7$ to the symbol bit $y_7$,
the code bit $b_8$ to the symbol bit $y_{11}$,
the code bit $b_3$ to the symbol bit $y_6$,
the code bit $b_{10}$ to the symbol bit $y_{10}$, and
the code bit $b_{11}$ to the symbol bit $y_8$.

FIG. 119 illustrates code bit groups and symbol bit groups where the LDPC code is an LDPC code having a code length N of 16,200 bits and an encoding rate of 8/9 and besides the modulation method is 4096QAM and the multiple b is 1.

In this instance, $12 \times 1$ (= mb) code bits read out from the memory 31 can be grouped into five code bit groups $Gb_1$, $Gb_2$, $Gb_3$, $Gb_4$ and $Gb_5$ as seen in A of FIG. 119 in accordance with the difference in error probability.

In A of FIG. 119, to the code bit group $Gb_1$, the code bit $b_0$ belongs; to the code bit group $Gb_2$, the code bit $b_1$ belongs; to the code bit group $Gb_3$, the code bits $b_2$ to $b_9$ belong; to the code bit group $Gb_4$, the code bit $b_{10}$ belongs; and to the code bit group $Gb_5$, the code bit $b_{11}$ belongs.

Where the modulation method is 4096QAM and the multiple b is 1, the $12 \times 1$ (= mb) symbol bits can be grouped into six symbol bit groups $Gy_1$, $Gy_2$, $Gy_3$, $Gy_4$, $Gy_5$ and $Gy_6$ as seen in B of FIG. 119 in accordance with the difference in error probability.

In B of FIG. 119, as with the case in B of FIG. 95, to the symbol bit group $Gy_1$, the symbol bits $y_0$ and $y_1$ belong;

to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; to the symbol bit group $Gy_5$, the symbol bits $y_8$ and $y_9$ belong; and to the symbol bit group $Gy_6$, the symbol bits $y_{10}$ and $y_{11}$ belong.

FIG. 120 illustrates an allocation rule where the LDPC code is an LDPC code having a code length N of 16,200 bits and an encoding rate of 8/9 and besides the modulation method is 4096QAM and the multiple b is 1.

In the allocation rule of FIG. 120, group set information ($Gb_1$, $Gy_6$, 1), ($Gb_2$, $Gy_1$, 1), ($Gb_3$, $Gy_1$, 1), ($Gb_3$, $Gy_2$, 2), ($Gb_3$, $Gy_3$, 2), ($Gb_3$, $Gy_4$, 2), ($Gb_3$, $Gy_5$, 1), ($Gb_4$, $Gy_6$, 1) and ($Gb_5$, $Gy_5$, 1) is prescribed.

Accordingly, according to the allocation rule of FIG. 120, it is prescribed that, depending upon the group set information ($Gb_1$, $Gy_6$, 1), one code bit of the code bit group $Gb_1$ which is best in error probability is allocated to one symbol bit of the symbol bit group $Gy_6$ which is sixth best in error probability, that
depending upon the group set information ($Gb_2$, $Gy_1$, 1), one code bit of the code bit group $Gb_2$ which is second best in error probability is allocated to one symbol bit of the symbol bit group $Gy_1$ which is best in error probability, that
depending upon the group set information ($Gb_3$, $Gy_1$, 1), one code bit of the code bit group $Gb_3$ which is third best in error probability are allocated to one symbol bit of the symbol bit group $Gy_1$ which is best in error probability, that
depending upon the group set information ($Gb_3$, $Gy_2$, 2), two code bits of the code bit group $Gb_3$ which is third best in error probability is allocated to two symbol bits of the symbol bit group $Gy_2$ which is second best in error probability, that
depending upon the group set information ($Gb_3$, $Gy_3$, 2), two code bits of the code bit group $Gb_3$ which is third best in error probability is allocated to two symbol bits of the symbol bit group $Gy_3$ which is third best in error probability, that
depending upon the group set information ($Gb_3$, $Gy_4$, 2), two code bits of the code bit group $Gb_3$ which is third best in error probability is allocated to two symbol bits of the symbol bit group $Gy_4$ which is fourth best in error probability, that
depending upon the group set information ($Gb_3$, $Gy_5$, 1), one code bit of the code bit group $Gb_3$ which is third best in error probability is allocated to one symbol bit of the symbol bit group $Gy_5$ which is fifth best in error probability, that
depending upon the group set information ($Gb_4$, $Gy_6$, 1), one code bit of the code bit group $Gb_4$ which is fourth best in error probability is allocated to one symbol bit of the symbol bit group $Gy_6$ which is sixth best in error probability, and that
depending upon the group set information ($Gb_5$, $Gy_5$, 1), one code bit of the code bit group $Gb_5$ which is fifth best in error probability is allocated to one symbol bit of the symbol bit group $Gy_5$ which is fifth best in error probability.

FIG. 121 illustrates an example of replacement of code bits in accordance with the allocation rule of FIG. 120.

In particular, A of FIG. 121 illustrates a first example of replacement of code bits in accordance with the allocation rule of FIG. 120 where the LDPC code is an LDPC code having a code length N of 16,200 bits and an encoding rate of 8/9 and besides the modulation method is 4096QAM and the multiple b is 1.

Where the LDPC code is an LDPC code having a code length N of 16,200 bits and an encoding rate of 8/9 and besides the modulation method is 4096QAM and the multiple b is 1, in the demultiplexer 25, code bits written in the memory 31 for $(16{,}200/(12 \times 1)) \times (12 \times 1)$ bits in the column direction $\times$ row direction are read out in a unit of $12 \times 1$ (= mb) bits in the row direction and are supplied to the replacement section 32 (FIGS. 16 and 17).

The replacement section 32 replaces the $12 \times 1$ (= mb) code bits $b_0$ to $b_{11}$ read out from the memory 31 in accordance with the allocation rule of FIG. 120 such that the $12 \times 1$ (= mb) code bits $b_0$ to $b_{11}$ are allocated, for example, to the $12 \times 1$ (= mb) symbol bits $y_0$ to $y_{11}$ of one (= b) symbol as seen in A of FIG. 121.

In particular, the replacement section 32 carries out replacement for allocating
the code bit $b_0$ to the symbol bit $y_{10}$,
the code bit $b_1$ to the symbol bit $y_0$,
the code bit $b_2$ to the symbol bit $b_1$,
the code bit $b_3$ to the symbol bit $y_2$,
the code bit $b_4$ to the symbol bit $y_3$,
the code bit $b_5$ to the symbol bit $y_9$,
the code bit $b_6$ to the symbol bit $y_5$, the code bit $b_7$ to the symbol bit $y_6$,
the code bit $b_8$ to the symbol bit $y_8$,
the code bit $b_9$ to the symbol bit $y_7$,
the code bit $b_{10}$ to the symbol bit $y_{11}$, and
the code bit $b_{11}$ to the symbol bit $y_9$.

B of FIG. 121 illustrates a second example of replacement of code bits in accordance with the allocation rule of FIG. 120 where the LDPC code is an LDPC code having a code length N of 16,200 bits and an encoding rate of 8/9 and besides the modulation method is 4096QAM and the multiple b is 1.

According to B of FIG. 121, the replacement section 32 carries out replacement for allocating the $12 \times 1$ (= mb) code bits $b_0$ to $b_{11}$ read out from the memory 31 in accordance with the allocation rule of FIG. 120 in such a manner as to allocate
the code bit $b_0$ to the symbol bit $y_{11}$,
the code bit $b_1$ to the symbol bit $y_1$,
the code bit $b_2$ to the symbol bit $y_3$,

the code bit $b_3$ to the symbol bit $y_4$,
the code bit $b_4$ to the symbol bit $y_5$,
the code bit $b_5$ to the symbol bit $y_0$,
the code bit $b_6$ to the symbol bit $y_2$,
the code bit $b_7$ to the symbol bit $y_7$,
the code bit $b_8$ to the symbol bit $y_9$,
the code bit $b_9$ to the symbol bit $y_6$,
the code bit $b_{10}$ to the symbol bit $y_{10}$, and
the code bit $b_{11}$ to the symbol bit $y_8$.

FIG. 122 illustrates code bit groups and symbol bit groups where the LDPC code is an LDPC code having a code length N of 64,800 bits and an encoding rate of 8/9 and besides the modulation method is 4096QAM and the multiple b is 1.

In this instance, 12 × 1 (= mb) code bits read out from the memory 31 can be grouped into five code bit groups $Gb_1$, $Gb_2$, $Gb_3$, $Gb_4$ and $Gb_5$ as seen in A of FIG. 122 in accordance with the difference in error probability.

In A of FIG. 122, to the code bit group $Gb_1$, the code bit $b_0$ belongs; to the code bit group $Gb_2$, the code bit $b_1$ belongs; to the code bit group $Gb_3$, the code bits $b_2$ to $b_9$ belong; to the code bit group $Gb_4$, the code bit $b_{10}$ belongs; and to the code bit group $Gb_5$, the code bit $b_{11}$ belongs.

Where the modulation method is 4096QAM and the multiple b is 1, the 12 × 1 (= mb) symbol bits can be grouped into six symbol bit groups $Gy_1$, $Gy_2$, $Gy_3$, $Gy_4$, $Gy_5$ and $Gy_6$ as seen in B of FIG. 122 in accordance with the difference in error probability.

In B of FIG. 122, as with the case in B of FIG. 95, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; to the symbol bit group $Gy_5$, the symbol bits $y_8$ and $y_9$ belong; and to the symbol bit group $Gy_6$, the symbol bits $y_{10}$ and $y_{11}$ belong.

FIG. 123 illustrates an allocation rule where the LDPC code is an LDPC code having a code length N of 64,800 bits and an encoding rate of 8/9 and besides the modulation method is 4096QAM and the multiple b is 1.

In the allocation rule of FIG. 123, group set information ($Gb_1$, $Gy_6$, 1), ($Gb_2$, $Gy_1$, 1), ($Gb_3$, $Gy_1$, 1), ($Gb_3$, $Gy_2$, 2), ($Gb_3$, $Gy_3$, 2), ($Gb_3$, $Gy_4$, 2), ($Gb_3$, $Gy_5$, 1), ($Gb_4$, $Gy_6$, 1) and ($Gb_5$, $Gy_5$, 1) is prescribed.

Accordingly, according to the allocation rule of FIG. 123, it is prescribed that,
depending upon the group set information ($Gb_1$, $Gy_6$, 1), one code bit of the code bit group $Gb_1$ which is best in error probability is allocated to one symbol bit of the symbol bit group $Gy_6$ which is sixth best in error probability, that
depending upon the group set information ($Gb_2$, $Gy_1$, 1), one code bit of the code bit group $Gb_2$ which is second best in error probability is allocated to one symbol bit of the symbol bit group $Gy_1$ which is best in error probability, that
depending upon the group set information ($Gb_3$, $Gy_1$, 1), one code bit of the code bit group $Gb_3$ which is third best in error probability are allocated to one symbol bit of the symbol bit group $Gy_1$ which is best in error probability, that
depending upon the group set information ($Gb_3$, $Gy_2$, 2), two code bits of the code bit group $Gb_3$ which is third best in error probability is allocated to two symbol bits of the symbol bit group $Gy_2$ which is second best in error probability, that
depending upon the group set information ($Gb_3$, $Gy_3$, 2), two code bits of the code bit group $Gb_3$ which is third best in error probability is allocated to two symbol bits of the symbol bit group $Gy_3$ which is third best in error probability, that
depending upon the group set information ($Gb_3$, $Gy_4$, 2), two code bits of the code bit group $Gb_3$ which is third best in error probability is allocated to two symbol bits of the symbol bit group $Gy_4$ which is fourth best in error probability, that
depending upon the group set information ($Gb_3$, $Gy_5$, 1), one code bit of the code bit group $Gb_3$ which is third best in error probability is allocated to one symbol bit of the symbol bit group $Gy_5$ which is fifth best in error probability, that
depending upon the group set information ($Gb_4$, $Gy_6$, 1), one code bit of the code bit group $Gb_4$ which is fourth best in error probability is allocated to one symbol bit of the symbol bit group $Gy_6$ which is sixth best in error probability, and that
depending upon the group set information ($Gb_5$, $Gy_5$, 1), one code bit of the code bit group $Gb_5$ which is fifth best in error probability is allocated to one symbol bit of the symbol bit group $Gy_5$ which is fifth best in error probability.

FIG. 124 illustrates an example of replacement of code bits in accordance with the allocation rule of FIG. 123.

In particular, A of FIG. 124 illustrates a first example of replacement of code bits in accordance with the allocation rule of FIG. 123 where the LDPC code is an LDPC code having a code length N of 64,800 bits and an encoding rate of 8/9 and besides the modulation method is 4096QAM and the multiple b is 1.

Where the LDPC code is an LDPC code having a code length N of 64,800 bits and an encoding rate of 8/9 and besides the modulation method is 4096QAM and the multiple b is 1, in the demultiplexer 25, code bits written in the memory 31 for (64,800/(12 × 1)) × (12 × 1) bits in the column direction × row direction are read out in a unit of 12 × 1 (= mb) bits in the row direction and are supplied to the replacement section 32 (FIGS. 16 and 17).

The replacement section 32 replaces the 12 × 1 (= mb) code bits $b_0$ to $b_{11}$ read out from the memory 31 in accordance with the allocation rule of FIG. 123 such that the 12 × 1 (= mb) code bits $b_0$ to $b_{11}$ are allocated, for example, to the 12 × 1 (= mb) symbol bits $y_0$ to $y_{11}$ of one (= b) symbol as seen in A of FIG. 124.

In particular, the replacement section 32 carries out replacement for allocating
the code bit $b_0$ to the symbol bit $y_{10}$,
the code bit $b_1$ to the symbol bit $y_0$,
the code bit $b_2$ to the symbol bit $y_1$,
the code bit $b_3$ to the symbol bit $y_2$,
the code bit $b_4$ to the symbol bit $y_3$,
the code bit $b_5$ to the symbol bit $y_4$,
the code bit $b_6$ to the symbol bit $y_5$,
the code bit $b_7$ to the symbol bit $y_6$,
the code bit $b_8$ to the symbol bit $y_8$,
the code bit $b_9$ to the symbol bit $y_7$,
the code bit $b_{10}$ to the symbol bit $y_{11}$, and
the code bit $b_{11}$ to the symbol bit $y_9$.

B of FIG. 124 illustrates a second example of replacement of code bits in accordance with the allocation rule of FIG. 123 where the LDPC code is an LDPC code having a code length N of 64,800 bits and an encoding rate of 8/9 and besides the modulation method is 4096QAM and the multiple b is 1.

According to B of FIG. 124, the replacement section 32 carries out replacement for allocating the 12 × 1 (= mb) code bits $b_0$ to $b_{11}$ read out from the memory 31 in accordance with the allocation rule of FIG. 123 in such a manner as to allocate
the code bit $b_0$ to the symbol bit $y_{11}$,
the code bit $b_1$ to the symbol bit $y_1$,
the code bit $b_2$ to the symbol bit $y_3$,
the code bit $b_3$ to the symbol bit $y_4$,
the code bit $b_4$ to the symbol bit $y_5$,
the code bit $b_5$ to the symbol bit $y_0$,
the code bit $b_6$ to the symbol bit $y_2$,
the code bit $b_7$ to the symbol bit $y_7$,
the code bit $b_8$ to the symbol bit $y_9$,
the code bit $b_9$ to the symbol bit $y_6$,
the code bit $b_{10}$ to the symbol bit $y_{10}$, and
the code bit $b_{11}$ to the symbol bit $y_8$.

FIG. 125 illustrates code bit groups and symbol bit groups where the LDPC code is an LDPC code having a code length N of 64,800 bits and an encoding rate of 9/10 and besides the modulation method is 4096QAM and the multiple b is 1.

In this instance, 12 × 1 (= mb) code bits read out from the memory 31 can be grouped into five code bit groups $Gb_1$, $Gb_2$, $Gb_3$, $Gb_4$ and $Gb_5$ as seen in A of FIG. 125 in accordance with the difference in error probability.

In A of FIG. 125, to the code bit group $Gb_1$, the code bit $b_0$ belongs; to the code bit group $Gb_2$, the code bit $b_1$ belongs; to the code bit group $Gb_3$, the code bits $b_2$ to $b_9$ belong; to the code bit group $Gb_4$, the code bit $b_{10}$ belongs; and to the code bit group $Gb_5$, the code bit $b_{11}$ belongs.

Where the modulation method is 4096QAM and the multiple b is 1, the 12 × 1 (= mb) symbol bits can be grouped into six symbol bit groups $Gy_1$, $Gy_2$, $Gy_3$, $Gy_4$, $Gy_5$ and $Gy_6$ as seen in B of FIG. 125 in accordance with the difference in error probability.

In B of FIG. 125, as with the case in B of FIG. 95, to the symbol bit group $Gy_1$, the symbol bits $y_0$ and $y_1$ belong; to the symbol bit group $Gy_2$, the symbol bits $y_2$ and $y_3$ belong; to the symbol bit group $Gy_3$, the symbol bits $y_4$ and $y_5$ belong; to the symbol bit group $Gy_4$, the symbol bits $y_6$ and $y_7$ belong; to the symbol bit group $Gy_5$, the symbol bits $y_8$ and $y_9$ belong; and to the symbol bit group $Gy_6$, the symbol bits $y_{10}$ and $y_{11}$, belong.

FIG. 126 illustrates an allocation rule where the LDPC code is an LDPC code having a code length N of 64,800 bits and an encoding rate of 9/10 and besides the modulation method is 4096QAM and the multiple b is 1.

In the allocation rule of FIG. 126, group set information ($Gb_1$, $Gy_6$, 1), ($Gb_2$, $Gy_1$, 1), ($Gb_3$, $Gy_1$, 1), ($Gb_3$, $Gy_2$, 2), ($Gb_3$, $Gy_3$, 2), ($Gb_3$, $Gy_4$, 2), ($Gb_3$, $Gy_5$, 1), ($Gb_4$, $Gy_6$, 1) and ($Gb_5$, $Gy_5$, 1) is prescribed.

Accordingly, according to the allocation rule of FIG. 126, it is prescribed that,
depending upon the group set information ($Gb_1$, $Gy_6$, 1), one code bit of the code bit group $Gb_1$ which is best in error probability is allocated to one symbol bit of the symbol bit group $Gy_6$ which is sixth best in error probability, that
depending upon the group set information ($Gb_2$, $Gy_1$, 1), one code bit of the code bit group $Gb_2$ which is second best in error probability is allocated to one symbol bit of the symbol bit group $Gy_1$ which is best in error probability, that
depending upon the group set information ($Gb_3$, $Gy_1$, 1), one code bit of the code bit group $Gb_3$ which is third best in error probability are allocated to one symbol bit of the symbol bit group $Gy_1$ which is best in error probability, that
depending upon the group set information ($Gb_3$, $Gy_2$, 2), two code bits of the code bit group $Gb_3$ which is third best in error probability is allocated to two symbol bits of the symbol bit group $Gy_2$ which is second best in error probability, that depending upon the group set information ($Gb_3$, $Gy_3$, 2), two code bits of the code bit group $Gb_3$ which is third best in error probability is allocated to two symbol bits of the symbol bit group $Gy_3$ which is third best in error probability, that depending upon the group set information ($Gb_3$, $Gy_4$, 2), two code bits of the code bit group $Gb_3$ which is third best in error probability is allocated to two symbol bits of the symbol bit group $Gy_4$ which is fourth best in error probability, that depending upon the group set information ($Gb_3$, $Gy_5$, 1), one code bit of the code bit group $Gb_3$ which is third best in error probability is allocated to one symbol bit of the symbol bit group $Gy_5$ which is fifth best in error probability, that depending upon the group set information ($Gb_4$, $Gy_6$, 1), one code bit of the code bit group $Gb_4$ which is fourth best in error probability is allocated to one symbol bit of the symbol bit group $Gy_6$ which is sixth best in error probability, and that depending upon the group set information ($Gb_5$, $Gy_5$, 1), one code bit of the code bit group $Gb_5$ which is fifth best in error probability is allocated to one symbol bit of the symbol bit group $Gy_5$ which is fifth best in error probability.

FIG. 127 illustrates an example of replacement of code bits in accordance with the allocation rule of FIG. 126.

In particular, A of FIG. 127 illustrates a first example of replacement of code bits in accordance with the allocation rule of FIG. 126 where the LDPC code is an LDPC code having a code length N of 64,800 bits and an encoding rate of 9/10 and besides the modulation method is 4096QAM and the multiple b is 1.

Where the LDPC code is an LDPC code having a code length N of 64,800 bits and an encoding rate of 9/10 and besides the modulation method is 4096QAM and the multiple b is 1, in the demultiplexer 25, code bits written in the memory 31 for (64,800/(12 1)) $\times$ (12 $\times$ 1) bits in the column direction $\times$ row direction are read out in a unit of 12 $\times$ 1 (= mb) bits in the row direction and are supplied to the replacement section 32 (FIGS. 16 and 17).

The replacement section 32 replaces the 12 $\times$ 1 (= mb) code bits $b_0$ to $b_{11}$ read out from the memory 31 in accordance with the allocation rule of FIG. 126 such that the 12 $\times$ 1 (= mb) code bits $b_0$ to $b_{11}$ are allocated, for example, to the 12 $\times$ 1 (= mb) symbol bits $y_0$ to $y_{11}$ of one (= b) symbol as seen in A of FIG. 127.

In particular, the replacement section 32 carries out replacement for allocating
the code bit $b_0$ to the symbol bit $y_{10}$,
the code bit $b_1$ to the symbol bit $y_0$,
the code bit $b_2$ to the symbol bit $y_1$,
the code bit $b_3$ to the symbol bit $y_2$,
the code bit $b_4$ to the symbol bit $y_3$,
the code bit $b_5$ to the symbol bit $y_4$,
the code bit $b_6$ to the symbol bit $y_5$,
the code bit $b_7$ to the symbol bit $y_6$,
the code bit $b_8$ to the symbol bit $y_8$,
the code bit $b_9$ to the symbol bit $y_7$,
the code bit $b_{10}$ to the symbol bit $y_{11}$, and
the code bit $b_{11}$ to the symbol bit $y_9$.

B of FIG. 127 illustrates a second example of replacement of code bits in accordance with the allocation rule of FIG. 126 where the LDPC code is an LDPC code having a code length N of 64,800 bits and an encoding rate of 9/10 and besides the modulation method is 4096QAM and the multiple b is 1.

According to B of FIG. 127, the replacement section 32 carries out replacement for allocating the 12 $\times$ 1 (= mb) code bits $b_0$ to $b_{11}$ read out from the memory 31 in accordance with the allocation rule of FIG. 126 in such a manner as to allocate
the code bit $b_0$ to the symbol bit $y_{11}$,
the code bit $b_1$ to the symbol bit $y_1$,
the code bit $b_2$ to the symbol bit $y_3$,
the code bit $b_3$ to the symbol bit $y_9$,
the code bit $b_4$ to the symbol bit $y_5$,
the code bit $b_5$ to the symbol bit $y_0$,
the code bit $b_6$ to the symbol bit $y_2$,
the code bit $b_7$ to the symbol bit $y_7$,
the code bit $b_8$ to the symbol bit $y_9$,
the code bit $b_9$ to the symbol bit $y_6$,
the code bit $b_{10}$ to the symbol bit $y_{10}$, and
the code bit $b_{11}$ to the symbol bit $y_8$.

While totaling 22 different replacement processes including 12 different replacement processes where six different LDPC codes having a code length N of 64,800 bits and different encoding rates of 2/3, 3/4, 4/5, 5/6, 8/9 and 9/10 are modulated by two different modulation methods of 1024QAM and 4096QAM and 10 different replacement processes where five different LDPC codes having a code length N of 16,200 bits and different encoding rates of 2/3, 3/4, 4/5, 5/6 and 8/9 are modulated by two different modulation methods of 1024QAM and 4096QAM are described as the replacement processes of the new replacement method, the 22 different replacement processes can be carried out, by adopting, for example, four different replacement methods as a replacement method for replacing code bits, by one of the four different replacement methods.

In particular, where an LDPC code having a code length N of 64,800 or 16,200 bits and an encoding rate of 3/4, 4/5 or 5/6 is modulated by 1024QAM, the replacement process can be carried out by a replacement method, for example, illustrated in A of FIG. 70, of allocating
the code bit $b_0$ to the symbol bit $y_6$,
the code bit $b_1$ to the symbol bit $y_4$,
the code bit $b_2$ to the symbol bit $y_8$,
the code bit $b_3$ to the symbol bit $y_5$,
the code bit $b_4$ to the symbol bit $y_0$,
the code bit $b_5$ to the symbol bit $y_2$,
the code bit $b_6$ to the symbol bit $y_1$,
the code bit $b_7$ to the symbol bit $y_3$,
the code bit $b_8$ to the symbol bit $y_9$, and
the code bit $b_9$ to the symbol bit $y_7$.

In addition, where an LDPC code having a code length N of 64,800 or 16,200 bits and an encoding rate of 3/4, 4/5 or 5/6 is modulated by 4096QAM, the replacement process can be carried out by a replacement method, for example, illustrated in A of FIG. 103, of allocating
the code bit $b_0$ to the symbol bit $y_8$,
the code bit $b_1$ to the symbol bit $y_0$,
the code bit $b_2$ to the symbol bit $y_6$,
the code bit $b_3$ to the symbol bit $y_1$,
the code bit $b_4$ to the symbol bit $y_4$,
the code bit $b_5$ to the symbol bit $y_5$,
the code bit $b_6$ to the symbol bit $y_2$,
the code bit $b_7$ to the symbol bit $y_3$,
the code bit $b_8$ to the symbol bit $y_7$,
the code bit $b_9$ to the symbol bit $y_{10}$,
the code bit $b_{10}$ to the symbol bit $y_{11}$, and
the code bit $b_{11}$ to the symbol bit $y_9$.

Further, where an LDPC code having a code length N of 64,800 or 16,200 bits and an encoding rate of 2/3 or 8/9 and an LDPC code having a code length N of 64,800 bits and an encoding rate of 9/10 is modulated by 1024QAM, the replacement process can be carried out by a replacement method, for example, illustrated in A of FIG. 64, of allocating
the code bit $b_0$ to the symbol bit $y_8$,
the code bit $b_1$ to the symbol bit $y_0$,
the code bit $b_2$ to the symbol bit $b_1$,
the code bit $b_3$ to the symbol bit $y_2$,
the code bit $b_4$ to the symbol bit $y_3$,
the code bit $b_5$ to the symbol bit $y_4$,
the code bit $b_6$ to the symbol bit $y_6$,
the code bit $b_7$ to the symbol bit $y_5$,
the code bit $b_8$ to the symbol bit $y_9$, and
the code bit $b_9$ to the symbol bit $y_7$.

In addition, where an LDPC code having a code length N of 64,800 or 16,200 bits and an encoding rate of 2/3 or 8/9 and an LDPC code having a code length N of 64,800 bits and an encoding rate of 9/10 is modulated by 4096QAM, the replacement process can be carried out by a replacement method, for example, illustrated in A of FIG. 97, of allocating
the code bit $b_0$ to the symbol bit $y_{10}$,
the code bit $b_1$ to the symbol bit $y_0$,
the code bit $b_2$ to the symbol bit $y_1$,
the code bit $b_3$ to the symbol bit $y_2$,
the code bit $b_4$ to the symbol bit $y_3$,
the code bit $b_5$ to the symbol bit $y_4$,
the code bit $b_6$ to the symbol bit $y_5$,
the code bit $b_7$ to the symbol bit $y_6$,
the code bit $b_8$ to the symbol bit $y_8$,
the code bit $b_9$ to the symbol bit $y_7$,
the code bit $b_{10}$ to the symbol bit $y_{11}$, and

the code bit $b_{11}$ to the symbol bit $y_9$.

While the new replacement method is described above in regard to the case wherein the modulation method is 1024QAM and the case wherein the modulation method is 4096QAM, in the following, arrangement of (signal points corresponding to) symbols of the individual modulation methods is described.

FIG. 128 illustrates arrangement of (signal points corresponding to) 1,024 symbols on the IQ plane where 1024QAM is carried out by the orthogonal modulation section 27 of FIG. 8.

In particular, FIG. 128 illustrates a method of determining arrangement symbols of 1024QAM recursively from arrangement of symbols of 256QAM of the DVB-T.2.

It is to be noted that, in FIG. 128, (i,q) represents a coordinate (I coordinate and Q coordinate) of a symbol on the IQ plane.

Meanwhile, $C_{256}$ (i, q) represents a symbol number (applied to a symbol) of a symbol at a position of the coordinate (i,q) from among numbers (hereinafter referred to as symbol numbers) applied sequentially to 256 symbols of 256QAM for specifying the symbols. In the following, a symbol of 256QAM at a position of the coordinate (i,q) is referred to also as $C_{256}$(i,q)th symbol .

Further, $C_{1024}$(i,q) represents a symbol number of a symbol at the position of the coordinate (i,q) from among 1,024 symbols of 1024QAM. In the following, the symbol of 1024QAM at the position of the coordinate (i,q) is referred to also as $C_{1024}$(i,q)th symbols.

Now, if all of 256 symbols of 256QAM are translated in parallel into the first quadrant on the IQ plane, then the $C_{256}$(i,q)th symbol of 256QAM after the parallel translation becomes $C_{1024}$(i,q)th = $C_{256}$(i,q)th symbol of 1024QAM.

Further, if the 256 symbols of 256QAM translated in parallel into the first quadrant are moved symmetrically with respect to the I axis, then the $C_{256}$(i,q)th symbol of 256QAM after the symmetrical movement becomes the $C_{1024}$ (i,-q)th = ($C_{256}$(i,q)+256)th symbol of 1024QAM.

In addition, if the 256 symbols of 256QAM translated in parallel into the first quadrant are moved symmetrically with respect to the Q axis, then the $C_{256}$(i,q)th symbol of 256QAM after the symmetrical movement becomes the $C_{1024}$ (-i,q)th = ($C_{256}$(i,q)+256×2)th symbol of 1024QAM.

Further, if the 256 symbols of 256QAM translated in parallel into the first quadrant are moved symmetrically with respect to the original point, then the $C_{256}$(i,q)th symbol of 256QAM after the symmetrical movement becomes the $C_{1024}$(-i,-q)th = ($C_{256}$(i,q)+256×3)th symbol of 1024QAM.

It is to be noted that, as regards the Xth symbol described above, a value where X is represented in a binary notation represents a value of the symbol (signal point to which the symbol is mapped).

For example, where $C_{256}$(i,q) = 25, the symbol value of the $C_{256}$(i,q)th symbol is 00011001B (B represents that the value of the preceding numeral is represented in a binary notation). Further, for example, where $C_{1024}$(i,q) = 823, the symbol value of the $C_{1024}$(i,q)th symbol is 1100110111B.

Further, the $C_{1024}$(-i,q)th = ($C_{256}$(i,q)+256×2) th symbol in the second quadrant (I < 0, q > 0) is at a position to which the $C_{256}$(i,q)th symbol from among the 256 symbols of 256QAM moved in parallel into the first quadrant is moved line-symmetrically with respect to the Q axis, and the symbol value of the $C_{1024}$(-i,q)th = ($C_{256}$(i,q)+256×2)th symbol assumes a value of a result of addition of 10B which is a binary representation of 2 from among 256 × 2 to the two high order bits of a value where $C_{256}$(i,q) is represented by a binary numbers.

In 1024QAM, the bit number m of one symbol is 10, and symbol bits of one symbol are represented ($y_0$, $y_1$, ..., $y_{m-1}$) = ($y_0$, $y_1$, $y_2$, $y_3$, $y_4$, $y_5$, $y_6$, $y_7$, $y_8$, $y_9$) from the most significant bit.

For example, where $C_{1024}$(i,q) = 823, the symbol value of the $C_{1024}$(i,q)th symbol, that is, the 10 symbol bits ($y_0$, $y_1$, $y_2$, $y_3$, $y_4$, $y_5$, $y_6$, $y_7$, $y_8$, $y_9$), are (1, 1, 0, 0, 1, 1, 0, 1, 1, 1).

Then, as described hereinabove with reference to FIGS. 62 to 94, the symbol bits $y_0$ and $y_1$ belong to the symbol bit group $Gy_1$; the symbol bits $y_2$ and $y_3$ to the symbol bit group $Gy_2$; the symbol bits $y_4$ and $y_5$ to the symbol bit group $Gy_3$; the symbol bits $y_6$ and $y_7$ to the symbol bit group $Gy_4$; and the symbol bits $y_8$ and $y_9$ to the symbol bit group $Gy_5$.

Furthermore, the symbol bits belonging to the symbol bit group $Gy_j$ having a comparatively small suffix j exhibits a comparatively good error probability (exhibits a comparatively high tolerance to errors).

FIG. 129 illustrates arrangement of (signal points corresponding to) 4,096 symbols on the IQ plane where 4096QAM is carried out by the orthogonal modulation section 27 of FIG. 8.

It is to be noted that, in FIG. 129, $C_{4096}$(i,q) represents a symbol number of a symbol at the position of the coordinate (i,q) from among 4,096 symbols of 4096QAM. In the following, the symbol of 4096QAM at the position of the coordinate (i,q) is referred to also as $C_{4096}$(i,q)th symbol.

Now, if all of 1024 symbols of 1024QAM described in FIG. 128 are translated in parallel into the first quadrant on the IQ plane, then the $C_{1024}$(i,q)th symbol of 1024QAM after the parallel translation becomes $C_{4096}$(i,q)th = $C_{1024}$(i, q)th symbol of 4096QAM.

Further, if the 1024 symbols of 1024QAM translated in parallel into the first quadrant are moved symmetrically with respect to the I axis, then the $C_{1024}$(i,q)th symbol of 1024QAM after the symmetrical movement becomes the $C_{4096}$ (i,-q)th = ($C_{1024}$(i,q)+1024)th symbol of 4096QAM.

In addition, if the 1024 symbols of 1024QAM translated in parallel into the first quadrant are moved symmetrically with respect to the Q axis, then the $C_{1024}$(i,q)th symbol of 1024QAM after the symmetrical movement becomes the $C_{4096}$(-i,q)th = ($C_{1024}$(i,q)+1024×2)th symbol of 4096QAM.

Further, if the 1024 symbols of 1024QAM translated in parallel into the first quadrant are moved symmetrically with respect to the original point, then the $C_{1024}$(i,q)th symbol of 1024QAM after the symmetrical movement becomes the $C_{4096}$(-i,-q)th = ($C_{1024}$(i,q)+1024×3)th symbol of 4C396QAM.

Also with regard to symbol bits of symbols of 1024QAM (FIG. 128) and 4096QAM (FIG. 129), there exist strong bits and weak beats similarly to that described in FIG. 12 or the like.

FIGS. 130 to 133 illustrate results of a simulation of the BER (Bit Error Rate) where a replacement process of the new replacement method is carried out and where a replacement process of the new replacement method is not carried out.

In particular, FIG. 130 illustrates the BER where LDPC codes having a code length N of 16,200 and having encoding rates of 2/3, 3/4, 3/5, 5/6 and 8/9 are determined as an object and 1024QAM are adopted as the modulation method.

FIG. 131 illustrates the BER where LDPC codes having a code length N of 64,800 and having encoding rates of 2/3, 3/4, 3/5, 5/6, 8/9 and 9/10 are determined as an object and 1024QAM are adopted as the modulation method.

FIG. 132 illustrates the BER where LDPC codes having a code length N of 16,200 and having encoding rates of 2/3, 3/4, 3/5, 5/6 and 8/9 are determined as an object and 4096QAM are adopted as the modulation method.

FIG. 133 illustrates the BER where LDPC codes having a code length N of 64,800 and having encoding rates of 2/3, 3/4, 3/5, 5/6, 8/9 and 9/10 are determined as an object and 4096QAM are adopted as the modulation method.

It is to be noted that, in FIGS. 130 to 133, the multiple b is 1.

Further, in FIGS. 130 to 133, the axis of abscissa indicates $E_s/N_0$ (noise power ratio to signal power per one symbol), and the axis of ordinate indicates the BER. Further, a solid line represents the BER where a replacement process of the new replacement method is carried out and a broken line represents the BER where no replacement process is carried out.

From FIGS. 130 to 133, it can be recognized that the replacement process of the new replacement method exhibits an improved BER and an improved tolerance to errors in comparison with an alternative case wherein the replacement process is not carried out.

It is to be noted that, while, in the present embodiment, the replacement section 32 in the demultiplexer 25 carries out the replacement process for code bits read out from the memory 31 for the convenience of description, it is possible to carry out the replacement process by controlling writing or reading out of code bits into or from the memory 31.

In particular, the replacement process can be carried out, for example, by controlling the addresses (read addresses) from which code bits are to be read out such that reading out of the code bits from the memory 31 is carried out in the order of the code bits after the replacement.

Incidentally, while the new replacement method as a replacement method of code bits where the multiple b is 1 is described above with reference to FIGS. 62 to 127, the replacement of code bits where the multiple b is 1 can be utilized as it is to replacement of code bits where the multiple b is equal to or higher than 2 (it is to be noted, however, that it is necessary for the multiple b to be a devisor of the code length N).

It is described with reference to FIGS. 134 and 135 that the replacement of code bits where the multiple b is 1 can be utilized as it is to replacement of code bits where the multiple b is equal to or higher than 2.

FIG. 134 is a view illustrating replacement of code bits where the multiple b is 1.

It is to be noted that it is assumed that, in FIG. 134 (similarly also in FIG. 135 hereinafter described), the code length N of an LDPC code is, for example, 24 bits for the simplification of description. Further, it is assumed that the modulation method is QPSK wherein 4 (= m) bits from among code bits are mapped as one symbol to some of four signal points.

Where the code length N is 24 bits and the multiple b is 1 and besides 4 (= m) code bits are set as one symbol, the memory 31 (FIGS. 16 and 17) of the demultiplexer 25 has four columns for storing 4 × 1 (= mb) bits in the row direction and stores 24/(4 × 1) bits in the column direction.

Now, if it is assumed that the code bits of an LDPC code of 24 bits are represented as a, b, c, d, ..., v, w, x beginning with the top bit, then the code bits a to x of the LDPC code of 24 bits are successively written in the column direction into the four columns of the memory 31 as seen in A of FIG. 134.

In particular, A of FIG. 134 illustrates a writing state of the LDPC code of 24 bits into the four columns of the memory 31.

Into the first column from among the four columns of the memory 31, the code bits a, b, c, d, e and f are written; into the second column, the code bits g, h, i, j, k and 1 are written; into the third column, the code bits m, n, o, p, q and r are written; and into the fourth column, the code bits s, t, u, v, w and x are written.

It is to be noted that, in FIG. 134 (similarly also in FIG. 135), a code bit whose writing is carried out comparatively early is illustrated at a comparatively lower position of each column in order to facilitate recognition of the reading out order of code bits from the column.

After the writing of the 24 code bits a to x into the memory 31 ends, the code bits a to x written in the memory 31 are read out in a unit of 4 × 1 (= mb) bits in the row direction and supplied to the replacement section 32 (FIGS. 16 and 17).

The replacement section 32 carries out replacement of the code bits $b_i$ of allocating the 4 × 1 (= mb) bits read out in the row direction from the memory 31 to symbol bits $y_i$ of one (=b) symbol, for example, as seen in B of FIG. 134.

In particular, B of FIG. 134 illustrates an example of replacement of allocating four code bits $b_i$ to symbol bits $y_i$ of one symbol.

In B of FIG. 134, replacement of allocating the code bit $b_0$ read out from the first column to the symbol bit $y_2$, allocating the code bit $b_1$ read out from the second column to the symbol bit $y_1$, allocating the code bit $b_2$ read out from the third column to the symbol bit $y_3$ and allocating the code bit $b_3$ read out from the fourth column to the symbol bit $y_0$ is carried out.

It is to be noted that, in the following description, allocation of code bits to symbol bits for replacing the code bits is referred to as replacement pattern.

As a result of the replacement of the 4 × 1 (= mb) code bits $b_0$, $b_1$, $b_2$ and $b_3$ read out in the row direction from the memory 31 in accordance with the replacement pattern of B of FIG. 134, one symbol composed of the symbol bits $y_0$, $y_1$, $y_2$ and $y_3$ illustrated in C of FIG. 134 is obtained.

In particular, C of FIG. 134 illustrates symbols obtained by replacement of the code bits written in such a manner as seen in A of FIG. 134 in accordance with the replacement pattern of B of FIG. 134.

For example, where (the arrangement of) the code bitts a, g, m and s written in the lowermost row of the first to fourth columns in A of FIG. 134 are replaced in accordance with the replacement pattern of B of FIG. 134, a symbol of the arrangement of the symbol bits s, g, a and m as seen at the bottom of C of FIG. 134 is obtained.

Meanwhile, where, for example, the code bits b, h, n and t written in the second row from below of the first to fourth columns in A of FIG. 134 are replaced in accordance with the replacement pattern of B of FIG. 134, a symbol of the arrangement of the symbol bits t, h, b and n as seen at the second position from below in C of FIG. 134 is obtained.

FIG. 135 is a view illustrating replacement of code bits where the multiple b is 2 utilizing the replacement pattern of code bits where the multiple b is 1 illustrated in FIG. 134 as it is.

It is to be noted that the replacement in FIG. 135 is different from that in FIG. 134 only in that the multiple b is not 1 but 2. Accordingly, the code length N of the LDPC code is 24 bits and the modulation method is QPSK wherein 4 (= m) bits of the code bits are mapped as one symbol to four signal points.

Where the code length N is 24 bits and the multiple b is 2 and besides 4 (= m) code bits are set as one symbol, the memory 31 (FIGS. 16 and 17) of the demultiplexer 25 has eight columns for storing 4 × 2 (= mb) bits in the row direction and stores 24/(4 × 2) bits in the column direction.

The code bits a to x of an LDPC code of 24 bits are successively written in the column direction into the eight columns of the memory 31 as seen in A of FIG. 135.

In particular, A of FIG. 135 illustrates a writing state of the LDPC code of 24 bits into the eight columns of the memory 31.

It is to be noted that, in A of FIG. 135, the eight columns are illustrated in order of the first column, third column, fifth column, seventh column, second column, fourth column, sixth column and eighth column for the convenience of description.

In A of FIG. 135, into the first column from among the eight columns of the memory 31, the code bits a, b and c are written; into the second column, the code bits d, e and f are written; into the third column, the code bits g, h and i are written; into the fourth column, the code bits j, k and 1 are written; into the fifth column, the code bits m, n and o are written; into the sixth column, the code bits p, q and r are written; into the seventh column, code bits s, t and u are written; and into the eighth column, code bits v, w and x are written.

After the writing of the 24 code bits a to x into the memory 31 ends, the code bits a to x written in the memory 31 are read out in a unit of 4 × 2 (= mb) bits in the row direction and supplied to the replacement section 32 (FIGS. 16 and 17).

The replacement section 32 carries out replacement of the code bits $b_i$ of allocating the 4 × 2 (= mb) bits read out in the row direction from the memory 31 to symbol bits $y_i$ of two successive (= b) symbols, for example, as seen in B of FIG. 135.

In particular, B of FIG. 135 illustrates an example of replacement of allocating eight code bits $b_i$ to symbol bits $y_i$ of two successive symbols.

Here, in B of FIG. 135, the symbol bits $y_0$ to $y_3$ are symbol bits of the first symbol from between the two successive symbols, and the symbol bits $y_4$ to $y_7$ are symbol bits of the second symbol from between the two successive symbols.

In B of FIG. 135, the replacement pattern of code bits where the multiple b is 1 illustrated in B of FIG. 134 is used as it is.

In particular, in B of FIG. 135, replacement of allocating the code bit $b_0$ read out from the first column to the symbol bit $y_2$, allocating the code bit $b_2$ read out from the third column to the symbol bit $y_1$, allocating the code bit $b_4$ read out from the fifth column to the symbol bit $y_3$ and allocating the code bit $b_6$ read out from the seventh column to the symbol bit $y_0$ is carried out. This replacement pattern (arrangement pattern of arrow marks in B of FIG. 135) coincides with the replacement pattern of code bits where the multiple b is 1 illustrated in B of FIG. 134.

In addition, in B of FIG. 135, replacement of allocating the code bit $b_1$ read out from the second column to the symbol bit $y_6$, allocating the code bit $b_3$ read out from the fourth column to the symbol bit $y_5$, allocating the code bit $b_5$ read out from the sixth column to the symbol bit $y_7$ and allocating the code bit $b_7$ read out from the eight column to the symbol bit $y_4$ is carried out. This replacement pattern also coincides with the replacement pattern of code bits where the multiple b is 1 illustrated in B of FIG. 134.

As a result of the replacement of the 4 × 2 (= mb) code bits $b_0$, $b_1$, $b_2$, $b_3$, $b_4$, $b_5$, $b_6$ and $b_7$ read out in the row direction from the memory 31 in accordance with the replacement pattern of B of FIG. 135, two successive symbols composed of the symbol bits $y_0$, $y_1$, $y_2$, $y_3$, $y_4$, $y_5$, $y_6$ and $y_7$ illustrated in C of FIG. 135 are obtained.

In particular, C of FIG. 135 illustrates symbols obtained by replacement of the code bits written in such a manner as seen in A of FIG. 135 in accordance with the replacement pattern of B of FIG. 135.

For example, where (the arrangement of) the code bitts a, g, m, s, d, j, p and v written in the lowermost row of the first to eight columns in A of FIG. 135 are replaced in accordance with the replacement pattern of B of FIG. 135, a symbol of the arrangement of the symbol bits s, g, a and m and a symbol of the arrangement of the symbol bits v, j, d and p as seen at the bottom of C of FIG. 135 are obtained.

Meanwhile, where, for example, the code bits b, h, n, t, e, k, q and w written in the second row from below of the first to eighth columns in A of FIG. 135 are replaced in accordance with the replacement pattern of B of FIG. 135, a symbol of the arrangement of the symbol bits t, h, b and n and a symbol of the arrangement of the symbol bits w, k, e and q as seen at the second position from below in C of FIG. 135 are obtained.

Here, as can be recognized from comparison between C of FIG. 134 and C of FIG. 135, if the replacement pattern where the multiple b is 1 is utilized as it is to carry out replacement of code bits where the multiple b is 2, then a symbol having the same arrangement of symbol bits (code bits) as that in the case wherein the multiple b is 1.

Accordingly, where the replacement pattern where the multiple b is 1 is utilized as it is to carry out replacement of code bits where the multiple b is 2, the tolerance to errors according to the replacement is similar to that where the multiple b is 1.

It is to be noted that the order in which a symbol composed of arrangement of the same symbol bits is obtained may differ between a case wherein the multiple b is 1 and another case wherein the multiple b is 2.

Now, a particular example of replacement of code bits wherein the multiple b is 2 utilizing the replacement pattern where the multiple b is 1 as it is as described above is described.

FIG. 136 illustrates an example of replacement of code bits where the LDPC code is an LDPC code having a code length N of 16,200 bits and an encoding rate of 2/3 and besides the modulation method is 1024QAM and the multiple b is 2.

The replacement of code bits wherein the multiple b is 2 in FIG. 136 utilizes the replacement of code bits of A of FIG. 64 which is different only in that the multiple b is 1 as it is. Accordingly, the replacement of code bits of FIG. 136 complies with the allocation rule of FIG. 63.

Where the LDPC code is an LDPC code having a code length N of 16,200 bits and an encoding rate of 2/3 and besides the modulation method is 1024QAM and the multiple b is 2, in the demultiplexer 25, code bits written in the memory 31 for (16,200/(10 × 2)) × (10 × 2) bits in the column direction × row direction are read out in a unit of 10 × 2 (= mb) bits in the row direction and are supplied to the replacement section 32 (FIGS. 16 and 17).

The replacement section 32 replaces the 10 × 2 (= mb) code bits $b_0$ to $b_{19}$ read out from the memory 31 such that the 10 × 2 (= mb) code bits $b_0$ to $b_{19}$ are allocated, for example, to the 10 × 2 (= mb) symbol bits $y_0$ to $y_{19}$ of two successive (= b) symbols as seen in FIG. 136.

In particular, the replacement section 32 carries out replacement for allocating
the code bit $b_0$ to the symbol bit $y_8$,
the code bit $b_2$ to the symbol bit $y_0$,
the code bit $b_4$ to the symbol bit $y_1$,
the code bit $b_6$ to the symbol bit $y_2$,
the code bit $b_8$ to the symbol bit $y_3$,
the code bit $b_{10}$ to the symbol bit $y_4$,
the code bit $b_{12}$ to the symbol bit $y_6$,
the code bit $b_{14}$ to the symbol bit $y_5$,
the code bit $b_{16}$ to the symbol bit $y_9$,
the code bit $b_{18}$ to the symbol bit $y_7$,
the code bit $b_1$ to the symbol bit $y_{18}$,

the code bit $b_3$ to the symbol bit $y_{10}$,
the code bit $b_5$ to the symbol bit $y_{11}$,
the code bit $b_7$ to the symbol bit $y_{12}$,
the code bit $b_9$ to the symbol bit $y_{13}$,
the code bit $b_{11}$ to the symbol bit $y_{14}$,
the code bit $b_{13}$ to the symbol bit $y_{16}$,
the code bit $b_{15}$ to the symbol bit $y_{15}$,
the code bit $b_{17}$ to the symbol bit $y_{19}$, and
the code bit $b_{19}$ to the symbol bit $y_{17}$.

It is to be noted that, in FIG. 136, both of the replacement pattern of the code bits $b_0$, $b_2$, $b_4$, $b_6$, $b_8$, $b_{10}$, $b_{12}$, $b_{14}$, $b_{16}$ and $b_{18}$ and the replacement pattern of the code bits $b_1$, $b_3$, $b_5$, $b_7$, $b_9$, $b_{11}$, $b_{13}$, $b_{15}$, $b_{17}$ and $b_{19}$ coincide with the replacement pattern of the code bits $b_0$ to $b_9$ of A of FIG. 64.

FIG. 137 illustrates an example of replacement of code bits where the LDPC code is an LDPC code having a code length N of 64,800 bits and an encoding rate of 2/3 and besides the modulation method is 1024QAM and the multiple b is 2.

The replacement of code bits wherein the multiple b is 2 in FIG. 137 utilizes the replacement of code bits of A of FIG. 67 which is different only in that the multiple b is 1 as it is. Accordingly, the replacement of code bits of FIG. 137 complies with the allocation rule of FIG. 66.

Where the LDPC code is an LDPC code having a code length N of 64,800 bits and an encoding rate of 2/3 and besides the modulation method is 1024QAM and the multiple b is 2, in the demultiplexer 25, code bits written in the memory 31 for $(64{,}800/(10 \times 2)) \times (10 \times 2)$ bits in the column direction $\times$ row direction are read out in a unit of $10 \times 2$ (= mb) bits in the row direction and are supplied to the replacement section 32 (FIGS. 16 and 17).

The replacement section 32 replaces the $10 \times 2$ (= mb) code bits $b_0$ to $b_{19}$ read out from the memory 31 such that the $10 \times 2$ (= mb) code bits $b_0$ to $b_{19}$ are allocated, for example, to the $10 \times 2$ (= mb) symbol bits $y_0$ to $y_{19}$ of two successive (= b) symbols as seen in FIG. 137.

In particular, the replacement section 32 carries out replacement for allocating
the code bit $b_0$ to the symbol bit $y_8$,
the code bit $b_2$ to the symbol bit $y_0$,
the code bit $b_4$ to the symbol bit $y_1$,
the code bit $b_6$ to the symbol bit $y_2$,
the code bit $b_8$ to the symbol bit $y_3$,
the code bit $b_{10}$ to the symbol bit $y_4$,
the code bit $b_{12}$ to the symbol bit $y_6$,
the code bit $b_{14}$ to the symbol bit $y_5$,
the code bit $b_{16}$ to the symbol bit $y_9$,
the code bit $b_{18}$ to the symbol bit $y_7$,
the code bit $b_1$ to the symbol bit $y_{18}$,
the code bit $b_3$ to the symbol bit $y_{10}$,
the code bit $b_5$ to the symbol bit $y_{11}$,
the code bit $b_7$ to the symbol bit $y_{12}$, the code bit $b_9$ to the symbol bit $y_{13}$,
the code bit $b_{11}$ to the symbol bit $y_{14}$,
the code bit $b_{13}$ to the symbol bit $y_{16}$,
the code bit $b_{15}$ to the symbol bit $y_{15}$,
the code bit $b_{17}$ to the symbol bit $y_{19}$, and
the code bit $b_{19}$ to the symbol bit $y_{17}$.

It is to be noted that, in FIG. 137, both of the replacement pattern of the code bits $b_0$, $b_2$, $b_4$, $b_6$, $b_8$, $b_{10}$, $b_{12}$, $b_{14}$, $b_{16}$ and $b_{18}$ and the replacement pattern of the code bits $b_1$, $b_3$, $b_5$, $b_7$, $b_9$, $b_{11}$, $b_{13}$, $b_{15}$, $b_{17}$ and $b_{19}$ coincide with the replacement pattern of the code bits $b_0$ to $b_9$ of A of FIG. 67.

FIG. 138 illustrates an example of replacement of code bits where the LDPC code is an LDPC code having a code length N of 16,200 bits and an encoding rate of 3/4 and besides the modulation method is 1024QAM and the multiple b is 2.

The replacement of code bits wherein the multiple b is 2 in FIG. 138 utilizes the replacement of code bits of A of FIG. 70 which is different only in that the multiple b is 1 as it is. Accordingly, the replacement of code bits of FIG. 138 complies with the allocation rule of FIG. 69.

Where the LDPC code is an LDPC code having a code length N of 16,200 bits and an encoding rate of 3/4 and besides the modulation method is 1024QAM and the multiple b is 2, in the demultiplexer 25, code bits written in the memory 31 for $(16{,}200/(10 \times 2)) \times (10 \times 2)$ bits in the column direction $\times$ row direction are read out in a unit of $10 \times 2$ (= mb) bits in the row direction and are supplied to the replacement section 32 (FIGS. 16 and 17).

The replacement section 32 replaces the 10 × 2 (= mb) code bits $b_0$ to $b_{19}$ read out from the memory 31 such that the 10 × 2 (= mb) code bits $b_0$ to $b_{19}$ are allocated, for example, to the 10 × 2 (= mb) symbol bits $y_0$ to $y_{19}$ of two successive (= b) symbols as seen in FIG. 138.

In particular, the replacement section 32 carries out replacement for allocating
the code bit $b_0$ to the symbol bit $y_6$,
the code bit $b_2$ to the symbol bit $y_4$,
the code bit $b_4$ to the symbol bit $y_8$,
the code bit $b_6$ to the symbol bit $y_5$,
the code bit $b_8$ to the symbol bit $y_0$,
the code bit $b_{10}$ to the symbol bit $y_2$,
the code bit $b_{12}$ to the symbol bit $y_1$,
the code bit $b_{14}$ to the symbol bit $y_3$,
the code bit $b_{16}$ to the symbol bit $y_9$,
the code bit $b_{18}$ to the symbol bit $y_7$,
the code bit $b_1$ to the symbol bit $y_{16}$,
the code bit $b_3$ to the symbol bit $y_{14}$,
the code bit $b_5$ to the symbol bit $y_{18}$,
the code bit $b_7$ to the symbol bit $y_{15}$,
the code bit $b_9$ to the symbol bit $y_{10}$,
the code bit $b_{11}$ to the symbol bit $y_{12}$,
the code bit $b_{13}$ to the symbol bit $y_{11}$,
the code bit $b_{15}$ to the symbol bit $y_{13}$,
the code bit $b_{17}$ to the symbol bit $y_{19}$, and
the code bit $b_{19}$ to the symbol bit $y_{17}$.

It is to be noted that, in FIG. 138, both of the replacement pattern of the code bits $b_0$, $b_2$, $b_4$, $b_6$, $b_8$, $b_{10}$, $b_{12}$, $b_{14}$, $b_{16}$ and $b_{18}$ and the replacement pattern of the code bits $b_1$, $b_3$, $b_5$, $b_7$, $b_9$, $b_{11}$, $b_{13}$, $b_{15}$, $b_{17}$ and $b_{19}$ coincide with the replacement pattern of the code bits $b_0$ to $b_9$ of A of FIG. 70.

FIG. 139 illustrates an example of replacement of code bits where the LDPC code is an LDPC code having a code length N of 64,800 bits and an encoding rate of 3/4 and besides the modulation method is 1024QAM and the multiple b is 2.

The replacement of code bits wherein the multiple b is 2 in FIG. 139 utilizes the replacement of code bits of A of FIG. 73 which is different only in that the multiple b is 1 as it is. Accordingly, the replacement of code bits of FIG. 139 complies with the allocation rule of FIG. 72.

Where the LDPC code is an LDPC code having a code length N of 64,800 bits and an encoding rate of 3/4 and besides the modulation method is 1024QAM and the multiple b is 2, in the demultiplexer 25, code bits written in the memory 31 for (64,800/(10 × 2)) × (10 × 2) bits in the column direction × row direction are read out in a unit of 10 × 2 (= mb) bits in the row direction and are supplied to the replacement section 32 (FIGS. 16 and 17).

The replacement section 32 replaces the 10 × 2 (= mb) code bits $b_0$ to $b_{19}$ read out from the memory 31 such that the 10 × 2 (= mb) code bits $b_0$ to $b_{19}$ are allocated, for example, to the 10 × 2 (= mb) symbol bits $y_0$ to $y_{19}$ of two successive (= b) symbols as seen in FIG. 139.

In particular, the replacement section 32 carries out replacement for allocating
the code bit $b_0$ to the symbol bit $y_6$,
the code bit $b_2$ to the symbol bit $y_4$,
the code bit $b_4$ to the symbol bit $y_8$,
the code bit $b_6$ to the symbol bit $y_5$,
the code bit $b_8$ to the symbol bit $y_0$,
the code bit $b_{10}$ to the symbol bit $y_2$,
the code bit $b_{12}$ to the symbol bit $y_1$,
the code bit $b_{14}$ to the symbol bit $y_3$,
the code bit $b_{16}$ to the symbol bit $y_9$,
the code bit $b_{18}$ to the symbol bit $y_7$,
the code bit $b_1$ to the symbol bit $y_{16}$,
the code bit $b_3$ to the symbol bit $y_{14}$,
the code bit $b_5$ to the symbol bit $y_{18}$,
the code bit $b_7$ to the symbol bit $y_{15}$,
the code bit $b_9$ to the symbol bit $y_{10}$,
the code bit $b_{11}$ to the symbol bit $y_{12}$,
the code bit $b_{13}$ to the symbol bit $y_{11}$,

the code bit $b_{15}$ to the symbol bit $y_{13}$,
the code bit $b_{17}$ to the symbol bit $y_{19}$, and
the code bit $b_{19}$ to the symbol bit $y_{17}$.

It is to be noted that, in FIG. 139, both of the replacement pattern of the code bits $b_0$, $b_2$, $b_4$, $b_6$, $b_8$, $b_{10}$, $b_{12}$, $b_{14}$, $b_{16}$ and $b_{18}$ and the replacement pattern of the code bits $b_1$, $b_3$, $b_5$, $b_7$, $b_9$, $b_{11}$, $b_{13}$, $b_{15}$, $b_{17}$ and $b_{19}$ coincide with the replacement pattern of the code bits $b_0$ to $b_9$ of A of FIG. 73.

FIG. 140 illustrates an example of replacement of code bits where the LDPC code is an LDPC code having a code length N of 16,200 bits and an encoding rate of 4/5 and besides the modulation method is 1024QAM and the multiple b is 2.

The replacement of code bits wherein the multiple b is 2 in FIG. 140 utilizes the replacement of code bits of A of FIG. 76 which is different only in that the multiple b is 1 as it is. Accordingly, the replacement of code bits of FIG. 140 complies with the allocation rule of FIG. 75.

where the LDPC code is an LDPC code having a code length N of 16,200 bits and an encoding rate of 4/5 and besides the modulation method is 1024QAM and the multiple b is 2, in the demultiplexer 25, code bits written in the memory 31 for $(16{,}200/(10 \times 2)) \times (10 \times 2)$ bits in the column direction $\times$ row direction are read out in a unit of $10 \times 2$ (= mb) bits in the row direction and are supplied to the replacement section 32 (FIGS. 16 and 17).

The replacement section 32 replaces the $10 \times 2$ (= mb) code bits $b_0$ to $b_{19}$ read out from the memory 31 such that the $10 \times 2$ (= mb) code bits $b_0$ to $b_{19}$ are allocated, for example, to the $10 \times 2$ (= mb) symbol bits $y_0$ to $y_{19}$ of two successive (= b) symbols as seen in FIG. 140.

In particular, the replacement section 32 carries out replacement for allocating
the code bit $b_0$ to the symbol bit $y_6$,
the code bit $b_2$ to the symbol bit $y_4$,
the code bit $b_4$ to the symbol bit $y_8$,
the code bit $b_6$ to the symbol bit $y_5$,
the code bit $b_8$ to the symbol bit $y_0$,
the code bit $b_{10}$ to the symbol bit $y_2$,
the code bit $b_{12}$ to the symbol bit $y_1$,
the code bit $b_{14}$ to the symbol bit $y_3$,
the code bit $b_{16}$ to the symbol bit $y_9$,
the code bit $b_{18}$ to the symbol bit $y_7$,
the code bit $b_1$ to the symbol bit $y_{16}$,
the code bit $b_3$ to the symbol bit $y_{14}$,
the code bit $b_5$ to the symbol bit $y_{18}$,
the code bit $b_7$ to the symbol bit $y_{15}$,
the code bit $b_9$ to the symbol bit $y_{10}$,
the code bit $b_{11}$ to the symbol bit $y_{12}$,
the code bit $b_{13}$ to the symbol bit $y_{11}$,
the code bit $b_{15}$ to the symbol bit $y_{13}$,
the code bit $b_{17}$ to the symbol bit $y_{19}$, and
the code bit $b_{19}$ to the symbol bit $y_{17}$.

It is to be noted that, in FIG. 140, both of the replacement pattern of the code bits $b_0$, $b_2$, $b_4$, $b_6$, $b_8$, $b_{10}$, $b_{12}$, $b_{14}$, $b_{16}$ and $b_{18}$ and the replacement pattern of the code bits $b_1$, $b_3$, $b_5$, $b_7$, $b_9$, $b_{11}$, $b_{13}$, $b_{15}$, $b_{17}$ and $b_{19}$ coincide with the replacement pattern of the code bits $b_0$ to $b_9$ of A of FIG. 76.

FIG. 141 illustrates an example of replacement of code bits where the LDPC code is an LDPC code having a code length N of 64,800 bits and an encoding rate of 4/5 and besides the modulation method is 1024QAM and the multiple b is 2.

The replacement of code bits wherein the multiple b is 2 in FIG. 141 utilizes the replacement of code bits of A of FIG. 79 which is different only in that the multiple b is 1 as it is. Accordingly, the replacement of code bits of FIG. 141 complies with the allocation rule of FIG. 78.

Where the LDPC code is an LDPC code having a code length N of 64,800 bits and an encoding rate of 4/5 and besides the modulation method is 1024QAM and the multiple b is 2, in the demultiplexer 25, code bits written in the memory 31 for $(64{,}800/(10 \times 2)) \times (10 \times 2)$ bits in the column direction $\times$ row direction are read out in a unit of $10 \times 2$ (= mb) bits in the row direction and are supplied to the replacement section 32 (FIGS. 16 and 17).

The replacement section 32 replaces the $10 \times 2$ (= mb) code bits $b_0$ to $b_{19}$ read out from the memory 31 such that the $10 \times 2$ (= mb) code bits $b_0$ to $b_{19}$ are allocated, for example, to the $10 \times 2$ (= mb) symbol bits $y_0$ to $y_{19}$ of two successive (= b) symbols as seen in FIG. 141.

In particular, the replacement section 32 carries out replacement for allocating
the code bit $b_0$ to the symbol bit $y_6$,

the code bit $b_2$ to the symbol bit $y_4$,
the code bit $b_4$ to the symbol bit $y_8$,
the code bit $b_6$ to the symbol bit $y_5$,
the code bit $b_8$ to the symbol bit $y_0$,
the code bit $b_{10}$ to the symbol bit $y_2$,
the code bit $b_{12}$ to the symbol bit $y_1$,
the code bit $b_{14}$ to the symbol bit $y_3$,
the code bit $b_{16}$ to the symbol bit $y_9$,
the code bit $b_{18}$ to the symbol bit $y_7$,
the code bit $b_1$ to the symbol bit $y_{16}$,
the code bit $b_3$ to the symbol bit $y_{14}$,
the code bit $b_5$ to the symbol bit $y_{18}$,
the code bit $b_7$ to the symbol bit $y_{15}$,
the code bit $b_9$ to the symbol bit $y_{10}$,
the code bit $b_{11}$ to the symbol bit $y_{12}$,
the code bit $b_{13}$ to the symbol bit $y_{11}$,
the code bit $b_{15}$ to the symbol bit $y_{13}$,
the code bit $b_{17}$ to the symbol bit $y_{19}$, and
the code bit $b_{19}$ to the symbol bit $y_{17}$.

It is to be noted that, in FIG. 141, both of the replacement pattern of the code bits $b_0$, $b_2$, $b_4$, $b_6$, $b_8$, $b_{10}$, $b_{12}$, $b_{14}$, $b_{16}$ and $b_{18}$ and the replacement pattern of the code bits $b_1$, $b_3$, $b_5$, $b_7$, $b_9$, $b_{11}$, $b_{13}$, $b_{15}$, $b_{17}$ and $b_{19}$ coincide with the replacement pattern of the code bits $b_0$ to $b_9$ of A of FIG. 79.

FIG. 142 illustrates an example of replacement of code bits where the LDPC code is an LDPC code having a code length N of 16,200 bits and an encoding rate of 5/6 and besides the modulation method is 1024QAM and the multiple b is 2.

The replacement of code bits wherein the multiple b is 2 in FIG. 142 utilizes the replacement of code bits of A of FIG. 82 which is different only in that the multiple b is 1 as it is. Accordingly, the replacement of code bits of FIG. 142 complies with the allocation rule of FIG. 81.

Where the LDPC code is an LDPC code having a code length N of 16,200 bits and an encoding rate of 5/6 and besides the modulation method is 1024QAM and the multiple b is 2, in the demultiplexer 25, code bits written in the memory 31 for $(16{,}200/(10 \times 2)) \times (10 \times 2)$ bits in the column direction × row direction are read out in a unit of $10 \times 2$ (= mb) bits in the row direction and are supplied to the replacement section 32 (FIGS. 16 and 17).

The replacement section 32 replaces the $10 \times 2$ (= mb) code bits $b_0$ to $b_{19}$ read out from the memory 31 such that the $10 \times 2$ (= mb) code bits $b_0$ to $b_{19}$ are allocated, for example, to the $10 \times 2$ (= mb) symbol bits $y_0$ to $y_{19}$ of two successive (= b) symbols as seen in FIG. 142.

In particular, the replacement section 32 carries out replacement for allocating
the code bit $b_0$ to the symbol bit $y_6$,
the code bit $b_2$ to the symbol bit $y_4$,
the code bit $b_4$ to the symbol bit $y_8$,
the code bit $b_6$ to the symbol bit $y_5$,
the code bit $b_8$ to the symbol bit $y_0$,
the code bit $b_{10}$ to the symbol bit $y_2$,
the code bit $b_{12}$ to the symbol bit $y_1$,
the code bit $b_{14}$ to the symbol bit $y_3$,
the code bit $b_{16}$ to the symbol bit $y_9$,
the code bit $b_{18}$ to the symbol bit $y_7$,
the code bit $b_1$ to the symbol bit $y_{16}$,
the code bit $b_3$ to the symbol bit $y_{14}$,
the code bit $b_5$ to the symbol bit $y_{18}$,
the code bit $b_7$ to the symbol bit $y_{15}$,
the code bit $b_9$ to the symbol bit $y_{10}$,
the code bit $b_{11}$ to the symbol bit $y_{12}$,
the code bit $b_{13}$ to the symbol bit $y_{11}$,
the code bit $b_{15}$ to the symbol bit $y_{13}$,
the code bit $b_{17}$ to the symbol bit $y_{19}$, and
the code bit $b_{19}$ to the symbol bit $y_{17}$.

It is to be noted that, in FIG. 142, both of the replacement pattern of the code bits $b_0$, $b_2$, $b_4$, $b_6$, $b_8$, $b_{10}$, $b_{12}$, $b_{14}$, $b_{16}$ and $b_{18}$ and the replacement pattern of the code bits $b_1$, $b_3$, $b_5$, $b_7$, $b_9$, $b_{11}$, $b_{13}$, $b_{15}$, $b_{17}$ and $b_{19}$ coincide with

the replacement pattern of the code bits $b_0$ to $b_9$ of A of FIG. 82.

FIG. 143 illustrates an example of replacement of code bits where the LDPC code is an LDPC code having a code length N of 64,800 bits and an encoding rate of 5/6 and besides the modulation method is 1024QAM and the multiple b is 2.

The replacement of code bits wherein the multiple b is 2 in FIG. 143 utilizes the replacement of code bits of A of FIG. 85 which is different only in that the multiple b is 1 as it is. Accordingly, the replacement of code bits of FIG. 143 complies with the allocation rule of FIG. 84.

Where the LDPC code is an LDPC code having a code length N of 64,800 bits and an encoding rate of 5/6 and besides the modulation method is 1024QAM and the multiple b is 2, in the demultiplexer 25, code bits written in the memory 31 for $(64{,}800/(10 \times 2)) \times (10 \times 2)$ bits in the column direction $\times$ row direction are read out in a unit of $10 \times 2$ (= mb) bits in the row direction and are supplied to the replacement section 32 (FIGS. 16 and 17).

The replacement section 32 replaces the $10 \times 2$ (= mb) code bits $b_0$ to $b_{19}$ read out from the memory 31 such that the $10 \times 2$ (= mb) code bits $b_0$ to $b_{19}$ are allocated, for example, to the $10 \times 2$ (= mb) symbol bits $y_0$ to $y_{19}$ of two successive (= b) symbols as seen in FIG. 143.

In particular, the replacement section 32 carries out replacement for allocating
the code bit $b_0$ to the symbol bit $y_6$,
the code bit $b_2$ to the symbol bit $y_4$,
the code bit $b_4$ to the symbol bit $y_8$,
the code bit $b_6$ to the symbol bit $y_5$,
the code bit $b_8$ to the symbol bit $y_0$,
the code bit $b_{10}$ to the symbol bit $y_2$,
the code bit $b_{12}$ to the symbol bit $y_1$,
the code bit $b_{14}$ to the symbol bit $y_3$,
the code bit $b_{16}$ to the symbol bit $y_9$,
the code bit $b_{18}$ to the symbol bit $y_7$,
the code bit $b_1$ to the symbol bit $y_{16}$,
the code bit $b_3$ to the symbol bit $y_{14}$,
the code bit $b_5$ to the symbol bit $y_{18}$,
the code bit $b_7$ to the symbol bit $y_{15}$,
the code bit $b_9$ to the symbol bit $y_{10}$,
the code bit $b_{11}$ to the symbol bit $y_{12}$,
the code bit $b_{13}$ to the symbol bit $y_{11}$,
the code bit $b_{15}$ to the symbol bit $y_{13}$,
the code bit $b_{17}$ to the symbol bit $y_{19}$, and
the code bit $b_{19}$ to the symbol bit $y_{17}$.

It is to be noted that, in FIG. 143, both of the replacement pattern of the code bits $b_0$, $b_2$, $b_4$, $b_6$, $b_8$, $b_{10}$, $b_{12}$, $b_{14}$, $b_{16}$ and $b_{18}$ and the replacement pattern of the code bits $b_1$, $b_3$, $b_5$, $b_7$, $b_9$, $b_{11}$, $b_{13}$, $b_{15}$, $b_{17}$ and $b_{19}$ coincide with the replacement pattern of the code bits $b_0$ to $b_9$ of A of FIG. 85.

FIG. 144 illustrates an example of replacement of code bits where the LDPC code is an LDPC code having a code length N of 16,200 bits and an encoding rate of 8/9 and besides the modulation method is 1024QAM and the multiple b is 2.

The replacement of code bits wherein the multiple b is 2 in FIG. 144 utilizes the replacement of code bits of A of FIG. 88 which is different only in that the multiple b is 1 as it is. Accordingly, the replacement of code bits of FIG. 144 complies with the allocation rule of FIG. 87.

Where the LDPC code is an LDPC code having a code length N of 16,200 bits and an encoding rate of 8/9 and besides the modulation method is 1024QAM and the multiple b is 2, in the demultiplexer 25, code bits written in the memory 31 for $(16{,}200/(10 \times 2)) \times (10 \times 2)$ bits in the column direction $\times$ row direction are read out in a unit of $10 \times 2$ (= mb) bits in the row direction and are supplied to the replacement section 32 (FIGS. 16 and 17).

The replacement section 32 replaces the $10 \times 2$ (= mb) code bits $b_0$ to $b_{19}$ read out from the memory 31 such that the $10 \times 2$ (= mb) code bits $b_0$ to $b_{19}$ are allocated, for example, to the $10 \times 2$ (= mb) symbol bits $y_0$ to $y_{19}$ of two successive (= b) symbols as seen in FIG. 144.

In particular, the replacement section 32 carries out replacement for allocating
the code bit $b_0$ to the symbol bit $y_8$,
the code bit $b_2$ to the symbol bit $y_0$,
the code bit $b_4$ to the symbol bit $y_1$,
the code bit $b_6$ to the symbol bit $y_2$,
the code bit $b_8$ to the symbol bit $y_3$,
the code bit $b_{10}$ to the symbol bit $y_4$,

the code bit $b_{12}$ to the symbol bit $y_6$,
the code bit $b_{14}$ to the symbol bit $y_5$,
the code bit $b_{16}$ to the symbol bit $y_9$,
the code bit $b_{18}$ to the symbol bit $y_7$,
the code bit $b_1$ to the symbol bit $y_{18}$,
the code bit $b_3$ to the symbol bit $y_{10}$,
the code bit $b_5$ to the symbol bit $y_{11}$,
the code bit $b_7$ to the symbol bit $y_{12}$,
the code bit $b_9$ to the symbol bit $y_{13}$,
the code bit $b_{11}$ to the symbol bit $y_{14}$,
the code bit $b_{13}$ to the symbol bit $y_{16}$,
the code bit $b_{15}$ to the symbol bit $y_{15}$,
the code bit $b_{17}$ to the symbol bit $y_{19}$, and
the code bit $b_{19}$ to the symbol bit $y_{17}$.

It is to be noted that, in FIG. 144, both of the replacement pattern of the code bits $b_0$, $b_2$, $b_4$, $b_6$, $b_8$, $b_{10}$, $b_{12}$, $b_{14}$, $b_{16}$ and $b_{18}$ and the replacement pattern of the code bits $b_1$, $b_3$, $b_5$, $b_7$, $b_9$, $b_{11}$, $b_{13}$, $b_{15}$, $b_{17}$ and $b_{19}$ coincide with the replacement pattern of the code bits $b_0$ to $b_9$ of A of FIG. 88.

FIG. 145 illustrates an example of replacement of code bits where the LDPC code is an LDPC code having a code length N of 64,800 bits and an encoding rate of 8/9 and besides the modulation method is 1024QAM and the multiple b is 2.

The replacement of code bits wherein the multiple b is 2 in FIG. 145 utilizes the replacement of code bits of A of FIG. 91 which is different only in that the multiple b is 1 as it is. Accordingly, the replacement of code bits of FIG. 145 complies with the allocation rule of FIG. 90.

Where the LDPC code is an LDPC code having a code length N of 64,800 bits and an encoding rate of 8/9 and besides the modulation method is 1024QAM and the multiple b is 2, in the demultiplexer 25, code bits written in the memory 31 for $(64{,}800/(10 \times 2)) \times (10 \times 2)$ bits in the column direction × row direction are read out in a unit of $10 \times 2$ (= mb) bits in the row direction and are supplied to the replacement section 32 (FIGS. 16 and 17).

The replacement section 32 replaces the $10 \times 2$ (= mb) code bits $b_0$ to $b_{19}$ read out from the memory 31 such that the $10 \times 2$ (= mb) code bits $b_0$ to $b_{19}$ are allocated, for example, to the $10 \times 2$ (= mb) symbol bits $y_0$ to $y_{19}$ of two successive (= b) symbols as seen in FIG. 145.

In particular, the replacement section 32 carries out replacement for allocating
the code bit $b_0$ to the symbol bit $y_8$,
the code bit $b_2$ to the symbol bit $y_0$,
the code bit $b_4$ to the symbol bit $y_1$,
the code bit $b_6$ to the symbol bit $y_2$,
the code bit $b_8$ to the symbol bit $y_3$,
the code bit $b_{10}$ to the symbol bit $y_4$,
the code bit $b_{12}$ to the symbol bit $y_6$,
the code bit $b_{14}$ to the symbol bit $y_5$,
the code bit $b_{16}$ to the symbol bit $y_9$,
the code bit $b_{18}$ to the symbol bit $y_7$,
the code bit $b_1$ to the symbol bit $y_{18}$,
the code bit $b_3$ to the symbol bit $y_{10}$,
the code bit $b_5$ to the symbol bit $y_{11}$,
the code bit $b_7$ to the symbol bit $y_{12}$,
the code bit $b_9$ to the symbol bit $y_{13}$,
the code bit $b_{11}$ to the symbol bit $y_{14}$,
the code bit $b_{13}$ to the symbol bit $y_{16}$,
the code bit $b_{15}$ to the symbol bit $y_{15}$,
the code bit $b_{17}$ to the symbol bit $y_{19}$, and
the code bit $b_{19}$ to the symbol bit $y_{17}$.

It is to be noted that, in FIG. 145, both of the replacement pattern of the code bits $b_0$, $b_2$, $b_4$, $b_6$, $b_8$, $b_{10}$, $b_{12}$, $b_{14}$, $b_{16}$ and $b_{18}$ and the replacement pattern of the code bits $b_1$, $b_3$, $b_5$, $b_7$, $b_9$, $b_{11}$, $b_{13}$, $b_{15}$, $b_{17}$ and $b_{19}$ coincide with the replacement pattern of the code bits $b_0$ to $b_9$ of A of FIG. 91.

FIG. 146 illustrates an example of replacement of code bits where the LDPC code is an LDPC code having a code length N of 64,800 bits and an encoding rate of 9/10 and besides the modulation method is 1024QAM and the multiple b is 2.

The replacement of code bits wherein the multiple b is 2 in FIG. 146 utilizes the replacement of code bits of A of FIG. 94 which is different only in that the multiple b is 1 as it is. Accordingly, the replacement of code bits of FIG. 146 complies with the allocation rule of FIG. 93.

Where the LDPC code is an LDPC code having a code length N of 64,800 bits and an encoding rate of 9/10 and besides the modulation method is 1024QAM and the multiple b is 2, in the demultiplexer 25, code bits written in the memory 31 for $(64,800/(10 \times 2)) \times (10 \times 2)$ bits in the column direction $\times$ row direction are read out in a unit of $10 \times 2$ (= mb) bits in the row direction and are supplied to the replacement section 32 (FIGS. 16 and 17).

The replacement section 32 replaces the $10 \times 2$ (= mb) code bits $b_0$ to $b_{19}$ read out from the memory 31 such that the $10 \times 2$ (= mb) code bits $b_0$ to $b_{19}$ are allocated, for example, to the $10 \times 2$ (= mb) symbol bits $y_0$ to $y_{19}$ of two successive (= b) symbols as seen in FIG. 146.

In particular, the replacement section 32 carries out replacement for allocating
the code bit $b_0$ to the symbol bit $y_8$,
the code bit $b_2$ to the symbol bit $y_0$,
the code bit $b_4$ to the symbol bit $y_1$,
the code bit $b_6$ to the symbol bit $y_2$,
the code bit $b_8$ to the symbol bit $y_3$,
the code bit $b_{10}$ to the symbol bit $y_4$,
the code bit $b_{12}$ to the symbol bit $y_6$,
the code bit $b_{14}$ to the symbol bit $y_5$,
the code bit $b_{16}$ to the symbol bit $y_9$,
the code bit $b_{18}$ to the symbol bit $y_7$,
the code bit $b_1$ to the symbol bit $y_{18}$,
the code bit $b_3$ to the symbol bit $y_{10}$,
the code bit $b_5$ to the symbol bit $y_{11}$,
the code bit $b_7$ to the symbol bit $y_{12}$,
the code bit $b_9$ to the symbol bit $y_{13}$,
the code bit $b_{11}$ to the symbol bit $y_{14}$,
the code bit $b_{13}$ to the symbol bit $y_{16}$,
the code bit $b_{15}$ to the symbol bit $y_{15}$,
the code bit $b_{17}$ to the symbol bit $y_{19}$, and
the code bit $b_{19}$ to the symbol bit $y_{17}$.

It is to be noted that, in FIG. 146, both of the replacement pattern of the code bits $b_0$, $b_2$, $b_4$, $b_6$, $b_8$, $b_{10}$, $b_{12}$, $b_{14}$, $b_{16}$ and $b_{18}$ and the replacement pattern of the code bits $b_1$, $b_3$, $b_5$, $b_7$, $b_9$, $b_{11}$, $b_{13}$, $b_{15}$, $b_{17}$ and $b_{19}$ coincide with the replacement pattern of the code bits $b_0$ to $b_9$ of A of FIG. 94.

FIG. 147 illustrates an example of replacement of code bits where the LDPC code is an LDPC code having a code length N of 16,200 bits and an encoding rate of 2/3 and besides the modulation method is 4096QAM and the multiple b is 2.

The replacement of code bits wherein the multiple b is 2 in FIG. 147 utilizes the replacement of code bits of A of FIG. 97 which is different only in that the multiple b is 1 as it is. Accordingly, the replacement of code bits of FIG. 147 complies with the allocation rule of FIG. 96.

Where the LDPC code is an LDPC code having a code length N of 16,200 bits and an encoding rate of 2/3 and besides the modulation method is 4096QAM and the multiple b is 2, in the demultiplexer 25, code bits written in the memory 31 for $(16,200/(12 \times 2)) \times (12 \times 2)$ bits in the column direction $\times$ row direction are read out in a unit of $12 \times 2$ (= mb) bits in the row direction and are supplied to the replacement section 32 (FIGS. 16 and 17).

The replacement section 32 replaces the $12 \times 2$ (= mb) code bits $b_0$ to $b_{23}$ read out from the memory 31 such that the $12 \times 2$ (= mb) code bits $b_0$ to $b_{23}$ are allocated, for example, to the $12 \times 2$ (= mb) symbol bits $y_0$ to $y_{23}$ of two successive (= b) symbols as seen in FIG. 147.

In particular, the replacement section 32 carries out replacement for allocating
the code bit $b_0$ to the symbol bit $y_{10}$,
the code bit $b_2$ to the symbol bit $y_0$,
the code bit $b_4$ to the symbol bit $y_1$,
the code bit $b_6$ to the symbol bit $y_2$,
the code bit $b_8$ to the symbol bit $y_3$,
the code bit $b_{10}$ to the symbol bit $y_4$,
the code bit $b_{12}$ to the symbol bit $y_5$,
the code bit $b_{14}$ to the symbol bit $y_6$,
the code bit $b_{16}$ to the symbol bit $y_8$,
the code bit $b_{18}$ to the symbol bit $y_7$,
the code bit $b_{20}$ to the symbol bit $y_{11}$,

the code bit $b_{22}$ to the symbol bit $y_9$,
the code bit $b_1$ to the symbol bit $y_{22}$,
the code bit $b_3$ to the symbol bit $y_{12}$,
the code bit $b_5$ to the symbol bit $y_{13}$,
the code bit $b_7$ to the symbol bit $y_{14}$,
the code bit $b_9$ to the symbol bit $y_{15}$,
the code bit $b_{11}$ to the symbol bit $y_{16}$,
the code bit $b_{13}$ to the symbol bit $y_{17}$,
the code bit $b_{15}$ to the symbol bit $y_{18}$,
the code bit $b_{17}$ to the symbol bit $y_{20}$,
the code bit $b_{19}$ to the symbol bit $y_{19}$,
the code bit $b_{21}$ to the symbol bit $y_{23}$, and
the code bit $b_{23}$ to the symbol bit $y_{21}$.

It is to be noted that, in FIG. 147, both of the replacement pattern of the code bits $b_0$, $b_2$, $b_4$, $b_6$, $b_8$, $b_{10}$, $b_{12}$, $b_{14}$, $b_{16}$, $b_{18}$, $b_{20}$, and $b_{22}$ and the replacement pattern of the code bits $b_1$, $b_3$, $b_5$, $b_7$, $b_9$, $b_{11}$, $b_{13}$, $b_{15}$, $b_{17}$, $b_{19}$, $b_{21}$ and $b_{23}$ coincide with the replacement pattern of the code bits $b_0$ to $b_{11}$ of A of FIG. 97.

FIG. 148 illustrates an example of replacement of code bits where the LDPC code is an LDPC code having a code length N of 64,800 bits and an encoding rate of 2/3 and besides the modulation method is 4096QAM and the multiple b is 2.

The replacement of code bits wherein the multiple b is 2 in FIG. 148 utilizes the replacement of code bits of A of FIG. 100 which is different only in that the multiple b is 1 as it is. Accordingly, the replacement of code bits of FIG. 148 complies with the allocation rule of FIG. 99.

Where the LDPC code is an LDPC code having a code length N of 64,800 bits and an encoding rate of 2/3 and besides the modulation method is 4096QAM and the multiple b is 2, in the demultiplexer 25, code bits written in the memory 31 for $(64,800/(12 \times 2)) \times (12 \times 2)$ bits in the column direction $\times$ row direction are read out in a unit of $12 \times 2$ (= mb) bits in the row direction and are supplied to the replacement section 32 (FIGS. 16 and 17).

The replacement section 32 replaces the $12 \times 2$ (= mb) code bits $b_0$ to $b_{23}$ read out from the memory 31 such that the $12 \times 2$ (= mb) code bits $b_0$ to $b_{23}$ are allocated, for example, to the $12 \times 2$ (= mb) symbol bits $y_0$ to $y_{23}$ of two successive (= b) symbols as seen in FIG. 148.

In particular, the replacement section 32 carries out replacement for allocating
the code bit $b_0$ to the symbol bit $y_{10}$,
the code bit $b_2$ to the symbol bit $y_0$,
the code bit $b_4$ to the symbol bit $y_1$,
the code bit $b_6$ to the symbol bit $y_2$,
the code bit $b_8$ to the symbol bit $y_3$,
the code bit $b_{10}$ to the symbol bit $y_4$,
the code bit $b_{12}$ to the symbol bit $y_5$,
the code bit $b_{14}$ to the symbol bit $y_6$,
the code bit $b_{16}$ to the symbol bit $y_8$,
the code bit $b_{18}$ to the symbol bit $y_7$,
the code bit $b_{20}$ to the symbol bit $y_{11}$,
the code bit $b_{22}$ to the symbol bit $y_9$,
the code bit $b_1$ to the symbol bit $y_{22}$,
the code bit $b_3$ to the symbol bit $y_{12}$,
the code bit $b_5$ to the symbol bit $y_{13}$,
the code bit $b_7$ to the symbol bit $y_{14}$,
the code bit $b_9$ to the symbol bit $y_{15}$,
the code bit $b_{11}$ to the symbol bit $y_{16}$,
the code bit $b_{13}$ to the symbol bit $y_{17}$,
the code bit $b_{15}$ to the symbol bit $y_{18}$,
the code bit $b_{17}$ to the symbol bit $y_{20}$,
the code bit $b_{19}$ to the symbol bit $y_{19}$,
the code bit $b_{21}$ to the symbol bit $y_{23}$, and
the code bit $b_{23}$ to the symbol bit $y_{21}$.

It is to be noted that, in FIG. 148, both of the replacement pattern of the code bits $b_0$, $b_2$, $b_4$, $b_6$, $b_8$, $b_{10}$, $b_{12}$, $b_{14}$, $b_{16}$, $b_{18}$, $b_{20}$, and $b_{22}$ and the replacement pattern of the code bits $b_1$, $b_3$, $b_5$, $b_7$, $b_9$, $b_{11}$, $b_{13}$, $b_{15}$, $b_{17}$, $b_{19}$, $b_{21}$ and $b_{23}$ coincide with the replacement pattern of the code bits $b_0$ to $b_{11}$ of A of FIG. 100.

FIG. 149 illustrates an example of replacement of code bits where the LDPC code is an LDPC code having a code length N of 16,200 bits and an encoding rate of 3/4 and besides the modulation method is 4096QAM and the multiple b is 2.

The replacement of code bits wherein the multiple b is 2 in FIG. 149 utilizes the replacement of code bits of A of FIG. 103 which is different only in that the multiple b is 1 as it is. Accordingly, the replacement of code bits of FIG. 149 complies with the allocation rule of FIG. 102.

Where the LDPC code is an LDPC code having a code length N of 16,200 bits and an encoding rate of 3/4 and besides the modulation method is 4096QAM and the multiple b is 2, in the demultiplexer 25, code bits written in the memory 31 for (16,200/(12 $\times$ 2)) $\times$ (12 $\times$ 2) bits in the column direction $\times$ row direction are read out in a unit of 12 $\times$ 2 (= mb) bits in the row direction and are supplied to the replacement section 32 (FIGS. 16 and 17).

The replacement section 32 replaces the 12 $\times$ 2 (= mb) code bits $b_0$ to $b_{23}$ read out from the memory 31 such that the 12 $\times$ 2 (= mb) code bits $b_0$ to $b_{23}$ are allocated, for example, to the 12 $\times$ 2 (= mb) symbol bits $y_0$ to $y_{23}$ of two successive (= b) symbols as seen in FIG. 149.

In particular, the replacement section 32 carries out replacement for allocating
the code bit $b_0$ to the symbol bit $y_8$,
the code bit $b_2$ to the symbol bit $y_0$,
the code bit $b_4$ to the symbol bit $y_6$,
the code bit $b_6$ to the symbol bit $y_1$,
the code bit $b_8$ to the symbol bit $y_4$,
the code bit $b_{10}$ to the symbol bit $y_5$,
the code bit $b_{12}$ to the symbol bit $y_2$,
the code bit $b_{14}$ to the symbol bit $y_3$,
the code bit $b_{16}$ to the symbol bit $y_7$,
the code bit $b_{18}$ to the symbol bit $y_{10}$,
the code bit $b_{20}$ to the symbol bit $y_{11}$,
the code bit $b_{22}$ to the symbol bit $y_9$,
the code bit $b_1$ to the symbol bit $y_{20}$,
the code bit $b_3$ to the symbol bit $y_{12}$,
the code bit $b_5$ to the symbol bit $y_{18}$,
the code bit $b_7$ to the symbol bit $y_{13}$,
the code bit $b_9$ to the symbol bit $y_{16}$,
the code bit $b_{11}$ to the symbol bit $y_{17}$,
the code bit $b_{13}$ to the symbol bit $y_{14}$,
the code bit $b_{15}$ to the symbol bit $y_{15}$,
the code bit $b_{17}$ to the symbol bit $y_{19}$,
the code bit $b_{19}$ to the symbol bit $y_{22}$,
the code bit $b_{21}$ to the symbol bit $y_{23}$, and
the code bit $b_{23}$ to the symbol bit $y_{21}$.

It is to be noted that, in FIG. 149, both of the replacement pattern of the code bits $b_0$, $b_2$, $b_4$, $b_6$, $b_8$, $b_{10}$, $b_{12}$, $b_{14}$, $b_{16}$, $b_{18}$, $b_{20}$, and $b_{22}$ and the replacement pattern of the code bits $b_1$, $b_3$, $b_5$, $b_7$, $b_9$, $b_{11}$, $b_{13}$, $b_{15}$, $b_{17}$, $b_{19}$, $b_{21}$ and $b_{23}$ coincide with the replacement pattern of the code bits $b_1$ to $b_{11}$ of A of FIG. 103.

FIG. 150 illustrates an example of replacement of code bits where the LDPC code is an LDPC code having a code length N of 64,800 bits and an encoding rate of 3/4 and besides the modulation method is 4096QAM and the multiple b is 2.

The replacement of code bits wherein the multiple b is 2 in FIG. 150 utilizes the replacement of code bits of A of FIG. 106 which is different only in that the multiple b is 1 as it is. Accordingly, the replacement of code bits of FIG. 150 complies with the allocation rule of FIG. 105.

Where the LDPC code is an LDPC code having a code length N of 64,800 bits and an encoding rate of 3/4 and besides the modulation method is 1024QAM and the multiple b is 2, in the demultiplexer 25, code bits written in the memory 31 for (64,800/(12 $\times$ 2)) $\times$ (12 $\times$ 2) bits in the column direction $\times$ row direction are read out in a unit of 12 $\times$ 2 (= mb) bits in the row direction and are supplied to the replacement section 32 (FIGS. 16 and 17).

The replacement section 32 replaces the 12 $\times$ 2 (= mb) code bits $b_0$ to $b_{23}$ read out from the memory 31 such that the 12 $\times$ 2 (= mb) code bits $b_0$ to $b_{23}$ are allocated, for example, to the 12 $\times$ 2 (= mb) symbol bits $y_0$ to $y_{23}$ of two successive (= b) symbols as seen in FIG. 150.

In particular, the replacement section 32 carries out replacement for allocating
the code bit $b_0$ to the symbol bit $y_8$,
the code bit $b_2$ to the symbol bit $y_0$, the code bit $b_4$ to the symbol bit $y_6$,
the code bit $b_6$ to the symbol bit $y_1$,
the code bit $b_8$ to the symbol bit $y_4$,

the code bit $b_{10}$ to the symbol bit $y_5$,
the code bit $b_{12}$ to the symbol bit $y_2$,
the code bit $b_{14}$ to the symbol bit $y_3$,
the code bit $b_{16}$ to the symbol bit $y_7$,
the code bit $b_{18}$ to the symbol bit $y_{10}$,
the code bit $b_{20}$ to the symbol bit $y_{11}$,
the code bit $b_{22}$ to the symbol bit $y_9$,
the code bit $b_1$ to the symbol bit $y_{20}$,
the code bit $b_3$ to the symbol bit $y_{12}$,
the code bit $b_5$ to the symbol bit $y_{18}$,
the code bit $b_7$ to the symbol bit $y_{13}$, the code bit $b_9$ to the symbol bit $y_{16}$,
the code bit $b_{11}$ to the symbol bit $y_{17}$,
the code bit $b_{13}$ to the symbol bit $y_{14}$,
the code bit $b_{15}$ to the symbol bit $y_{15}$,
the code bit $b_{17}$ to the symbol bit $y_{19}$,
the code bit $b_{19}$ to the symbol bit $y_{22}$,
the code bit $b_{21}$ to the symbol bit $y_{23}$, and
the code bit $b_{23}$ to the symbol bit $y_{21}$.

It is to be noted that, in FIG. 150, both of the replacement pattern of the code bits $b_0$, $b_2$, $b_4$, $b_6$, $b_8$, $b_{10}$, $b_{12}$, $b_{14}$, $b_{16}$, $b_{18}$, $b_{20}$, and $b_{22}$ and the replacement pattern of the code bits $b_1$, $b_3$, $b_5$, $b_7$, $b_9$, $b_{11}$, $b_{13}$, $b_{15}$, $b_{17}$, $b_{19}$, $b_{21}$ and $b_{23}$ coincide with the replacement pattern of the code bits $b_0$ to $b_{11}$ of A of FIG. 106.

FIG. 151 illustrates an example of replacement of code bits where the LDPC code is an LDPC code having a code length N of 16,200 bits and an encoding rate of 4/5 and besides the modulation method is 4096QAM and the multiple b is 2.

The replacement of code bits wherein the multiple b is 2 in FIG. 151 utilizes the replacement of code bits of A of FIG. 109 which is different only in that the multiple b is 1 as it is. Accordingly, the replacement of code bits of FIG. 151 complies with the allocation rule of FIG. 108.

Where the LDPC code is an LDPC code having a code length N of 16,200 bits and an encoding rate of 4/5 and besides the modulation method is 4096QAM and the multiple b is 2, in the demultiplexer 25, code bits written in the memory 31 for $(16,200/(12 \times 2)) \times (12 \times 2)$ bits in the column direction × row direction are read out in a unit of $12 \times 2$ (= mb) bits in the row direction and are supplied to the replacement section 32 (FIGS. 16 and 17).

The replacement section 32 replaces the $12 \times 2$ (= mb) code bits $b_0$ to $b_{23}$ read out from the memory 31 such that the $12 \times 2$ (= mb) code bits $b_0$ to $b_{23}$ are allocated, for example, to the $12 \times 2$ (= mb) symbol bits $y_0$ to $y_{23}$ of two successive (= b) symbols as seen in FIG. 151.

In particular, the replacement section 32 carries out replacement for allocating
the code bit $b_0$ to the symbol bit $y_8$,
the code bit $b_2$ to the symbol bit $y_0$,
the code bit $b_4$ to the symbol bit $y_6$,
the code bit $b_6$ to the symbol bit $y_1$,
the code bit $b_8$ to the symbol bit $y_4$,
the code bit $b_{10}$ to the symbol bit $y_5$,
the code bit $b_{12}$ to the symbol bit $y_2$,
the code bit $b_{14}$ to the symbol bit $y_3$,
the code bit $b_{16}$ to the symbol bit $y_7$,
the code bit $b_{18}$ to the symbol bit $y_{10}$,
the code bit $b_{20}$ to the symbol bit $y_{11}$,
the code bit $b_{22}$ to the symbol bit $y_9$,
the code bit $b_1$ to the symbol bit $y_{20}$,
the code bit $b_3$ to the symbol bit $y_{12}$,
the code bit $b_5$ to the symbol bit $y_{18}$,
the code bit $b_7$ to the symbol bit $y_{13}$,
the code bit $b_9$ to the symbol bit $y_{16}$,
the code bit $b_{11}$ to the symbol bit $y_{17}$,
the code bit $b_{13}$ to the symbol bit $y_{14}$,
the code bit $b_{15}$ to the symbol bit $y_{15}$,
the code bit $b_{17}$ to the symbol bit $y_{19}$,
the code bit $b_{19}$ to the symbol bit $y_{22}$,
the code bit $b_{21}$ to the symbol bit $y_{23}$, and

the code bit $b_{23}$ to the symbol bit $y_{21}$.

It is to be noted that, in FIG. 151, both of the replacement pattern of the code bits $b_0$, $b_2$, $b_4$, $b_6$, $b_8$, $b_{10}$, $b_{12}$, $b_{14}$, $b_{16}$, $b_{18}$, $b_{20}$, and $b_{22}$ and the replacement pattern of the code bits $b_1$, $b_3$, $b_5$, $b_7$, $b_9$, $b_{11}$, $b_{13}$, $b_{15}$, $b_{17}$, $b_{19}$, $b_{21}$ and $b_{23}$ coincide with the replacement pattern of the code bits $b_0$ to $b_{11}$ of A of FIG. 109.

FIG. 152 illustrates an example of replacement of code bits where the LDPC code is an LDPC code having a code length N of 64,800 bits and an encoding rate of 4/5 and besides the modulation method is 4096QAM and the multiple b is 2.

The replacement of code bits wherein the multiple b is 2 in FIG. 152 utilizes the replacement of code bits of A of FIG. 112 which is different only in that the multiple b is 1 as it is. Accordingly, the replacement of code bits of FIG. 152 complies with the allocation rule of FIG. 111.

Where the LDPC code is an LDPC code having a code length N of 64,800 bits and an encoding rate of 4/5 and besides the modulation method is 4096QAM and the multiple b is 2, in the demultiplexer 25, code bits written in the memory 31 for (64,800/(12 × 2)) × (12 × 2) bits in the column direction × row direction are read out in a unit of 12 × 2 (= mb) bits in the row direction and are supplied to the replacement section 32 (FIGS. 16 and 17).

The replacement section 32 replaces the 12 × 2 (= mb) code bits $b_0$ to $b_{23}$ read out from the memory 31 such that the 12 × 2 (= mb) code bits $b_0$ to $b_{23}$ are allocated, for example, to the 12 × 2 (= mb) symbol bits $y_0$ to $y_{23}$ of two successive (= b) symbols as seen in FIG. 152.

In particular, the replacement section 32 carries out replacement for allocating
the code bit $b_0$ to the symbol bit $y_8$,
the code bit $b_2$ to the symbol bit $y_0$,
the code bit $b_4$ to the symbol bit $y_6$,
the code bit $b_6$ to the symbol bit $y_1$,
the code bit $b_8$ to the symbol bit $y_4$,
the code bit $b_{10}$ to the symbol bit $y_5$,
the code bit $b_{12}$ to the symbol bit $y_2$,
the code bit $b_{14}$ to the symbol bit $y_3$,
the code bit $b_{16}$ to the symbol bit $y_7$,
the code bit $b_{18}$ to the symbol bit $y_{10}$,
the code bit $b_{20}$ to the symbol bit $y_{11}$,
the code bit $b_{22}$ to the symbol bit $y_9$,
the code bit $b_1$ to the symbol bit $y_{20}$,
the code bit $b_3$ to the symbol bit $y_{12}$,
the code bit $b_5$ to the symbol bit $y_{18}$,
the code bit $b_7$ to the symbol bit $y_{13}$,
the code bit $b_9$ to the symbol bit $y_{16}$,
the code bit $b_{11}$ to the symbol bit $y_{17}$,
the code bit $b_{13}$ to the symbol bit $y_{14}$,
the code bit $b_{15}$ to the symbol bit $y_{15}$,
the code bit $b_{17}$ to the symbol bit $y_{19}$,
the code bit $b_{19}$ to the symbol bit $y_{22}$,
the code bit $b_{21}$ to the symbol bit $y_{23}$, and
the code bit $b_{23}$ to the symbol bit $y_{21}$.

It is to be noted that, in FIG. 152, both of the replacement pattern of the code bits $b_0$, $b_2$, $b_4$, $b_6$, $b_8$, $b_{10}$, $b_{12}$, $b_{14}$, $b_{16}$, $b_{18}$, $b_{20}$, and $b_{22}$ and the replacement pattern of the code bits $b_1$, $b_3$, $b_5$, $b_7$, $b_9$, $b_{11}$, $b_{13}$, $b_{15}$, $b_{17}$, $b_{19}$, $b_{21}$ and $b_{23}$ coincide with the replacement pattern of the code bits $b_0$ to $b_{11}$ of A of FIG. 112.

FIG. 153 illustrates an example of replacement of code bits where the LDPC code is an LDPC code having a code length N of 16,200 bits and an encoding rate of 5/6 and besides the modulation method is 4096QAM and the multiple b is 2.

The replacement of code bits wherein the multiple b is 2 in FIG. 153 utilizes the replacement of code bits of A of FIG. 115 which is different only in that the multiple b is 1 as it is. Accordingly, the replacement of code bits of FIG. 153 complies with the allocation rule of FIG. 114.

Where the LDPC code is an LDPC code having a code length N of 16,200 bits and an encoding rate of 5/6 and besides the modulation method is 4096QAM and the multiple b is 2, in the demultiplexer 25, code bits written in the memory 31 for (16,200/(12 × 2)) × (12 × 2) bits in the column direction × row direction are read out in a unit of 12 × 2 (= mb) bits in the row direction and are supplied to the replacement section 32 (FIGS. 16 and 17).

The replacement section 32 replaces the 12 × 2 (= mb) code bits $b_0$ to $b_{23}$ read out from the memory 31 such that the 12 × 2 (= mb) code bits $b_0$ to $b_{23}$ are allocated, for example, to the 12 × 2 (= mb) symbol bits $y_0$ to $y_{23}$ of two successive (= b) symbols as seen in FIG. 153.

In particular, the replacement section 32 carries out replacement for allocating
the code bit $b_0$ to the symbol bit $y_8$,
the code bit $b_2$ to the symbol bit $y_0$,
the code bit $b_4$ to the symbol bit $y_6$,
the code bit $b_6$ to the symbol bit $y_1$,
the code bit $b_8$ to the symbol bit $y_4$,
the code bit $b_{10}$ to the symbol bit $y_5$,
the code bit $b_{12}$ to the symbol bit $y_2$,
the code bit $b_{14}$ to the symbol bit $y_3$,
the code bit $b_{16}$ to the symbol bit $y_7$,
the code bit $b_{18}$ to the symbol bit $y_{10}$,
the code bit $b_{20}$ to the symbol bit $y_{11}$,
the code bit $b_{22}$ to the symbol bit $y_9$,
the code bit $b_1$ to the symbol bit $y_{20}$,
the code bit $b_3$ to the symbol bit $y_{12}$,
the code bit $b_5$ to the symbol bit $y_{18}$,
the code bit $b_7$ to the symbol bit $y_{13}$,
the code bit $b_9$ to the symbol bit $y_{16}$,
the code bit $b_{11}$ to the symbol bit $y_{17}$,
the code bit $b_{13}$ to the symbol bit $y_{14}$,
the code bit $b_{15}$ to the symbol bit $y_{15}$,
the code bit $b_{17}$ to the symbol bit $y_{19}$,
the code bit $b_{19}$ to the symbol bit $y_{22}$,
the code bit $b_{21}$ to the symbol bit $y_{23}$, and
the code bit $b_{23}$ to the symbol bit $y_{21}$.

It is to be noted that, in FIG. 153, both of the replacement pattern of the code bits $b_0$, $b_2$, $b_4$, $b_6$, $b_8$, $b_{10}$, $b_{12}$, $b_{14}$, $b_{16}$, $b_{18}$, $b_{20}$, and $b_{22}$ and the replacement pattern of the code bits $b_1$, $b_3$, $b_5$, $b_7$, $b_9$, $b_{11}$, $b_{13}$, $b_{15}$, $b_{17}$, $b_{19}$, $b_{21}$ and $b_{23}$ coincide with the replacement pattern of the code bits $b_0$ to $b_{11}$ of A of FIG. 115.

FIG. 154 illustrates an example of replacement of code bits where the LDPC code is an LDPC code having a code length N of 64,800 bits and an encoding rate of 5/6 and besides the modulation method is 4096QAM and the multiple b is 2.

The replacement of code bits wherein the multiple b is 2 in FIG. 154 utilizes the replacement of code bits of A of FIG. 118 which is different only in that the multiple b is 1 as it is. Accordingly, the replacement of code bits of FIG. 154 complies with the allocation rule of FIG. 117.

Where the LDPC code is an LDPC code having a code length N of 64,800 bits and an encoding rate of 5/6 and besides the modulation method is 4096QAM and the multiple b is 2, in the demultiplexer 25, code bits written in he memory 31 for $(64{,}800/(12 \times 2)) \times (12 \times 2)$ bits in the column direction $\times$ row direction are read out in a unit of $12 \times 2$ (= mb) bits in the row direction and are supplied to the replacement section 32 (FIGS. 16 and 17).

The replacement section 32 replaces the $12 \times 2$ (= mb) code bits $b_0$ to $b_{23}$ read out from the memory 31 such that the $12 \times 2$ (= mb) code bits $b_0$ to $b_{23}$ are allocated, for example, to the $12 \times 2$ (= mb) symbol bits $y_0$ to $y_{23}$ of two successive (= b) symbols as seen in FIG. 154.

In particular, the replacement section 32 carries out replacement for allocating
the code bit $b_0$ to the symbol bit $y_8$,
the code bit $b_2$ to the symbol bit $y_0$,
the code bit $b_4$ to the symbol bit $y_6$,
the code bit $b_6$ to the symbol bit $y_1$,
the code bit $b_8$ to the symbol bit $y_4$,
the code bit $b_{10}$ to the symbol bit $y_5$,
the code bit $b_{12}$ to the symbol bit $y_2$,
the code bit $b_{14}$ to the symbol bit $y_3$,
the code bit $b_{16}$ to the symbol bit $y_7$,
the code bit $b_{18}$ to the symbol bit $y_{10}$,
the code bit $b_{20}$ to the symbol bit $y_{11}$,
the code bit $b_{22}$ to the symbol bit $y_9$,
the code bit $b_1$ to the symbol bit $y_{20}$,
the code bit $b_3$ to the symbol bit $y_{12}$,
the code bit $b_5$ to the symbol bit $y_{18}$,
the code bit $b_7$ to the symbol bit $y_{13}$,

the code bit $b_9$ to the symbol bit $y_{16}$,
the code bit $b_{11}$ to the symbol bit $y_{17}$,
the code bit $b_{13}$ to the symbol bit $y_{14}$,
the code bit $b_{15}$ to the symbol bit $y_{15}$,
the code bit $b_{17}$ to the symbol bit $y_{19}$,
the code bit $b_{19}$ to the symbol bit $y_{22}$,
the code bit $b_{21}$ to the symbol bit $y_{23}$, and
the code bit $b_{23}$ to the symbols bit $y_{21}$.

It is to be noted that, in FIG. 154, both of the replacement pattern of the code bits $b_0$, $b_2$, $b_4$, $b_6$, $b_8$, $b_{10}$, $b_{12}$, $b_{14}$, $b_{16}$, $b_{18}$, $b_{20}$, and $b_{22}$ and the replacement pattern of the code bits $b_1$, $b_3$, $b_5$, $b_7$, $b_9$, $b_{11}$, $b_{13}$, $b_{15}$, $b_{17}$, $b_{19}$, $b_{21}$ and $b_{23}$ coincide with the replacement pattern of the code bits $b_0$ to $b_{11}$ of A of FIG. 118.

FIG. 155 illustrates an example of replacement of code bits where the LDPC code is an LDPC code having a code length N of 16,200 bits and an encoding rate of 8/9 and besides the modulation method is 4096QAM and the multiple b is 2.

The replacement of code bits wherein the multiple b is 2 in FIG. 155 utilizes the replacement of code bits of A of FIG. 121 which is different only in that the multiple b is 1 as it is. Accordingly, the replacement of code bits of FIG. 155 complies with the allocation rule of FIG. 120.

Where the LDPC code is an LDPC code having a code length N of 16,200 bits and an encoding rate of 8/9 and besides the modulation method is 4096QAM and the multiple b is 2, in the demultiplexer 25, code bits written in the memory 31 for $(16,200/(12 \times 2)) \times (12 \times 2)$ bits in the column direction $\times$ row direction are read out in a unit of $12 \times 2$ (= mb) bits in the row direction and are supplied to the replacement section 32 (FIGS. 16 and 17).

The replacement section 32 replaces the $12 \times 2$ (= mb) code bits $b_0$ to $b_{23}$ read out from the memory 31 such that the $12 \times 2$ (= mb) code bits $b_0$ to $b_{23}$ are allocated, for example, to the $12 \times 2$ (= mb) symbol bits $y_0$ to $y_{23}$ of two successive (= b) symbols as seen in FIG. 155.

In particular, the replacement section 32 carries out replacement for allocating
the code bit $b_0$ to the symbol bit $y_{10}$,
the code bit $b_2$ to the symbol bit $y_0$,
the code bit $b_4$ to the symbol bit $y_1$,
the code bit $b_6$ to the symbol bit $y_2$,
the code bit $b_8$ to the symbol bit $y_3$,
the code bit $b_{10}$ to the symbol bit $y_4$,
the code bit $b_{12}$ to the symbol bit $y_5$,
the code bit $b_{14}$ to the symbol bit $y_6$,
the code bit $b_{16}$ to the symbol bit $y_8$,
the code bit $b_{18}$ to the symbol bit $y_7$,
the code bit $b_{20}$ to the symbol bit $y_{11}$,
the code bit $b_{22}$ to the symbol bit $y_9$,
the code bit $b_1$ to the symbol bit $y_{22}$,
the code bit $b_3$ to the symbol bit $y_{12}$,
the code bit $b_5$ to the symbol bit $y_{13}$,
the code bit $b_7$ to the symbol bit $y_{14}$,
the code bit $b_9$ to the symbol bit $y_{15}$,
the code bit $b_{11}$ to the symbol bit $y_{16}$,
the code bit $b_{13}$ to the symbol bit $y_{17}$,
the code bit $b_{15}$ to the symbol bit $y_{18}$,
the code bit $b_{17}$ to the symbol bit $y_{20}$,
the code bit $b_{19}$ to the symbol bit $y_{19}$,
the code bit $b_{21}$ to the symbol bit $y_{23}$, and
the code bit $b_{23}$ to the symbol bit $y_{21}$.

It is to be noted that, in FIG. 155, both of the replacement pattern of the code bits $b_0$, $b_2$, $b_4$, $b_6$, $b_8$, $b_{10}$, $b_{12}$, $b_{14}$, $b_{16}$, $b_{18}$, $b_{20}$, and $b_{22}$ and the replacement pattern of the code bits $b_1$, $b_3$, $b_5$, $b_7$, $b_9$, $b_{11}$, $b_{13}$, $b_{15}$, $b_{17}$, $b_{19}$, $b_{21}$ and $b_{23}$ coincide with the replacement pattern of the code bits $b_0$ to $b_{11}$ of A of FIG. 121.

FIG. 156 illustrates an example of replacement of code bits where the LDPC code is an LDPC code having a code length N of 64,800 bits and an encoding rate of 8/9 and besides the modulation method is 4096QAM and the multiple b is 2.

The replacement of code bits wherein the multiple b is 2 in FIG. 156 utilizes the replacement of code bits of A of FIG. 124 which is different only in that the multiple b is 1 as it is. Accordingly, the replacement of code bits of FIG. 156 complies with the allocation rule of FIG. 123.

Where the LDPC code is an LDPC code having a code length N of 64,800 bits and an encoding rate of 8/9 and besides the modulation method is 4096QAM and the multiple b is 2, in the demultiplexer 25, code bits written in the memory 31 for (64,800/(12 × 2)) × (12 × 2) bits in the column direction × row direction are read out in a unit of 12 × 2 (= mb) bits in the row direction and are supplied to the replacement section 32 (FIGS. 16 and 17).

The replacement section 32 replaces the 12 × 2 (= mb) code bits $b_0$ to $b_{23}$ read out from the memory 31 such that the 12 × 2 (= mb) code bits $b_0$ to $b_{23}$ are allocated, for example, to the 12 × 2 (= mb) symbol bits $y_0$ to $y_{23}$ of two successive (= b) symbols as seen in FIG. 156.

In particular, the replacement section 32 carries out replacement for allocating
the code bit $b_0$ to the symbol bit $y_{10}$,
the code bit $b_2$ to the symbol bit $y_0$,

the code bit $b_4$ to the symbol bit $y_1$,
the code bit $b_6$ to the symbol bit $y_2$,
the code bit $b_8$ to the symbol bit $y_3$,
the code bit $b_{10}$ to the symbol bit $y_4$,
the code bit $b_{12}$ to the symbol bit $y_5$,
the code bit $b_{14}$ to the symbol bit $y_6$,
the code bit $b_{16}$ to the symbol bit $y_8$,
the code bit $b_{18}$ to the symbol bit $y_7$,
the code bit $b_{20}$ to the symbol bit $y_{11}$,
the code bit $b_{22}$ to the symbol bit $y_9$,
the code bit $b_1$ to the symbol bit $y_{22}$,
the code bit $b_3$ to the symbol bit $y_{12}$,
the code bit $b_5$ to the symbol bit $y_{13}$,
the code bit $b_7$ to the symbol bit $y_{14}$,
the code bit $b_9$ to the symbol bit $y_{15}$,
the code bit $b_{11}$ to the symbol bit $y_{16}$,
the code bit $b_{13}$ to the symbol bit $y_{17}$,
the code bit $b_{15}$ to the symbol bit $y_{18}$,
the code bit $b_{17}$ to the symbol bit $y_{20}$,
the code bit $b_{19}$ to the symbol bit $y_{19}$,
the code bit $b_{21}$ to the symbol bit $y_{23}$, and
the code bit $b_{23}$ to the symbol bit $y_{21}$.

It is to be noted that, in FIG. 156, both of the replacement pattern of the code bits $b_0$, $b_2$, $b_4$, $b_6$, $b_8$, $b_{10}$, $b_{12}$, $b_{14}$, $b_{16}$, $b_{18}$, $b_{20}$, and $b_{22}$ and the replacement pattern of the code bits $b_1$, $b_3$, $b_5$, $b_7$, $b_9$, $b_{11}$, $b_{13}$, $b_{15}$, $b_{17}$, $b_{19}$, $b_{21}$ and $b_{23}$ coincide with the replacement pattern of the code bits $b_0$ to $b_{11}$ of A of FIG. 124.

FIG. 157 illustrates an example of replacement of code bits where the LDPC code is an LDPC code having a code length N of 64,800 bits and an encoding rate of 9/10 and besides the modulation method is 4096QAM and the multiple b is 2.

The replacement of code bits wherein the multiple b is 2 in FIG. 157 utilizes the replacement of code bits of A of FIG. 127 which is different only in that the multiple b is 1 as it is. Accordingly, the replacement of code bits of FIG. 157 complies with the allocation rule of FIG. 126.

Where the LDPC code is an LDPC code having a code length N of 64,800 bits and an encoding rate of 9/10 and besides the modulation method is 4096QAM and the multiple b is 2, in the demultiplexer 25, code bits written in the memory 31 for (64,800/(12 × 2)) × (12 × 2) bits in the column direction × row direction are read out in a unit of 12 × 2 (= mb) bits in the row direction and are supplied to the replacement section 32 (FIGS. 16 and 17).

The replacement section 32 replaces the 12 × 2 (= mb) code bits $b_0$ to $b_{23}$ read out from the memory 31 such that the 12 × 2 (= mb) code bits $b_0$ to $b_{23}$ are allocated, for example, to the 12 × 2 (= mb) symbol bits $y_0$ to $y_{23}$ of two successive (= b) symbols as seen in FIG. 157.

In particular, the replacement section 32 carries out replacement for allocating
the code bit $b_0$ to the symbol bit $y_{10}$,
the code bit $b_2$ to the symbol bit $y_0$,
the code bit $b_4$ to the symbol bit $y_1$,
the code bit $b_6$ to the symbol bit $y_2$,
the code bit $b_8$ to the symbol bit $y_3$,
the code bit $b_{10}$ to the symbol bit $y_4$,
the code bit $b_{12}$ to the symbol bit $y_5$,
the code bit $b_{14}$ to the symbol bit $y_6$,

the code bit $b_{16}$ to the symbol bit $y_8$,
the code bit $b_{18}$ to the symbol bit $y_7$,
the code bit $b_{20}$ to the symbol bit $y_{11}$,
the code bit $b_{22}$ to the symbol bit $y_9$,
the code bit $b_1$ to the symbol bit $y_{22}$,
the code bit $b_3$ to the symbol bit $y_{12}$,
the code bit $b_5$ to the symbol bit $y_{13}$,
the code bit $b_7$ to the symbol bit $y_{14}$,
the code bit $b_9$ to the symbol bit $y_{15}$,
the code bit $b_{11}$ to the symbol bit $y_{16}$,
the code bit $b_{13}$ to the symbol bit $y_{17}$,
the code bit $b_{15}$ to the symbol bit $y_{18}$,
the code bit $b_{17}$ to the symbol bit $y_{20}$,
the code bit $b_{19}$ to the symbol bit $y_{19}$,
the code bit $b_{21}$ to the symbol bit $y_{23}$, and
the code bit $b_{23}$ to the symbol bit $y_{21}$.

It is to be noted that, in FIG. 157, both of the replacement pattern of the code bits $b_0$, $b_2$, $b_4$, $b_6$, $b_8$, $b_{10}$, $b_{12}$, $b_{14}$, $b_{16}$, $b_{18}$, $b_{20}$, and $b_{22}$ and the replacement pattern of the code bits $b_1$, $b_3$, $b_5$, $b_7$, $b_9$, $b_{11}$, $b_{13}$, $b_{15}$, $b_{17}$, $b_{19}$, $b_{21}$ and $b_{23}$ coincide with the replacement pattern of the code bits $b_0$ to $b_{11}$ of A of FIG. 127.

FIGS. 158 to 161 illustrate results of simulations of the BER obtained by carrying out a replacement process of the new replacement method wherein replacement where the multiple b is 2 is carried out utilizing the replacement where the multiple b is 1 described hereinabove with reference to FIGS. 136 to 157.

In particular, FIG. 158 illustrates the BER where LDPC codes having a code length N of 16,200 and having encoding rates of 2/3, 3/4, 3/5, 5/6 and 8/9 are determined as an object and 1024QAM are adopted as the modulation method.

FIG. 159 illustrates the BER where LDPC codes having a code length N of 64,800 and having encoding rates of 2/3, 3/4, 3/5, 5/6, 8/9 and 9/10 are determined as an object and 1024QAM are adopted as the modulation method.

FIG. 160 illustrates the BER where LDPC codes having a code length N of 16,200 and having encoding rates of 2/3, 3/4, 3/5, 5/6 and 8/9 are determined as an object and 4096QAM are adopted as the modulation method.

FIG. 161 illustrates the BER where LDPC codes having a code length N of 64,800 and having encoding rates of 2/3, 3/4, 3/5, 5/6, 8/9 and 9/10 are determined as an object and 4096QAM are adopted as the modulation method.

In FIGS. 158 to 161, the axis of abscissa indicates $E_s/N_0$, and the axis of ordinate indicates the BER similarly to those in FIGS. 130 to 133. Further, a solid line represents the BER where a replacement process of the new replacement method is carried out and a broken line represents the BER where no replacement process is carried out.

From FIGS. 158 to 161, it can be recognized that the replacement process of the new replacement method exhibits an improved BER and an improved tolerance to errors in comparison with an alternative case wherein the replacement process is not carried out.

FIG. 162 is a block diagram showing an example of a configuration of the reception apparatus 12 of FIG. 7.

Referring to FIG. 162, the reception apparatus 12 is a data processing apparatus for receiving a modulation signal from the transmission apparatus 11 (FIG. 7) and includes an orthogonal demodulation section 51, a demapping section 52, a deinterleaver 53 and an LDPC decoding section 56.

The orthogonal demodulation section 51 receives a modulation signal from the transmission apparatus 11 and carries out orthogonal demodulation, and then supplies symbols obtained as a result of the orthogonal demodulation (values on the I and Q axes) to the demapping section 52.

The demapping section 52 carries out demapping of converting the signal points from the orthogonal demodulation section 51 to code bits of an LDPC code to be symbolized symbols and supplies the code bits to the deinterleaver 53.

The deinterleaver 53 includes a multiplexer (MUX) 54 and a column twist deinterleaver 55 and carries out deinterleave of the symbols of the symbol bits from the demapping section 52.

In particular, the multiplexer 54 carries out a reverse replacement process (reverse process to the replacement process) corresponding to the replacement process carried out by the demultiplexer 25 of FIG. 8 for the symbols of the symbol bits from the demapping section 52, that is, a reverse replacement process of returning the positions of the code bits (symbol bits) of the LDPC codes replaced by the replacement process to the original positions. Then, the multiplexer 54 supplies an LDPC code obtained as a result of the reverse replacement process to the column twist deinterleaver 55.

The column twist deinterleaver 55 carries out column twist deinterleave (reverse process to the column twist interleave) corresponding to the column twist interleave as the re-arrangement process carried out by the column twist interleaver 24 of FIG. 8, that is, for example, column twist deinterleave as a reverse re-arrangement process of returning the arrangement of the code bits of the LDPC code having an arrangement changed by the column twist interleave as the re-arrangement process to the original arrangement, for the LDPC code from the multiplexer 54.

In particular, the column twist deinterleaver 55 carries out column twist deinterleave by writing the code bits of the LDPC code into and reading out the written code bits from the memory for deinterleave, the memory being configured similarly to the memory 31 shown in FIG. 22 and so forth.

It is to be noted that, in the column twist deinterleaver 55, writing of the code bits is carried out in the row direction of the memory for deinterleave using read addresses upon reading out the codes from the memory 31 as write addresses. Meanwhile, readout of the code bits is carried out in the column direction of the memory for deinterleave using the write addresses upon writing of the code bits into the memory 31 as read addresses.

The LDPC codes obtained as a result of the column twist interleave are supplied from the column twist deinterleaver 55 to the LDPC decoding section 56.

Here, while the LDPC code supplied from the demapping section 52 to the deinterleaver 53 has been obtained by the parity interleave, column twist interleave and replacement process carried out in this order therefor, the deinterleaver 53 carries out only a reverse replacement process corresponding to the replacement process and column twist deinterleave corresponding to the column twist interleave. Accordingly, parity deinterleave corresponding to the parity interleave (process reverse to the parity interleave), that is, the parity deinterleave returning the arrangement of the code bits of the LDPC codes, whose arrangement has been varied by the parity interleave, to the original arrangement, is not carried out.

Accordingly, the LDPC code for which the reverse replacement process and the column twist deinterleave have been carried out but the parity deinterleave has not been carried out is supplied from the (column twist deinterleaver 55 of the) deinterleaver 53 to the LDPC decoding section 56.

The LDPC decoding section 56 carries out LDPC decoding of the LDPC code from the deinterleaver 53 using a conversion parity check matrix, obtained by carrying out at least column replacement corresponding to the parity interleave for the parity check matrix H used for the LDPC encoding by the LDPC encoding section 21 of FIG. 8, and outputs data obtained as a result of the LDPC decoding as a decoding result of the object data.

FIG. 163 is a flow chart illustrating a reception process carried out by the reception apparatus 12 of FIG. 162.

The orthogonal demodulation section 51 receives a modulation signal from the transmission apparatus 11 at step S111. Then, the processing advances to step S112, at which the orthogonal demodulation section 51 carries out orthogonal demodulation of the modulation signal. The orthogonal demodulation section 51 supplies signal points obtained as a result of the orthogonal demodulation to the demapping section 52, whereafter the processing advances from step S112 to step S113.

At step S113, the demapping section 52 carries out demapping of converting the signal points from the orthogonal demodulation section 51 into symbols and supplies the code bits to the deinterleaver 53, whereafter the processing advances to step S114.

At step S114, the deinterleaver 53 carries out deinterleave of the symbols of the symbol bits from the demapping section 52, whereafter the processing advances to step S115.

In particular, at step S114, the multiplexer 54 in the deinterleaver 53 carries out a reverse replacement process for the symbols of the symbol bits from the demapping section 52 and supplies LDPC code obtained as a result of the reverse replacement process to the column twist deinterleaver 55.

The column twist deinterleaver 55 carries out column twist deinterleave for the LDPC code from the multiplexer 54 and supplies an LDPC code obtained as a result of the column twist deinterleave to the LDPC decoding section 56.

At step S115, the LDPC decoding section 56 carries out LDPC decoding of the LDPC code from the column twist deinterleaver 55 using a conversion parity check matrix obtained by carrying out at least column replacement corresponding to the parity interleave for the parity check matrix H used for the LDPC encoding by the LDPC encoding section 21 of FIG. 8, and outputs data obtained by the LDPC decoding as a decoding result of the object data. Thereafter, the processing is ended.

It is to be noted that the reception process of FIG. 163 is carried out repetitively.

Also in FIG. 162, the multiplexer 54 for carrying out the reverse replacement process and the column twist deinterleaver 55 for carrying out the column twist deinterleave are configured separately from each other for the convenience of description similarly as in the case of FIG. 8. However, the multiplexer 54 and the column twist deinterleaver 55 can be configured integrally with each other.

Further, where the transmission apparatus 11 of FIG. 8 does not carry out the column twist interleave, there is no necessity to provide the column twist deinterleaver 55 in the reception apparatus 12 of FIG. 162.

Now, the LDPC decoding carried out by the LDPC decoding section 56 of FIG. 162 is further described.

The LDPC decoding section 56 of FIG. 162 carries out LDPC decoding of an LDPC code, for which the reverse replacement process and the column twist deinterleave have been carried out but the parity deinterleave has not been carried out, from the column twist deinterleaver 55 as described above using a conversion parity check matrix obtained by carrying out at least column replacement corresponding to the parity interleave for the parity check matrix H used for the LDPC encoding by the LDPC encoding section 21 of FIG. 8.

Here, LDPC decoding which can suppress the operation frequency within a sufficiently implementable range while suppressing the circuit scale by carrying out the LDPC decoding using the conversion parity check matrix has been proposed formerly (refer to, for example, Japanese Patent Laid-Open No. 2004-343170).

Thus, the formerly proposed LDPC decoding which uses a conversion parity check matrix is described first with reference to FIGS. 164 to 167.

FIG. 164 shows an example of the parity check matrix H of an LDPC code whose code length N is 90 and encoding rate is 2/3.

It is to be noted that, in FIG. 164, 0 is represented by a period (.) (this similarly applies also to FIGS. 165 and 166 hereinafter described).

In the parity check matrix H of FIG. 164, the parity matrix has a staircase structure.

FIG. 165 illustrates a parity check matrix H' obtained by applying row replacement of an expression (11) and column replacement of an expression (12) to the parity check matrix H of FIG. 164.

$$\text{Row replacement: } 6s+t+1\text{th row} \rightarrow 5t+s+1\text{th row} \quad \ldots (11)$$

$$\text{Column replacement: } 6x+y+61\text{th column} \rightarrow 5y+x+61\text{th column} \quad \ldots (12)$$

However, in the expressions (11) and (12), s, t, x and y are integers within the ranges of $0 \leq s < 5$, $0 \leq t < 6$, $0 \leq x < 5$ and $0 \leq t < 6$, respectively.

According to the row replacement of the expression (11), the replacement is carried out in such a manner that the 1st, 7th, 13th, 19th and 25th rows each of whose numbers indicates a remainder of 1 where it is divided by 6 are replaced to the 1st, 2nd, 3rd, 4th and 5th rows, and the 2nd, 8th, 14th, 20th and 26th rows each of whose numbers indicates a remainder of 2 where it is divided by 6 are replaced to 6th, 7th, 8th, 9th and 10th rows.

On the other hand, according to the column replacement of the expression (12), the replacement is carried out for the 61st and succeeding columns (parity matrix) such that the 61st, 67th, 73rd, 79th and 85th columns each of whose numbers indicates a remainder of 1 where it is divided by 6 are replaced to 61st, 62nd, 63rd, 64th and 65th columns, and the 62nd, 68th, 74th, 80th and 86th columns each of whose numbers indicates a remainder of 2 where it is divided by 6 are replaced to 66th, 67th, 68th, 69th and 70th columns.

A matrix obtained by carrying out replacement of the rows and the columns for the parity check matrix H of FIG. 164 is a parity check matrix H' of FIG. 165.

Here, even if the row replacement of the parity check matrix H is carried out, this does not have an influence on the arrangement of the code bits of the LDPC code.

Meanwhile, the column replacement of the expression (12) corresponds to parity interleave when the information length K, the unit column number P of the cyclic structure and the devisor q (= M/P) of the parity length M (here, 30) in the parity interleave of interleaving the K+qx+y+1th code bit to the position of the K+Py+x+1th code bit are set to 60, 5 and 6, respectively.

If the parity check matrix H' (hereinafter referred to suitably as replacement parity check matrix) of FIG. 165 is multiplied by a result of replacement same as that of the expression (12) for the LDPC code of the parity check matrix H (hereinafter referred to suitably as original parity check matrix) of FIG. 164, then the 0 vector is outputted. In particular, where a row vector obtained by applying the column replacement of the expression (12) for the row vector c as the LDPC code (one codeword) of the original parity check matrix H is represented by c', since $Hc^T$ becomes the 0 vector on the basis of the characteristic of the parity check matrix, also $H'c'^T$ naturally becomes the 0 vector.

From the foregoing, the conversion parity check matrix H' of FIG. 165 becomes the parity check matrix of an LDPC code c' obtained by carrying out the column replacement of the expression (12) for the LDPC code c of the original parity check matrix H.

Accordingly, by carrying out the column replacement of the expression (12) for the LDPC code c of the original parity check matrix H, decoding (LDPC decoding) the LDPC code c' after the column replacement using the parity check matrix H' of FIG. 165 and then carrying out reverse replacement to the column replacement of the expression (12) for result of decoding, a decoding result similar to that obtained where the LDPC code of the original parity check matrix H is decoded using the parity check matrix H can be obtained.

FIG. 166 shows the conversion parity check matrix H' of FIG. 165 wherein a space is provided between units of 5 × 5 matrices.

In FIG. 166, the conversion parity check matrix H' is represented by a combination of a unit matrix of 5 × 5 elements, another matrix (hereinafter referred to suitably as quasi unit matrix) which corresponds to the unit matrix whose element or elements of 1 are changed into an element or elements of 0, a further matrix (hereinafter referred to suitably as shift matrix) which corresponds to the unit matrix or quasi unit matrix after it is cyclically shifted (cyclic shift), a still further matrix (hereinafter referred to suitably as sum matrix) of two or more of the unit matrix, quasi unit matrix and shift matrix, and a 0 matrix of 5 × 5 elements.

It can be regarded that the conversion parity check matrix H' of FIG. 166 is composed of a unit matrix, a quasi unit matrix, a shift matrix, a sum matrix and a 0 matrix of 5 × 5 elements. Therefor, the matrices of 5 × 5 elements which compose the conversion parity check matrix H' are hereinafter referred to as component matrices.

For decoding of an LDPC code represented by a parity check matrix represented by a matrix of P × P components, an architecture which carries out check node mathematical operation and variable node mathematical operation simultaneously for P check nodes and P variable nodes can be used.

FIG. 167 is a block diagram showing an example of a configuration of a decoding apparatus which carries out such decoding as just described.

In particular, FIG. 167 shows an example of a configuration of a decoding apparatus which carries out decoding of LDPC codes of the original parity check matrix H of FIG. 164 using the conversion parity check matrix H' of FIG. 166 obtained by carrying out at least the column replacement of the expression (12).

The decoding apparatus of FIG. 167 includes an edge data storage memory 300 including six FTFOs $300_1$ to $300_6$, a selector 301 for selecting the FIFOs $300_1$ to $300_6$, a check node calculation section 302, two cyclic shift circuits 303 and 308, an edge data storage memory 304 including 18 FIFOs $304_1$ to $304_{18}$, a selector 305 for selecting the FIFOs $304_1$ to $304_{18}$, a reception data memory 306 for storing reception information, a variable node calculation section 307, a decoded word calculation section 309, a reception data re-arrangement section 310, and a decoded data re-arrangement section 311.

First, a storage method of data into the edge data storage memories 300 and 304 is described.

The edge data storage memory 300 includes the six FIFOs $300_1$ to $300_6$ the number of which is equal to a quotient when the row number 30 of the conversion parity check matrix H' of FIG. 166 is divided by the row number 5 of the component matrices. Each of the FIFOs $300_y$ (y = 1, 2, ..., 6) has a plurality of stages of storage regions such that messages corresponding to five edges whose number is equal to the number of rows and the number of columns of the component matrices can be read out from or written into the storage regions of each stage at the same time. Further, the number of stages of the storage regions of each FIFO $300_y$ is nine which is the maximum number of 1s (Hamming weight) in the row direction of the conversion parity check matrix of FIG. 166.

In the FIFO $300_1$, data (messages $v_i$ from variable nodes) corresponding to the positions of the value 1 in the first to fifth rows of the conversion parity check matrix H' of FIG. 166 are stored in a closed form in the horizontal direction in the individual rows (in the form wherein 0 is ignored). In particular, if an element in the j row of the ith column is represented as (j, i), then in the storage regions at the first stage of the FIFO $300_1$, data corresponding to the positions of the value 1 of the unit matrix of 5 × 5 elements from (1,1) to (5,5) of the conversion parity check matrix H' are stored. In the storage regions at the second stage, data corresponding to the positions of the value 1 of a shift matrix from (1,21) to (5,25) of the conversion parity check matrix H' (a shift matrix obtained by cyclically shifting the unit matrix of 5 × 5 elements by three in the rightward direction). Also in the storage regions at the third to eighth stages, data are stored in an associated relationship with the conversion parity check matrix H'. Then, in the storage regions at the ninth stage, data corresponding to the positions of the value of a shift matrix of (1,86) to (5,90) of the conversion parity check matrix H' (a shift matrix obtained by replacing the value 1 in the first row of the unit matrix of 5 × 5 elements with the value 0 and then cyclically shifting the unit matrix after the replacement by one in the leftward direction) are stored.

In the FIFO $300_2$, data corresponding to the positions of the value 1 from the sixth to tenth rows of the conversion parity check matrix H' of FIG. 166 are stored. In particular, in the storage region at the first stage of the FIFO $300_2$, data corresponding to the positions of the value 1 of a first shift matrix which forms a sum matrix from (6,1) to (10,5) of the conversion parity check matrix H' (a sum matrix which is the sum of a first shift matrix obtained by cyclically shifting the unit matrix of 5 × 5 elements by one in the rightward direction and a second shift matrix obtained by cyclically shifting the unit matrix of 5 × 5 elements by two in the rightward direction) are stored. Further, in the storage region at the second stage, data corresponding to the positions of the value 1 of the second shift matrix which forms the sum matrix from (6,1) to (10,5) of the conversion parity check matrix H' are stored.

In particular, with regard to a component matrix whose weight is 2 or more, where the component matrix is represented in the form of the sum of plural ones from among a unit matrix of P $\times$ P elements having the weight 1, a quasi unit matrix which corresponds to the unit matrix whose one or more elements having the value 1 are replaced with 0 and a shift matrix obtained by cyclically shifting the unit matrix or the quasi unit matrix, data corresponding to the positions of the value 1 of the unit matrix, quasi unit matrix or shift matrix whose weight is 1 (messages corresponding to edges belonging to the unit matrix, quasi unit matrix or shift matrix) are stored into the same address (same FIFO from among the FIFOs $300_1$ to $300_6$).

Also in the storage regions at the third to ninth stages, data are stored in an associated relationship with the conversion parity check matrix H'.

Also the FIFOs $300_3$ to $300_6$ store data in an associated relationship with the conversion parity check matrix H'.

The edge data storage memory 304 includes 18 FIFOs $304_1$ to $304_{18}$ the number of which is equal to the quotient when the column number 90 of the conversion parity check matrix H' is divided by the column number 5 of the component matrix. Each edge data storage memory $304_x$ (x = 1, 2, ..., 18) includes a plurality of stages of storage regions, and messages corresponding to five edges the number of which is equal to the number of rows and the number of columns of the conversion parity check matrix H' can be read out from or written into the storage regions of each stage at the same time.

In the FIFO $304_1$, data corresponding to the positions of the value 1 from the first to fifth columns of the conversion parity check matrix H' of FIG. 166 (messages $u_j$ from the check nodes) are stored in a closed form in the vertical direction in the individual columns (in the form wherein 0 is ignored). In particular, in the storage regions at the first stage of the FIFO $304_1$, data corresponding to the positions of the value 1 of the unit matrix of 5 $\times$ 5 elements from (1,1) to (5,5) of the conversion parity check matrix H' are stored. In the storage regions at the second stage, data corresponding to the positions of the value of a first shift matrix which forms a sum matrix from (6,1) to (10,5) of the vertical parity check matrix H' (a sum matrix which is the sum of a first shift matrix obtained by cyclically shifting the unit matrix of 5 $\times$ 5 elements by one to the right and a second shift matrix obtained by cyclically shifting the unit matrix of 5 $\times$ 5 elements by two to the right) are stored. Further, in the storage regions at the third stage, data corresponding to the positions of the value 1 of the second shift matrix which forms the sum matrix from (6,1) to (10,5) of the vertical parity check matrix H'.

In particular, with regard to a component matrix whose weight is 2 or more, where the component matrix is represented in the form of the sum of plural ones from among a unit matrix of P $\times$ P elements having the weight 1, a quasi unit matrix which corresponds to the unit matrix whose one or more elements having the value 1 are replaced with 0 and a shift matrix obtained by cyclically shifting the unit matrix or the quasi unit matrix, data corresponding to the positions of the value 1 of the unit matrix, quasi unit matrix or shift matrix whose weight is 1 (messages corresponding to edges belonging to the unit matrix, quasi unit matrix or shift matrix) are stored into the same address (same FIFO from among the FIFOs $304_1$ to $304_{18}$).

Also with regard to the storage regions at the fourth and fifth stages, data are stored in an associated relationship with the conversion parity check matrix H'. The number of stages of the storage regions of the FIFO $304_1$ is 5 which is a maximum number of the number of 1s (Hamming weight) in the row direction in the first to fifth columns of the conversion parity check matrix H'.

Also the FIFOs $304_2$ and $304_3$ store data in an associated relationship with the conversion parity check matrix H' similarly, and each length (stage number) of the FIFOs $304_2$ and $304_3$ is 5. Also the FIFOs $304_4$ to $304_{12}$ store data in an associated relationship with the conversion parity check matrix H' similarly, and each length of the FIFOs $304_4$ to $304_{12}$ is 3. Also the FIFOs $304_{13}$ to $304_{18}$ store data in an associated relationship with the conversion parity check matrix H' similarly, and each length of the FIFOs $304_{13}$ to $304_{18}$ is 2.

Now, operation of the decoding apparatus of FIG. 167 is described.

The edge data storage memory 300 includes the six FIFOs $300_1$ to $300_6$, and FIFOs into which data are to be stored are selected from among the FIFOs $300_1$ to $300_6$ in accordance with information (Matrix data) D312 representing to which row of the conversion parity check matrix H' five messages D311 supplied from the cyclic shift circuit 308 at the preceding stage belong. Then, the five messages D311 are stored collectively and in order into the selected FIFOs. Further, when data are to be read out, the edge data storage memory 300 reads out five messages $D300_1$ in order from the FIFO $300_1$ and supplies the five messages $D300_1$ to the selector 301 at the succeeding stage. After the reading out of the messages from the FIFO $300_1$ ends, the edge data storage memory 300 reads out the messages in order also from the FIFOs $330_2$ to $300_6$ and supplies the read out messages to the selector 301.

The selector 301 selects the five messages from that FIFO from which data are currently read out from among the FIFOs $300_1$ to $300_6$ in accordance with a select signal D301 and supplies the five messages as messages D302 to the check node calculation section 302.

The check node calculation section 302 includes five check node calculators $302_1$ to $302_5$ and carries out the check node mathematical operation in accordance with the expression (7) using the messages D302 ($D302_1$ to $D302_5$) (messages $v_i$ of the expression (7)) supplied thereto through the selector 301. Then, the check node calculation section 302 supplies five messages D303 ($D303_1$ to $D303_5$) (messages $u_j$ of the expression (7)) obtained as a result of the check node mathematical operation to the cyclic shift circuit 303.

The cyclic shift circuit 303 cyclically shifts the five messages $D303_1$ to $303_5$ determined by the check node calculation section 302 based on information (Matrix data) D305 regarding by what number of original unit matrices the corresponding edges are cyclically shifted in the conversion parity check matrix H' , and supplies a result of the cyclic shift as a message D304 to the edge data storage memory 304.

The edge data storage memory 304 includes 18 FIFOs $304_1$ to $304_{18}$. The edge data storage memory 304 selects a FIFO into which data are to be stored from among the FIFOs $304_1$ to $304_{18}$ in accordance with the information D305 regarding to which row of the conversion parity check matrix H' the five messages D304 supplied from the cyclic shift circuit 303 at the preceding stage belong and collectively stores the five messages D304 in order into the selected FIFO. On the other hand, when data are to be read out, the edge data storage memory 304 reads out five messages $D306_1$ in order from the FIFO $304_1$ and supplies the messages $D306_1$ to the selector 305 at the succeeding stage. After the reading out of data from the FIFO $304_1$ ends, the edge data storage memory 304 reads out messages in order also from the FIFOs $304_2$ to $304_{18}$ and supplies the messages to the selector 305.

The selector 305 selects the five messages from the FIFO from which data are currently read out from among the FIFOs $304_1$ to $304_{18}$ in accordance with a select signal D307 and supplies the selected messages as messages D308 to the variable node calculation section 307 and the decoded word calculation section 309.

On the other hand, the reception data re-arrangement section 310 carries out the column replacement of the expression (12) to re-arrange an LDPC code D313 received through a communication path and supplies the re-arranged LDPC code D313 as reception data D314 to the reception data memory 306. The reception data memory 306 calculates and stores a reception LLR (logarithmic likelihood ratio) from the reception data D314 supplied thereto from the reception data re-arrangement section 310 and collects and supplies every five ones of the reception LLRs as reception values D309 to the variable node calculation section 307 and the decoded word calculation section 309.

The variable node calculation section 307 includes five variable node calculators $307_1$ to $307_5$ and carries out variable node mathematical operation in accordance with the expression (1) using the messages D308 ($308_1$ to $308_5$) (messages $u_j$ of the expression (1)) supplied thereto through the selector 305 and the five reception values D309 (reception values $u_{Oi}$ of the expression (1)) supplied thereto from the reception data memory 306. Then, the variable node calculation section 307 supplies messages D310 ($D301_1$ to $D310_5$) (messages $v_i$ of the expression (1)) obtained as a result of the mathematical operation to the cyclic shift circuit 308.

The cyclic shift circuit 308 cyclically shifts messages $D310_1$ to $D310_5$ calculated by the variable node calculation section 307 based on information regarding by what number of original unit matrices the corresponding edge is cyclically shifted in the conversion parity check matrix H', and supplies a result of the cyclic shifting as a message D311 to the edge data storage memory 300.

By carrying out the sequence of operations described above, decoding in one cycle of an LDPC code can be carried out. In the decoding apparatus of FIG. 167, after an LDPC code is decoded by a predetermined number of times, a final decoding result is determined by the decoded word calculation section 309 and the decoded data re-arrangement section 311 and then outputted.

In particular, the decoded word calculation section 309 includes five decoded word calculators $309_1$ to $309_5$ and acts as a final stage in a plurality of cycles of decoding to calculate a decoding result (decoded word) in accordance with the expression (5) using the five messages D308 ($D308_1$ to $D308_5$) (messages $u_j$ of the expression (5)) outputted from the selector 305 and the five reception values D309 (reception values $u_{Oi}$ of the expression (5)) outputted from the reception data memory 306. Then, the decoded word calculation section 309 supplies decoded data D315 obtained as a result of the calculation to the decoded data re-arrangement section 311.

The decoded data re-arrangement section 311 carries out reverse replacement to the column replacement of the expression (12) for the decoded data D315 supplied thereto from the decoded word calculation section 309 to re-arrange the order of the decoded data D315 and outputs the re-arranged decoded data D315 as a decoding result D316.

As described above, by applying one or both of row replacement and column replacement to a parity check matrix (original parity check matrix) to convert the parity check matrix into a parity check matrix (conversion parity check matrix) which can be represented by a combination of a unit matrix of $P \times P$ elements, a quasi unit matrix which corresponds to the unit matrix whose element or elements of 1 are changed into an element or elements of 0, a shift matrix which corresponds to the unit matrix or quasi unit matrix after it is cyclically shifted, a sum matrix of two or more of the unit matrix, quasi unit matrix and shift matrix, and a 0 matrix of $P \times P$ elements as described above, it becomes possible to adopt for LDPC code decoding an architecture which carries out check node mathematical operation and variable node mathematical operation simultaneously for P check nodes and P variable nodes. Consequently, by carrying out the node mathematical operation simultaneously for P nodes, it is possible to suppress the operation frequency within an implementable range to carry out LDPC decoding.

The LDPC decoding section 56 which composes the reception apparatus 12 of FIG. 162 carries out check node mathematical operation and variable node mathematical operation simultaneously for P check nodes and P variable nodes to carry out LDPC decoding similarly to the decoding apparatus of FIG. 167.

In particular, it is assumed now to simplify description that the parity check matrix of an LDPC code outputted from the LDPC encoding section 21 which composes the transmission apparatus 11 of FIG. 8 is, for example, the parity check matrix H wherein the parity matrix has a staircase structure shown in FIG. 164. In this instance, the parity interleaver 23 of the transmission apparatus 11 carries out parity interleave for interleaving the K+qx+y+1th code bit to the position of the K+Py+x+1th code bit with the information length K set to 60, with the unit column number P of the cyclic structure set to 5 and with the devisor q (= M/P) of the parity length M to 6.

Since this parity interleave corresponds to the column replacement of the expression (12), the LDPC decoding section 56 need not carry out the column replacement of the expression (12).

Therefore, in the reception apparatus 12 of FIG. 162, an LDPC code for which parity deinterleave has not been carried out, that is, an LDPC code in a state wherein the column replacement of the expression (12) is carried out, is supplied from the column twist deinterleaver 55 to the LDPC decoding section 56 as described above. The LDPC decoding section 56 carries out processing similar to that of the decoding apparatus of FIG. 167 except that the column replacement of the expression (12) is not carried out.

In particular, FIG. 168 shows an example of a configuration of the LDPC decoding section 56 of FIG. 162.

Referring to FIG. 168, the LDPC decoding section 56 is configured similarly to that of the decoding apparatus of FIG. 167 except that the reception data re-arrangement section 310 of FIG. 167 is not provided and carries out processing similar to that of the decoding apparatus of FIG. 167 except that the column replacement of the expression (12) is not carried out. Therefore, description of the LDPC decoding section 56 is omitted herein.

Since the LDPC decoding section 56 can be configured without including the reception data re-arrangement section 310 as described above, it can be reduced in scale in comparison with the decoding apparatus of FIG. 167.

It is to be noted that, while, in FIGS. 164 to 168, it is assumed that the code length N of the LDPC code is 90; the information length K is 60; the unit column number P (row number and column number of a component matrix) of the cyclic structure is 5; and the devisor q (= M/P) of the parity length M is 6, for simplified description, the code length N, information length K, unit column number P of the cyclic structure and the devisor q (= M/P) are not individually limited to the specific values given above.

In particular, while the LDPC encoding section 21 in the transmission apparatus 11 of FIG. 8 outputs an LDPC code wherein, for example, the code length N is 64,800 or 16,200, the information length K is N - Pq (= N - M), the unit column number P of the cyclic structure is 360 and the devisor q is M/P, the LDPC decoding section 56 of FIG. 168 can be applied also where LDPC decoding is carried out by carrying out the check node mathematical operation and the variable node mathematical operation simultaneously for P check nodes and P variable nodes in regard to such an LDPC code as just described.

While the series of processes described above can be executed by hardware, it may otherwise be executed by software. Where the series of processes is executed by software, a program which constructs the software is installed into a computer for universal use or the like.

FIG. 169 shows an example of a configuration of an embodiment of a computer into which a program for executing the series of processes described hereinabove is installed.

The program can be recorded in advance on a hard disk 705 or in a ROM 703 as a recording medium built in the computer.

Or, the program can be stored (recorded) temporarily or permanently on or in a removable recording medium 711 such as a flexible disk, a CD-ROM (Compact Disc Read Only Memory), an MO (Magneto Optical) disc, a DVD (Digital Versatile Disc), a magnetic disc or a semiconductor memory. Such a removable recording medium 711 as just described can be provided as so-called package software.

It is to be noted that the program not only can be installed from such a removable recording medium 711 as described above into the computer but also can be installed into the hard disk 705 built in the computer where it is transferred thereto and received by a communication section 708. In this instance, the program may be transferred to the computer by wireless communication from a download site through an artificial satellite for digital satellite broadcasting or transferred to the computer by wire communication through a network such as a LAN (Local Area Network) or the Internet.

The computer has a CPU (Central Processing Unit) 702 built therein. An input/output interface 7410 is connected to the CPU 702 by a bus 701, and if an instruction is inputted to the CPU 702 through the input/output interface 710 when an inputting section 707 configured from a keyboard, a mouse, a microphone and so forth is operated by a user or in a like case, the CPU 702 executes the program stored in the ROM (Read Only Memory) 703. Or, the CPU 702 loads a program stored on the hard disk 705, a program transferred from a satellite or a network, received by the communication section 708 and installed in the hard disk 705 or a program read out from the removable recording medium 711 loaded in a drive 709 and installed in the hard disk 705 into a RAM (Random Access Memory) 704 and executes the program. Consequently, the CPU 702 carries out processing in accordance with the flow chart described hereinabove or processing carried out by the configuration of the block diagram described hereinabove. Then, the CPU 702 outputs a result of the processing from an outputting section 706 configured from an LCD (Liquid Crystal Display), a speaker and so forth and transmits the processing result from the communication section 708 through the input/output interface 710 or records the processing result on the hard disk 705 as occasion demands.

Here, in the present specification, processing steps which describe the program for causing the computer to carry out various processes need not necessarily be processed in a time series in accordance with the order described as a flow chart but include those processes to be executed in parallel or individually (for example, parallel processes or processes by an object).

Further, the program may be processed by a single computer or may be processed by distributed processing by a plurality of computers. Further, the program may be transferred to and executed by a computer at a remote place.

Now, variations of the method of replacement of code bits of an LDPC code in the replacement process by the replacement section 32 of the demultiplexer 25, that is, of the allocation pattern (hereinafter referred to as bit allocation pattern) of code bits of an LDPC code and symbol bits representative of a symbol, are described.

In the demultiplexer 25, the code bits of the LDPC code are written in the column direction of the memory 31, which stores (N/(mb)) × (mb) bits in the column direction × row direction. Thereafter, the code bits are read out in a unit of mb bits in the row direction. Further, in the demultiplexer 25, the replacement section 32 replaces the mb code bits read out in the row direction of the memory 31 and determines the code bits after the replacement as mb symbol bits of (successive) b symbols.

In particular, the replacement section 32 determines the i+1th bit from the most significant bit of the mb code bits read out in the row direction of the memory 31 as the code bit $b_i$ and determines the i+1th bit from the most significant bit of the mb symbol bits of the b (successive) symbols as the symbol bit $y_i$, and then replaces the mb code bits $b_0$ to $b_{mb-1}$ in accordance with a predetermined bit allocation pattern.

FIG. 170 shows an example of a bit allocation pattern which can be adopted where the LDPC code is an LDPC code whose code length N is 64,800 bits and whose encoding rate is 5/6 or 9/10 and besides the modulation method is 4096QAM and the multiple b is 1.

Where the LDPC code is an LDPC code whose code length N is 64,800 bits and whose encoding rate is 5/6 or 9/10 and besides the modulation method is 4096QAM and the multiple b is 1, in the demultiplexer 25, the code bits written in the memory 31 for storing (64,800/(12 × 1)) × (12 × 1) bits in the column direction × row direction are read out in a unit of 12 × 1 (= mb) bits in the row direction and supplied to the replacement section 32 (FIGS. 16 and 17).

The replacement section 32 replaces 12 × 1 (= mb) code bits $b_0$ to $b_{11}$ such that the 12 × 1 (= mb) code bits $b_0$ to $b_{11}$ to be read out from the memory 31 may be allocated to the 12 × 1 (= mb) symbol bits $y_0$ to $y_{11}$ of one (= b) symbol as seen in FIG. 170.

In particular, according to FIG. 170, the replacement section 32 carries out, with regard to both of an LDPC code having the encoding rate of 5/6 and an LDPC code having the encoding rate of 9/10 from among LDPC codes having the code length N of 64,800 bits, replacement for allocating

the code bit $b_0$ to the symbol bit $y_8$,
the code bit $b_1$ to the symbol bit $y_0$,
the code bit $b_2$ to the symbol bit $y_6$,
the code bit $b_3$ to the symbol bit $y_1$,
the code bit $b_4$ to the symbol bit $y_4$,
the code bit $b_5$ to the symbol bit $y_5$,
the code bit $b_6$ to the symbol bit $y_2$,
the code bit $b_7$ to the symbol bit $y_3$,
the code bit $b_8$ to the symbol bit $y_7$,
the code bit $b_9$ to the symbol bit $y_{10}$,
the code bit $b_{10}$ to the symbol bit $y_{11}$, and
the code bit $b_{11}$ to the symbol bit $y_9$.

FIG. 171 shows an example of a bit allocation pattern which can be adopted where the LDPC code is an LDPC code whose code length N is 64,800 bits and whose encoding rate is 5/6 or 9/10 and besides the modulation method is 4096QAM and the multiple b is 2.

Here, the bit allocation pattern of FIG. 171 utilizes the bit allocation pattern of FIG. 170 wherein the multiple b is 1 without any modification.

Where the LDPC code is an LDPC code whose code length N is 64,800 bits and whose encoding rate is 5/6 or 9/10 and besides the modulation method is 4096QAM and the multiple b is 2, in the demultiplexer 25, the code bits written in the memory 31 for storing (64,800/(12 × 2)) × (12 × 2) bits in the column direction × row direction are read out in a unit of 12 × 2 (= mb) bits in the row direction and supplied to the replacement section 32 (FIGS. 16 and 17).

The replacement section 32 replaces 12 × 2 (= mb) code bits $b_0$ to $b_{23}$ such that the 12 × 2 (= mb) code bits $b_0$ to $b_{23}$ to be read out from the memory 31 may be allocated to the 12 × 2 (= mb) symbol bits $y_0$ to $y_{23}$ of two (= b) successive symbols as seen in FIG. 171.

In particular, according to FIG. 171, the replacement section 32 carries out, with regard to both of an LDPC code having the encoding rate of 5/6 and an LDPC code having the encoding rate of 9/10 from among LDPC codes having the code length N of 64,800 bits, replacement for allocating

the code bit $b_0$ to the symbol bit $y_8$,
the code bit $b_2$ to the symbol bit $y_0$,
the code bit $b_4$ to the symbol bit $y_6$,
the code bit $b_6$ to the symbol bit $y_1$,
the code bit $b_8$ to the symbol bit $y_4$,
the code bit $b_{10}$ to the symbol bit $y_5$,
the code bit $b_{12}$ to the symbol bit $y_2$,
the code bit $b_{14}$ to the symbol bit $y_3$,
the code bit $b_{16}$ to the symbol bit $y_7$,
the code bit $b_{18}$ to the symbol bit $y_{10}$,
the code bit $b_{20}$ to the symbol bit $y_{11}$,
the code bit $b_{22}$ to the symbol bit $y_9$,
the code bit $b_1$ to the symbol bit $y_{20}$,
the code bit $b_3$ to the symbol bit $y_{12}$,
the code bit $b_5$ to the symbol bit $y_{18}$,
the code bit $b_7$ to the symbol bit $y_{13}$,
the code bit $b_9$ to the symbol bit $y_{16}$,
the code bit $b_{11}$ to the symbol bit $y_{17}$,
the code bit $b_{13}$ to the symbol bit $y_{14}$,
the code bit $b_{15}$ to the symbol bit $y_{15}$,
the code bit $b_{17}$ to the symbol bit $y_{19}$,
the code bit $b_{19}$ to the symbol bit $y_{22}$,
the code bit $b_{21}$ to the symbol bit $y_{23}$, and
the code bit $b_{23}$ to the symbol bit $y_{21}$.

FIG. 172 shows an example of a bit allocation pattern which can be adopted where the modulation method is 1024QAM and the LDPC code is an LDPC code whose code length N is 16,200 bits and whose encoding rate is 3/4, 5/6 or 8/9 and besides the multiple b is 2 and also where the modulation method is 1024QAM and the LDPC code is an LDPC code whose code length N is 64,800 bits and whose encoding length is 3/4, 5/6 or 9/10 and besides the multiple b is 2.

Where the LDPC code is an LDPC code whose code length N is 16,200 bits and whose encoding rate is 3/4, 5/6 or 8/9 and the modulation method is 1024QAM and besides the multiple b is 2, in the demultiplexer 25, the code bits written in the memory 31 for storing (16,200/(10 × 2)) × (10 × 2) bits in the column direction × row direction are read out in a unit of 10 × 2 (= mb) bits in the row direction and supplied to the replacement section 32 (FIGS. 16 and 17).

On the other hand, where the LDPC code is an LDPC code whose code length N is 64,800 bits and whose encoding rate is 3/4, 5/6 or 9/10 and the modulation method is 1024QAM and besides the multiple b is 2, in the demultiplexer 25, the code bits written in the memory 31 for storing (64,800/(10 × 2)) × (10 × 2) bits in the column direction × row direction are read out in a unit of 10 × 2 (= mb) bits in the row direction and supplied to the replacement section 32 (FIGS. 16 and 17).

The replacement section 32 replaces 10 × 2 (= mb) code bits $b_0$ to $b_{19}$ such that the 10 × 2 (= mb) code bits $b_0$ to $b_{19}$ to be read out from the memory 31 may be allocated to the 10 × 2 (= mb) symbol bits $y_0$ to $y_{19}$ of two (= b) successive symbols as seen in FIG. 172.

In particular, according to FIG. 172, the replacement section 32 carries out, with regard to all of the LDPC codes having the encoding rate of 3/4, LDPC codes having the encoding rate of 5/6 and LDPC codes having a further encoding rate of 8/9 from among LDPC codes having the code length of 16,200 bits as well as LDPC code having the encoding rate of 3/4, LDPC codes having the encoding rate of 5/6 and LDPC codes having a further encoding rate of 9/10 from among LDPC codes having another code length N of 64,800, replacement for allocating

the code bit $b_0$ to the symbol bit $y_8$,
the code bit $b_1$ to the symbol bit $y_3$,
the code bit $b_2$ to the symbol bit $y_7$,
the code bit $b_3$ to the symbol bit $y_{10}$,
the code bit $b_4$ to the symbol bit $y_{19}$,
the code bit $b_5$ to the symbol bit $y_4$,
the code bit $b_6$ to the symbol bit $y_9$,
the code bit $b_7$ to the symbol bit $y_5$,
the code bit $b_8$ to the symbol bit $y_{17}$,
the code bit $b_9$ to the symbol bit $y_6$,

the code bit $b_{10}$ to the symbol bit $y_{14}$,
the code bit $b_{11}$ to the symbol bit $y_{11}$,
the code bit $b_{12}$ to the symbol bit $y_2$,
the code bit $b_{13}$ to the symbol bit $y_{18}$,
the code bit $b_{14}$ to the symbol bit $y_{16}$,
the code bit $b_{15}$ to the symbol bit $y_{15}$,
the code bit $b_{16}$ to the symbol bit $y_0$,
the code bit $b_{17}$ to the symbol bit $y_1$,
the code bit $b_{18}$ to the symbol bit $y_{13}$, and
the code bit $b_{19}$ to the symbol bit $y_{12}$.

FIG. 173 shows an example of a bit allocation pattern which can be adopted where the modulation method is 4096QAM and the LDPC code is an LDPC code whose code length N is 16,200 bits and whose encoding rate is 5/6 or 8/9 and besides the multiple b is 2 and also where the modulation method is 4096QAM and the LDPC code is an LDPC code whose code length N is 64,800 bits and whose encoding rate is 5/6 or 9/10 and besides the multiple b is 2.

Where the LDPC code is an LDPC code whose code length N is 16,200 bits and whose encoding rate is 5/6 or 8/9 and the modulation method is 4096QAM and besides the multiple b is 2, in the demultiplexer 25, the code bits written in the memory 31 for storing (16,200/(12 × 2)) × (12 × 2) bits in the column direction × row direction are read out in a unit of 12 × 2 (= mb) bits in the row direction and supplied to the replacement section 32 (FIGS. 16 and 17).

On the other hand, where the LDPC code is an LDPC code whose code length N is 64,800 bits and whose encoding rate is 5/6 or 9/10 and the modulation method is 4096QAM and besides the multiple b is 2, in the demultiplexer 25, the code bits written in the memory 31 for storing (64,800/(12 × 2)) × (12 × 2) bits in the column direction × row direction are read out in a unit of 12 × 2 (= mb) bits in the row direction and supplied to the replacement section 32 (FIGS. 16 and 17).

The replacement section 32 replaces 12 × 2 (= mb) code bits $b_0$ to $b_{23}$ such that the 12 × 2 (= mb) bits to be read out from the memory 31 may be allocated to the 12 × 2 (= mb) symbol bits $y_0$ to $y_{23}$ of two (= b) successive symbols as seen in FIG. 173.

In particular, according to FIG. 173, the replacement section 32 carries out, with regard to all of the LDPC codes having the encoding rate of 5/6 and LDPC codes having the encoding rate of 8/9 from among LDPC codes having the code length of 16,200 bits as well as LDPC codes having the encoding rate of 5/6 and LDPC codes having the encoding rate of 9/10 from among LDPC codes having another code length N of 64,800, replacement for allocating
the code bit $b_0$ to the symbol bit $y_{10}$,
the code bit $b_1$ to the symbol bit $y_{15}$,
the code bit $b_2$ to the symbol bit $y_4$,
the code bit $b_3$ to the symbol bit $y_{19}$,
the code bit $b_4$ to the symbol bit $y_{21}$,
the code bit $b_5$ to the symbol bit $y_{16}$,
the code bit $b_6$ to the symbol bit $y_{23}$,
the code bit $b_7$ to the symbol bit $y_{18}$,
the code bit $b_8$ to the symbol bit $y_{11}$,
the code bit bg to the symbol bit $y_{14}$,
the code bit $b_{10}$ to the symbol bit $y_{22}$,
the code bit $b_{11}$ to the symbol bit $y_5$,
the code bit $b_{12}$ to the symbol bit $y_6$,
the code bit $b_{13}$ to the symbol bit $y_{17}$,
the code bit $b_{14}$ to the symbol bit $y_{13}$,
the code bit $b_{15}$ to the symbol bit $y_{20}$,
the code bit $b_{16}$ to the symbol bit $y_1$,
the code bit $b_{17}$ to the symbol bit $y_3$,
the code bit $b_{18}$ to the symbol bit $y_9$,
the code bit $b_{19}$ to the symbol bit $y_2$,
the code bit $b_{20}$ to the symbol bit $y_7$,
the code bit $b_{21}$ to the symbol bit $y_8$,
the code bit $b_{22}$ to the symbol bit $y_{12}$, and
the code bit $y_{23}$ to the symbol bit $y_0$.

According to the bit allocation patterns shown in FIGS. 170 to 173, the same bit allocation pattern can be adopted for a plurality of kinds of LDPC codes, and besides, the tolerance to errors can be set to a desired performance with regard to all of the plural kinds of LDPC codes.

In particular, FIGS. 174 to 177 illustrates results of simulations of the BER (Bit Error Rate) where a replacement process is carried out in accordance with the bit allocation patterns of FIGS. 170 to 173.

It is to be noted that, in FIGS. 174 to 177, the axis of abscissa represents $E_s/N_O$ (signal power to noise power ratio per one symbol) and the axis of ordinate represents the BER.

Further, a solid line curve represents the BER where a replacement process is carried out and an alternate long and short dash line represents the BER where a replacement process is not carried out.

FIG. 174 illustrates the BER where a replacement process in accordance with the bit allocation pattern of FIG. 170 is carried out for LDPC codes whose code length N is 64,800 and whose encoding rate is 5/6 and 9/10 adopting 4096QAM as the modulation method and setting the multiple b to 1.

FIG. 175 illustrates the BER where a replacement process in accordance with the bit allocation pattern of FIG. 171 is carried out for LDPC codes whose code length N is 64,800 and whose encoding rate is 5/6 and 9/10 adopting 4096QAM as the modulation method and setting the multiple b to 2.

It is to be noted that, in FIGS. 174 and 175, a graph having a triangular mark applied thereto represents the BER regarding the LDPC code having the encoding rate of 5/6, and a graph having an asterisk applied thereto represents the BER regarding the LDPC code having the encoding rate of 9/10.

FIG. 176 illustrates the BER where a replacement process in accordance with the bit allocation pattern of FIG. 172 is carried out for LDPC codes whose code length N is 16,200 and whose encoding rate is 3/4, 5/6 and 8/9 and for LDPC codes whose code length N is 64,800 and whose encoding rate is 3/4, 5/6 and 9/10 adopting 1024QAM as the modulation method and setting the multiple b to 2.

It is to be noted that, in FIG. 176, a graph having an asterisk applied thereto represents the BER regarding the LDPC code having the code length N of 64,800 and the encoding rate of 9/10, and a graph having an upwardly directed triangular mark applied thereto represents the BER regarding the LDPC codes having the code length N of 64,800 and the encoding rate of 5/6. Further, a graph having a square mark applied thereto represents the BER regarding the LDPC code having the code length N of 64,800 and the encoding rate of 3/4.

Further, in FIG. 176, a graph having a round mark applied thereto represents the BER regarding the LDPC code having the code length N of 16,200 and the encoding rate of 8/9, and a graph having a downwardly directed triangular mark applied thereto represents the BER regarding the LDPC code having the code length N of 16,200 and the encoding rate of 5/6. Further, a graph having a plus mark applied thereto represents the BER regarding the LDPC code having the code length N of 16,200 and the encoding rate of 3/4.

FIG. 177 illustrates the BER where a replacement process in accordance with the bit allocation pattern of FIG. 173 is carried out for LDPC codes whose code length N is 16,200 and whose encoding rate is 5/6 and 8/9 and for LDPC codes whose code length N is 64,800 and whose encoding rate is 5/6 and 9/10 adopting 4096QAM as the modulation method and setting the multiple b to 2.

It is to be noted that, in FIG. 177, a graph having an asterisk applied thereto represents the BER regarding the LDPC code having the code length N of 64,800 and the encoding rate of 9/10, and a graph having an upwardly directed triangular mark applied thereto represents the BER regarding the LDPC codes having the code length N of 64,800 and the encoding rate of 5/6.

Further, in FIG. 177, a graph having a round mark applied thereto represents the BER regarding the LDPC code having the code length N of 16,200 and the encoding rate of 8/9, and a graph having a downwardly directed triangular mark applied thereto represents the BER regarding the LDPC code having the code length N of 16,200 and the encoding rate of 5/6.

According to FIGS. 174 to 177, the same bit allocation pattern can be adopted with regard to a plurality of kinds of LDPC codes. Besides, the tolerance to errors can be set to a desired performance with regard to all of the plural kinds of LDPC codes.

In particular, where a bit allocation pattern for exclusive use is adopted for each of a plurality of kinds of LDPC codes which have different code lengths and different encoding rates, the tolerance to an error can be raised to a very high performance. However, it is necessary to change the bit allocation pattern for each of a plurality of kinds of LDPC codes.

On the other hand, according to the bit allocation patterns of FIGS. 170 to 173, the same bit allocation pattern can be adopted for a plurality of kinds of LDPC codes which have different code lengths and different encoding rates, and the necessity to change the bit allocation pattern for each of a plurality of kinds of LDPC codes as in a case wherein a bit allocation pattern for exclusive use is adopted for each of a plurality of kinds of LDPC codes is eliminated.

Further, according to the bit allocation patterns of FIGS. 170 to 173, the tolerance to errors can be raised to a high performance although it is a little lower than that where a bit allocation pattern for exclusive use is adopted for each of a plurality of kinds of LDPC codes.

In particular, for example, where the modulation method is 4096QAM, the same bit allocation pattern in FIG. 170 or 171 can be used for all of the LDPC codes which have the code length N of 64,800 and the encoding rate of 5/6 and 9/10. Even where the same bit allocation pattern is adopted in this manner, the tolerance to errors can be raised to a high performance.

Further, for example, where the modulation method is 1024QAM, the same bit allocation pattern of FIG. 172 can be adopted for all of the LDPC codes which have the code length N of 16,200 and the encoding rate of 3/4, 5/6 and 8/9 and the LDPC codes which have the code length N of 64,800 and the encoding rate of 3/4, 5/6 and 9/10. Then, even if the same bit allocation pattern is adopted in this manner, the tolerance to errors can be raised to a high performance.

Meanwhile, for example, where the modulation method is 4096QAM, the same bit allocation pattern of FIG. 173 can be adopted for all of the LDPC codes which have the code length N of 16,200 and the encoding rate of 5/6 and 8/9 and the LDPC codes which have the code length N of 64,800 and the encoding rate of 5/6 and 9/10. Then, even if the same bit allocation pattern is adopted in this manner, the tolerance to errors can be raised to a high performance.

Now, a process for LDPC encoding by the LDPC encoding section 21 of the transmission apparatus 11 is described further.

For example, in the DVB-S.2 standard, LDPC encoding of the two different code lengths N of 64,800 bits and 16,200 bits are prescribed.

And, for the LDPC code whose code length N is 64,800 bits, the 11 encoding rates 1/4, 1/3, 2/5, 1/2, 3/5, 2/3, 3/4, 4/5, 5/6, 8/9 and 9/10 are prescribed, and for the LDPC code whose code length N is 16,200 bits, the 10 encoding rates 1/4, 1/3, 2/5, 1/2, 3/5, 2/3, 3/4, 4/5, 5/6 and 8/9 are prescribed.

The LDPC encoding section 21 carries out encoding (error correction encoding) into LDPC codes of the different encoding rates whose code length N is 64,800 bits or 16,200 bits in accordance with a parity check matrix H prepared for each code length N and for each encoding rate.

In particular, the LDPC encoding section 21 stores a parity check matrix initial value table hereinafter described for producing a parity check matrix H for each code length N and for each encoding rate.

Here, in the DVB-S.2 standard, LDPC codes of the two different code lengths N of 64,800 bits and 16,200 bits are prescribed as described hereinabove, and the 11 different encoding rates are prescribed for the LDPC code whose code length N is 64,800 bits and the 10 different encoding rates are prescribed for the LDPC code whose code length N is 16,200 bits.

Accordingly, where the transmission apparatus 11 is an apparatus which carries out processing in compliance with the DVB-S.2 standard, parity check matrix initial value tables individually corresponding to the 11 different encoding rates for the LDPC code whose code length N is 64,800 bits and parity check matrix initial value tables individually corresponding to the 10 different encoding rates for the LDPC code whose code length N is 16,200 bits are stored in the LDPC encoding section 21.

The LDPC encoding section 21 sets a code length N and an encoding rate r for LDPC codes, for example, in response to an operation of an operator. The code length N and the encoding rate r set by the LDPC encoding section 21 are hereinafter referred to suitably as set code length N and set encoding rate r, respectively.

The LDPC encoding section 21 places, based on the parity check matrix initial value tables corresponding to the set code length N and the set encoding rate r, elements of the value 1 of an information matrix $H_A$ corresponding to an information length K (= Nr = code length N - parity length M) corresponding to the set code length N and the set encoding rate r in a period of 360 columns (unit column number P of the cyclic structure) in the column direction to produce a parity check matrix H.

Then, the LDPC encoding section 21 extracts information bits for the information length K from object data which are an object of transmission such as image data or sound data supplied from the transmission apparatus 11. Further, the LDPC encoding section 21 calculates parity bits corresponding to the information bits based on the parity check matrix H to produce a codeword (LDPC code) for one code length.

In other words, the LDPC encoding section 21 successively carries out mathematical operation of a parity bit of the codeword c which satisfies the following expression.

$$Hc^T = 0$$

Here, in the expression above, c indicates a row vector as the codeword (LDPC code), and $c^T$ indicates inversion of the row vector c.

Where, from within the row vector c as an LDPC code (one codeword), a portion corresponding to the information bits is represented by a row vector A and a portion corresponding to the parity bits is represented by a row vector T, the row vector c can be represented by an expression c = [A|T] from the row vector A as the information bits and the row vector T as the parity bits.

Meanwhile, the parity check matrix H can be represented, from the information matrix $H_A$ of those of the code bits of the LDPC code which correspond to the information bits and the parity matrix $H_T$ of those of the code bits of the LDPC code which correspond to the parity bits by an expression $H = [H_A|H_T]$ (matrix wherein the elements of the information matrix $H_A$ are elements on the left side and the elements of the parity matrix $H_T$ are elements on the right side).

Further, for example, in the DVB-S.2 standard, the parity check matrix $H_T$ of the parity check matrix $H = [H_A|H_T]$ has a staircase structure.

It is necessary for the parity check matrix H and the row vector c = [A|T] as an LDPC code to satisfy the expression $Hc^T = 0$, and where the parity matrix $H_T$ of the parity check matrix $H = [H_A|H_T]$ has a staircase structure, the row vector T as parity bits which configures the row vector c = [A|T] which satisfies the expression $Hc^T = 0$ can be determined sequentially by setting the elements of each row to zero in order beginning with the elements in the first row of the column vector $Hc^T$ in the expression $Hc^T = 0$.

If the LDPC encoding section 21 determines a parity bit T for an information bit A, then it outputs a codeword c = [A|T] represented by the information bit A and the parity bit T as an LDPC encoding result of the information bit A.

As described above, the LDPC encoding section 21 stores the parity check matrix initial value tables corresponding to the code lengths N and the encoding rates r in advance therein and carries out LDPC encoding of the set code length N and the set encoding rate r using a parity check matrix H produced from the parity check matrix initial value tables corresponding to the set code length N and the set encoding rate r.

Each parity check matrix initial value table is a table which represents the position of elements of the value 1 of the information matrix $H_A$ corresponding to the information length K corresponding to the code length N and the encoding rate r of the LDPC code of the parity check matrix H (LDPC code defined by the parity check matrix H) for every 360 rows (unit column number P of the periodic structure), and is produced in advance for a parity check matrix H for each code length N and each encoding rate r.

FIGS. 178 to 223 illustrate the parity check matrix initial value tables for producing various parity check matrices H including parity check matrix initial value tables prescribed in the DVB-S.2 standard.

In particular, FIG. 178 shows the parity check matrix initial value table for a parity check matrix H prescribed in the DVB-S.2 standard and having a code length N of 16,200 bits and an encoding rate r of 2/3.

FIGS. 179 to 181 show the parity check matrix initial value table for a parity check matrix H prescribed in the DVB-S.2 standard and having a code length N of 64,800 bits and an encoding rate r of 2/3.

It is to be noted that FIG. 180 is a view continuing from FIG. 179 and FIG. 181 is a view continuing from FIG. 180.

FIG. 182 shows the parity check matrix initial value table for a parity check matrix H prescribed in the DVB-S. 2 standard and having a code length N of 16,200 bits and an encoding rate r of 3/4.

FIGS. 183 to 186 show the parity check matrix initial value table for a parity check matrix H prescribed in the DVB-S.2 standard and having a code length N of 64,800 bits and an encoding rate r of 3/4.

It is to be noted that FIG. 184 is a view continuing from FIG. 183 and FIG. 185 is a view continuing from FIG. 184. Further, FIG. 186 is a view continuing from FIG. 185.

FIG. 187 shows the parity check matrix initial value table for a parity check matrix H prescribed in the DVB-S. 2 standard and having a code length N of 16,200 bits and an encoding rate r of 4/5.

FIGS. 188 to 191 show the parity check matrix initial value table for a parity check matrix H prescribed in the DVB-S.2 standard and having a code length N of 64,800 bits and an encoding rate r of 4/5.

It is to be noted that FIG. 189 is a view continuing from FIG. 188 and FIG. 190 is a view continuing from FIG. 189. Further, FIG. 191 is a view continuing from FIG. 190.

FIG. 192 shows the parity check matrix initial value table for a parity check matrix H prescribed in the DVB-S. 2 standard and having a code length N of 16,200 bits and an encoding rate r of 5/6.

FIGS. 193 to 196 show the parity check matrix initial value table for a parity check matrix H prescribed in the DVB-S.2 standard and having a code length N of 64,800 bits and an encoding rate r of 5/6.

It is to be noted that FIG. 194 is a view continuing from FIG. 193 and FIG. 195 is a view continuing from FIG. 194. Further, FIG. 196 is a view continuing from FIG. 195.

FIG. 197 shows the parity check matrix initial value table for a parity check matrix H prescribed in the DVB-S. 2 standard and having a code length N of 16,200 bits and an encoding rate r of 8/9.

FIGS. 198 to 201 show the parity check matrix initial value table for a parity check matrix H prescribed in the DVB-S.2 standard and having a code length N of 64,800 bits and an encoding rate r of 8/9.

It is to be noted that FIG. 199 is a view continuing from FIG. 198 and FIG. 200 is a view continuing from FIG. 199. Further, FIG. 201 is a view continuing from FIG. 200.

FIGS. 202 to 205 show the parity check matrix initial value table for a parity check matrix H prescribed in the DVB-S.2 standard and having a code length N of 64,800 bits and an encoding rate r of 9/10.

It is to be noted that FIG. 203 is a view continuing from FIG. 202 and FIG. 204 is a view continuing from FIG. 203. Further, FIG. 205 is a view continuing from FIG. 204.

FIGS. 206 and 207 show the parity check matrix initial value table for a parity check matrix H prescribed in the DVB-S.2 standard and having a code length N of 64,800 bits and an encoding rate r of 1/4.

It is to be noted that FIG. 207 is a view continuing from FIG. 206.

FIGS. 208 and 209 show the parity check matrix initial value table for a parity check matrix H prescribed in the DVB-S.2 standard and having a code length N of 64,800 bits and an encoding rate r of 1/3.

It is to be noted that FIG. 209 is a view continuing from FIG. 208.

FIGS. 210 and 211 show the parity check matrix initial value table for a parity check matrix H prescribed in the DVB-S.2 standard and having a code length N of 64,800 bits and an encoding rate r of 2/5.

It is to be noted that FIG. 211 is a view continuing from FIG. 210.

FIGS. 212 to 214 show the parity check matrix initial value table for a parity check matrix H prescribed in the DVB-S.2 standard and having a code length N of 64,800 bits and an encoding rate r of 1/2.

It is to be noted that FIG. 213 is a view continuing from FIG. 212 and FIG. 214 is a view continuing from FIG. 213.

FIGS. 215 to 217 show the parity check matrix initial value table for a parity check matrix H prescribed in the DVB-S.2 standard and having a code length N of 64,800 bits and an encoding rate r of 3/5.

It is to be noted that FIG. 216 is a view continuing from FIG. 215 and FIG. 217 is a view continuing from FIG. 216.

FIG. 218 shows the parity check matrix initial value table for a parity check matrix H prescribed in the DVB-S. 2 standard and having a code length N of 16,200 bits and an encoding rate r of 1/4.

FIG. 219 shows the parity check matrix initial value table for a parity check matrix H prescribed in the DVB-S. 2 standard and having a code length N of 16,200 bits and an encoding rate r of 1/3.

FIG. 220 shows the parity check matrix initial value table for a parity check matrix H prescribed in the DVB-S. 2 standard and having a code length N of 16,200 bits and an encoding rate r of 2/5.

FIG. 221 shows the parity check matrix initial value table for a parity check matrix H prescribed in the DVB-S. 2 standard and having a code length N of 16,200 bits and an encoding rate r of 1/2.

FIG. 222 shows the parity check matrix initial value table for a parity check matrix H prescribed in the DVB-S. 2 standard and having a code length N of 16,200 bits and an encoding rate r of 3/5.

FIG. 223 shows the parity check matrix initial value table for a parity check matrix H having a code length N of 16,200 bits and an encoding rate r of 3/5, which can be used in place of the parity check matrix initial value table of FIG. 222.

The LDPC encoding section 21 of the transmission apparatus 11 determines a parity check matrix H in the following manner using the parity check matrix initial value tables.

In particular, FIG. 224 illustrates a method for determining a parity check matrix H from a parity check matrix initial value table.

It is to be noted that the parity check matrix initial value table of FIG. 224 indicates the parity check matrix initial value table for a parity check matrix H prescribed in the DVB-S.2 standard and having a code length N of 16,200 bits and an encoding rate r of 2/3 shown in FIG. 178.

As described above, the parity check matrix initial value table is a table which represents the position of elements of the value 1 of a information matrix $H_A$ corresponding to the information length K corresponding to the code length N and the encoding rate r of the LDPC code for every 360 columns (for every unit column number P of the cyclic structure), and in the first row of the parity check matrix initial value table, a number of row numbers of elements of the value 1 in the 1+360×(i-1)th column of the parity check matrix H (row numbers where the row number of the first row of the parity check matrix H is 0) equal to the number of column weights which the 1+360×(i-1)th column has.

Here, it is assumed that the parity matrix $H_T$ of the parity check matrix H corresponding to the parity length M has a staircase structure and is determined in advance. According to the parity check matrix initial value table, the information matrix $H_A$ corresponding to the information length K from within the parity check matrix H is determined.

The row number k+1 of the parity check matrix initial value table differs depending upon the information length K.

The information length K and the row number k+1 of the parity check matrix initial value table satisfy a relationship given by the following expression.

$$K = (k + 1) \times 360$$

Here, 360 in the expression above is the uni column number P of the cyclic structure.

In the parity check matrix initial value table of FIG. 224, 13 numerical values are listed in the first to third rows, and three numerical values are listed in the fourth to k+1th (in FIG. 224, 30th) rows.

Accordingly, the number of column weights in the parity check matrix H determined from the parity check matrix initial value table of FIG. 224 is 13 in the first to 1+360×(3-1)-1th rows but is 3 in the 1+360×(3-1)th to Kth rows.

The first row of the parity check matrix initial value table of FIG. 224 includes 0, 2084, 1613, 1548, 1286, 1460, 3196, 4297, 2481, 3369, 3451, 4620 and 2622, and this indicates that, in the first column of the parity check matrix H, the elements in rows of the row numbers of 0, 2084, 1613, 1548, 1286, 1460, 3196, 4297, 2481, 3369, 3451, 4620 and 2622 have the value 1 (and besides the other elements have the value 0).

Meanwhile, the second row of the parity check matrix initial value table of FIG. 224 includes 1, 122, 1516, 3448, 2880, 1407, 1847, 3799, 3529, 373, 971, 4358 and 3108, and this indicates that, in the 361st (= 1+360×(2-1)th) column of the parity check matrix H, the elements in rows of the row numbers of 1, 122, 1546, 3448, 2880, 1407, 1847, 3799, 3529, 373, 971, 4358 and 3108 have the value 1.

As given above, the parity check matrix initial value table represents the position of elements of the value 1 of the information matrix $H_A$ of the parity check matrix H for every 360 columns.

Each of the columns of the parity check matrix H other than the 1+360×(i-l)th column, that is, each of the columns from 2+360×(i-1)th to 360×ith columns, includes elements of the value of 1 obtained by cyclically shifting the elements of the value of 1 of the 1+360×(i-1)th column which depend upon the parity check matrix initial value table periodically in the downward direction (in the downward direction of the column) in accordance with the parity length M.

In particular, for example, the 2+360×(i-1)th column is a column obtained by cyclically shifting the 1+360×(i-1)th column in the downward direction by M/360 (= q), and the next 3+360×(i-1)th is a column obtained by cyclically shifting the 1+360×(i-1)th column in the downward direction by 2 × M/360 (= 2 × q) and then cyclically shifting the cyclically shifted column (2+360×(i-1)th column) in the downward direction by M/360 (= q).

Now, if it is assumed that the numeral value in the jth column (jth from the left) in the ith row (ith row from above) of the parity check matrix initial value table is represented by $b_{i,j}$ and the row number of the jth element of the value 1 in the wth column of the parity check matrix H is represented by $H_{w-j}$, then the row number $H_{w-j}$ of the element of the value 1 in the wth column which is a column other than the 1+360×(i-1)th column of the parity check matrix H can be determined in accordance with the following expression.

$$H_{w-j} = \text{mod}\{h_{i,j} + \text{mod}((w-1),P) \times q, M\}$$

Here, mod(x,y) signifies a remainder when x is divided by y.

Meanwhile, P is a unit number of columns of the cyclic structure described hereinabove and is, for example, in the DVB-S.2 standard, 360. Further, q is a value M/360 obtained by dividing the parity length M by the unit column number P (= 360) of the cyclic structure.

The LDPC encoding section 21 specifies the row number of the elements of the value 1 in the 1+360×(i-1)th column of the parity check matrix H from the parity check matrix initial value table.

Further, the LDPC encoding section 21 determines the row number $H_{w-j}$ of the element of the value 1 in the wth column which is a column other than the 1+360×(i-1)th column of the parity check matrix H and produces a parity check matrix H in which the elements of the row numbers obtained by the foregoing have the value 1.

Now, variations of the method of replacement of code bits of an LDPC code in the replacement process by the replacement section 32 of the demultiplexer 25 in the transmission apparatus 11, that is, of the allocation pattern (hereinafter referred to as bit allocation pattern) of code bits of an LDPC code and symbol bits representative of a symbol, are described.

In the demultiplexer 25, the code bits of the LDPC code are written in the column direction of the memory 31, which stores (N/(mb)) × (mb) bits in the column direction× row direction. Thereafter, the code bits are read out in a unit of mb bits in the row direction. Further, in the demultiplexer 25, the replacement section 32 replaces the mb code bits read out in the row direction of the memory 31 and determines the code bits after the replacement as mb symbol bits of (successive) b symbols.

In particular, the replacement section 32 determines the i+1th bit from the most significant bit of the mb code bits read out in the row direction of the memory 31 as the code bit $b_i$ and determines the i+1th bit from the most significant bit of the mb symbol bits of the b (successive) symbols as the symbol bit $y_i$, and then replaces the mb code bits $b_0$ to $b_{mb-1}$ in accordance with a predetermined bit allocation pattern.

FIG. 225 shows an example of a bit allocation pattern which can be adopted where the LDPC code is an LDPC code whose code length N is 64,800 bits and whose encoding rate is 5/6 or 9/10 and besides the modulation method is 4096QAM and the multiple b is 1.

Where the LDPC code is an LDPC code whose code length N is 64,800 bits and whose encoding rate is 5/6 or 9/10 and besides the modulation method is 4096QAM and the multiple b is 1, in the demultiplexer 25, the code bits written in the memory 31 for storing (64,800/(12 × 1)) × (12 × 1) bits in the column direction × row direction are read out in a unit of 12 × 1 (= mb) bits in the row direction and supplied to the replacement section 32.

The replacement section 32 replaces 12 × 1 (= mb) code bits $b_0$ to $b_{11}$ such that the 12 × 1 (= mb) code bits $b_0$ to $b_{11}$ to be read out from the memory 31 may be allocated to the 12 × 1 (= mb) symbol bits $y_0$ to $y_{11}$ of one (= b) symbol as seen in FIG. 225.

In particular, according to FIG. 225, the replacement section 32 carries out, with regard to both of an LDPC code having the encoding rate of 5/6 and an LDPC code having the encoding rate of 9/10 from among LDPC codes having the code length N of 64,800 bits, replacement for allocating
the code bit $b_0$ to the symbol bit $y_8$,
the code bit $b_1$ to the symbol bit $y_0$,
the code bit $b_2$ to the symbol bit $y_6$,
the code bit $b_3$ to the symbol bit $y_1$,
the code bit $b_4$ to the symbol bit $y_4$,
the code bit $b_5$ to the symbol bit $y_5$,
the code bit $b_6$ to the symbol bit $y_2$,
the code bit $b_7$ to the symbol bit $y_3$,
the code bit $b_8$ to the symbol bit $y_7$,
the code bit $b_9$ to the symbol bit $y_{10}$,
the code bit $b_{10}$ to the symbol bit $y_{11}$, and
the code bit $b_{11}$ to the symbol bit $y_9$.

FIG. 226 shows an example of a bit allocation pattern which can be adopted where the LDPC code is an LDPC code whose code length N is 64,800 bits and whose encoding rate is 5/6 or 9/10 and besides the modulation method is 4096QAM and the multiple b is 2.

Where the LDPC code is an LDPC code whose code length N is 64,800 bits and whose encoding rate is 5/6 or 9/10 and besides the modulation method is 4096QAM and the multiple b is 2, in the demultiplexer 25, the code bits written in the memory 31 for storing $(64{,}800/(12 \times 2)) \times (12 \times 2)$ bits in the column direction × row direction are read out in a unit of $12 \times 2$ (= mb) bits in the row direction and supplied to the replacement section 32.

The replacement section 32 replaces $12 \times 2$ (= mb) code bits $b_0$ to $b_{23}$ such that the $12 \times 2$ (= mb) code bits $b_0$ to $b_{23}$ to be read out from the memory 31 may be allocated to the $12 \times 2$ (= mb) symbol bits $y_0$ to $y_{23}$ of two (= b) successive symbols as seen in FIG. 226.

In particular, according to FIG. 226, the replacement section 32 carries out, with regard to both of an LDPC code having the encoding rate of 5/6 and an LDPC code having the encoding rate of 9/10 from among LDPC codes having the code length N of 64,800 bits, replacement for allocating
the code bit $b_0$ to the symbol bit $y_8$,
the code bit $b_2$ to the symbol bit $y_0$,
the code bit $b_4$ to the symbol bit $y_6$,
the code bit $b_6$ to the symbol bit $y_1$,
the code bit $b_8$ to the symbol bit $y_4$,
the code bit $b_{10}$ to the symbol bit $y_5$,
the code bit $b_{12}$ to the symbol bit $y_2$,
the code bit $b_{14}$ to the symbol bit $y_3$,
the code bit $b_{16}$ to the symbol bit $y_7$,
the code bit $b_{18}$ to the symbol bit $y_{10}$,
the code bit $b_{20}$ to the symbol bit $y_{11}$,
the code bit $b_{22}$ to the symbol bit $y_9$,
the code bit $b_1$ to the symbol bit $y_{20}$,
the code bit $b_3$ to the symbol bit $y_{12}$,
the code bit $b_5$ to the symbol bit $y_{18}$,
the code bit $b_7$ to the symbol bit $y_{13}$,
the code bit $b_9$ to the symbol bit $y_{16}$,
the code bit $b_{11}$ to the symbol bit $y_{17}$,
the code bit $b_{13}$ to the symbol bit $y_{14}$,
the code bit $b_{15}$ to the symbol bit $y_{15}$,
the code bit $b_{17}$ to the symbol bit $y_{19}$,
the code bit $b_{19}$ to the symbol bit $y_{22}$,
the code bit $b_{21}$ to the symbol bit $y_{23}$, and
the code bit $b_{23}$ to the symbol bit $y_{21}$.

Here, the bit allocation pattern of FIG. 226 utilizes the bit allocation pattern of FIG. 225 wherein the multiple b is 1 without any modification. In particular, in FIG. 226, the allocation of the code bits $b_0$, $b_2$, ..., $b_{22}$ to the symbol bits $y_i$ and the allocation of the $b_1$, $b_3$, ..., $b_{23}$ to the symbol bits $y_i$ are similar to the allocation of the code bits $b_0$ to $b_{11}$ to the symbol bits $y_1$ of FIG. 225.

FIG. 227 shows an example of a bit allocation pattern which can be adopted where the modulation method is 1024QAM and the LDPC code is an LDPC code whose code length N is 16,200 bits and whose encoding rate is 3/4, 5/6 or 8/9 and besides the multiple b is 2 and also where the modulation method is 1024QAM and the LDPC code is an LDPC code whose code length N is 64,800 bits and whose encoding length is 3/4, 5/6 or 9/10 and besides the multiple b is 2.

Where the LDPC code is an LDPC code whose code length N is 16,200 bits and whose encoding rate is 3/4, 5/6 or 8/9 and the modulation method is 1024QAM and besides the multiple b is 2, in the demultiplexer 25, the code bits written in the memory 31 for storing (16,200/(10 × 2)) × (10 × 2) bits in the column direction × row direction are read out in a unit of 10 × 2 (= mb) bits in the row direction and supplied to the replacement section 32.

On the other hand, where the LDPC code is an LDPC code whose code length N is 64,800 bits and whose encoding rate is 3/4, 5/6 or 9/10 and the modulation method is 1024QAM and besides the multiple b is 2, in the demultiplexer 25, the code bits written in the memory 31 for storing (64,800/(10 × 2)) × (10 × 2) bits in the column direction × row direction are read out in a unit of 10 × 2 (= mb) bits in the row direction and supplied to the replacement section 32.

The replacement section 32 replaces 10 × 2 (= mb) code bits $b_0$ to $b_{19}$ such that the 10 × 2 (= mb) code bits $b_0$ to $b_{19}$ to be read out from the memory 31 may be allocated to the 10 × 2 (= mb) symbol bits $y_0$ to $y_{19}$ of two (= b) successive symbols as seen in FIG. 227.

In particular, according to FIG. 227, the replacement section 32 carries out, with regard to all of the LDPC codes having the encoding rate of 3/4, LDPC codes having the encoding rate of 5/6 and LDPC codes having a further encoding rate of 8/9 from among LDPC codes having the code length of 16,200 bits as well as LDPC code having the encoding rate of 3/4, LDPC codes having the encoding rate of 5/6 and LDPC codes having a further encoding rate of 9/10 from among LDPC codes having another code length N of 64,800, replacement for allocating
the code bit $b_0$ to the symbol bit $y_8$,
the code bit $b_1$ to the symbol bit $y_3$,
the code bit $b_2$ to the symbol bit $y_7$,
the code bit $b_3$ to the symbol bit $y_{10}$,
the code bit $b_4$ to the symbol bit $y_{19}$,
the code bit $b_5$ to the symbol bit $y_4$,
the code bit $b_6$ to the symbol bit $y_9$,
the code bit $b_7$ to the symbol bit $y_5$,
the code bit $b_8$ to the symbol bit $y_{17}$,
the code bit $b_9$ to the symbol bit $y_6$,
the code bit $b_{10}$ to the symbol bit $y_{14}$,
the code bit $b_{11}$ to the symbol bit $y_{11}$,
the code bit $b_{12}$ to the symbol bit $y_2$,
the code bit $b_{13}$ to the symbol bit $y_{18}$,
the code bit $b_{14}$ to the symbol bit $y_{16}$,
the code bit $b_{15}$ to the symbol bit $y_{15}$,
the code bit $b_{16}$ to the symbol bit $y_0$,
the code bit $b_{17}$ to the symbol bit $y_1$,
the code bit $b_{18}$ to the symbol bit $y_{13}$, and
the code bit $b_{19}$ to the symbol bit $y_{12}$.

FIG. 228 shows an example of a bit allocation pattern which can be adopted where the modulation method is 4096QAM and the LDPC code is an LDPC code whose code length N is 16,200 bits and whose encoding rate is 5/6 or 8/9 and besides the multiple b is 2 and also where the modulation method is 4096QAM and the LDPC code is an LDPC code whose code length N is 64,800 bits and whose encoding rate is 5/6 or 9/10 and besides the multiple b is 2.

Where the LDPC code is an LDPC code whose code length N is 16,200 bits and whose encoding rate is 5/6 or 8/9 and the modulation method is 4096QAM and besides the multiple b is 2, in the demultiplexer 25, the code bits written in the memory 31 for storing (16,200/(12 × 2)) × (12 × 2) bits in the column direction × row direction are read out in a unit of 12 × 2 (= mb) bits in the row direction and supplied to the replacement section 32.

On the other hand, where the LDPC code is an LDPC code whose code length N is 64,800 bits and whose encoding rate is 5/6 or 9/10 and the modulation method is 4096QAM and besides the multiple b is 2, in the demultiplexer 25, the code bits written in the memory 31 for storing (64,800/(12 × 2)) × (12 × 2) bits in the column direction row direction are read out in a unit of 12 × 2 (= mb) bits in the row direction and supplied to the replacement section 32.

The replacement section 32 replaces 12 × 2 (= mb) code bits $b_0$ to $b_{23}$ such that the 12 × 2 (= mb) bits to be read out from the memory 31 may be allocated to the 12 × 2 (= mb) symbol bits $y_0$ to $y_{23}$ of two (= b) successive symbols as seen in FIG. 228.

In particular, according to FIG. 228, the replacement section 32 carries out, with regard to all of the LDPC codes having the encoding rate of 5/6 and LDPC codes having the encoding rate of 8/9 from among LDPC codes having the code length of 16,200 bits as well as LDPC codes having the encoding rate of 5/6 and LDPC codes having the encoding rate of 9/10 from among LDPC codes having another code length N of 64,800, replacement for allocating
the code bit $b_0$ to the symbol bit $y_{10}$,
the code bit $b_1$ to the symbol bit $y_{15}$,
the code bit $b_2$ to the symbol bit $y_4$,

the code bit $b_3$ to the symbol bit $y_{19}$,
the code bit $b_4$ to the symbol bit $y_{21}$,
the code bit $b_5$ to the symbol bit $y_{16}$,
the code bit $b_6$ to the symbol bit $y_{23}$,
the code bit $b_7$ to the symbol bit $y_{18}$,
the code bit $b_8$ to the symbol bit $y_{11}$,
the code bit $b_9$ to the symbol bit $y_{14}$,
the code bit $b_{10}$ to the symbol bit $y_{22}$,
the code bit $b_{11}$ to the symbol bit $y_5$,
the code bit $b_{12}$ to the symbol bit $y_6$,
the code bit $b_{13}$ to the symbol bit $y_{17}$,
the code bit $b_{14}$ to the symbol bit $y_{13}$,
the code bit $b_{15}$ to the symbol bit $y_{20}$,
the code bit $b_{16}$ to the symbol bit $y_1$,
the code bit $b_{17}$ to the symbol bit $y_3$,
the code bit $b_{18}$ to the symbol bit $y_9$,
the code bit $b_{19}$ to the symbol bit $y_2$,
the code bit $b_{20}$ to the symbol bit $y_7$,
the code bit $b_{21}$ to the symbol bit $y_8$,
the code bit $b_{22}$ to the symbol bit $y_{12}$, and
the code bit $y_{23}$ to the symbol bit $y_0$.

According to the bit allocation patterns shown in FIGS. 225 to 228, the same bit allocation pattern can be adopted for a plurality of kinds of LDPC codes, and besides, the tolerance to errors can be set to a desired performance with regard to all of the plural kinds of LDPC codes.

In particular, FIGS. 229 to 232 illustrates results of simulations of the BER (Bit Error Rate) where a replacement process is carried out in accordance with the bit allocation patterns of FIGS. 225 to 228.

It is to be noted that, in FIGS. 229 to 232, the axis of abscissa represents $E_s/N_O$ (signal power to noise power ratio per one symbol) and the axis of ordinate represents the BER.

Further, a solid line curve represents the BER where a replacement process is carried out and an alternate long and short dash line represents the BER where a replacement process is not carried out.

FIG. 229 illustrates the BER where a replacement process in accordance with the bit allocation pattern of FIG. 225 is carried out for LDPC codes whose code length N is 64,800 and whose encoding rate is 5/6 and 9/10 adopting 4096QAM as the modulation method and setting the multiple b to 1.

FIG. 230 illustrates the BER where a replacement process in accordance with the bit allocation pattern of FIG. 226 is carried out for LDPC codes whose code length N is 64,800 and whose encoding rate is 5/6 and 9/10 adopting 4096QAM as the modulation method and setting the multiple b to 2.

It is to be noted that, in FIGS. 229 and 230, a graph having a triangular mark applied thereto represents the BER regarding the LDPC code having the encoding rate of 5/6, and a graph having an asterisk applied thereto represents the BER regarding the LDPC code having the encoding rate of 9/10.

FIG. 231 illustrates the BER where a replacement process in accordance with the bit allocation pattern of FIG. 227 is carried out for LDPC codes whose code length N is 16,200 and whose encoding rate is 3/4, 5/6 and 8/9 and for LDPC codes whose code length N is 64,800 and whose encoding rate is 3/4, 5/6 and 9/10 adopting 1024QAM as the modulation method and setting the multiple b to 2.

It is to be noted that, in FIG. 231, a graph having an asterisk applied thereto represents the BER regarding the LDPC code having the code length N of 64,800 and the encoding rate of 9/10, and a graph having an upwardly directed triangular mark applied thereto represents the BER regarding the LDPC codes having the code length N of 64,800 and the encoding rate of 5/6. Further, a graph having a square mark applied thereto represents the BER regarding the LDPC code having the code length N of 64,800 and the encoding rate of 3/4.

Further, in FIG. 231, a graph having a round mark applied thereto represents the BER regarding the LDPC code having the code length N of 16,200 and the encoding rate of 8/9, and a graph having a downwardly directed triangular mark applied thereto represents the BER regarding the LDPC code having the code length N of 16,200 and the encoding rate of 5/6. Further, a graph having a plus mark applied thereto represents the BER regarding the LDPC code having the code length N of 16,200 and the encoding rate of 3/4.

FIG. 232 illustrates the BER where a replacement process in accordance with the bit allocation pattern of FIG. 228 is carried out for LDPC codes whose code length N is 16,200 and whose encoding rate is 5/6 and 8/9 and for LDPC codes whose code length N is 64,800 and whose encoding rate is 5/6 and 9/10 adopting 4096QAM as the modulation method and setting the multiple b to 2.

It is to be noted that, in FIG. 232, a graph having an asterisk applied thereto represents the BER regarding the LDPC code having the code length N of 64,800 and the encoding rate of 9/10, and a graph having an upwardly directed triangular mark applied thereto represents the BER regarding the LDPC codes having the code length N of 64,800 and the encoding rate of 5/6.

Further, in FIG. 232, a graph having a round mark applied thereto represents the BER regarding the LDPC code having the code length N of 16,200 and the encoding rate of 8/9, and a graph having a downwardly directed triangular mark applied thereto represents the BER regarding the LDPC code having the code length N of 16,200 and the encoding rate of 5/6.

According to FIGS. 229 to 232, the same bit allocation pattern can be adopted with regard to a plurality of kinds of LDPC codes. Besides, the tolerance to errors can be set to a desired performance with regard to all of the plural kinds of LDPC codes.

In particular, where a bit allocation pattern for exclusive use is adopted for each of a plurality of kinds of LDPC codes which have different code lengths and different encoding rates, the tolerance to an error can be raised to a very high performance. However, it is necessary to change the bit allocation pattern for each of a plurality of kinds of LDPC codes.

On the other hand, according to the bit allocation patterns of FIGS. 225 to 228, the same bit allocation pattern can be adopted for a plurality of kinds of LDPC codes which have different code lengths and different encoding rates, and the necessity to change the bit allocation pattern for each of a plurality of kinds of LDPC codes as in a case wherein a bit allocation pattern for exclusive use is adopted for each of a plurality of kinds of LDPC codes is eliminated.

Further, according to the bit allocation patterns of FIGS. 225 to 228, the tolerance to errors can be raised to a high performance although it is a little lower than that where a bit allocation pattern for exclusive use is adopted for each of a plurality of kinds of LDPC codes.

In particular, for example, where the modulation method is 4096QAM, the same bit allocation pattern in FIG. 225 or 226 can be used for all of the LDPC codes which have the code length N of 64,800 and the encoding rate of 5/6 and 9/10. Even where the same bit allocation pattern is adopted in this manner, the tolerance to errors can be raised to a high performance.

Further, for example, where the modulation method is 1024QAM, the same bit allocation pattern of FIG. 227 can be adopted for all of the LDPC codes which have the code length N of 16,200 and the encoding rate of 3/4, 5/6 and 8/9 and the LDPC codes which have the code length N of 64,800 and the encoding rate of 3/4, 5/6 and 9/10. Then, even if the same bit allocation pattern is adopted in this manner, the tolerance to errors can be raised to a high performance.

Meanwhile, for example, where the modulation method is 4096QAM, the same bit allocation pattern of FIG. 228 can be adopted for all of the LDPC codes which have the code length N of 16,200 and the encoding rate of 5/6 and 8/9 and the LDPC codes which have the code length N of 64,800 and the encoding rate of 5/6 and 9/10. Then, even if the same bit allocation pattern is adopted in this manner, the tolerance to errors can be raised to a high performance.

Variations of the bit allocation pattern are further described.

FIG. 233 illustrates an example of a bit allocation pattern which can be adopted where the LDPC code is any LDPC code which has the code length N of 16,200 or 64,800 bits and one of the encoding rates for the LDPC code defined by a parity check matrix H produced, for example, from any of the parity check matrix initial value tables shown in FIGS. 178 to 223 other than the encoding rate of 3/5 and besides the modulation method is QPSK and the multiple b is 1.

Where the LDPC code is an LDPC code which has the code length N of 16,200 or 64,800 bits and has the encoding rate other than 3/5 and besides the modulation method is QPSK and the multiple b is 1, the demultiplexer 25 reads out code bits written in the memory 31 for storing $(N/(2 \times 1)) \times (2 \times 1)$ bits in the column direction $\times$ row direction in a unit of $2 \times 1$ (= mb) bits in the row direction and supplies the read out code bits to the replacement section 32.

The replacement section 32 replaces the $2 \times 1$ (= mb) code bits $b_0$ and $b_1$ read out from the memory 31 in such a manner that the $2 \times 1$ (= mb) code bits $b_0$ and $b_1$ are allocated to the $2 \times 1$ (= mb) symbol bits $y_0$ and $y_1$ of one (= b) symbol as seen in FIG. 233.

In particular, according to FIG. 233, the replacement section 32 carries out replacement for allocating
the code bit $b_0$ to the symbol bit $y_0$, and
the code bit $b_1$ to the symbol bit $y_1$.

It is to be noted that, in this instance, also it is possible to consider that replacement is not carried out and the code bits $b_0$ and $b_1$ are determined as they are as the symbol bits $y_0$ and $y_1$, respectively.

FIG. 234 shows an example of a bit allocation pattern which can be adopted where the LDPC code is an LDPC code which has the code length N of 16,200 or 64,800 bits and has the encoding rate other than 3/5 and besides the modulation method is 16QAM and the multiple b is 2.

Where the LDPC code is an LDPC code which has the code length N of 16,200 or 64,800 bits and has the encoding rate other than 3/5 and besides the modulation method is 16QAM and the multiple b is 2, the demultiplexer 25 reads out the code bits written in the memory 31 for storing $(N/(4 \times 2)) \times (4 \times 2)$ bits in the column direction $\times$ row direction in a unit of $4 \times 2$ (= mb) bits in the row direction and supplies the read out code bits to the replacement section 32.

The replacement section 32 replaces the $4 \times 2$ (= mb) code bits $b_0$ to $b_7$ read out from the memory 31 in such a manner that the 4 × 2 (= mb) code bits are allocated to the 4 × 2 (= mb) symbol bits $y_0$ to $y_7$ of two (= b) successive symbols as seen in FIG. 234.

In particular, according to FIG. 234, the replacement section 32 carries out replacement for allocating
the code bit $b_0$ to the symbol bit $y_7$,
the code bit $b_1$ to the symbol bit $y_1$,
the code bit $b_2$ to the symbol bit $y_4$,
the code bit $b_3$ to the symbol bit $y_2$,
the code bit $b_4$ to the symbol bit $y_5$,
the code bit $b_5$ to the symbol bit $y_3$,
the code bit $b_6$ to the symbol bit $y_6$, and
the code bit $b_7$ to the symbol bit $y_0$.

FIG. 235 shows an example of a bit allocation pattern which can be adopted where the modulation method is 64QAM and the LDPC code is an LDPC code whose code length N is 16,200 or 64,800 bits and whose encoding rate is any other than 3/5 and besides the multiple b is 2.

Where the LDPC code is an LDPC code whose code length N is 16,200 or 64,800 bits and whose encoding rate is any other than 3/5 and the modulation method is 64QAM and besides the multiple b is 2, in the demultiplexer 25, the code bits written in the memory 31 for storing (N/(6 × 2)) × (6 × 2) bits in the column directions × row direction are read out in a unit of 6 × 2 (= mb) bits in the row direction and supplied to the replacement section 32.

The replacement section 32 replaces the 6 × 2 (= mb) code bits $b_0$ to $b_{11}$ read out from the memory 31 such that the 6 × 2 (= mb) code bits $b_1$ to $b_{11}$ may be allocated to the 6 × 2 (= mb) symbol bits $y_0$ to $y_{11}$ of two (= b) successive symbols as seen in FIG. 235.

In particular, according to FIG. 235, the replacement section 32 carries out replacement for allocating
the code bit $b_0$ to the symbol bit $y_{11}$,
the code bit $b_1$ to the symbol bit $y_7$,
the code bit $b_2$ to the symbol bit $y_3$,
the code bit $b_3$ to the symbol bit $y_{10}$,
the code bit $b_4$ to the symbol bit $y_6$,
the code bit $b_5$ to the symbol bit $y_2$,
the code bit $b_6$ to the symbol bit $y_9$,
the code bit $b_7$ to the symbol bit $y_5$,
the code bit $b_8$ to the symbol bit $y_1$,
the code bit $b_9$ to the symbol bit $y_8$,
the code bit $b_{10}$ to the symbol bit $y_4$, and
the code bit $b_{11}$ to the symbol bit $y_0$.

FIG. 236 shows an example of a bit allocation pattern which can be adopted where the modulation method is 256QAM and the LDPC code is an LDPC code whose code length N is 64,800 bits and whose encoding rate is any other than 3/5 and besides the multiple b is 2.

Where the LDPC code is an LDPC code whose code length N is 64,800 bits and whose encoding rate is any other than 3/5 and the modulation method is 256QAM and besides the multiple b is 2, in the demultiplexer 25, the code bits written in the memory 31 for storing (64,800/(8 × 2)) × (8 × 2) bits in the column direction × row direction are read out in a unit of 8 × 2 (= mb) bits in the row direction and supplied to the replacement section 32.

The replacement section 32 replaces the 8 × 2 (= mb) code bits $b_0$ to $b_{15}$ read out from the memory 31 such that the 8 × 2 (= mb) code bits $b_0$ to $b_{15}$ may be allocated to the 8 × 2 (= mb) symbol bits $y_0$ to $y_{15}$ of two (= b) successive symbols as seen in FIG. 236.

In particular, according to FIG. 236, the replacement section 32 carries out replacement for allocating
the code bit $b_0$ to the symbol bit $y_{15}$,
the code bit $b_1$ to the symbol bit $y_1$,
the code bit $b_2$ to the symbol bit $y_{13}$,
the code bit $b_3$ to the symbol bit $y_3$,
the code bit $b_4$ to the symbol bit $y_8$,
the code bit $b_5$ to the symbol bit $y_{11}$,
the code bit $b_6$ to the symbol bit $y_9$,
the code bit $b_7$ to the symbol bit $y_5$,
the code bit $b_8$ to the symbol bit $y_{10}$,
the code bit $b_9$ to the symbol bit $y_6$,
the code bit $b_{10}$ to the symbol bit $y_4$,
the code bit $b_{11}$ to the symbol bit $y_7$,
the code bit $b_{12}$ to the symbol bit $y_{12}$,

the code bit $b_{13}$ to the symbol bit $y_2$,
the code bit $b_{14}$ to the symbol bit $y_{14}$, and
the code bit $b_{15}$ to the symbol bit $y_0$.

FIG. 237 shows an example of a bit allocation pattern which can be adopted where the modulation method is 256QAM and the LDPC code is an LDPC code whose code length N is 16,200 bits and whose encoding rate is any other than 3/5 and besides the multiple b is 1.

Where the LDPC code is an LDPC code whose code length N is 16,200 bits and whose encoding rate is any other than 3/5 and the modulation method is 256QAM and besides the multiple b is 1, in the demultiplexer 25, the code bits written in the memory 31 for storing (16,200/(8 × 1)) × (8 × 1) bits in the column direction × row direction are read out in a unit of 8 × 1 (= mb) bits in the row direction and supplied to the replacement section 32.

The replacement section 32 replaces the 8 × 1 (= mb) code bits $b_0$ to $b_7$ read out from the memory 31 such that the 8 × 1 (= mb) code bits $b_0$ to $b_7$ may be allocated to the 8 × 1 (= mb) symbol bits $y_0$ to $y_7$ of one (= b) symbol as seen in FIG. 237.

In particular, according to FIG. 237, the replacement section 32 carries out replacement for allocating
the code bit $b_0$ to the symbol bit $y_7$,
the code bit $b_1$ to the symbol bit $y_3$,
the code bit $b_2$ to the symbol bit $y_1$,
the code bit $b_3$ to the symbol bit $y_5$,
the code bit $b_4$ to the symbol bit $y_2$,
the code bit $b_5$ to the symbol bit $y_6$,
the code bit $b_6$ to the symbol bit $y_4$, and
the code bit $b_7$ to the symbol bit $y_0$.

FIG. 238 shows an example of a bit allocation pattern which can be adopted where the LDPC code is an LDPC code whose code length N is 16,200 or 64,800 bits and whose encoding rate is any other than 3/5 and besides the modulation method is QPSK and the multiple b is 1.

Where the LDPC code is an LDPC code whose code length N is 16,200 or 64,800 bits and whose encoding rate is any other than 3/5 and besides the modulation method is QPSK and the multiple b is 1, in the demultiplexer 25, the code bits written in the memory 31 for storing (N/(2 × 1)) × (2 × 1) bits in the column direction × row direction are read out in a unit of 2 × 1 (= mb) bits in the row direction and supplied to the replacement section 32.

The replacement section 32 replaces the 2 × 1 (= mb) code bits $b_0$ and $b_1$ read out from the memory 31 such that the 2 × 1 (= mb) code bits $b_0$ and $b_1$ may be allocated to the 2 × 1 (= mb) symbol bits $y_0$ and $y_1$ of one (= b) symbol as seen in FIG. 238.

In particular, according to FIG. 238, the replacement section 32 carries out replacement for allocating
the code bit $b_0$ to the symbol bit $y_0$, and
the code bit $b_1$ to the symbol bit $y_2$.

It is to be noted that, in this instance, also it is possible to consider that replacement is not carried out and the code bits $b_0$ and $b_1$ are determined as they are as the symbol bits $y_0$ and $y_1$, respectively.

FIG. 239 shows an example of a bit allocation pattern which can be adopted where the LDPC code is an LDPC code whose code length N is 64,800 bits and whose encoding rate is 3/5 and besides the modulation method is 16QAM and the multiple b is 2.

Where the LDPC code is an LDPC code whose code length N is 64,800 bits and whose encoding rate is 3/5 and besides the modulation method is 16QAM and the multiple b is 2, in the demultiplexer 25, the code bits written in the memory 31 for storing (64,800/(4 × 2)) × (4 × 2) bits in the column direction × row direction are read out in a unit of 4 × 2 (= mb) bits in the row direction and supplied to the replacement section 32.

The replacement section 32 replaces the 4 × 2 (= mb) code bits $b_0$ to $b_7$ read out from the memory 31 such that the 4 × 2 (= mb) code bits $b_0$ to $b_7$ may be allocated to the 4 × 2 (= mb) symbol bits $y_0$ to $y_7$ of two (= b) successive symbols as seen in FIG. 239.

In particular, according to FIG. 239, the replacement section 32 carries out replacement for allocating
the code bit $b_0$ to the symbol bit $y_0$,
the code bit $b_1$ to the symbol bit $y_5$,
the code bit $b_2$ to the symbol bit $y_1$,
the code bit $b_3$ to the symbol bit $y_2$,
the code bit $b_4$ to the symbol bit $y_9$, the code bit $b_5$ to the symbol bit $y_7$,
the code bit $b_6$ to the symbol bit $y_3$, and
the code bit $b_7$ to the symbol bit $y_6$.

FIG. 240 shows an example of a bit allocation pattern which can be adopted where the LDPC code is an LDPC code whose code length N is 16,200 bits and whose encoding rate is 3/5 and besides the modulation method is 16QAM and the multiple b is 2.

Where the LDPC code is an LDPC code whose code length N is 16,200 bits and whose encoding rate is 3/5 and besides the modulation method is 16QAM and the multiple b is 2, in the demultiplexer 25, the code bits written in the memory 31 for storing (16,200/(4 × 2)) × (4 × 2) bits in the column direction × row direction are read out in a unit of 4 × 2 (= mb) bits in the row direction and supplied to the replacement section 32.

The replacement section 32 replaces the 4 × 2 (= mb) code bits $b_0$ to $b_7$ read out from the memory 31 such that the 4 × 2 (= mb) code bits $b_0$ to $b_7$ may be allocated to the 4 × 2 (= mb) symbol bits $y_0$ to $y_7$ of two (= b) successive symbols as seen in FIG. 240.

In particular, according to FIG. 240, the replacement section 32 carries out replacement for allocating
the code bit $b_0$ to the symbol bit $y_7$,
the code bit $b_1$ to the symbol bit $y_1$,
the code bit $b_2$ to the symbol bit $y_4$,
the code bit $b_3$ to the symbol bit $y_2$,
the code bit $b_4$ to the symbol bit $y_5$,
the code bit $b_5$ to the symbol bit $y_3$,
the code bit $b_6$ to the symbol bit $y_6$, and
the code bit $b_7$ to the symbol bit $y_0$.

FIG. 241 shows an example of a bit allocation pattern which can be adopted where the modulation method is 64QAM and the LDPC code is an LDPC code whose code length N is 64,800 bits and whose encoding rate is 3/5 and besides the multiple b is 2.

Where the LDPC code is an LDPC code whose code length N is 64,800 bits and whose encoding rate is 3/5 and the modulation method is 64QAM and besides the multiple b is 2, in the demultiplexer 25, the code bits written in the memory 31 for storing (64,800/(6 × 2)) × (6 × 2) bits in the column direction × row direction are read out in a unit of 6 × 2 (= mb) bits in the row direction and supplied to the replacement section 32.

The replacement section 32 replaces the 6 × 2 (= mb) code bits $b_0$ to $b_{11}$ read out from the memory 31 such that the 6 × 2 (= mb) code bits $b_0$ to $b_{11}$ may be allocated to the 6 × 2 (= mb) symbol bits $y_0$ to $y_{11}$ of two (= b) successive symbols as seen in FIG. 241.

In particular, according to FIG. 241, the replacement section 32 carries out replacement for allocating
the code bit $b_0$ to the symbol bit $y_2$,
the code bit $b_1$ to the symbol bit $y_7$,
the code bit $b_2$ to the symbol bit $y_6$,
the code bit $b_3$ to the symbol bit $y_9$,
the code bit $b_4$ to the symbol bit $y_0$,
the code bit $b_5$ to the symbol bit $y_3$,
the code bit $b_6$ to the symbol bit $y_1$,
the code bit $b_7$ to the symbol bit $y_8$,
the code bit $b_8$ to the symbol bit $y_4$,
the code bit $b_9$ to the symbol bit $y_{11}$
the code bit $b_{10}$to the symbol bit $y_5$, and
the code bit $b_{11}$ to the symbol bit $y_{10.}$

FIG. 242 shows an example of a bit allocation pattern which can be adopted where the modulation method is 64QAM and the LDPC code is an LDPC code whose code length N is 16,200 bits and whose encoding rate is 3/5 and besides the multiple b is 2.

Where the LDPC code is an LDPC code whose code length N is 16,200 bits and whose encoding rate is 3/5 and the modulation method is 64QAM and besides the multiple b is 2, in the demultiplexer 25, the code bits written in the memory 31 for storing (16,200/(6 × 2)) × (6 × 2) bits in the column direction × row direction are read out in a unit of 6 × 2 (= mb) bits in the row direction and supplied to the replacement section 32.

The replacement section 32 replaces the 6 × 2 (= mb) code bits $b_0$ to $b_{11}$ read out from the memory 31 such that the 6 × 2 (= mb) code bits $b_0$ to $b_{11}$ may be allocated to the 6 × 2 (= mb) symbol bits $y_0$ to $y_{11}$ of two (= b) successive symbols as seen in FIG. 242.

In particular, according to FIG. 242, the replacement section 32 carries out replacement for allocating
the code bit $b_0$ to the symbol bit $y_{11}$,
the code bit $b_1$ to the symbol bit $y_7$,
the code bit $b_2$ to the symbol bit $y_3$,
the code bit $b_3$ to the symbol bit $y_{10}$,
the code bit $b_4$ to the symbol bit $y_6$,
the code bit $b_5$ to the symbol bit $y_2$,
the code bit $b_6$ to the symbol bit $y_9$,
the code bit $b_7$ to the symbol bit $y_5$,

the code bit $b_8$ to the symbol bit $y_1$,
the code bit $b_9$ to the symbol bit $y_8$,
the code bit $b_{10}$ to the symbol bit $y_4$, and
the code bit $b_{11}$ to the symbol bit $y_0$.

FIG. 243 shows an example of a bit allocation pattern which can be adopted where the modulation method is 256QAM and the LDPC code is an LDPC code whose code length N is 64,800 bits and whose encoding rate is 3/5 and besides the multiple b is 2.

Where the LDPC code is an LDPC code whose code length N is 64,800 bits and whose encoding rate is 3/5 and the modulation method is 256QAM and besides the multiple b is 2, in the demultiplexer 25, the code bits written in the memory 31 for storing (64,800/(8 × 2)) × (8 × 2) bits in the column direction × row direction are read out in a unit of 8 × 2 (= mb) bits in the row direction and supplied to the replacement section 32.

The replacement section 32 replaces the 8 × 2 (= mb) code bits $b_0$ to bits read out from the memory 31 such that the 8 × 2 (= mb) code bits $b_0$ to $b_{15}$ may be allocated to the 8 × 2 (= mb) symbol bits $y_0$ to $y_{15}$ of two (= b) successive symbols as seen in FIG. 243.

In particular, according to FIG. 243, the replacement section 32 carries out replacement for allocating
the code bit $b_0$ to the symbol bit $y_2$,
the code bit $b_1$ to the symbol bit $y_{11}$,
the code bit $b_2$ to the symbol bit $y_3$,
the code bit $b_3$ to the symbol bit $y_4$,
the code bit $b_4$ to the symbol bit $y_0$,
the code bit $b_5$ to the symbol bit $y_9$,
the code bit $b_6$ to the symbol bit $y_1$,
the code bit $b_7$ to the symbol bit $y_8$,
the code bit $b_8$ to the symbol bit $y_{10}$,
the code bit $b_9$ to the symbol bit $y_{13}$,
the code bit $b_{10}$ to the symbol bit $y_7$,
the code bit $b_{11}$ to the symbol bit $y_{14}$,
the code bit $b_{12}$ to the symbol bit $y_6$,
the code bit $b_{13}$ to the symbol bit $y_{15}$,
the code bit $b_{19}$ to the symbol bit $y_5$, and
the code bit $b_{15}$ to the symbol bit $y_{12}$.

FIG. 244 shows an example of a bit allocation pattern which can be adopted where the modulation method is 256QAM and the LDPC code is an LDPC code whose code length N is 16,200 bits and whose encoding rate is 3/5 and besides the multiple b is 1.

Where the LDPC code is an LDPC code whose code length N is 16,200 bits and whose encoding rate is 3/5 and the modulation method is 256QAM and besides the multiple b is 1, in the demultiplexer 25, the code bits written in the memory 31 for storing (16,200/(8 × 1)) × (8 × 1) bits in the column direction × row direction are read out in a unit of 8 × 1 (= mb) bits in the row direction and supplied to the replacement section 32.

The replacement section 32 replaces the 8 × 1 (= mb) code bits $b_0$ to $b_7$ read out from the memory 31 such that the 8 × 1 (= mb) code bits $b_0$ to $b_7$ may be allocated to the 8 × 1 (= mb) symbol bits $y_0$ to $y_7$ of one (= b) symbol as seen in FIG. 244.

In particular, according to FIG. 244, the replacement section 32 carries out replacement for allocating
the code bit $b_0$ to the symbol bit $y_7$,
the code bit $b_1$ to the symbol bit $y_3$,
the code bit $b_2$ to the symbol bit $y_1$,
the code bit $b_3$ to the symbol bit $y_5$,
the code bit $b_4$ to the symbol bit $y_2$,
the code bit $b_5$ to the symbol bit $y_6$,
the code bit $b_6$ to the symbol bit $y_4$, and
the code bit $b_7$ to the symbol bit $y_0$.

Now, the deinterleaver 53 which composes the reception apparatus 12 is described.

FIG. 245 is a view illustrating processing of the multiplexer 54 which composes the deinterleaver 53.

In particular, A of FIG. 245 shows an example of a functional configuration of the multiplexer 54.

The multiplexer 54 is composed of a reverse replacement section 1001 and a memory 1002.

The multiplexer 54 determines symbol bits of symbols supplied from the demapping section 52 at the preceding stage as an object of processing thereof and carries out a reverse replacement process corresponding to the replacement process carried out by the demultiplexer 25 of the transmission apparatus 11 (process reverse to the replacement process), that is, a reverse replacement process of returning the positions of the code bits (symbol bits) of the LDPC code replaced by the replacement process. Then, the multiplexer 54 supplies an LDPC code obtained as a result of the reverse replacement process to the column twist deinterleaver 55 at the succeeding stage.

In particular, in the multiplexer 54, mb symbol bits $y_0$, $y_1$, ..., $y_{mb-1}$ of b symbols are supplied in a unit of b (successive) symbols to the reverse replacement section 1001.

The reverse replacement section 1001 carries out reverse replacement of returning the arrangement of the mb symbol bits $y_0$ to $y_{mb-1}$ to the original arrangement of the mb code bits $b_0$, $b_1$, ..., $b_{mb-1}$ (arrangement of the code bits $b_0$ to $b_{mb-1}$ before the replacement by the replacement section 32 which composes the demultiplexer 25 on the transmission apparatus 11 side is carried out). The reverse replacement section 1001 outputs code bits $b_0$ to $b_{mb-1}$ obtained as a result of the reverse replacement.

The memory 1002 has a storage capacity of storing mb bits in the row (horizontal) direction and storing N/(mb) bits in the column (vertical) direction similarly to the memory 31 which composes the demultiplexer 25 of the transmission apparatus 11 side. In other words, the reverse replacement section 1001 is configured from mb columns each of which stores N/(mb) bits.

However, in the memory 1002, writing of the code bits of LDPC codes outputted from the reverse replacement section 1001 is carried out in a direction in which reading out of code bits from the memory 31 of the demultiplexer 25 of the transmission apparatus 11 is carried out, and reading out of code bits written in the memory 1002 is carried out in a direction in which writing of code bits into the memory 31 is carried out.

In particular, the multiplexer 54 of the reception apparatus 12 successively carries out writing of code bits of an LDPC code outputted from the reverse replacement section 1001 in a unit of mb bits in the row direction beginning with the first row of the memory 1002 toward a lower low as seen in A of FIG. 245.

Then, when the writing of code bits for one code length ends, the multiplexer 54 reads out the code bits in the column direction from the memory 1002 and supplies the code bits to the column twist deinterleaver 55 at the succeeding stage.

Here, B of FIG. 245 is a view illustrating reading out of the code bits from the memory 1002.

The multiplexer 54 carries out reading out of code bits of an LDPC code in a downward direction (column direction) from above of a column which composes the memory 1002 beginning with a leftmost column toward a right side column.

Now, processing of the column twist deinterleaver 55 which composes the deinterleaver 53 of the reception apparatus 12 is described with reference to FIG. 246.

FIG. 246 shows an example of a configuration of the memory 1002 of the multiplexer 54.

The memory 1002 has a storage capacity for storing mb bits in the column (vertical) direction and stores N/(mb) bits in the row (horizontal) direction and is composed of mb columns.

The column twist deinterleaver 55 writes code bits of an LDPC code in the row direction into the memory 1002 and controls the position at which reading out is started when the code bits are read out in the column direction to carry out column twist deinterleave.

In particular, the column twist deinterleaver 55 carries out a reverse re-arrangement process of suitably changing the reading out starting position at which reading out of code bits with regard to each of a plurality of columns is to be started to return the arrangement of code bits re-arranged by the column twist interleave to the original arrangement.

Here, FIG. 246 shows an example of a configuration of the memory 1002 where the modulation method is 16QAM and the multiple b is 1. Accordingly, the bit number m of one symbol is 4 bits, and the memory 1002 includes four (= mb) columns.

The column twist deinterleaver 55 carries out (in place of the multiplexer 54), writing of code bits of an LDPC code outputted from the replacement section 1001 in the row direction successively into the memory 1002 beginning with the first row toward a lowermost row.

Then, if writing of code bits for one code length ends, then the column twist deinterleaver 55 carries out reading out of code bits in the downward direction (column direction) from a top of the memory 1002 beginning with a leftmost column toward a right side column.

However, the column twist deinterleaver 55 carries out reading out of the code bits from the memory 1002 determining the writing starting position upon writing of the code bits by the column twist interleaver 24 on the transmission apparatus 11 side to a reading out starting position of the code bits.

In particular, if the address of the position of the top of each column is determined as 0 and the address of each position in the column direction is represented by an integer given in an ascending order, then where the modulation method is 16QAM and the multiple b is 1, the column twist deinterleaver 55 sets the reading out starting position for the leftmost column to the position whose address is 0, sets the reading out starting position for the second column (from the left) to the position whose address is 2, sets the reading out starting position for the third column to the position whose address is 4, and sets the reading out starting position for the fourth column to the position whose address is 7.

It is to be noted that, with regard to each of those columns whose reading out starting position has an address other than 0, reading out of code bits is carried out such that, after such reading out is carried out down to the lowermost position, the reading out position is returned to the top (position whose address is 0) of the column and the reading out is carried out downwardly to the position immediately preceding to the reading out starting position. Then, after that, reading out is carried out from the next (right) column.

By carrying out such column twist interleave as described above, the arrangement of the code bits re-arranged by the column twist interleave is returned to the original arrangement.

FIG. 247 is a block diagram showing another example of the configuration of the reception apparatus 12.

Referring to FIG. 247, the reception apparatus 12 is a data processing apparatus which receives a modulation signal from the transmission apparatus 11 and includes an orthogonal demodulation section 51, a demapping section 52, a deinterleaver 53 and an LDPC decoding section 1021.

The orthogonal demodulation section 51 receives a modulation signal from the transmission apparatus 11, carries out orthogonal demodulation and supplies symbols (values in the I and Q axis directions) obtained as a result of the orthogonal demodulation to the demapping section 52.

The demapping section 52 carries out demapping of converting the symbols from the orthogonal demodulation section 51 into code bits of an LDPC code and supplies the code bits to the deinterleaver 53.

The deinterleaver 53 includes a multiplexer (MUX) 54, a column twist deinterleaver 55 and a parity deinterleaver 1011 and carries out deinterleave of the code bits of the LDPC code from the demapping section 52.

In particular, the multiplexer 54 determines an LDPC code from the demapping section 52 as an object of processing thereof and carries out a reverse replacement process corresponding to the replacement process carried out by the demultiplexer 25 of the transmission apparatus 11 (reverse process to the replacement process), that is, a reverse replacement process of returning the positions of the code bits replaced by the replacement process to the original positions. Then, the multiplexer 54 supplies an LDPC code obtained as a result of the reverse replacement process to the column twist deinterleaver 55.

The column twist deinterleaver 55 determines the LDPC code from the multiplexer 54 as an object of processing and carries out column twist deinterleave corresponding to the column twist interleave as a re-arrangement process carried out by the column twist interleaver 24 of the transmission apparatus 11.

The LDPC code obtained as a result of the column twist deinterleave is supplied from the column twist deinterleaver 55 to the parity deinterleaver 1011.

The parity deinterleaver 1011 determines the code bits after the column twist deinterleave by the column twist deinterleaver 55 as an object of processing thereof and carries out parity deinterleave corresponding to the parity interleave carried out by the parity interleaver 23 of the transmission apparatus 11 (reverse process to the parity interleave), that is, parity deinterleave of returning the arrangement of the code bits of the LDPC code whose arrangement was changed by the parity interleave to the original arrangement.

The LDPC code obtained as a result of the parity deinterleave is supplied from the parity deinterleaver 1011 to the LDPC decoding section 1021.

Accordingly, in the reception apparatus 12 of FIG. 247, the LDPC code for which the reverse replacement process, column twist deinterleave and parity deinterleave have been carried out, that is, an LDPC code obtained by LDPC coding in accordance with the parity check matrix H, is supplied to the LDPC decoding section 1021.

The LDPC decoding section 1021 carries out LDPC decoding of the LDPC code from the deinterleaver 53 using the parity check matrix H itself used for LDPC encoding by the LDPC encoding section 21 of the transmission apparatus 11 or a conversion parity check matrix obtained by carrying out at least column conversion corresponding to the parity interleave for the parity check matrix H. Then, the LDPC decoding section 1021 outputs data obtained by the LDPC decoding as a decoding result of the object data.

Here, in the reception apparatus 12 of FIG. 247, since an LDPC code obtained by LDPC encoding in accordance with the parity check matrix H is supplied from the (parity deinterleaver 1011 of) the deinterleaver 53 to the LDPC decoding section 1021, where the LDPC decoding of the LDPC code is carried out using the parity check matrix H itself used for the LDPC encoding by the LDPC encoding section 21 of the transmission apparatus 11, the LDPC decoding section 1021 can be configured, for example, from a decoding apparatus which carries out LDPC decoding in accordance with a full serial decoding method wherein mathematical operation of messages (check node messages and variable node messages) is carried out for one by one node or another decoding apparatus wherein LDPC decoding is carried out in accordance with a full parallel decoding method wherein mathematical operation of messages are carried out simultaneously (in parallel) for all nodes.

Further, where LDPC decoding of an LDPC code is carried out using a conversion parity check matrix obtained by carrying out at least column replacement corresponding to the parity interleave for the parity check matrix H used in the LDPC encoding by the LDPC encoding section 21 of the transmission apparatus 11, the LDPC decoding section 1021 can be confirmed from a decoding apparatus of an architecture which carries out the check node mathematical operation and the variable node mathematical operation simultaneously for P (or a devisor of P other than 1) check nodes and P variable nodes and which has a reception data re-arrangement section 310 for carrying out column replacement similar to the column replacement for obtaining a conversion parity check matrix for the LDPC code to re-arrange the code bits of the LDPC codes.

It is to be noted that, while, in FIG. 247, the multiplexer 54 for carrying out the reverse replacement process, column twist deinterleaver 55 for carrying out the column twist deinterleave and parity deinterleaver 1011 for carrying out the parity deinterleave are configured separately from each other for the convenience of description, two or more of the multiplexer 54, column twist deinterleaver 55 and parity deinterleaver 1011 can be configured integrally similarly to the parity interleaver 23, column twist interleaver 24 and demultiplexer 25 of the transmission apparatus 11.

FIG. 248 is a block diagram showing a first example of a configuration of a reception system which can be applied to the reception apparatus 12.

Referring to FIG. 248, the reception system includes an acquisition section 1101, a transmission line decoding processing section 1102 and an information source decoding processing section 1103.

The acquisition section 1101 acquires a signal including an LDPC code obtained at least by LDPC encoding object data such as image data and music data of a program through a transmission line such as, for example, terrestrial digital broadcasting, satellite digital broadcasting, a CATV network, the Internet or some other network. Then, the acquisition section 1101 supplies the acquired signal to the transmission line decoding processing section 1102.

Here, where the signal acquired by the acquisition section 1101 is broadcast, for example, from a broadcasting station through ground waves, satellite waves, a CATV (Cable Television) or the like, the acquisition section 1101 is configured from a tuner, an STB (Set Top Box) or the like. On the other hand, where the signal acquired by the acquisition section 1101 is transmitted in a multicast state as in the IPTV (Internet Protocol Television), for example, from a web server, the acquisition section 11 is configured from a network I/F (Inter face) such as, for example, an NIC (Network Interface Card).

The transmission line decoding processing section 1102 carries out a transmission line decoding process including at least a process for correcting errors produced in the transmission line for the signal acquired through the transmission line by the acquisition section 1101, and supplies a signal obtained as a result of the transmission line decoding process to the information source decoding processing section 1103.

In particular, the signal acquired through the transmission line by the acquisition section 1101 is a signal obtained by carrying out at least error correction encoding for correcting errors produced in the transmission line, and for such a signal as just described, the transmission line decoding processing section 1102 carries out a transmission line decoding process such as, for example, an error correction process.

Here, as the error correction encoding, for example, LDPC encoding, Reed-Solomon encoding and so forth are available. Here, as the error correction encoding, at least LDPC encoding is carried out.

Further, the transmission line decoding process sometimes includes demodulation of a modulation signal and so forth.

The information source decoding processing section 1103 carries out an information source decoding process including at least a process for decompressing compressed information into original information for the signal for which the transmission line decoding process has been carried out.

In particular, the signal acquired through the transmission line by the acquisition section 1101 has sometimes been processed by compression encoding for compressing information in order to reduce the data amount such as images, sound and so forth as information. In this instance, the information source decoding processing section 1103 carries out an information source decoding process such as a process (decompression process) for decompressing the compressed information into original information for a signal for which the transmission line decoding process has been carried out.

It is to be noted that, where the signal acquired through the transmission line by the acquisition section 1101 has not been carried out compression encoding, the information source decoding processing section 1103 does not carry out the process of decompressing the compressed information into the original information.

Here, as the decompression process, for example, MPEG decoding and so forth are available. Further, the transmission line decoding process sometimes includes descrambling in addition to the decompression process.

In the reception system configured in such a manner as described above, the acquisition section 1101 receives a signal obtained by carrying out compression encoding such as MPEG encoding for data of, for example, images, sound and so forth and further carrying out error correction encoding such as LDPC encoding for the compression encoded data through a transmission line. The signal is supplied to the transmission line decoding processing section 1102.

In the transmission line decoding processing section 1102, processes similar to those carried out, for example, by the orthogonal demodulation section 51, demapping section 52, deinterleaver 53 and LDPC decoding section 56 (or LDPC decoding section 1021) are carried out as the transmission line decoding process for the signal from the acquisition section 1101. Then, a signal obtained as a result of the transmission line decoding process is supplied to the information source decoding processing section 1103.

In the information source decoding processing section 1103, an information source decoding process such as MPEG decoding is carried out for the signal from the transmission line decoding processing section 1102, and an image or sound obtained as a result of the information decoding process is outputted.

Such a reception system of FIG. 248 as described above can be applied, for example, to a television tuner for receiving television broadcasting as digital broadcasting and so forth.

It is to be noted that it is possible to configure the acquisition section 1101, transmission line decoding processing section 1102 and information source decoding processing section 1103 each as an independent apparatus (hardware (IC (Integrated Circuit) or the like) or a software module).

Further, as regards the acquisition section 1101, transmission line decoding processing section 1102 and information source decoding processing section 1103, a set of the acquisition section 1101 and transmission line decoding processing section 1102, another set of the transmission line decoding processing section 1102 and information source decoding processing section 1103 or a further set of the acquisition section 1101, transmission line decoding processing section 1102 and information source decoding processing section 1103 can be configured as a single independent apparatus.

FIG. 249 is a block diagram showing a second example of the configuration of the reception system which can be applied to the reception apparatus 12.

It is to be noted that, in FIG. 249, elements corresponding those in FIG. 248 are denoted by like reference numerals, and description of them is suitably omitted in the following description.

The reception system of FIG. 249 is common to that of FIG. 248 in that it includes an acquisition section 1101, a transmission line decoding processing section 1102 and an information source decoding processing section 1103 but is different from that of FIG. 248 in that it newly includes an outputting section 1111.

The outputting section 1111 is, for example, a display apparatus for displaying an image or a speaker for outputting sound and outputs an image, a sound of the like as a signal outputted from the information source decoding processing section 1103. In other words, the outputting section 1111 displays an image or outputs sound.

Such a reception system of FIG. 249 as described above can be applied, for example, to a TV (television receiver) for receiving a television broadcast as a digital broadcast, a radio receiver for receiving a radio broadcast and so forth.

It is to be noted that, where the signal acquired by the acquisition section 1101 is not in a form wherein compression encoding is not applied, a signal outputted from the transmission line decoding processing section 1102 is supplied to the outputting section 1111.

FIG. 250 is a block diagram showing a third example of the configuration of the reception system which can be applied to the reception apparatus 12.

It is to be noted that, in FIG. 250, corresponding elements to those of FIG. 248 are denoted by like reference numerals, and in the following description, description of them is suitably omitted.

The reception system of FIG. 250 is common to that of FIG. 248 in that it includes an acquisition section 1101 and a transmission line decoding processing section 1102.

However, the reception system of FIG. 250 is different from that of FIG. 248 in that it does not include the information source decoding processing section 1103 but newly includes a recording section 1121.

The recording section 1121 records (stores) a signal (for example, a TS packet of a TS of MPEG) outputted from the transmission line decoding processing section 1102 on or into a recording (storage) medium such as an optical disk, a hard disk (magnetic disk) or a flash memory.

Such a reception system of FIG. 250 as described above can be applied to a recorder for recording a television broadcast or the like.

It is to be noted that, in FIG. 250, the reception system may include the information source decoding processing section 1103 such that a signal after an information source decoding process has been carried out by the information source decoding processing section 1103, that is, an image or sound obtained by decoding, is recorded by the recording section 1121.

It should be understood by those skilled in the art that various modifications, combinations, subcombinations and alterations may occur depending on design requirements and other factors insofar as they are within the scope of the appended claims or the equivalents thereof.

Other aspects and features of the invention are set out in the following numbered clauses:

**CLAUSES**

1. A data processing apparatus, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides
a predetermined positive integer is represented by b,
said storage means stores mb bits in the row direction and stores N/(mb) bits in the column direction;
the code bits of the LDPC code being written in the column direction of said storage means and read out in the row direction;
said data processing apparatus comprising replacement means for replacing,
where the mb code bits read out in the row direction of said storage means set as b symbols,
the mb code bits such that the code bits after the replacement form the symbol bits representative of the symbols;
the LDPC code being an LDPC code which is prescribed in the DVB-S.2 or DVB-T.2 standard and which has a code length N of 64,800 bits and has an encoding rate of 5/6 or 9/10;
the m bits being 12 bits while the integer b is 1;
the 12 bits of the code bit being mapped as one symbol to ones of 4,096 signal points prescribed in 4096QAM;
said storage means having 12 columns for storing 12 $\times$ 1 bits in the row direction and storing 64,800/(12 $\times$ 1) bits in the column direction;
said replacement means carrying out,
where the i+1th bit from the most significant bit of the 12 $\times$ 1 code bits read out in the row direction of said storage means is represented as bit $b_i$ and the i+1th bit from the most significant bit of the 12 $\times$ 1 symbol bits of one symbol is represented as bit $y_i$,
replacement for allocating
the bit $b_0$ to the bit $y_8$,
the bit $b_1$ to the bit $y_0$,
the bit $b_2$ to the bit $y_6$,
the bit $b_3$ to the bit $y_1$,
the bit $b_4$ to the bit $y_4$,
the bit $b_5$ to the bit $y_5$,
the bit $b_6$ to the bit $y_2$,
the bit $b_7$ to the bit $y_3$,
the bit $b_8$ to the bit $y_7$,
the bit $b_9$ to the bit $y_{10}$,
the bit $b_{10}$ to the bit $y_{11}$, and
the bit $b_{11}$ to the bit $y_9$,
for both of the LDPC code whose encoding rate is 5/6 and the LDPC code whose encoding rate is 9/10.

2. A data processing apparatus, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides
a predetermined positive integer is represented by b,
said storage means stores mb bits in the row direction and stores N/(mb) bits in the column direction;
the code bits of the LDPC code being written in the column direction of said storage means and read out in the row direction;
said data processing apparatus comprising replacement means for replacing,
where the mb code bits read out in the row direction of said storage means set as b symbols,
the mb code bits such that the code bits after the replacement form the symbol bits representative of the symbols;
the LDPC code being an LDPC code which is prescribed in the DVB-S.2 or DVB-T.2 standard and which has a code length N of 64,800 bits and has an encoding rate of 5/6 or 9/10;
the m bits being 12 bits while the integer b is 2;
the 12 bits of the code bit being mapped as one symbol to ones of 4,096 signal points prescribed in 4096QAM;
said storage means having 24 columns for storing 12 $\times$ 2 bits in the row direction and storing 64,800/(12 $\times$ 2) bits in the column direction;
said replacement means carrying out,
where the i+1th bit from the most significant bit of the 12 $\times$ 2 code bits read out in the row direction of said storage means is represented as bit $b_i$ and the i+1th bit from the most significant bit of the 12 $\times$ 2 symbol bits of two successive symbols is represented as bit $y_i$,
replacement for allocating
the bit $b_0$ to the bit $y_8$,
the bit $b_2$ to the bit $y_0$,

the bit $b_4$ to the bit $y_6$,
the bit $b_6$ to the bit $y_1$,
the bit $b_8$ to the bit $y_4$,
the bit $b_{10}$ to the bit $y_5$,
the bit $b_{12}$ to the bit $y_2$,
the bit $b_{14}$ to the bit $y_3$,
the bit $b_{16}$ to the bit $y_7$,
the bit $b_{18}$ to the bit $y_{10}$,
the bit $b_{20}$ to the bit $y_{11}$,
the bit $b_{22}$ to the bit $y_9$,
the bit $b_1$ to the bit $y_{20}$,
the bit $b_3$ to the bit $y_{12}$,
the bit $b_5$ to the bit $y_{18}$,
the bit $b_7$ to the bit $y_{13}$,
the bit $b_9$ to the bit $y_{16}$,
the bit $b_{11}$ to the bit $y_{17}$,
the bit $b_{13}$ to the bit $y_{14}$,
the bit $b_{15}$ to the bit $y_{15}$,
the bit $b_{17}$ to the bit $y_{19}$,
the bit $b_{19}$ to the bit $y_{22}$,
the bit $b_{21}$ to the bit $y_{23}$, and
the bit $b_{23}$ to the bit $y_{21}$,
for both of the LDPC code whose encoding rate is 5/6 and the LDPC code whose encoding rate is 9/10.

3. A data processing apparatus, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides a predetermined positive integer is represented by b,
said storage means stores mb bits in the row direction and stores N/(mb) bits in the column direction;
the code bits of the LDPC code being written in the column direction of said storage means and read out in the row direction;
said data processing apparatus comprising replacement means for replacing,
where the mb code bits read out in the row direction of said storage means set as successive b symbols,
the mb code bits such that the code bits after the replacement form the symbol bits representative of the symbols;
the LDPC code being an LDPC code which is prescribed in the DVB-S.2 or DVB-T.2 standard and which has a code length N of 16,200 bits and has an encoding rate of 3/4, 5/6 or 8/9, or which has a code length N of 64,800 bits and has an encoding rate of 3/4, 5/6 or 9/10;
the m bits being 10 bits while the integer b is 2;
the 10 bits of the code bit being mapped as one symbol to ones of 1,024 signal points prescribed in 1024QAM;
said storage means having 20 columns for storing $10 \times 2$ bits in the row direction and storing $N/(10 \times 2)$ bits in the column direction;
said replacement means carrying out,
where the i+1th bit from the most significant bit of the $10 \times 2$ code bits read out in the row direction of said storage means is represented as bit $b_i$ and the i+1th bit from the most significant bit of the $10 \times 2$ symbol bits of two successive symbols is represented as bit $y_i$,
replacement for allocating
the bit $b_0$ to the bit $y_8$,
the bit $b_1$ to the bit $y_3$,
the bit $b_2$ to the bit $y_7$,
the bit $b_3$ to the bit $y_{10}$,
the bit $b_4$ to the bit $y_{19}$,
the bit $b_5$ to the bit $y_4$,
the bit $b_6$ to the bit $y_9$,
the bit $b_7$ to the bit $y_5$,
the bit $b_8$ to the bit $y_{17}$,
the bit $b_9$ to the bit $y_6$,

the bit $b_{10}$ to the bit $y_{14}$,
the bit $b_{11}$ to the bit $y_{11}$,
the bit $b_{12}$ to the bit $y_2$,
the bit $b_{13}$ to the bit $y_{18}$,
the bit $b_{14}$ to the bit $y_{16}$,
the bit $b_{15}$ to the bit $y_{15}$,
the bit $b_{16}$ to the bit $y_0$,
the bit $b_{17}$ to the bit $y_1$,
the bit $b_{18}$ to the bit $y_{13}$, and
the bit $b_{19}$ to the bit $y_{12}$,
for both of the LDPC code which has a code length N of 16,200 bits and encoding rate is 3/4, 5/6 or 8/9, or the LDPC code which has a code length N of 64,800 bits and encoding rate is 3/4, 5/6 or 9/10.

4. A data processing apparatus, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides
a predetermined positive integer is represented by b,
said storage means stores mb bits in the row direction and stores N/(mb) bits in the column direction;
the code bits of the LDPC code being written in the column direction of said storage means and read out in the row direction;
said data processing apparatus comprising replacement means for replacing,
where the mb code bits read out in the row direction of said storage means set as b symbols,
the mb code bits such that the code bits after the replacement form the symbol bits representative of the symbols;
the LDPC code being an LDPC code which is prescribed in the DVB-S.2 or DVB-T.2 standard and which has a code length N of 16,200 bits and has an encoding rate of 5/6 or 8/9, or which has a code length N of 64,800 bits and has an encoding rate of 5/6 or 9/10;
the m bits being 12 bits while the integer b is 2;
the 12 bits of the code bit being mapped as one symbol to ones of 4,096 signal points prescribed in 4096QAM;
said storage means having 24 columns for storing 12 × 2 bits in the row direction and storing N/(12 × 2) bits in the column direction;
said replacement means carrying out,
where the i+1th bit from the most significant bit of the 12 × 2 code bits read out in the row direction of said storage means is represented as bit $b_i$ and the i+1th bit from the most significant bit of the 12 × 2 symbol bits of two successive symbols is represented as bit $y_i$,
replacement for allocating
the bit $b_0$ to the bit $y_{10}$,
the bit $b_1$ to the bit $y_{15}$,
the bit $b_2$ to the bit $y_4$,
the bit $b_3$ to the bit $y_{19}$,
the bit $b_4$ to the bit $y_{21}$,
the bit $b_5$ to the bit $y_{16}$,
the bit $b_6$ to the bit $y_{23}$,
the bit $b_7$ to the bit $y_{18}$,
the bit $b_8$ to the bit $y_{11}$,
the bit $b_9$ to the bit $y_{14}$,
the bit $b_{10}$ to the bit $y_{22}$,
the bit $b_{11}$ to the bit $y_5$,
the bit $b_{12}$ to the bit $y_6$,
the bit $b_{13}$ to the bit $y_{17}$,
the bit $b_{14}$ to the bit $y_{13}$,
the bit $b_{15}$ to the bit $y_{20}$,
the bit $b_{16}$ to the bit $y_1$,
the bit $b_{17}$ to the bit $y_3$,
the bit $b_{18}$ to the bit $y_9$,
the bit $b_{19}$ to the bit $y_2$,
the bit $b_{20}$ to the bit $y_7$,

the bit $b_{21}$ to the bit $y_8$,
the bit $b_{22}$ to the bit $y_{12}$, and
the bit $b_{23}$ to the bit $y_0$,
for both of the LDPC code which has a code length N of 16,200 bits and encoding rate is 5/6 or 8/9, or the LDPC code which has a code length N of 64,800 bits and encoding rate is 5/6 or 9/10.

5. A data processing method, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides a predetermined positive integer is represented by b,
said storage means stores mb bits in the row direction and stores N/(mb) bits in the column direction;
the code bits of the LDPC code being written in the column direction of said storage means and read out in the row direction;
said data processing method comprising a replacement step for replacing,
where the mb code bits read out in the row direction of said storage means set as b symbols,
the mb code bits such that the code bits after the replacement form the symbol bits representative of the symbols;
the LDPC code being an LDPC code which is prescribed in the DVB-S.2 or DVB-T.2 standard and which has a code length N of 64,800 bits and has an encoding rate of 5/6 or 9/10;
the m bits being 12 bits while the integer b is 1;
the 12 bits of the code bit being mapped as one symbol to ones of 4,096 signal points prescribed in 4096QAM;
said storage means having 12 columns for storing $12 \times 1$ bits in the row direction and storing $64{,}800/(12 \times 1)$ bits in the column direction;
said replacement step carrying out,
where the i+1th bit from the most significant bit of the $12 \times 1$ code bits read out in the row direction of said storage means is represented as bit $b_i$ and the i+1th bit from the most significant bit of the $12 \times 1$ symbol bits of one symbol is represented as bit $y_i$,
replacement for allocating
the bit $b_0$ to the bit $y_8$,
the bit $b_1$ to the bit $y_0$,
the bit $b_2$ to the bit $y_6$,
the bit $b_3$ to the bit $y_1$,
the bit $b_4$ to the bit $y_4$,
the bit $b_5$ to the bit $y_5$,
the bit $b_6$ to the bit $y_2$,
the bit $b_7$ to the bit $y_3$,
the bit $b_8$ to the bit $y_7$,
the bit $b_9$ to the bit $y_{10}$,
the bit $b_{10}$ to the bit $y_{11}$, and
the bit $b_{11}$ to the bit $y_9$,
for both of the LDPC code whose encoding rate is 5/6 and the LDPC code whose encoding rate is 9/10.

6. A data processing method, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides a predetermined positive integer is represented by b,
said storage means stores mb bits in the row direction and stores N/(mb) bits in the column direction;
the code bits of the LDPC code being written in the column direction of said storage means and read out in the row direction;
said data processing method comprising a replacement step for replacing,
where the mb code bits read out in the row direction of said storage means set as b symbols,
the mb code bits such that the code bits after the replacement form the symbol bits representative of the symbols;
the LDPC code being an LDPC code which is prescribed in the DVB-S.2 or DVB-T.2 standard and which has a code length N of 64,800 bits and has an encoding rate of 5/6 or 9/10;
the m bits being 12 bits while the integer b is 2;

the 12 bits of the code bit being mapped as one symbol to ones of 4,096 signal points prescribed in 4096QAM;
said storage means having 24 columns for storing 12 × 2 bits in the row direction and storing 64,800/(12 × 2) bits in the column direction;
said replacement step carrying out,
where the i+1th bit from the most significant bit of the 12 × 2 code bits read out in the row direction of said storage means is represented as bit $b_i$ and the i+1th bit from the most significant bit of the 12 × 2 symbol bits of two successive symbols is represented as bit $y_i$,
replacement for allocating
the bit $b_0$ to the bit $y_8$,
the bit $b_2$ to the bit $y_0$,
the bit $b_4$ to the bit $y_6$,
the bit $b_6$ to the bit $y_1$,
the bit $b_8$ to the bit $y_4$,
the bit $b_{10}$ to the bit $y_5$,
the bit $b_{12}$ to the bit $y_2$,
the bit $b_{14}$ to the bit $y_3$,
the bit $b_{16}$ to the bit $y_7$,
the bit $b_{18}$ to the bit $y_{10}$,
the bit $b_{20}$ to the bit $y_{11}$,
the bit $b_{22}$ to the bit $y_9$,
the bit $b_1$ to the bit $y_{20}$,
the bit $b_3$ to the bit $y_{12}$,
the bit $b_5$ to the bit $y_{18}$,
the bit $b_7$ to the bit $y_{13}$,
the bit $b_9$ to the bit $y_{16}$,
the bit $b_{11}$ to the bit $y_{17}$,
the bit $b_{13}$ to the bit $y_{14}$,
the bit $b_{15}$ to the bit $y_{15}$,
the bit $b_{17}$ to the bit $y_{19}$,
the bit $b_{19}$ to the bit $y_{22}$,
the bit $b_{21}$ to the bit $y_{23}$, and
the bit $b_{23}$ to the bit $y_{21}$,
for both of the LDPC code whose encoding rate is 5/6 and the LDPC code whose encoding rate is 9/10.

7. A data processing method, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides
a predetermined positive integer is represented by b,
said storage means stores mb bits in the row direction and stores N/(mb) bits in the column direction;
the code bits of the LDPC code being written in the column direction of said storage means and read out in the row direction;
said data processing method comprising a replacement step for replacing,
where the mb code bits read out in the row direction of said storage means set as successive b symbols,
the mb code bits such that the code bits after the replacement form the symbol bits representative of the symbols;
the LDPC code being an LDPC code which is prescribed in the DVB-S.2 or DVB-T.2 standard and which has a code length N of 16,200 bits and has an encoding rate of 3/4, 5/6 or 8/9, or which has a code length N of 64,800 bits and has an encoding rate of 3/4, 5/6 or 9/10;
the m bits being 10 bits while the integer b is 2;
the 10 bits of the code bit being mapped as one symbol to ones of 1,024 signal points prescribed in 1024QAM;
said storage means having 20 columns for storing 10 × 2 bits in the row direction and storing N/(10 × 2) bits in the column direction;
said replacement step carrying out,
where the i+1th bit from the most significant bit of the 10 × 2 code bits read out in the row direction of said storage means is represented as bit bi and the i+1th bit from the most significant bit of the 10 × 2 symbol bits of two successive symbols is represented as bit $y_i$,
replacement for allocating

the bit $b_0$ to the bit $y_8$,
the bit $b_1$ to the bit $y_3$,
the bit $b_2$ to the bit $y_7$,
the bit $b_3$ to the bit $y_{10}$,
the bit $b_4$ to the bit $y_{19}$,
the bit $b_5$ to the bit $y_4$,
the bit $b_6$ to the bit $y_9$,
the bit $b_7$ to the bit $y_5$,
the bit $b_8$ to the bit $y_{17}$,
the bit bg to the bit $y_6$,
the bit $b_{10}$ to the bit $y_{14}$,
the bit $b_{11}$ to the bit $y_{11}$,
the bit $b_{12}$ to the bit $y_2$,
the bit $b_{13}$ to the bit $y_{18}$,
the bit $b_{14}$ to the bit $y_{16}$,
the bit $b_{15}$ to the bit $y_{15}$,
the bit $b_{16}$ to the bit $y_0$,
the bit $b_{17}$ to the bit $y_1$,
the bit $b_{18}$ to the bit $y_{13}$, and
the bit $b_{19}$ to the bit $y_{12}$,
for both of the LDPC code which has a code length N of 16,200 bits and encoding rate is 3/4, 5/6 or 8/9, or the LDPC code which has a code length N of 64,800 bits and encoding rate is 3/4, 5/6 or 9/10.

8. A data processing method, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides
a predetermined positive integer is represented by b,
said storage means stores mb bits in the row direction and stores N/(mb) bits in the column direction;
the code bits of the LDPC code being written in the column direction of said storage means and read out in the row direction;
said data processing method comprising a replacement step for replacing,
where the mb code bits read out in the row direction of said storage means set as b symbols,
the mb code bits such that the code bits after the replacement form the symbol bits representative of the symbols;
the LDPC code being an LDPC code which is prescribed in the DVB-S.2 or DVB-T.2 standard and which has a code length N of 16,200 bits and has an encoding rate of 5/6 or 8/9, or which has a code length N of 64,800 bits and has an encoding rate of 5/6 or 9/10;
the m bits being 12 bits while the integer b is 2;
the 12 bits of the code bit being mapped as one symbol to ones of 4,096 signal points prescribed in 4096QAM;
said storage means having 24 columns for storing $12 \times 2$ bits in the row direction and storing $N/(12 \times 2)$ bits in the column direction;
said replacement step carrying out,
where the i+1th bit from the most significant bit of the $12 \times 2$ code bits read out in the row direction of said storage means is represented as bit $b_i$ and the i+1th bit from the most significant bit of the $12 \times 2$ symbol bits of two successive symbols is represented as bit $y_i$,
replacement for allocating
the bit $b_0$ to the bit $y_{10}$,
the bit $b_1$ to the bit $y_{15}$,
the bit $b_2$ to the bit $y_4$,
the bit $b_3$ to the bit $y_{19}$,
the bit $b_4$ to the bit $y_{21}$,
the bit $b_5$ to the bit $y_{16}$,
the bit $b_6$ to the bit $y_{23}$,
the bit $b_7$ to the bit $y_{18}$,
the bit $b_8$ to the bit $y_{11}$,
the bit bg to the bit $y_{14}$,
the bit $b_{10}$ to the bit $y_{22}$,

the bit $b_{11}$ to the bit $y_5$,
the bit $b_{12}$ to the bit $y_6$,
the bit $b_{13}$ to the bit $y_{17}$,
the bit $b_{14}$ to the bit $y_{13}$,
the bit $b_{15}$ to the bit $y_{20}$,
the bit $b_{16}$ to the bit $y_1$,
the bit $b_{17}$ to the bit $y_3$,
the bit $b_{18}$ to the bit $y_9$,
the bit $b_{19}$ to the bit $y_2$,
the bit $b_{20}$ to the bit $y_7$,
the bit $b_{21}$ to the bit $y_8$,
the bit $b_{22}$ to the bit $y_{12}$, and
the bit $b_{23}$ to the bit $y_0$,
for both of the LDPC code which has a code length N of 16,200 bits and encoding rate is 5/6 or 8/9, or the LDPC code which has a code length N of 64,800 bits and encoding rate is 5/6 or 9/10.

## Claims

**1.** A data processing apparatus, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides a predetermined positive integer is represented by b,
said storage means stores mb bits in the row direction and stores N/(mb) bits in the column direction;
the code bits of the LDPC code being written in the column direction of said storage means and read out in the row direction;
said data processing apparatus comprising replacement means for replacing,
where the mb code bits read out in the row direction of said storage means set as b symbols,
the mb code bits such that the code bits after the replacement form the symbol bits representative of the symbols;
the LDPC code being an LDPC code which is prescribed in the DVB-S.2 or DVB-T.2 standard and which has a code length N of 64,800 bits and has an encoding rate of 9/10;
the m bits being 12 bits while the integer b is 1;
the 12 bits of the code bit being mapped as one symbol to ones of 4,096 signal points prescribed in 4096QAM;
said storage means having 12 columns for storing $12 \times 1$ bits in the row direction and storing $64,800/(12 \times 1)$ bits in the column direction;
said replacement means carrying out,
where the i+1th bit from the most significant bit of the $12 \times 1$ code bits read out in the row direction of said storage means is represented as bit $b_i$ and the i+1th bit from the most significant bit of the $12 \times 1$ symbol bits of one symbol is represented as bit $y_i$,
replacement for allocating
the bit $b_0$ to the bit $y_8$,
the bit $b_1$ to the bit $y_0$,
the bit $b_2$ to the bit $y_6$,
the bit $b_3$ to the bit $y_1$,
the bit $b_4$ to the bit $y_4$,
the bit $b_5$ to the bit $y_5$,
the bit $b_6$ to the bit $y_2$,
the bit $b_7$ to the bit $y_3$,
the bit $b_8$ to the bit $y_7$,
the bit $b_9$ to the bit $y_{10}$,
the bit $b_{10}$ to the bit $y_{11}$, and
the bit $b_{11}$ to the bit $y_9$,
for the LDPC code whose encoding rate is 9/10.

**2.** A data processing apparatus, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides
a predetermined positive integer is represented by b,
said storage means stores mb bits in the row direction and stores N/(mb) bits in the column direction;
the code bits of the LDPC code being written in the column direction of said storage means and read out in the row direction;
said data processing apparatus comprising replacement means for replacing,
where the mb code bits read out in the row direction of said storage means set as successive b symbols,
the mb code bits such that the code bits after the replacement form the symbol bits representative of the symbols;
the LDPC code being an LDPC code which is prescribed in the DVB-S.2 or DVB-T.2 standard and which has a code length N of 16,200 bits and has an encoding rate of 3/4;
the m bits being 10 bits while the integer b is 2;
the 10 bits of the code bit being mapped as one symbol to ones of 1,024 signal points prescribed in 1024QAM;
said storage means having 20 columns for storing 10 × 2 bits in the row direction and storing N/(10 × 2) bits in the column direction;
said replacement means carrying out,
where the i+1th bit from the most significant bit of the 10 × 2 code bits read out in the row direction of said storage means is represented as bit $b_i$ and the i+1th bit from the most significant bit of the 10 × 2 symbol bits of two successive symbols is represented as bit $y_i$,
replacement for allocating
the bit $b_0$ to the bit $y_8$,
the bit $b_1$ to the bit $y_3$,
the bit $b_2$ to the bit $y_7$,
the bit $b_3$ to the bit $y_{10}$,
the bit $b_4$ to the bit $y_{19}$,
the bit $b_5$ to the bit $y_4$,
the bit $b_6$ to the bit $y_9$,
the bit $b_7$ to the bit $y_5$,
the bit $b_8$ to the bit $y_{17}$,
the bit $b_9$ to the bit $y_6$,
the bit $b_{10}$ to the bit $y_{14}$,
the bit $b_{11}$ to the bit $y_{11}$,
the bit $b_{12}$ to the bit $y_2$,
the bit $b_{13}$ to the bit $y_{18}$,
the bit $b_{14}$ to the bit $y_{16}$,
the bit $b_{15}$ to the bit $y_{15}$,
the bit $b_{16}$ to the bit $y_0$,
the bit $b_{17}$ to the bit $y_1$,
the bit $b_{18}$ to the bit $y_{13}$, and
the bit $b_{19}$ to the bit $y_{12}$,
for the LDPC code which has a code length N of 16,200 bits and encoding rate is 3/4.

**3.** A data processing apparatus, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides
a predetermined positive integer is represented by b,
said storage means stores mb bits in the row direction and stores N/(mb) bits in the column direction;
the code bits of the LDPC code being written in the column direction of said storage means and read out in the row direction;
said data processing apparatus comprising replacement means for replacing,
where the mb code bits read out in the row direction of said storage means set as successive b symbols,
the mb code bits such that the code bits after the replacement form the symbol bits representative of the symbols;
the LDPC code being an LDPC code which is prescribed in the DVB-S.2 or DVB-T.2 standard and which has a code length N of 16,200 bits and has an encoding rate of 5/6;
the m bits being 10 bits while the integer b is 2;

the 10 bits of the code bit being mapped as one symbol to ones of 1,024 signal points prescribed in 1024QAM;
said storage means having 20 columns for storing 10 $\times$ 2 bits in the row direction and storing N/(10 $\times$ 2) bits in the column direction;
said replacement means carrying out,
where the i+1th bit from the most significant bit of the 10 $\times$ 2 code bits read out in the row direction of said storage means is represented as bit $b_i$ and the i+1th bit from the most significant bit of the 10 $\times$ 2 symbol bits of two successive symbols is represented as bit $y_i$,
replacement for allocating
the bit $b_0$ to the bit $y_8$,
the bit $b_1$ to the bit $y_3$,
the bit $b_2$ to the bit $y_7$,
the bit $b_3$ to the bit $y_{10}$,
the bit $b_4$ to the bit $y_{19}$,
the bit $b_5$ to the bit $y_4$,
the bit $b_6$ to the bit $y_9$,
the bit $b_7$ to the bit $y_5$,
the bit $b_8$ to the bit $y_{17}$,
the bit $b_9$ to the bit $y_6$,
the bit $b_{10}$ to the bit $y_{14}$,
the bit $b_{11}$ to the bit $y_{11}$,
the bit $b_{12}$ to the bit $y_2$,
the bit $b_{13}$ to the bit $y_{18}$,
the bit $b_{14}$ to the bit $y_{16}$,
the bit $b_{15}$ to the bit $y_{15}$,
the bit $b_{16}$ to the bit $y_0$,
the bit $b_{17}$ to the bit $y_1$,
the bit $b_{18}$ to the bit $y_{13}$, and
the bit $b_{19}$ to the bit $y_{12}$,
for the LDPC code which has a code length N of 16,200 bits and encoding rate is 5/6.

**4.** A data processing apparatus, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides
a predetermined positive integer is represented by b,
said storage means stores mb bits in the row direction and stores N/(mb) bits in the column direction;
the code bits of the LDPC code being written in the column direction of said storage means and read out in the row direction;
said data processing apparatus comprising replacement means for replacing,
where the mb code bits read out in the row direction of said storage means set as successive b symbols,
the mb code bits such that the code bits after the replacement form the symbol bits representative of the symbols;
the LDPC code being an LDPC code which is prescribed in the DVB-S.2 or DVB-T.2 standard and which has a code length N of 16,200 bits and has an encoding rate of 8/9;
the m bits being 10 bits while the integer b is 2;
the 10 bits of the code bit being mapped as one symbol to ones of 1,024 signal points prescribed in 1024QAM;
said storage means having 20 columns for storing 10 $\times$ 2 bits in the row direction and storing N/(10 $\times$ 2) bits in the column direction;
said replacement means carrying out,
where the i+1th bit from the most significant bit of the 10 $\times$ 2 code bits read out in the row direction of said storage means is represented as bit $b_i$ and the i+1th bit from the most significant bit of the 10 $\times$ 2 symbol bits of two successive symbols is represented as bit $y_i$,
replacement for allocating
the bit $b_0$ to the bit $y_8$,
the bit $b_1$ to the bit $y_3$,
the bit $b_2$ to the bit $y_7$,
the bit $b_3$ to the bit $y_{10}$,
the bit $b_4$ to the bit $y_{19}$,

the bit $b_5$ to the bit $y_4$,
the bit $b_6$ to the bit $y_9$,
the bit $b_7$ to the bit $y_5$.
the bit $b_8$ to the bit $y_{17}$,
the bit $b_9$ to the bit $y_6$,
the bit $b_{10}$ to the bit $y_{14}$,
the bit $b_{11}$ to the bit $y_{11}$,
the bit $b_{12}$ to the bit $y_2$,
the bit $b_{13}$ to the bit $y_{18}$,
the bit $b_{14}$ to the bit $y_{16}$,
the bit $b_{15}$ to the bit $y_{15}$,
the bit $b_{16}$ to the bit $y_0$,
the bit $b_{17}$ to the bit $y_1$,
the bit $b_{18}$ to the bit $y_{13}$, and
the bit $b_{19}$ to the bit $y_{12}$,
for the LDPC code which has a code length N of 16,200 bits and encoding rate is 8/9.

**5.** A data processing apparatus, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides
a predetermined positive integer is represented by b,
said storage means stores mb bits in the row direction and stores N/(mb) bits in the column direction;
the code bits of the LDPC code being written in the column direction of said storage means and read out in the row direction;
said data processing apparatus comprising replacement means for replacing,
where the mb code bits read out in the row direction of said storage means set as b symbols,
the mb code bits such that the code bits after the replacement form the symbol bits representative of the symbols;
the LDPC code being an LDPC code which is prescribed in the DVB-S.2 or DVB-T.2 standard and which has a code length N of 16,200 bits and has an encoding rate of 5/6;
the m bits being 12 bits while the integer b is 2;
the 12 bits of the code bit being mapped as one symbol to ones of 4,096 signal points prescribed in 4096QAM;
said storage means having 24 columns for storing $12 \times 2$ bits in the row direction and storing $N/(12 \times 2)$ bits in the column direction;
said replacement means carrying out,
where the i+1th bit from the most significant bit of the $12 \times 2$ code bits read out in the row direction of said storage means is represented as bit $b_i$ and the i+1th bit from the most significant bit of the $12 \times 2$ symbol bits of two successive symbols is represented as bit $y_i$,
replacement for allocating
the bit bo to the bit $y_{10}$,
the bit $b_1$ to the bit $y_{15}$,
the bit $b_2$ to the bit $y_4$,
the bit $b_3$ to the bit $y_{19}$,
the bit $b_4$ to the bit $y_{21}$,
the bit $b_5$ to the bit $y_{16}$,
the bit $b_6$ to the bit $y_{23}$,
the bit $b_7$ to the bit $y_{18}$,
the bit $b_8$ to the bit $y_{11}$,
the bit $b_9$ to the bit $y_{14}$,
the bit $b_{10}$ to the bit $y_{22}$,
the bit $b_{11}$ to the bit $y_5$,
the bit $b_{12}$ to the bit $y_6$,
the bit $b_{13}$ to the bit $y_{17}$,
the bit $b_{14}$ to the bit $y_{13}$,
the bit $b_{15}$ to the bit $y_{20}$,
the bit $b_{16}$ to the bit $y_1$,
the bit $b_{17}$ to the bit $y_3$,

the bit $b_{18}$ to the bit $y_9$,
the bit $b_{19}$ to the bit $y_2$,
the bit $b_{20}$ to the bit $y_7$,
the bit $b_{21}$ to the bit $y_8$,
the bit $b_{22}$ to the bit $y_{12}$, and
the bit $b_{23}$ to the bit $y_0$,
for the LDPC code which has a code length N of 16,200 bits and encoding rate is 5/6.

**6.** A data processing apparatus, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides
a predetermined positive integer is represented by b,
said storage means stores mb bits in the row direction and stores N/(mb) bits in the column direction;
the code bits of the LDPC code being written in the column direction of said storage means and read out in the row direction;
said data processing apparatus comprising replacement means for replacing,
where the mb code bits read out in the row direction of said storage means set as b symbols,
the mb code bits such that the code bits after the replacement form the symbol bits representative of the symbols;
the LDPC code being an LDPC code which is prescribed in the DVB-S.2 or DVB-T.2 standard and which has a code length N of 16,200 bits and has an encoding rate of 8/9;
the m bits being 12 bits while the integer b is 2;
the 12 bits of the code bit being mapped as one symbol to ones of 4,096 signal points prescribed in 4096QAM;
said storage means having 24 columns for storing 12 × 2 bits in the row direction and storing N/(12 × 2) bits in the column direction;
said replacement means carrying out,
where the i+1th bit from the most significant bit of the 12 × 2 code bits read out in the row direction of said storage means is represented as bit $b_i$ and the i+1th bit from the most significant bit of the 12 × 2 symbol bits of two successive symbols is represented as bit $y_i$,
replacement for allocating
the bit $b_0$ to the bit $y_{10}$,
the bit $b_1$ to the bit $y_{15}$,
the bit $b_2$ to the bit $y_4$,
the bit $b_3$ to the bit $y_{19}$,
the bit $b_9$ to the bit $y_{21}$,
the bit $b_5$ to the bit $y_{16}$,
the bit $b_6$ to the bit $y_{23}$,
the bit $b_7$ to the bit $y_{18}$,
the bit $b_8$ to the bit $y_{11}$,
the bit $b_9$ to the bit $y_{14}$,
the bit $b_{10}$ to the bit $y_{22}$,
the bit $b_{11}$ to the bit $y_5$,
the bit $b_{12}$ to the bit $y_6$,
the bit $b_{13}$ to the bit $y_{17}$,
the bit $b_{14}$ to the bit $y_{13}$,
the bit $b_{15}$ to the bit $y_{20}$,
the bit $b_{16}$ to the bit $y_1$,
the bit $b_{17}$ to the bit $y_3$,
the bit $b_{18}$ to the bit $y_9$,
the bit $b_{19}$ to the bit $y_2$,
the bit $b_{20}$ to the bit $y_7$,
the bit $b_{21}$ to the bit $y_8$,
the bit $b_{22}$ to the bit $y_{12}$, and
the bit $b_{23}$ to the bit $y_0$,
for the LDPC code which has a code length N of 16,200 bits and encoding rate is 8/9.

**7.** A data processing method, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides
a predetermined positive integer is represented by b,
said storage means stores mb bits in the row direction and stores N/(mb) bits in the column direction;
the code bits of the LDPC code being written in the column direction of said storage means and read out in the row direction;
said data processing method comprising a replacement step for replacing,
where the mb code bits read out in the row direction of said storage means set as b symbols,
the mb code bits such that the code bits after the replacement form the symbol bits representative of the symbols;
the LDPC code being an LDPC code which is prescribed in the DVB-S.2 or DVB-T.2 standard and which has a code length N of 64,800 bits and has an encoding rate of 9/10;
the m bits being 12 bits while the integer b is 1;
the 12 bits of the code bit being mapped as one symbol to ones of 4,096 signal points prescribed in 4096QAM;
said storage means having 12 columns for storing 12 × 1 bits in the row direction and storing 64,800/(12 × 1) bits in the column direction;
said replacement step carrying out,
where the i+1th bit from the most significant bit of the 12 × 1 code bits read out in the row direction of said storage means is represented as bit $b_i$ and the i+1th bit from the most significant bit of the 12 × 1 symbol bits of one symbol is represented as bit $y_i$,
replacement for allocating
the bit $b_0$ to the bit $y_8$,
the bit $b_1$ to the bit $y_0$,
the bit $b_2$ to the bit $y_6$,
the bit $b_3$ to the bit $y_1$,
the bit $b_4$ to the bit $y_4$,
the bit $b_5$ to the bit $y_5$,
the bit $b_6$ to the bit $y_2$,
the bit $b_7$ to the bit $y_3$,
the bit $b_8$ to the bit $y_7$,
the bit $b_9$ to the bit $y_{10}$,
the bit $b_{10}$ to the bit $y_{11}$, and
the bit $b_{11}$ to the bit $y_9$,
for the LDPC code whose encoding rate is 9/10.

**8.** A data processing method, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides
a predetermined positive integer is represented by b,
said storage means stores mb bits in the row direction and stores N/(mb) bits in the column direction;
the code bits of the LDPC code being written in the column direction of said storage means and read out in the row direction;
said data processing method comprising a replacement step for replacing,
where the mb code bits read out in the row direction of said storage means set as successive b symbols,
the mb code bits such that the code bits after the replacement form the symbol bits representative of the symbols;
the LDPC code being an LDPC code which is prescribed in the DVB-S.2 or DVB-T.2 standard and which has a code length N of 16,200 bits and has an encoding rate of 3/4;
the m bits being 10 bits while the integer b is 2;
the 10 bits of the code bit being mapped as one symbol to ones of 1,024 signal points prescribed in 1024QAM;
said storage means having 20 columns for storing 10 × 2 bits in the row direction and storing N/(10 × 2) bits in the column direction;
said replacement step carrying out,
where the i+1th bit from the most significant bit of the 10 × 2 code bits read out in the row direction of said storage means is represented as bit bit and the i+1th bit from the most significant bit of the 10 × 2 symbol bits of two successive symbols is represented as bit $y_i$,
replacement for allocating

the bit $b_0$ to the bit $y_8$,
the bit $b_1$ to the bit $y_3$,
the bit $b_2$ to the bit $y_7$,
the bit $b_3$ to the bit $y_{10}$,
the bit $b_9$ to the bit $y_{19}$,
the bit $b_5$ to the bit $y_4$,
the bit $b_6$ to the bit $y_9$,
the bit $b_7$ to the bit $y_5$,
the bit $b_8$ to the bit $y_{17}$,
the bit $b_9$ to the bit $y_6$,
the bit $b_{10}$ to the bit $y_{14}$,
the bit $b_{11}$ to the bit $y_{11}$,
the bit $b_{12}$ to the bit $y_2$,
the bit $b_{13}$ to the bit $y_{18}$,
the bit $b_{14}$ to the bit $y_{16}$,
the bit $b_{15}$ to the bit $y_{15}$,
the bit $b_{16}$ to the bit $y_0$,
the bit $b_{17}$ to the bit $y_1$,
the bit $b_{18}$ to the bit $y_{13}$, and
the bit $b_{19}$ to the bit $y_{12}$,
for the LDPC code which has a code length N of 16,200 bits and encoding rate is 3/4.

**9.** A data processing method, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides
a predetermined positive integer is represented by b,
said storage means stores mb bits in the row direction and stores N/(mb) bits in the column direction;
the code bits of the LDPC code being written in the column direction of said storage means and read out in the row direction;
said data processing method comprising a replacement step for replacing,
where the mb code bits read out in the row direction of said storage means set as successive b symbols,
the mb code bits such that the code bits after the replacement form the symbol bits representative of the symbols;
the LDPC code being an LDPC code which is prescribed in the DVB-S.2 or DVB-T.2 standard and which has a code length N of 16,200 bits and has an encoding rate of 5/6;
the m bits being 10 bits while the integer b is 2;
the 10 bits of the code bit being mapped as one symbol to ones of 1,024 signal points prescribed in 1024QAM;
said storage means having 20 columns for storing $10 \times 2$ bits in the row direction and storing N/($10 \times 2$) bits in the column direction;
said replacement step carrying out,
where the i+1th bit from the most significant bit of the $10 \times 2$ code bits read out in the row direction of said storage means is represented as bit $b_i$ and the i+1th bit from the most significant bit of the $10 \times 2$ symbol bits of two successive symbols is represented as bit $y_i$,
replacement for allocating
the bit $b_0$ to the bit $y_8$,
the bit $b_1$ to the bit $y_3$,
the bit $b_2$ to the bit $y_7$,
the bit $b_3$ to the bit $y_{10}$,
the bit $b_4$ to the bit $y_{19}$,
the bit $b_5$ to the bit $y_4$,
the bit $b_6$ to the bit $y_9$,
the bit $b_7$ to the bit $y_5$,
the bit $b_8$ to the bit $y_{17}$,
the bit $b_9$ to the bit $y_6$,
the bit $b_{10}$ to the bit $y_{14}$,
the bit $b_{11}$ to the bit $y_{11}$,
the bit $b_{12}$ to the bit $y_2$,

the bit $b_{13}$ to the bit $y_{18}$,
the bit $b_{14}$ to the bit $y_{16}$,
the bit $b_{15}$ to the bit $y_{15}$,
the bit $b_{16}$ to the bit $y_0$,
the bit $b_{17}$ to the bit $y_1$,
the bit $b_{18}$ to the bit $y_{13}$, and
the bit $b_{19}$ to the bit $y_{12}$,
for the LDPC code which has a code length N of 16,200 bits and encoding rate is 5/6.

**10.** A data processing method, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides
a predetermined positive integer is represented by b,
said storage means stores mb bits in the row direction and stores N/(mb) bits in the column direction;
the code bits of the LDPC code being written in the column direction of said storage means and read out in the row direction;
said data processing method comprising a replacement step for replacing,
where the mb code bits read out in the row direction of said storage means set as successive b symbols,
the mb code bits such that the code bits after the replacement form the symbol bits representative of the symbols;
the LDPC code being an LDPC code which is prescribed in the DVB-S.2 or DVB-T.2 standard and which has a code length N of 16,200 bits and has an encoding rate of 8/9;
the m bits being 10 bits while the integer b is 2;
the 10 bits of the code bit being mapped as one symbol to ones of 1,024 signal points prescribed in 1024QAM;
said storage means having 20 columns for storing $10 \times 2$ bits in the row direction and storing $N/(10 \times 2)$ bits in the column direction;
said replacement step carrying out,
where the i+1th bit from the most significant bit of the $10 \times 2$ code bits read out in the row direction of said storage means is represented as bit $b_i$ and the i+1th bit from the most significant bit of the $10 \times 2$ symbol bits of two successive symbols is represented as bit $y_i$,
replacement for allocating
the bit $b_0$ to the bit $y_6$,
the bit $b_1$ to the bit $y_3$,
the bit $b_2$ to the bit $y_7$,
the bit $b_3$ to the bit $y_{10}$,
the bit $b_4$ to the bit $y_{19}$,
the bit $b_5$ to the bit $y_4$,
the bit $b_6$ to the bit $y_9$,
the bit $b_7$ to the bit $y_5$,
the bit $b_8$ to the bit $y_{17}$,
the bit $b_9$ to the bit $y_6$,
the bit $b_{10}$ to the bit $y_{14}$,
the bit $b_{11}$ to the bit $y_{11}$,
the bit $b_{12}$ to the bit $y_2$,
the bit $b_{13}$ to the bit $y_{18}$,
the bit $b_{14}$ to the bit $y_{16}$,
the bit $b_{15}$ to the bit $y_{15}$,
the bit $b_{16}$ to the bit $y_0$,
the bit $b_{17}$ to the bit $y_1$,
the bit $b_{18}$ to the bit $y_{13}$, and
the bit $b_{19}$ to the bit $y_{12}$,
for the LDPC code which has a code length N of 16,200 bits and encoding rate is 8/9.

**11.** A data processing method, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides
a predetermined positive integer is represented by b,
said storage means stores mb bits in the row direction and stores N/(mb) bits in the column direction;
the code bits of the LDPC code being written in the column direction of said storage means and read out in the row direction;
said data processing method comprising a replacement step for replacing,
where the mb code bits read out in the row direction of said storage means set as b symbols,
the mb code bits such that the code bits after the replacement form the symbol bits representative of the symbols;
the LDPC code being an LDPC code which is prescribed in the DVB-S.2 or DVB-T.2 standard and which has a code length N of 16,200 bits and has an encoding rate of 5/6;
the m bits being 12 bits while the integer b is 2;
the 12 bits of the code bit being mapped as one symbol to ones of 4,096 signal points prescribed in 4096QAM;
said storage means having 24 columns for storing $12 \times 2$ bits in the row direction and storing N/($12 \times 2$) bits in the column direction;
said replacement step carrying out,
where the i+1th bit from the most significant bit of the $12 \times 2$ code bits read out in the row direction of said storage means is represented as bit $b_i$ and the i+1th bit from the most significant bit of the $12 \times 2$ symbol bits of two successive symbols is represented as bit $y_i$,
replacement for allocating
the bit $b_0$ to the bit $y_{10}$,
the bit $b_1$ to the bit $y_{15}$,
the bit $b_2$ to the bit $y_4$,
the bit $b_3$ to the bit $y_{19}$,
the bit $b_4$ to the bit $y_{21}$,
the bit $b_5$ to the bit $y_{16}$,
the bit $b_6$ to the bit $y_{23}$,
the bit $b_7$ to the bit $y_{18}$,
the bit $b_8$ to the bit $y_{11}$,
the bit $b_9$ to the bit $y_{14}$,
the bit $b_{10}$ to the bit $y_{22}$,
the bit $b_{11}$ to the bit $y_5$,
the bit $b_{12}$ to the bit $y_6$,
the bit $b_{13}$ to the bit $y_{17}$,
the bit $b_{14}$ to the bit $y_{13}$,
the bit $b_{15}$ to the bit $y_{20}$,
the bit $b_{16}$ to the bit $y_1$,
the bit $b_{17}$ to the bit $y_3$,
the bit $b_{18}$ to the bit $y_9$,
the bit $b_{19}$ to the bit $y_2$,
the bit $b_{20}$ to the bit $y_7$,
the bit $b_{21}$ to the bit $y_8$,
the bit $b_{22}$ to the bit $y_2$, and
the bit $b_{23}$ to the bit $y_0$,
for the LDPC code which has a code length N of 16,200 bits and encoding rate is 5/6.

**12.** A data processing method, wherein:

where code bits of an LDPC (Low Density Parity Check) code having a code length of N bits are written in a column direction of storage means for storing the code bits in a row direction and the column direction and m bits of the code bits of the LDPC code read out in the row direction are set as one symbol, and besides
a predetermined positive integer is represented by b,
said storage means stores mb bits in the row direction and stores N/(mb) bits in the column direction;
the code bits of the LDPC code being written in the column direction of said storage means and read out in the row direction;
said data processing method comprising a replacement step for replacing,
where the mb code bits read out in the row direction of said storage means set as b symbols,
the mb code bits such that the code bits after the replacement form the symbol bits representative of the symbols;
the LDPC code being an LDPC code which is prescribed in the DVB-S.2 or DVB-T.2 standard and which has a code length N of 16,200 bits and has an encoding rate of 8/9;
the m bits being 12 bits while the integer b is 2;
the 12 bits of the code bit being mapped as one symbol to ones of 4,096 signal points prescribed in 4096QAM;
said storage means having 24 columns for storing 12 × 2 bits in the row direction and storing N/(12 × 2) bits in the column direction;
said replacement step carrying out,
where the i+1th bit from the most significant bit of the 12 × 2 code bits read out in the row direction of said storage means is represented as bit $b_i$ and the i+1th bit from the most significant bit of the 12 × 2 symbol bits of two successive symbols is represented as bit $y_i$,
replacement for allocating
the bit $b_1$ to the bit $y_{10}$,
the bit $b_1$ to the bit $y_{15}$,
the bit $b_2$ to the bit $y_4$,
the bit $b_3$ to the bit $y_{19}$,
the bit $b_4$ to the bit $y_{21}$,
the bit $b_5$ to the bit $y_{16}$,
the bit $b_6$ to the bit $y_{23}$,
the bit $b_7$ to the bit $y_{18}$,
the bit $b_8$ to the bit $y_{11}$,
the bit $b_9$ to the bit $y_{14}$,
the bit $b_{10}$ to the bit $y_{22}$,
the bit $b_{11}$ to the bit $y_5$,
the bit $b_{12}$ to the bit $y_6$,
the bit $b_{13}$ to the bit $y_{17}$,
the bit $b_{14}$ to the bit $y_{13}$,
the bit $b_{15}$ to the bit $y_{20}$,
the bit $b_{16}$ to the bit $y_1$,
the bit $b_{17}$ to the bit $y_3$,
the bit $b_{18}$ to the bit $y_9$,
the bit $b_{19}$ to the bit $y_2$,
the bit $b_{20}$ to the bit $y_7$,
the bit $b_{21}$ to the bit $y_8$,
the bit $b_{22}$ to the bit $y_{12}$, and
the bit $b_{23}$ to the bit $y_0$,
for the LDPC code which has a code length N of 16,200 bits and encoding rate is 8/9.

FIG.1

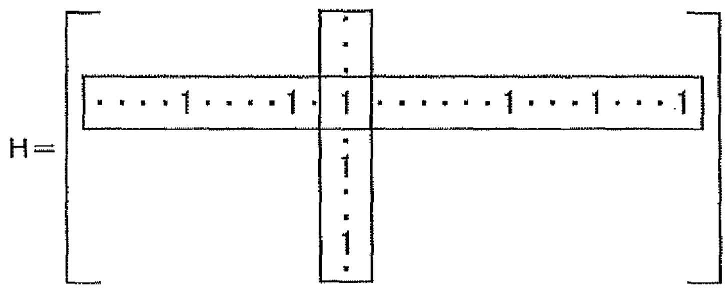
H=
· · · · 1 · · · · · 1 · 1 · · · · · · · · 1 · · · 1 · · · · 1
1
1

FIG.2

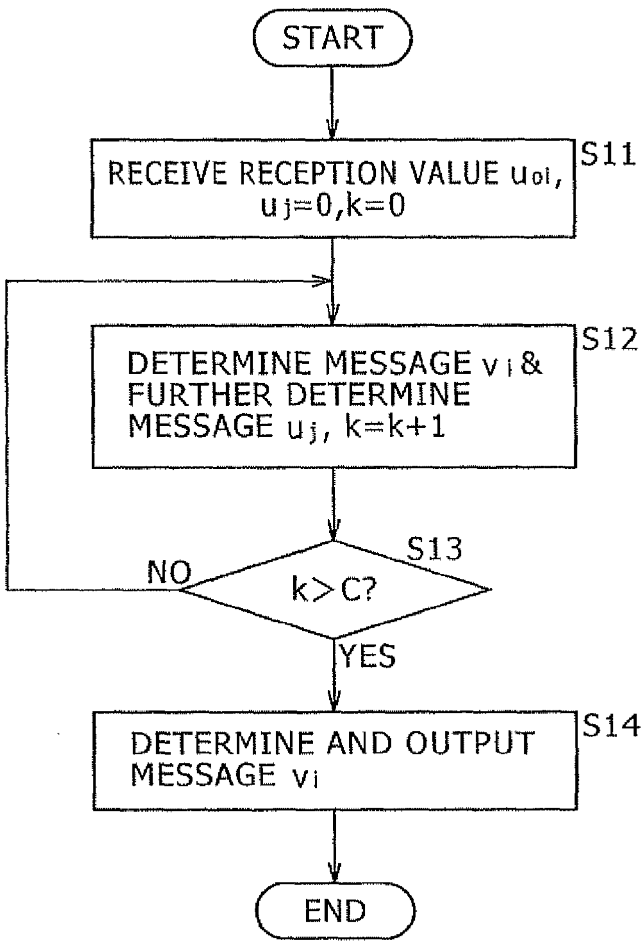
START
RECEIVE RECEPTION VALUE $u_{0i}$, $u_j$=0,k=0
S11
DETERMINE MESSAGE $v_i$ & FURTHER DETERMINE MESSAGE $u_j$, k=k+1
S12
k>C?
S13
NO
YES
DETERMINE AND OUTPUT MESSAGE $v_i$
S14
END

FIG.3

$$H=\begin{bmatrix} 1 & 1 & 1 & 0 & 0 & 0 & 1 & 0 & 1 & 1 & 0 & 0 \\ 1 & 1 & 0 & 1 & 1 & 0 & 0 & 0 & 0 & 0 & 1 & 1 \\ 0 & 0 & 1 & 1 & 1 & 1 & 1 & 0 & 0 & 1 & 0 & 0 \\ 0 & 0 & 0 & 1 & 1 & 1 & 0 & 1 & 1 & 0 & 0 & 1 \\ 1 & 1 & 0 & 0 & 0 & 1 & 0 & 1 & 0 & 1 & 1 & 0 \\ 0 & 0 & 1 & 0 & 0 & 0 & 1 & 1 & 1 & 0 & 1 & 1 \end{bmatrix}$$

FIG.4

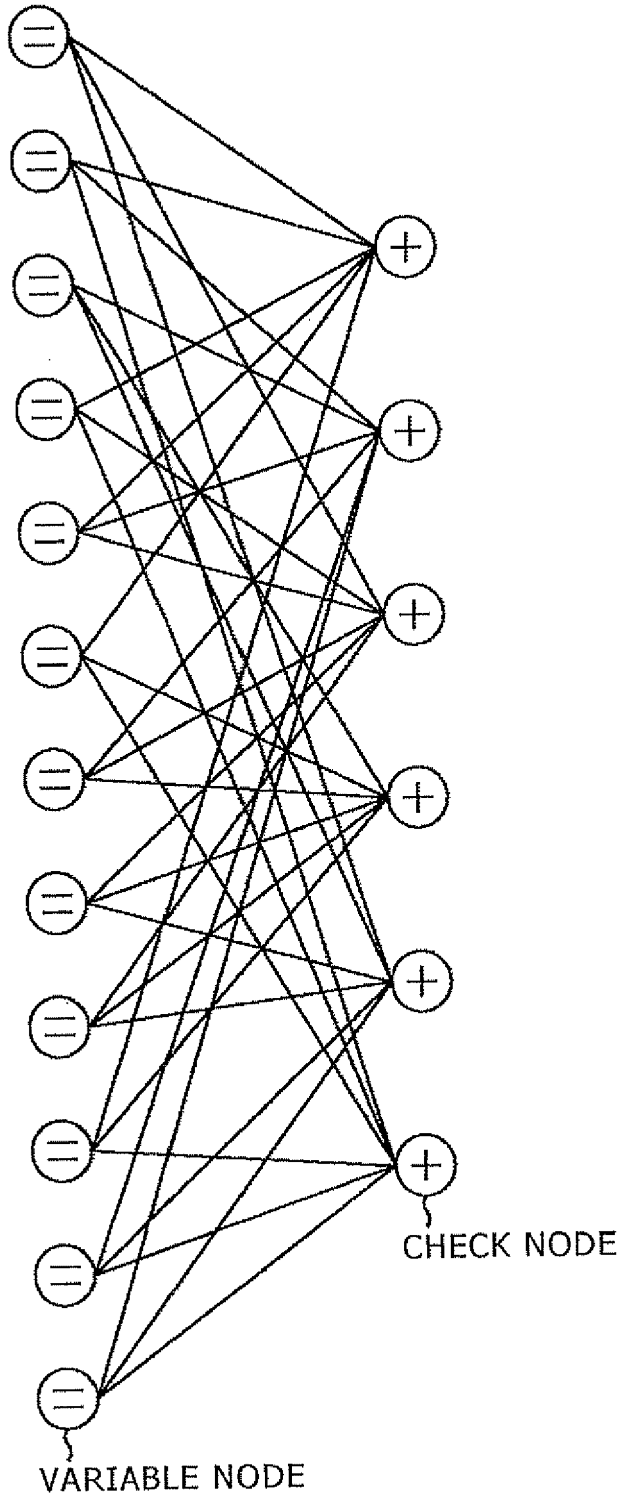

FIG. 5

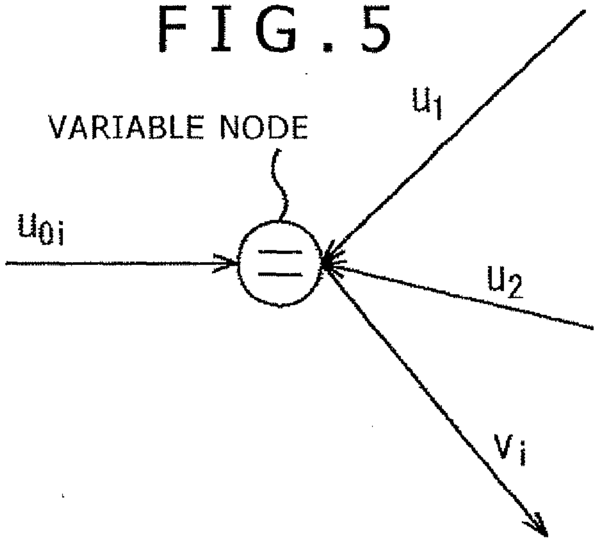


FIG. 6

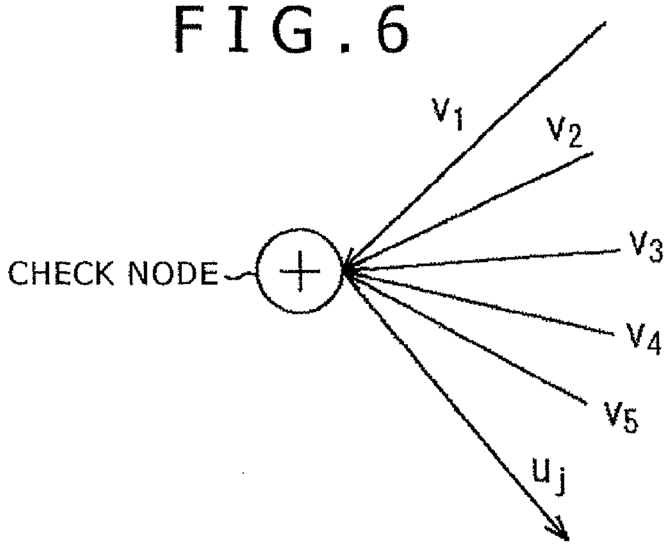


FIG. 7

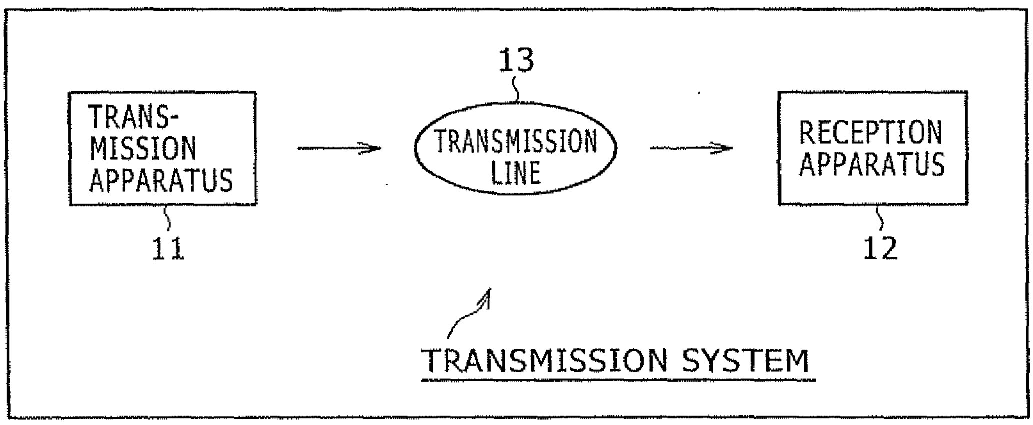

FIG. 8

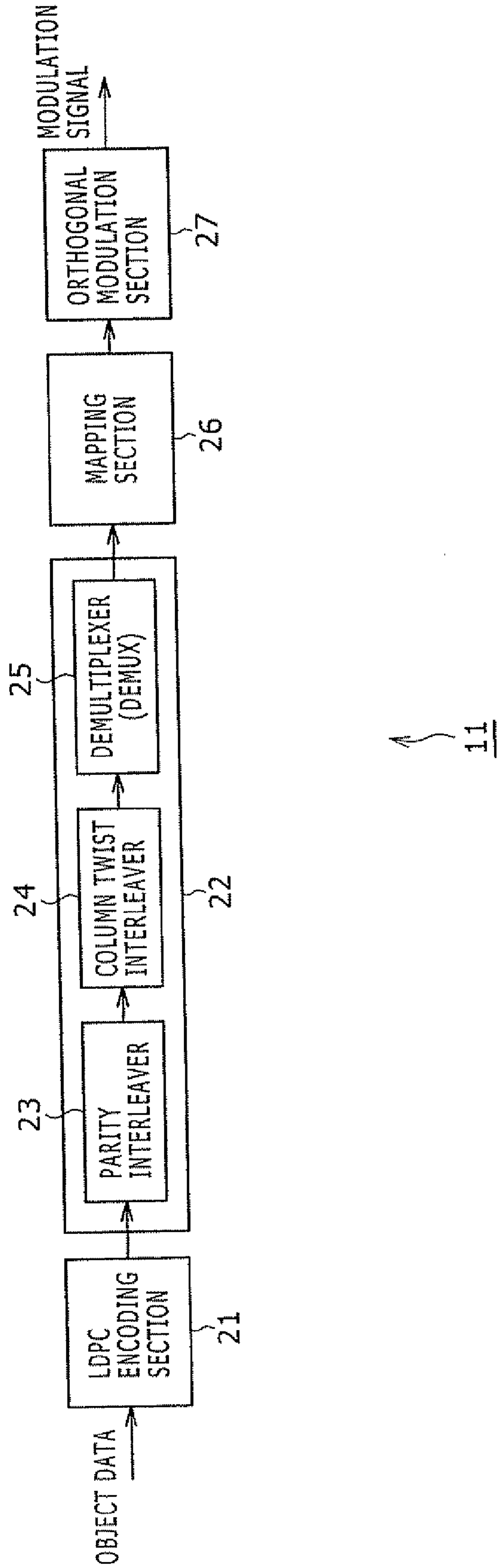
OBJECT DATA
LDPC ENCODING SECTION
21
PARITY INTERLEAVER
23
COLUMN TWIST INTERLEAVER
24
DEMULTIPLEXER (DEMUX)
25
22
MAPPING SECTION
26
ORTHOGONAL MODULATION SECTION
27
MODULATION SIGNAL
11

FIG. 9

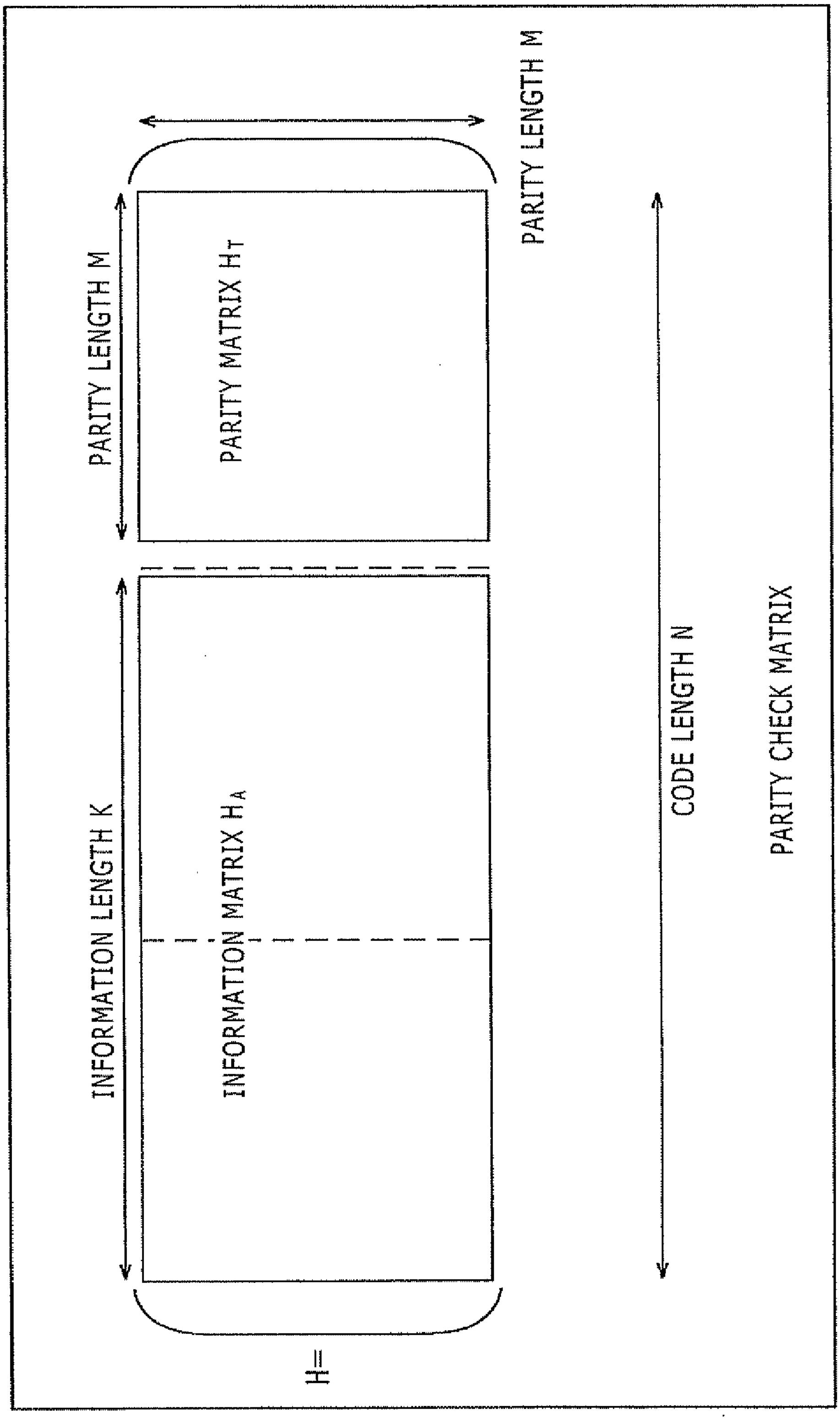
H=
INFORMATION LENGTH K
INFORMATION MATRIX $H_A$
PARITY LENGTH M
PARITY MATRIX $H_T$
PARITY LENGTH M
CODE LENGTH N
PARITY CHECK MATRIX

FIG.10

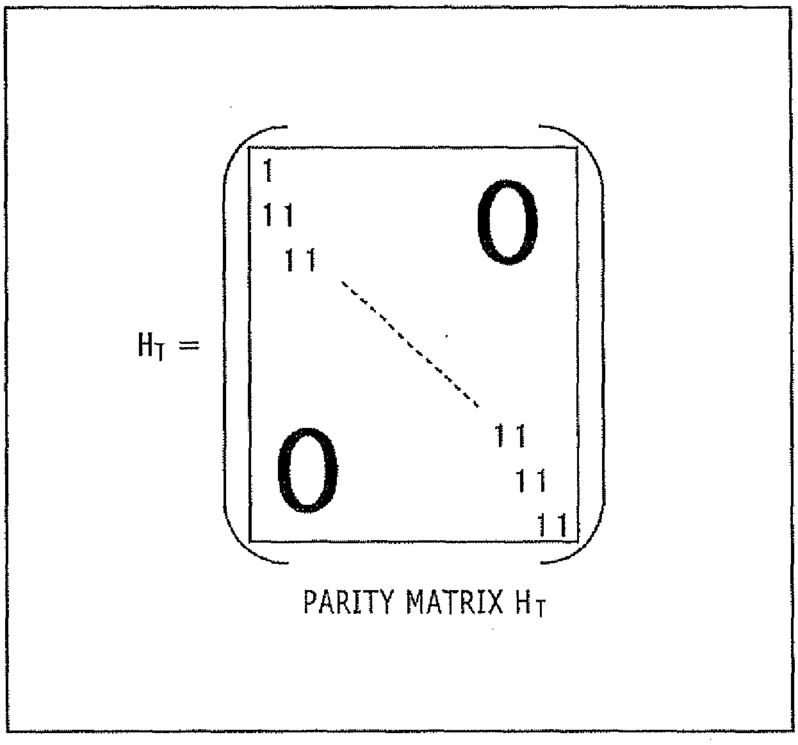

# FIG.11

A PARITY CHECK MATRIX

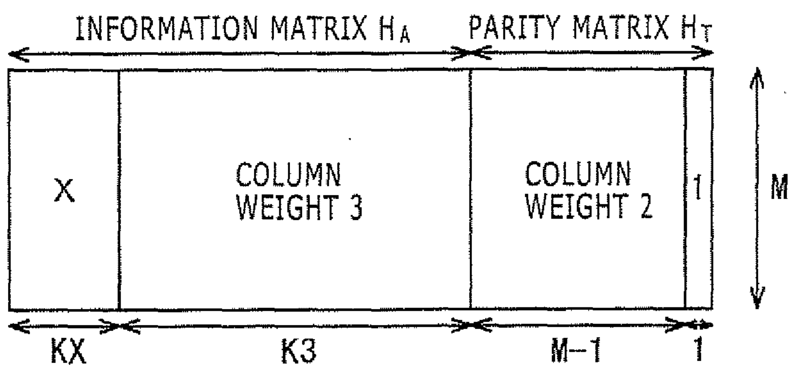


B COLUMN NUMBER OF COLUMN WEIGHTS

| | N=64800 | | | | N=16200 | | | |
|---|---|---|---|---|---|---|---|---|
| Nominal ENCODING RATE | X | KX | K3 | M | x | KX | K3 | M |
| 1/4 | 12 | 5400 | 10800 | 48600 | 12 | 1440 | 1800 | 12960 |
| 1/3 | 12 | 7200 | 14400 | 43200 | 12 | 1800 | 3600 | 10800 |
| 2/5 | 12 | 8640 | 17280 | 38880 | 12 | 2160 | 4320 | 9720 |
| 1/2 | 8 | 12960 | 19440 | 32400 | 8 | 1800 | 5400 | 9000 |
| 3/5 | 12 | 12960 | 25920 | 25920 | 12 | 3240 | 6480 | 6480 |
| 2/3 | 13 | 4320 | 38880 | 21600 | 13 | 1080 | 9720 | 5400 |
| 3/4 | 12 | 5400 | 43200 | 16200 | 12 | 360 | 11520 | 4320 |
| 4/5 | 11 | 6480 | 45360 | 12960 | - | 0 | 12600 | 3600 |
| 5/6 | 13 | 5400 | 48600 | 10800 | 13 | 360 | 12960 | 2880 |
| 8/9 | 4 | 7200 | 50400 | 7200 | 4 | 1800 | 12600 | 1800 |
| 9/10 | 4 | 6480 | 51840 | 6480 | --- | --- | --- | --- |

FIG.12

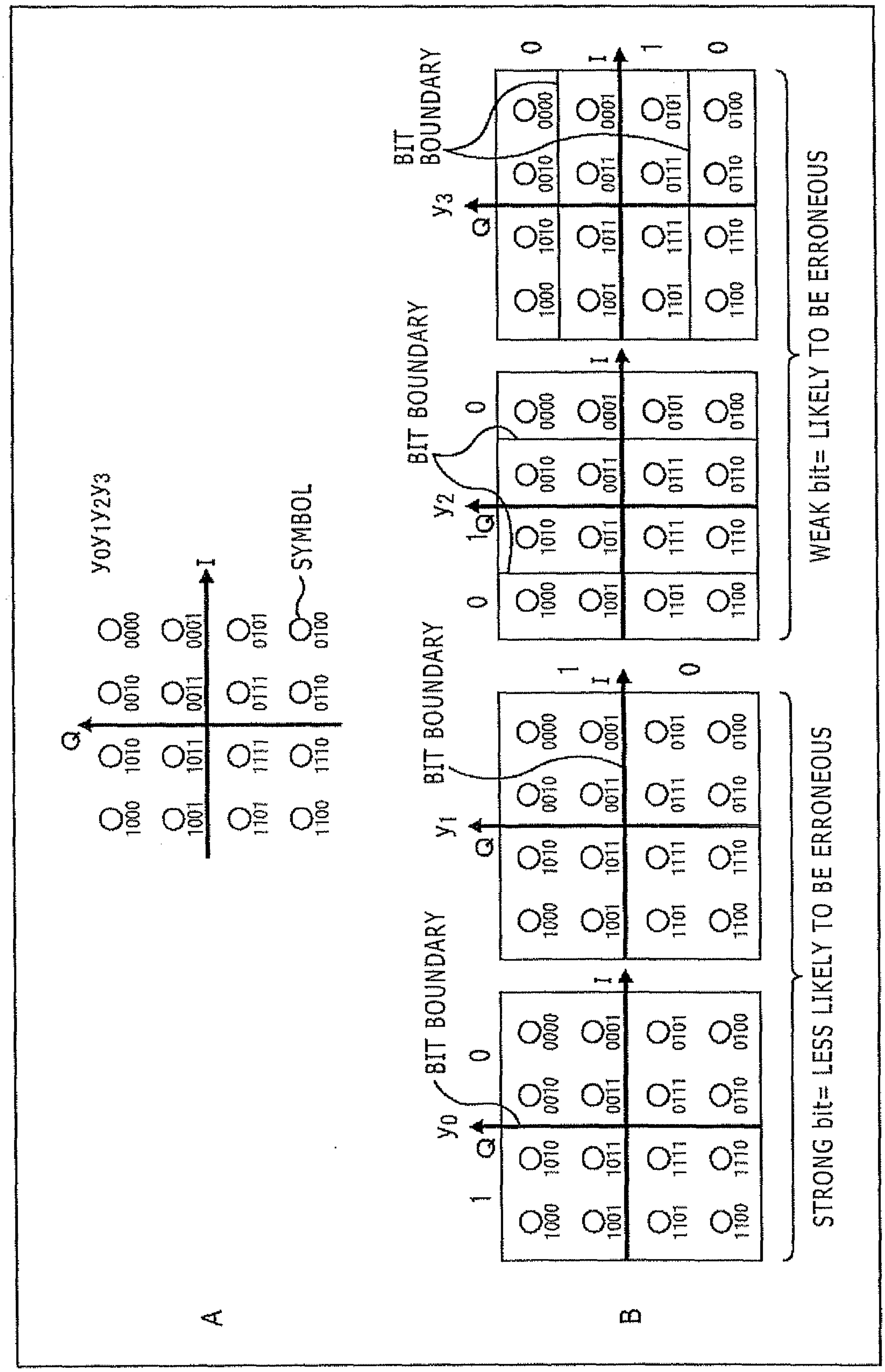
A
y0y1y2y3
Q
I
SYMBOL
B
y0
y1
y2
y3
BIT BOUNDARY
STRONG bit= LESS LIKELY TO BE ERRONEOUS
WEAK bit= LIKELY TO BE ERRONEOUS

# FIG.13

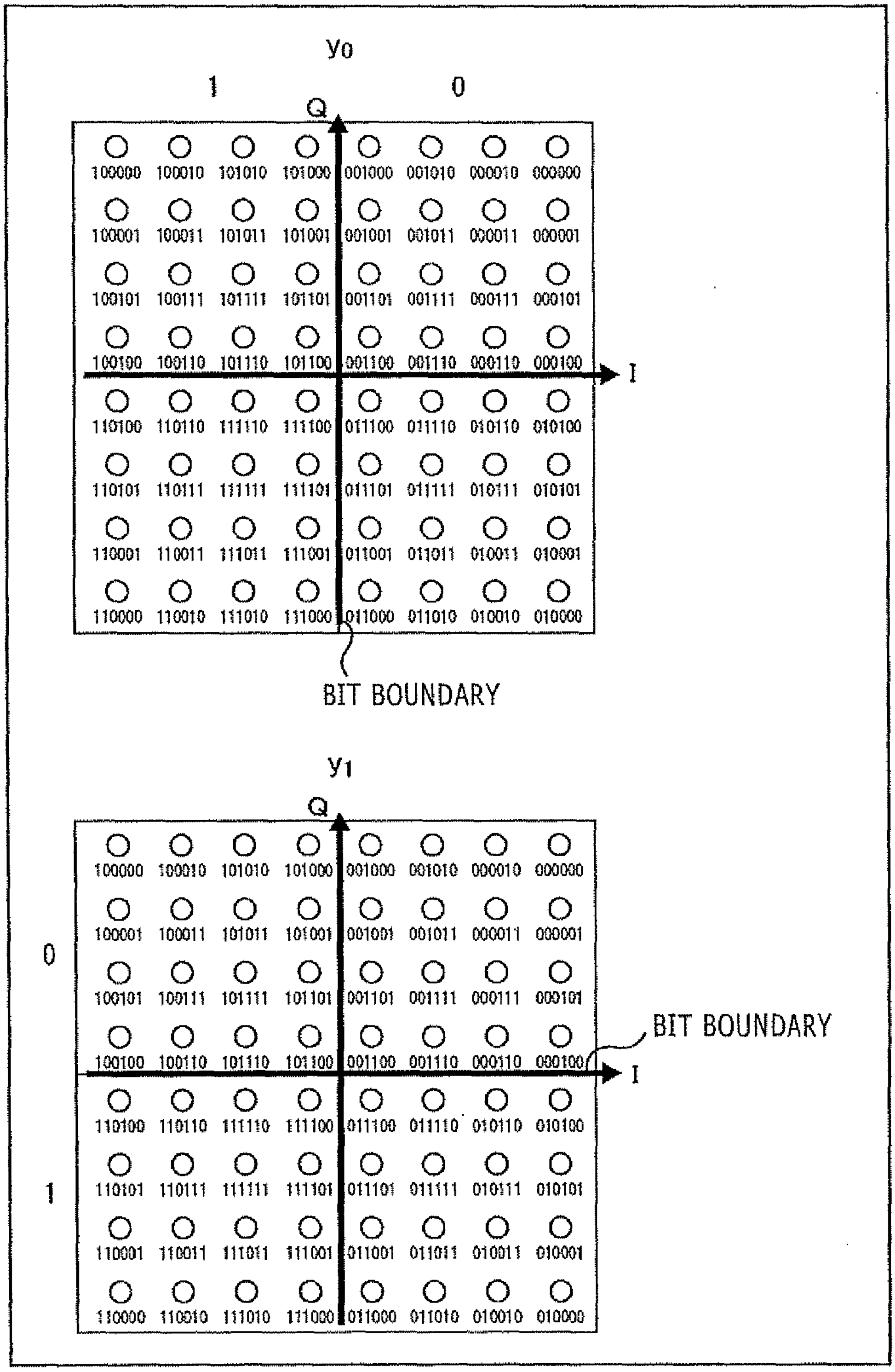

y0
1
0
Q
100000 100010 101010 101000 001000 001010 000010 000000
100001 100011 101011 101001 001001 001011 000011 000001
100101 100111 101111 101101 001101 001111 000111 000101
100100 100110 101110 101100 001100 001110 000110 000100
I
110100 110110 111110 111100 011100 011110 010110 010100
110101 110111 111111 111101 011101 011111 010111 010101
110001 110011 111011 111001 011001 011011 010011 010001
110000 110010 111010 111000 011000 011010 010010 010000
BIT BOUNDARY
y1
Q
100000 100010 101010 101000 001000 001010 000010 000000
100001 100011 101011 101001 001001 001011 000011 000001
0
100101 100111 101111 101101 001101 001111 000111 000101
BIT BOUNDARY
100100 100110 101110 101100 001100 001110 000110 000100
I
110100 110110 111110 111100 011100 011110 010110 010100
1
110101 110111 111111 111101 011101 011111 010111 010101
110001 110011 111011 111001 011001 011011 010011 010001
110000 110010 111010 111000 011000 011010 010010 010000

# FIG.14

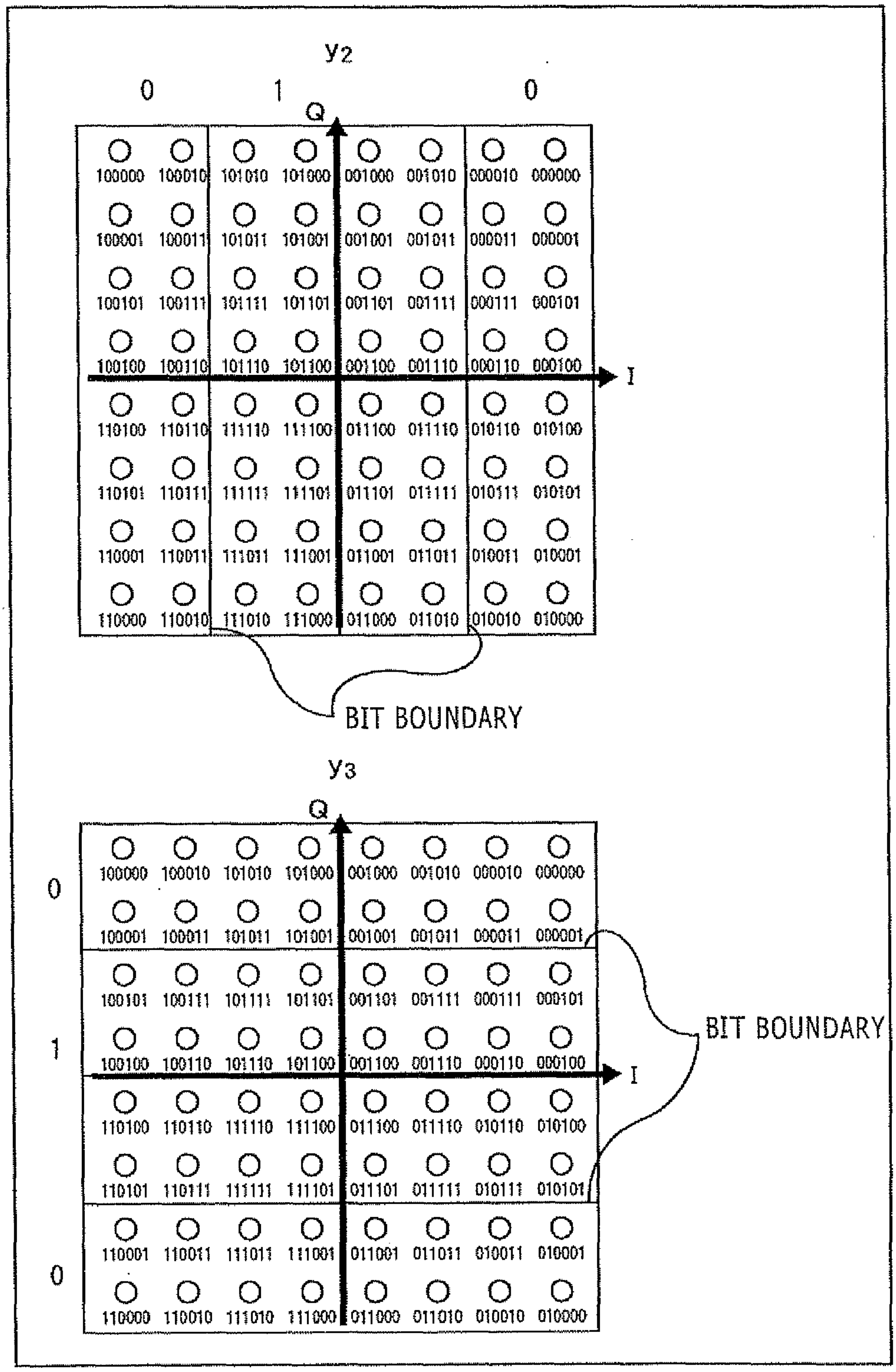

# FIG.15

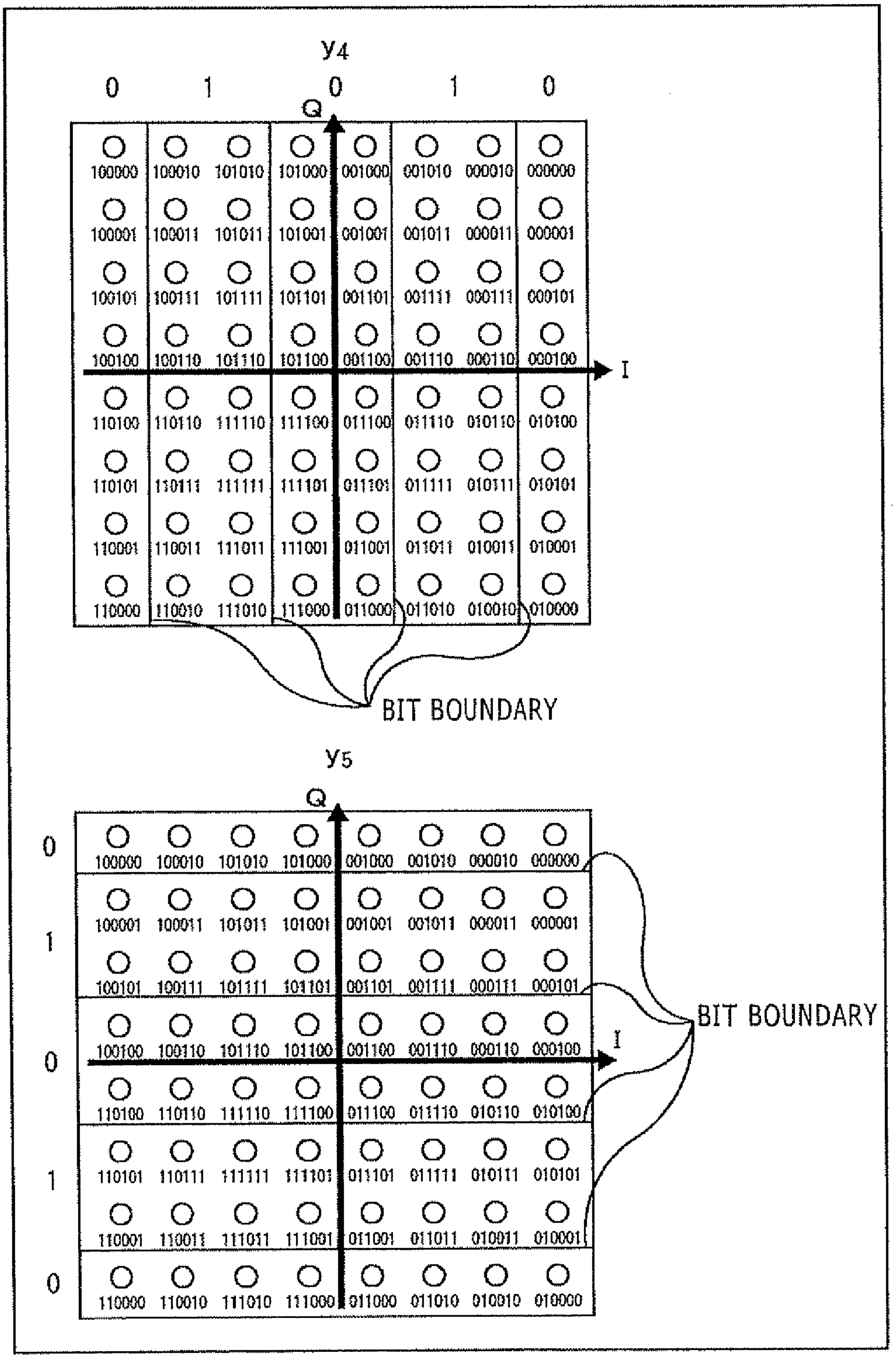
y4
0
1
0
1
0
Q
I
100000 100010 101010 101000 001000 001010 000010 000000
100001 100011 101011 101001 001001 001011 000011 000001
100101 100111 101111 101101 001101 001111 000111 000101
100100 100110 101110 101100 001100 001110 000110 000100
110100 110110 111110 111100 011100 011110 010110 010100
110101 110111 111111 111101 011101 011111 010111 010101
110001 110011 111011 111001 011001 011011 010011 010001
110000 110010 111010 111000 011000 011010 010010 010000
BIT BOUNDARY
y5
Q
I
0
1
0
1
0
100000 100010 101010 101000 001000 001010 000010 000000
100001 100011 101011 101001 001001 001011 000011 000001
100101 100111 101111 101101 001101 001111 000111 000101
100100 100110 101110 101100 001100 001110 000110 000100
110100 110110 111110 111100 011100 011110 010110 010100
110101 110111 111111 111101 011101 011111 010111 010101
110001 110011 111011 111001 011001 011011 010011 010001
110000 110010 111010 111000 011000 011010 010010 010000
BIT BOUNDARY

FIG.16

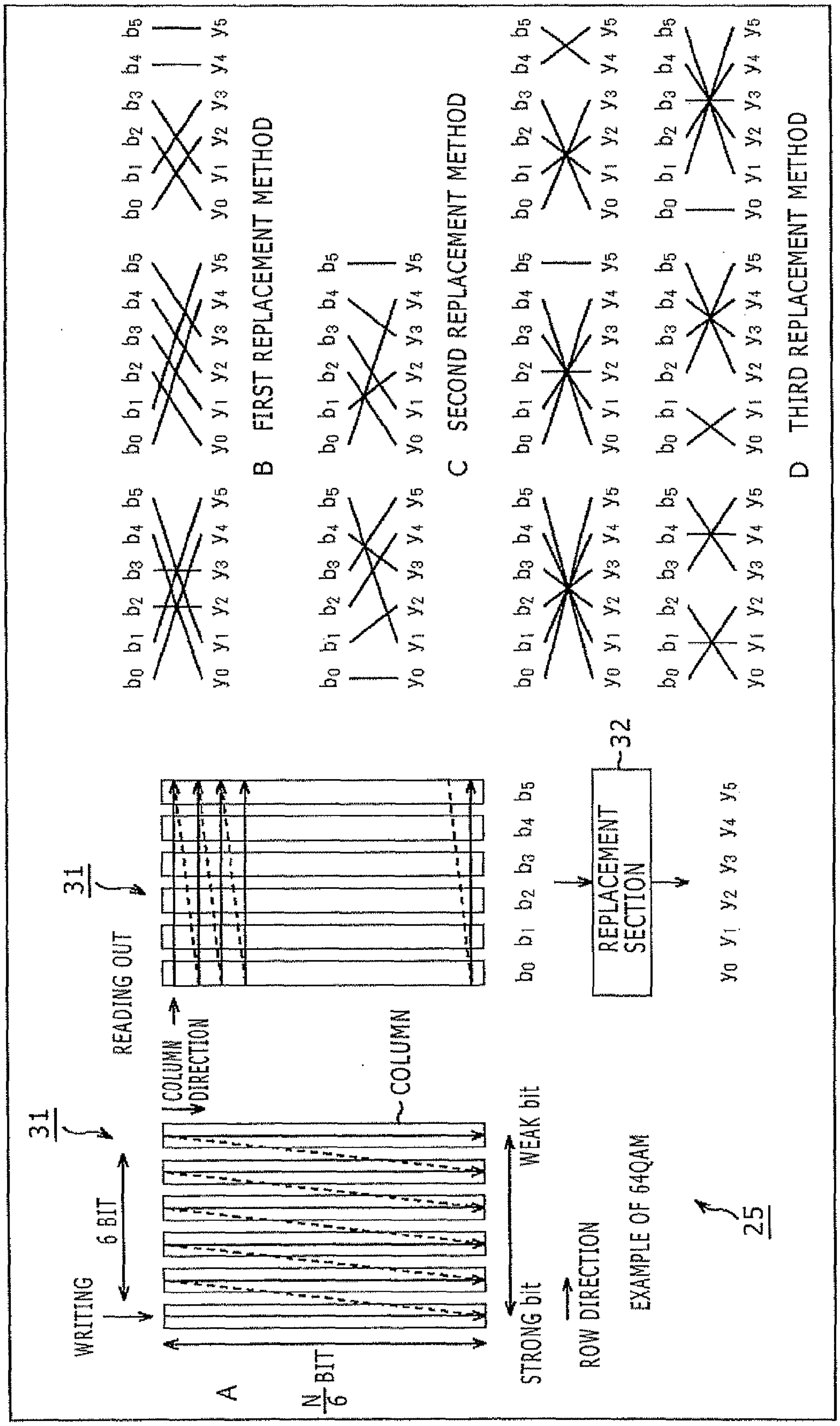
A
WRITING
6 BIT
31
N/6 BIT
COLUMN DIRECTION
COLUMN
READING OUT
STRONG bit
WEAK bit
ROW DIRECTION
EXAMPLE OF 64QAM
25
b0 b1 b2 b3 b4 b5
REPLACEMENT SECTION
32
y0 y1 y2 y3 y4 y5
B FIRST REPLACEMENT METHOD
C SECOND REPLACEMENT METHOD
D THIRD REPLACEMENT METHOD

FIG.17

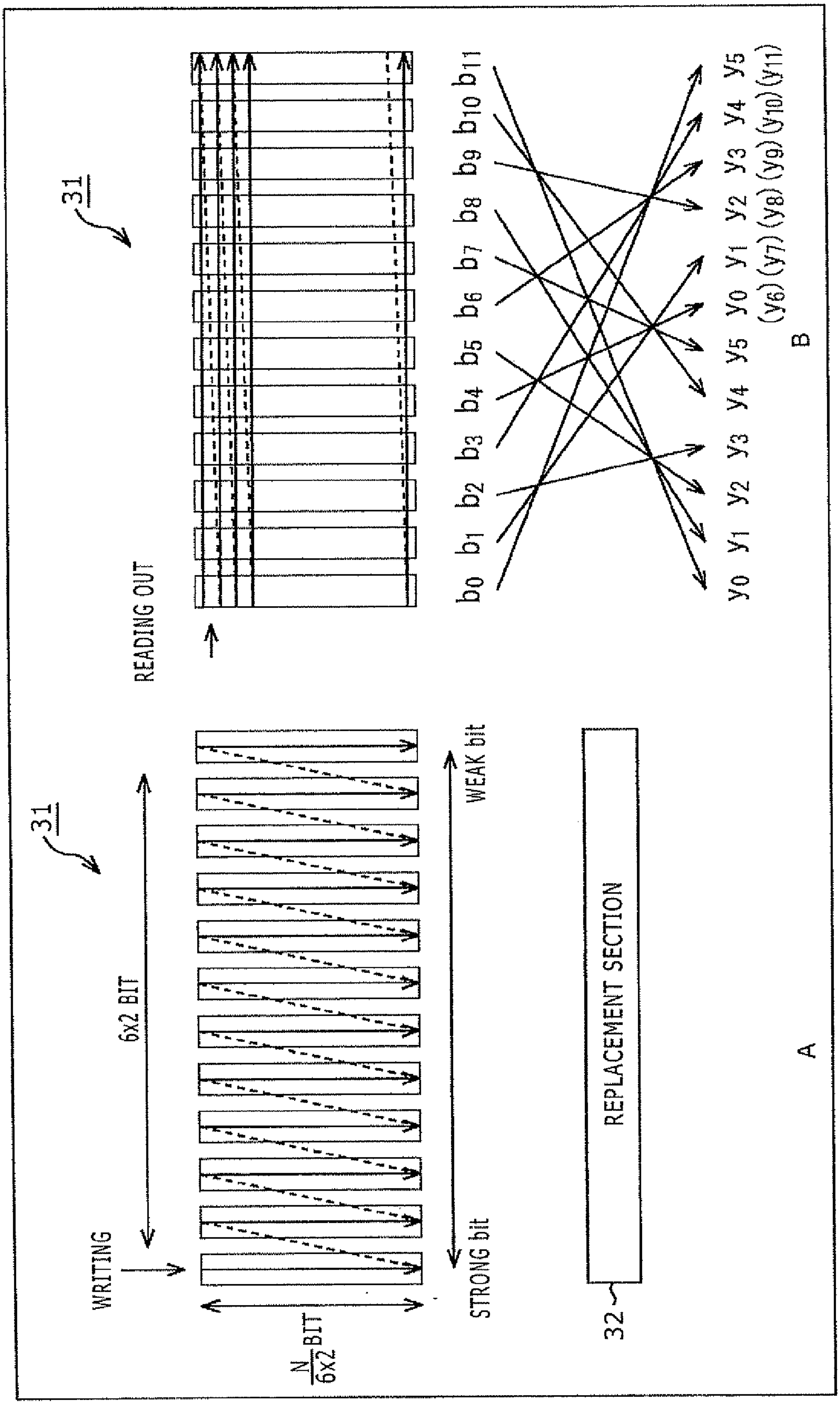

31
WRITING
6x2 BIT
N/6x2 BIT
STRONG bit
WEAK bit
READING OUT
REPLACEMENT SECTION
32
A
b0 b1 b2 b3 b4 b5 b6 b7 b8 b9 b10 b11
y0 y1 y2 y3 y4 y5 y0 y1 y2 y3 y4 y5
(y6) (y7) (y8) (y9) (y10) (y11)
B

FIG.18

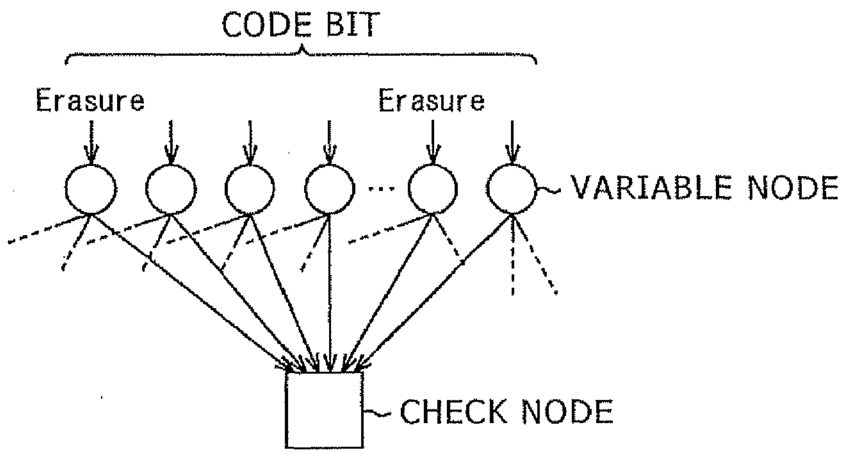

# FIG.19

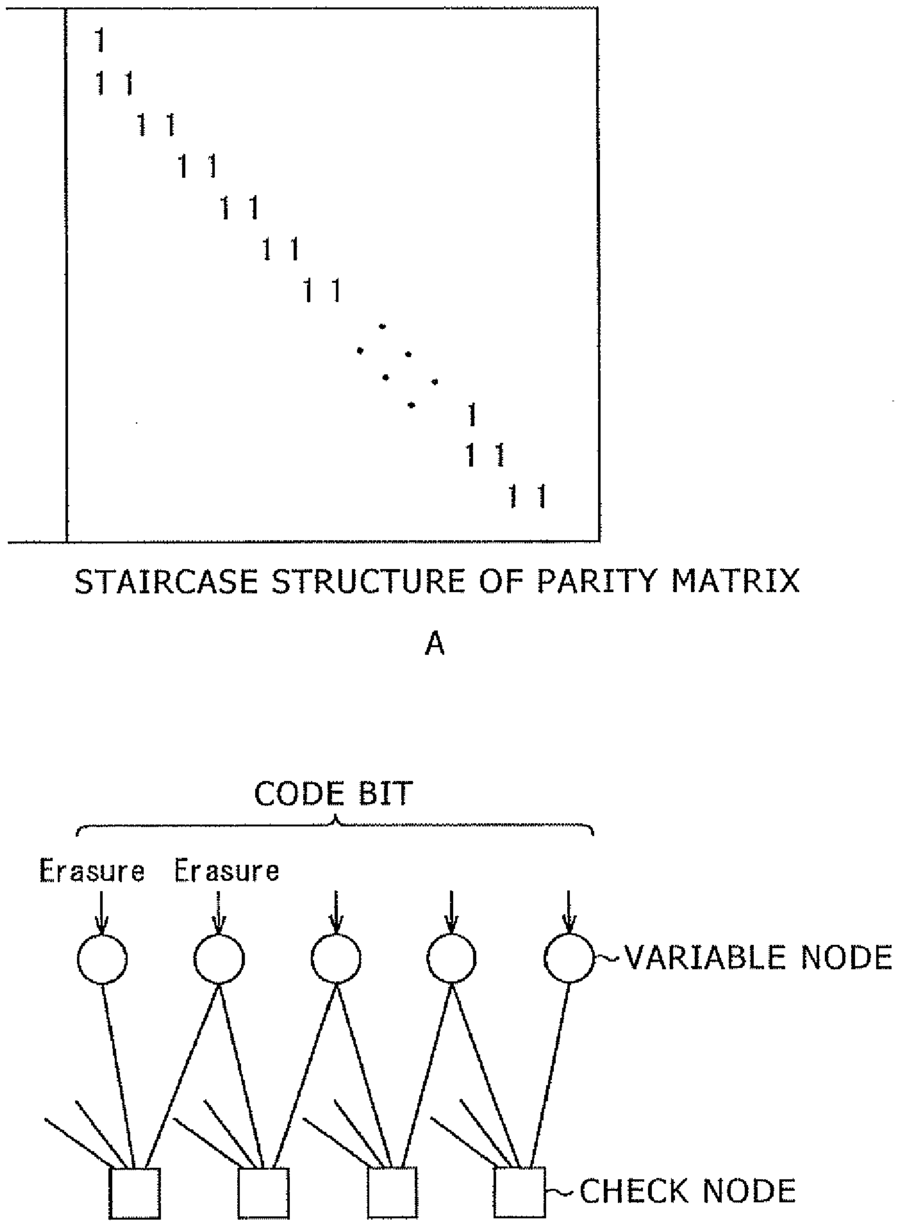


STAIRCASE STRUCTURE OF PARITY MATRIX

A

STAIRCASE STRUCTURE PORTION OF Tanner Graph

B

FIG.20

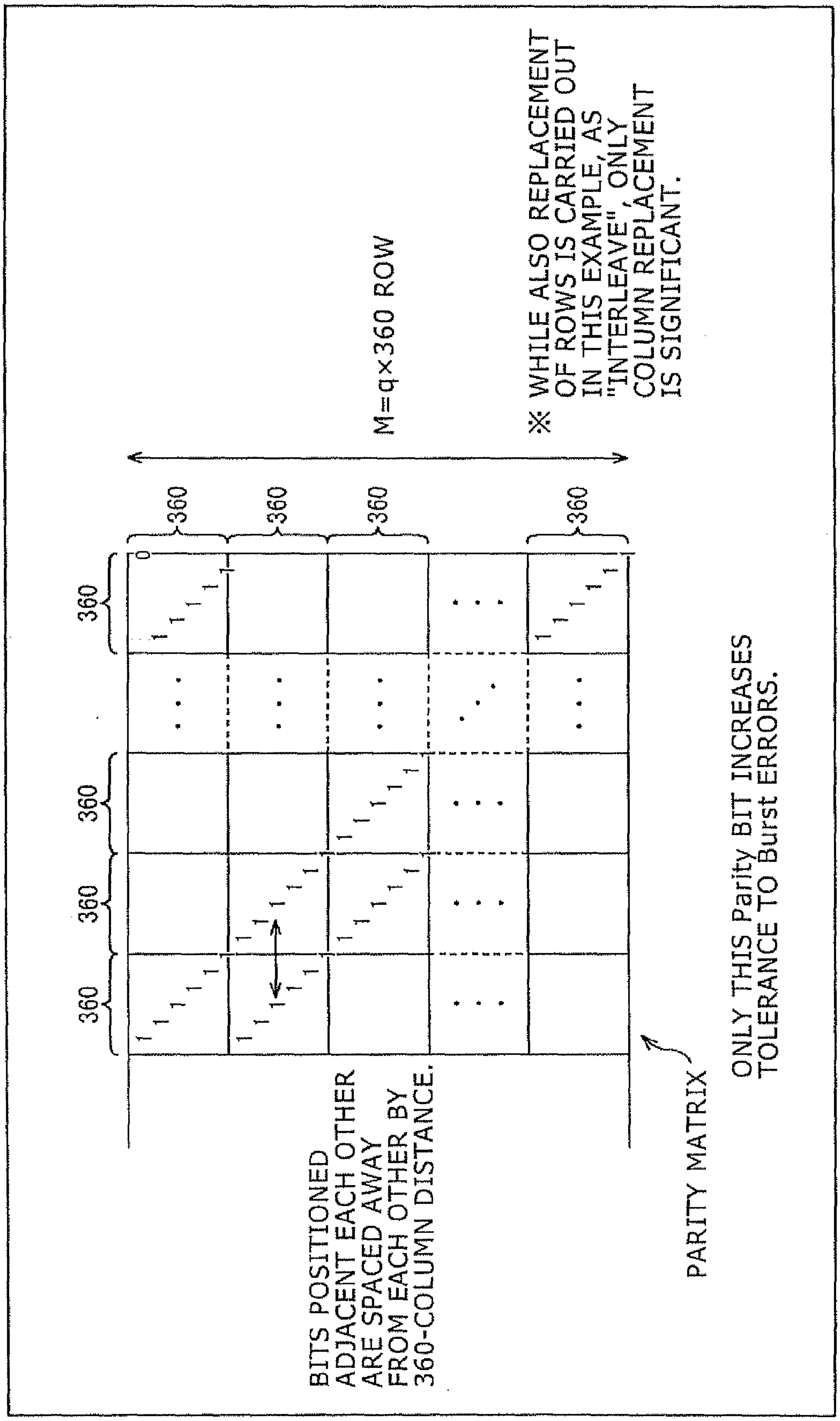
360
360
360
360
360
360
360
360
0
M=q×360 ROW
※ WHILE ALSO REPLACEMENT OF ROWS IS CARRIED OUT IN THIS EXAMPLE, AS "INTERLEAVE", ONLY COLUMN REPLACEMENT IS SIGNIFICANT.
BITS POSITIONED ADJACENT EACH OTHER ARE SPACED AWAY FROM EACH OTHER BY 360-COLUMN DISTANCE.
PARITY MATRIX
ONLY THIS Parity BIT INCREASES TOLERANCE TO Burst ERRORS.

FIG.21

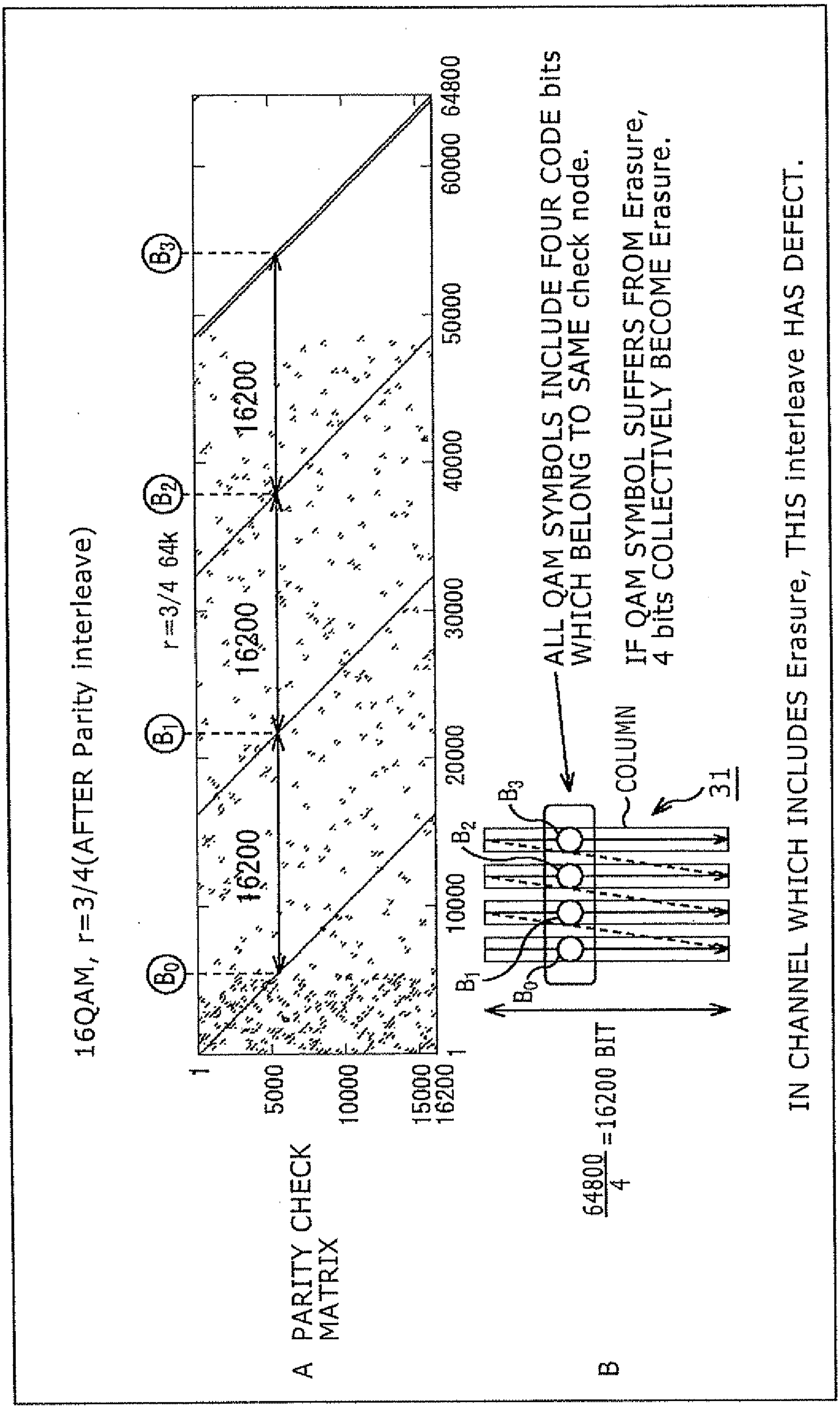
16QAM, r=3/4(AFTER Parity interleave)
r=3/4 64k
A PARITY CHECK MATRIX
B0
B1
B2
B3
16200
16200
16200
1
5000
10000
15000
16200
1
10000
20000
30000
40000
50000
60000
64800
B
64800/4 =16200 BIT
ALL QAM SYMBOLS INCLUDE FOUR CODE bits WHICH BELONG TO SAME check node.
IF QAM SYMBOL SUFFERS FROM Erasure, 4 bits COLLECTIVELY BECOME Erasure.
COLUMN
31
IN CHANNEL WHICH INCLUDES Erasure, THIS interleave HAS DEFECT.

FIG.22

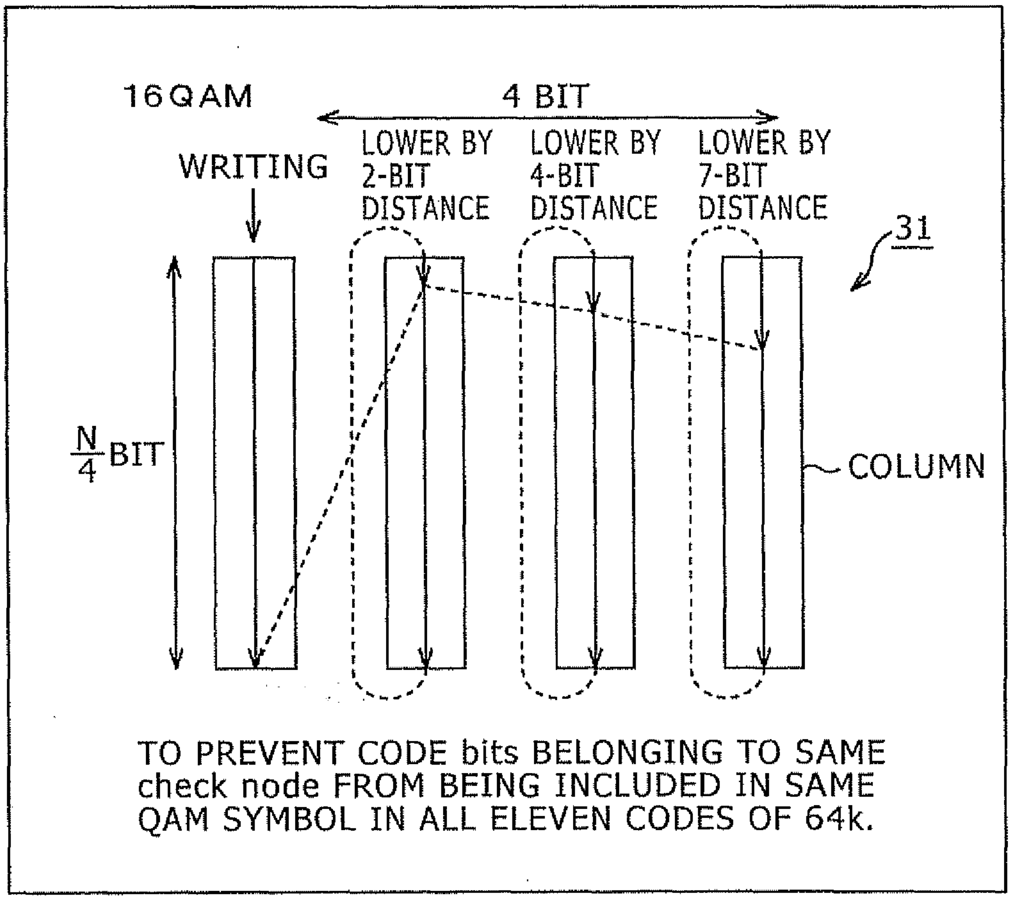
16QAM
4 BIT
WRITING
LOWER BY 2-BIT DISTANCE
LOWER BY 4-BIT DISTANCE
LOWER BY 7-BIT DISTANCE
31
$\frac{N}{4}$BIT
COLUMN
TO PREVENT CODE bits BELONGING TO SAME check node FROM BEING INCLUDED IN SAME QAM SYMBOL IN ALL ELEVEN CODES OF 64k.

# FIG.23

| REQUIRED MEMORY COLUMN NUMBER mb | b=1 (FIRST TO THIRD REPLACEMENT METHODS) | b=2 (FOURTH REPLACEMENT METHOD) | WRITING STARTING POSITION IN mb COLUMNS | | | | | | | | | | | | | | | | | | | | | | | |
|---|---|---|---|---|---|---|---|---|---|---|---|---|---|---|---|---|---|---|---|---|---|---|---|---|---|---|
| | | | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 |
| 2 | QPSK | | 0 | 2 | | | | | | | | | | | | | | | | | | | | | | |
| 4 | 16QAM | QPSK | 0 | 2 | 4 | 7 | | | | | | | | | | | | | | | | | | | | |
| 6 | 64QAM | | 0 | 2 | 5 | 9 | 10 | 13 | | | | | | | | | | | | | | | | | | |
| 8 | 256QAM | 16QAM | 0 | 0 | 2 | 4 | 4 | 5 | 7 | 7 | | | | | | | | | | | | | | | | |
| 10 | 1024QAM | | 0 | 3 | 6 | 8 | 11 | 13 | 15 | 17 | 18 | 20 | | | | | | | | | | | | | | |
| 12 | 4096QAM | 64QAM | 0 | 0 | 2 | 2 | 3 | 4 | 4 | 5 | 5 | 7 | 8 | 9 | | | | | | | | | | | | |
| 16 | | 256QAM | 0 | 2 | 2 | 2 | 2 | 3 | 7 | 15 | 16 | 20 | 22 | 22 | 27 | 27 | 28 | 32 | | | | | | | | |
| 20 | | 1024QAM | 0 | 1 | 3 | 4 | 5 | 6 | 6 | 9 | 13 | 14 | 14 | 16 | 21 | 21 | 23 | 25 | 25 | 26 | 28 | 30 | | | | |
| 24 | | 4096QAM | 0 | 5 | 8 | 8 | 8 | 8 | 10 | 10 | 10 | 12 | 13 | 16 | 17 | 19 | 21 | 22 | 23 | 26 | 37 | 39 | 40 | 41 | 41 | 41 |

# FIG.24

| REQUIRED MEMORY COLUMN NUMBER mb | b=1 (FIRST TO THIRD REPLACEMENT METHODS) | b=2 (FOURTH REPLACEMENT METHOD) | WRITING STARTING POSITION IN mb COLUMNS | | | | | | | | | | | | | | | | | | | | | | | |
|---|---|---|---|---|---|---|---|---|---|---|---|---|---|---|---|---|---|---|---|---|---|---|---|---|---|---|
| | | | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 |
| 2 | QPSK | | 0 | 0 | | | | | | | | | | | | | | | | | | | | | | |
| 4 | 16QAM | QPSK | 0 | 2 | 3 | 3 | | | | | | | | | | | | | | | | | | | | |
| 6 | 64QAM | | 0 | 0 | 2 | 3 | 7 | 7 | | | | | | | | | | | | | | | | | | |
| 8 | 256QAM | 16QAM | 0 | 0 | 0 | 1 | 7 | 20 | 20 | 21 | | | | | | | | | | | | | | | | |
| 10 | 1024QAM | | 0 | 1 | 2 | 2 | 3 | 3 | 4 | 4 | 5 | 7 | | | | | | | | | | | | | | |
| 12 | 4096QAM | 64QAM | 0 | 0 | 0 | 2 | 2 | 2 | 3 | 3 | 3 | 6 | 7 | 7 | | | | | | | | | | | | |
| 20 | | 1024QAM | 0 | 0 | 0 | 2 | 2 | 2 | 2 | 2 | 5 | 5 | 5 | 5 | 5 | 7 | 7 | 7 | 7 | 8 | 8 | 10 | | | | |
| 24 | | 4096QAM | 0 | 0 | 0 | 0 | 0 | 0 | 0 | 1 | 1 | 1 | 2 | 2 | 2 | 3 | 7 | 9 | 9 | 9 | 10 | 10 | 10 | 10 | 10 | 11 |

FIG.25

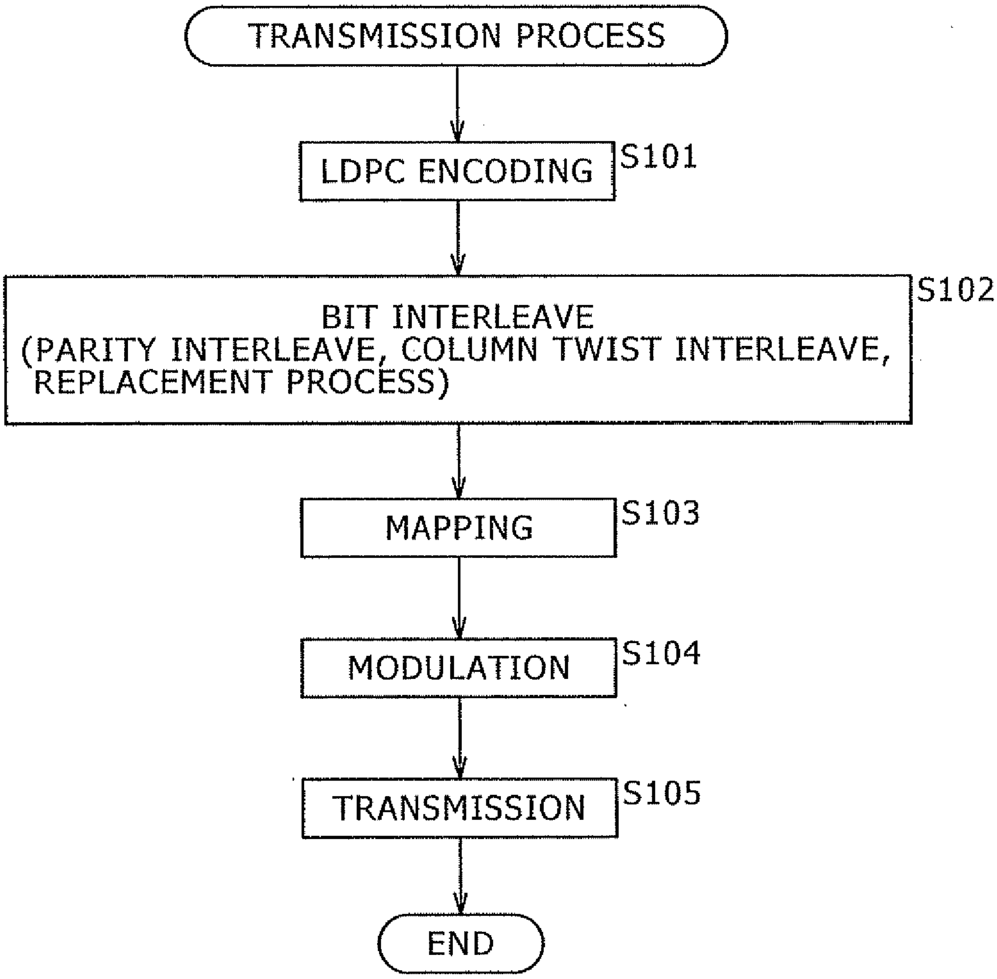
TRANSMISSION PROCESS
LDPC ENCODING
S101
BIT INTERLEAVE
(PARITY INTERLEAVE, COLUMN TWIST INTERLEAVE,
REPLACEMENT PROCESS)
S102
MAPPING
S103
MODULATION
S104
TRANSMISSION
S105
END

# FIG.26

A

EQUIVALENT REDUCTION MODE OF Flutter

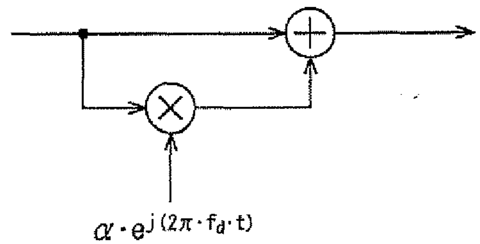


$1/\alpha^2 = D/U$
$f_d$:doppler freq.
t:time

B

OFDM SYMBOL WAS SENT IN THIS CHANNEL, AND simulation WAS CARRIED OUT WITH MODEL FROM WHICH 1-carrier WAS EXTRACTED AFTER FFT ON RECEPTION SIDE

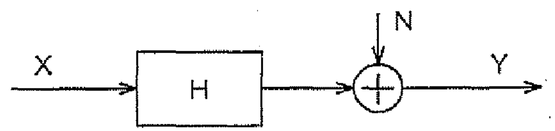


$$Y = \underbrace{\left[1 + \alpha \cdot \exp\left(j2\pi \cdot m \cdot f_d \cdot Ts + j2\pi \cdot \frac{(Nu-1) \cdot f_d \cdot Tu}{Nu}\right) \cdot \frac{\mathrm{sinc}(\pi \cdot f_d \cdot Tu)}{\mathrm{sinc}(\pi \cdot f_d \cdot Tu/Nu)}\right]}_{H} \cdot X + N$$

$$E\left[N^2\right] = \alpha^2 \cdot \left(1 - \left|\frac{\mathrm{sinc}(\pi \cdot f_d \cdot Tu)}{\mathrm{sinc}(\pi \cdot f_d \cdot Tu/Nu)}\right|^2\right)$$

|C| OF POWER: APPROXIMATION WITH AWGN

m:symbol number
Ts:symbol length(sec)
Tu:effective symbol length(sec)
Nu:number of OFDM carriers

FIG.27

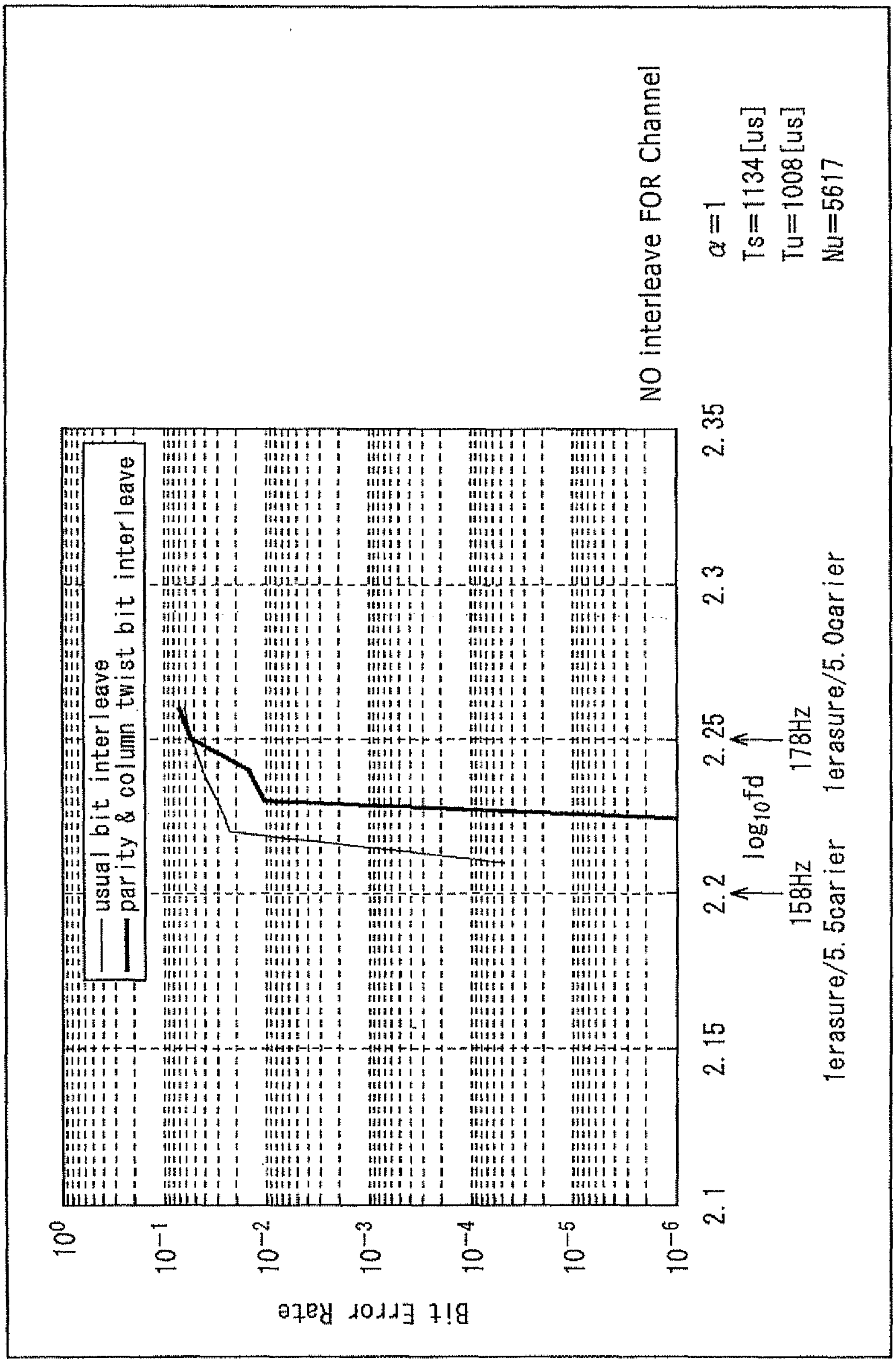
Bit Error Rate
10^0
10^-1
10^-2
10^-3
10^-4
10^-5
10^-6
2.1
2.15
2.2
2.25
2.3
2.35
log10fd
158Hz
178Hz
1erasure/5.5carier
1erasure/5.0carier
usual bit interleave
parity & column twist bit interleave
NO interleave FOR Channel
α=1
Ts=1134[us]
Tu=1008[us]
Nu=5617

FIG.28

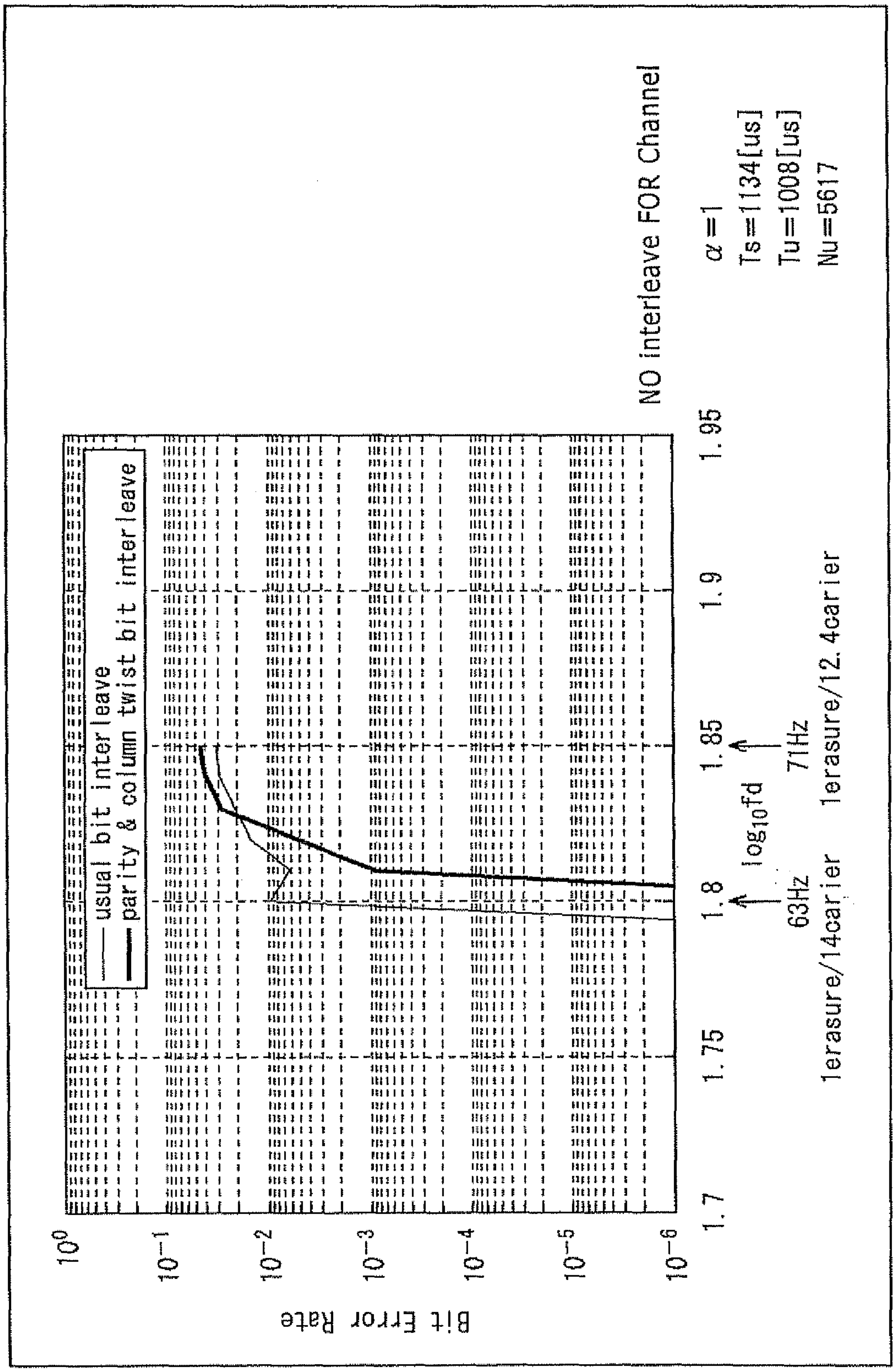
Bit Error Rate
10^0
10^-1
10^-2
10^-3
10^-4
10^-5
10^-6
1.7
1.75
1.8
1.85
1.9
1.95
usual bit interleave
parity & column twist bit interleave
log10fd
63Hz
1erasure/14carier
71Hz
1erasure/12.4carier
NO interleave FOR Channel
α=1
Ts=1134[us]
Tu=1008[us]
Nu=5617

FIG.29

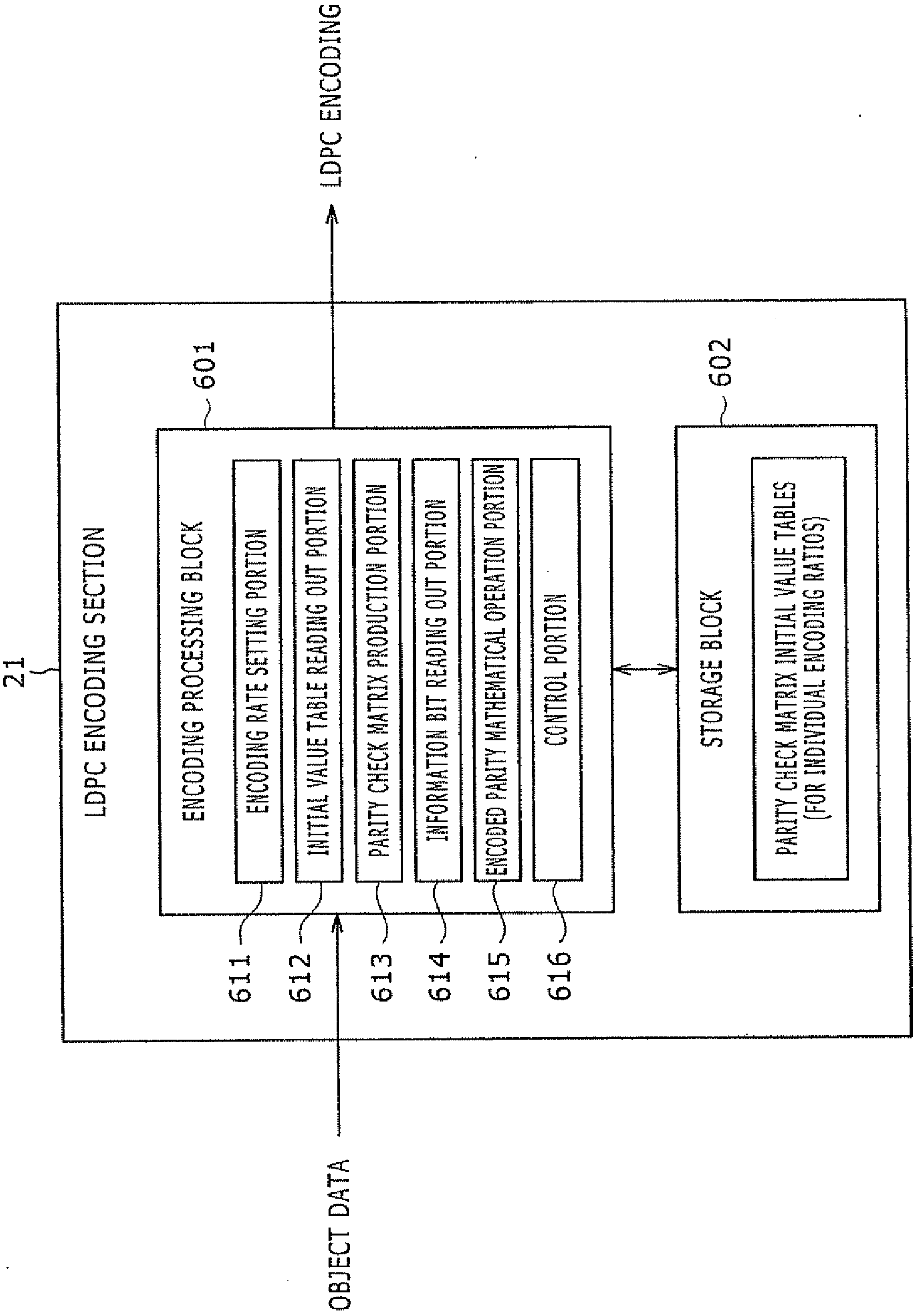
LDPC ENCODING
21
LDPC ENCODING SECTION
601
ENCODING PROCESSING BLOCK
ENCODING RATE SETTING PORTION
INITIAL VALUE TABLE READING OUT PORTION
PARITY CHECK MATRIX PRODUCTION PORTION
INFORMATION BIT READING OUT PORTION
ENCODED PARITY MATHEMATICAL OPERATION PORTION
CONTROL PORTION
611
612
613
614
615
616
602
STORAGE BLOCK
PARITY CHECK MATRIX INITIAL VALUE TABLES
(FOR INDIVIDUAL ENCODING RATIOS)
OBJECT DATA

FIG.30

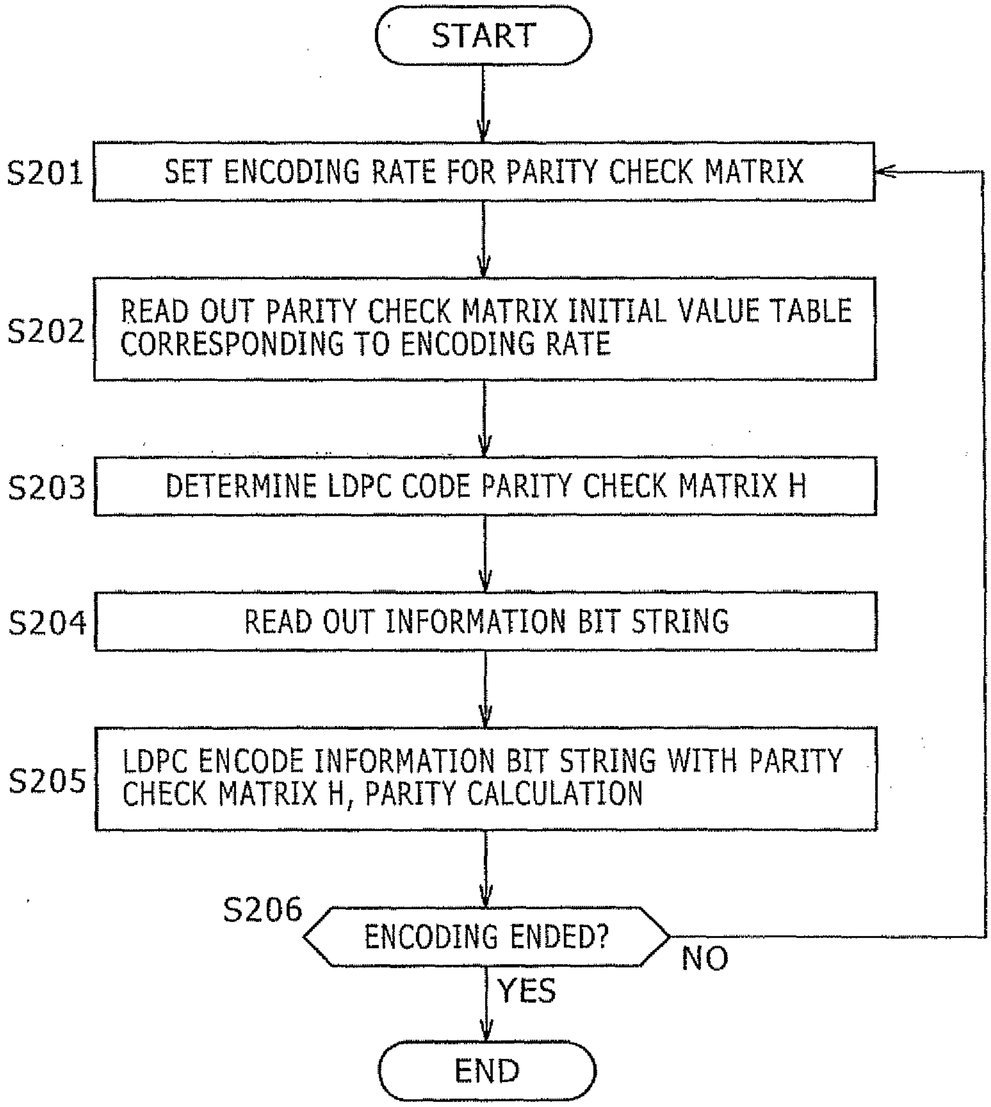
START
S201
SET ENCODING RATE FOR PARITY CHECK MATRIX
S202
READ OUT PARITY CHECK MATRIX INITIAL VALUE TABLE CORRESPONDING TO ENCODING RATE
S203
DETERMINE LDPC CODE PARITY CHECK MATRIX H
S204
READ OUT INFORMATION BIT STRING
S205
LDPC ENCODE INFORMATION BIT STRING WITH PARITY CHECK MATRIX H, PARITY CALCULATION
S206
ENCODING ENDED?
NO
YES
END

# FIG.31

r2/3 16K

0 2084 1613 1548 1286 1460 3196 4297 2481 3369 3451 4620 2622
1 122 1516 3448 2880 1407 1847 3799 3529 373 971 4358 3108
2 259 3399 929 2650 864 3996 3833 107 5287 164 3125 2350
3 342 3529
4 4198 2147
5 1880 4836
6 3864 4910
7 243 1542
8 3011 1436
9 2167 2512
10 4606 1003
11 2835 705
12 3426 2365
13 3848 2474
14 1360 1743
0 163 2536
1 2583 1180
2 1542 509
3 4418 1005
4 5212 5117
5 2155 2922
6 347 2696
7 226 4296
8 1560 487
9 3926 1640
10 149 2928
11 2364 563
12 635 688
13 231 1684
14 1129 3894

PARITY CHECK MATRIX INITIAL VALUE TABLE WHERE $r=\frac{2}{3}$, N=16200

# FIG.32

PARITY CHECK MATRIX INITIAL VALUE TABLE WHERE $r=\frac{2}{3}$, N=64800

r2/3 64K

0 10491 16043 506 12826 8065 8226 2767 240 18673 9279 10579 20928
1 17819 8313 6433 6224 5120 5824 12812 17187 9940 13447 13825 18483
2 17957 6024 8681 18628 12794 5915 14576 10970 12064 20437 4455 7151
3 19777 6183 9972 14536 8182 17749 11341 5556 4379 17434 15477 18532
4 4651 19689 1608 659 16707 14335 6143 3058 14618 17894 20684 5306
5 9778 2552 12096 12369 15198 16890 4851 3109 1700 18725 1997 15882
6 486 6111 13743 11537 5591 7433 15227 14145 1483 3887 17431 12430
7 20647 14311 11734 4180 8110 5525 12141 15761 18661 18441 10569 8192
8 3791 14759 15264 19918 10132 9062 10010 12786 10675 9682 19246 5454
9 19525 9485 7777 19999 8378 9209 3163 20232 6690 16518 716 7353
10 4588 6709 20202 10905 915 4317 11073 13576 16433 368 3508 21171
11 14072 4033 19959 12608 631 19494 14160 8249 10223 21504 12395 4322
12 13800 14161
13 2948 9647
14 14693 16027
15 20506 11082
16 1143 9020
17 13501 4014
18 1548 2190
19 12216 21556
20 2095 19897
21 4189 7958
22 15940 10048
23 515 12614
24 8501 8450
25 17595 16784
26 5913 8495
27 16394 10423
28 7409 6981
29 6678 15939
30 20344 12987
31 2510 14588
32 17918 6655
33 6703 19451
34 496 4217
35 7290 5766
36 10521 8925
37 20379 11905
38 4090 5838
39 19082 17040

# FIG.33

40 20233 12352
41 19365 19546
42 6249 19030
43 11037 19193
44 19760 11772
45 19644 7428
46 16076 3521
47 11779 21062
48 13062 9682
49 8934 5217
50 11087 3319
51 18892 4356
52 7894 3898
53 5963 4360
54 7346 11726
55 5182 5609
56 2412 17295
57 9845 20494
58 6687 1864
59 20564 5216
0 18226 17207
1 9380 8266
2 7073 3065
3 18252 13437
4 9161 15642
5 10714 10153
6 11585 9078
7 5359 9418
8 9024 9515
9 1206 16354
10 14994 1102
11 9375 20796
12 15964 6027
13 14789 6452
14 8002 18591
15 14742 14089
16 253 3045
17 1274 19286
18 14777 2044
19 13920 9900
20 452 7374

# FIG.34

21 18206 9921
22 6131 5414
23 10077 9726
24 12045 5479
25 4322 7990
26 15616 5550
27 15561 10661
28 20718 7387
29 2518 18804
30 8984 2600
31 6516 17909
32 11148 98
33 20559 3704
34 7510 1569
35 16000 11692
36 9147 10303
37 16650 191
38 15577 18685
39 17167 20917
40 4256 3391
41 20092 17219
42 9218 5056
43 18429 8472
44 12093 20753
45 16345 12748
46 16023 11095
47 5048 17595
48 18995 4817
49 16483 3536
50 1439 16148
51 3661 3039
52 19010 18121
53 8968 11793
54 13427 18003
55 5303 3083
56 531 16668
57 4771 6722
58 5695 7960
59 3589 14630

# FIG.35

r3/4 16K

3 3198 478 4207 1481 1009 2616 1924 3437 554 683 1801
4 2681 2135
5 3107 4027
6 2637 3373
7 3830 3449
8 4129 2060
9 4184 2742
10 3946 1070
11 2239 984
0 1458 3031
1 3003 1328
2 1137 1716
3 132 3725
4 1817 638
5 1774 3447
6 3632 1257
7 542 3694
8 1015 1945
9 1948 412
10 995 2238
11 4141 1907
0 2480 3079
1 3021 1088
2 713 1379
3 997 3903
4 2323 3361
5 1110 986
6 2532 142
7 1690 2405
8 1298 1881
9 615 174
10 1648 3112
11 1415 2808

PARITY CHECK MATRIX INITIAL VALUE TABLE WHERE $r=\frac{3}{4}$, N=16200

# FIG.36

PARITY CHECK MATRIX INITIAL VALUE TABLE WHERE $r=\frac{3}{4}$, N=64800

r3/4 64K

0 6385 7901 14611 13389 11200 3252 5243 2504 2722 821 7374
1 11359 2698 357 13824 12772 7244 6752 15310 852 2001 11417
2 7862 7977 6321 13612 12197 14449 15137 13860 1708 6399 13444
3 1560 11804 6975 13292 3646 3812 8772 7306 5795 14327 7866
4 7626 11407 14599 9689 1628 2113 10809 9283 1230 15241 4870
5 1610 5699 15876 9446 12515 1400 6303 5411 14181 13925 7358
6 4059 8836 3405 7853 7992 15336 5970 10368 10278 9675 4651
7 4441 3963 9153 2109 12683 7459 12030 12221 629 15212 406
8 6007 8411 5771 3497 543 14202 875 9186 6235 13908 3563
9 3232 6625 4795 546 9781 2071 7312 3399 7250 4932 12652
10 8820 10088 11090 7069 6585 13134 10158 7183 488 7455 9238
11 1903 10818 119 215 7558 11046 10615 11545 14784 7961 15619
12 3655 8736 4917 15874 5129 2134 15944 14768 7150 2692 1469
13 8316 3820 505 8923 6757 806 7957 4216 15589 13244 2622
14 14463 4852 15733 3041 11193 12860 13673 8152 6551 15108 8758
15 3149 11981
16 13416 6906
17 13098 13352
18 2009 14460
19 7207 4314
20 3312 3945
21 4418 6248
22 2669 13975
23 7571 9023
24 14172 2967
25 7271 7138
26 6135 13670
27 7490 14559
28 8657 2466
29 8599 12834
30 3470 3152
31 13917 4365
32 6024 13730
33 10973 14182
34 2464 13167
35 5281 15049
36 1103 1849
37 2058 1069
38 9654 6095
39 14311 7667

FIG.37

40 15617 8146
41 4588 11218
42 13660 6243
43 8578 7874
44 11741 2686
0 1022 1264
1 12604 9965
2 8217 2707
3 3156 11793
4 354 1514
5 6978 14058
6 7922 16079
7 15087 12138
8 5053 6470
9 12687 14932
10 15458 1763
11 8121 1721
12 12431 549
13 4129 7091
14 1426 8415
15 9783 7604
16 6295 11329
17 1409 12061
18 8065 9087
19 2918 8438
20 1293 14115
21 3922 13851
22 3851 4000
23 5865 1768
24 2655 14957
25 5565 6332
26 4303 12631
27 11653 12236
28 16025 7632
29 4655 14128
30 9584 13123
31 13987 9597
32 15409 12110
33 8754 15490
34 7416 15325
35 2909 15549

FIG.38

36 2995 8257
37 9406 4791
38 11111 4854
39 2812 8521
40 8476 14717
41 7820 15360
42 1179 7939
43 2357 8678
44 7703 6216
0 3477 7067
1 3931 13845
2 7675 12899
3 1754 8187
4 7785 1400
5 9213 5891
6 2494 7703
7 2576 7902
8 4821 15682
9 10426 11935
10 1810 904
11 11332 9264
12 11312 3570
13 14916 2650
14 7679 7842
15 6089 13084
16 3938 2751
17 8509 4648
18 12204 8917
19 5749 12443
20 12613 4431
21 1344 4014
22 8488 13850
23 1730 14896
24 14942 7126
25 14983 8863
26 6578 8564
27 4947 396
28 297 12805
29 13878 6692
30 11857 11186
31 14395 11493

# FIG.39

32 16145 12251
33 13462 7428
34 14526 13119
35 2535 11243
36 6465 12690
37 6872 9334
38 15371 14023
39 8101 10187
40 11963 4848
41 15125 6119
42 8051 14465
43 11139 5167
44 2883 14521

# FIG.40

r4/5 16K

5 896 1565
6 2493 184
7 212 3210
8 727 1339
9 3428 612
0 2663 1947
1 230 2695
2 2025 2794
3 3039 283
4 862 2889
5 376 2110
6 2034 2286
7 951 2068
8 3108 3542
9 307 1421
0 2272 1197
1 1800 3280
2 331 2308
3 465 2552
4 1038 2479
5 1383 343
6 94 236
7 2619 121
8 1497 2774
9 2116 1855
0 722 1584
1 2767 1881
2 2701 1610
3 3283 1732
4 168 1099
5 3074 243
6 3460 945
7 2049 1746
8 566 1427
9 3545 1168

PARITY CHECK MATRIX INITIAL VALUE TABLE WHERE $r=\frac{4}{5}$, N=16200

# FIG.41

PARITY CHECK MATRIX INITIAL VALUE TABLE WHERE $r=\frac{4}{5}$, N=64800

r4/5 64K

0 149 11212 5575 6360 12559 8108 8505 408 10026 12828
1 5237 490 10677 4998 3869 3734 3092 3509 7703 10305
2 8742 5553 2820 7085 12116 10485 564 7795 2972 2157
3 2699 4304 8350 712 2841 3250 4731 10105 517 7516
4 12067 1351 11992 12191 11267 5161 537 6166 4246 2363
5 6828 7107 2127 3724 5743 11040 10756 4073 1011 3422
6 11259 1216 9526 1466 10816 940 3744 2815 11506 11573
7 4549 11507 1118 1274 11751 5207 7854 12803 4047 6484
8 8430 4115 9440 413 4455 2262 7915 12402 8579 7052
9 3885 9126 5665 4505 2343 253 4707 3742 4166 1556
10 1704 8936 6775 8639 8179 7954 8234 7850 8883 8713
11 11716 4344 9087 11264 2274 8832 9147 11930 6054 5455
12 7323 3970 10329 2170 8262 3854 2087 12899 9497 11700
13 4418 1467 2490 5841 817 11453 533 11217 11962 5251
14 1541 4525 7976 3457 9536 7725 3788 2982 6307 5997
15 11484 2739 4023 12107 6516 551 2572 6628 8150 9852
16 6070 1761 4627 6534 7913 3730 11866 1813 12306 8249
17 12441 5489 8748 7837 7660 2102 11341 2936 6712 11977
18 10155 4210
19 1010 10483
20 8900 10250
21 10243 12278
22 7070 4397
23 12271 3887
24 11980 6836
25 9514 4356
26 7137 10281
27 11881 2526
28 1969 11477
29 3044 10921
30 2236 8724
31 9104 6340
32 7342 8582
33 11675 10405
34 6467 12775
35 3186 12198
0 9621 11445
1 7486 5611
2 4319 4879
3 2196 344

# FIG.42

4 7527 6650
5 10693 2440
6 6755 2706
7 5144 5998
8 11043 8033
9 4846 4435
10 4157 9228
11 12270 6562
12 11954 7592
13 7420 2592
14 8810 9636
15 689 5430
16 920 1304
17 1253 11934
18 9559 6016
19 312 7589
20 4439 4197
21 4002 9555
22 12232 7779
23 1494 8782
24 10749 3969
25 4368 3479
26 6316 5342
27 2455 3493
28 12157 7405
29 6598 11495
30 11805 4455
31 9625 2090
32 4731 2321
33 3578 2608
34 8504 1849
35 4027 1151
0 5647 4935
1 4219 1870
2 10968 8054
3 6970 5447
4 3217 5638
5 8972 669
6 5618 12472
7 1457 1280
8 8868 3883

# FIG.43

9 8866 1224
10 8371 5972
11 266 4405
12 3706 3244
13 6039 5844
14 7200 3283
15 1502 11282
16 12318 2202
17 4523 965
18 9587 7011
19 2552 2051
20 12045 10306
21 11070 5104
22 6627 6906
23 9889 2121
24 829 9701
25 2201 1819
26 6689 12925
27 2139 8757
28 12004 5948
29 8704 3191
30 8171 10933
31 6297 7116
32 616 7146
33 5142 9761
34 10377 8138
35 7616 5811
0 7285 9863
1 7764 10867
2 12343 9019
3 4414 8331
4 3464 642
5 6960 2039
6 786 3021
7 710 2086
8 7423 5601
9 8120 4885
10 12385 11990
11 9739 10034
12 424 10162
13 1347 7597

# FIG.44

14 1450 112
15 7965 8478
16 8945 7397
17 6590 8316
18 6838 9011
19 6174 9410
20 255 113
21 6197 5835
22 12902 3844
23 4377 3505
24 5478 8672
25 4453 2132
26 9724 1380
27 12131 11526
28 12323 9511
29 8231 1752
30 497 9022
31 9288 3080
32 2481 7515
33 2696 268
34 4023 12341
35 7108 5553

# FIG.45

r5/6 16K

3 2409 499 1481 908 559 716 1270 333 2508 2264 1702 2805
4 2447 1926
5 414 1224
6 2114 842
7 212 573
0 2383 2112
1 2286 2348
2 545 819
3 1264 143
4 1701 2258
5 964 166
6 114 2413
7 2243 81
0 1245 1581
1 775 169
2 1696 1104
3 1914 2831
4 532 1450
5 91 974
6 497 2228
7 2326 1579
0 2482 256
1 1117 1261
2 1257 1658
3 1478 1225
4 2511 980
5 2320 2675
6 435 1278
7 228 503
0 1885 2369
1 57 483
2 838 1050
3 1231 1990
4 1738 68
5 2392 951
6 163 645
7 2644 1704

PARITY CHECK MATRIX INITIAL VALUE TABLE WHERE $r=\frac{5}{6}$, N=16200

# FIG.46

PARITY CHECK MATRIX INITIAL VALUE TABLE WHERE $r=\frac{5}{6}$, N=64800

r5/6 64K

0 4362 416 8909 4156 3216 3112 2560 2912 6405 8593 4969 6723
1 2479 1786 8978 3011 4339 9313 6397 2957 7288 5484 6031 10217
2 10175 9009 9889 3091 4985 7267 4092 8874 5671 2777 2189 8716
3 9052 4795 3924 3370 10058 1128 9996 10165 9360 4297 434 5138
4 2379 7834 4835 2327 9843 804 329 8353 7167 3070 1528 7311
5 3435 7871 348 3693 1876 6585 10340 7144 5870 2084 4052 2780
6 3917 3111 3476 1304 10331 5939 5199 1611 1991 699 8316 9960
7 6883 3237 1717 10752 7891 9764 4745 3888 10009 4176 4614 1567
8 10587 2195 1689 2968 5420 2580 2883 6496 111 6023 1024 4449
9 3786 8593 2074 3321 5057 1450 3840 5444 6572 3094 9892 1512
10 8548 1848 10372 4585 7313 6536 6379 1766 9462 2456 5606 9975
11 8204 10593 7935 3636 3882 394 5968 8561 2395 7289 9267 9978
12 7795 74 1633 9542 6867 7352 6417 7568 10623 725 2531 9115
13 7151 2482 4260 5003 10105 7419 9203 6691 8798 2092 8263 3755
14 3600 570 4527 200 9718 6771 1995 8902 5446 768 1103 6520
15 6304 7621
16 6498 9209
17 7293 6786
18 5950 1708
19 8521 1793
20 6174 7854
21 9773 1190
22 9517 10268
23 2181 9349
24 1949 5560
25 1556 555
26 8600 3827
27 5072 1057
28 7928 3542
29 3226 3762
0 7045 2420
1 9645 2641
2 2774 2452
3 5331 2031
4 9400 7503
5 1850 2338
6 10456 9774
7 1692 9276
8 10037 4038
9 3964 338

FIG.47

10 2640 5087
11 858 3473
12 5582 5683
13 9523 916
14 4107 1559
15 4506 3491
16 8191 4182
17 10192 6157
18 5668 3305
19 3449 1540
20 4766 2697
21 4069 6675
22 1117 1016
23 5619 3085
24 8483 8400
25 8255 394
26 6338 5042
27 6174 5119
28 7203 1989
29 1781 5174
0 1464 3559
1 3376 4214
2 7238 67
3 10595 8831
4 1221 6513
5 5300 4652
6 1429 9749
7 7878 5131
8 4435 10284
9 6331 5507
10 6662 4941
11 9614 10238
12 8400 8025
13 9156 5630
14 7067 8878
15 9027 3415
16 1690 3866
17 2854 8469
18 6206 630
19 363 5453
20 4125 7008

# FIG.48

21 1612 6702
22 9069 9226
23 5767 4060
24 3743 9237
25 7018 5572
26 8892 4536
27 853 6064
28 8069 5893
29 2051 2885
0 10691 3153
1 3602 4055
2 328 1717
3 2219 9299
4 1939 7898
5 617 206
6 8544 1374
7 10676 3240
8 6672 9489
9 3170 7457
10 7868 5731
11 6121 10732
12 4843 9132
13 580 9591
14 6267 9290
15 3009 2268
16 195 2419
17 8016 1557
18 1516 9195
19 8062 9064
20 2095 8968
21 753 7326
22 6291 3833
23 2614 7844
24 2303 646
25 2075 611
26 4687 362
27 8684 9940
28 4830 2065
29 7038 1363
0 1769 7837
1 3801 1689

FIG.49

2 10070 2359
3 3667 9918
4 1914 6920
5 4244 5669
6 10245 7821
7 7648 3944
8 3310 5488
9 6346 9666
10 7088 6122
11 1291 7827
12 10592 8945
13 3609 7120
14 9168 9112
15 6203 8052
16 3330 2895
17 4264 10563
18 10556 6496
19 8807 7645
20 1999 4530
21 9202 6818
22 3403 1734
23 2106 9023
24 6881 3883
25 3895 2171
26 4062 6424
27 3755 9536
28 4683 2131
29 7347 8027

# FIG.50

PARITY CHECK MATRIX INITIAL VALUE TABLE WHERE $r=\frac{8}{9}$, N=16200

r8/9 16K

0 1558 712 805
1 1450 873 1337
2 1741 1129 1184
3 294 806 1566
4 482 605 923
0 926 1578
1 777 1374
2 608 151
3 1195 210
4 1484 692
0 427 488
1 828 1124
2 874 1366
3 1500 835
4 1496 502
0 1006 1701
1 1155 97
2 657 1403
3 1453 624
4 429 1495
0 809 385
1 367 151
2 1323 202
3 960 318
4 1451 1039
0 1098 1722
1 1015 1428
2 1261 1564
3 544 1190
4 1472 1246
0 508 630
1 421 1704
2 284 898
3 392 577
4 1155 556
0 631 1000
1 732 1368
2 1328 329
3 1515 506
4 1104 1172

# FIG.51

PARITY CHECK MATRIX INITIAL VALUE TABLE WHERE $r=\frac{8}{9}$, N=64800

r8/9 64K

0 6235 2848 3222
1 5800 3492 5348
2 2757 927 90
3 6961 4516 4739
4 1172 3237 6264
5 1927 2425 3683
6 3714 6309 2495
7 3070 6342 7154
8 2428 613 3761
9 2906 264 5927
10 1716 1950 4273
11 4613 6179 3491
12 4865 3286 6005
13 1343 5923 3529
14 4589 4035 2132
15 1579 3920 6737
16 1644 1191 5998
17 1482 2381 4620
18 6791 6014 6596
19 2738 5918 3786
0 5156 6166
1 1504 4356
2 130 1904
3 6027 3187
4 6718 759
5 6240 2870
6 2343 1311
7 1039 5465
8 6617 2513
9 1588 5222
10 6561 535
11 4765 2054
12 5966 6892
13 1969 3869
14 3571 2420
15 4632 981
16 3215 4163
17 973 3117
18 3802 6198
19 3794 3948

FIG.52

0 3196 6126
1 573 1909
2 850 4034
3 5622 1601
4 6005 524
5 5251 5783
6 172 2032
7 1875 2475
8 497 1291
9 2566 3430
10 1249 740
11 2944 1948
12 6528 2899
13 2243 3616
14 867 3733
15 1374 4702
16 4698 2285
17 4760 3917
18 1859 4058
19 6141 3527
0 2148 5066
1 1306 145
2 2319 871
3 3463 1061
4 5554 6647
5 5837 339
6 5821 4932
7 6356 4756
8 3930 418
9 211 3094
10 1007 4928
11 3584 1235
12 6982 2869
13 1612 1013
14 953 4964
15 4555 4410
16 4925 4842
17 5778 600
18 6509 2417
19 1260 4903
0 3369 3031

FIG.53

1 3557 3224
2 3028 583
3 3258 440
4 6226 6655
5 4895 1094
6 1481 6847
7 4433 1932
8 2107 1649
9 2119 2065
10 4003 6388
11 6720 3622
12 3694 4521
13 1164 7050
14 1965 3613
15 4331 66
16 2970 1796
17 4652 3218
18 1762 4777
19 5736 1399
0 970 2572
1 2062 6599
2 4597 4870
3 1228 6913
4 4159 1037
5 2916 2362
6 395 1226
7 6911 4548
8 4618 2241
9 4120 4280
10 5825 474
11 2154 5558
12 3793 5471
13 5707 1595
14 1403 325
15 6601 5183
16 6369 4569
17 4846 896
18 7092 6184
19 6764 7127
0 6358 1951
1 3117 6960

# FIG.54

2 2710 7062
3 1133 3604
4 3694 657
5 1355 110
6 3329 6736
7 2505 3407
8 2462 4806
9 4216 214
10 5348 5619
11 6627 6243
12 2644 5073
13 4212 5088
14 3463 3889
15 5306 478
16 4320 6121
17 3961 1125
18 5699 1195
19 6511 792
0 3934 2778
1 3238 6587
2 1111 6596
3 1457 6226
4 1446 3885
5 3907 4043
6 6839 2873
7 1733 5615
8 5202 4269
9 3024 4722
10 5445 6372
11 370 1828
12 4695 1600
13 680 2074
14 1801 6690
15 2669 1377
16 2463 1681
17 5972 5171
18 5728 4284
19 1696 1459

# FIG.55

PARITY CHECK MATRIX INITIAL VALUE TABLE WHERE $r=\frac{9}{10}$, N=64800

r9/10 64K

0 5611 2563 2900
1 5220 3143 4813
2 2481 834 81
3 6265 4064 4265
4 1055 2914 5638
5 1734 2182 3315
6 3342 5678 2246
7 2185 552 3385
8 2615 236 5334
9 1546 1755 3846
10 4154 5561 3142
11 4382 2957 5400
12 1209 5329 3179
13 1421 3528 6063
14 1480 1072 5398
15 3843 1777 4369
16 1334 2145 4163
17 2368 5055 260
0 6118 5405
1 2994 4370
2 3405 1669
3 4640 5550
4 1354 3921
5 117 1713
6 5425 2866
7 6047 683
8 5616 2582
9 2108 1179
10 933 4921
11 5953 2261
12 1430 4699
13 5905 480
14 4289 1846
15 5374 6208
16 1775 3476
17 3216 2178
0 4165 884
1 2896 3744
2 874 2801
3 3423 5579

# FIG.56

4 3404 3552
5 2876 5515
6 516 1719
7 765 3631
8 5059 1441
9 5629 598
10 5405 473
11 4724 5210
12 155 1832
13 1689 2229
14 449 1164
15 2308 3088
16 1122 669
17 2268 5758
0 5878 2609
1 782 3359
2 1231 4231
3 4225 2052
4 4286 3517
5 5531 3184
6 1935 4560
7 1174 131
8 3115 956
9 3129 1088
10 5238 4440
11 5722 4280
12 3540 375
13 191 2782
14 906 4432
15 3225 1111
16 6296 2583
17 1457 903
0 855 4475
1 4097 3970
2 4433 4361
3 5198 541
4 1146 4426
5 3202 2902
6 2724 525
7 1083 4124
8 2326 6003

# FIG.57

9 5605 5990
10 4376 1579
11 4407 984
12 1332 6163
13 5359 3975
14 1907 1854
15 3601 5748
16 6056 3266
17 3322 4085
0 1768 3244
1 2149 144
2 1589 4291
3 5154 1252
4 1855 5939
5 4820 2706
6 1475 3360
7 4266 693
8 4156 2018
9 2103 752
10 3710 3853
11 5123 931
12 6146 3323
13 1939 5002
14 5140 1437
15 1263 293
16 5949 4665
17 4548 6380
0 3171 4690
1 5204 2114
2 6384 5565
3 5722 1757
4 2805 6264
5 1202 2616
6 1018 3244
7 4018 5289
8 2257 3067
9 2483 3073
10 1196 5329
11 649 3918
12 3791 4581
13 5028 3803

# FIG.58

14 3119 3506
15 4779 431
16 3888 5510
17 4387 4084
0 5836 1692
1 5126 1078
2 5721 6165
3 3540 2499
4 2225 6348
5 1044 1484
6 6323 4042
7 1313 5603
8 1303 3496
9 3516 3639
10 5161 2293
11 4682 3845
12 3045 643
13 2818 2616
14 3267 649
15 6236 593
16 646 2948
17 4213 1442
0 5779 1596
1 2403 1237
2 2217 1514
3 5609 716
4 5155 3858
5 1517 1312
6 2554 3158
7 5280 2643
8 4990 1353
9 5648 1170
10 1152 4366
11 3561 5368
12 3581 1411
13 5647 4661
14 1542 5401
15 5078 2687
16 316 1755
17 3392 1991

# FIG.59

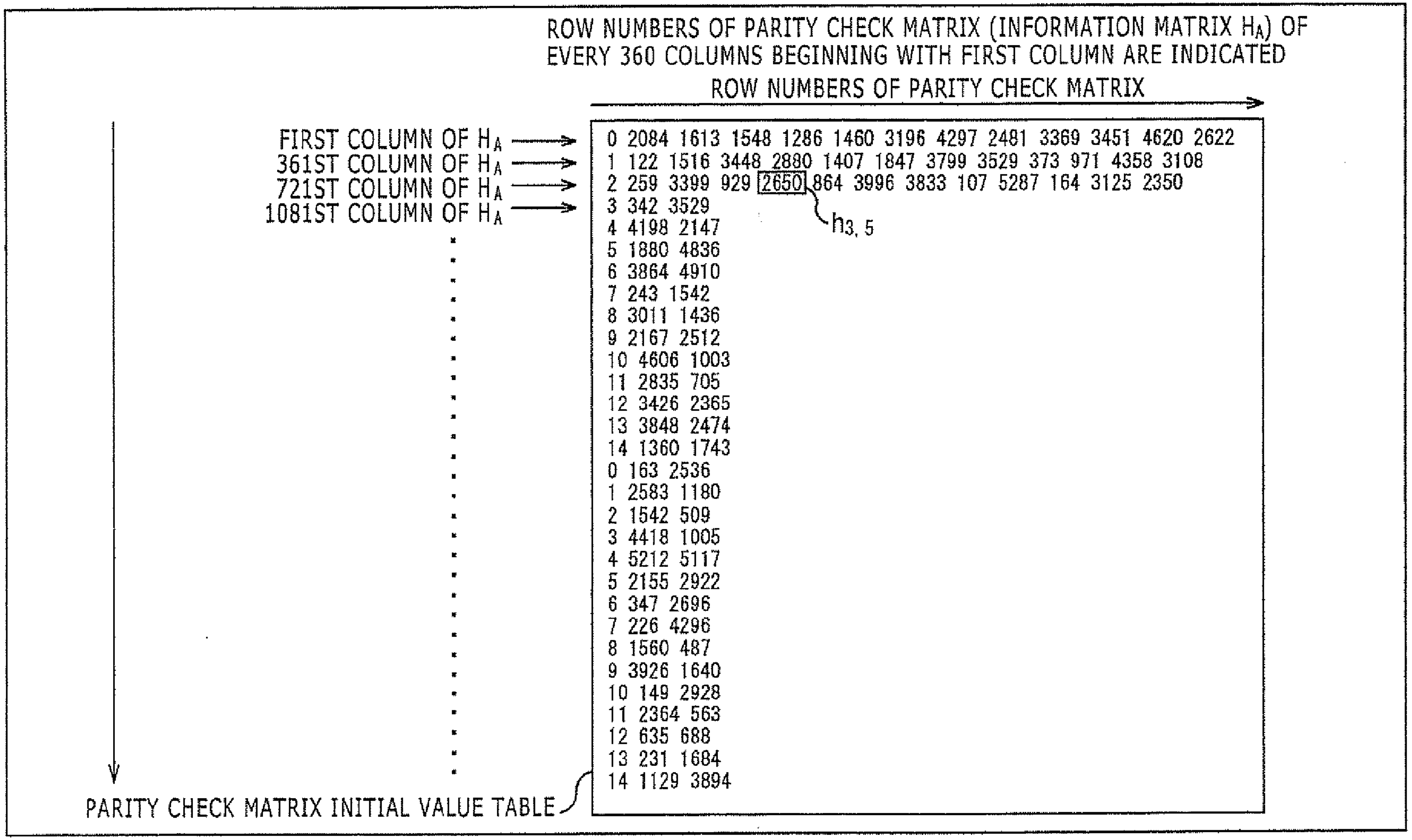
ROW NUMBERS OF PARITY CHECK MATRIX (INFORMATION MATRIX $H_A$) OF EVERY 360 COLUMNS BEGINNING WITH FIRST COLUMN ARE INDICATED
ROW NUMBERS OF PARITY CHECK MATRIX
FIRST COLUMN OF $H_A$
361ST COLUMN OF $H_A$
721ST COLUMN OF $H_A$
1081ST COLUMN OF $H_A$
0 2084 1613 1548 1286 1460 3196 4297 2481 3369 3451 4620 2622
1 122 1516 3448 2880 1407 1847 3799 3529 373 971 4358 3108
2 259 3399 929 2650 864 3996 3833 107 5287 164 3125 2350
3 342 3529
4 4198 2147
5 1880 4836
6 3864 4910
7 243 1542
8 3011 1436
9 2167 2512
10 4606 1003
11 2835 705
12 3426 2365
13 3848 2474
14 1360 1743
0 163 2536
1 2583 1180
2 1542 509
3 4418 1005
4 5212 5117
5 2155 2922
6 347 2696
7 226 4296
8 1560 487
9 3926 1640
10 149 2928
11 2364 563
12 635 688
13 231 1684
14 1129 3894
$h_{3,5}$
PARITY CHECK MATRIX INITIAL VALUE TABLE

# FIG.60

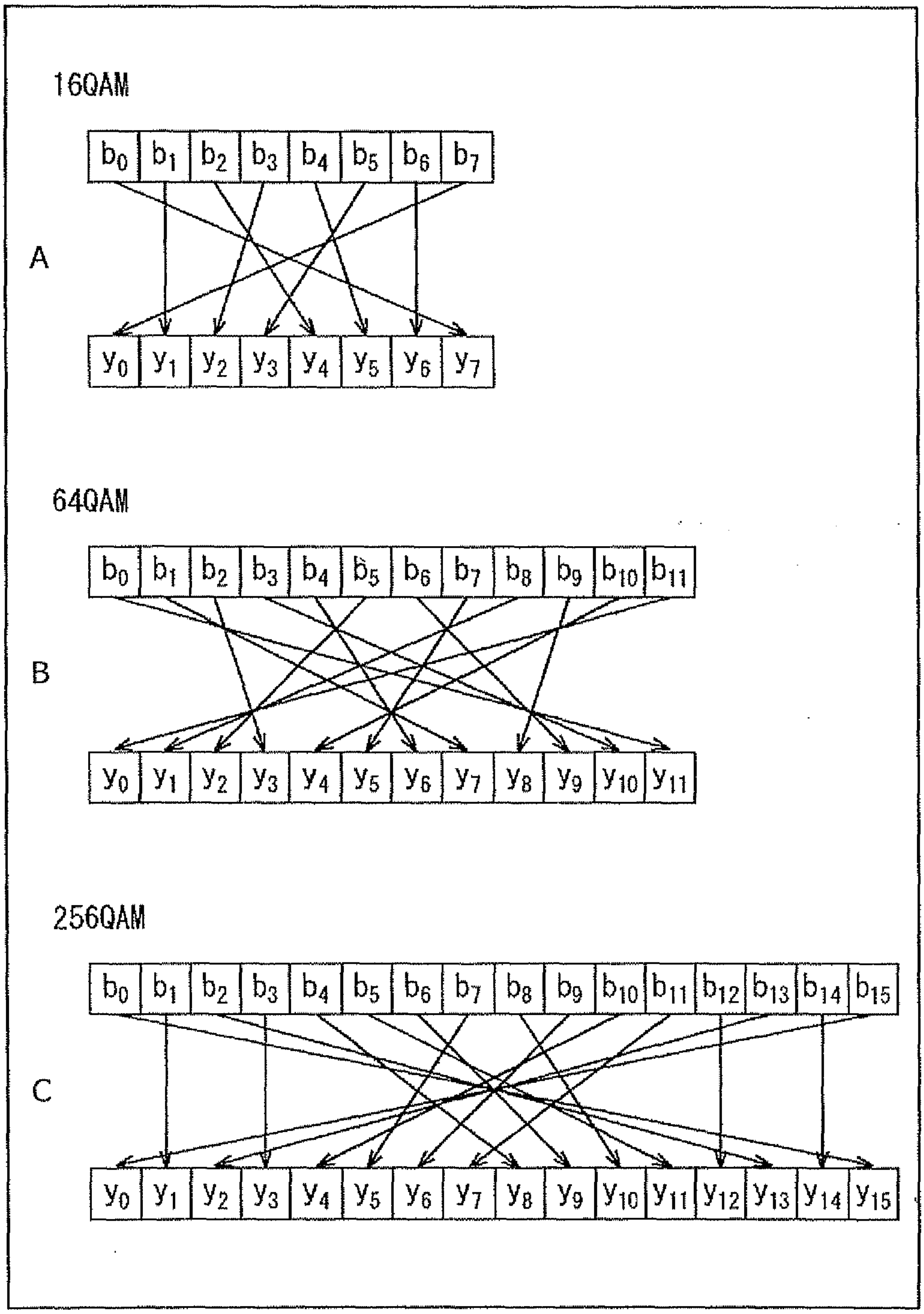

# FIG.61

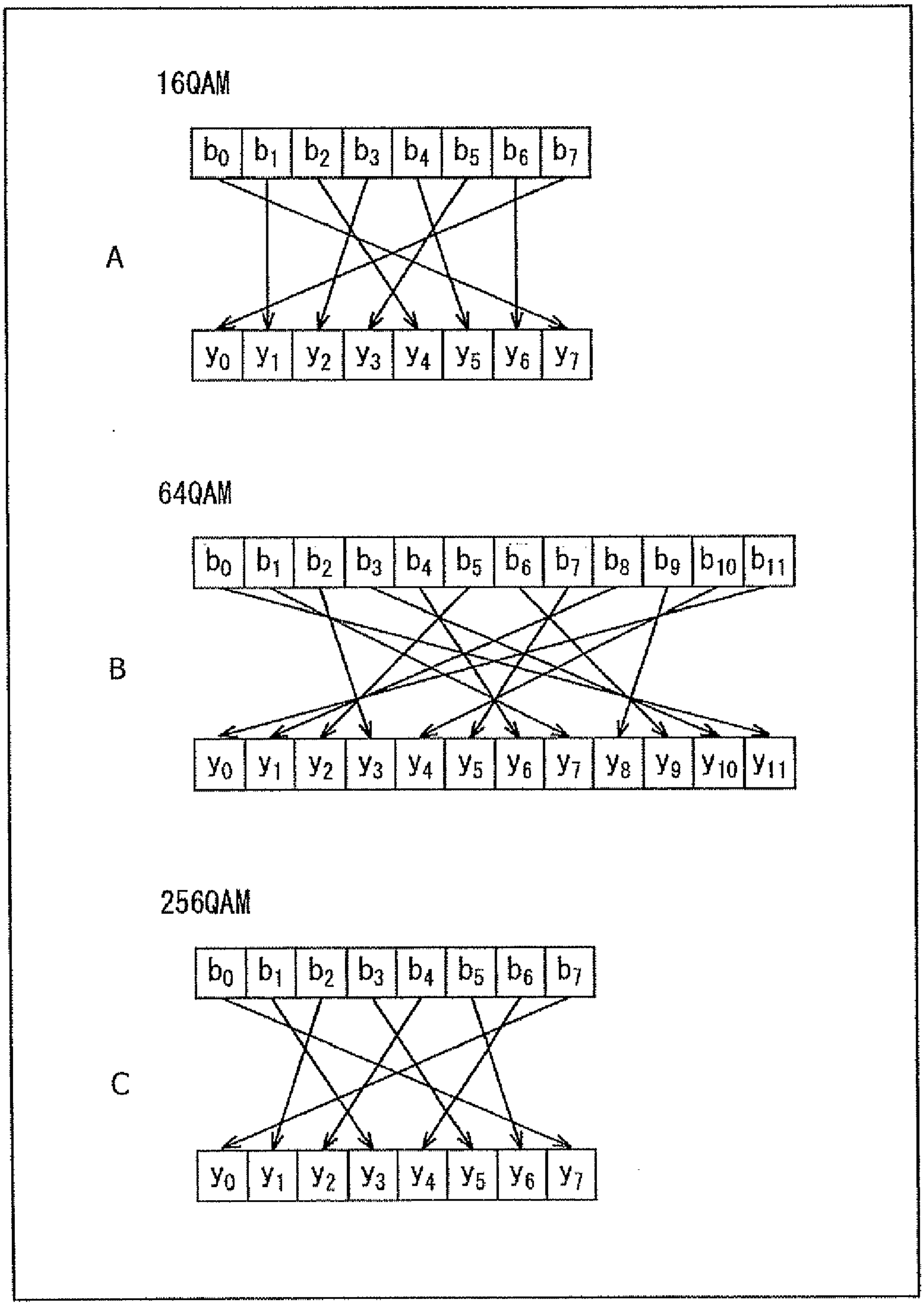
16QAM
A
b0 b1 b2 b3 b4 b5 b6 b7
y0 y1 y2 y3 y4 y5 y6 y7
64QAM
B
b0 b1 b2 b3 b4 b5 b6 b7 b8 b9 b10 b11
y0 y1 y2 y3 y4 y5 y6 y7 y8 y9 y10 y11
256QAM
C
b0 b1 b2 b3 b4 b5 b6 b7
y0 y1 y2 y3 y4 y5 y6 y7

FIG.62

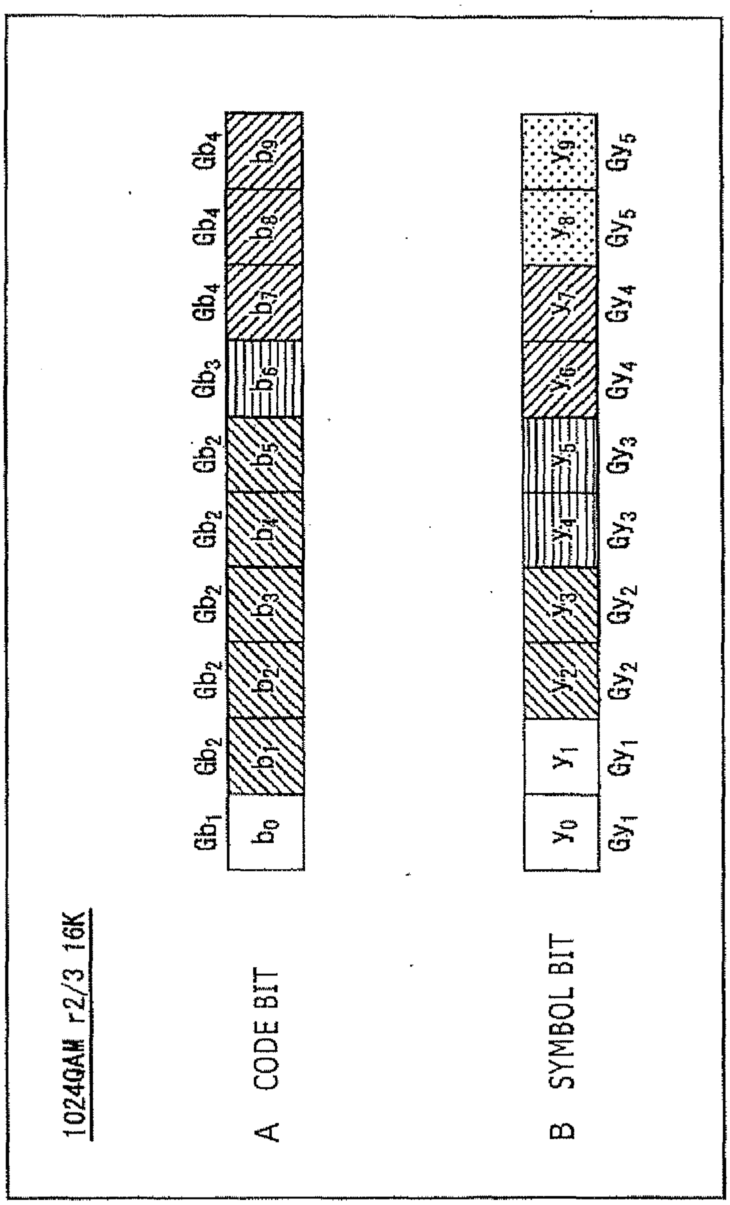
1024QAM r2/3 16K
A CODE BIT
Gb1 Gb2 Gb2 Gb2 Gb2 Gb2 Gb3 Gb4 Gb4 Gb4
b0 b1 b2 b3 b4 b5 b6 b7 b8 b9
B SYMBOL BIT
y0 y1 y2 y3 y4 y5 y6 y7 y8 y9
Gy1 Gy1 Gy2 Gy2 Gy3 Gy3 Gy4 Gy4 Gy5 Gy5

FIG.63

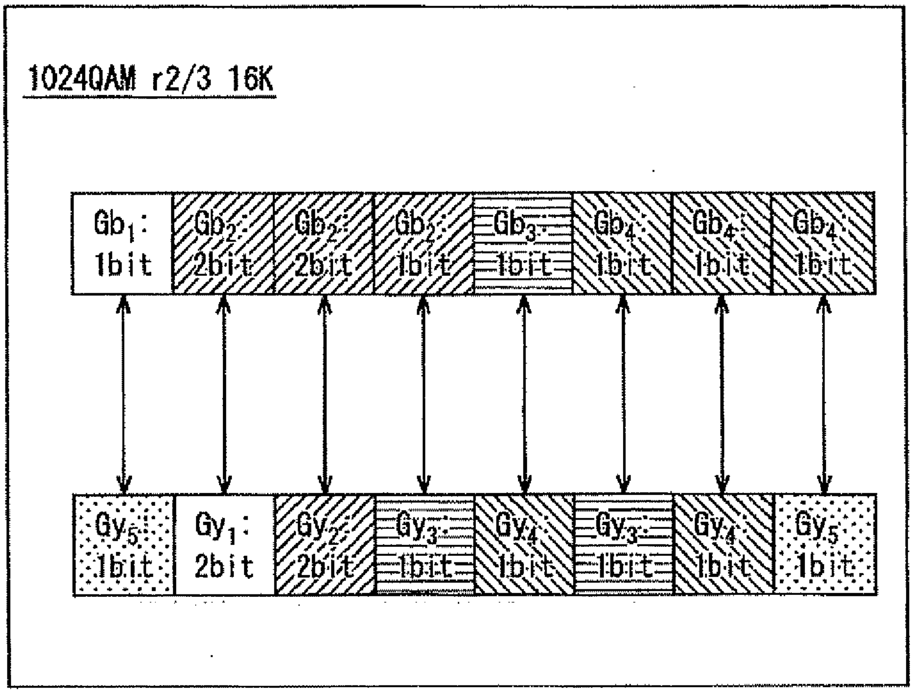
1024QAM r2/3 16K
Gb1: 1bit
Gb2: 2bit
Gb2: 2bit
Gb2: 1bit
Gb3: 1bit
Gb4: 1bit
Gb4: 1bit
Gb4: 1bit
Gy5: 1bit
Gy1: 2bit
Gy2: 2bit
Gy3: 1bit
Gy4: 1bit
Gy3: 1bit
Gy4: 1bit
Gy5: 1bit

# FIG.64

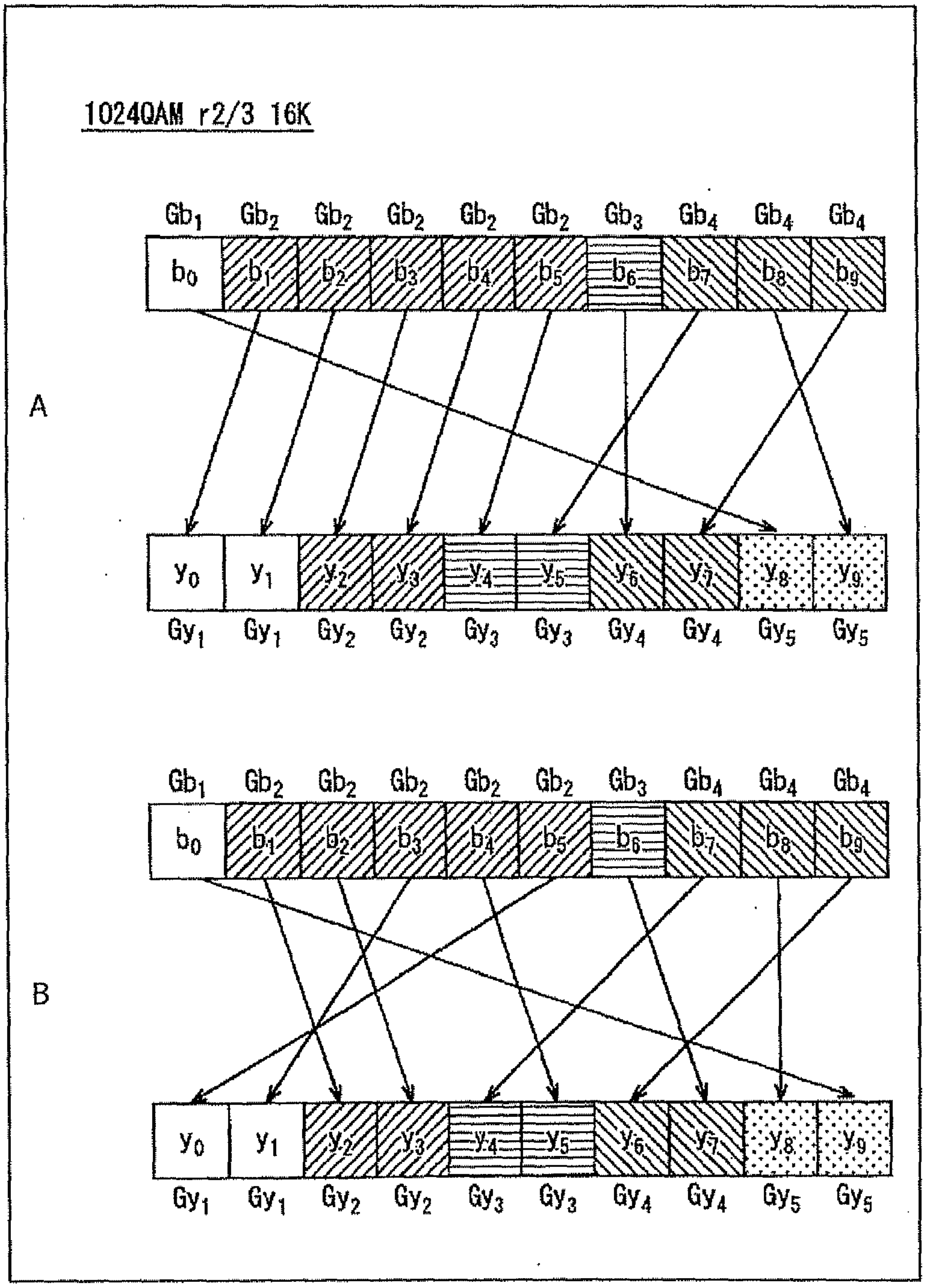

1024QAM r2/3 16K
A
Gb1 Gb2 Gb2 Gb2 Gb2 Gb2 Gb3 Gb4 Gb4 Gb4
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5
B
Gb1 Gb2 Gb2 Gb2 Gb2 Gb2 Gb3 Gb4 Gb4 Gb4
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5

FIG. 65

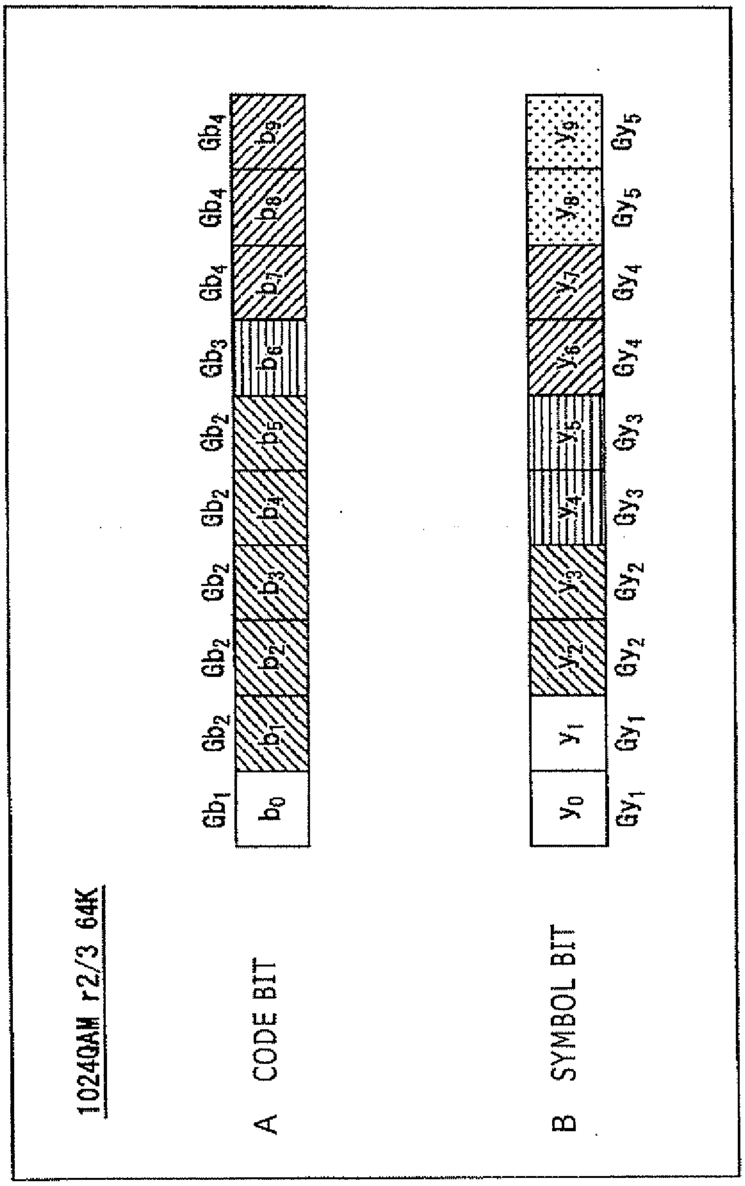
1024QAM r2/3 64K
A CODE BIT
Gb1 Gb2 Gb2 Gb2 Gb2 Gb2 Gb3 Gb4 Gb4 Gb4
b0 b1 b2 b3 b4 b5 b6 b7 b8 b9
B SYMBOL BIT
y0 y1 y2 y3 y4 y5 y6 y7 y8 y9
Gy1 Gy1 Gy2 Gy2 Gy3 Gy3 Gy4 Gy4 Gy5 Gy5

FIG.66

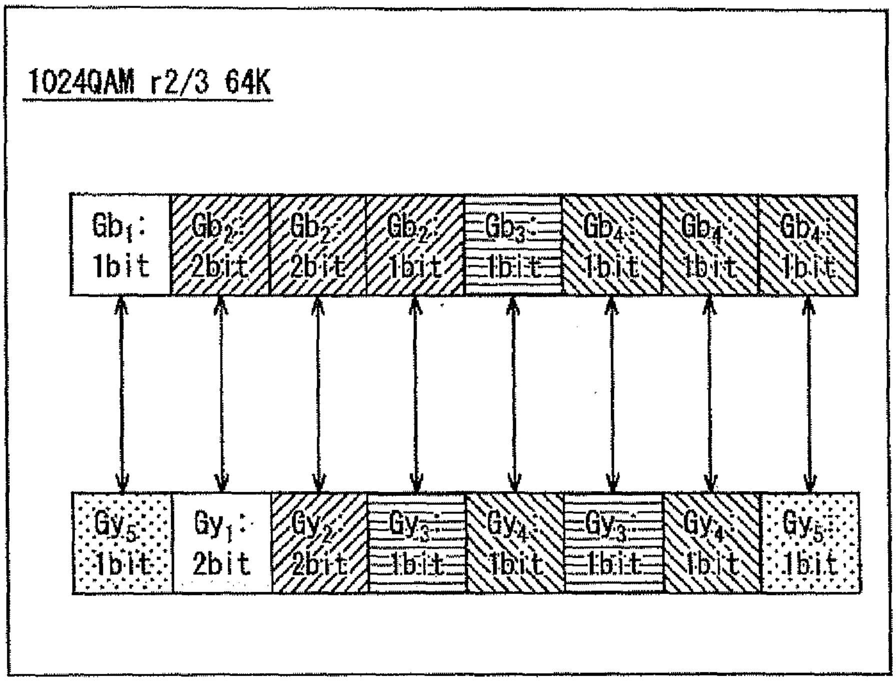
1024QAM r2/3 64K
Gb1: 1bit
Gb2: 2bit
Gb2: 2bit
Gb2: 1bit
Gb3: 1bit
Gb4: 1bit
Gb4: 1bit
Gb4: 1bit
Gy5: 1bit
Gy1: 2bit
Gy2: 2bit
Gy3: 1bit
Gy4: 1bit
Gy3: 1bit
Gy4: 1bit
Gy5: 1bit

FIG.67

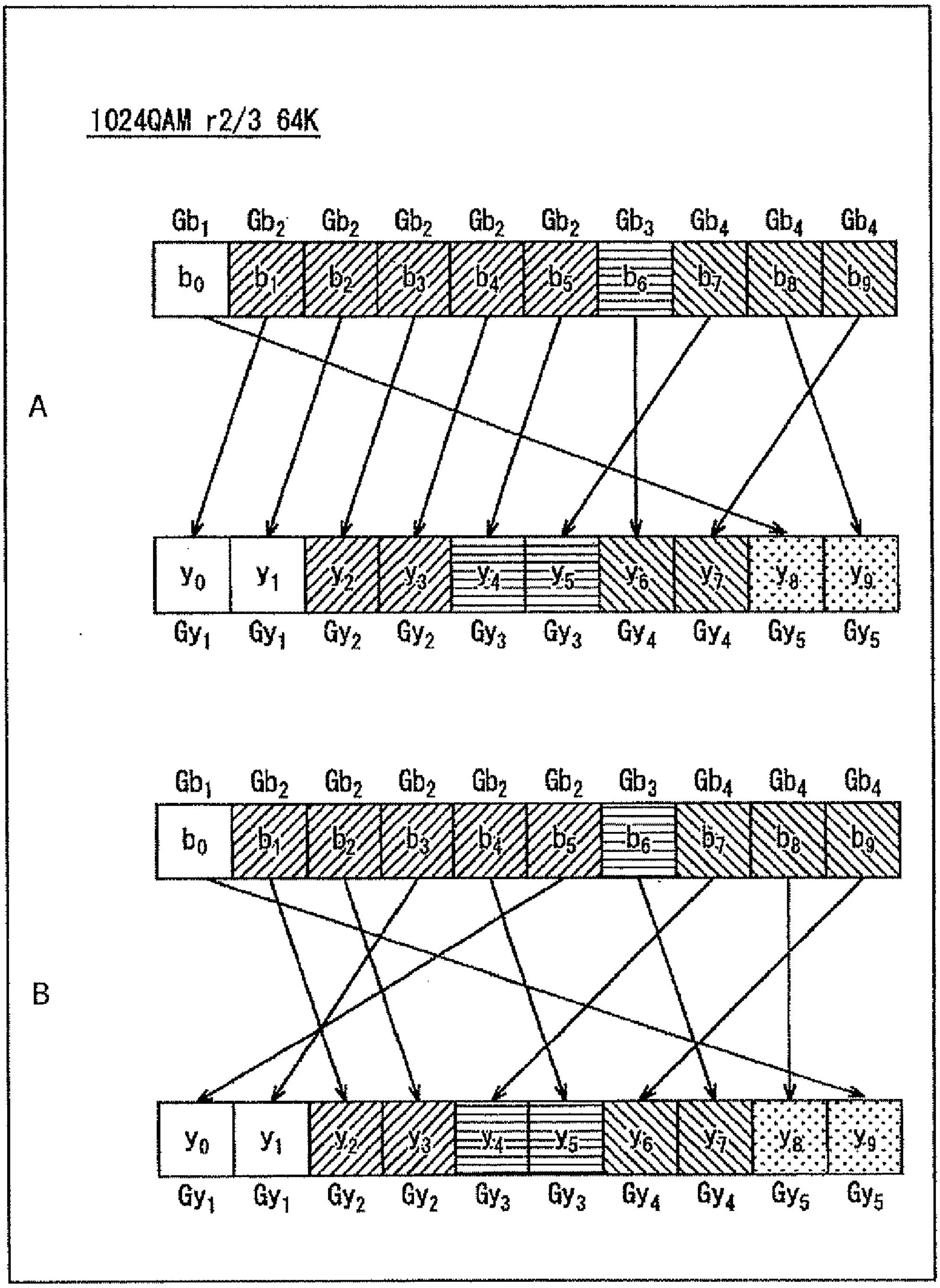
1024QAM r2/3 64K
A
Gb1 Gb2 Gb2 Gb2 Gb2 Gb2 Gb3 Gb4 Gb4 Gb4
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5
B
Gb1 Gb2 Gb2 Gb2 Gb2 Gb2 Gb3 Gb4 Gb4 Gb4
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5

FIG.68

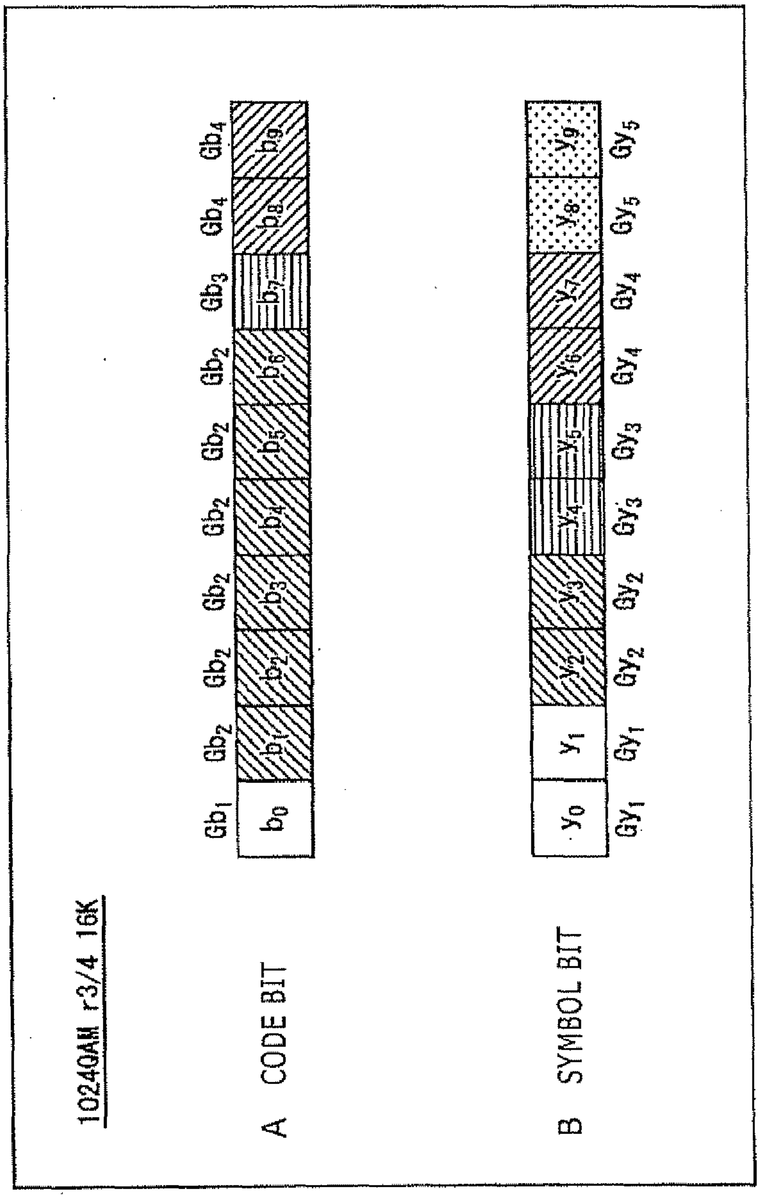
1024QAM r3/4 16K
A CODE BIT
Gb1 Gb2 Gb2 Gb2 Gb2 Gb2 Gb2 Gb3 Gb4 Gb4
b0 b1 b2 b3 b4 b5 b6 b7 b8 b9
B SYMBOL BIT
y0 y1 y2 y3 y4 y5 y6 y7 y8 y9
Gy1 Gy1 Gy2 Gy2 Gy3 Gy3 Gy4 Gy4 Gy5 Gy5

FIG.69

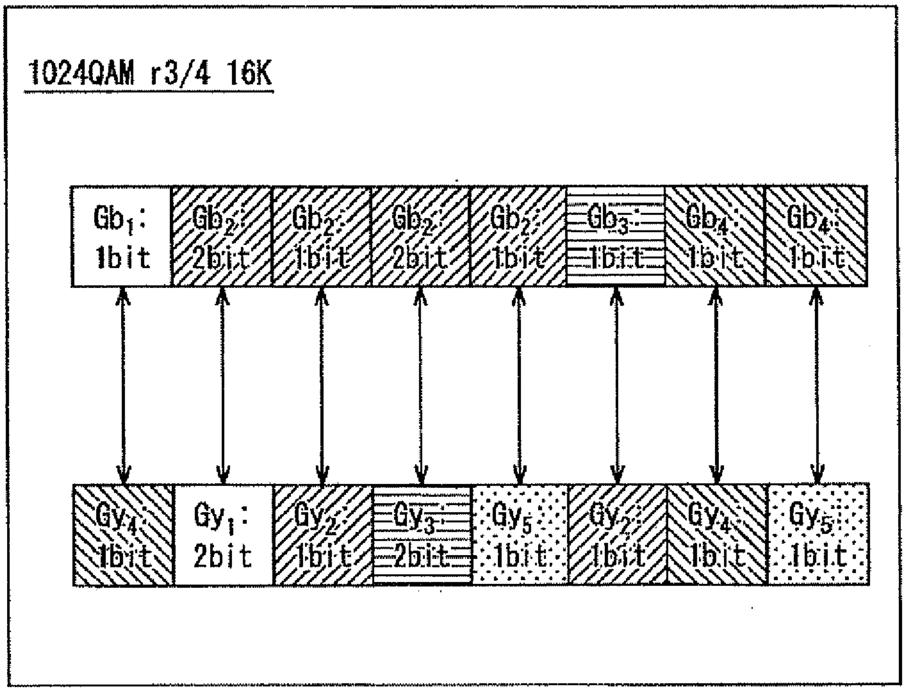
1024QAM r3/4 16K
Gb1: 1bit
Gb2: 2bit
Gb2: 1bit
Gb2: 2bit
Gb2: 1bit
Gb3: 1bit
Gb4: 1bit
Gb4: 1bit
Gy4: 1bit
Gy1: 2bit
Gy2: 1bit
Gy3: 2bit
Gy5: 1bit
Gy2: 1bit
Gy4: 1bit
Gy5: 1bit

# FIG.70

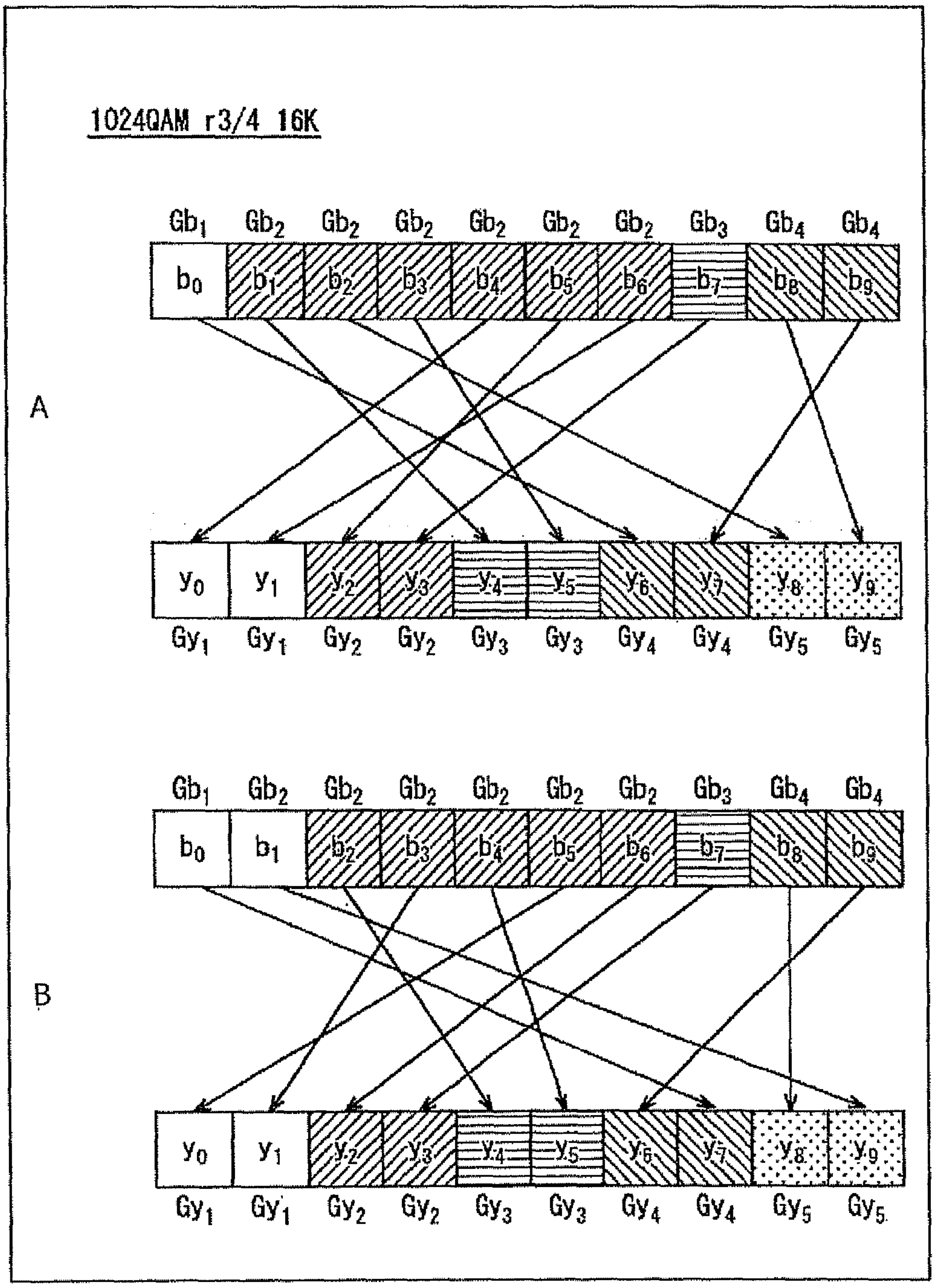
1024QAM r3/4 16K
A
Gb1 Gb2 Gb2 Gb2 Gb2 Gb2 Gb2 Gb3 Gb4 Gb4
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5
B
Gb1 Gb2 Gb2 Gb2 Gb2 Gb2 Gb2 Gb3 Gb4 Gb4
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5

FIG.71

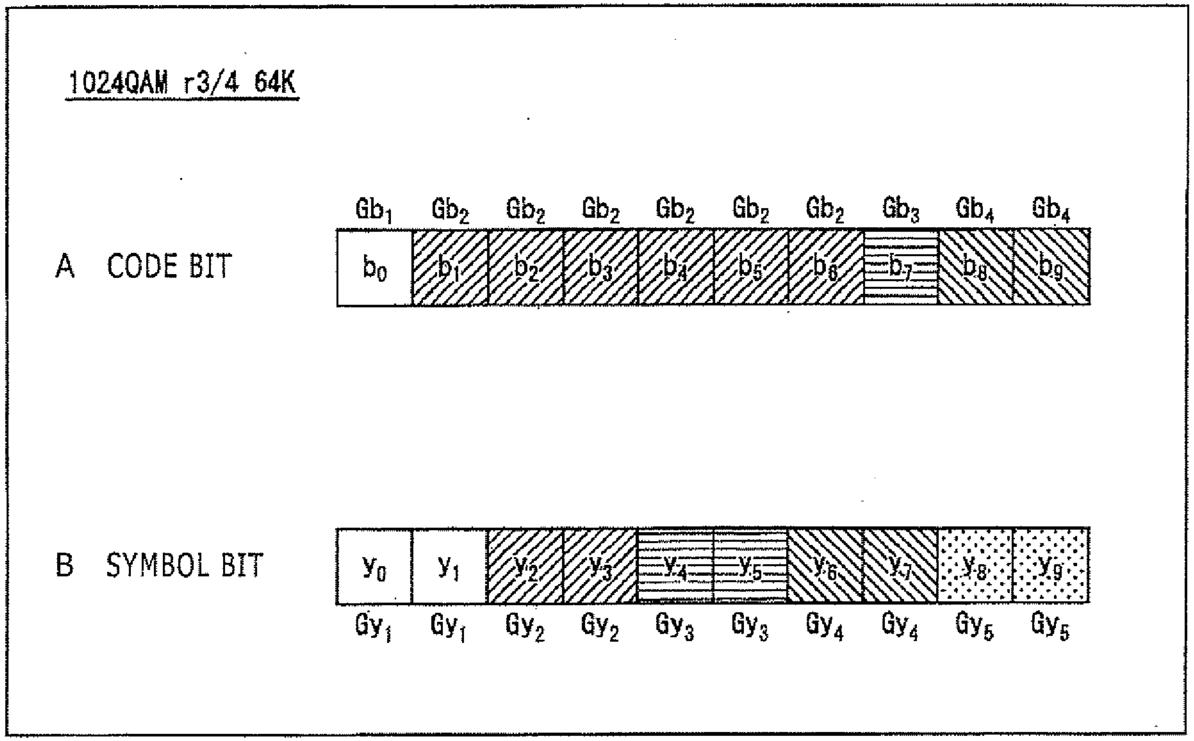
1024QAM r3/4 64K
A CODE BIT
Gb1 Gb2 Gb2 Gb2 Gb2 Gb2 Gb2 Gb3 Gb4 Gb4
b0 b1 b2 b3 b4 b5 b6 b7 b8 b9
B SYMBOL BIT
y0 y1 y2 y3 y4 y5 y6 y7 y8 y9
Gy1 Gy1 Gy2 Gy2 Gy3 Gy3 Gy4 Gy4 Gy5 Gy5

FIG.72

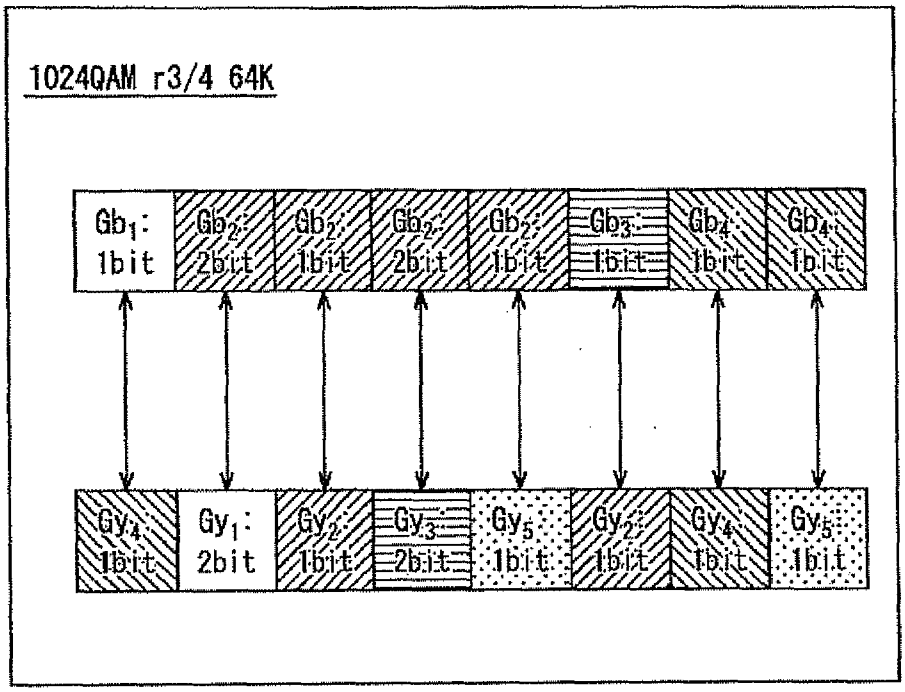
1024QAM r3/4 64K
Gb1: 1bit
Gb2: 2bit
Gb2: 1bit
Gb2: 2bit
Gb2: 1bit
Gb3: 1bit
Gb4: 1bit
Gb4: 1bit
Gy4: 1bit
Gy1: 2bit
Gy2: 1bit
Gy3: 2bit
Gy5: 1bit
Gy2: 1bit
Gy4: 1bit
Gy5: 1bit

# FIG.73

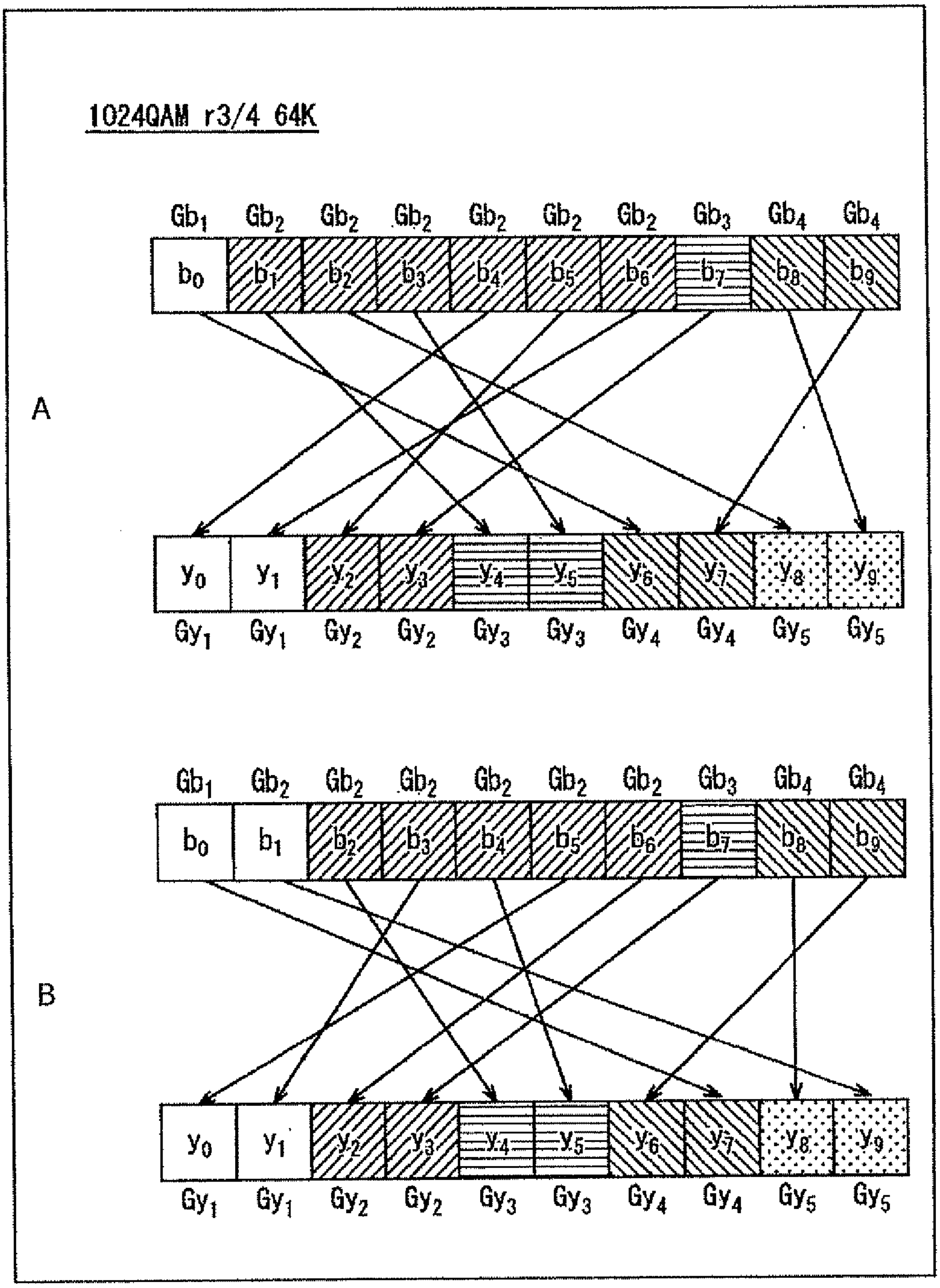
1024QAM r3/4 64K
A
Gb1 Gb2 Gb2 Gb2 Gb2 Gb2 Gb2 Gb3 Gb4 Gb4
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5
B
Gb1 Gb2 Gb2 Gb2 Gb2 Gb2 Gb2 Gb3 Gb4 Gb4
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5

FIG.74

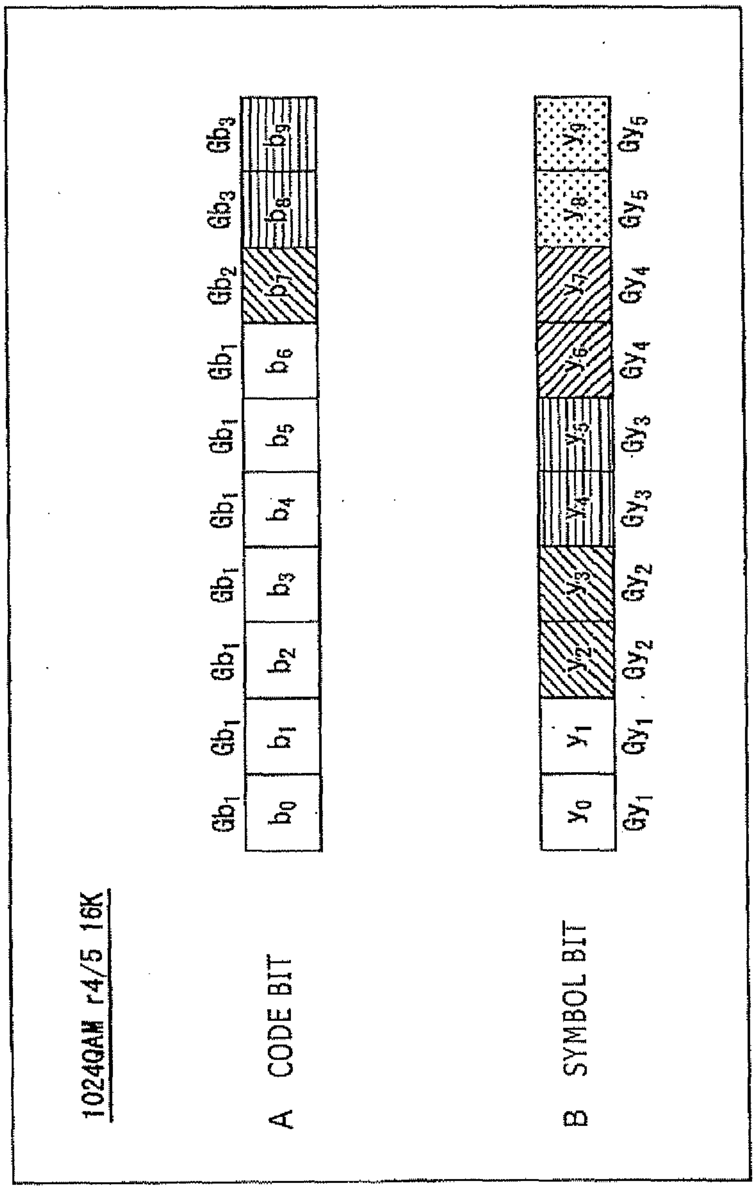
1024QAM r4/5 16K
A CODE BIT
Gb1 Gb1 Gb1 Gb1 Gb1 Gb1 Gb1 Gb2 Gb3 Gb3
b0 b1 b2 b3 b4 b5 b6 b7 b8 b9
B SYMBOL BIT
y0 y1 y2 y3 y4 y5 y6 y7 y8 y9
Gy1 Gy1 Gy2 Gy2 Gy3 Gy3 Gy4 Gy4 Gy5 Gy5

# FIG.75

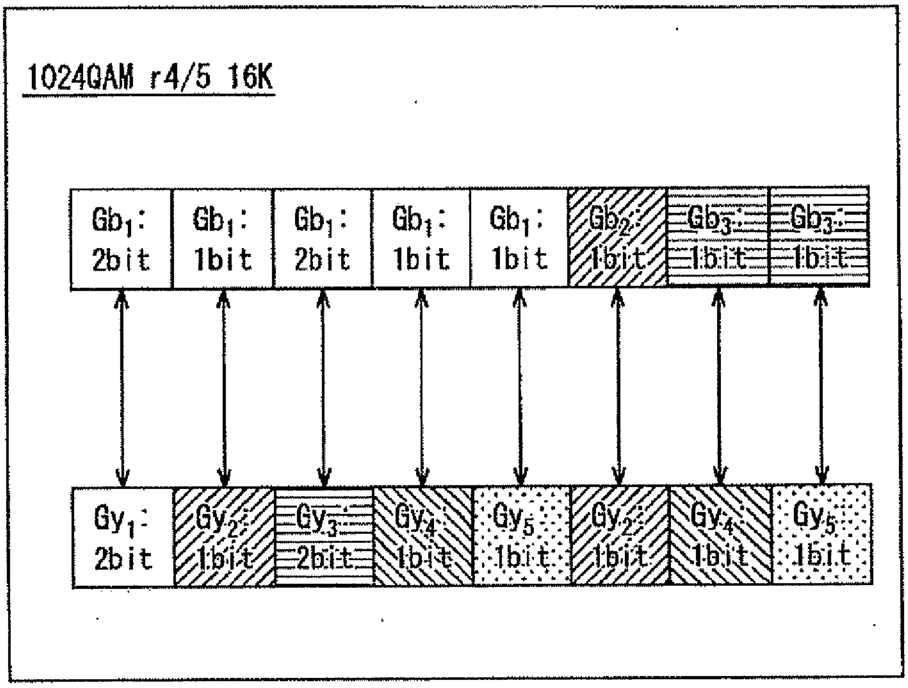
1024QAM r4/5 16K
Gb1: 2bit
Gb1: 1bit
Gb1: 2bit
Gb1: 1bit
Gb1: 1bit
Gb2: 1bit
Gb3: 1bit
Gb3: 1bit
Gy1: 2bit
Gy2: 1bit
Gy3: 2bit
Gy4: 1bit
Gy5: 1bit
Gy2: 1bit
Gy4: 1bit
Gy5: 1bit

FIG.76

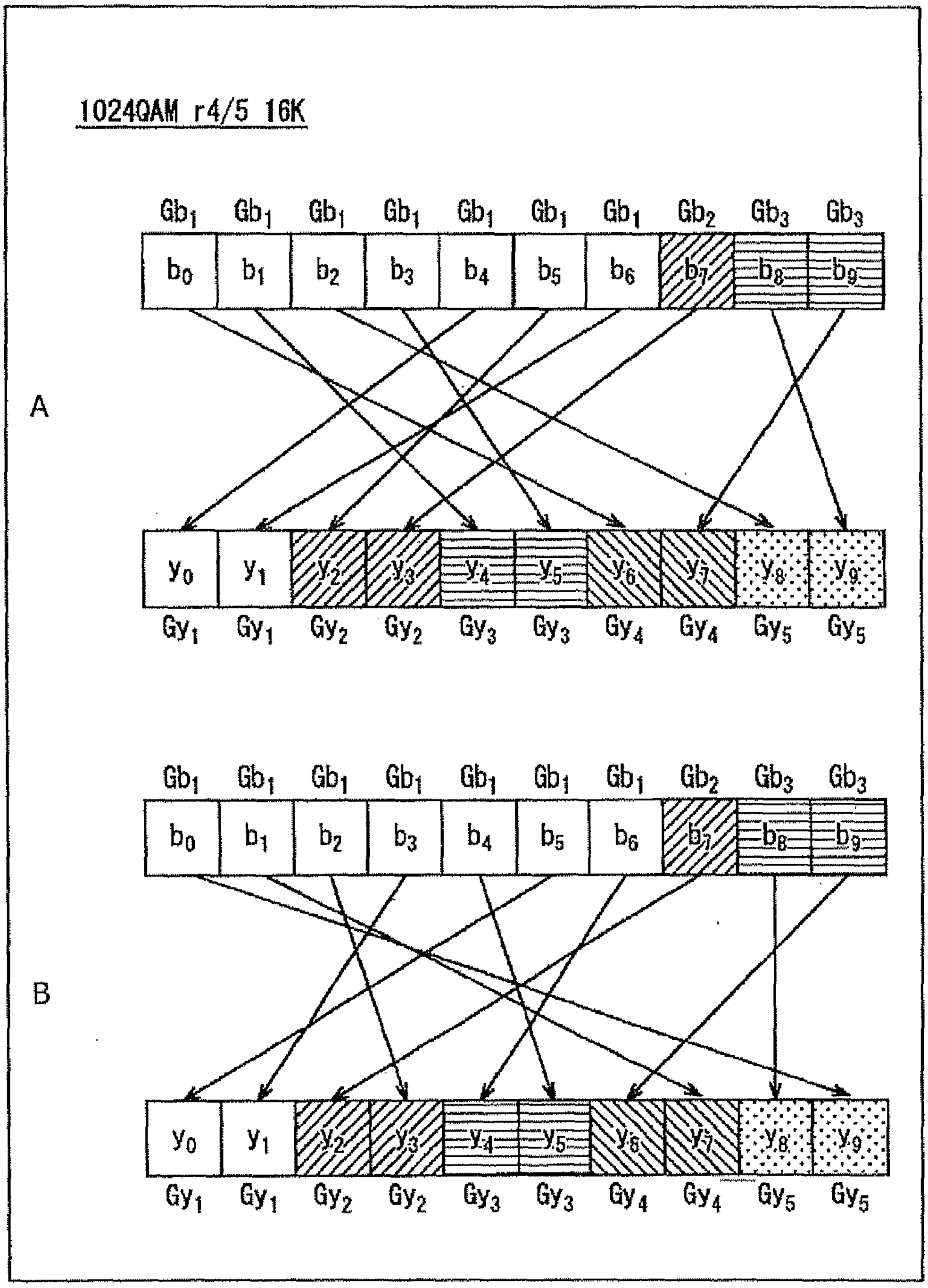
1024QAM r4/5 16K
A
Gb1 Gb1 Gb1 Gb1 Gb1 Gb1 Gb1 Gb2 Gb3 Gb3
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5
B
Gb1 Gb1 Gb1 Gb1 Gb1 Gb1 Gb1 Gb2 Gb3 Gb3
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5

FIG.77

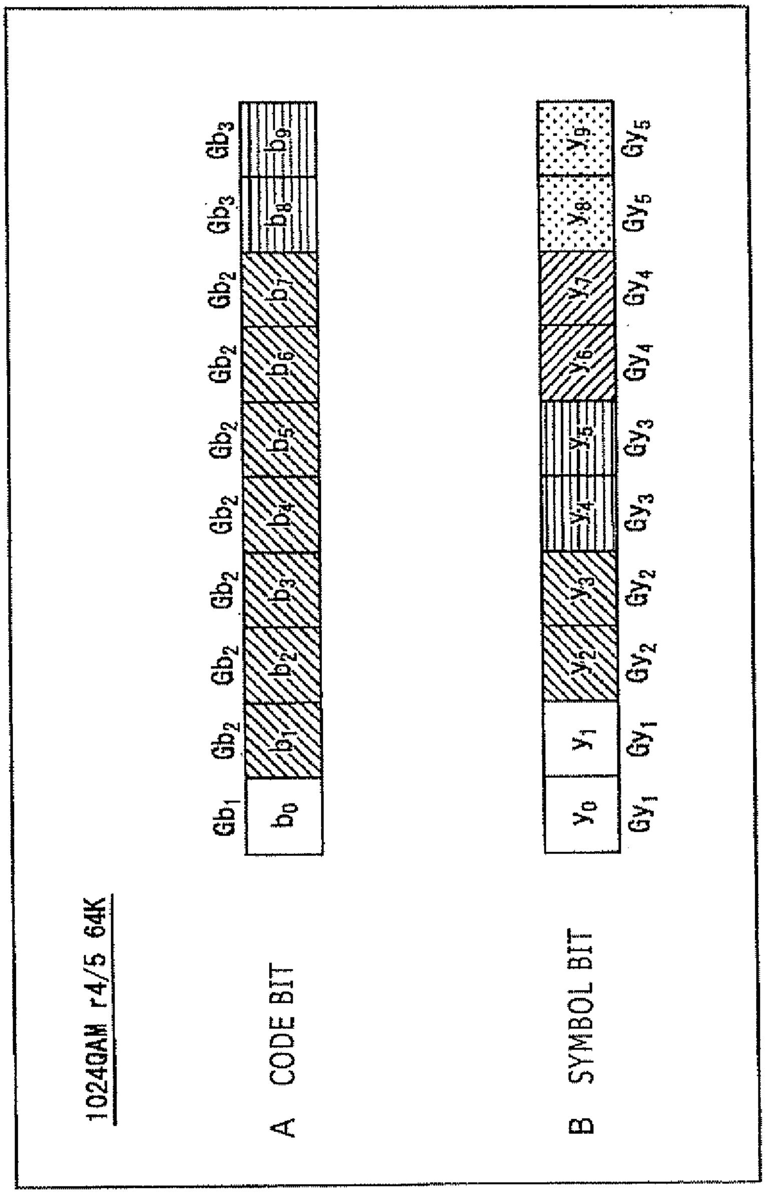
1024QAM r4/5 64K
A CODE BIT
Gb1 Gb2 Gb2 Gb2 Gb2 Gb2 Gb2 Gb2 Gb3 Gb3
b0 b1 b2 b3 b4 b5 b6 b7 b8 b9
B SYMBOL BIT
y0 y1 y2 y3 y4 y5 y6 y7 y8 y9
Gy1 Gy1 Gy2 Gy2 Gy3 Gy3 Gy4 Gy4 Gy5 Gy5

FIG.78

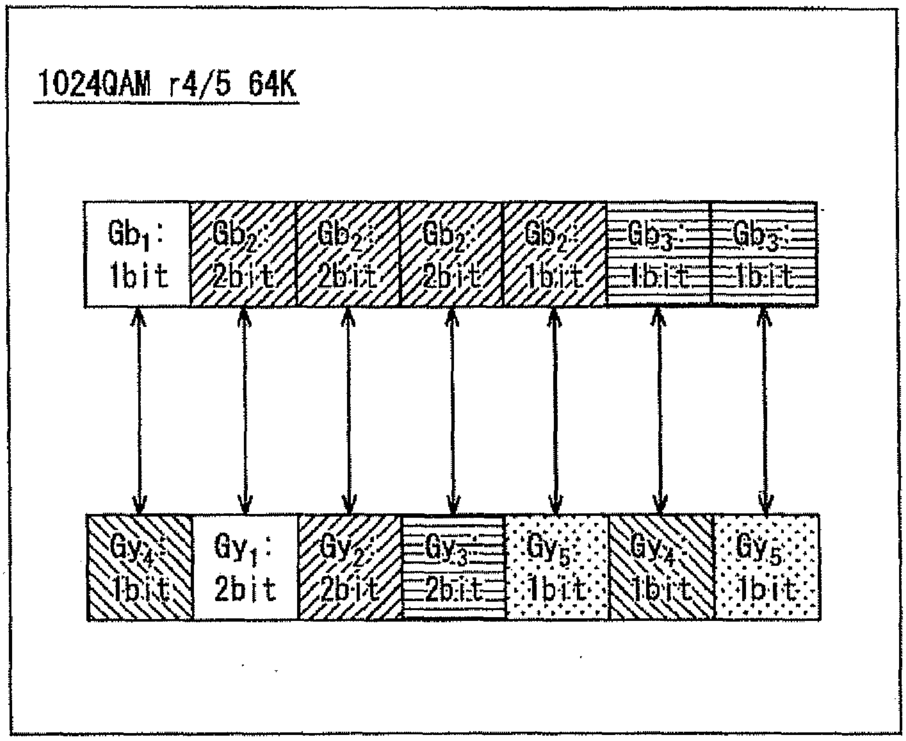
1024QAM r4/5 64K
Gb1: 1bit
Gb2: 2bit
Gb2: 2bit
Gb2: 2bit
Gb2: 1bit
Gb3: 1bit
Gb3: 1bit
Gy4: 1bit
Gy1: 2bit
Gy2: 2bit
Gy3: 2bit
Gy5: 1bit
Gy4: 1bit
Gy5: 1bit

FIG.79

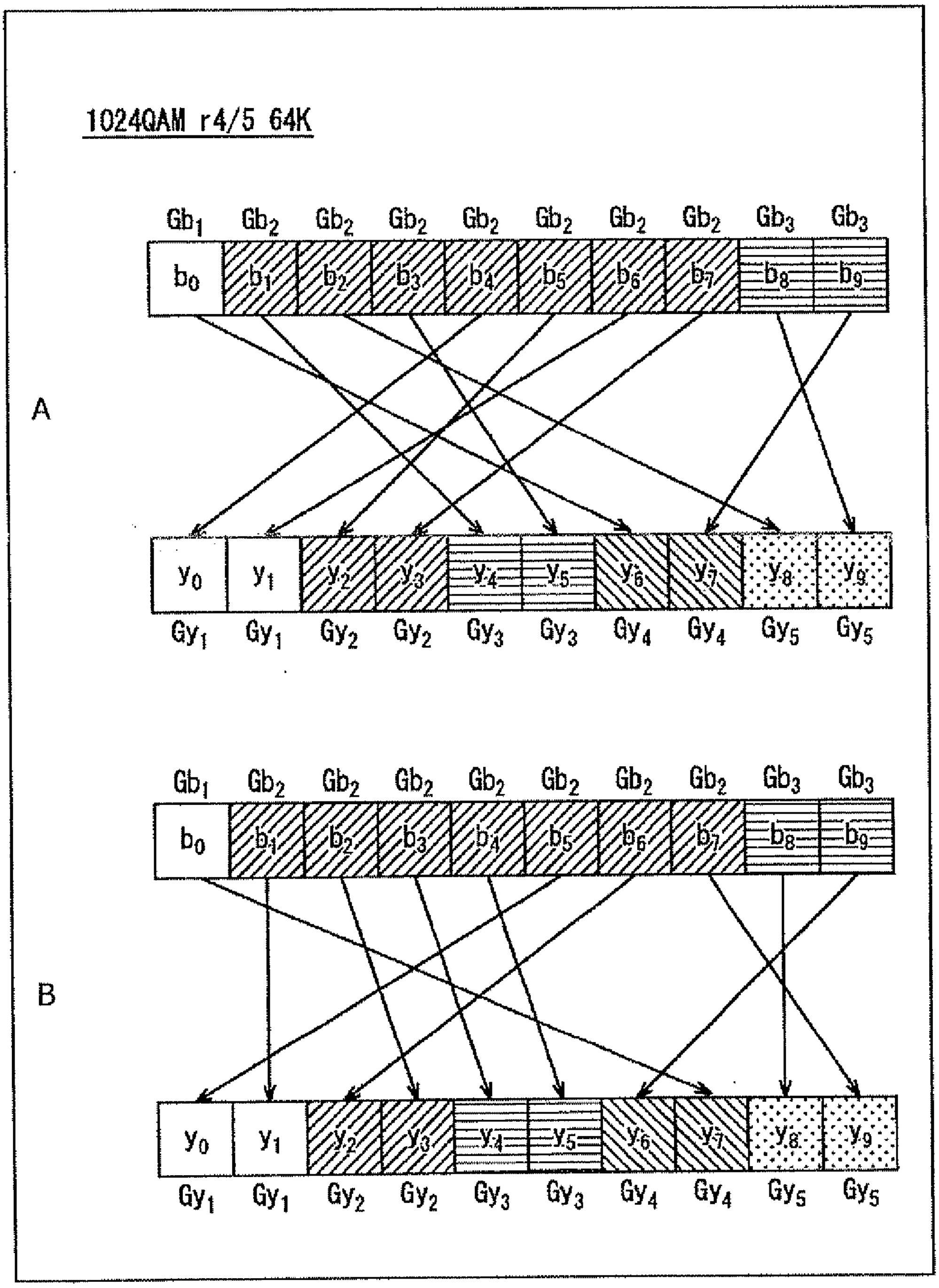
1024QAM r4/5 64K
A
Gb1 Gb2 Gb2 Gb2 Gb2 Gb2 Gb2 Gb2 Gb3 Gb3
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5
B
Gb1 Gb2 Gb2 Gb2 Gb2 Gb2 Gb2 Gb2 Gb3 Gb3
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5

FIG.80

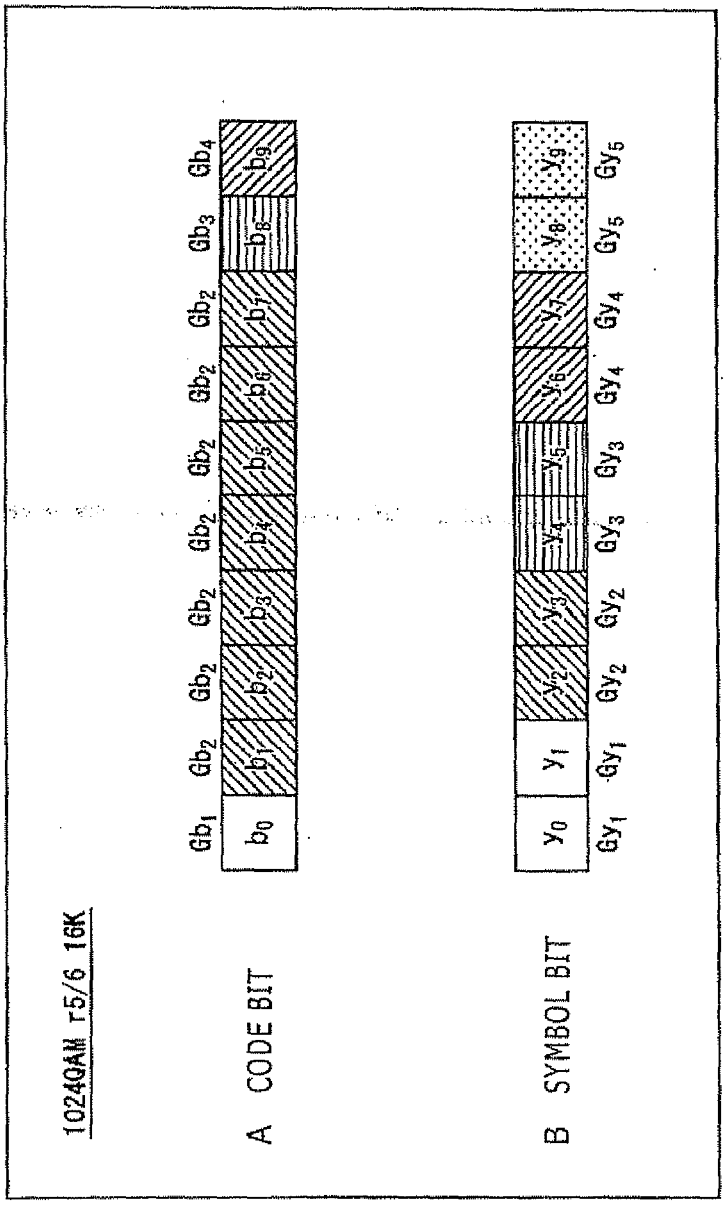
1024QAM r5/6 16K
A CODE BIT
Gb1 Gb2 Gb2 Gb2 Gb2 Gb2 Gb2 Gb2 Gb3 Gb4
b0 b1 b2 b3 b4 b5 b6 b7 b8 b9
B SYMBOL BIT
y0 y1 y2 y3 y4 y5 y6 y7 y8 y9
Gy1 Gy1 Gy2 Gy2 Gy3 Gy3 Gy4 Gy4 Gy5 Gy5

FIG.81

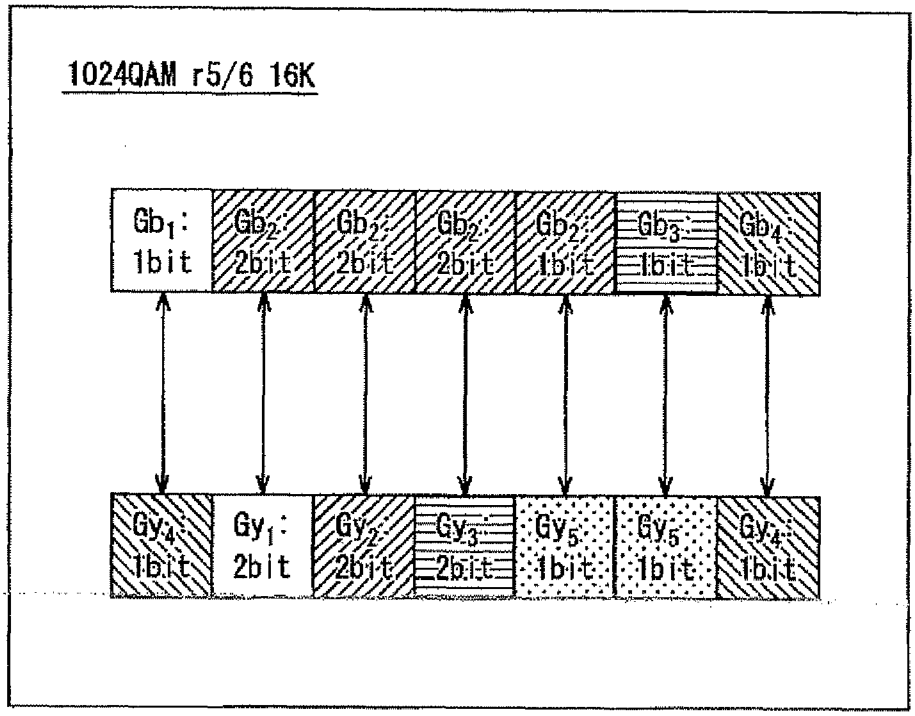
1024QAM r5/6 16K
Gb1: 1bit
Gb2: 2bit
Gb2: 2bit
Gb2: 2bit
Gb2: 1bit
Gb3: 1bit
Gb4: 1bit
Gy4: 1bit
Gy1: 2bit
Gy2: 2bit
Gy3: 2bit
Gy5: 1bit
Gy5: 1bit
Gy4: 1bit

# FIG.82

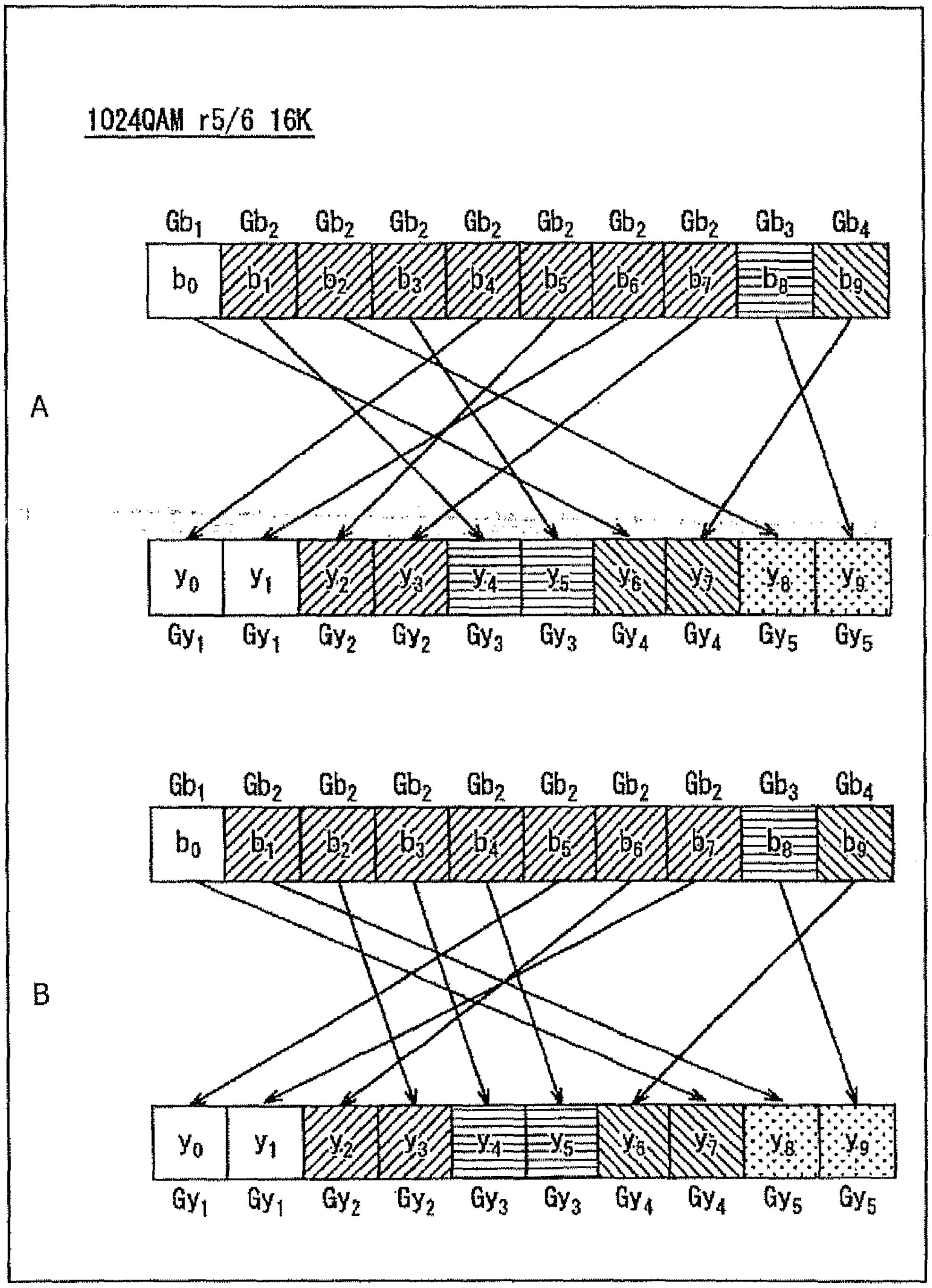
1024QAM r5/6 16K
A
Gb1 Gb2 Gb2 Gb2 Gb2 Gb2 Gb2 Gb2 Gb3 Gb4
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5
B
Gb1 Gb2 Gb2 Gb2 Gb2 Gb2 Gb2 Gb2 Gb3 Gb4
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5

FIG. 83

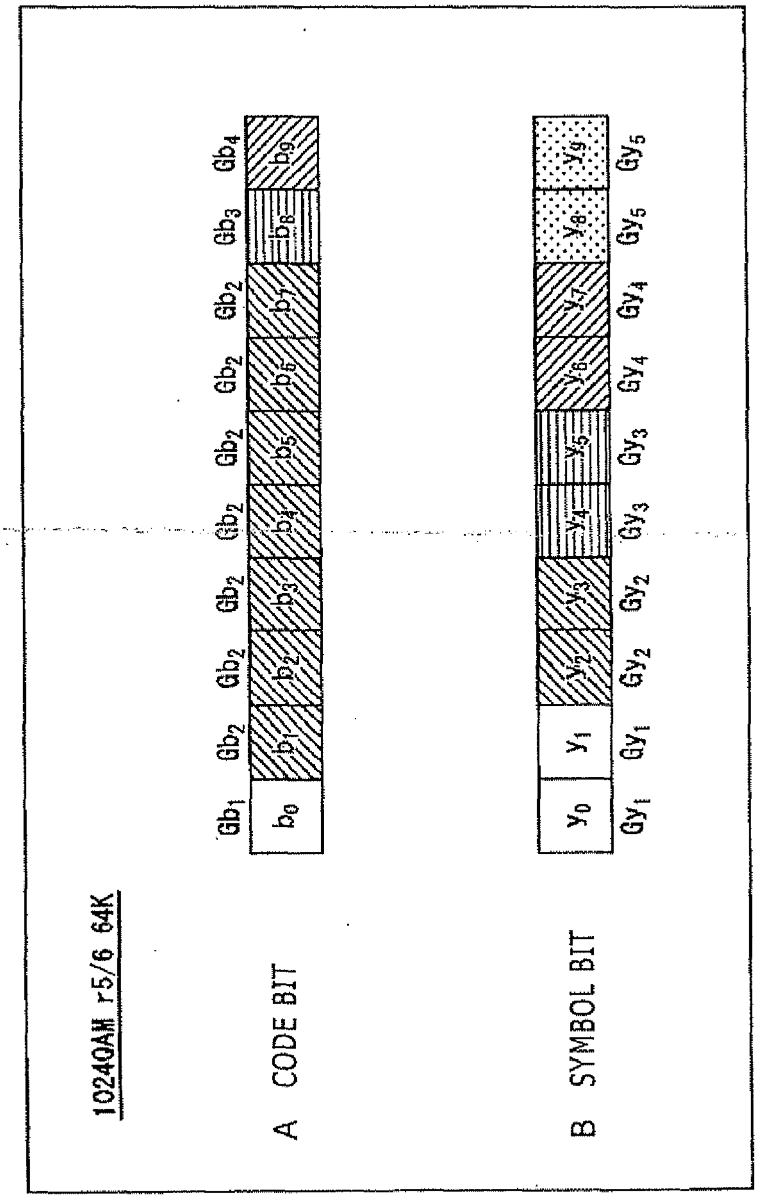
1024QAM r5/6 64K
A CODE BIT
Gb1 Gb2 Gb2 Gb2 Gb2 Gb2 Gb2 Gb2 Gb3 Gb4
b0 b1 b2 b3 b4 b5 b6 b7 b8 b9
B SYMBOL BIT
Gy1 Gy1 Gy2 Gy2 Gy3 Gy3 Gy4 Gy4 Gy5 Gy5
y0 y1 y2 y3 y4 y5 y6 y7 y8 y9

FIG.84

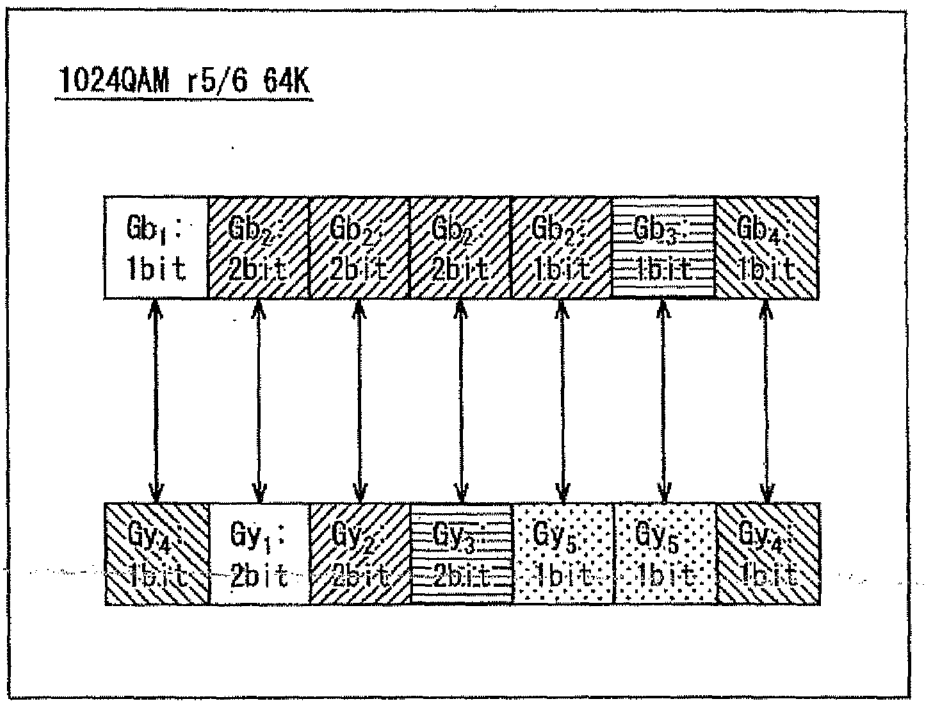
1024QAM r5/6 64K
Gb1: 1bit
Gb2: 2bit
Gb2: 2bit
Gb2: 2bit
Gb2: 1bit
Gb3: 1bit
Gb4: 1bit
Gy4: 1bit
Gy1: 2bit
Gy2: 2bit
Gy3: 2bit
Gy5: 1bit
Gy5: 1bit
Gy4: 1bit

# FIG.85

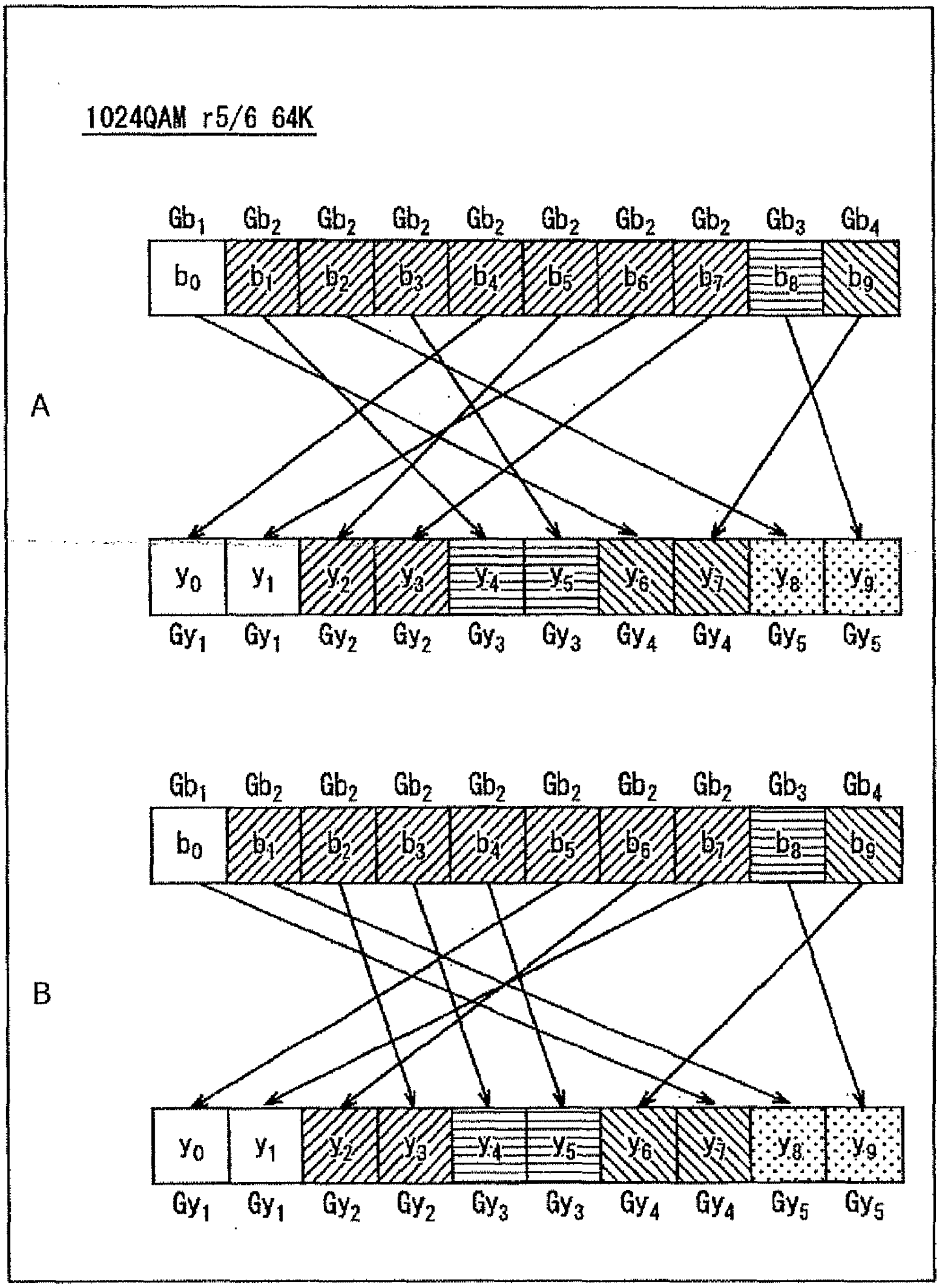
1024QAM r5/6 64K
A
Gb1 Gb2 Gb2 Gb2 Gb2 Gb2 Gb2 Gb2 Gb3 Gb4
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5
B
Gb1 Gb2 Gb2 Gb2 Gb2 Gb2 Gb2 Gb2 Gb3 Gb4
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5

FIG.86

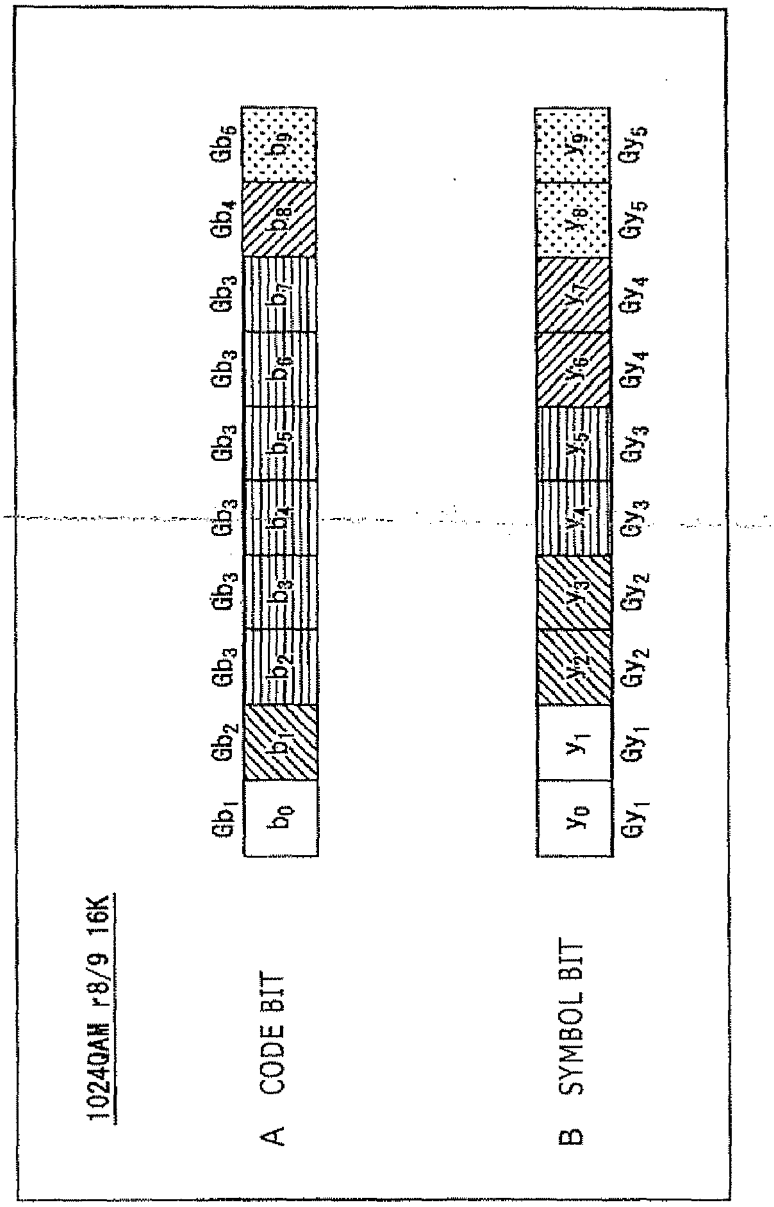
1024QAM r8/9 16K
A CODE BIT
Gb1 Gb2 Gb3 Gb3 Gb3 Gb3 Gb3 Gb3 Gb4 Gb5
b0 b1 b2 b3 b4 b5 b6 b7 b8 b9
B SYMBOL BIT
y0 y1 y2 y3 y4 y5 y6 y7 y8 y9
Gy1 Gy1 Gy2 Gy2 Gy3 Gy3 Gy4 Gy4 Gy5 Gy5

FIG.87

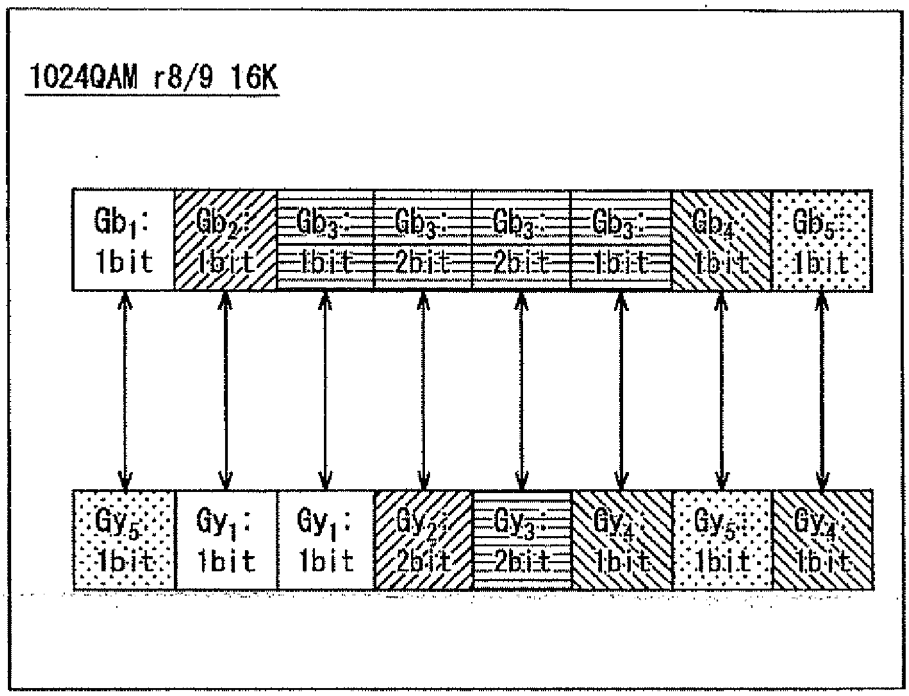
1024QAM r8/9 16K
Gb1: 1bit
Gb2: 1bit
Gb3: 1bit
Gb3: 2bit
Gb3: 2bit
Gb3: 1bit
Gb4: 1bit
Gb5: 1bit
Gy5: 1bit
Gy1: 1bit
Gy1: 1bit
Gy2: 2bit
Gy3: 2bit
Gy4: 1bit
Gy5: 1bit
Gy4: 1bit

# FIG.88

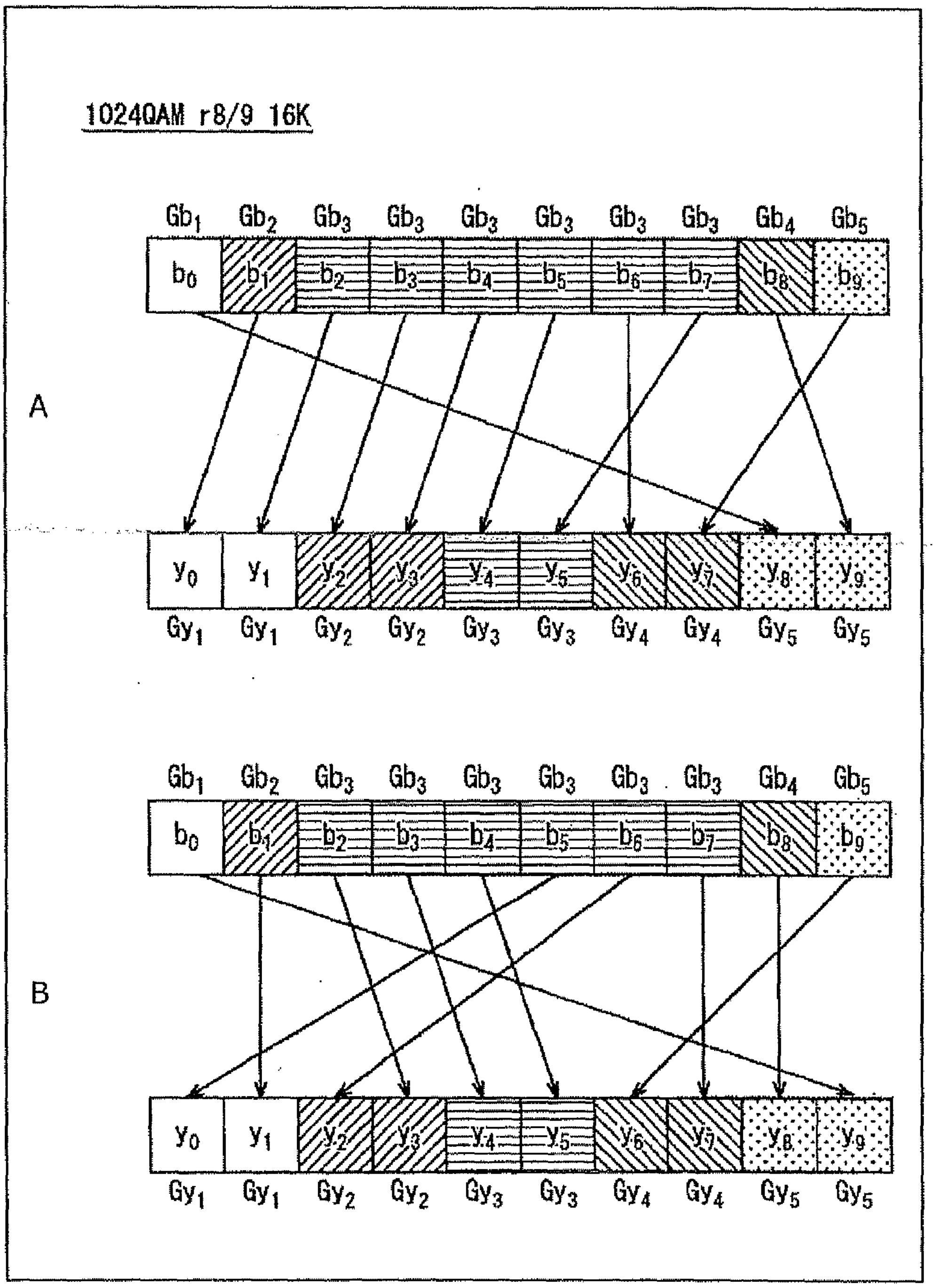
1024QAM r8/9 16K
A
B
Gb1 Gb2 Gb3 Gb3 Gb3 Gb3 Gb3 Gb3 Gb4 Gb5
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5

FIG.89

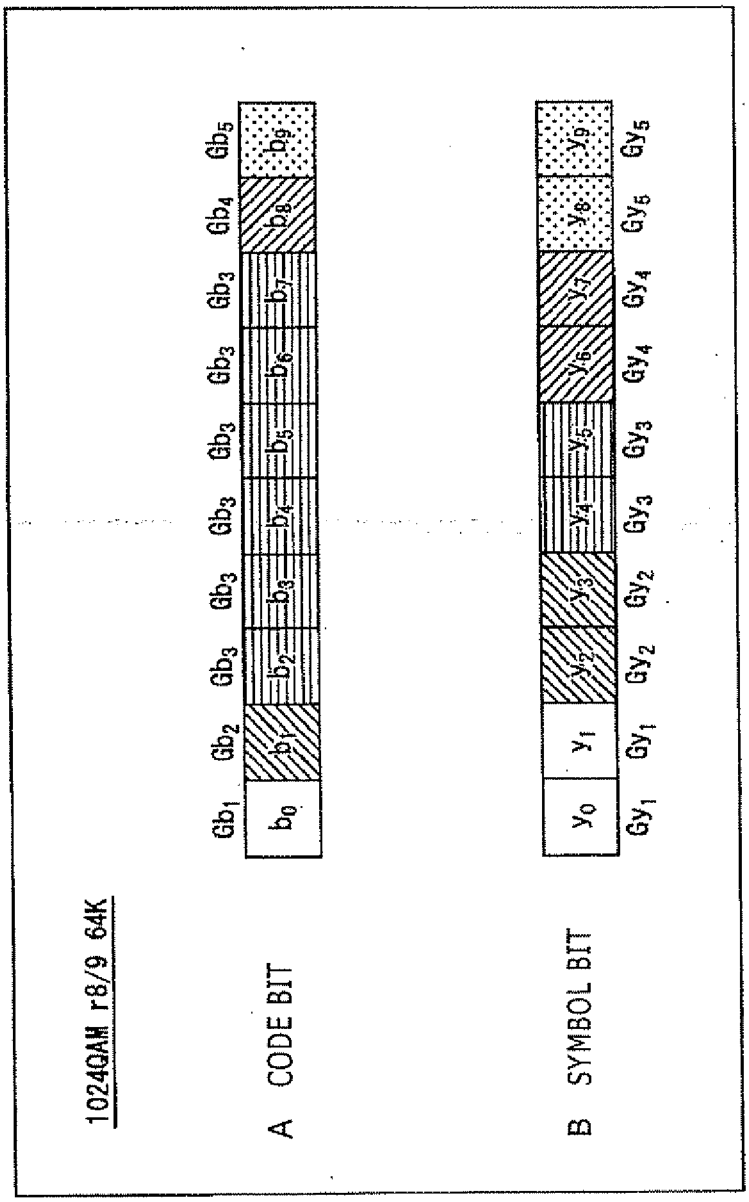
1024QAM r8/9 64K
A CODE BIT
Gb1 Gb2 Gb3 Gb3 Gb3 Gb3 Gb3 Gb3 Gb4 Gb5
b0 b1 b2 b3 b4 b5 b6 b7 b8 b9
B SYMBOL BIT
y0 y1 y2 y3 y4 y5 y6 y7 y8 y9
Gy1 Gy1 Gy2 Gy2 Gy3 Gy3 Gy4 Gy4 Gy5 Gy5

FIG.90

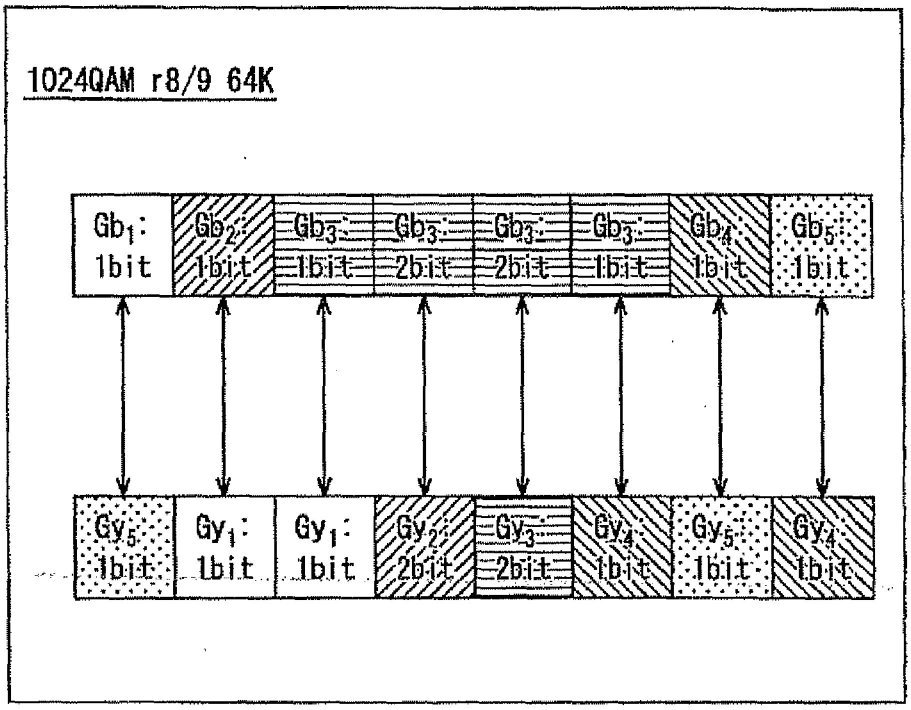
1024QAM r8/9 64K
Gb1: 1bit
Gb2: 1bit
Gb3: 1bit
Gb3: 2bit
Gb3: 2bit
Gb3: 1bit
Gb4: 1bit
Gb5: 1bit
Gy5: 1bit
Gy1: 1bit
Gy1: 1bit
Gy2: 2bit
Gy3: 2bit
Gy4: 1bit
Gy5: 1bit
Gy4: 1bit

# FIG.91

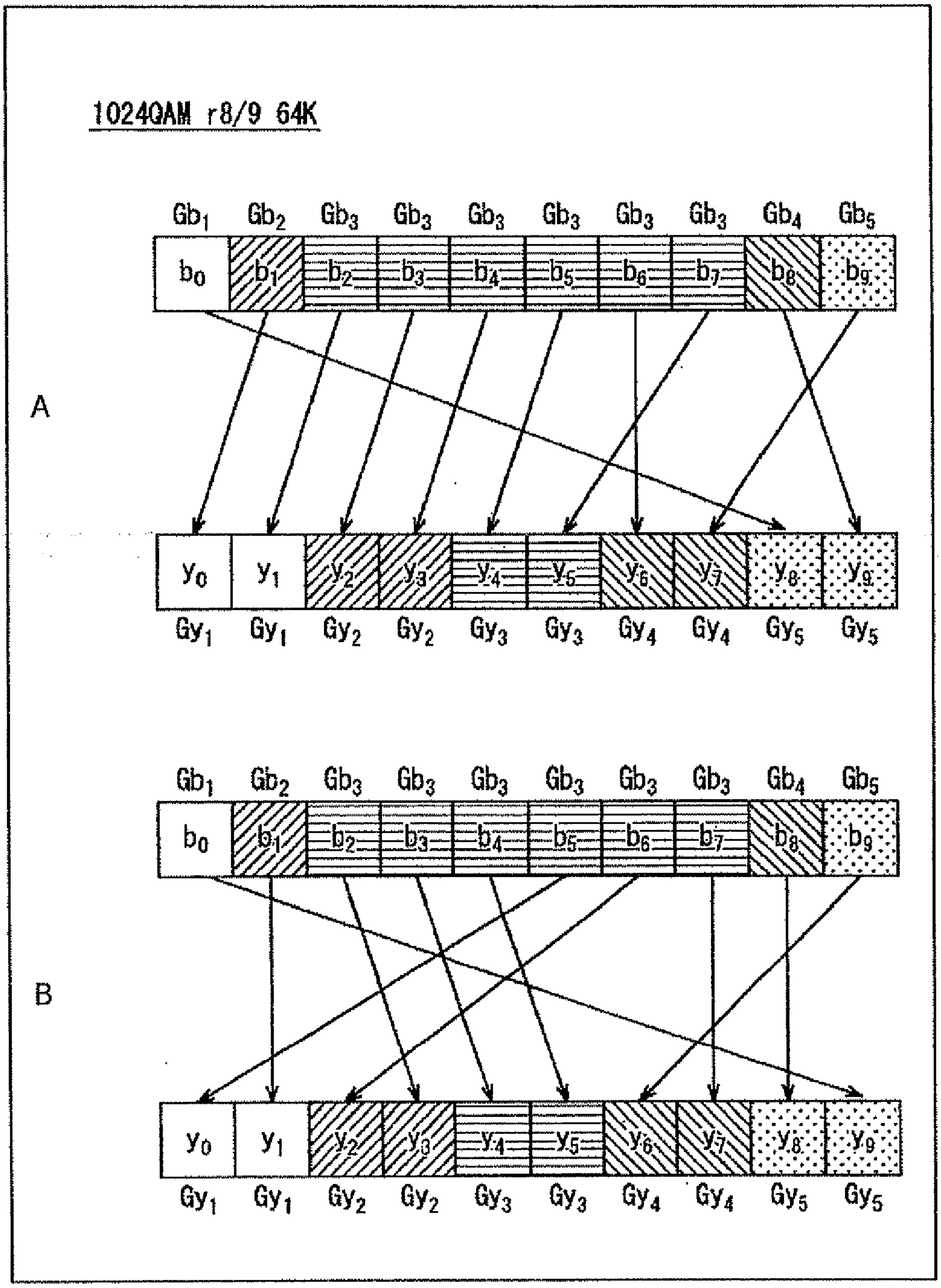
1024QAM r8/9 64K
A
Gb1 Gb2 Gb3 Gb3 Gb3 Gb3 Gb3 Gb3 Gb4 Gb5
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5
B
Gb1 Gb2 Gb3 Gb3 Gb3 Gb3 Gb3 Gb3 Gb4 Gb5
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5

FIG.92

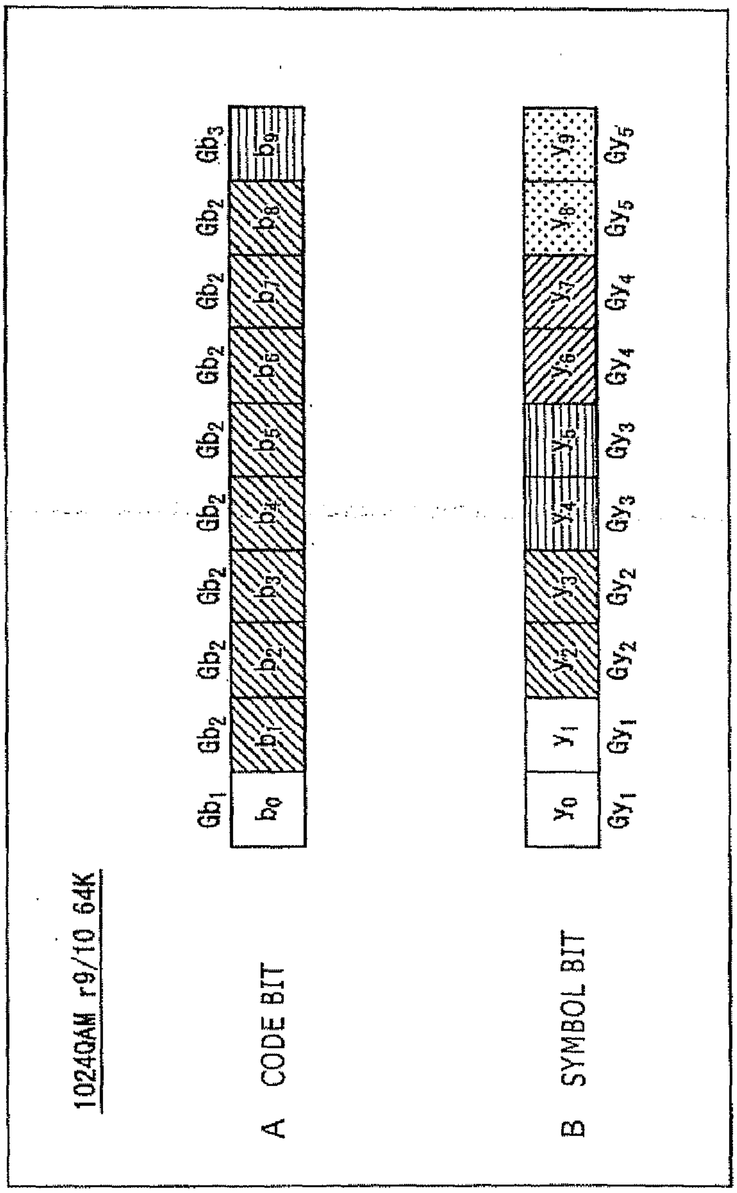
1024QAM r9/10 64K
A CODE BIT
B SYMBOL BIT
Gb1 Gb2 Gb2 Gb2 Gb2 Gb2 Gb2 Gb2 Gb2 Gb3
$b_0$ $b_1$ $b_2$ $b_3$ $b_4$ $b_5$ $b_6$ $b_7$ $b_8$ $b_9$
$y_0$ $y_1$ $y_2$ $y_3$ $y_4$ $y_5$ $y_6$ $y_7$ $y_8$ $y_9$
Gy1 Gy1 Gy2 Gy2 Gy3 Gy3 Gy4 Gy4 Gy5 Gy5

# FIG.93

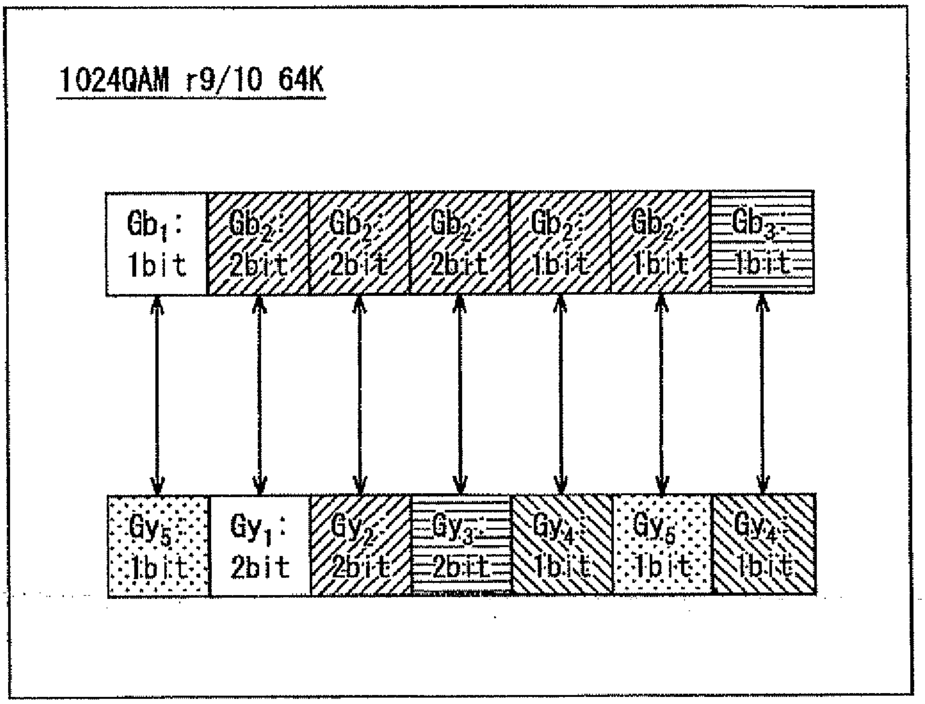
1024QAM r9/10 64K
Gb1: 1bit
Gb2: 2bit
Gb2: 2bit
Gb2: 2bit
Gb2: 1bit
Gb2: 1bit
Gb3: 1bit
Gy5: 1bit
Gy1: 2bit
Gy2: 2bit
Gy3: 2bit
Gy4: 1bit
Gy5: 1bit
Gy4: 1bit

# FIG.94

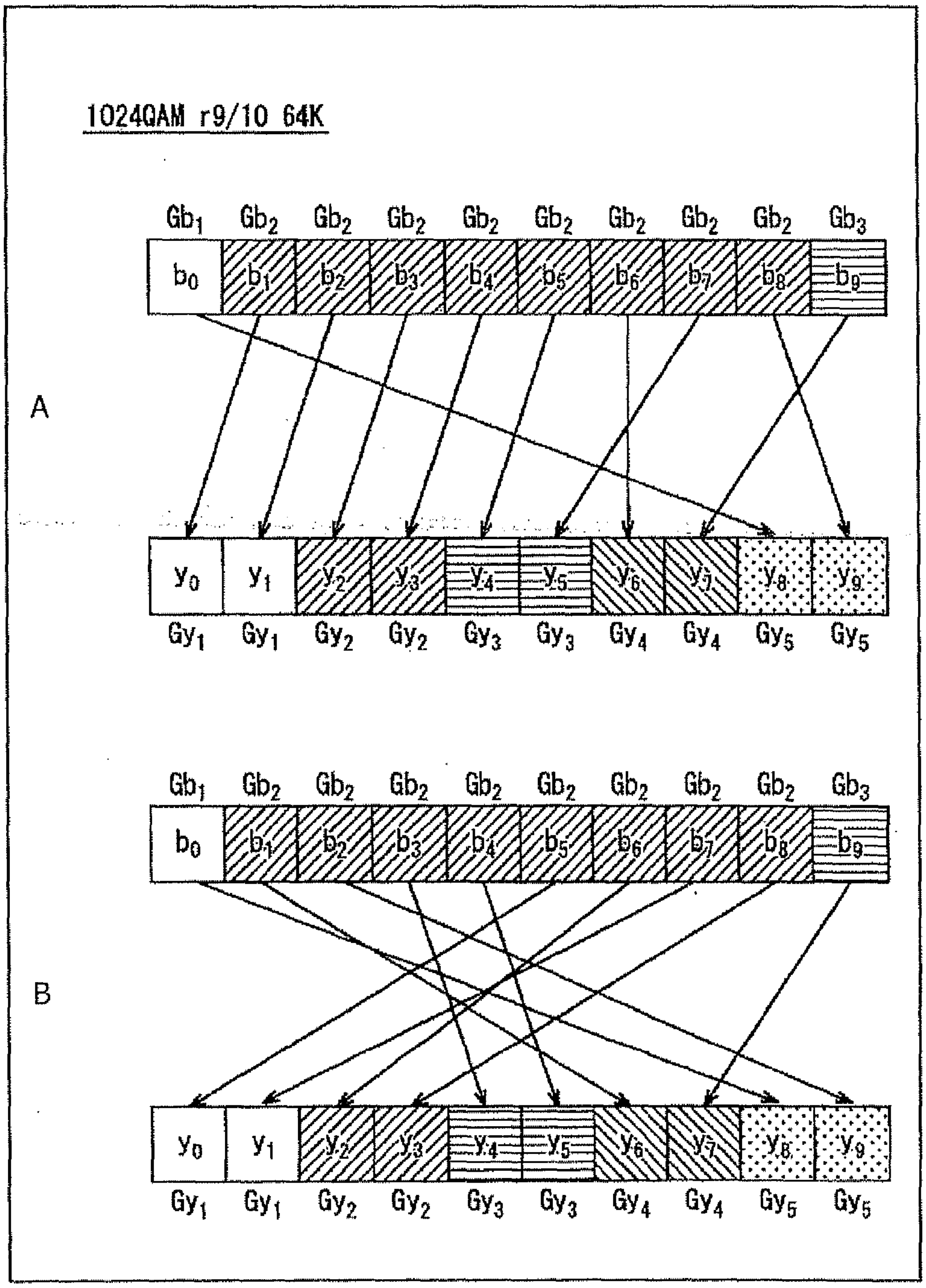
1024QAM r9/10 64K
A
Gb1 Gb2 Gb2 Gb2 Gb2 Gb2 Gb2 Gb2 Gb2 Gb3
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5
B
Gb1 Gb2 Gb2 Gb2 Gb2 Gb2 Gb2 Gb2 Gb2 Gb3
b0 b1 b2 b3 b4 b5 b6 b7 b8 b9
y0 y1 y2 y3 y4 y5 y6 y7 y8 y9
Gy1 Gy1 Gy2 Gy2 Gy3 Gy3 Gy4 Gy4 Gy5 Gy5

FIG. 95

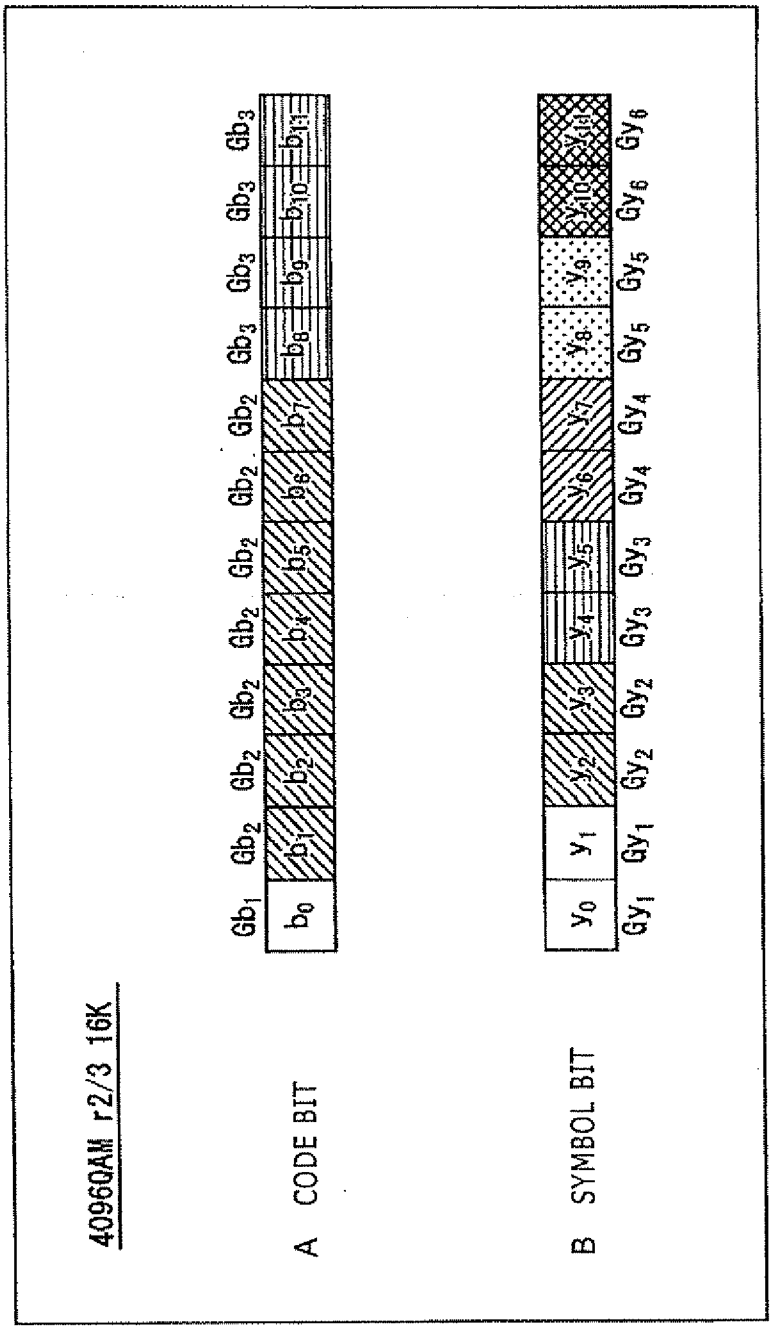
4096QAM r2/3 16K
A CODE BIT
B SYMBOL BIT
Gb1 Gb2 Gb2 Gb2 Gb2 Gb2 Gb2 Gb2 Gb3 Gb3 Gb3 Gb3
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

# FIG.96

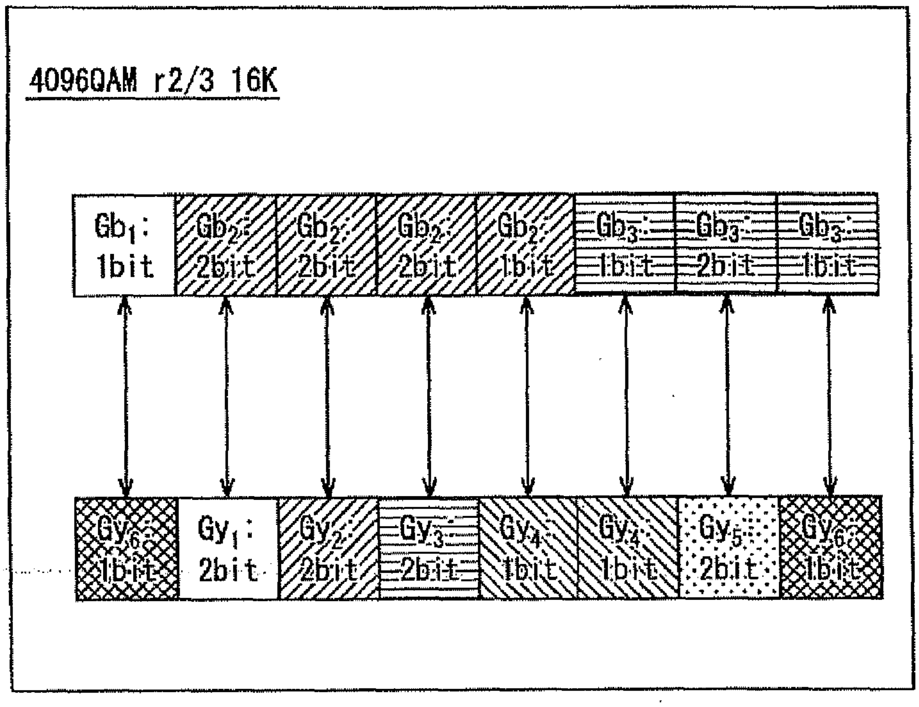
4096QAM r2/3 16K
Gb1: 1bit
Gb2: 2bit
Gb2: 2bit
Gb2: 2bit
Gb2: 1bit
Gb3: 1bit
Gb3: 2bit
Gb3: 1bit
Gy6: 1bit
Gy1: 2bit
Gy2: 2bit
Gy3: 2bit
Gy4: 1bit
Gy4: 1bit
Gy5: 2bit
Gy6: 1bit

# FIG.97

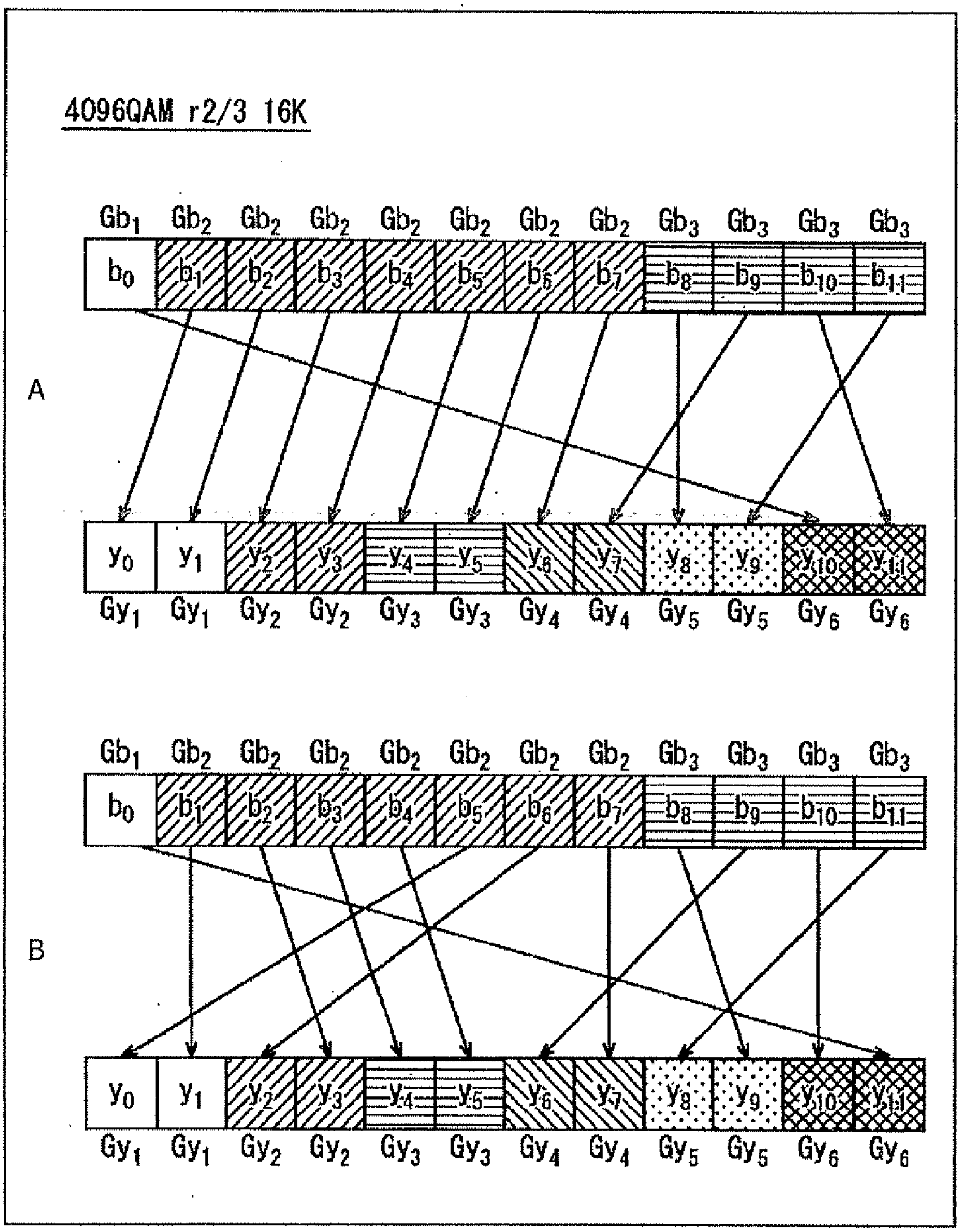

4096QAM r2/3 16K
A
Gb1 Gb2 Gb2 Gb2 Gb2 Gb2 Gb2 Gb2 Gb3 Gb3 Gb3 Gb3
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6
B
Gb1 Gb2 Gb2 Gb2 Gb2 Gb2 Gb2 Gb2 Gb3 Gb3 Gb3 Gb3
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.98

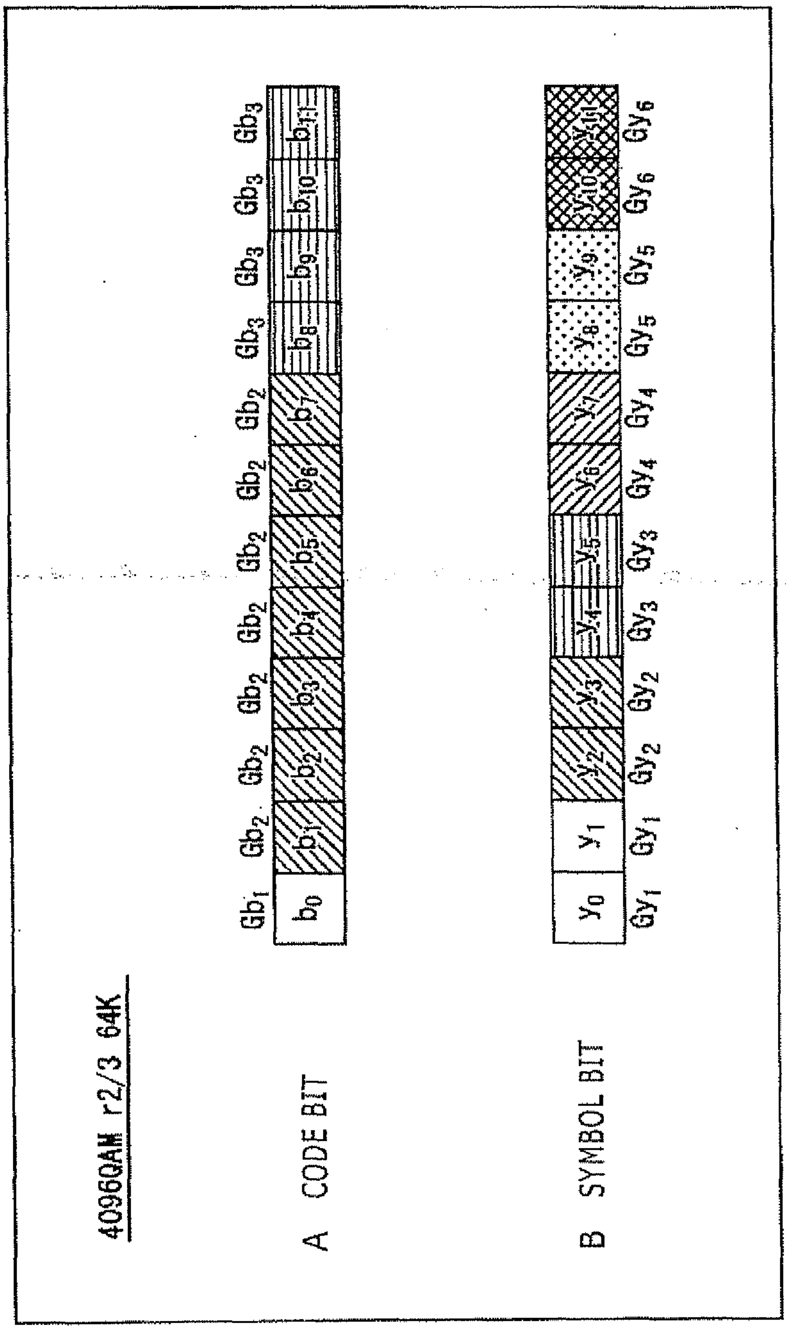
4096QAM r2/3 64K
A CODE BIT
Gb1 Gb2 Gb2 Gb2 Gb2 Gb2 Gb2 Gb2 Gb3 Gb3 Gb3 Gb3
b0 b1 b2 b3 b4 b5 b6 b7 b8 b9 b10 b11
B SYMBOL BIT
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.99

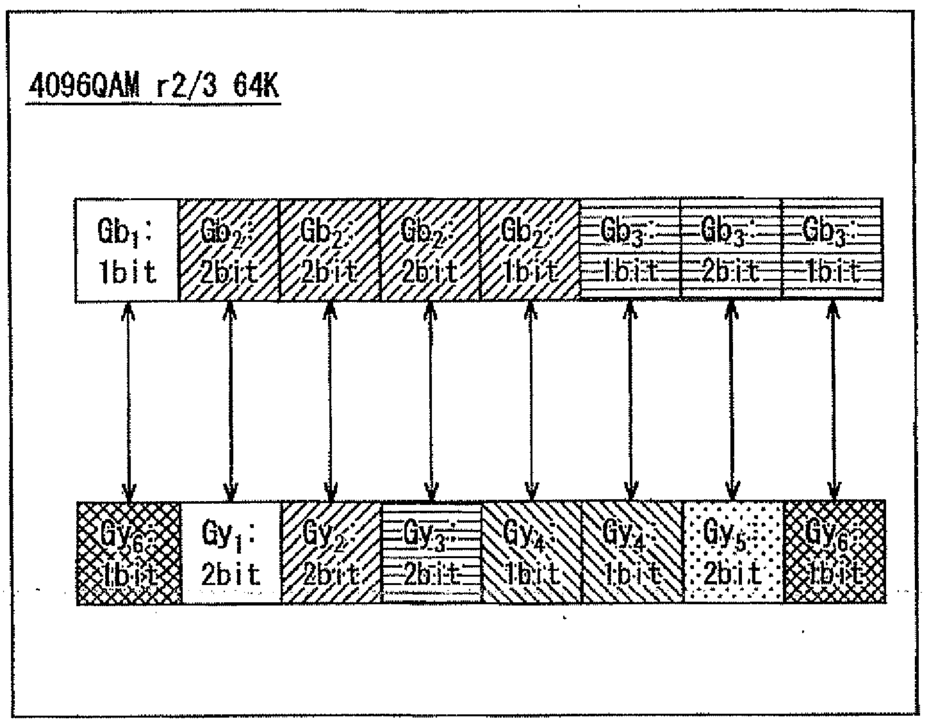
4096QAM r2/3 64K
Gb1: 1bit
Gb2: 2bit
Gb2: 2bit
Gb2: 2bit
Gb2: 1bit
Gb3: 1bit
Gb3: 2bit
Gb3: 1bit
Gy6: 1bit
Gy1: 2bit
Gy2: 2bit
Gy3: 2bit
Gy4: 1bit
Gy4: 1bit
Gy5: 2bit
Gy6: 1bit

# FIG.100

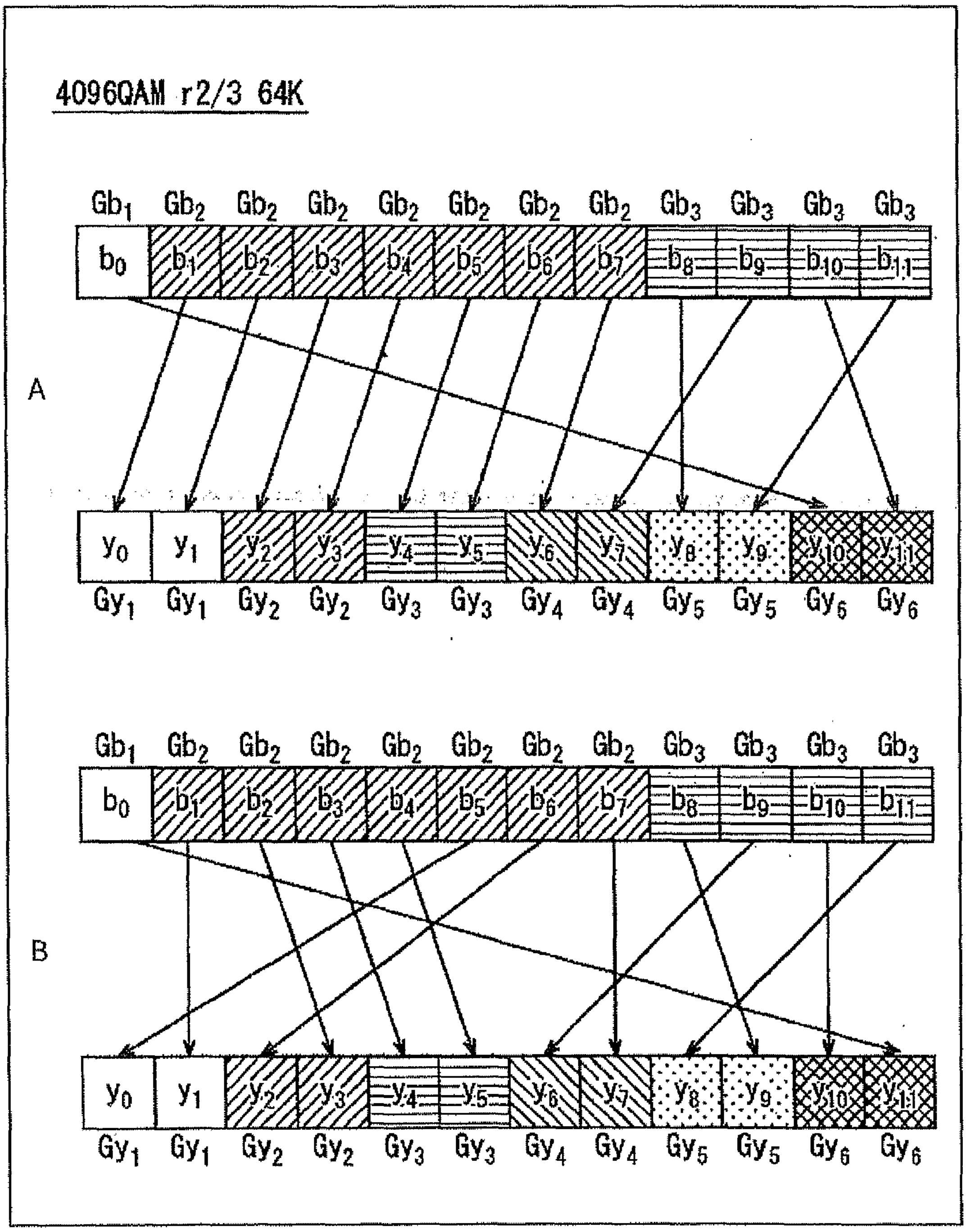
4096QAM r2/3 64K
A
Gb1 Gb2 Gb2 Gb2 Gb2 Gb2 Gb2 Gb2 Gb3 Gb3 Gb3 Gb3
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6
B
Gb1 Gb2 Gb2 Gb2 Gb2 Gb2 Gb2 Gb2 Gb3 Gb3 Gb3 Gb3
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.101

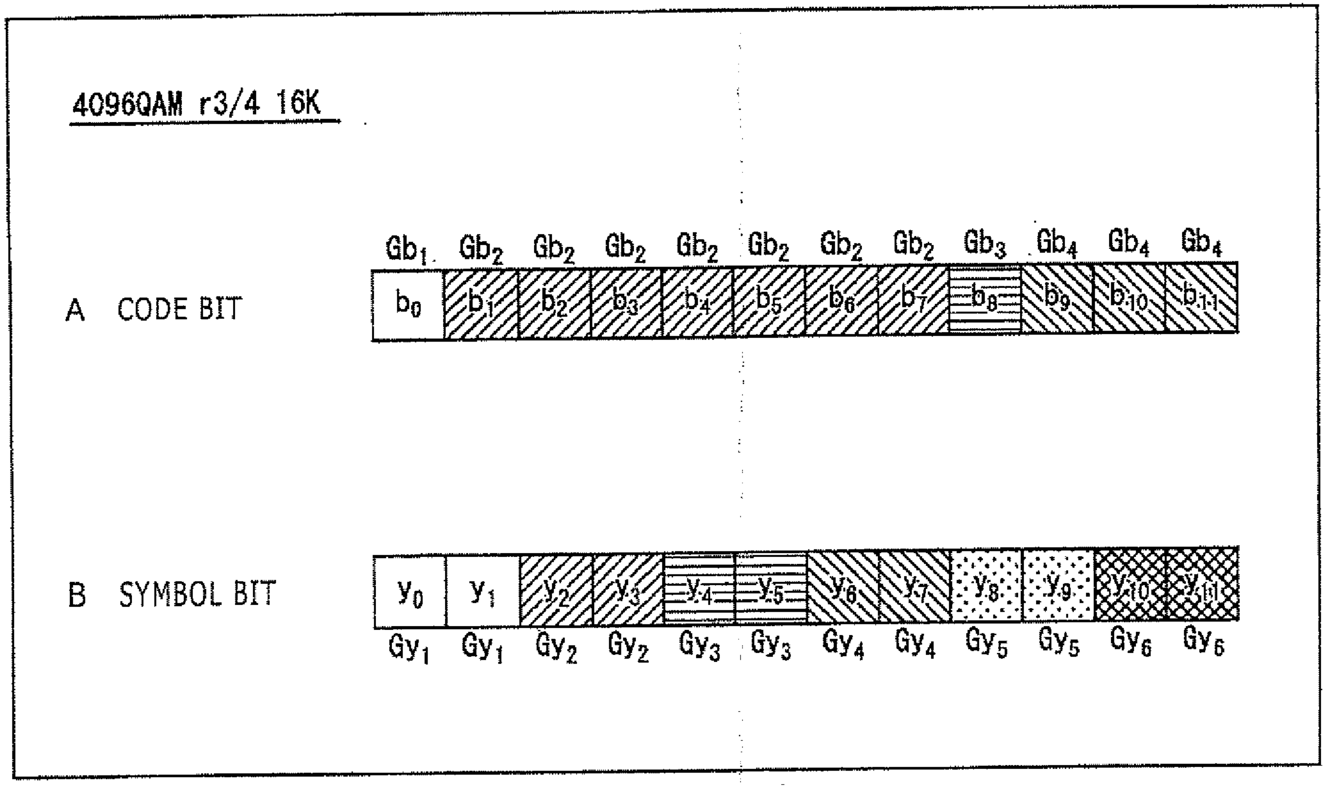
4096QAM r3/4 16K
A CODE BIT
Gb1 Gb2 Gb2 Gb2 Gb2 Gb2 Gb2 Gb2 Gb3 Gb4 Gb4 Gb4
b0 b1 b2 b3 b4 b5 b6 b7 b8 b9 b10 b11
B SYMBOL BIT
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.102

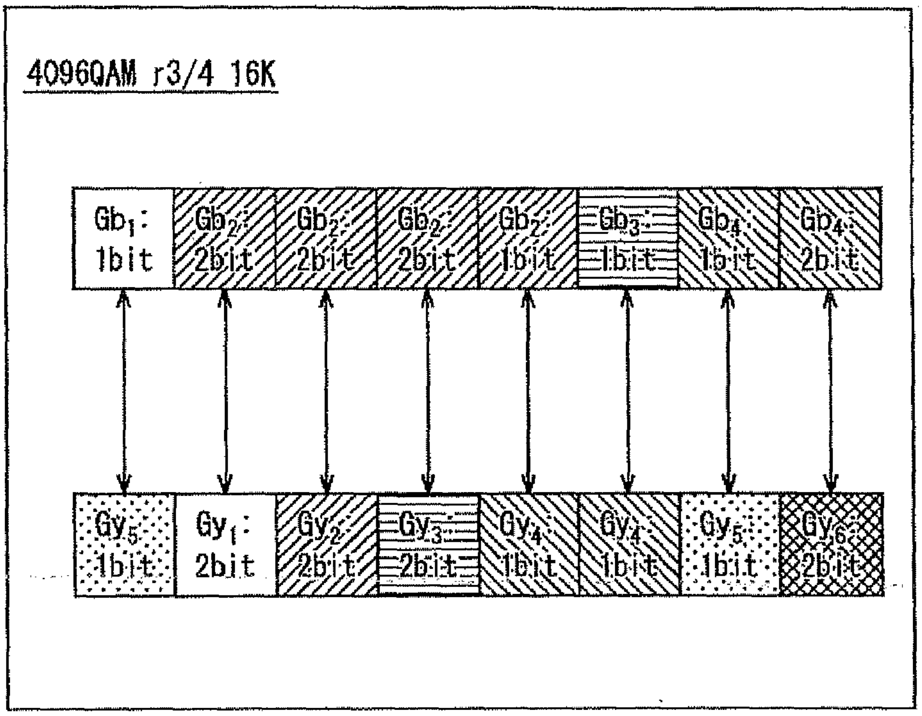
4096QAM r3/4 16K
Gb1: 1bit
Gb2: 2bit
Gb2: 2bit
Gb2: 2bit
Gb2: 1bit
Gb3: 1bit
Gb4: 1bit
Gb4: 2bit
Gy5: 1bit
Gy1: 2bit
Gy2: 2bit
Gy3: 2bit
Gy4: 1bit
Gy4: 1bit
Gy5: 1bit
Gy6: 2bit

# FIG.103

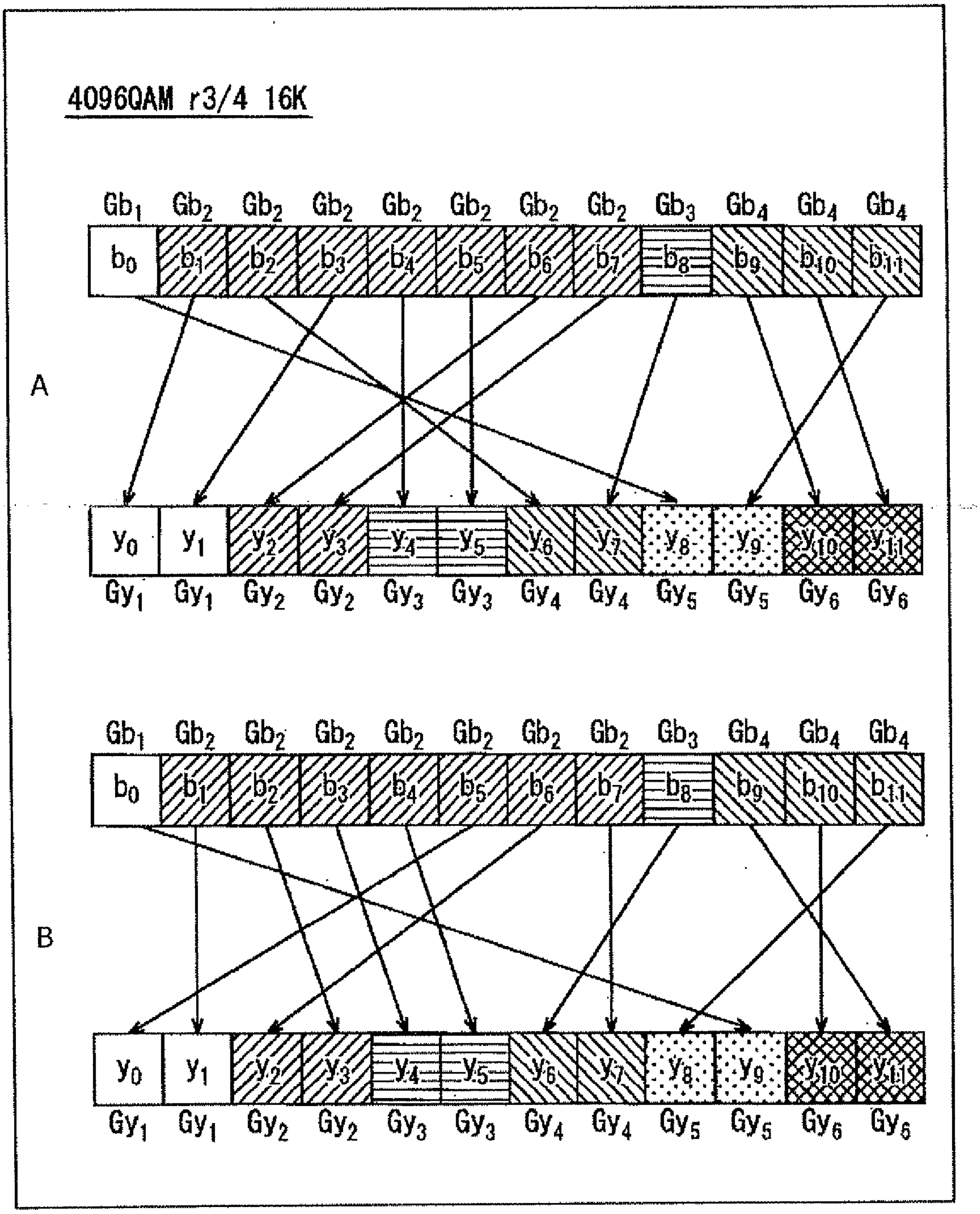

4096QAM r3/4 16K
A
Gb1 Gb2 Gb2 Gb2 Gb2 Gb2 Gb2 Gb2 Gb3 Gb4 Gb4 Gb4
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6
B
Gb1 Gb2 Gb2 Gb2 Gb2 Gb2 Gb2 Gb2 Gb3 Gb4 Gb4 Gb4
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.104

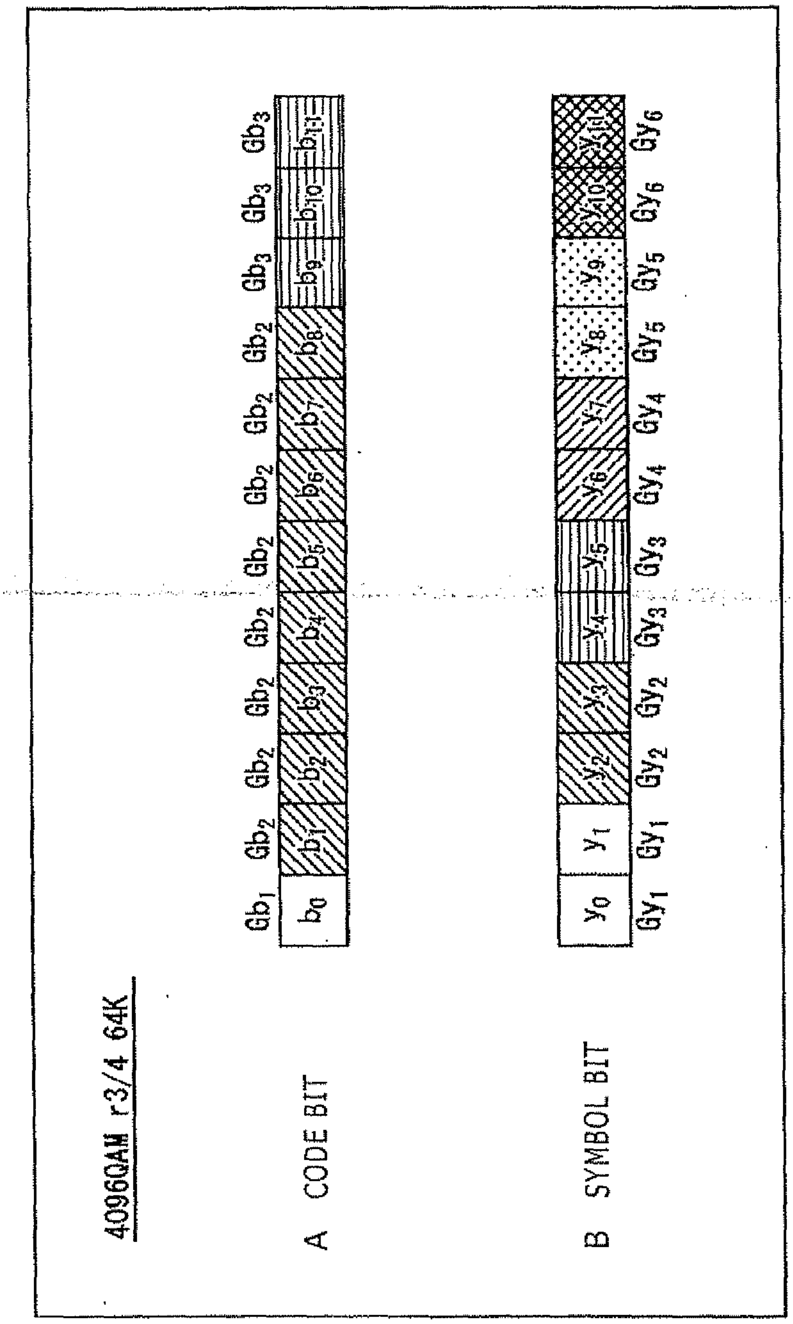
4096QAM r3/4 64K
A CODE BIT
B SYMBOL BIT
Gb1 Gb2 Gb2 Gb2 Gb2 Gb2 Gb2 Gb2 Gb2 Gb3 Gb3 Gb3
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.105

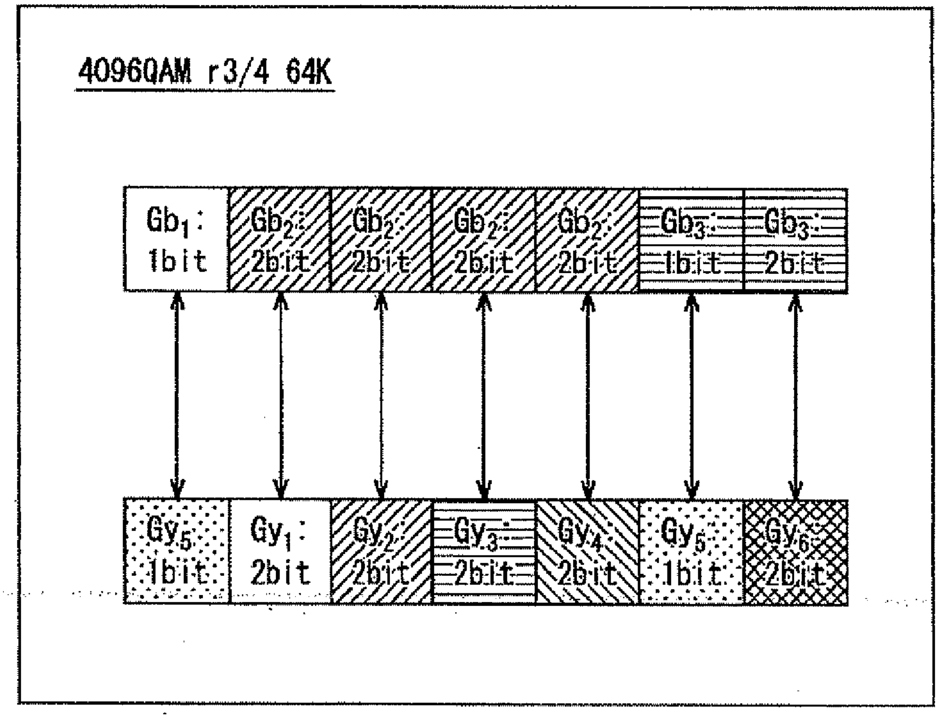
4096QAM r3/4 64K
Gb1: 1bit
Gb2: 2bit
Gb2: 2bit
Gb2: 2bit
Gb2: 2bit
Gb3: 1bit
Gb3: 2bit
Gy5: 1bit
Gy1: 2bit
Gy2: 2bit
Gy3: 2bit
Gy4: 2bit
Gy5: 1bit
Gy6: 2bit

# FIG.106

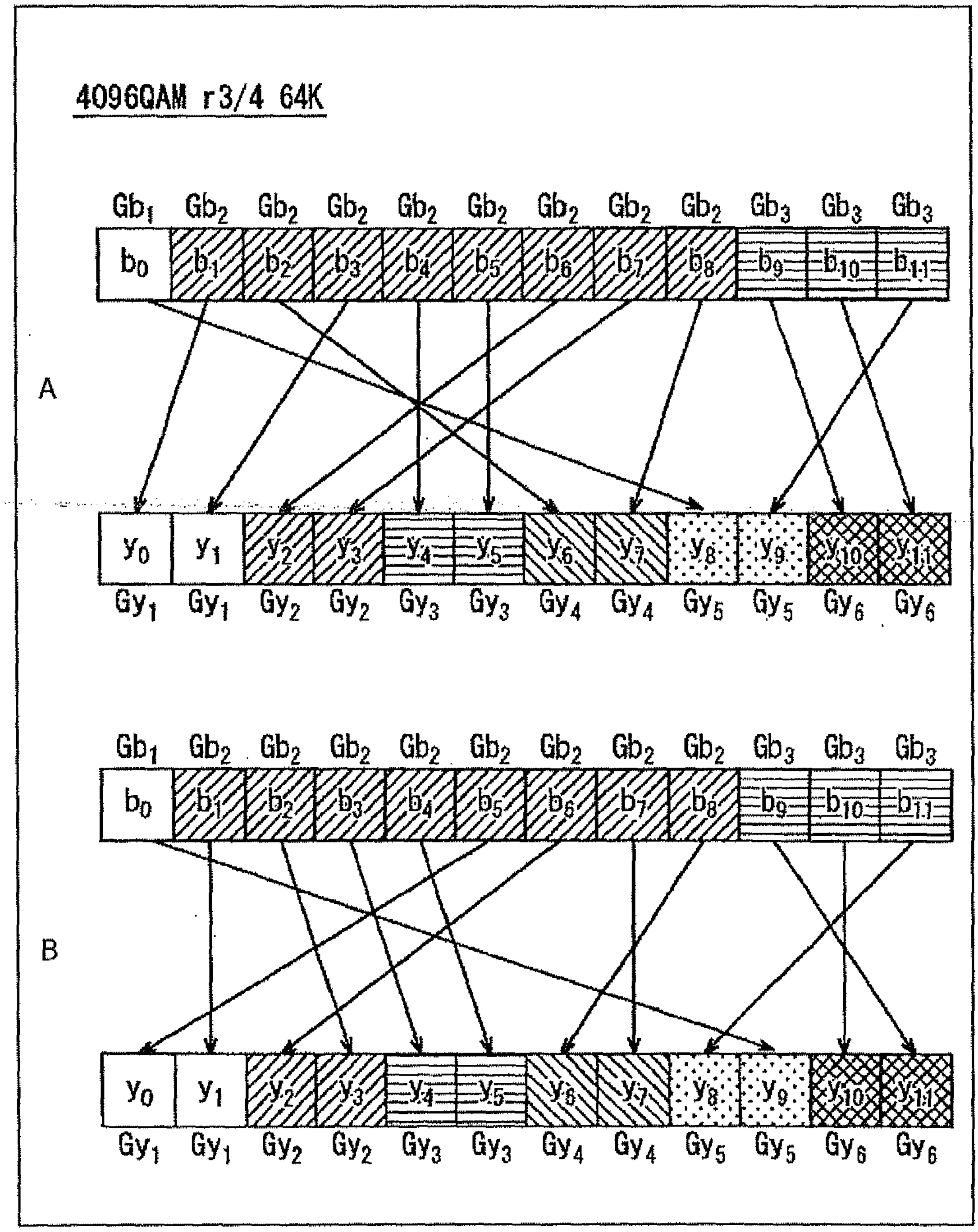
4096QAM r3/4 64K
A
Gb1 Gb2 Gb2 Gb2 Gb2 Gb2 Gb2 Gb2 Gb2 Gb3 Gb3 Gb3
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6
B
Gb1 Gb2 Gb2 Gb2 Gb2 Gb2 Gb2 Gb2 Gb2 Gb3 Gb3 Gb3
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.107

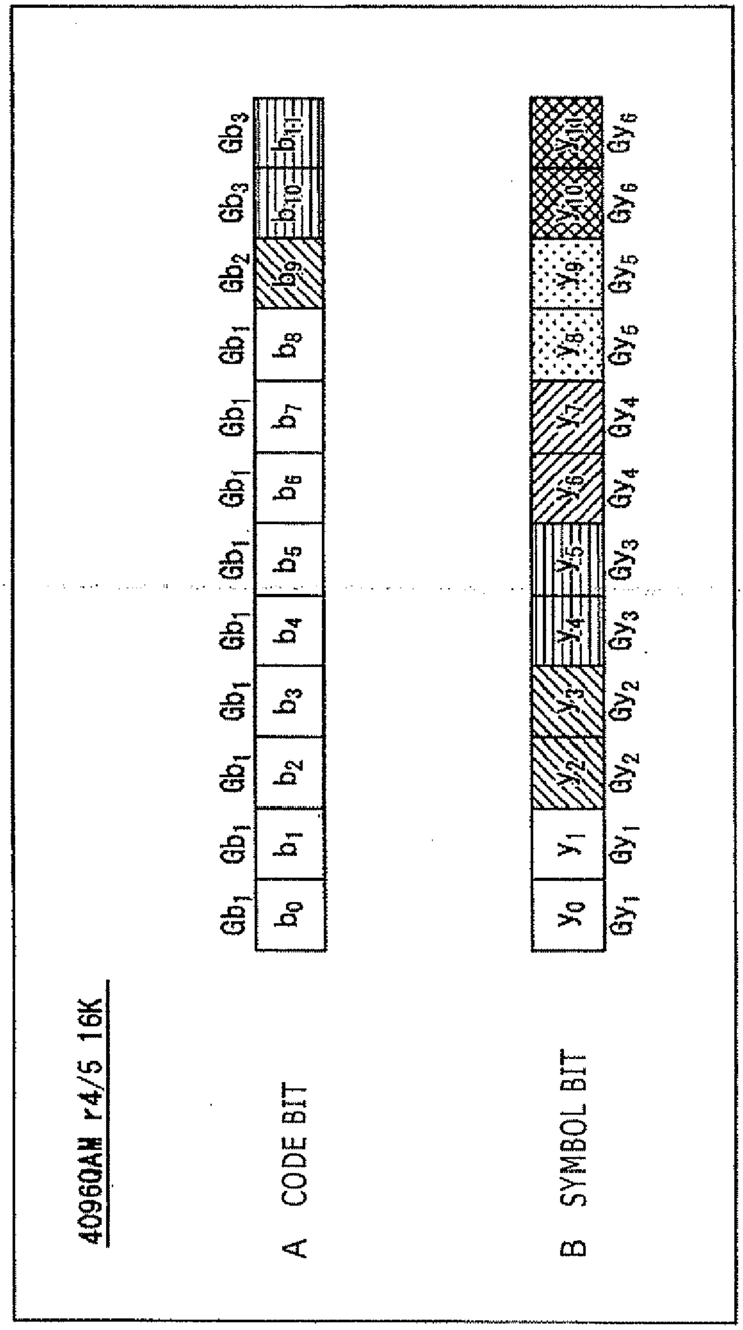
4096QAM r4/5 16K
A CODE BIT
b0 b1 b2 b3 b4 b5 b6 b7 b8 b9 b10 b11
Gb1 Gb1 Gb1 Gb1 Gb1 Gb1 Gb1 Gb1 Gb1 Gb2 Gb3 Gb3
B SYMBOL BIT
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

# FIG.108

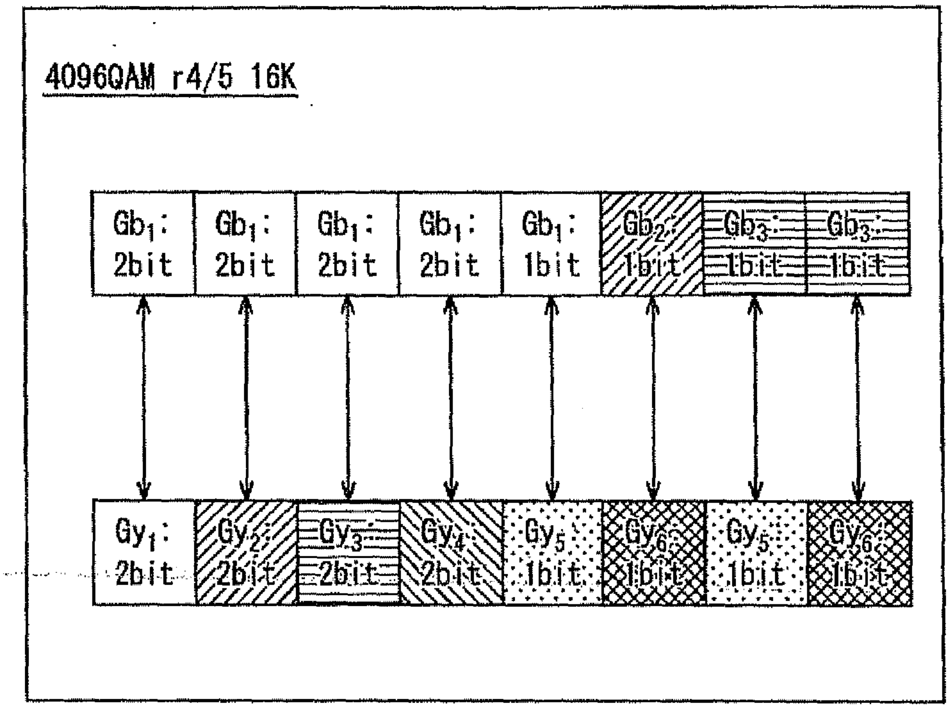
4096QAM r4/5 16K
Gb1: 2bit
Gb1: 2bit
Gb1: 2bit
Gb1: 2bit
Gb1: 1bit
Gb2: 1bit
Gb3: 1bit
Gb3: 1bit
Gy1: 2bit
Gy2: 2bit
Gy3: 2bit
Gy4: 2bit
Gy5: 1bit
Gy6: 1bit
Gy5: 1bit
Gy6: 1bit

FIG.109

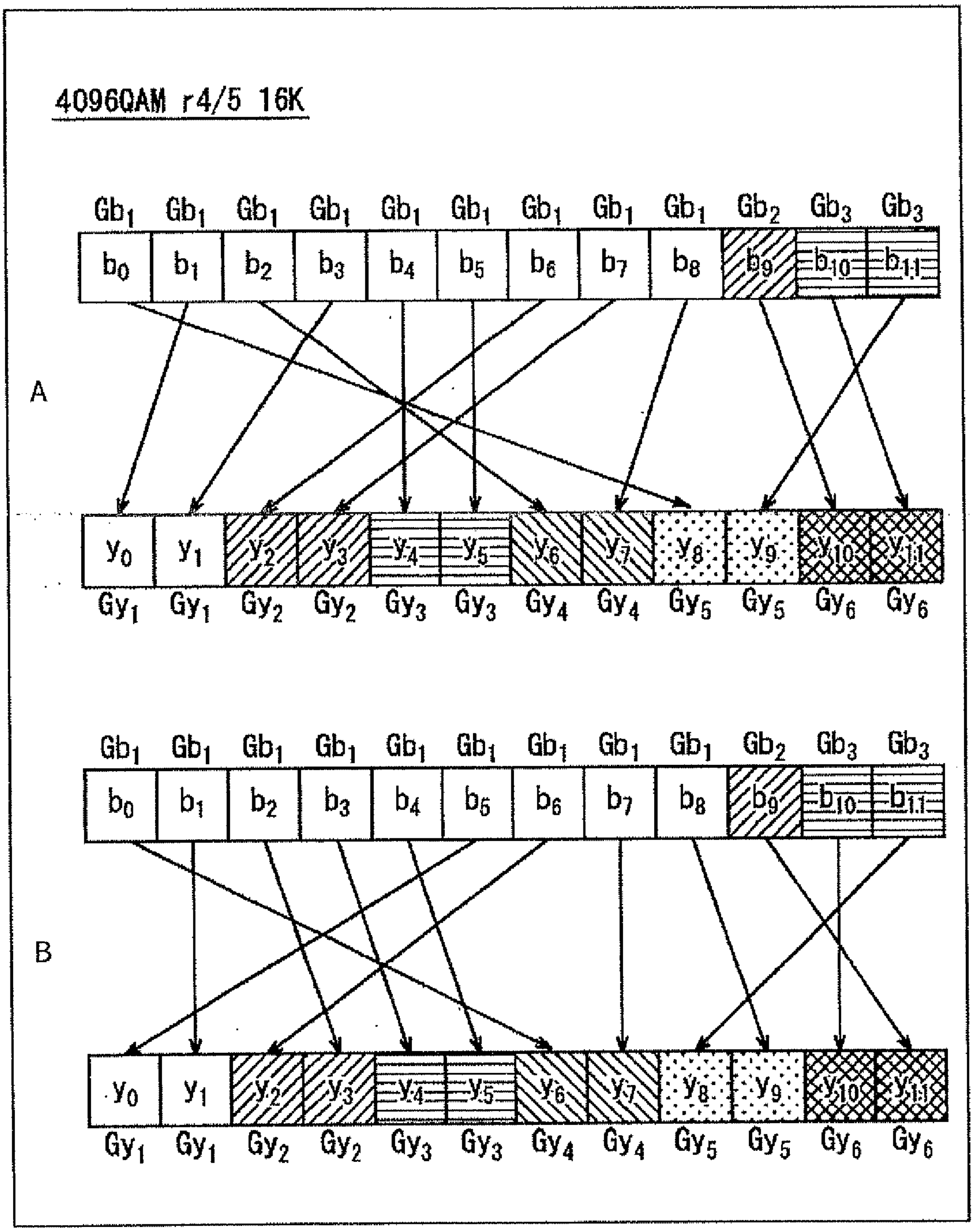
4096QAM r4/5 16K
A
Gb1 Gb1 Gb1 Gb1 Gb1 Gb1 Gb1 Gb1 Gb1 Gb2 Gb3 Gb3
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6
B
Gb1 Gb1 Gb1 Gb1 Gb1 Gb1 Gb1 Gb1 Gb1 Gb2 Gb3 Gb3
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.110

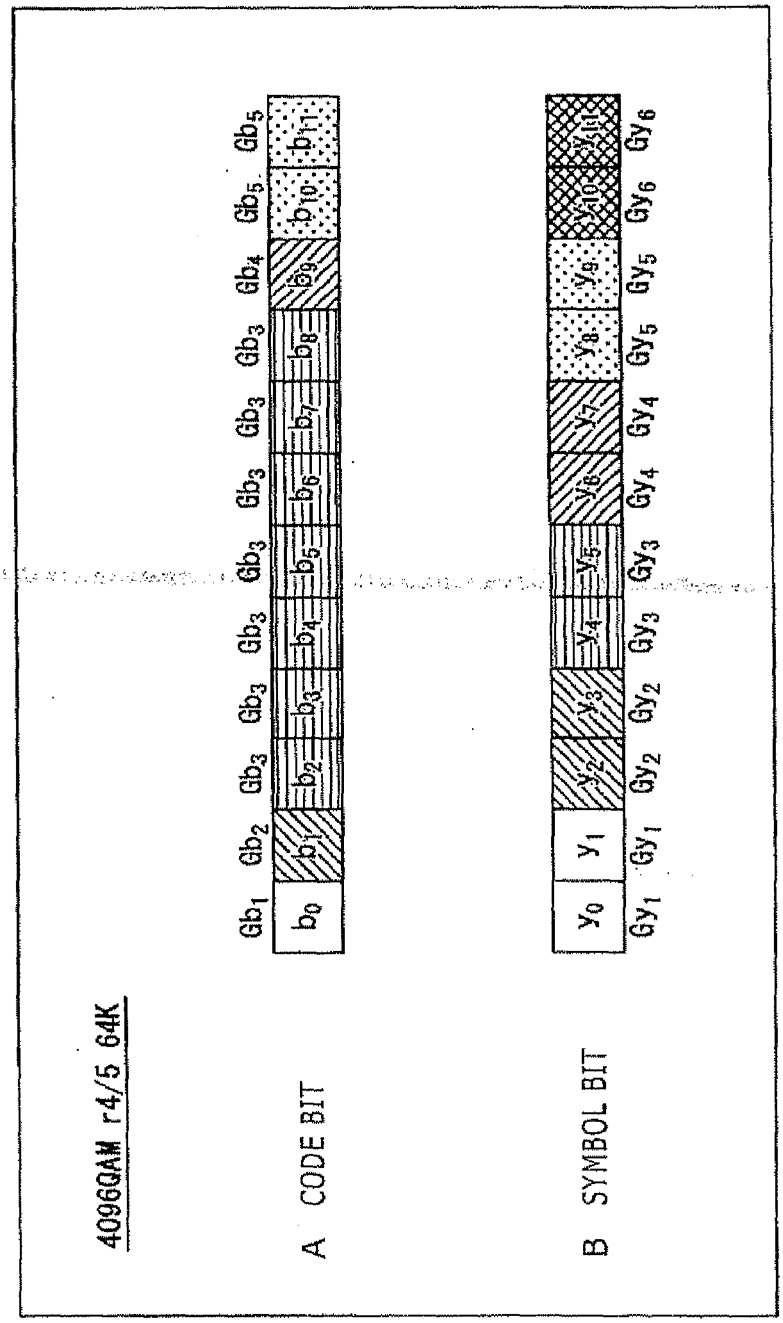
4096QAM r4/5 64K
A CODE BIT
Gb1 Gb2 Gb3 Gb3 Gb3 Gb3 Gb3 Gb3 Gb3 Gb4 Gb5 Gb5
b0 b1 b2 b3 b4 b5 b6 b7 b8 b9 b10 b11
B SYMBOL BIT
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.111

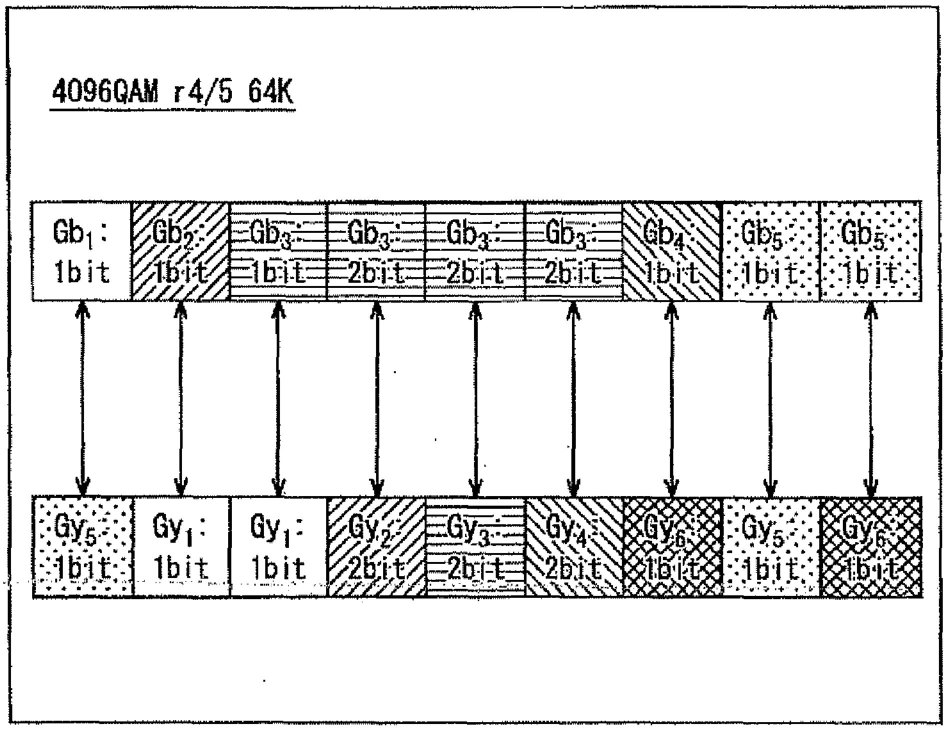
4096QAM r4/5 64K
Gb1: 1bit
Gb2: 1bit
Gb3: 1bit
Gb3: 2bit
Gb3: 2bit
Gb3: 2bit
Gb4: 1bit
Gb5: 1bit
Gb5: 1bit
Gy5: 1bit
Gy1: 1bit
Gy1: 1bit
Gy2: 2bit
Gy3: 2bit
Gy4: 2bit
Gy6: 1bit
Gy5: 1bit
Gy6: 1bit

# FIG. 112

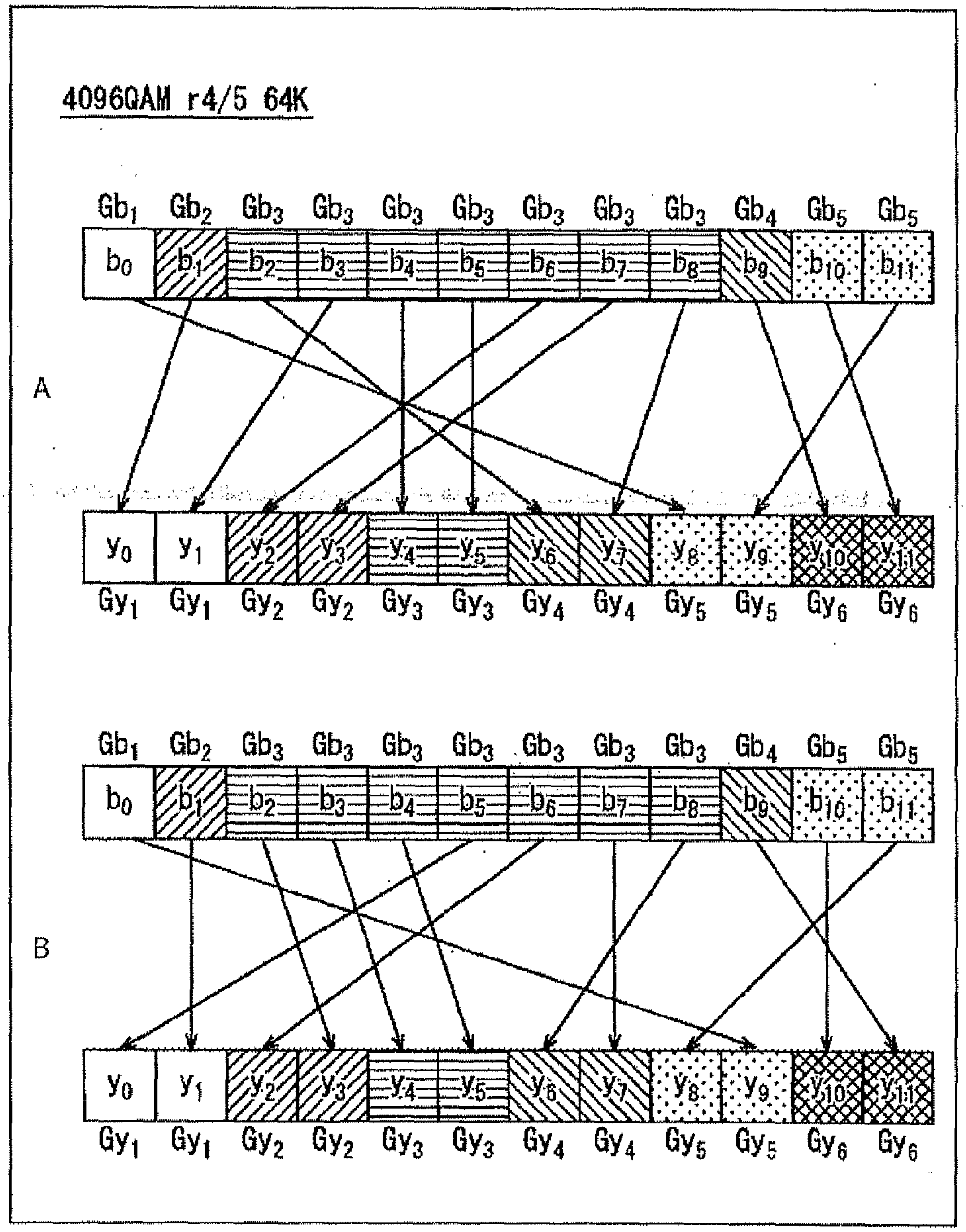
4096QAM r4/5 64K
A
Gb1 Gb2 Gb3 Gb3 Gb3 Gb3 Gb3 Gb3 Gb3 Gb4 Gb5 Gb5
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6
B
Gb1 Gb2 Gb3 Gb3 Gb3 Gb3 Gb3 Gb3 Gb3 Gb4 Gb5 Gb5
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.113

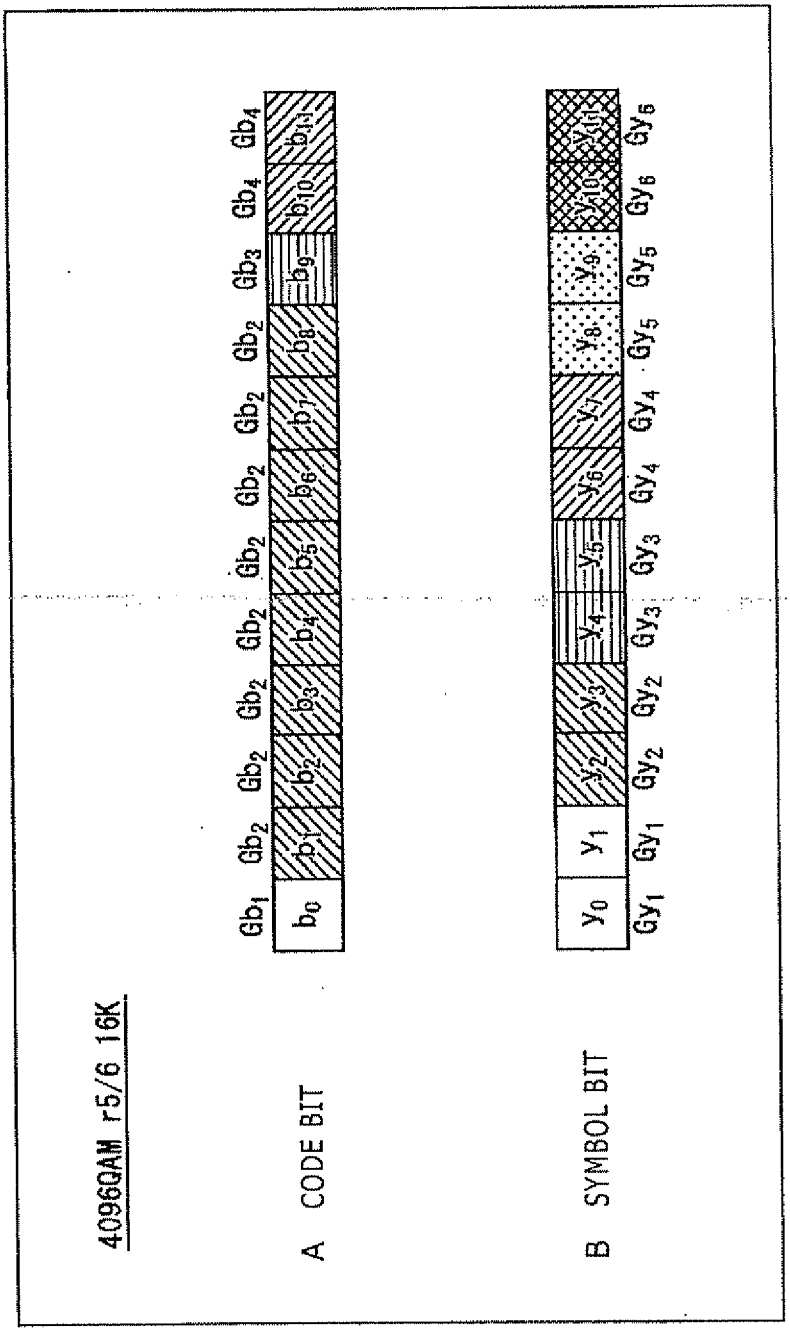
4096QAM r5/6 16K
A CODE BIT
B SYMBOL BIT
Gb1 Gb2 Gb2 Gb2 Gb2 Gb2 Gb2 Gb2 Gb2 Gb3 Gb4 Gb4
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.114

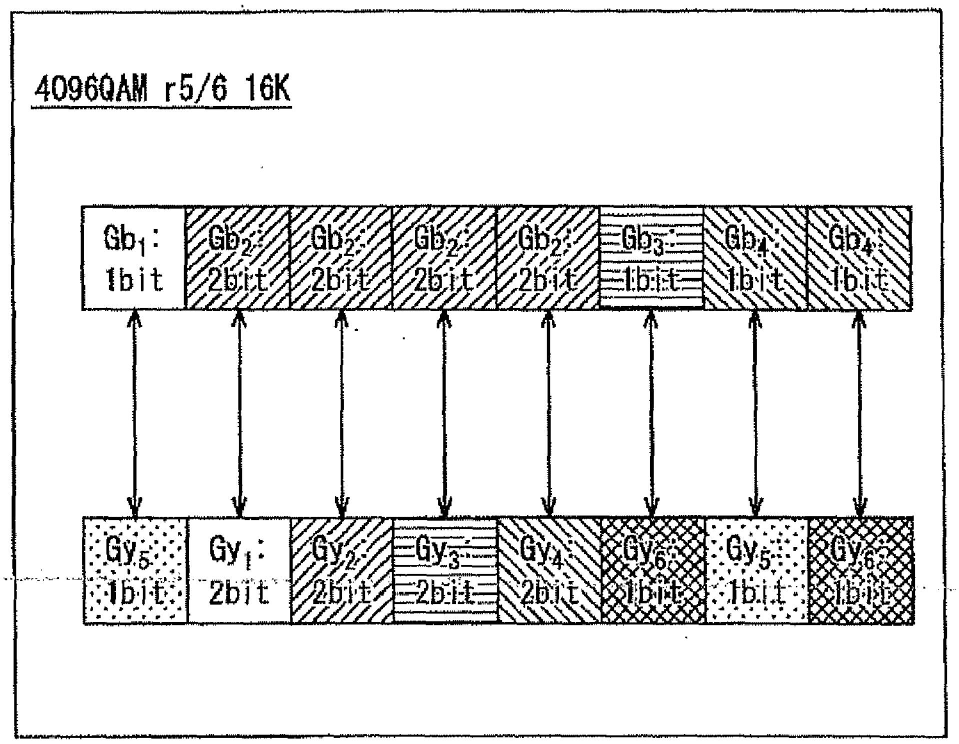
4096QAM r5/6 16K
Gb1: 1bit
Gb2: 2bit
Gb2: 2bit
Gb2: 2bit
Gb2: 2bit
Gb3: 1bit
Gb4: 1bit
Gb4: 1bit
Gy5: 1bit
Gy1: 2bit
Gy2: 2bit
Gy3: 2bit
Gy4: 2bit
Gy6: 1bit
Gy5: 1bit
Gy6: 1bit

# FIG.115

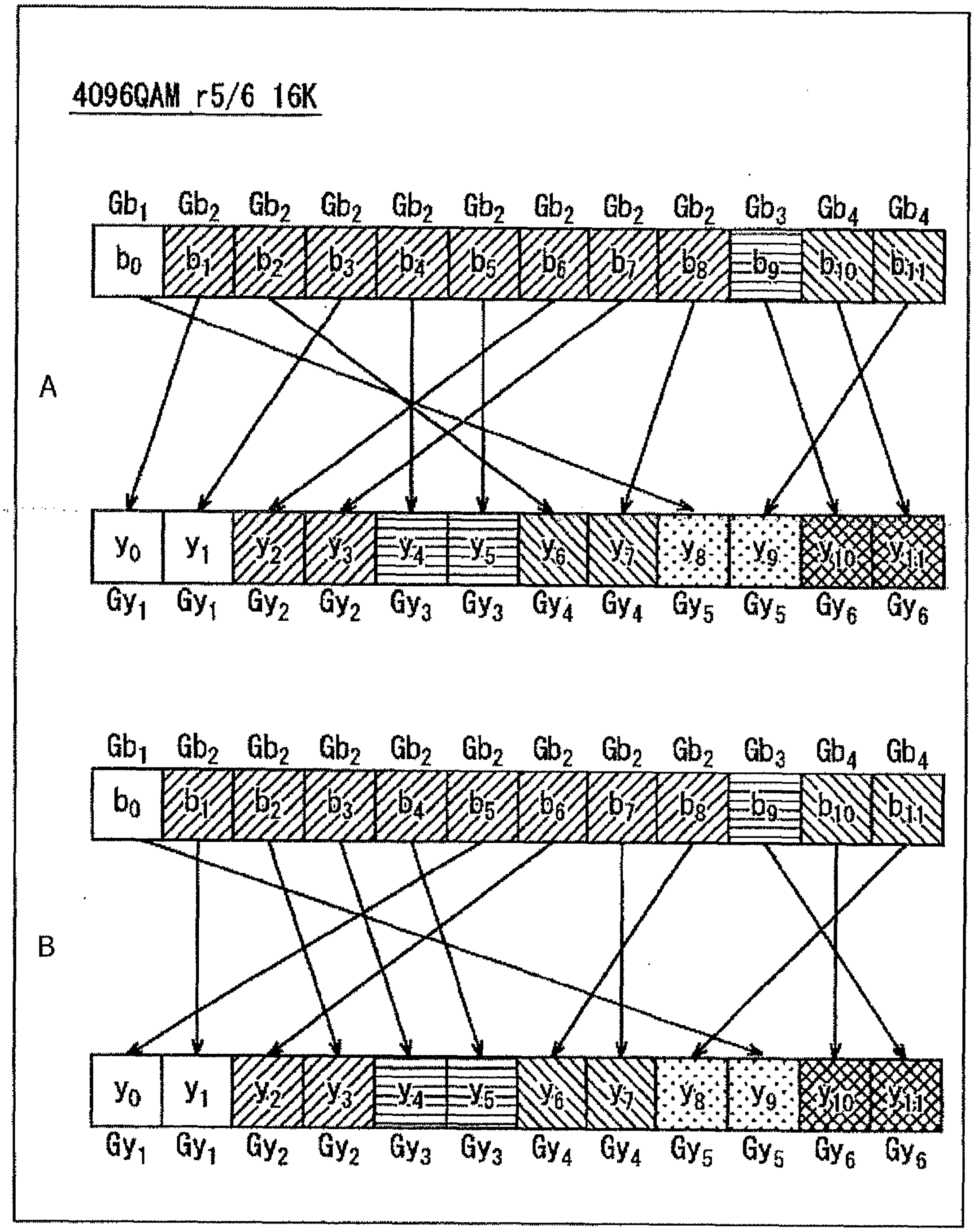
4096QAM r5/6 16K
A
Gb1 Gb2 Gb2 Gb2 Gb2 Gb2 Gb2 Gb2 Gb2 Gb3 Gb4 Gb4
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6
B
Gb1 Gb2 Gb2 Gb2 Gb2 Gb2 Gb2 Gb2 Gb2 Gb3 Gb4 Gb4
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.116

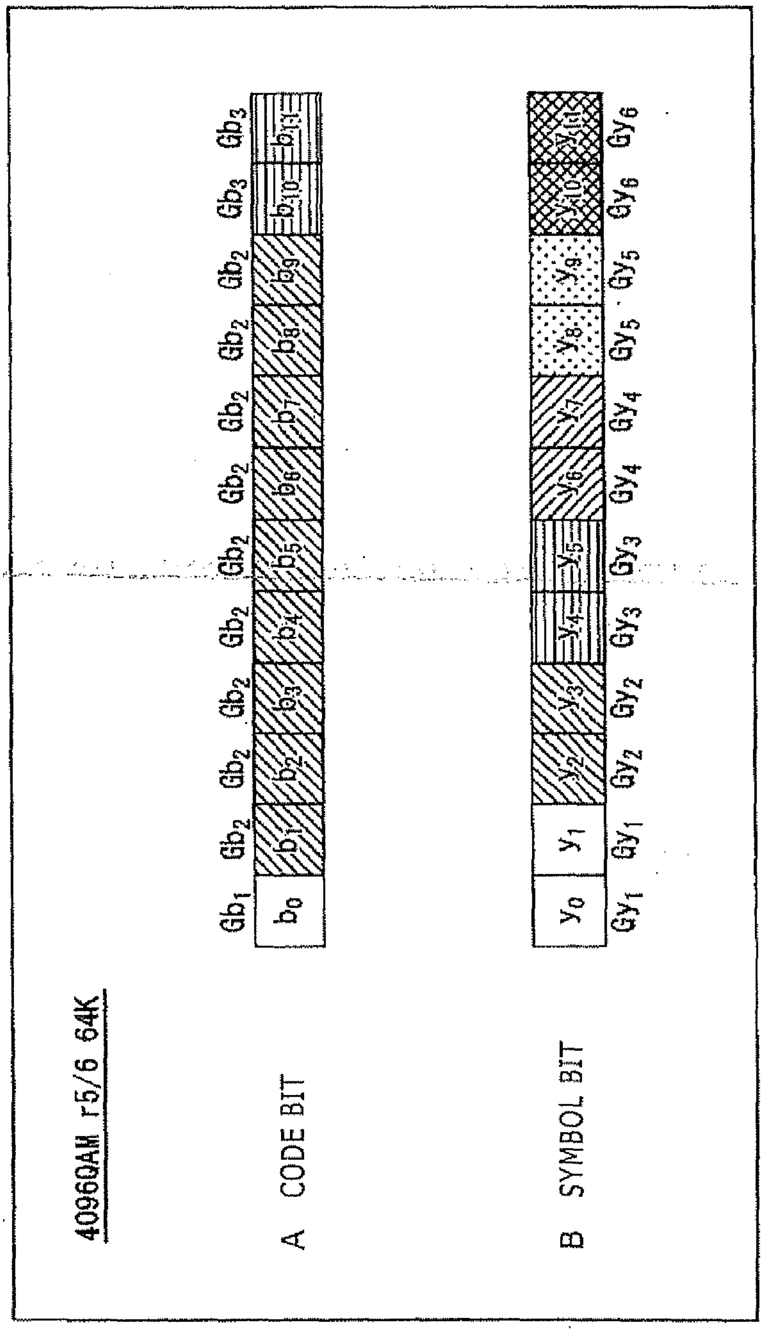
4096QAM r5/6 64K
A CODE BIT
$Gb_1$ $Gb_2$ $Gb_2$ $Gb_2$ $Gb_2$ $Gb_2$ $Gb_2$ $Gb_2$ $Gb_2$ $Gb_2$ $Gb_3$ $Gb_3$
$b_0$ $b_1$ $b_2$ $b_3$ $b_4$ $b_5$ $b_6$ $b_7$ $b_8$ $b_9$ $b_{10}$ $b_{11}$
B SYMBOL BIT
$y_0$ $y_1$ $y_2$ $y_3$ $y_4$ $y_5$ $y_6$ $y_7$ $y_8$ $y_9$ $y_{10}$ $y_{11}$
$Gy_1$ $Gy_1$ $Gy_2$ $Gy_2$ $Gy_3$ $Gy_3$ $Gy_4$ $Gy_4$ $Gy_5$ $Gy_5$ $Gy_6$ $Gy_6$

FIG.117

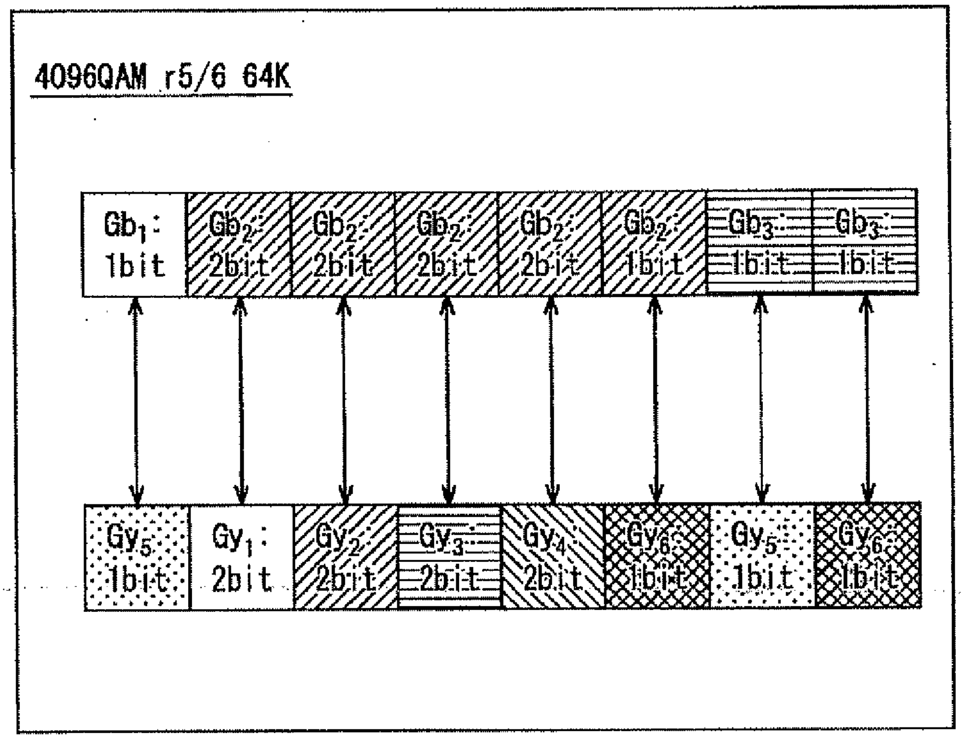
4096QAM r5/6 64K
Gb1: 1bit
Gb2: 2bit
Gb2: 2bit
Gb2: 2bit
Gb2: 2bit
Gb2: 1bit
Gb3: 1bit
Gb3: 1bit
Gy5: 1bit
Gy1: 2bit
Gy2: 2bit
Gy3: 2bit
Gy4: 2bit
Gy6: 1bit
Gy5: 1bit
Gy6: 1bit

# FIG.118

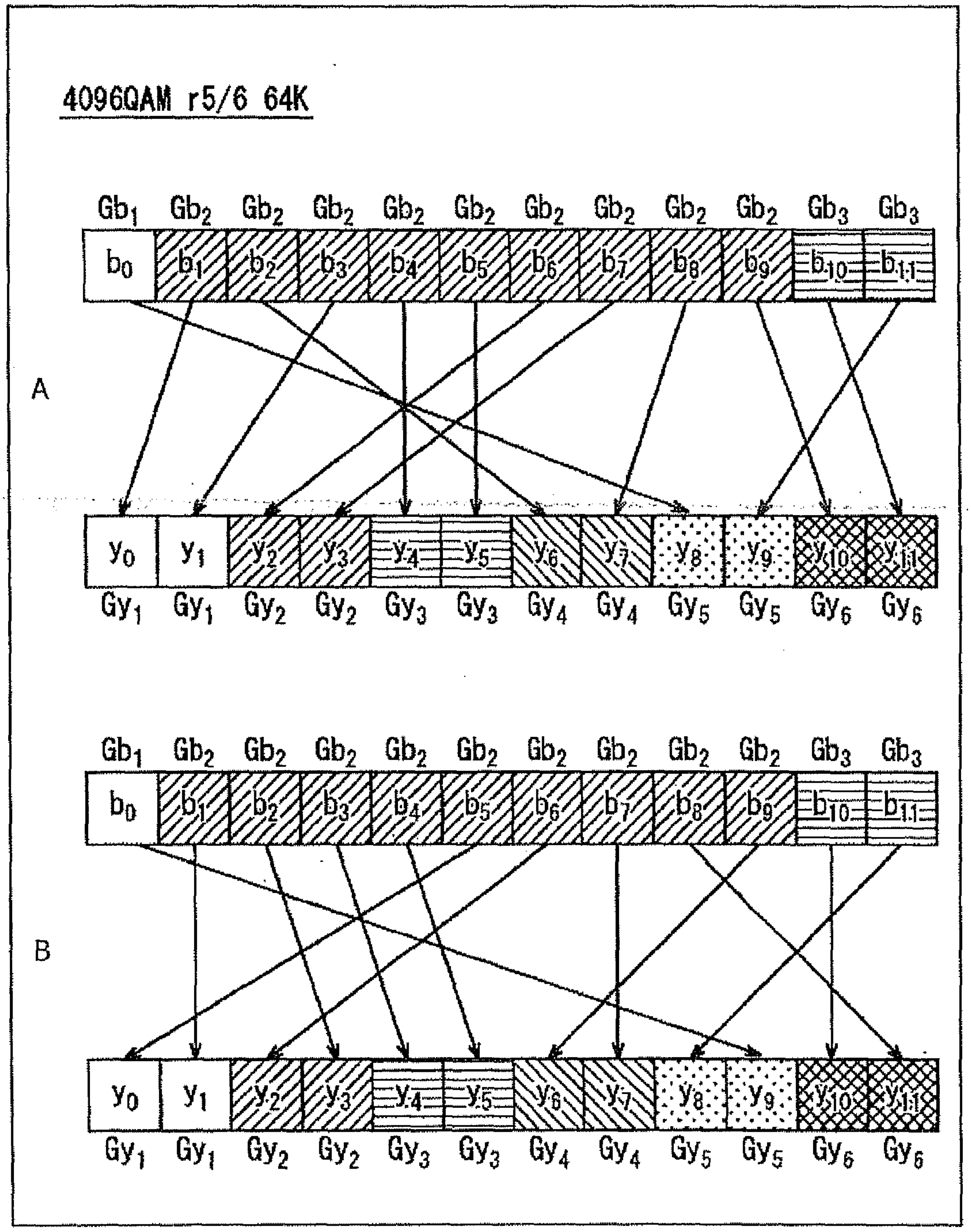
4096QAM r5/6 64K
A
Gb1 Gb2 Gb2 Gb2 Gb2 Gb2 Gb2 Gb2 Gb2 Gb2 Gb3 Gb3
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6
B
Gb1 Gb2 Gb2 Gb2 Gb2 Gb2 Gb2 Gb2 Gb2 Gb2 Gb3 Gb3
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.119

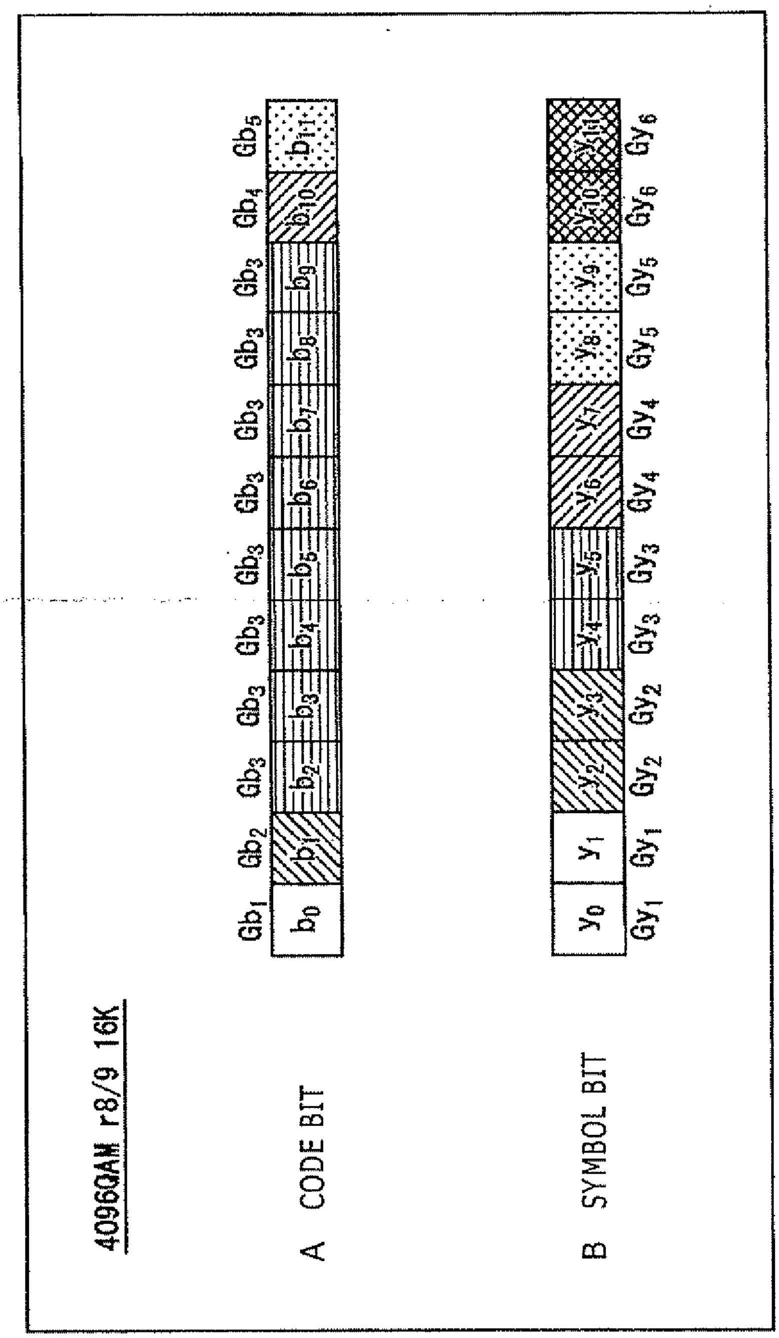
4096QAM r8/9 16K
A CODE BIT
Gb1 Gb2 Gb3 Gb3 Gb3 Gb3 Gb3 Gb3 Gb3 Gb3 Gb4 Gb5
b0 b1 b2 b3 b4 b5 b6 b7 b8 b9 b10 b11
B SYMBOL BIT
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.120

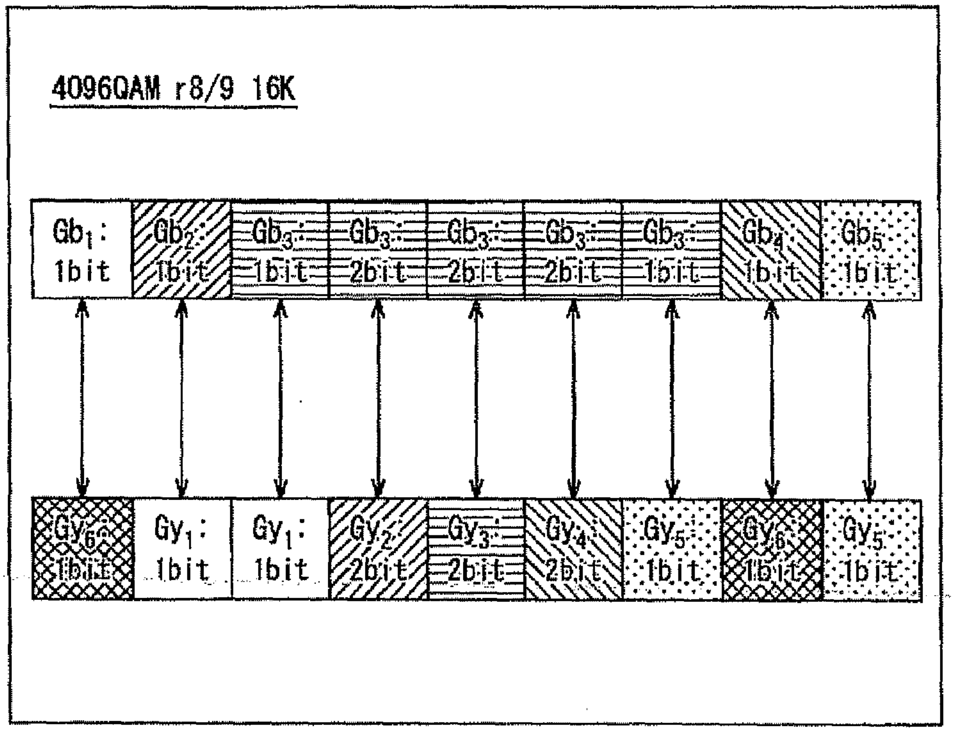
4096QAM r8/9 16K
Gb1: 1bit
Gb2: 1bit
Gb3: 1bit
Gb3: 2bit
Gb3: 2bit
Gb3: 2bit
Gb3: 1bit
Gb4: 1bit
Gb5: 1bit
Gy6: 1bit
Gy1: 1bit
Gy1: 1bit
Gy2: 2bit
Gy3: 2bit
Gy4: 2bit
Gy5: 1bit
Gy6: 1bit
Gy5: 1bit

FIG.121

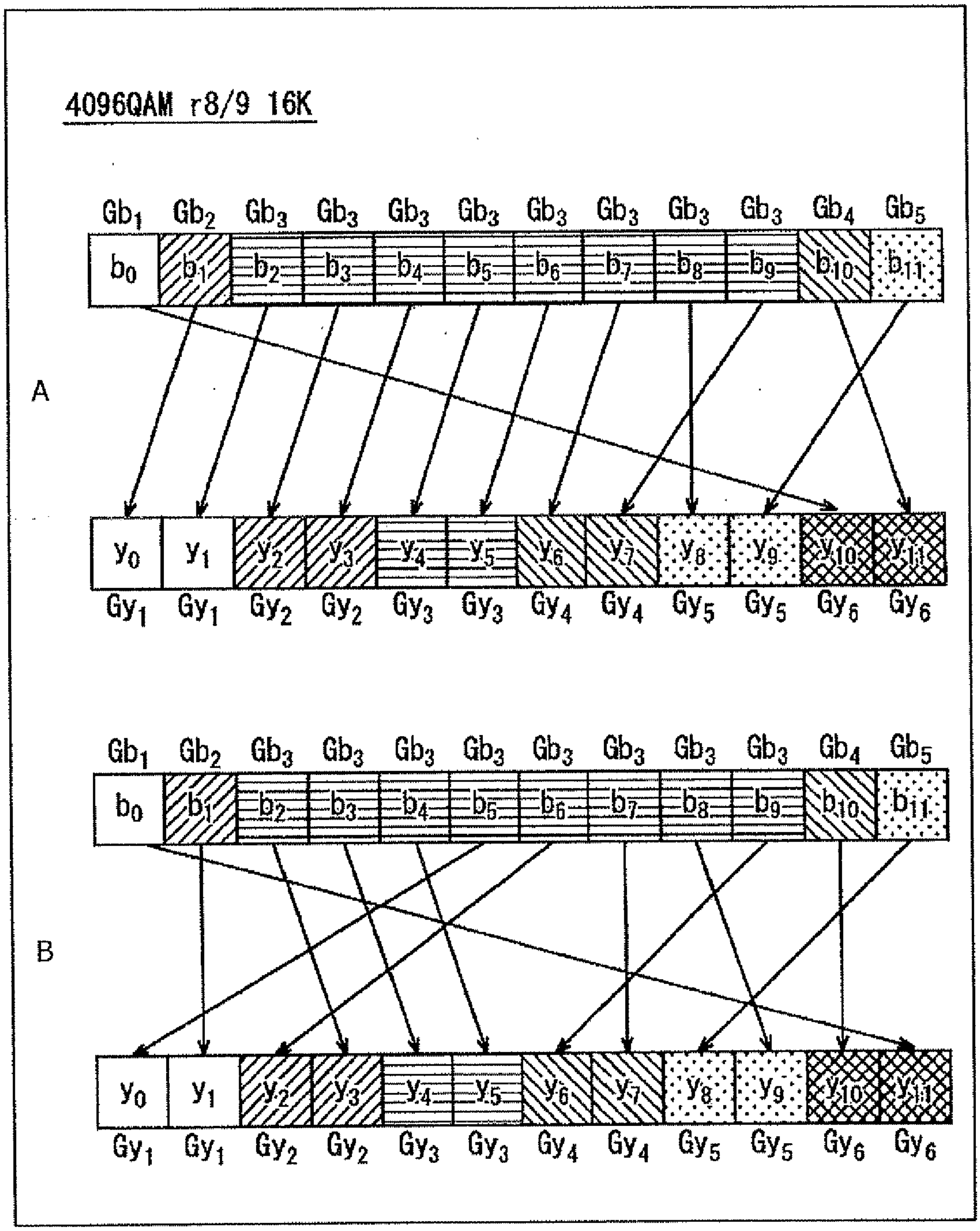
4096QAM r8/9 16K
A
Gb1 Gb2 Gb3 Gb3 Gb3 Gb3 Gb3 Gb3 Gb3 Gb3 Gb4 Gb5
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6
B
Gb1 Gb2 Gb3 Gb3 Gb3 Gb3 Gb3 Gb3 Gb3 Gb3 Gb4 Gb5
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG. 122

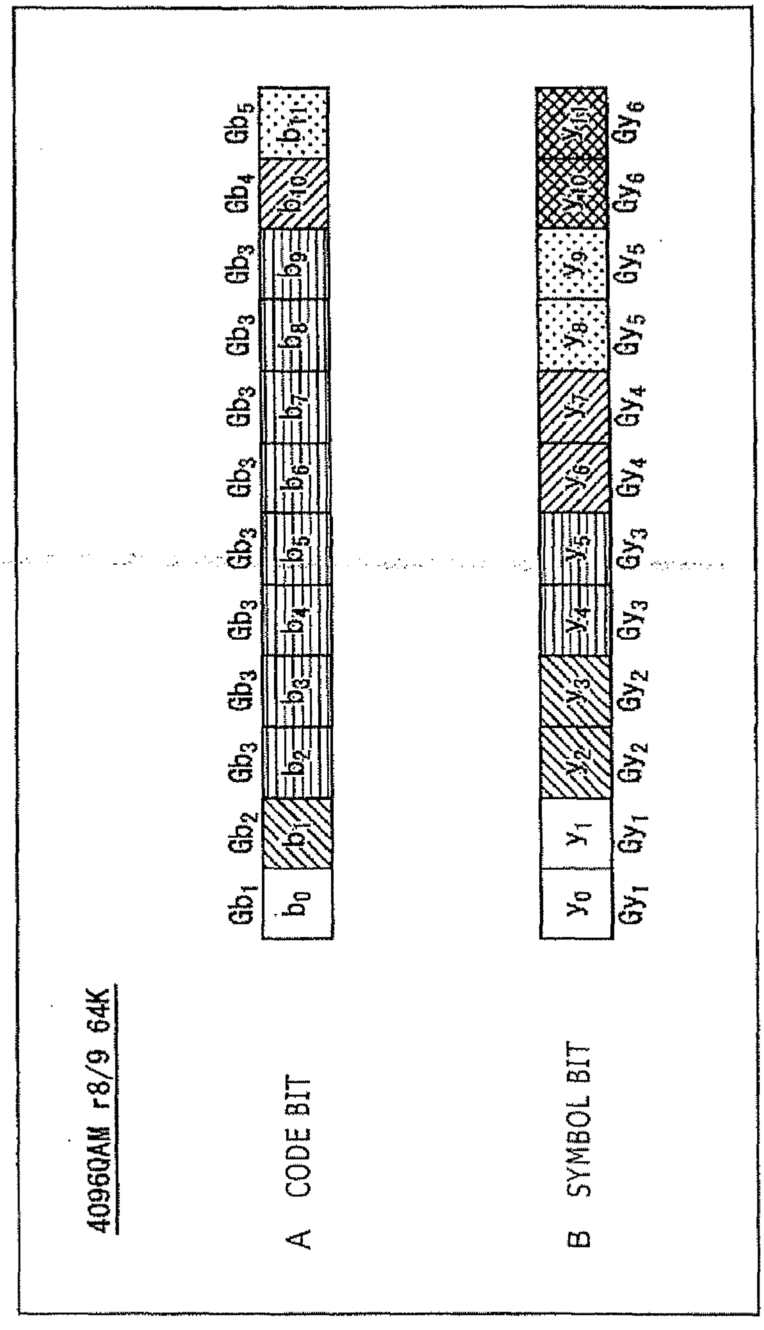
4096QAM r8/9 64K
A CODE BIT
Gb1 Gb2 Gb3 Gb3 Gb3 Gb3 Gb3 Gb3 Gb3 Gb3 Gb4 Gb5
b0 b1 b2 b3 b4 b5 b6 b7 b8 b9 b10 b11
B SYMBOL BIT
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.123

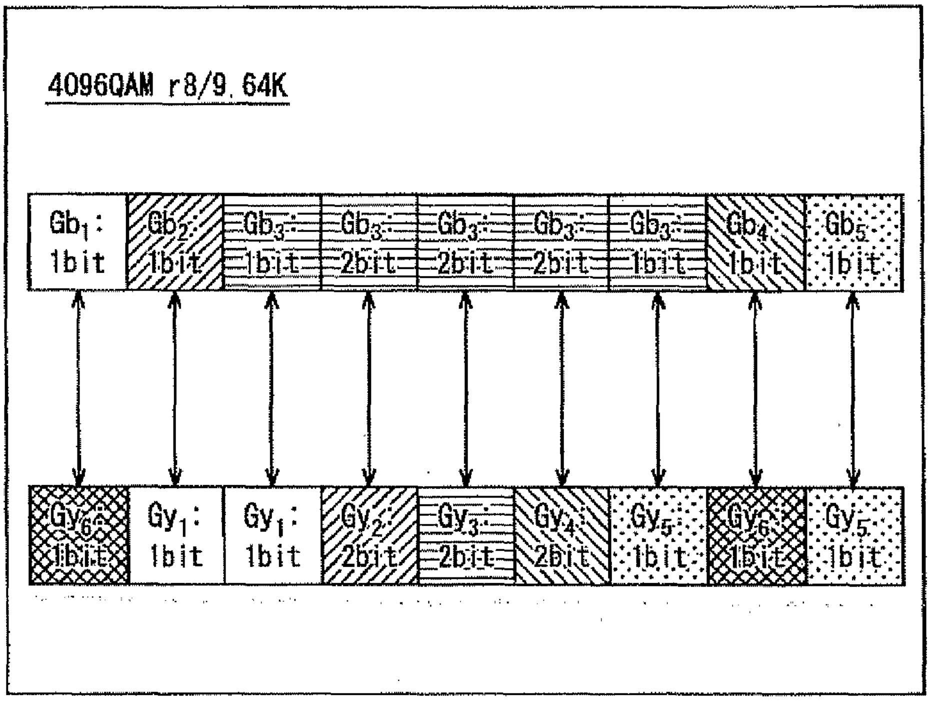
4096QAM r8/9, 64K
Gb1: 1bit
Gb2: 1bit
Gb3: 1bit
Gb3: 2bit
Gb3: 2bit
Gb3: 2bit
Gb3: 1bit
Gb4: 1bit
Gb5: 1bit
Gy6: 1bit
Gy1: 1bit
Gy1: 1bit
Gy2: 2bit
Gy3: 2bit
Gy4: 2bit
Gy5: 1bit
Gy6: 1bit
Gy5: 1bit

FIG.124

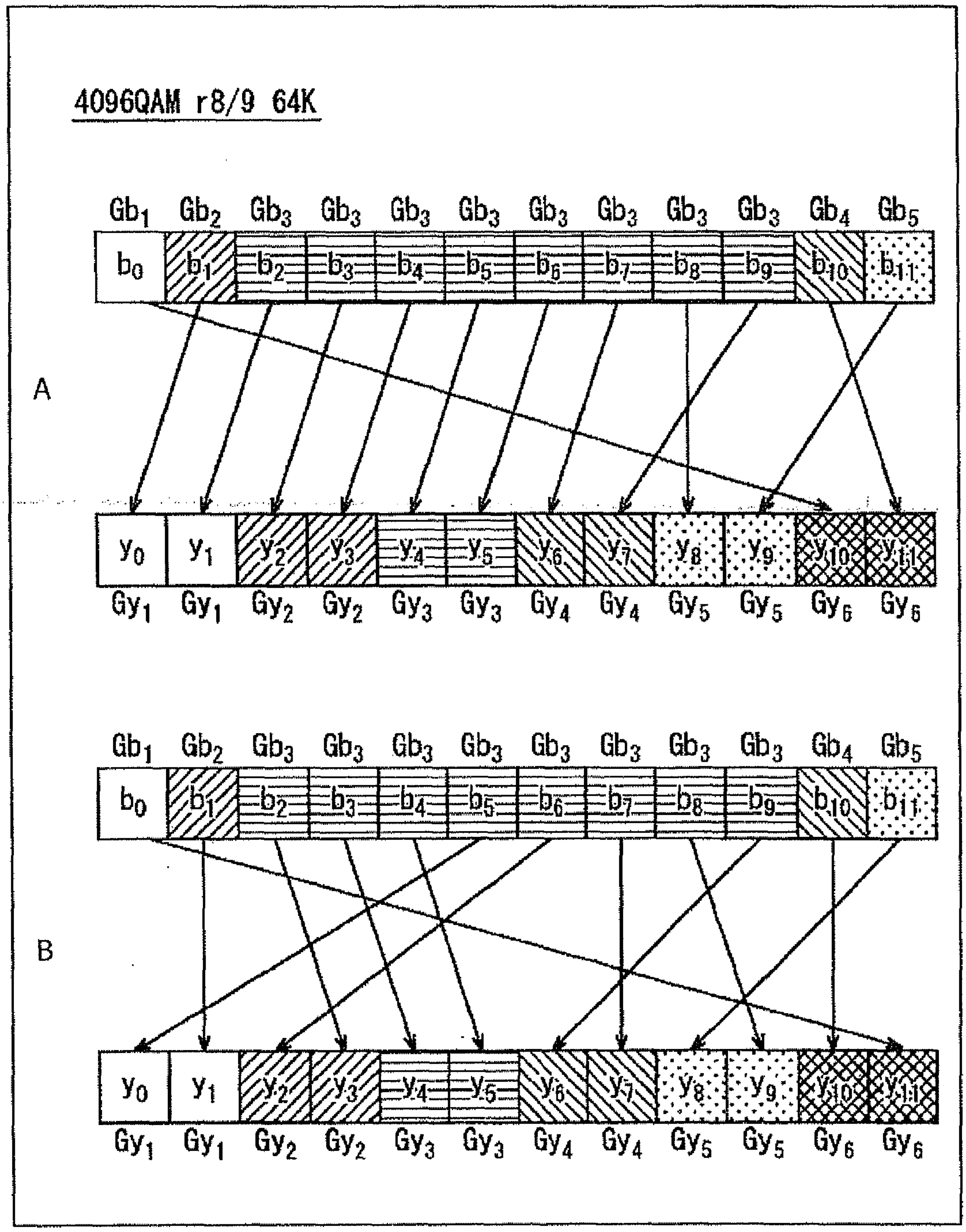
4096QAM r8/9 64K
A
Gb1 Gb2 Gb3 Gb3 Gb3 Gb3 Gb3 Gb3 Gb3 Gb3 Gb4 Gb5
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6
B
Gb1 Gb2 Gb3 Gb3 Gb3 Gb3 Gb3 Gb3 Gb3 Gb3 Gb4 Gb5
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.125

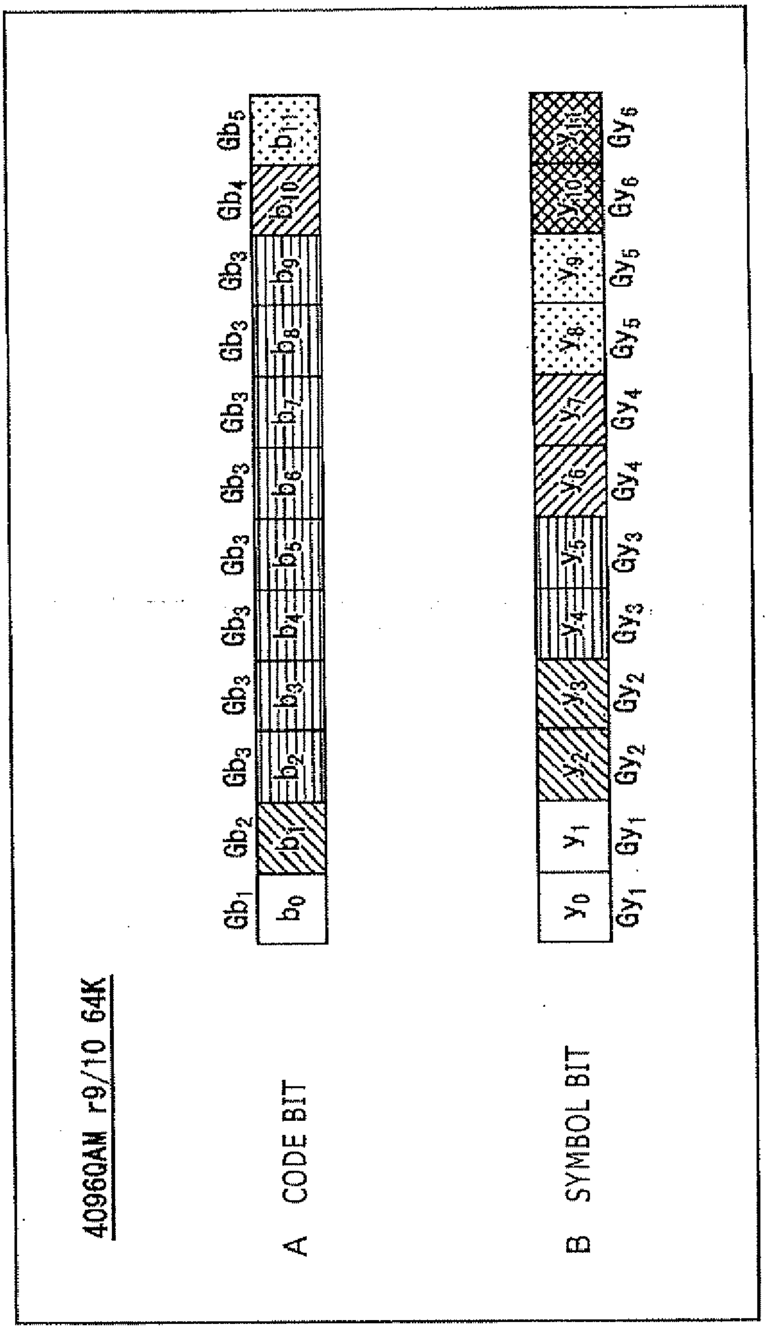
4096QAM r9/10 64K
A CODE BIT
B SYMBOL BIT
Gb1 Gb2 Gb3 Gb3 Gb3 Gb3 Gb3 Gb3 Gb3 Gb3 Gb4 Gb5
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.126

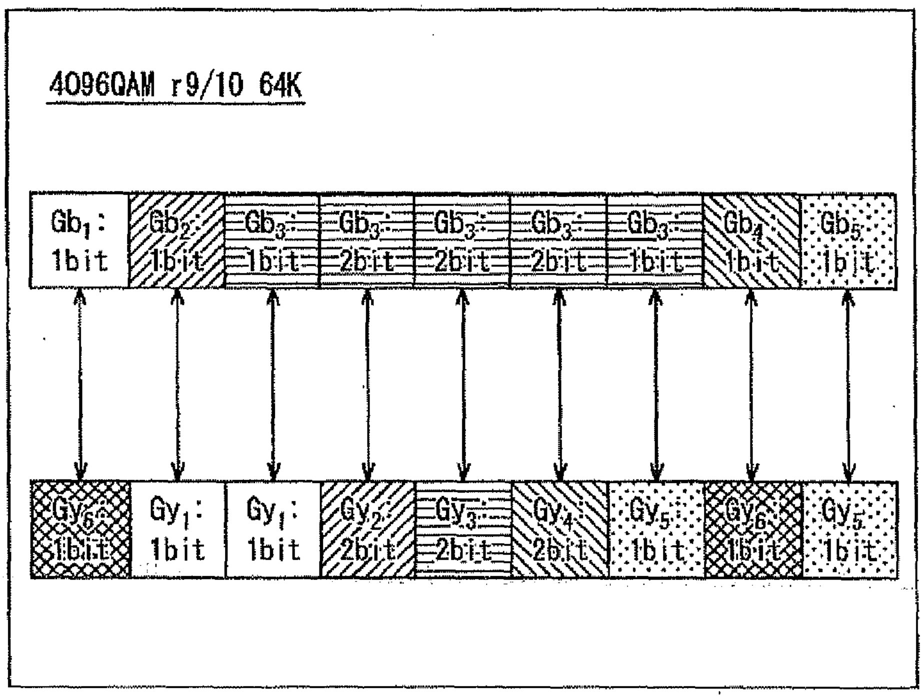
4096QAM r9/10 64K
Gb1: 1bit
Gb2: 1bit
Gb3: 1bit
Gb3: 2bit
Gb3: 2bit
Gb3: 2bit
Gb3: 1bit
Gb4: 1bit
Gb5: 1bit
Gy6: 1bit
Gy1: 1bit
Gy1: 1bit
Gy2: 2bit
Gy3: 2bit
Gy4: 2bit
Gy5: 1bit
Gy6: 1bit
Gy5: 1bit

FIG.127

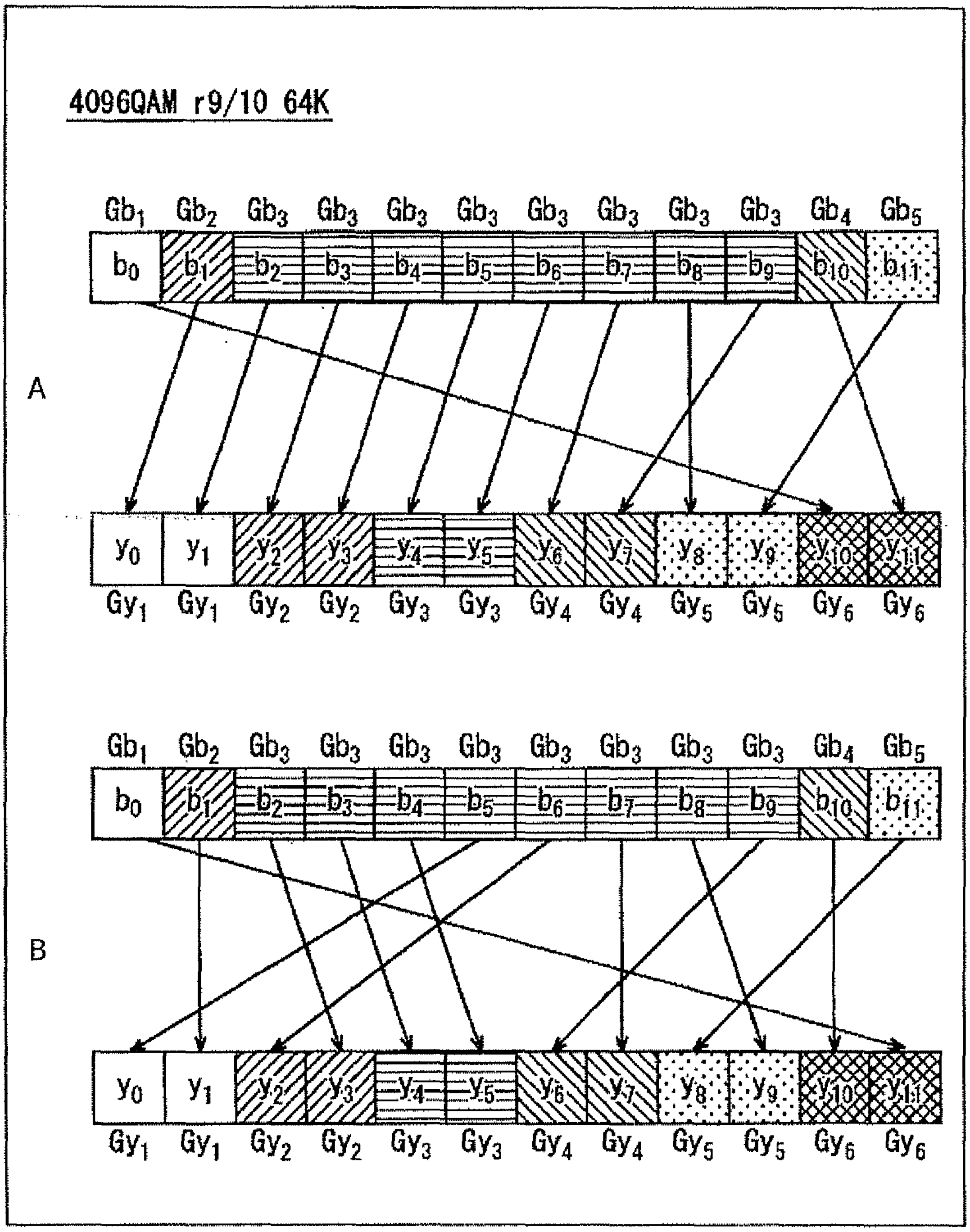
4096QAM r9/10 64K
A
Gb1 Gb2 Gb3 Gb3 Gb3 Gb3 Gb3 Gb3 Gb3 Gb3 Gb4 Gb5
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6
B
Gb1 Gb2 Gb3 Gb3 Gb3 Gb3 Gb3 Gb3 Gb3 Gb3 Gb4 Gb5
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.128

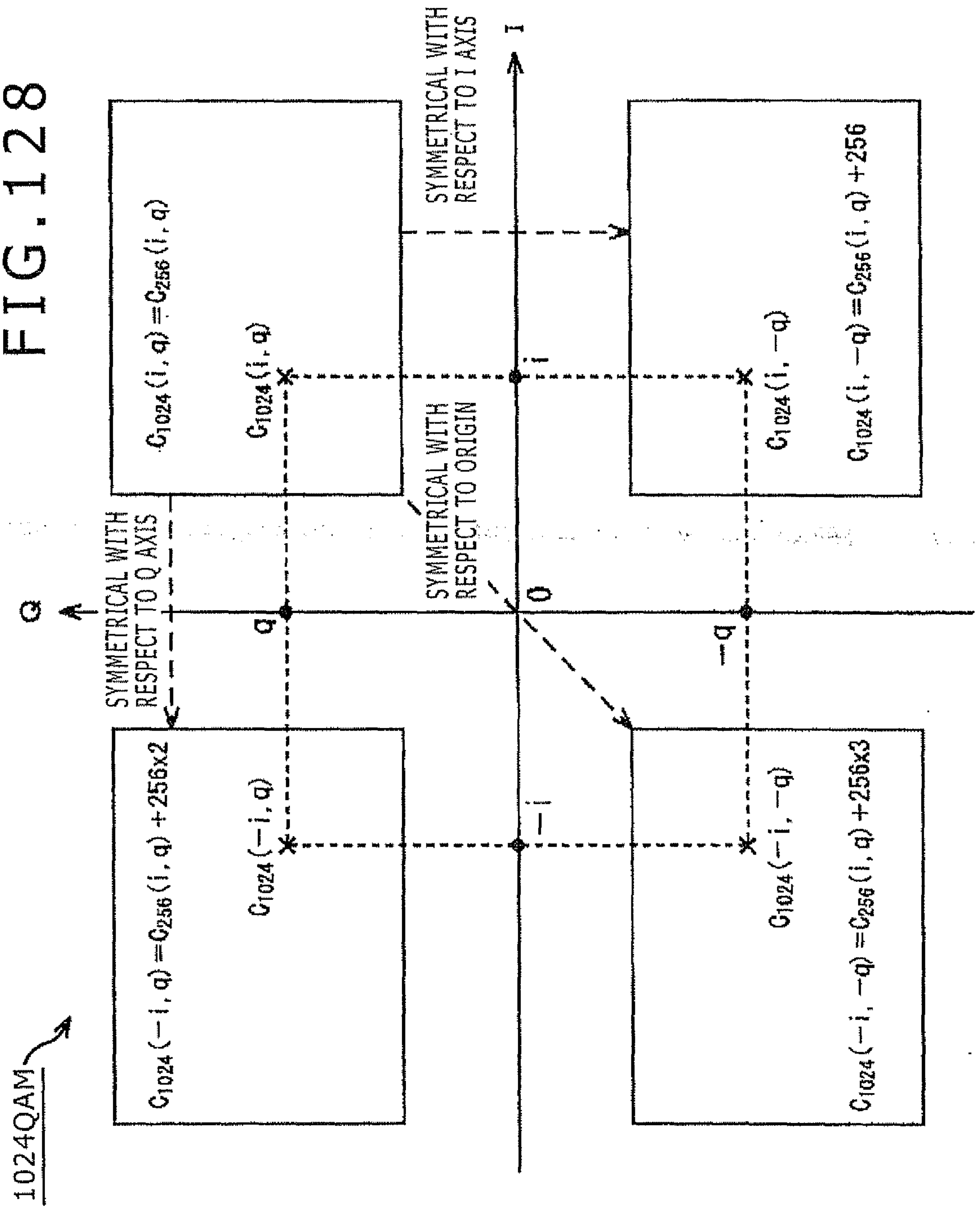
1024QAM
Q
I
0
q
-q
i
-i
SYMMETRICAL WITH RESPECT TO Q AXIS
SYMMETRICAL WITH RESPECT TO ORIGIN
SYMMETRICAL WITH RESPECT TO I AXIS
$C_{1024}(i, q) = C_{256}(i, q)$
$C_{1024}(i, q)$
$C_{1024}(i, -q)$
$C_{1024}(i, -q) = C_{256}(i, q) + 256$
$C_{1024}(-i, q) = C_{256}(i, q) + 256 \times 2$
$C_{1024}(-i, q)$
$C_{1024}(-i, -q)$
$C_{1024}(-i, -q) = C_{256}(i, q) + 256 \times 3$

# FIG.129

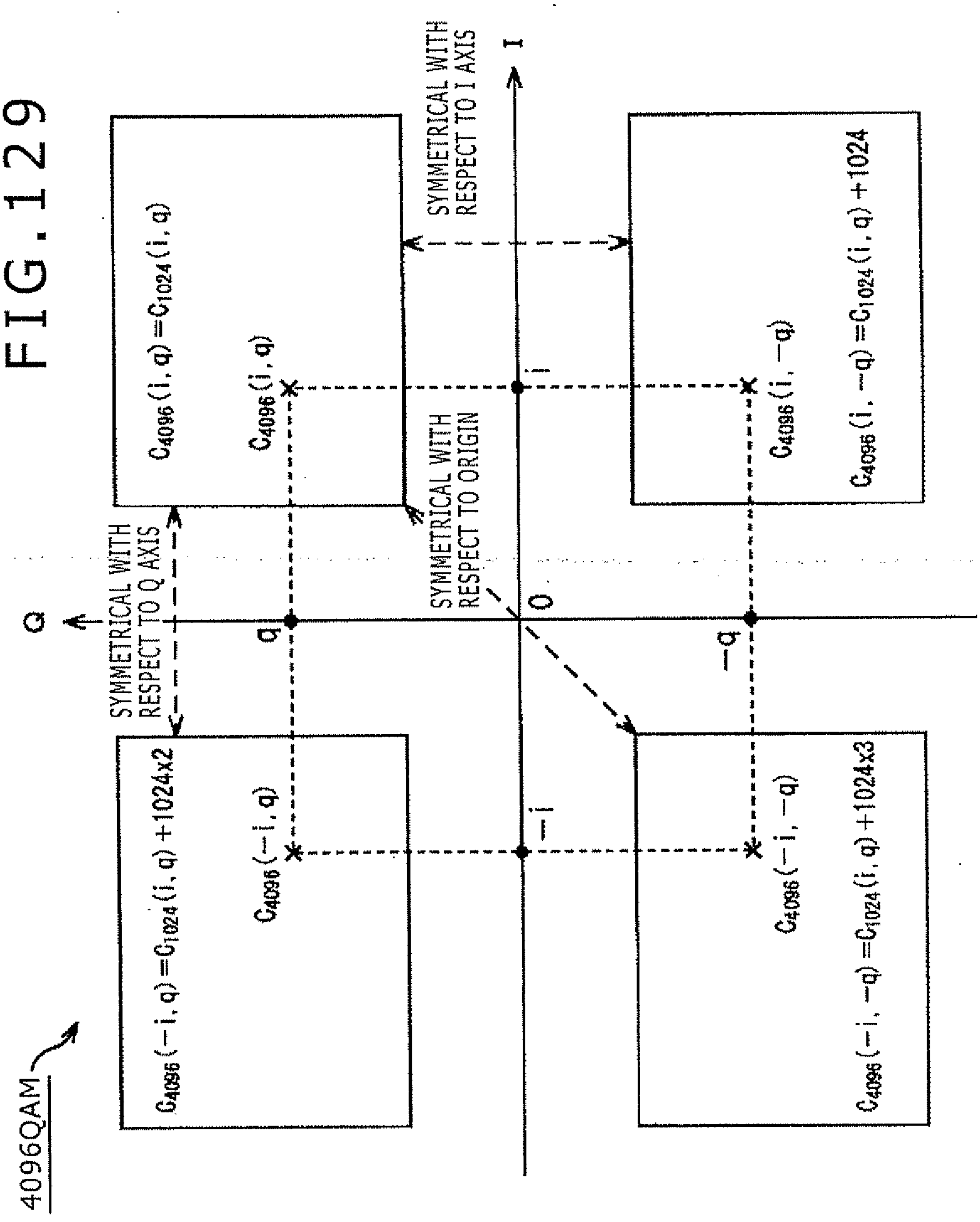
4096QAM
Q
I
O
q
−q
i
−i
SYMMETRICAL WITH RESPECT TO Q AXIS
SYMMETRICAL WITH RESPECT TO I AXIS
SYMMETRICAL WITH RESPECT TO ORIGIN
$C_{4096}$(i, q) = $C_{1024}$(i, q)
$C_{4096}$(i, q)
$C_{4096}$(−i, q) = $C_{1024}$(i, q) +1024x2
$C_{4096}$(−i, q)
$C_{4096}$(i, −q) = $C_{1024}$(i, q) +1024
$C_{4096}$(i, −q)
$C_{4096}$(−i, −q) = $C_{1024}$(i, q) +1024x3
$C_{4096}$(−i, −q)

FIG.130

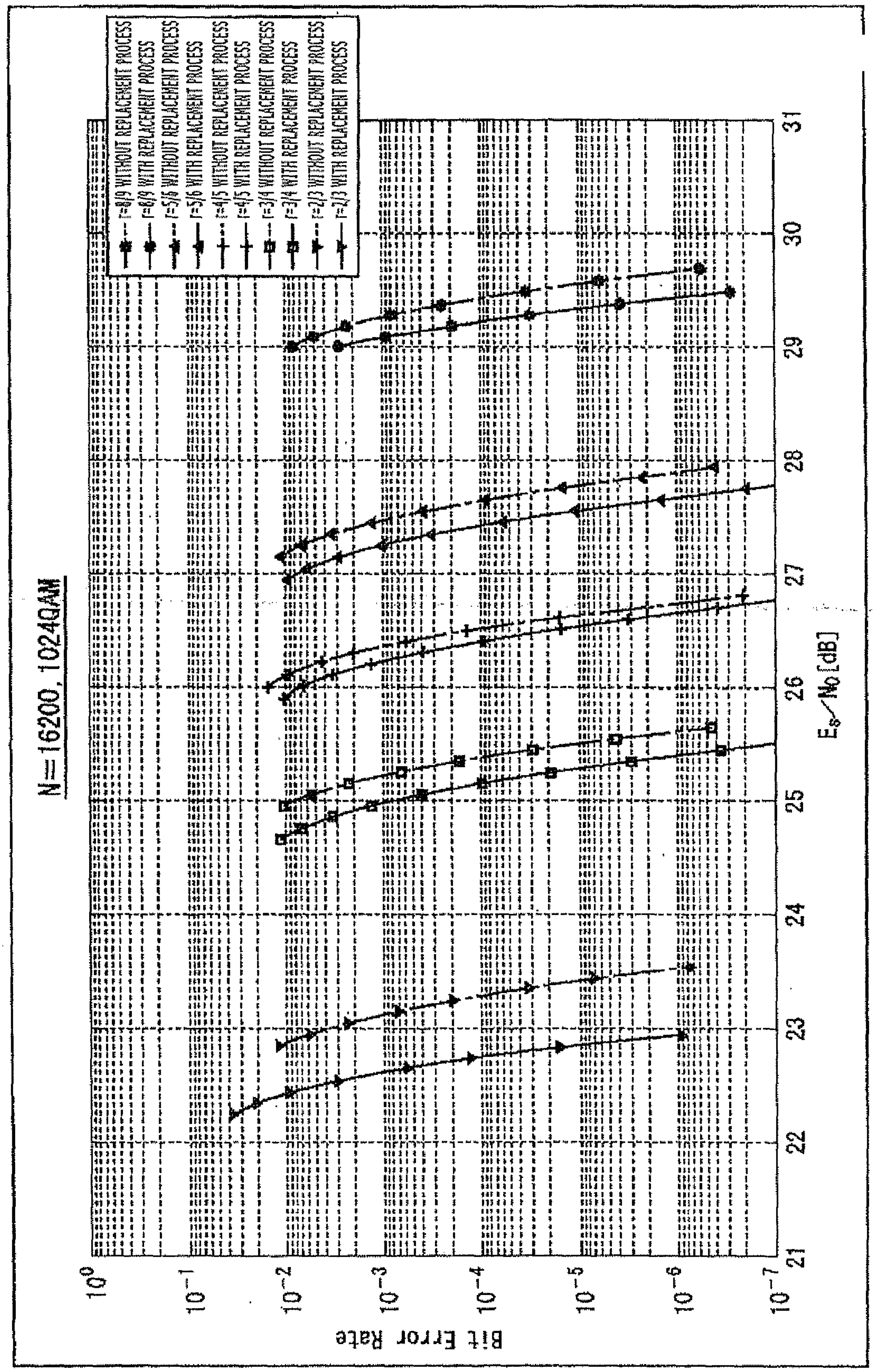
N=16200, 1024QAM
r=8/9 WITHOUT REPLACEMENT PROCESS
r=8/9 WITH REPLACEMENT PROCESS
r=5/6 WITHOUT REPLACEMENT PROCESS
r=5/6 WITH REPLACEMENT PROCESS
r=4/5 WITHOUT REPLACEMENT PROCESS
r=4/5 WITH REPLACEMENT PROCESS
r=3/4 WITHOUT REPLACEMENT PROCESS
r=3/4 WITH REPLACEMENT PROCESS
r=2/3 WITHOUT REPLACEMENT PROCESS
r=2/3 WITH REPLACEMENT PROCESS
Bit Error Rate
$10^0$
$10^{-1}$
$10^{-2}$
$10^{-3}$
$10^{-4}$
$10^{-5}$
$10^{-6}$
$10^{-7}$
21
22
23
24
25
26
27
28
29
30
31
$E_s/N_0$ [dB]

FIG. 131

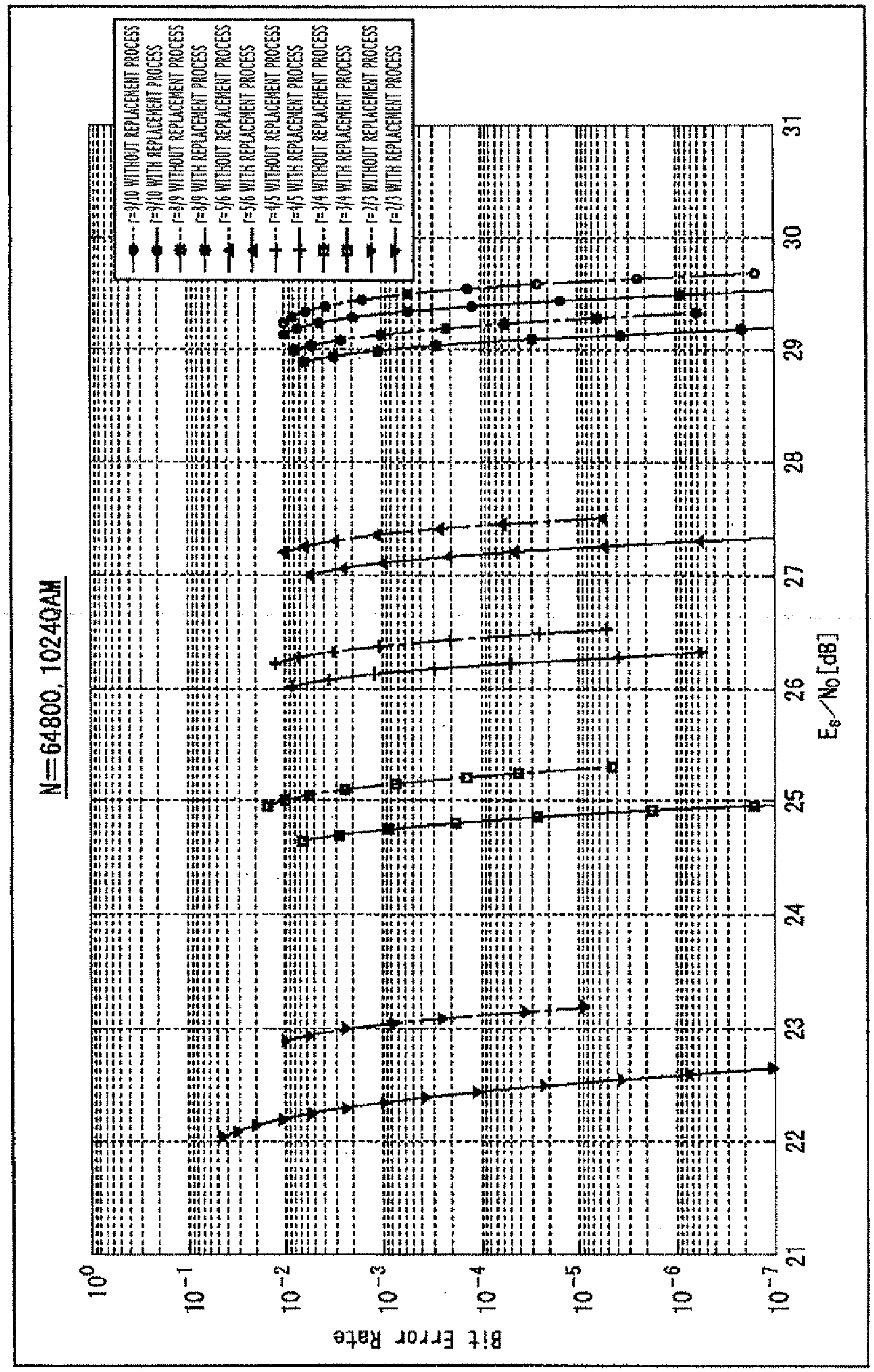
N=64800, 1024QAM
Bit Error Rate
$E_s/N_0$[dB]
r=9/10 WITHOUT REPLACEMENT PROCESS
r=9/10 WITH REPLACEMENT PROCESS
r=8/9 WITHOUT REPLACEMENT PROCESS
r=8/9 WITH REPLACEMENT PROCESS
r=5/6 WITHOUT REPLACEMENT PROCESS
r=5/6 WITH REPLACEMENT PROCESS
r=4/5 WITHOUT REPLACEMENT PROCESS
r=4/5 WITH REPLACEMENT PROCESS
r=3/4 WITHOUT REPLACEMENT PROCESS
r=3/4 WITH REPLACEMENT PROCESS
r=2/3 WITHOUT REPLACEMENT PROCESS
r=2/3 WITH REPLACEMENT PROCESS

FIG. 132

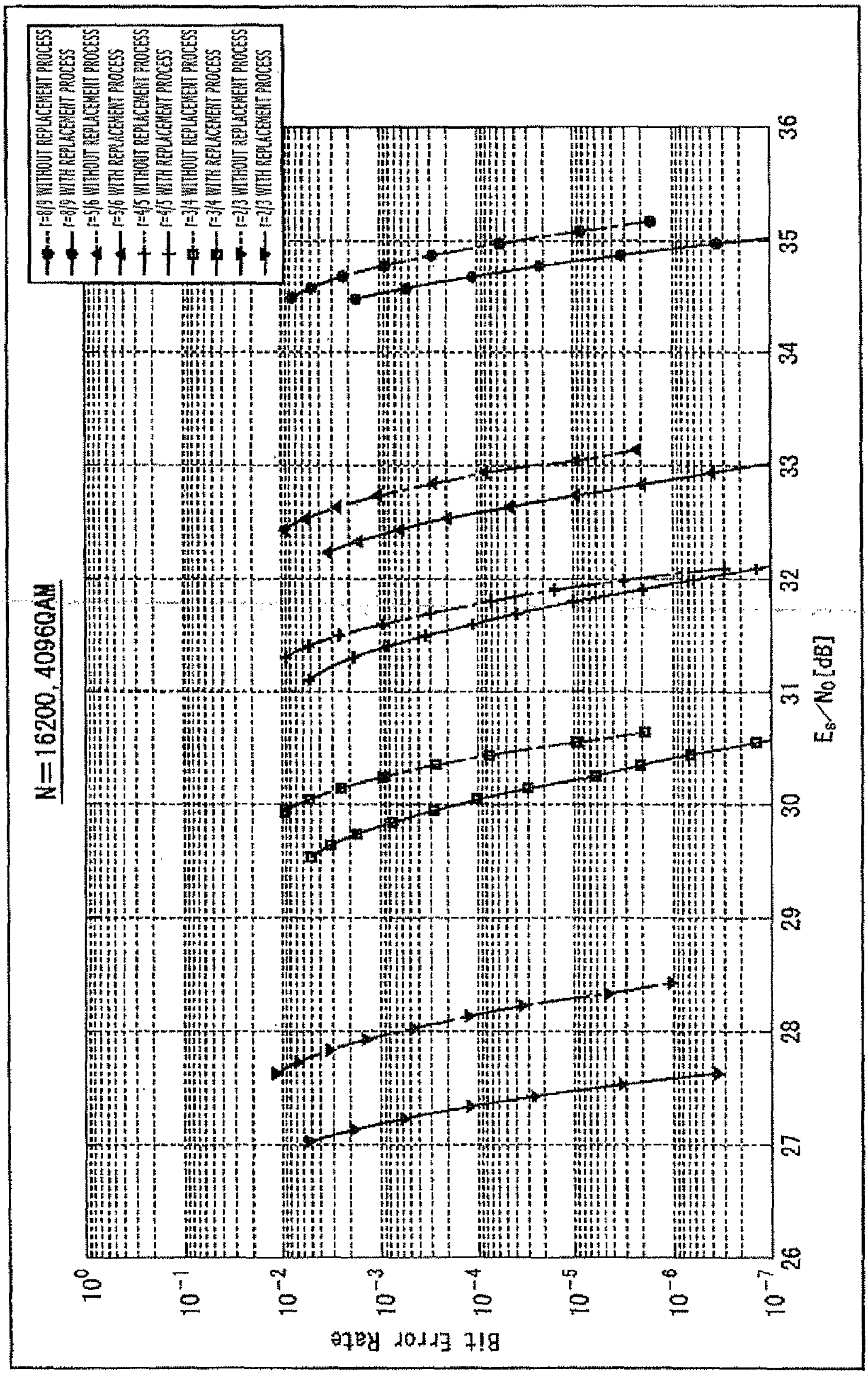
N=16200, 4096QAM
r=8/9 WITHOUT REPLACEMENT PROCESS
r=8/9 WITH REPLACEMENT PROCESS
r=5/6 WITHOUT REPLACEMENT PROCESS
r=5/6 WITH REPLACEMENT PROCESS
r=4/5 WITHOUT REPLACEMENT PROCESS
r=4/5 WITH REPLACEMENT PROCESS
r=3/4 WITHOUT REPLACEMENT PROCESS
r=3/4 WITH REPLACEMENT PROCESS
r=2/3 WITHOUT REPLACEMENT PROCESS
r=2/3 WITH REPLACEMENT PROCESS
Bit Error Rate
10^0
10^-1
10^-2
10^-3
10^-4
10^-5
10^-6
10^-7
26
27
28
29
30
31
32
33
34
35
36
Es/No[dB]

FIG.133

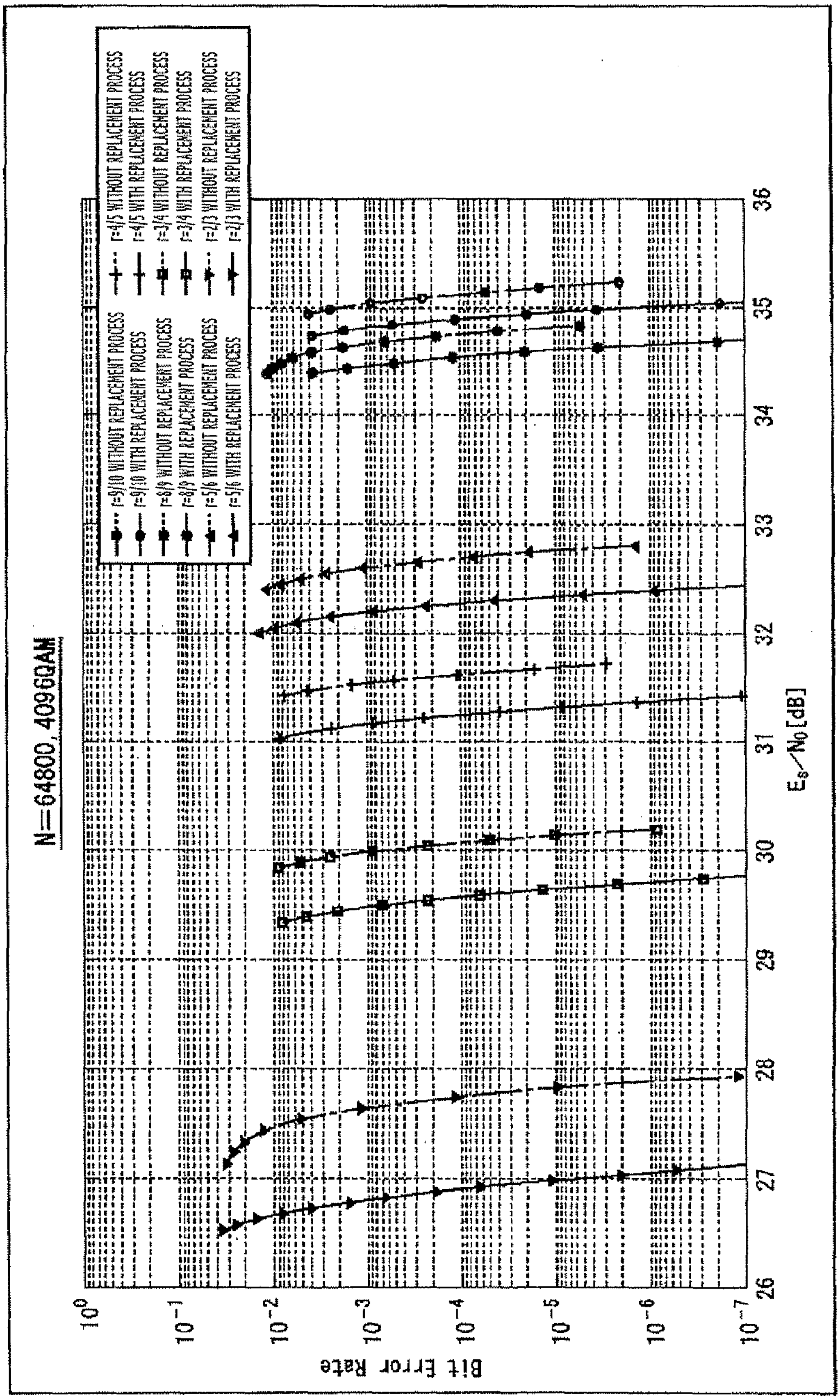
N=64800, 4096QAM
r=9/10 WITHOUT REPLACEMENT PROCESS
r=9/10 WITH REPLACEMENT PROCESS
r=8/9 WITHOUT REPLACEMENT PROCESS
r=8/9 WITH REPLACEMENT PROCESS
r=5/6 WITHOUT REPLACEMENT PROCESS
r=5/6 WITH REPLACEMENT PROCESS
r=4/5 WITHOUT REPLACEMENT PROCESS
r=4/5 WITH REPLACEMENT PROCESS
r=3/4 WITHOUT REPLACEMENT PROCESS
r=3/4 WITH REPLACEMENT PROCESS
r=2/3 WITHOUT REPLACEMENT PROCESS
r=2/3 WITH REPLACEMENT PROCESS
Bit Error Rate
$10^{0}$
$10^{-1}$
$10^{-2}$
$10^{-3}$
$10^{-4}$
$10^{-5}$
$10^{-6}$
$10^{-7}$
26
27
28
29
30
31
32
33
34
35
36
$E_s/N_0$[dB]

FIG. 134

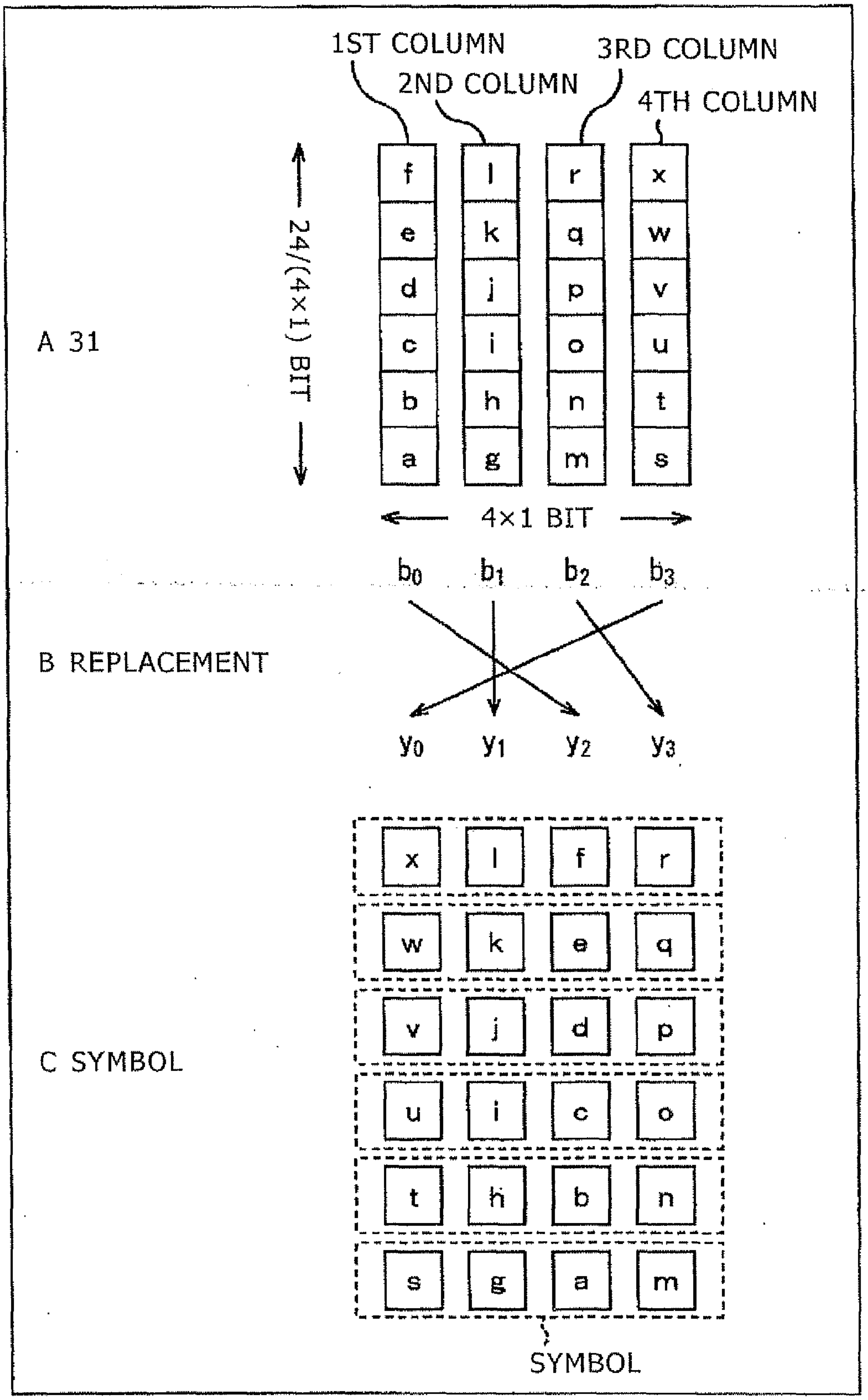
1ST COLUMN
2ND COLUMN
3RD COLUMN
4TH COLUMN
A 31
24/(4×1) BIT
f e d c b a
l k j i h g
r q p o n m
x w v u t s
4×1 BIT
B REPLACEMENT
b0 b1 b2 b3
y0 y1 y2 y3
C SYMBOL
x l f r
w k e q
v j d p
u i c o
t h b n
s g a m
SYMBOL

FIG.135

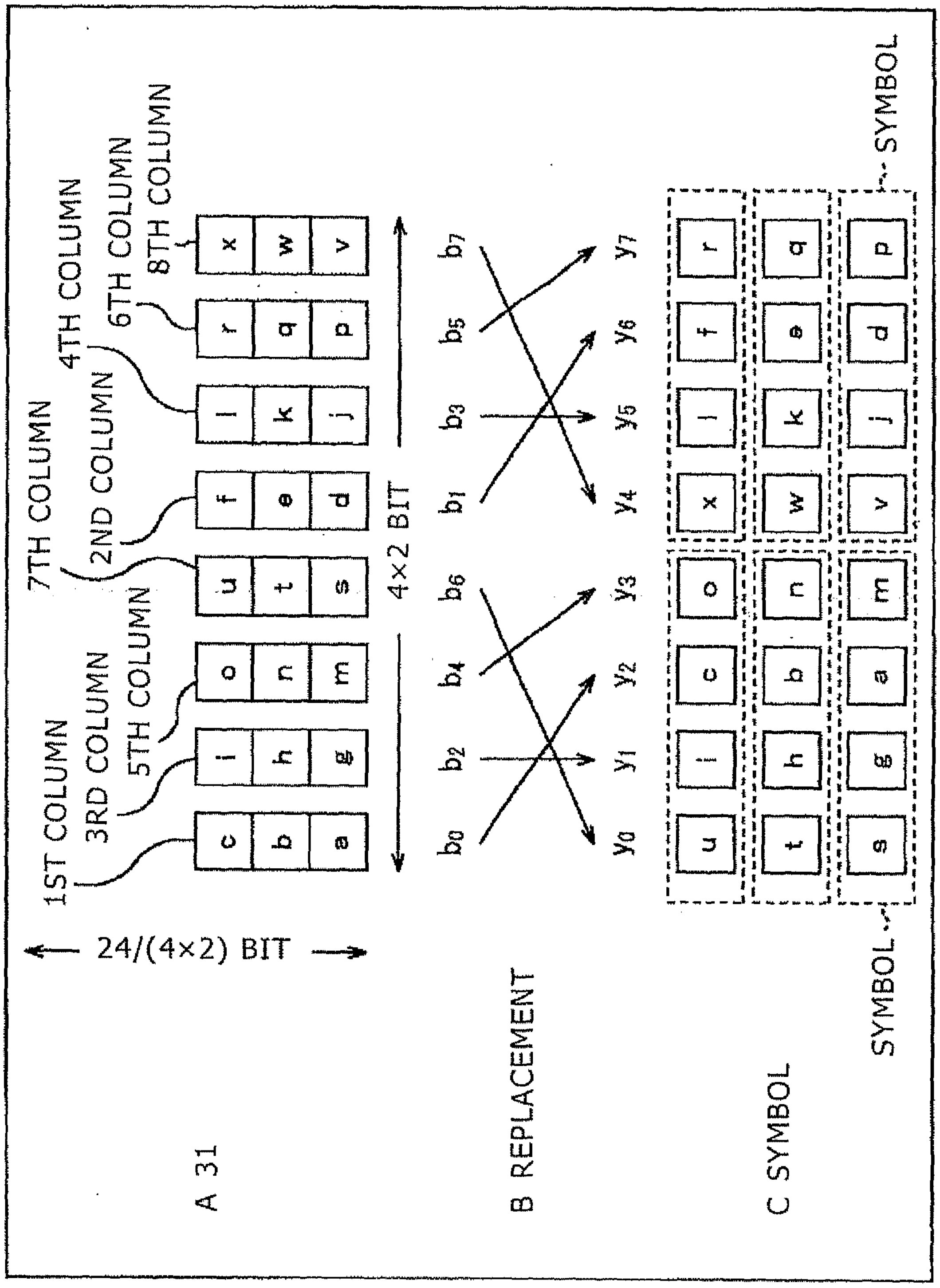
A 31
24/(4×2) BIT
1ST COLUMN
3RD COLUMN
5TH COLUMN
7TH COLUMN
2ND COLUMN
4TH COLUMN
6TH COLUMN
8TH COLUMN
4×2 BIT
B REPLACEMENT
C SYMBOL
SYMBOL
SYMBOL

# FIG.136

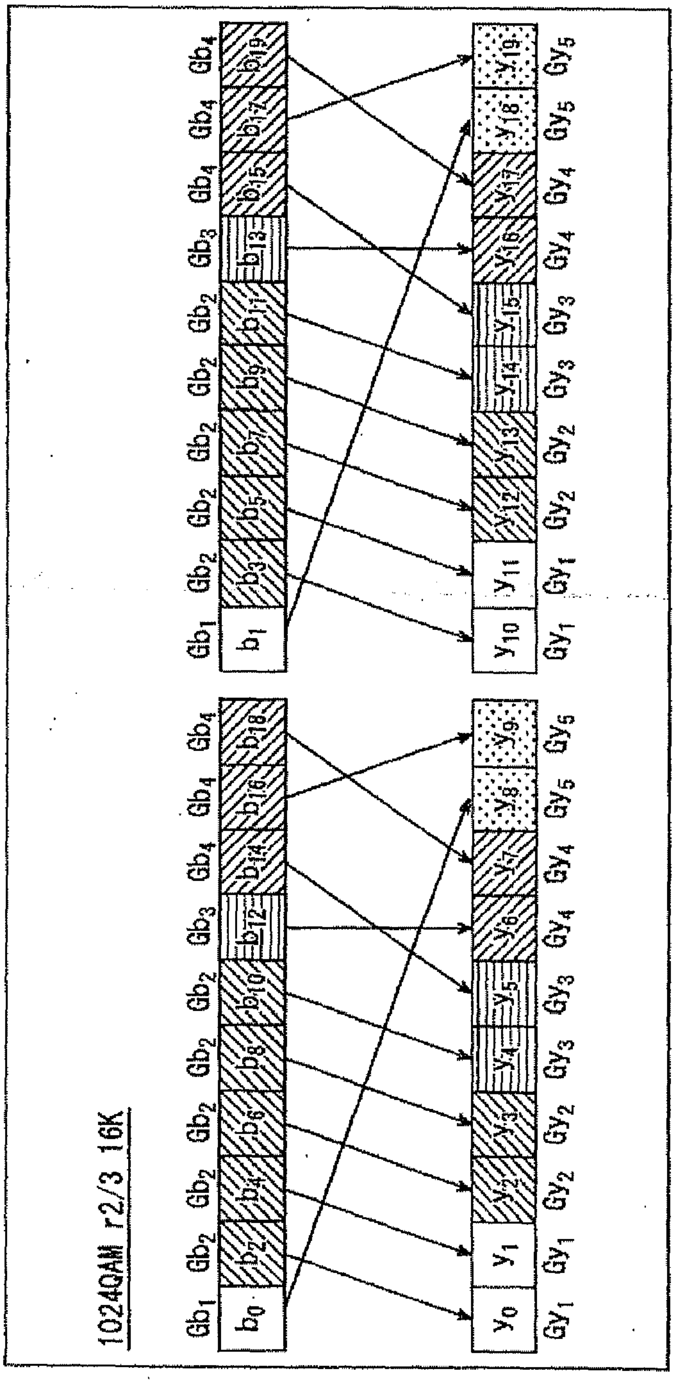
1024QAM r2/3 16K
Gb1 Gb2 Gb2 Gb2 Gb2 Gb2 Gb2 Gb3 Gb4 Gb4 Gb4
b0 b2 b4 b6 b8 b10 b12 b14 b16 b18
b1 b3 b5 b7 b9 b11 b13 b15 b17 b19
y0 y1 y2 y3 y4 y5 y6 y7 y8 y9
y10 y11 y12 y13 y14 y15 y16 y17 y18 y19
Gy1 Gy1 Gy2 Gy2 Gy3 Gy3 Gy4 Gy4 Gy5 Gy5

FIG.137

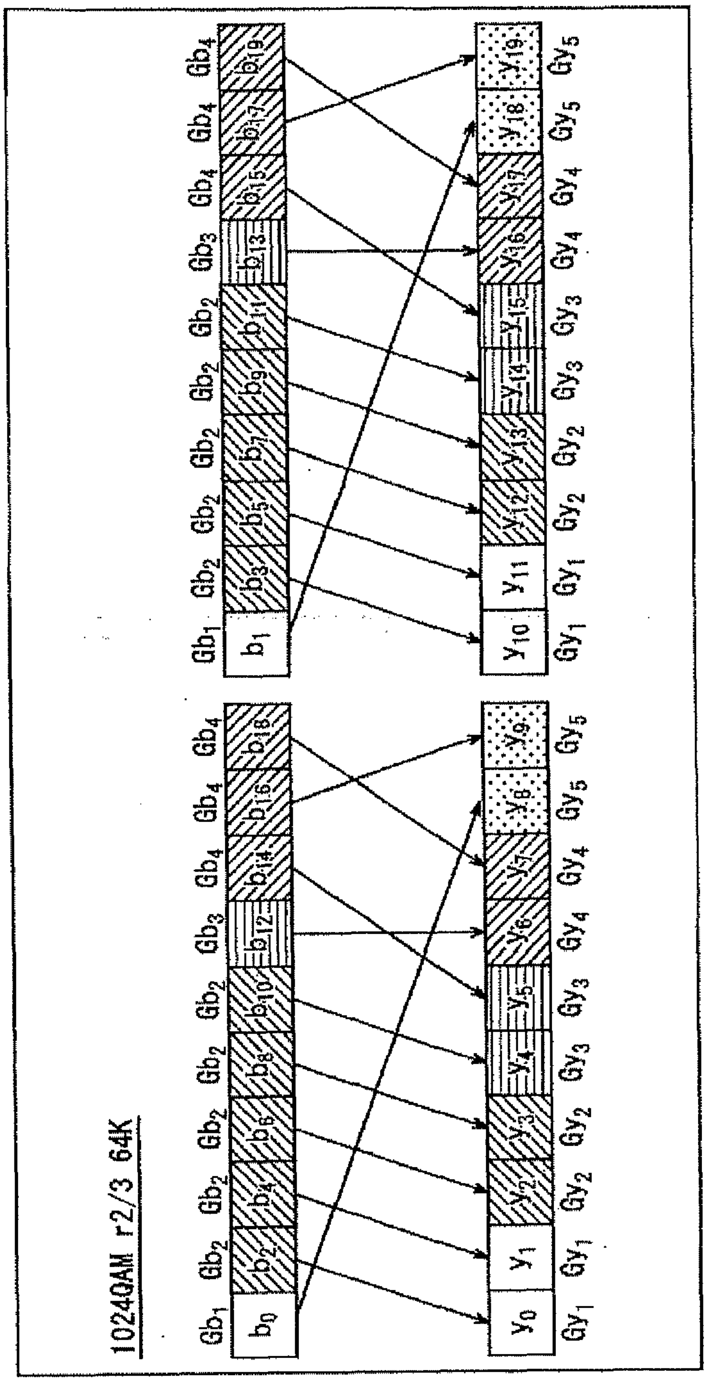
1024QAM r2/3 64K
Gb1 Gb2 Gb2 Gb2 Gb2 Gb2 Gb3 Gb4 Gb4 Gb4
b0 b2 b4 b6 b8 b10 b12 b14 b16 b18
y0 y1 y2 y3 y4 y5 y6 y7 y8 y9
Gy1 Gy1 Gy2 Gy2 Gy3 Gy3 Gy4 Gy4 Gy5 Gy5
b1 b3 b5 b7 b9 b11 b13 b15 b17 b19
y10 y11 y12 y13 y14 y15 y16 y17 y18 y19

FIG.138

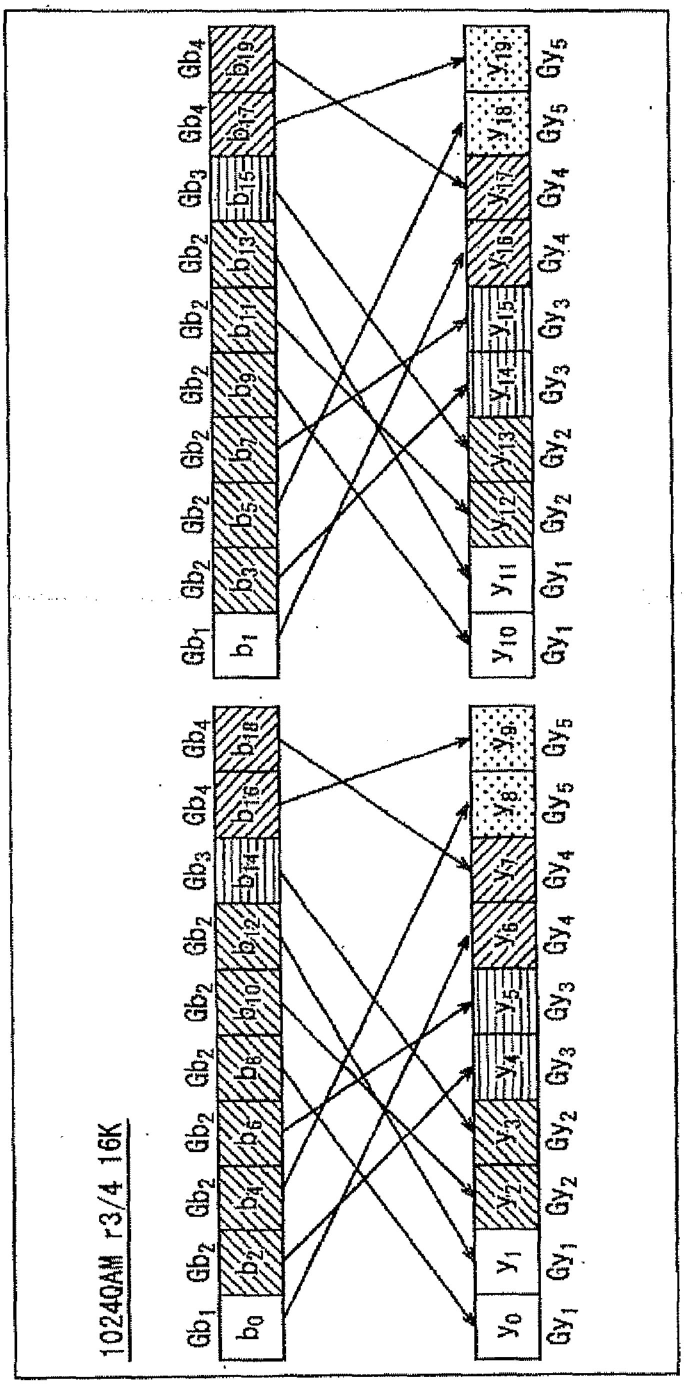

FIG.139

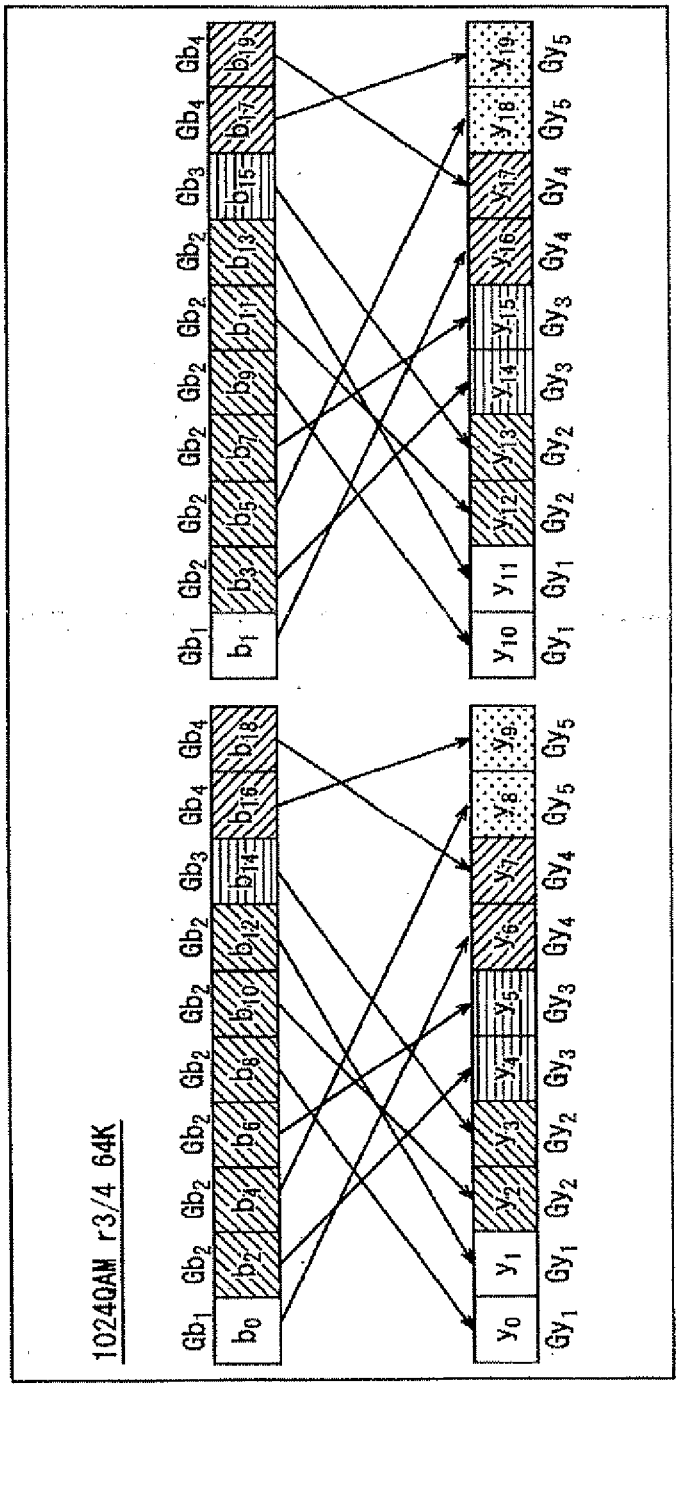
1024QAM r3/4 64K
Gb1 Gb2 Gb2 Gb2 Gb2 Gb2 Gb2 Gb3 Gb4 Gb4
b0 b2 b4 b6 b8 b10 b12 b14 b16 b18
y0 y1 y2 y3 y4 y5 y6 y7 y8 y9
Gy1 Gy1 Gy2 Gy2 Gy3 Gy3 Gy4 Gy4 Gy5 Gy5
Gb1 Gb2 Gb2 Gb2 Gb2 Gb2 Gb2 Gb3 Gb4 Gb4
b1 b3 b5 b7 b9 b11 b13 b15 b17 b19
y10 y11 y12 y13 y14 y15 y16 y17 y18 y19
Gy1 Gy1 Gy2 Gy2 Gy3 Gy3 Gy4 Gy4 Gy5 Gy5

FIG.140

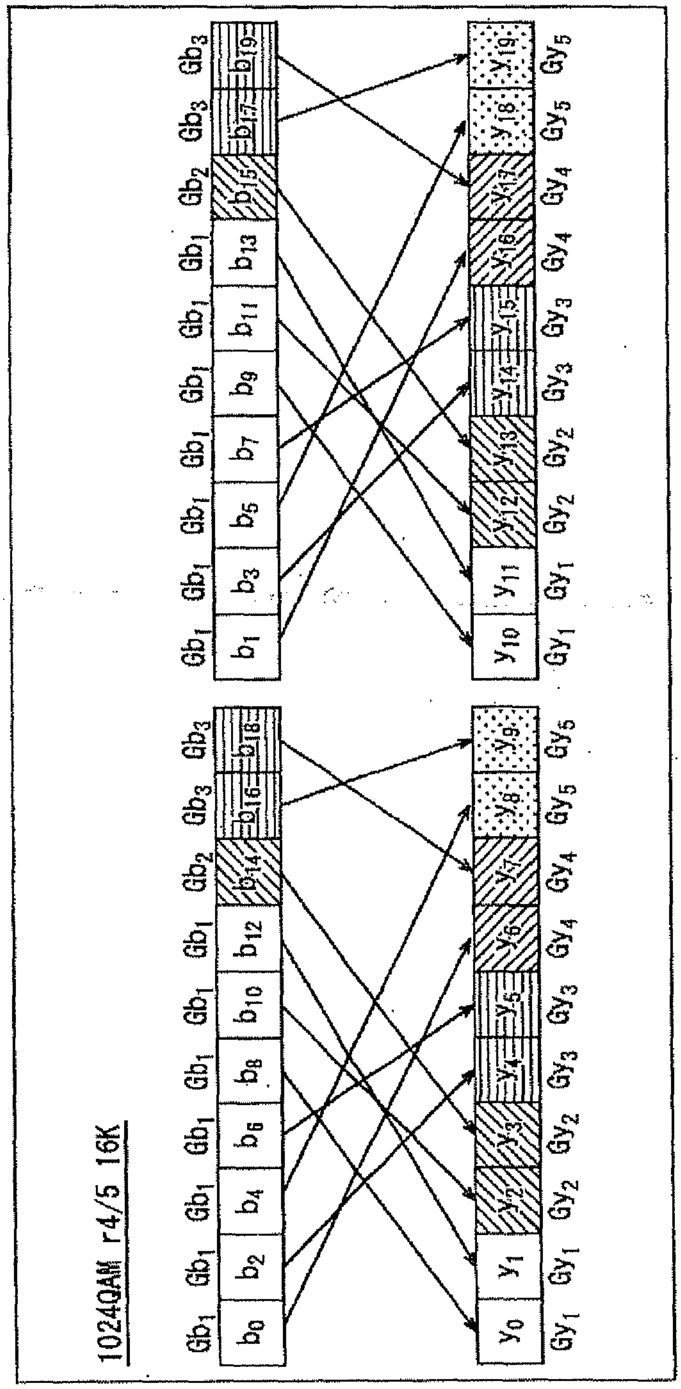
1024QAM r4/5 16K
Gb1 Gb1 Gb1 Gb1 Gb1 Gb1 Gb1 Gb2 Gb3 Gb3
b0 b2 b4 b6 b8 b10 b12 b14 b16 b18
y0 y1 y2 y3 y4 y5 y6 y7 y8 y9
Gy1 Gy1 Gy2 Gy2 Gy3 Gy3 Gy4 Gy4 Gy5 Gy5
Gb1 Gb1 Gb1 Gb1 Gb1 Gb1 Gb1 Gb2 Gb3 Gb3
b1 b3 b5 b7 b9 b11 b13 b15 b17 b19
y10 y11 y12 y13 y14 y15 y16 y17 y18 y19
Gy1 Gy1 Gy2 Gy2 Gy3 Gy3 Gy4 Gy4 Gy5 Gy5

FIG. 141

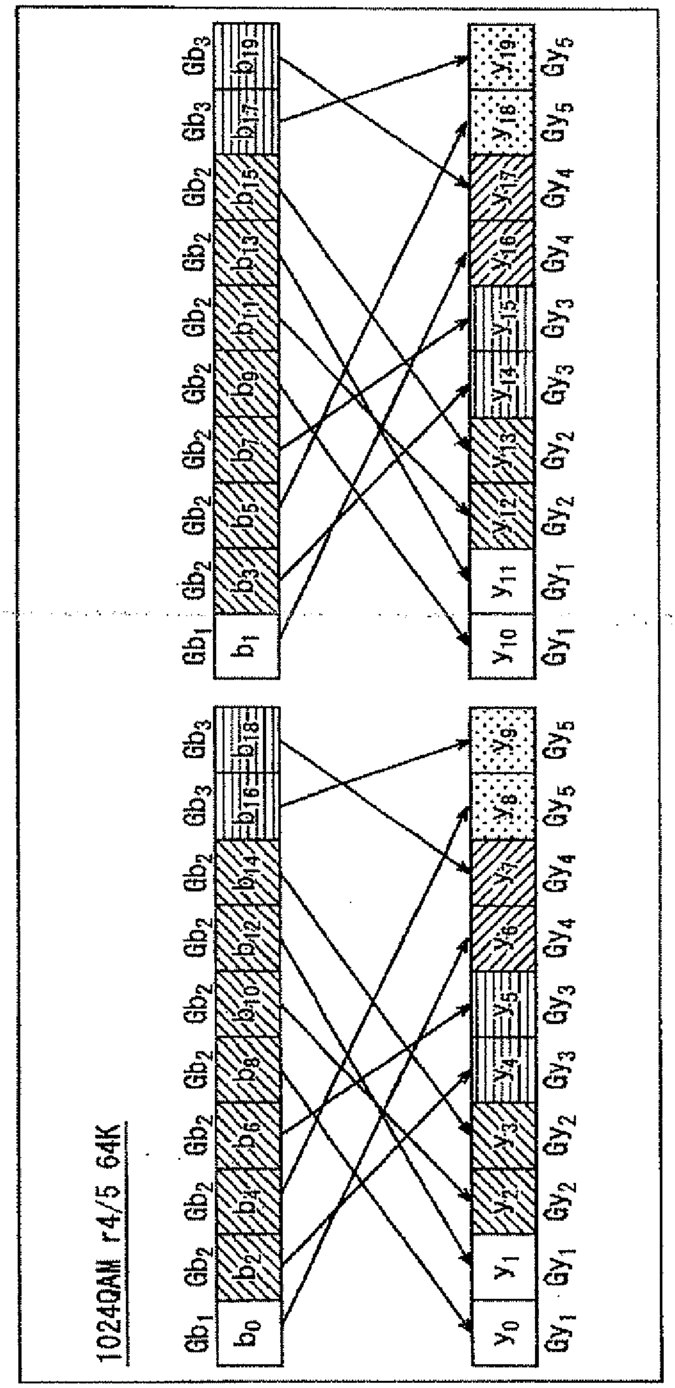

FIG.142

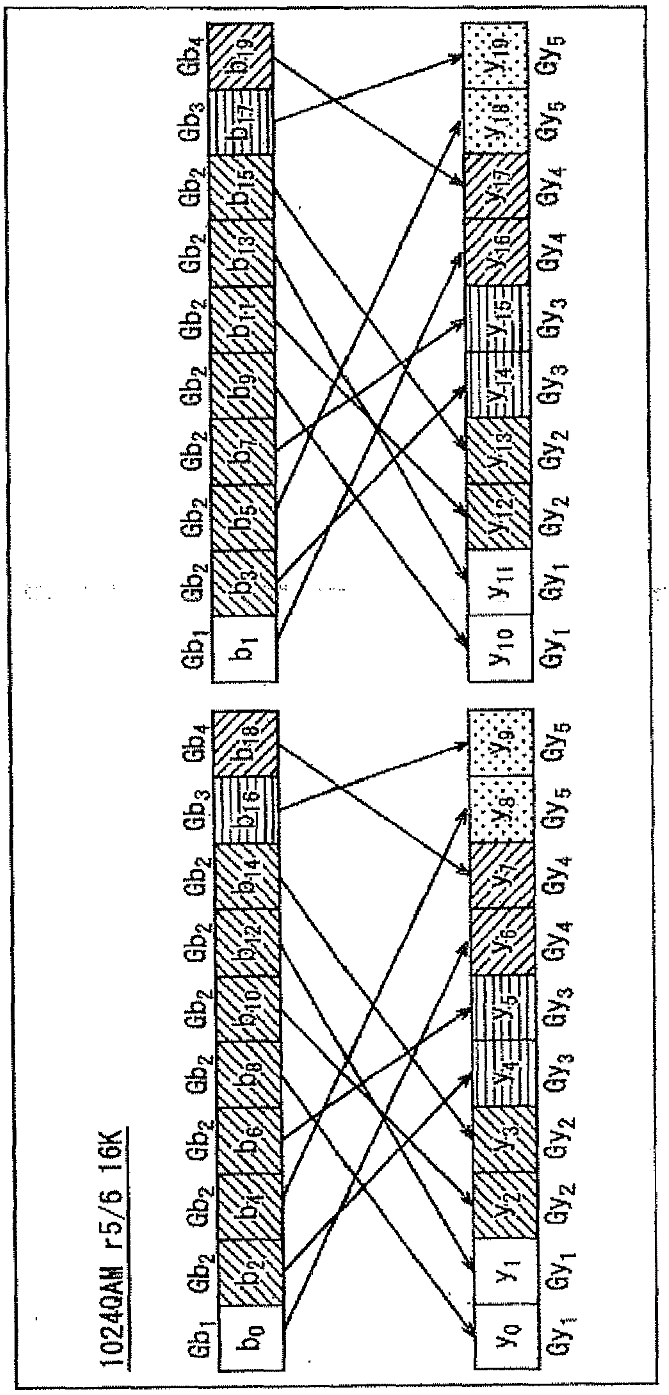
1024QAM r5/6 16K
Gb1 Gb2 Gb2 Gb2 Gb2 Gb2 Gb2 Gb2 Gb3 Gb4
b0 b2 b4 b6 b8 b10 b12 b14 b16 b18
y0 y1 y2 y3 y4 y5 y6 y7 y8 y9
Gy1 Gy1 Gy2 Gy2 Gy3 Gy3 Gy4 Gy4 Gy5 Gy5
Gb1 Gb2 Gb2 Gb2 Gb2 Gb2 Gb2 Gb2 Gb3 Gb4
b1 b3 b5 b7 b9 b11 b13 b15 b17 b19
y10 y11 y12 y13 y14 y15 y16 y17 y18 y19
Gy1 Gy1 Gy2 Gy2 Gy3 Gy3 Gy4 Gy4 Gy5 Gy5

FIG.143

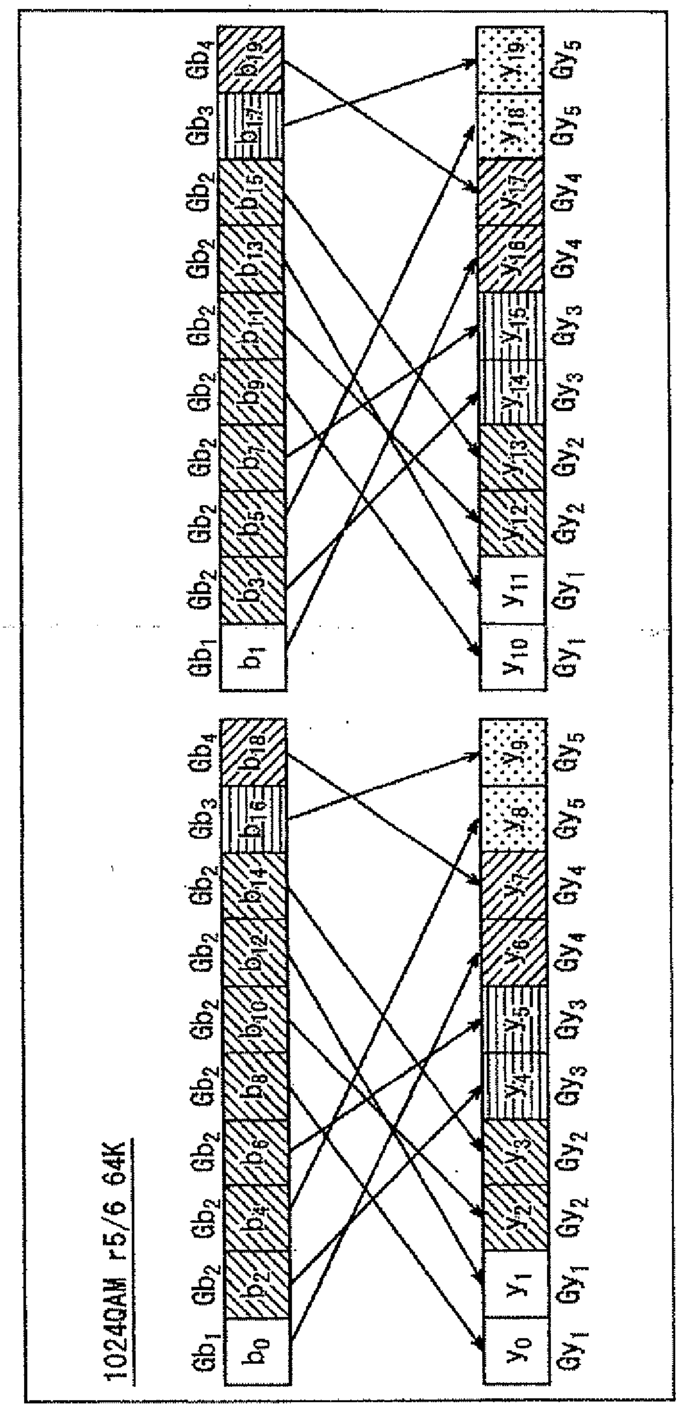
1024QAM r5/6 64K
Gb1 Gb2 Gb2 Gb2 Gb2 Gb2 Gb2 Gb2 Gb3 Gb4
b0 b2 b4 b6 b8 b10 b12 b14 b16 b18
y0 y1 y2 y3 y4 y5 y6 y7 y8 y9
Gy1 Gy1 Gy2 Gy2 Gy3 Gy3 Gy4 Gy4 Gy5 Gy5
Gb1 Gb2 Gb2 Gb2 Gb2 Gb2 Gb2 Gb2 Gb3 Gb4
b1 b3 b5 b7 b9 b11 b13 b15 b17 b19
y10 y11 y12 y13 y14 y15 y16 y17 y18 y19
Gy1 Gy1 Gy2 Gy2 Gy3 Gy3 Gy4 Gy4 Gy5 Gy5

FIG.144

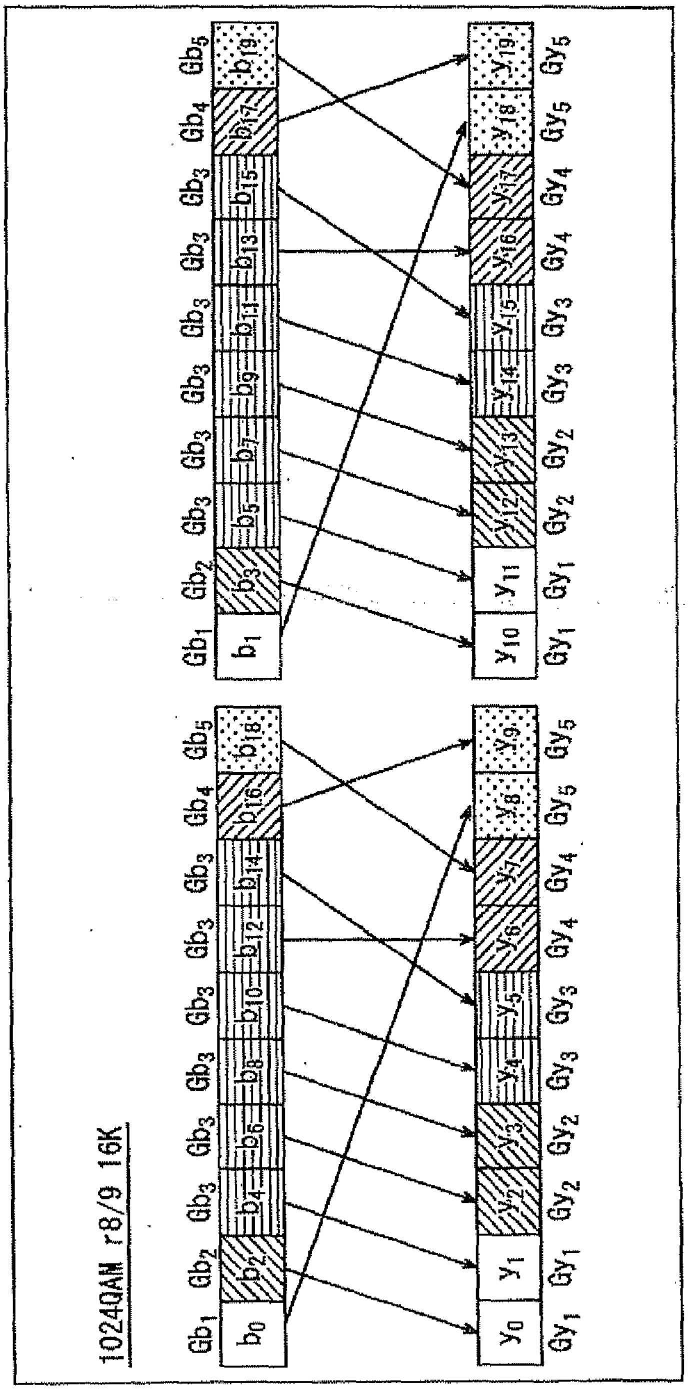

FIG.145

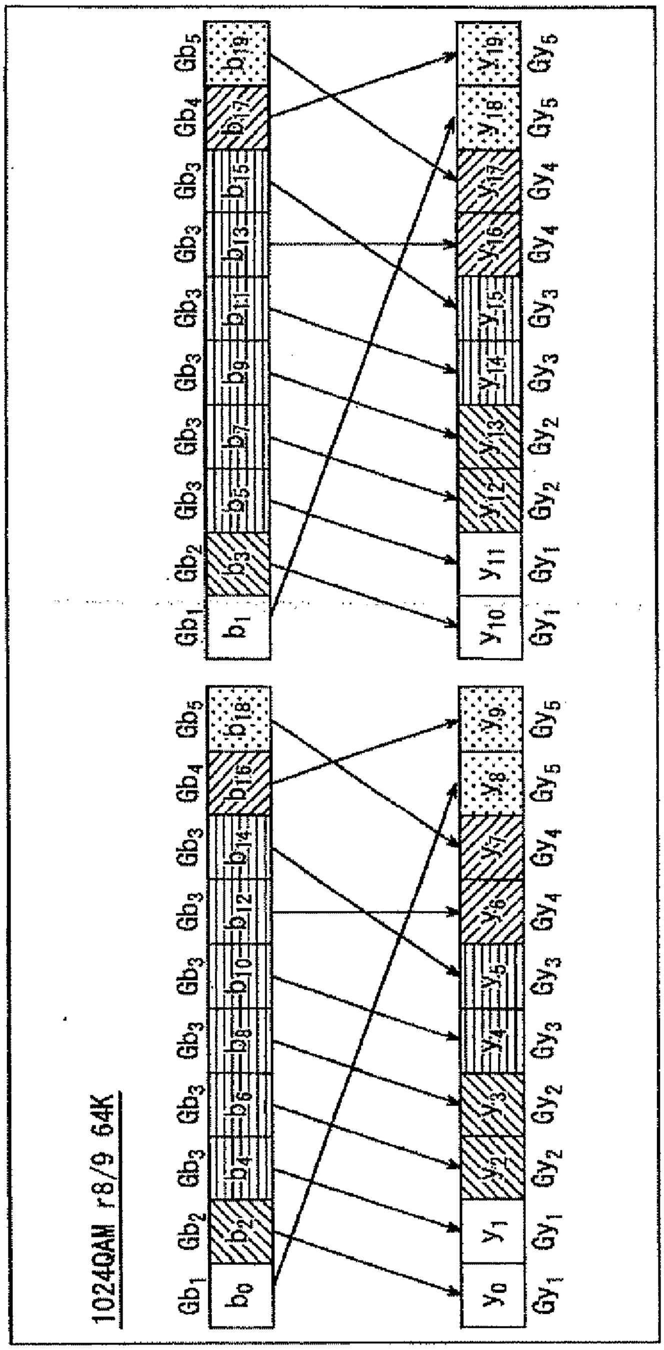
1024QAM r8/9 64K
Gb1 Gb2 Gb3 Gb3 Gb3 Gb3 Gb3 Gb3 Gb4 Gb5
b0 b2 b4 b6 b8 b10 b12 b14 b16 b18
y0 y1 y2 y3 y4 y5 y6 y7 y8 y9
Gy1 Gy1 Gy2 Gy2 Gy3 Gy3 Gy4 Gy4 Gy5 Gy5
b1 b3 b5 b7 b9 b11 b13 b15 b17 b19
y10 y11 y12 y13 y14 y15 y16 y17 y18 y19

FIG.146

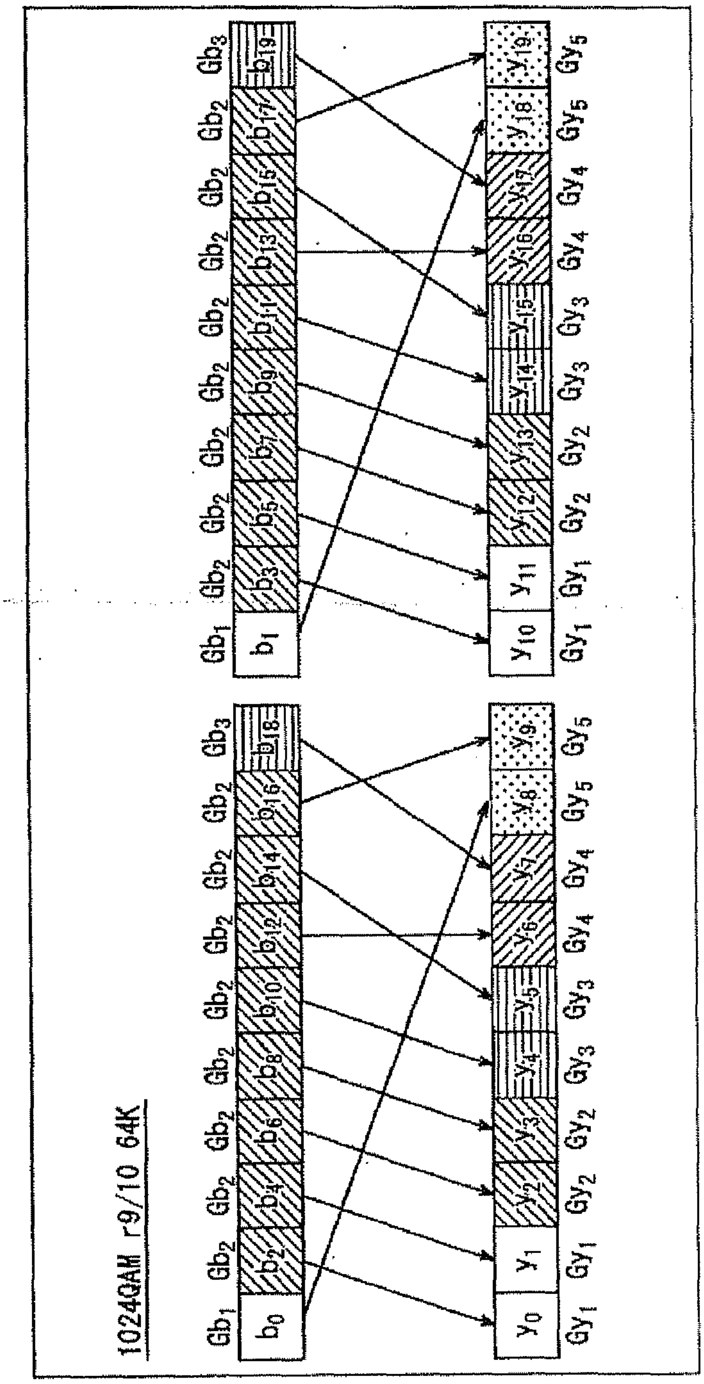
1024QAM r9/10 64K
Gb1 Gb2 Gb2 Gb2 Gb2 Gb2 Gb2 Gb2 Gb2 Gb3
b0 b2 b4 b6 b8 b10 b12 b14 b16 b18
y0 y1 y2 y3 y4 y5 y6 y7 y8 y9
Gy1 Gy1 Gy2 Gy2 Gy3 Gy3 Gy4 Gy4 Gy5 Gy5
Gb1 Gb2 Gb2 Gb2 Gb2 Gb2 Gb2 Gb2 Gb2 Gb3
b1 b3 b5 b7 b9 b11 b13 b15 b17 b19
y10 y11 y12 y13 y14 y15 y16 y17 y18 y19
Gy1 Gy1 Gy2 Gy2 Gy3 Gy3 Gy4 Gy4 Gy5 Gy5

FIG.147

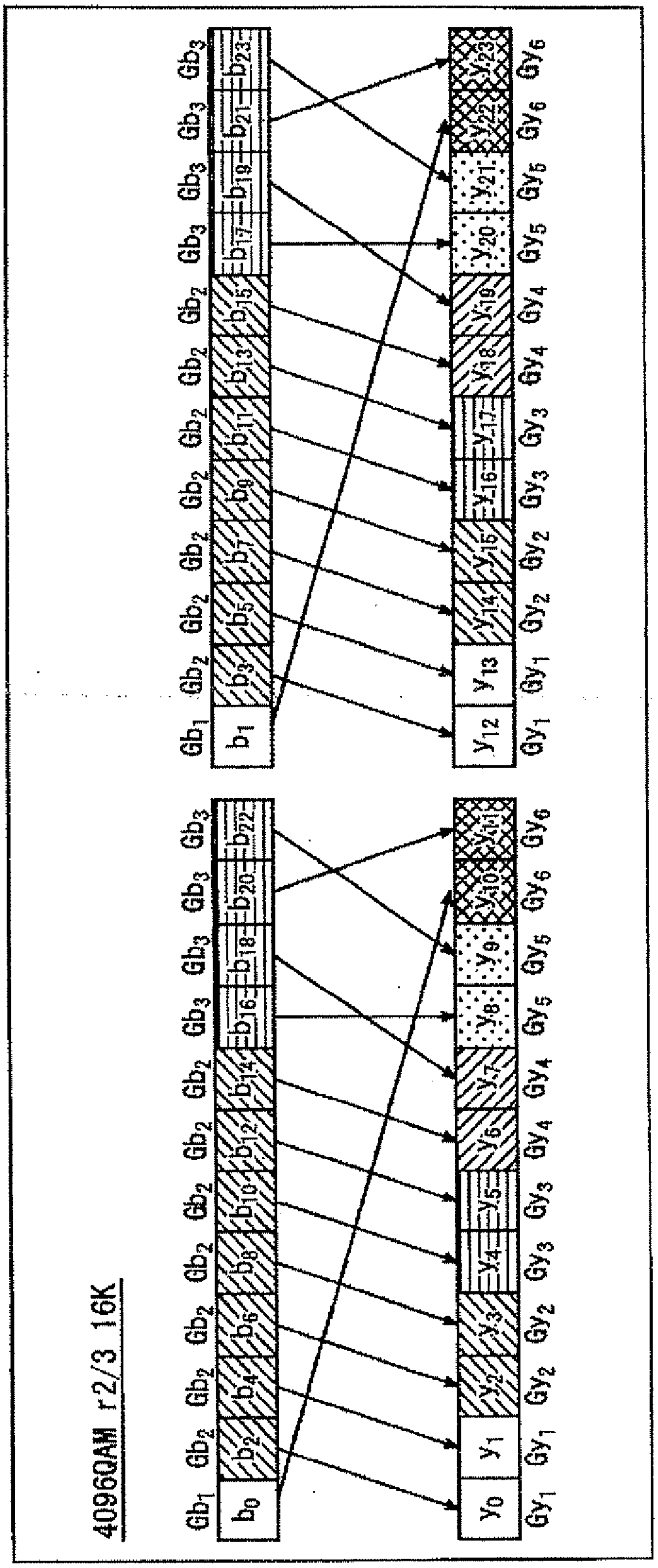

FIG.148

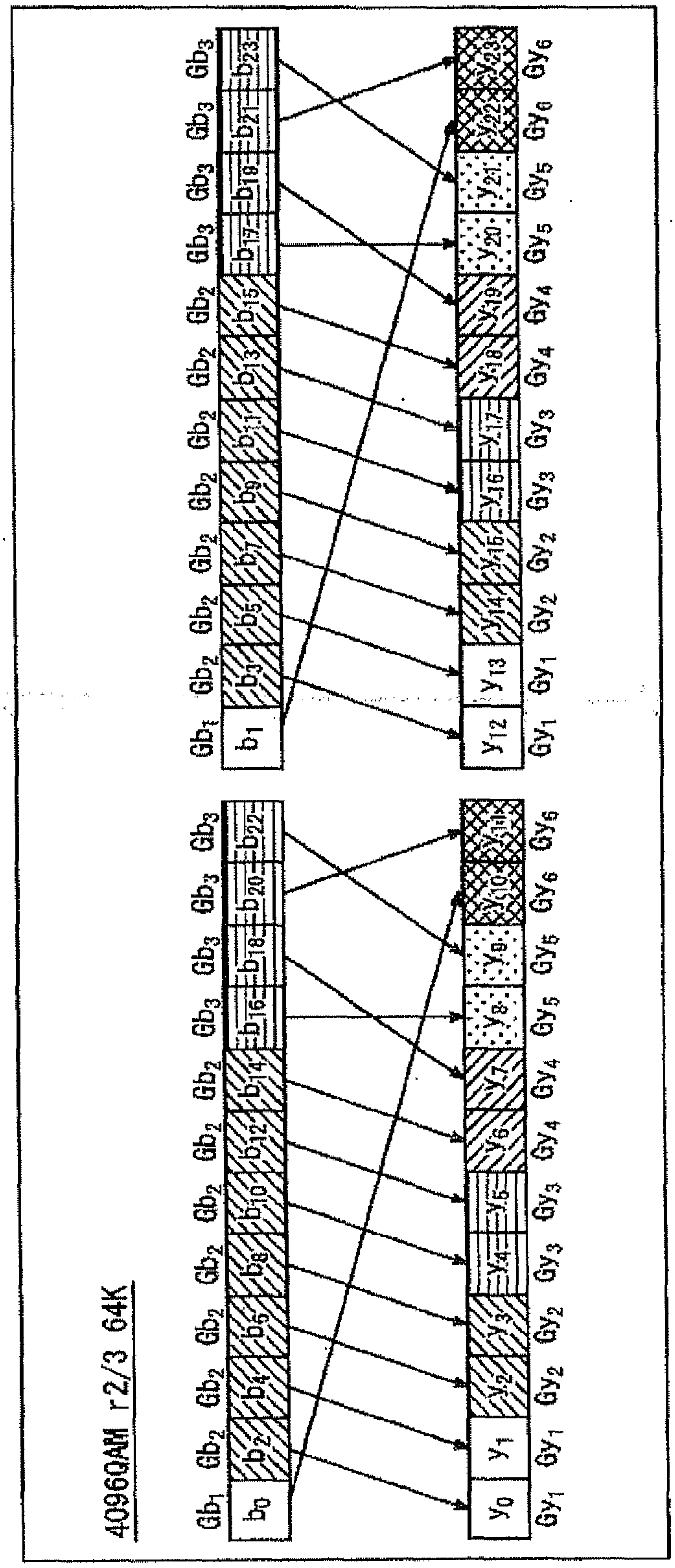
4096QAM r2/3 64K
Gb1 Gb2 Gb2 Gb2 Gb2 Gb2 Gb2 Gb2 Gb3 Gb3 Gb3 Gb3
b0 b2 b4 b6 b8 b10 b12 b14 b16 b18 b20 b22
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6
Gb1 Gb2 Gb2 Gb2 Gb2 Gb2 Gb2 Gb2 Gb3 Gb3 Gb3 Gb3
b1 b3 b5 b7 b9 b11 b13 b15 b17 b19 b21 b23
y12 y13 y14 y15 y16 y17 y18 y19 y20 y21 y22 y23
Gy1 Gy1 Gy2 Gy2 Gy3 Gy3 Gy4 Gy4 Gy5 Gy5 Gy6 Gy6

FIG.149

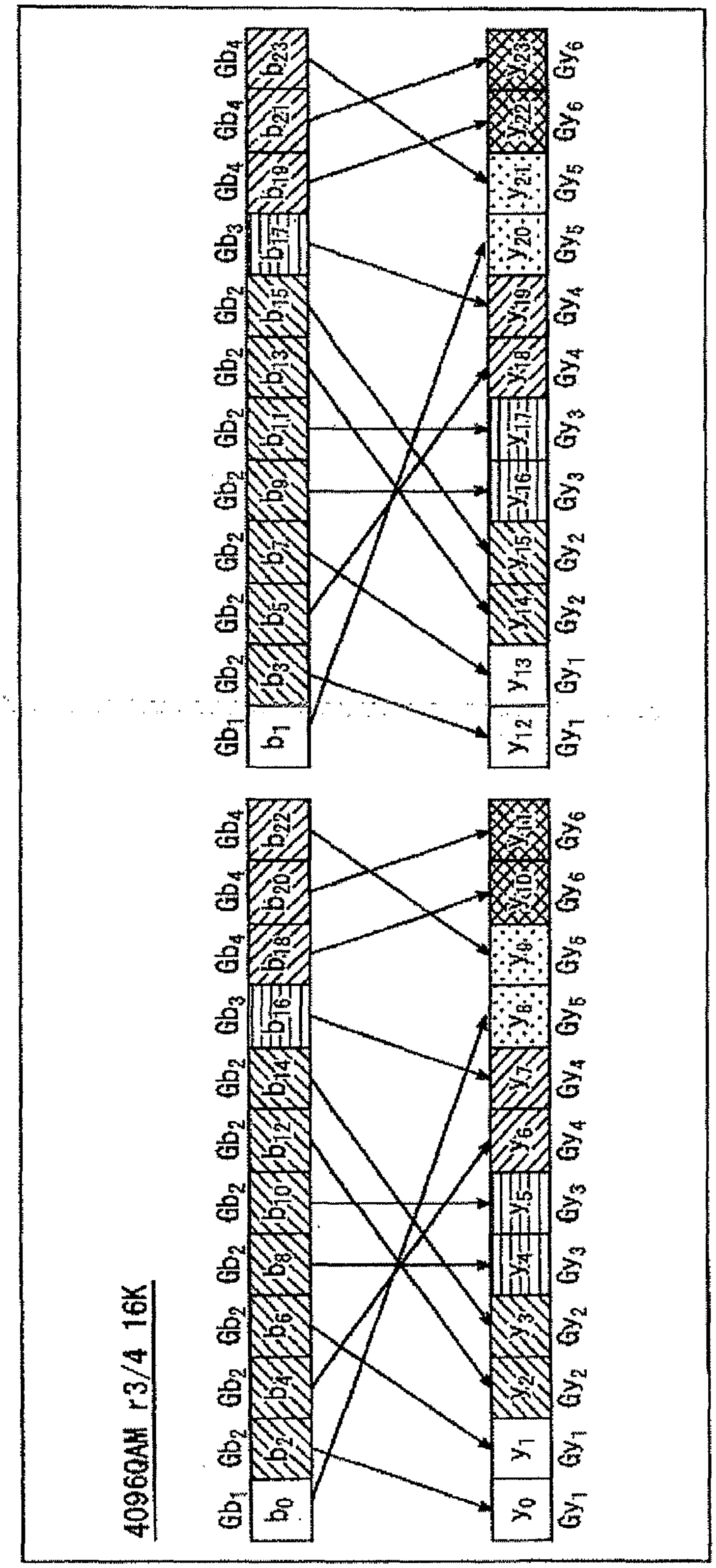

FIG.150

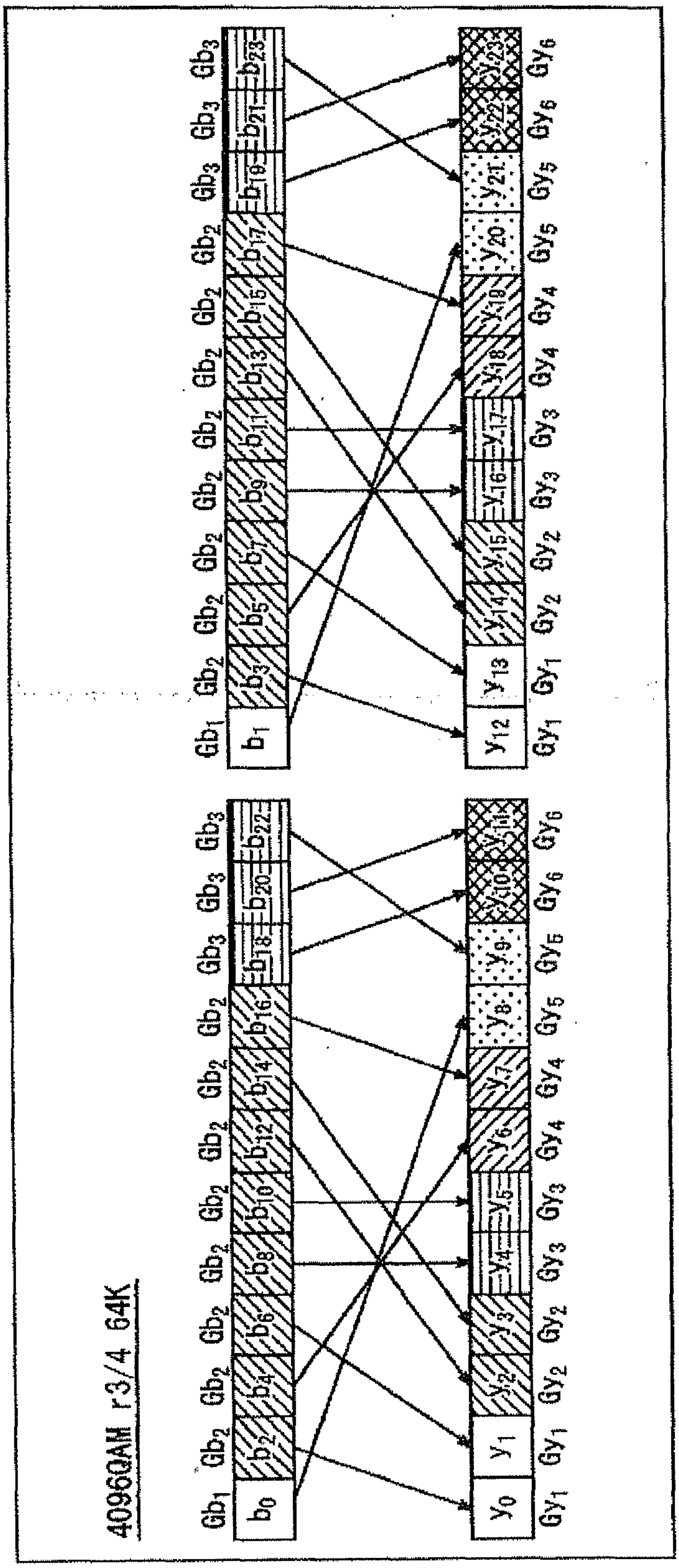

FIG.151

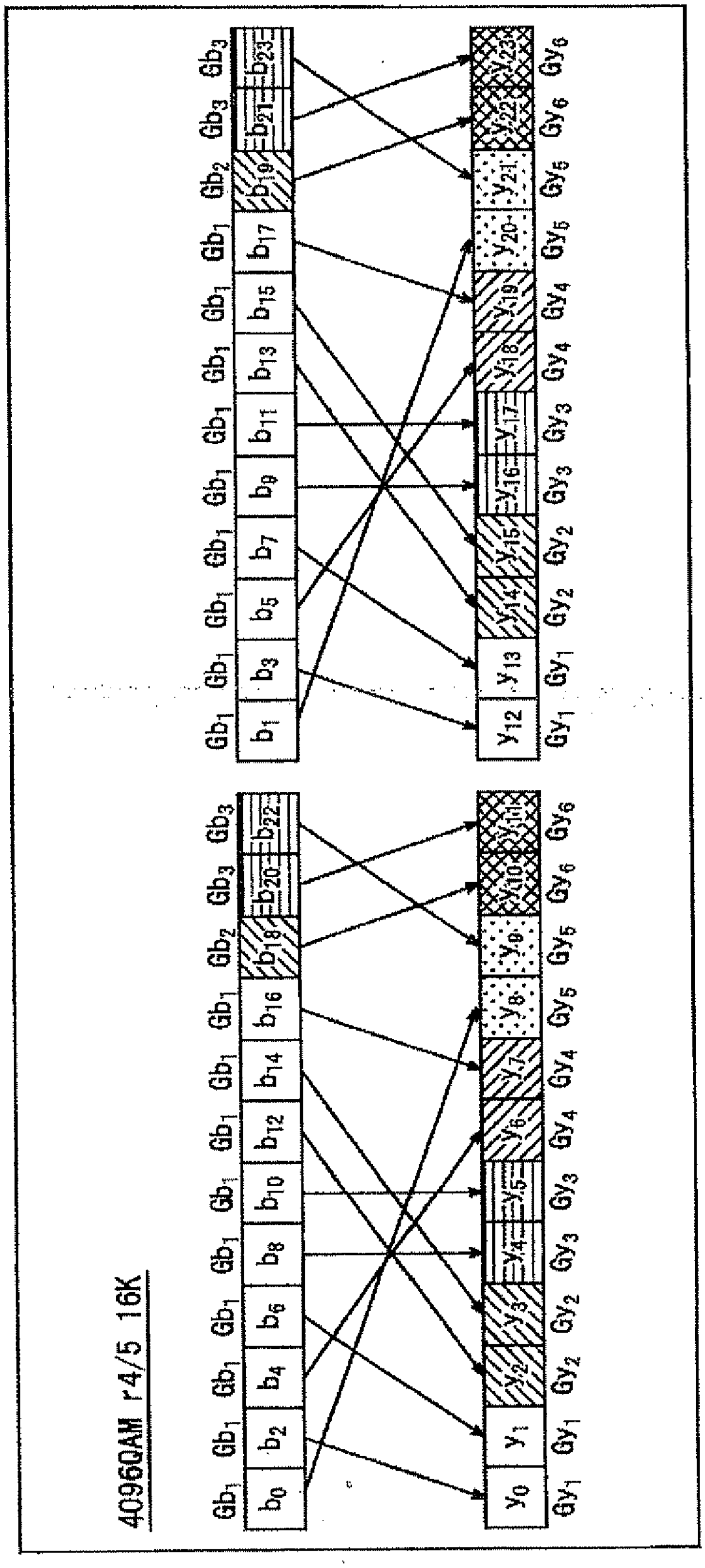
4096QAM r4/5 16K
Gb1 Gb1 Gb1 Gb1 Gb1 Gb1 Gb1 Gb1 Gb1 Gb2 Gb3 Gb3
b0 b2 b4 b6 b8 b10 b12 b14 b16 b18 b20 b22
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6
b1 b3 b5 b7 b9 b11 b13 b15 b17 b19 b21 b23
y12 y13 y14 y15 y16 y17 y18 y19 y20 y21 y22 y23

FIG.152

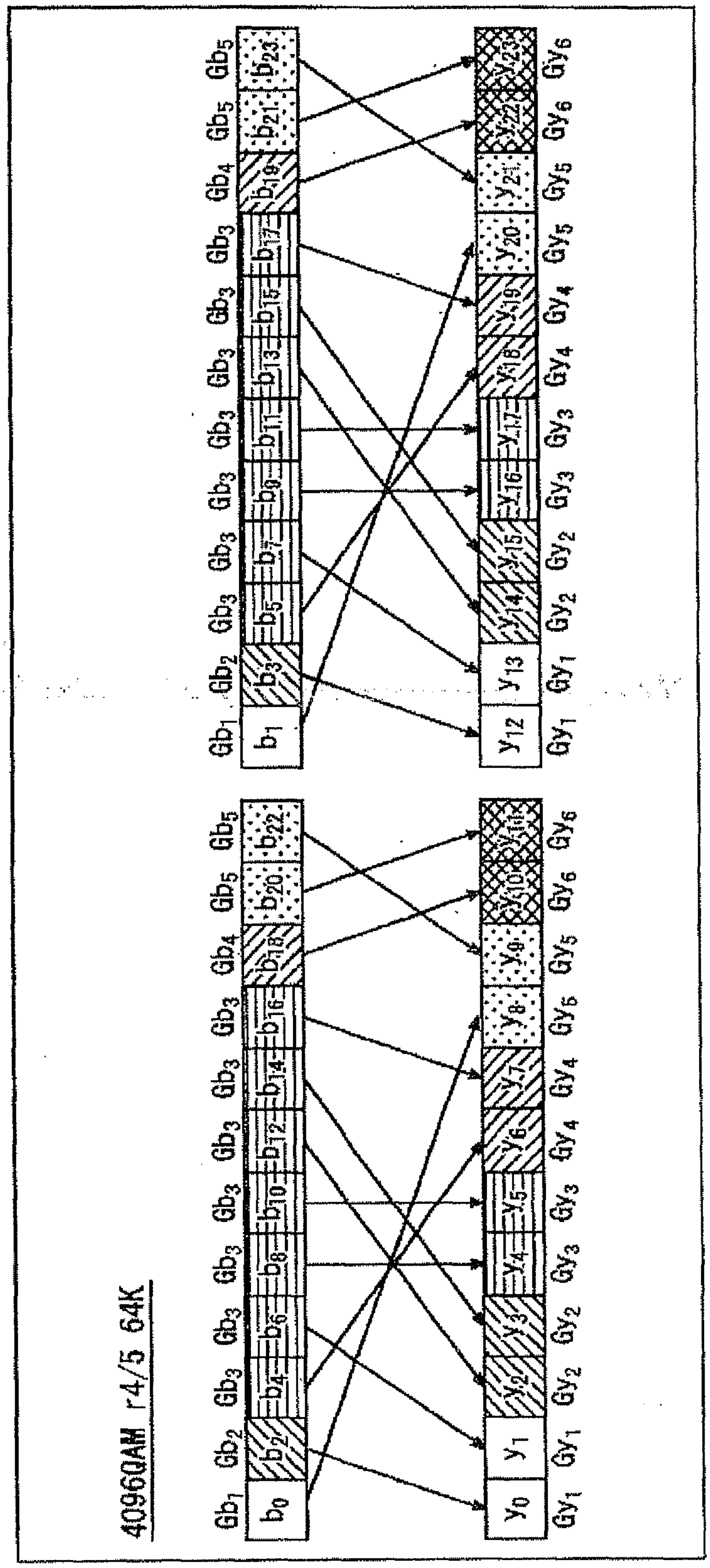

FIG.153

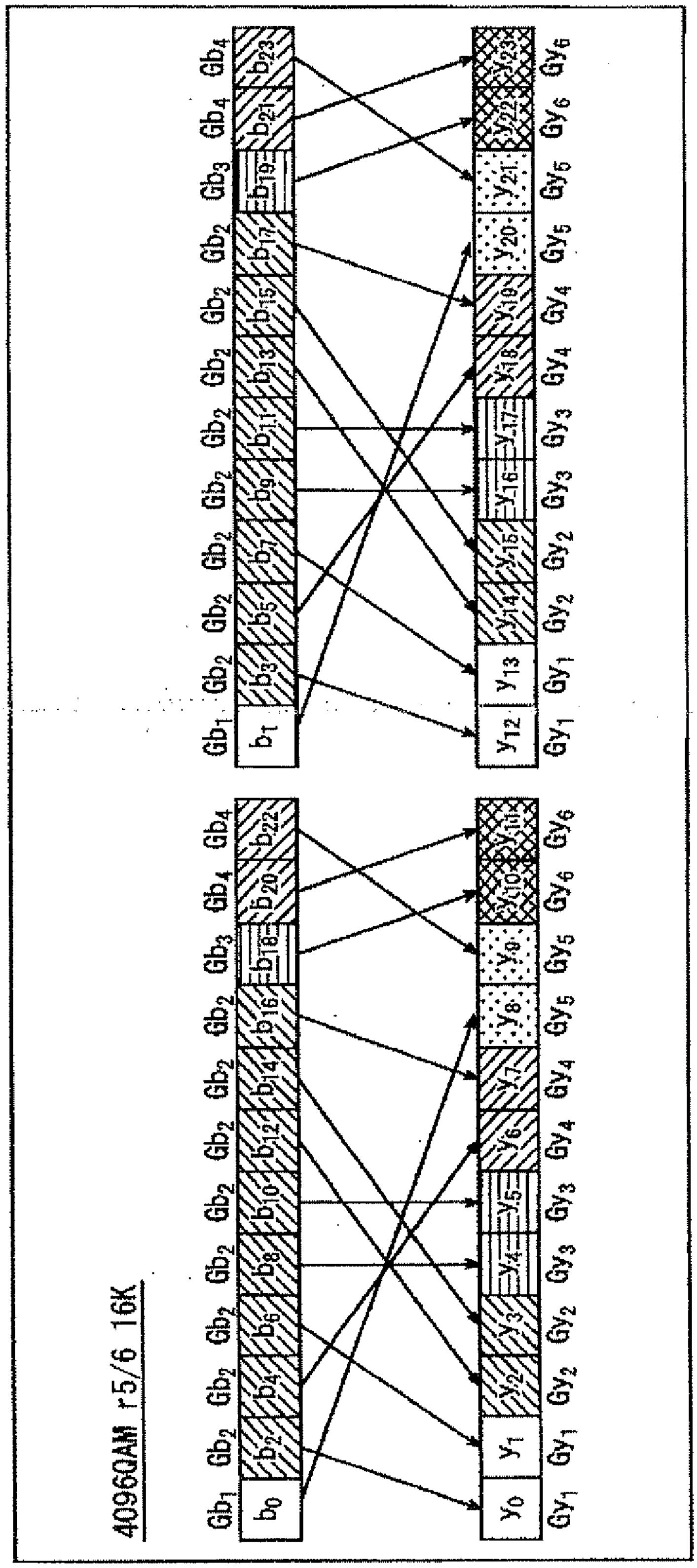
4096QAM r5/6 16K
Gb1 Gb2 Gb2 Gb2 Gb2 Gb2 Gb2 Gb2 Gb2 Gb3 Gb4 Gb4
b0 b2 b4 b6 b8 b10 b12 b14 b16 b18 b20 b22
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6
b1 b3 b5 b7 b9 b11 b13 b15 b17 b19 b21 b23
y12 y13 y14 y15 y16 y17 y18 y19 y20 y21 y22 y23

FIG.154

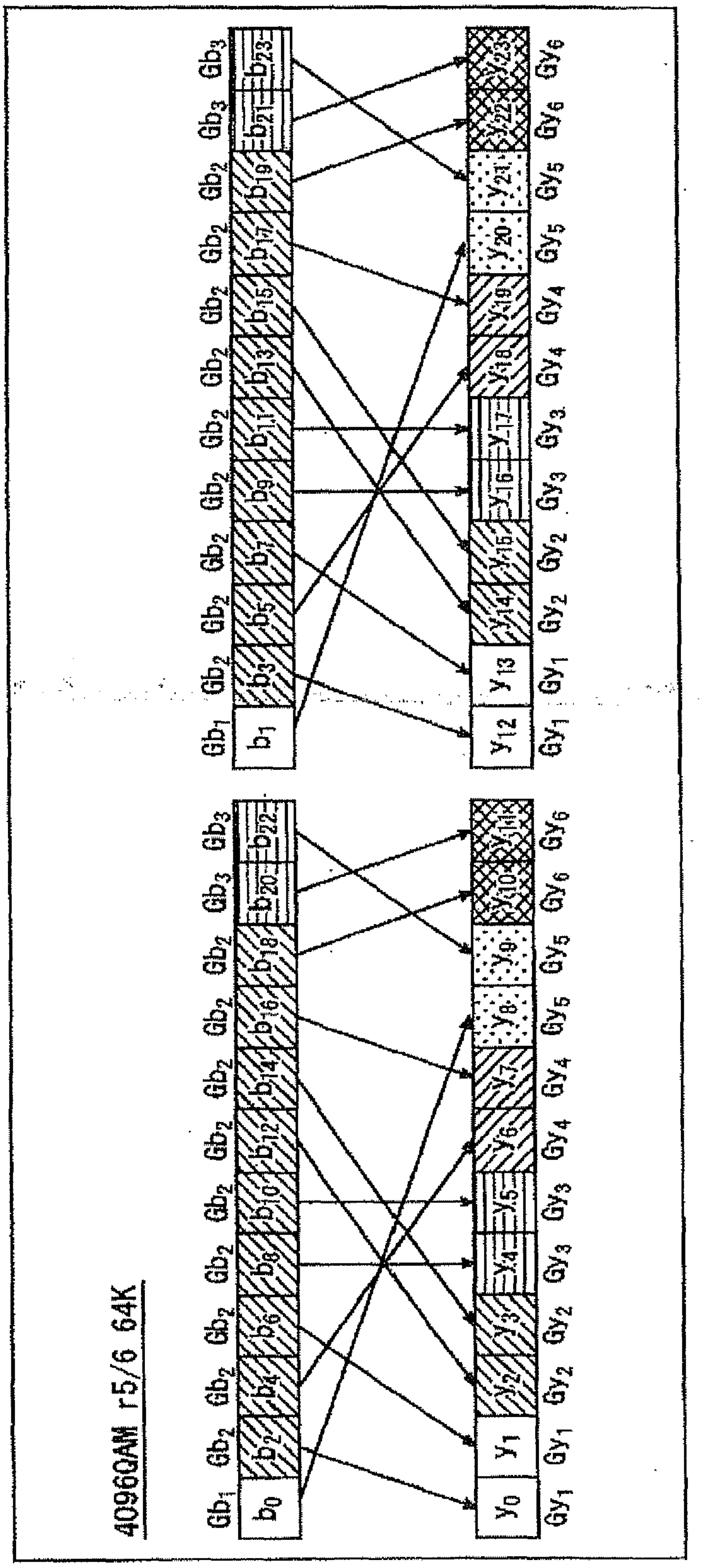

FIG.155

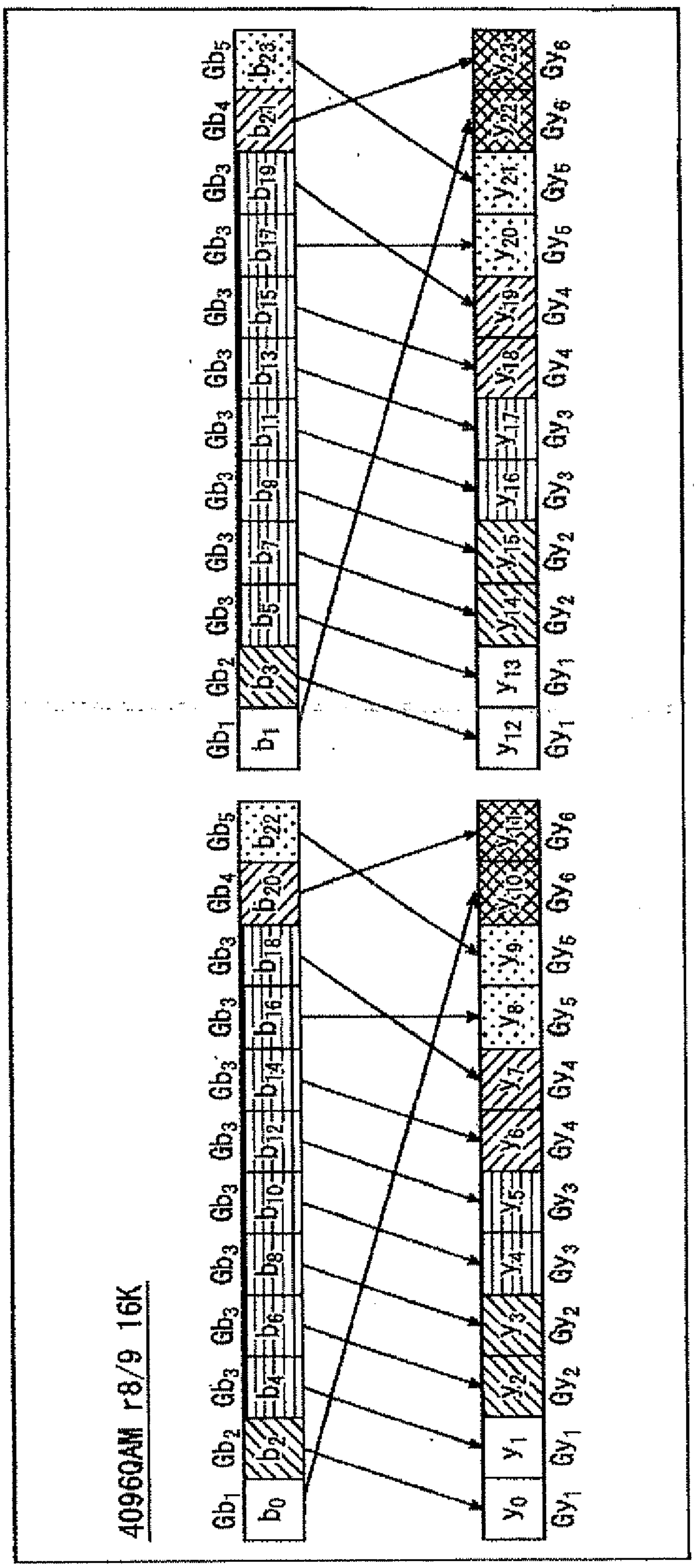
4096QAM r8/9 16K
$Gb_1$ $Gb_2$ $Gb_3$ $Gb_3$ $Gb_3$ $Gb_3$ $Gb_3$ $Gb_3$ $Gb_3$ $Gb_3$ $Gb_4$ $Gb_5$
$b_0$ $b_2$ $b_4$ $b_6$ $b_8$ $b_{10}$ $b_{12}$ $b_{14}$ $b_{16}$ $b_{18}$ $b_{20}$ $b_{22}$
$y_0$ $y_1$ $y_2$ $y_3$ $y_4$ $y_5$ $y_6$ $y_7$ $y_8$ $y_9$ $y_{10}$ $y_{11}$
$Gy_1$ $Gy_1$ $Gy_2$ $Gy_2$ $Gy_3$ $Gy_3$ $Gy_4$ $Gy_4$ $Gy_5$ $Gy_5$ $Gy_6$ $Gy_6$
$Gb_1$ $Gb_2$ $Gb_3$ $Gb_3$ $Gb_3$ $Gb_3$ $Gb_3$ $Gb_3$ $Gb_3$ $Gb_3$ $Gb_4$ $Gb_5$
$b_1$ $b_3$ $b_5$ $b_7$ $b_9$ $b_{11}$ $b_{13}$ $b_{15}$ $b_{17}$ $b_{19}$ $b_{21}$ $b_{23}$
$y_{12}$ $y_{13}$ $y_{14}$ $y_{15}$ $y_{16}$ $y_{17}$ $y_{18}$ $y_{19}$ $y_{20}$ $y_{21}$ $y_{22}$ $y_{23}$
$Gy_1$ $Gy_1$ $Gy_2$ $Gy_2$ $Gy_3$ $Gy_3$ $Gy_4$ $Gy_4$ $Gy_5$ $Gy_5$ $Gy_6$ $Gy_6$

FIG.156

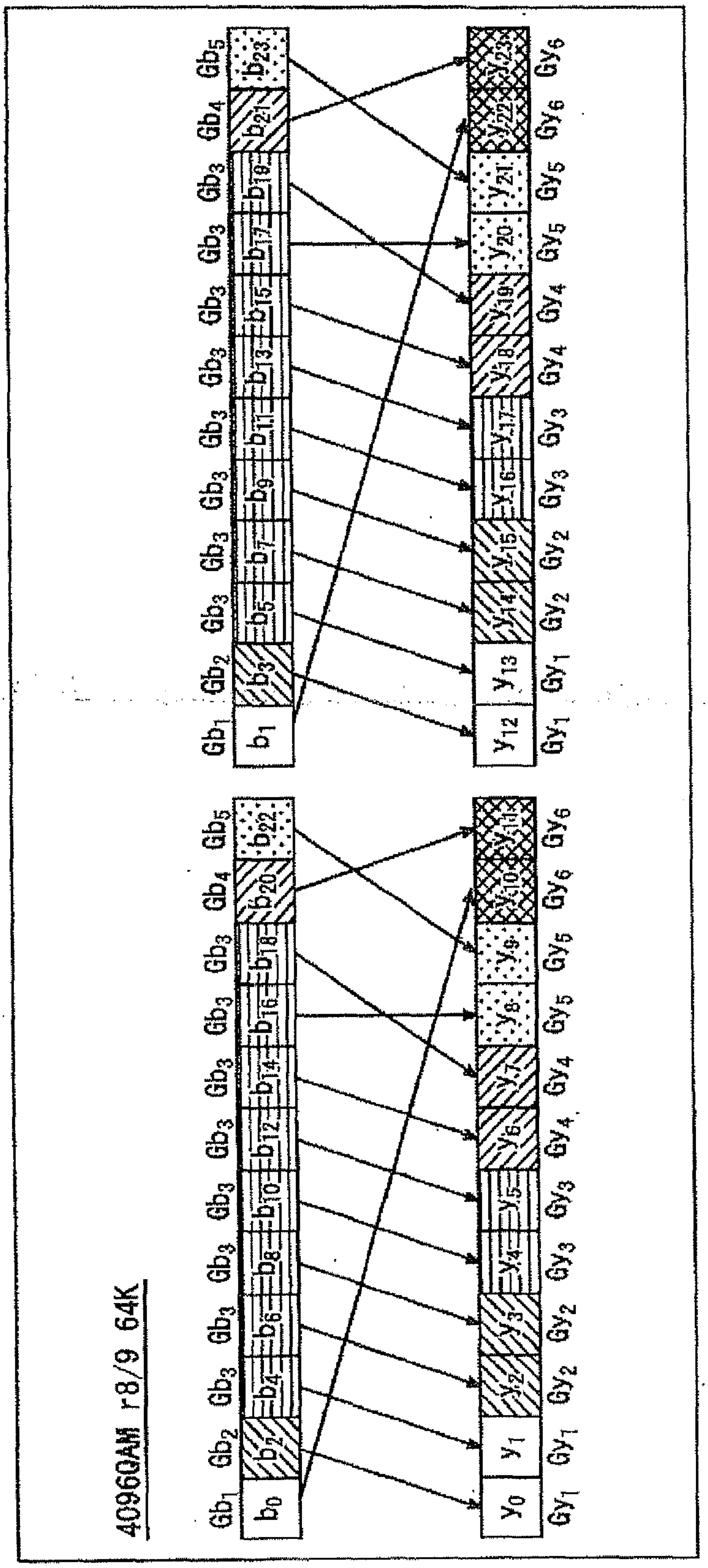

FIG.157

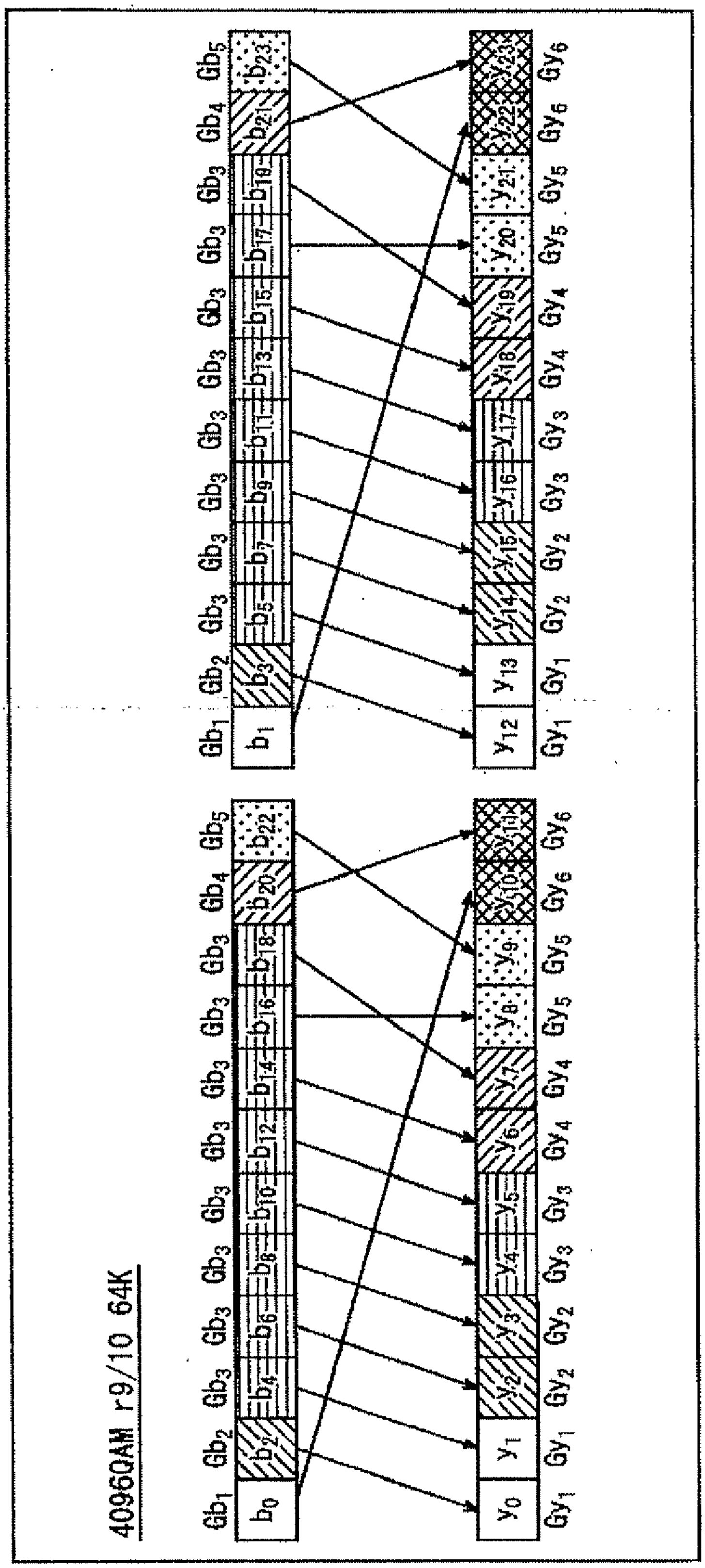

FIG. 158

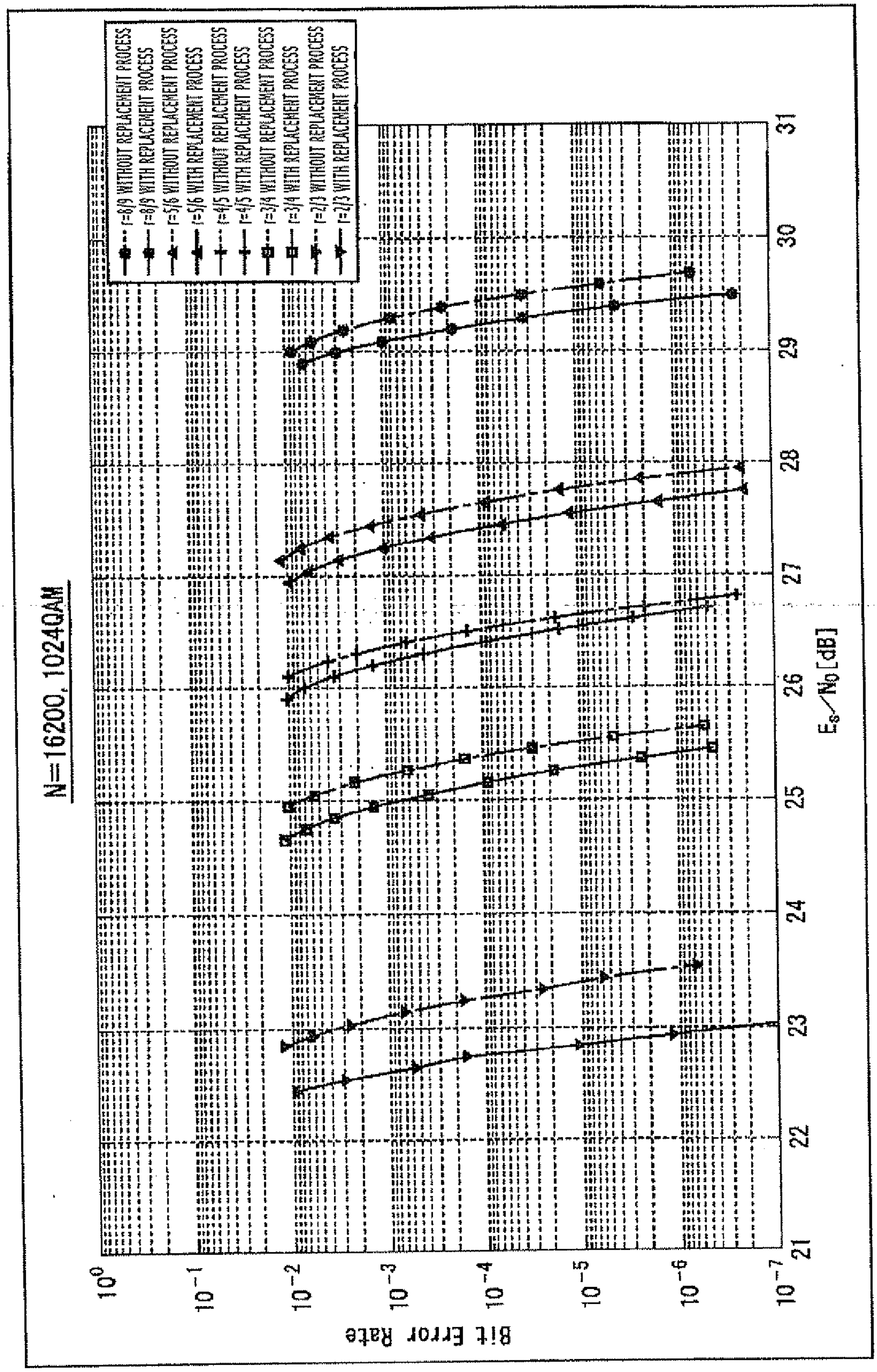
N=16200, 1024QAM
r=8/9 WITHOUT REPLACEMENT PROCESS
r=8/9 WITH REPLACEMENT PROCESS
r=5/6 WITHOUT REPLACEMENT PROCESS
r=5/6 WITH REPLACEMENT PROCESS
r=4/5 WITHOUT REPLACEMENT PROCESS
r=4/5 WITH REPLACEMENT PROCESS
r=3/4 WITHOUT REPLACEMENT PROCESS
r=3/4 WITH REPLACEMENT PROCESS
r=2/3 WITHOUT REPLACEMENT PROCESS
r=2/3 WITH REPLACEMENT PROCESS
Bit Error Rate
$10^0$
$10^{-1}$
$10^{-2}$
$10^{-3}$
$10^{-4}$
$10^{-5}$
$10^{-6}$
$10^{-7}$
21
22
23
24
25
26
27
28
29
30
31
$E_s/N_0$[dB]

FIG. 159

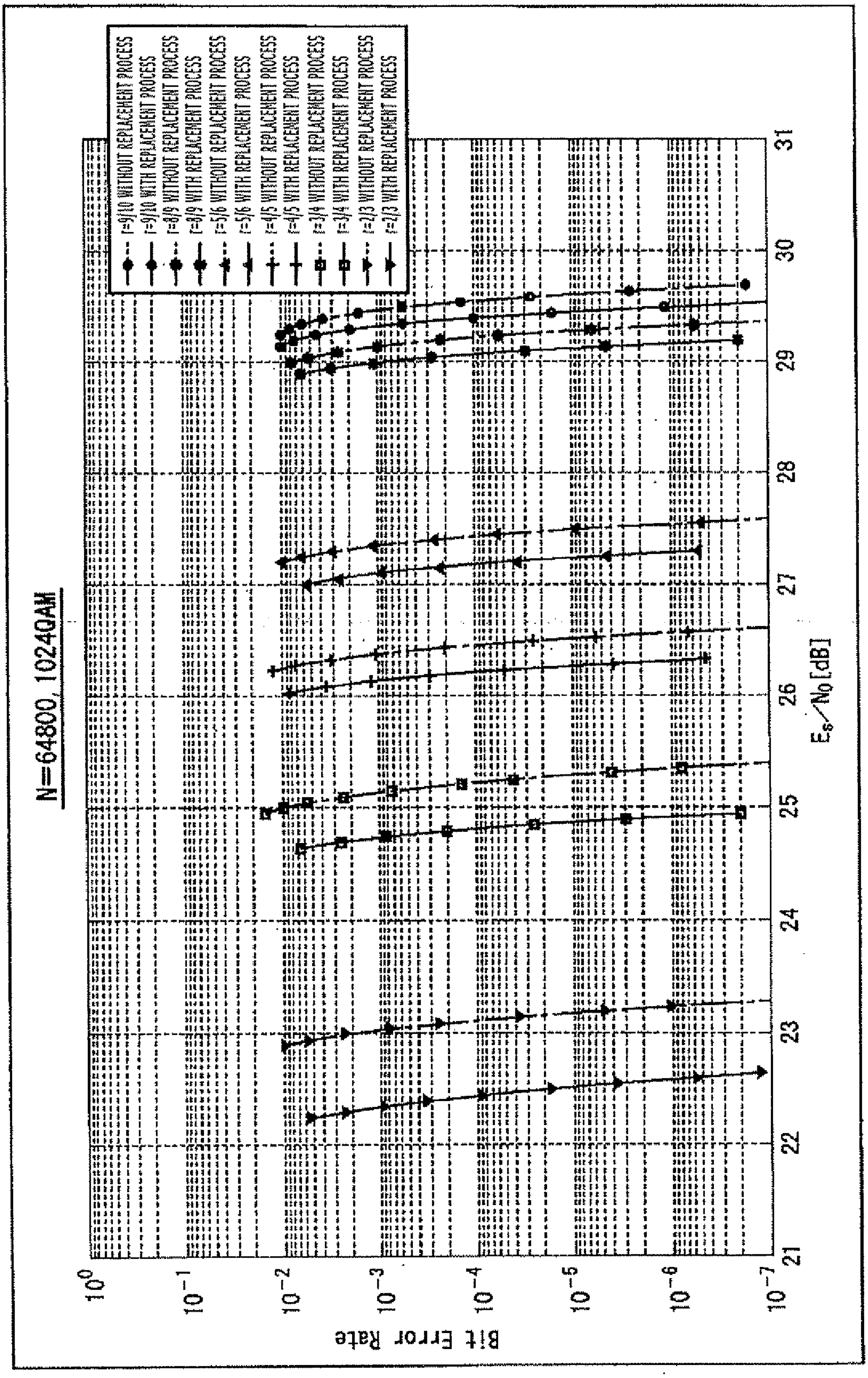
N=64800, 1024QAM
r=9/10 WITHOUT REPLACEMENT PROCESS
r=9/10 WITH REPLACEMENT PROCESS
r=8/9 WITHOUT REPLACEMENT PROCESS
r=8/9 WITH REPLACEMENT PROCESS
r=5/6 WITHOUT REPLACEMENT PROCESS
r=5/6 WITH REPLACEMENT PROCESS
r=4/5 WITHOUT REPLACEMENT PROCESS
r=4/5 WITH REPLACEMENT PROCESS
r=3/4 WITHOUT REPLACEMENT PROCESS
r=3/4 WITH REPLACEMENT PROCESS
r=2/3 WITHOUT REPLACEMENT PROCESS
r=2/3 WITH REPLACEMENT PROCESS
Bit Error Rate
$10^0$
$10^{-1}$
$10^{-2}$
$10^{-3}$
$10^{-4}$
$10^{-5}$
$10^{-6}$
$10^{-7}$
21
22
23
24
25
26
27
28
29
30
31
$E_s/N_0$ [dB]

FIG.160

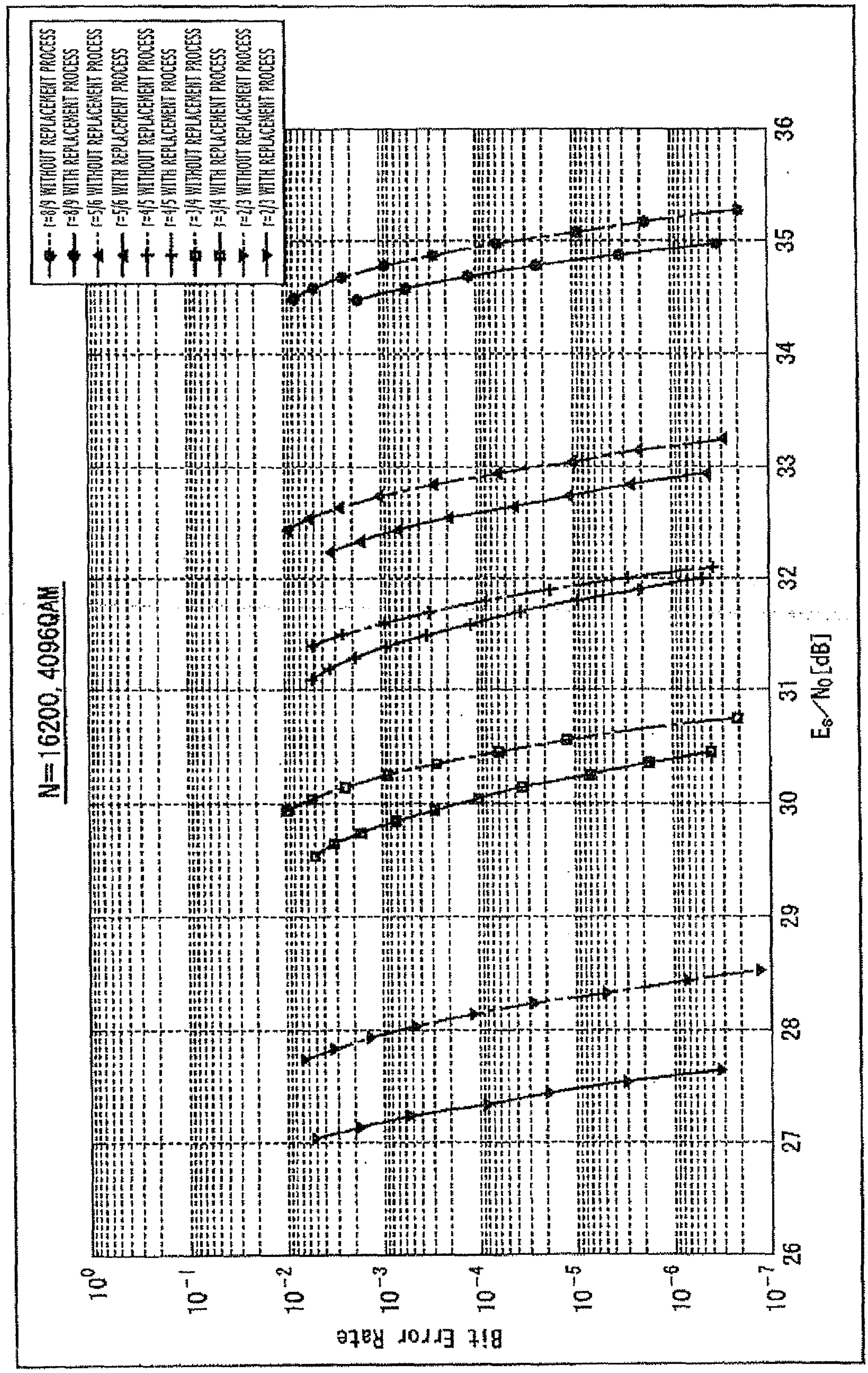
N=16200, 4096QAM
r=8/9 WITHOUT REPLACEMENT PROCESS
r=8/9 WITH REPLACEMENT PROCESS
r=5/6 WITHOUT REPLACEMENT PROCESS
r=5/6 WITH REPLACEMENT PROCESS
r=4/5 WITHOUT REPLACEMENT PROCESS
r=4/5 WITH REPLACEMENT PROCESS
r=3/4 WITHOUT REPLACEMENT PROCESS
r=3/4 WITH REPLACEMENT PROCESS
r=2/3 WITHOUT REPLACEMENT PROCESS
r=2/3 WITH REPLACEMENT PROCESS
Bit Error Rate
$10^0$
$10^{-1}$
$10^{-2}$
$10^{-3}$
$10^{-4}$
$10^{-5}$
$10^{-6}$
$10^{-7}$
26
27
28
29
30
31
32
33
34
35
36
$E_s/N_0$[dB]

FIG.161

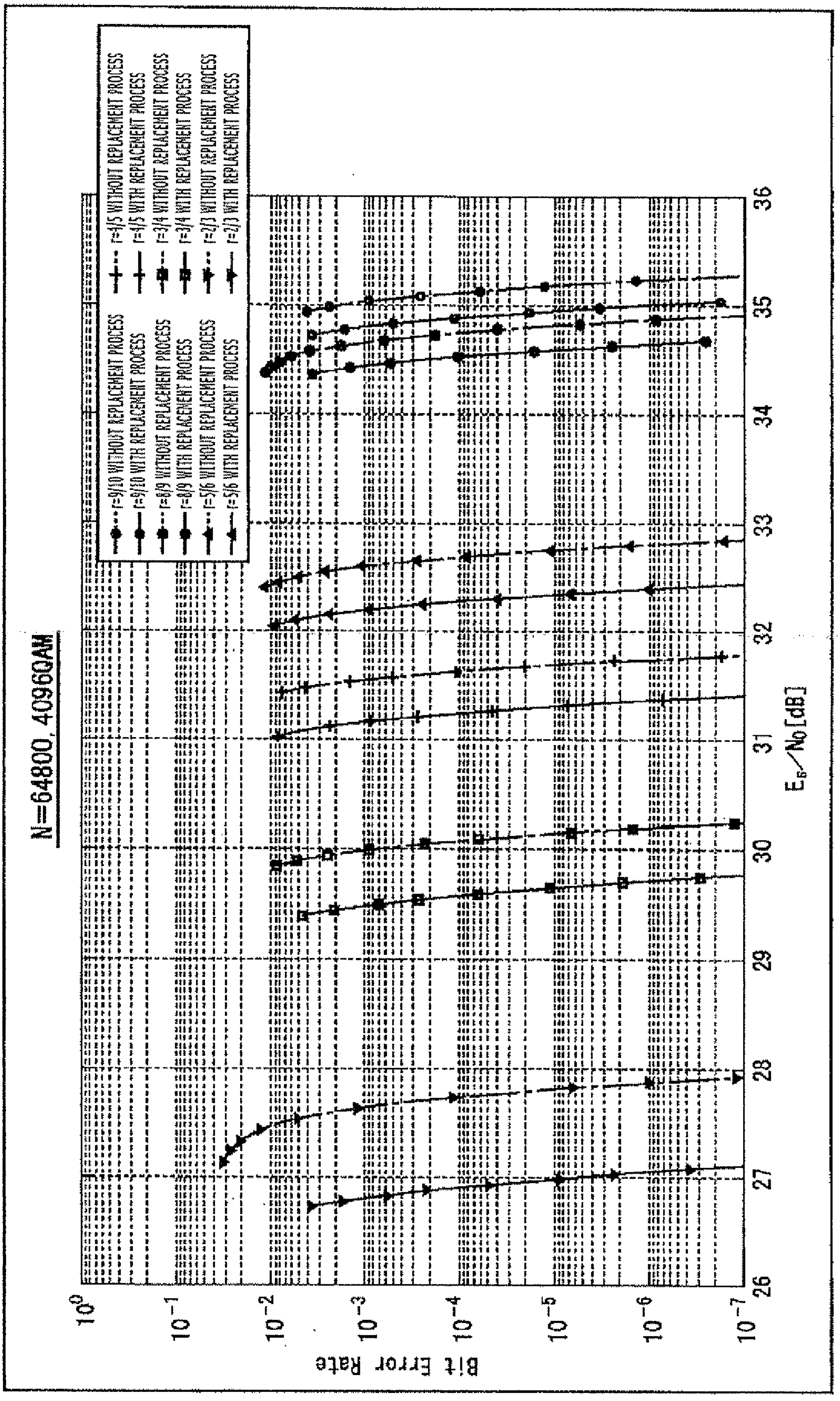
N=64800, 4096QAM
r=9/10 WITHOUT REPLACEMENT PROCESS
r=9/10 WITH REPLACEMENT PROCESS
r=8/9 WITHOUT REPLACEMENT PROCESS
r=8/9 WITH REPLACEMENT PROCESS
r=5/6 WITHOUT REPLACEMENT PROCESS
r=5/6 WITH REPLACEMENT PROCESS
r=4/5 WITHOUT REPLACEMENT PROCESS
r=4/5 WITH REPLACEMENT PROCESS
r=3/4 WITHOUT REPLACEMENT PROCESS
r=3/4 WITH REPLACEMENT PROCESS
r=2/3 WITHOUT REPLACEMENT PROCESS
r=2/3 WITH REPLACEMENT PROCESS
Bit Error Rate
$10^0$
$10^{-1}$
$10^{-2}$
$10^{-3}$
$10^{-4}$
$10^{-5}$
$10^{-6}$
$10^{-7}$
26
27
28
29
30
31
32
33
34
35
36
$E_b/N_0$[dB]

FIG.162

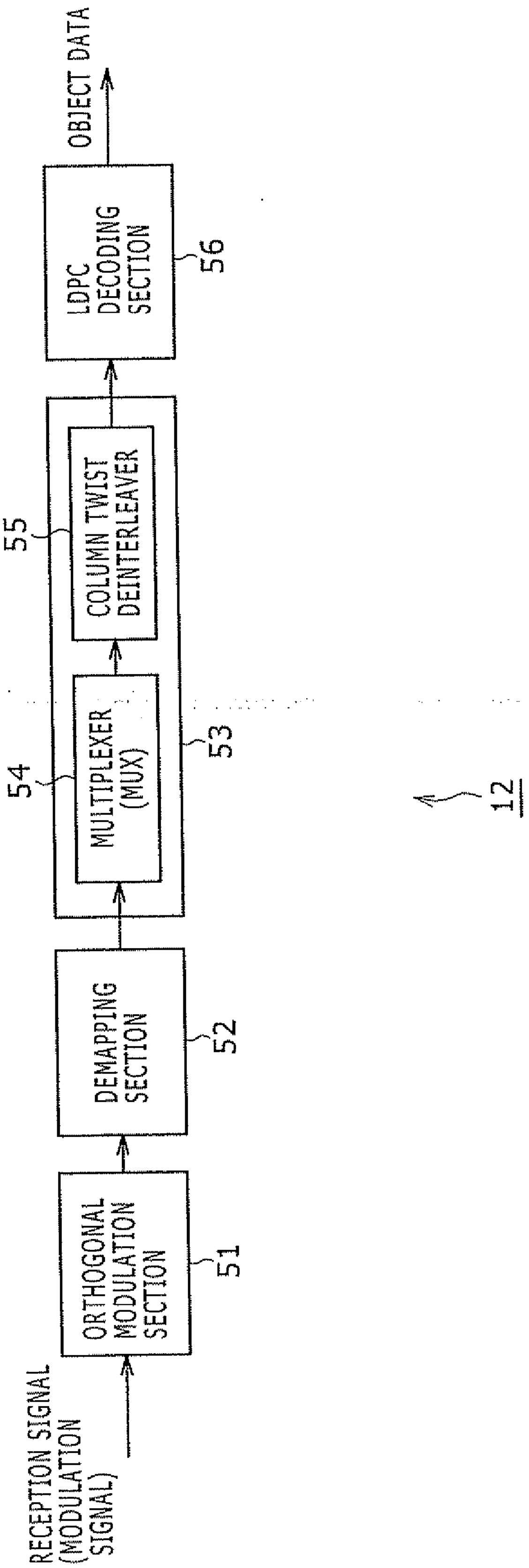
RECEPTION SIGNAL (MODULATION SIGNAL)
ORTHOGONAL MODULATION SECTION
51
DEMAPPING SECTION
52
MULTIPLEXER (MUX)
54
53
COLUMN TWIST DEINTERLEAVER
55
LDPC DECODING SECTION
56
OBJECT DATA
12

FIG.163

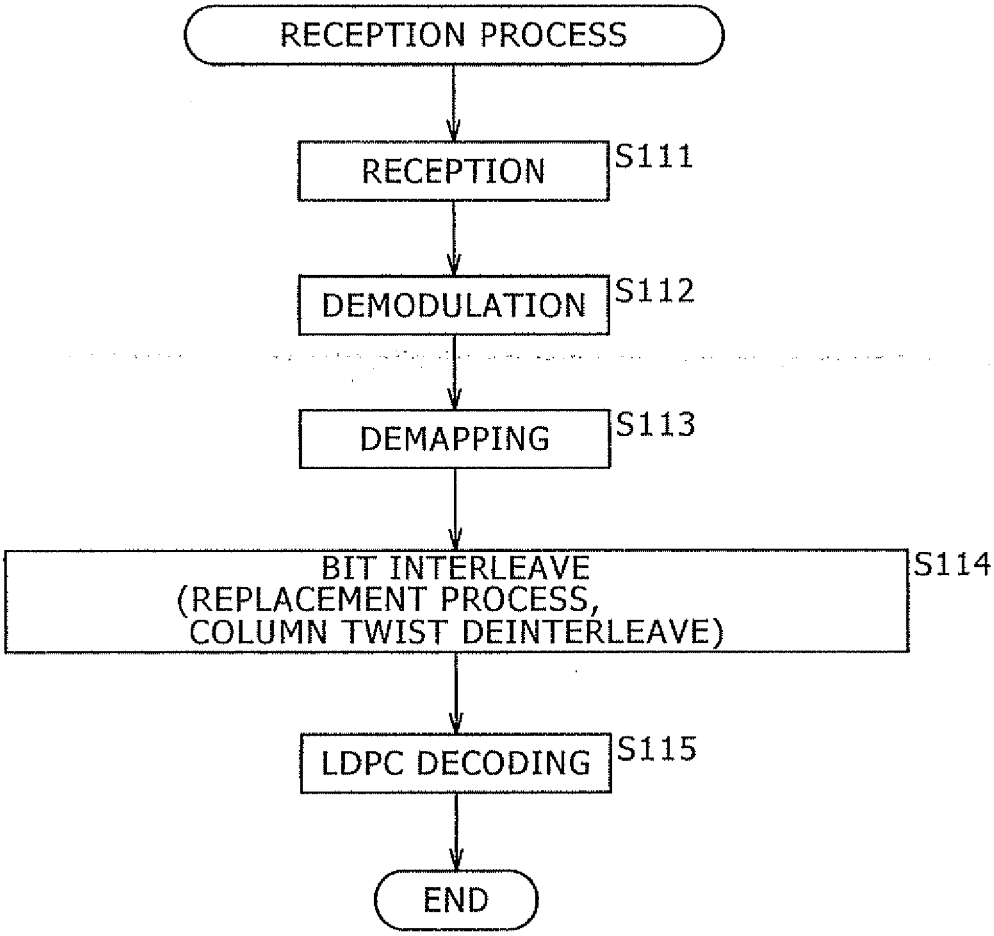
RECEPTION PROCESS
RECEPTION
S111
DEMODULATION
S112
DEMAPPING
S113
BIT INTERLEAVE
(REPLACEMENT PROCESS,
COLUMN TWIST DEINTERLEAVE)
S114
LDPC DECODING
S115
END

FIG.164

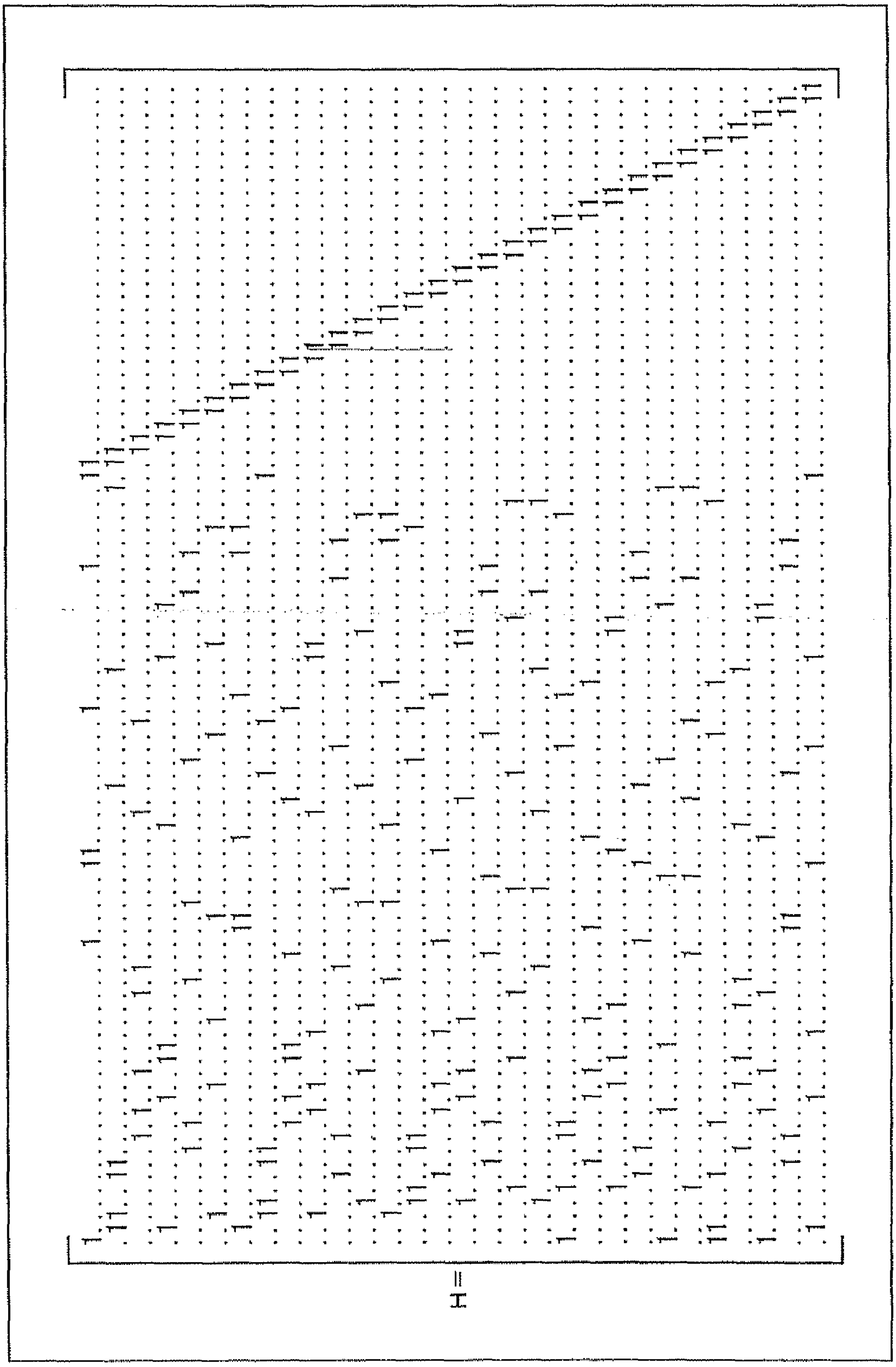

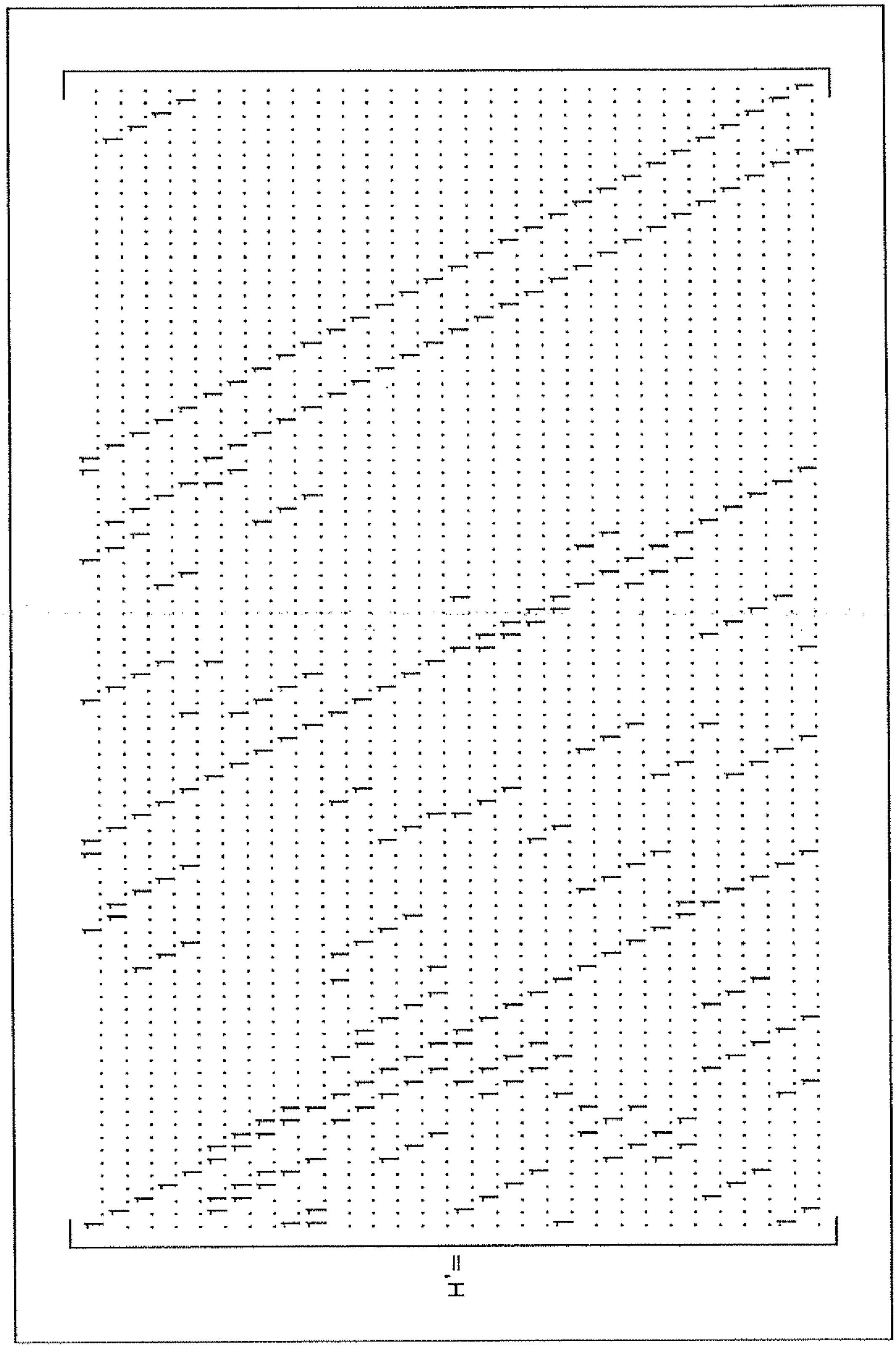


FIG.165

FIG.166

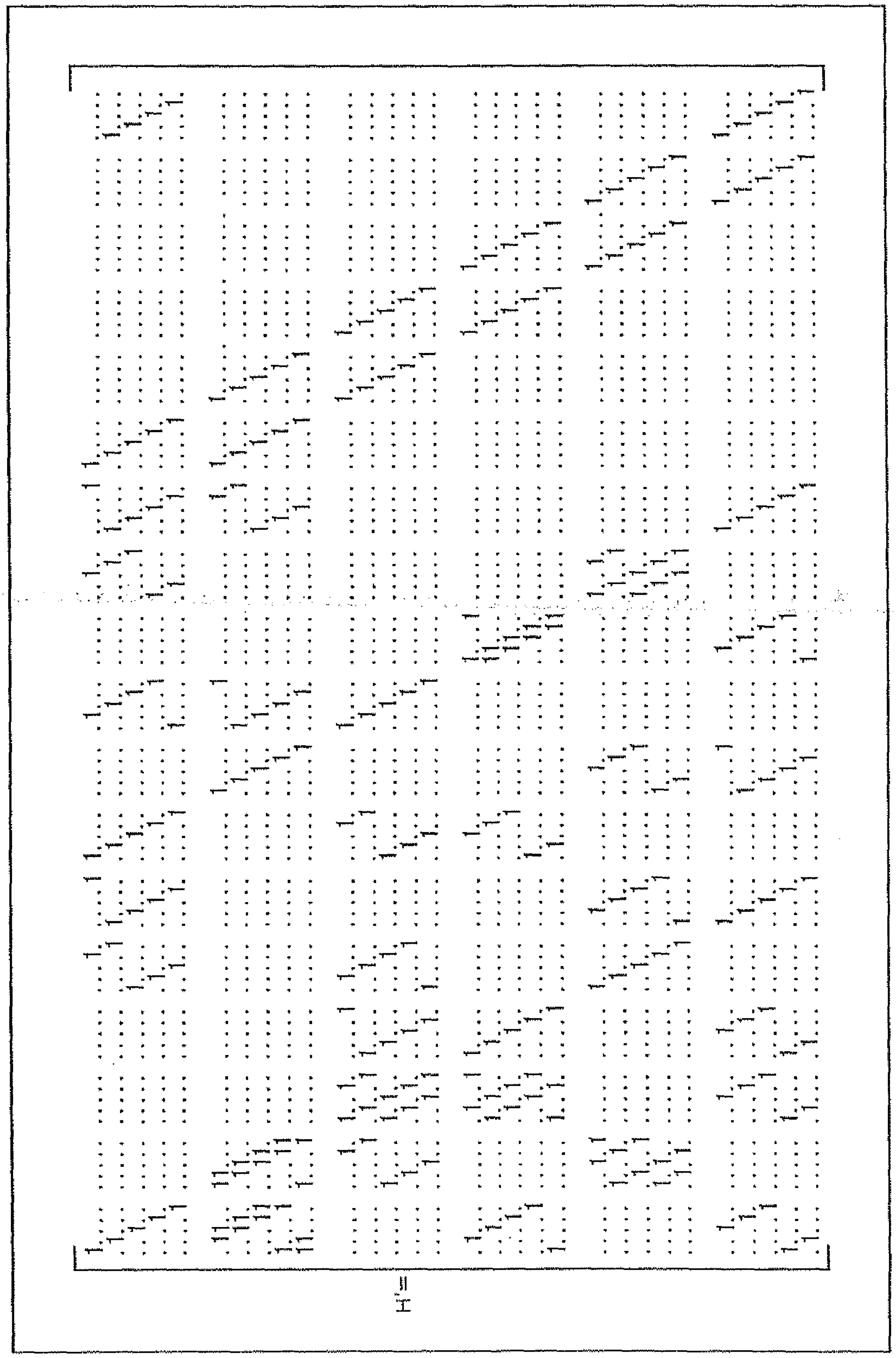

FIG. 167

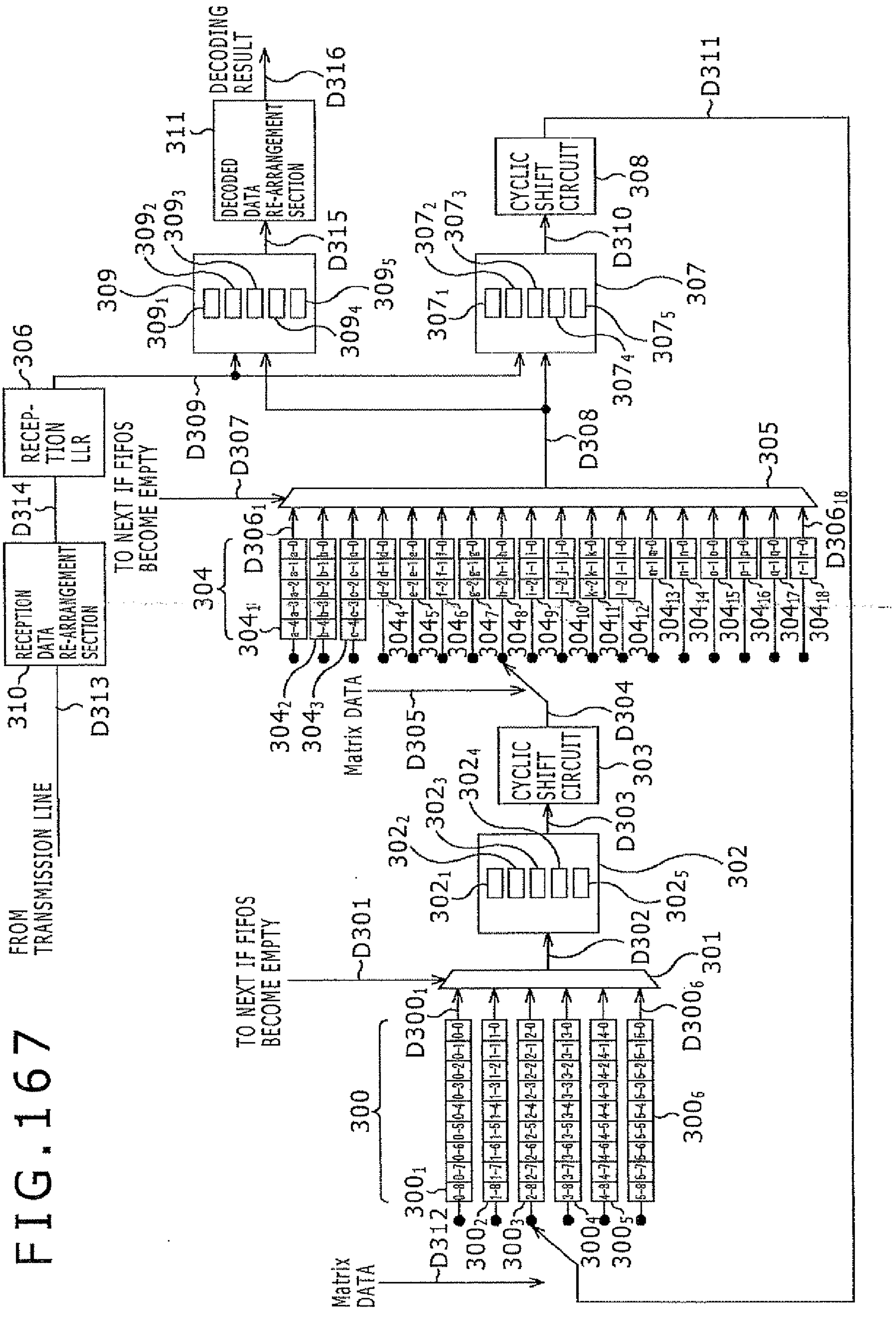
FROM TRANSMISSION LINE
RECEPTION DATA RE-ARRANGEMENT SECTION
RECEPTION LLR
DECODED DATA RE-ARRANGEMENT SECTION
DECODING RESULT
CYCLIC SHIFT CIRCUIT
CYCLIC SHIFT CIRCUIT
TO NEXT IF FIFOS BECOME EMPTY
TO NEXT IF FIFOS BECOME EMPTY
Matrix DATA
Matrix DATA
D301
D302
D303
D304
D305
D307
D308
D309
D310
D311
D312
D313
D314
D315
D316
300
301
302
303
304
305
306
307
308
309
310
311

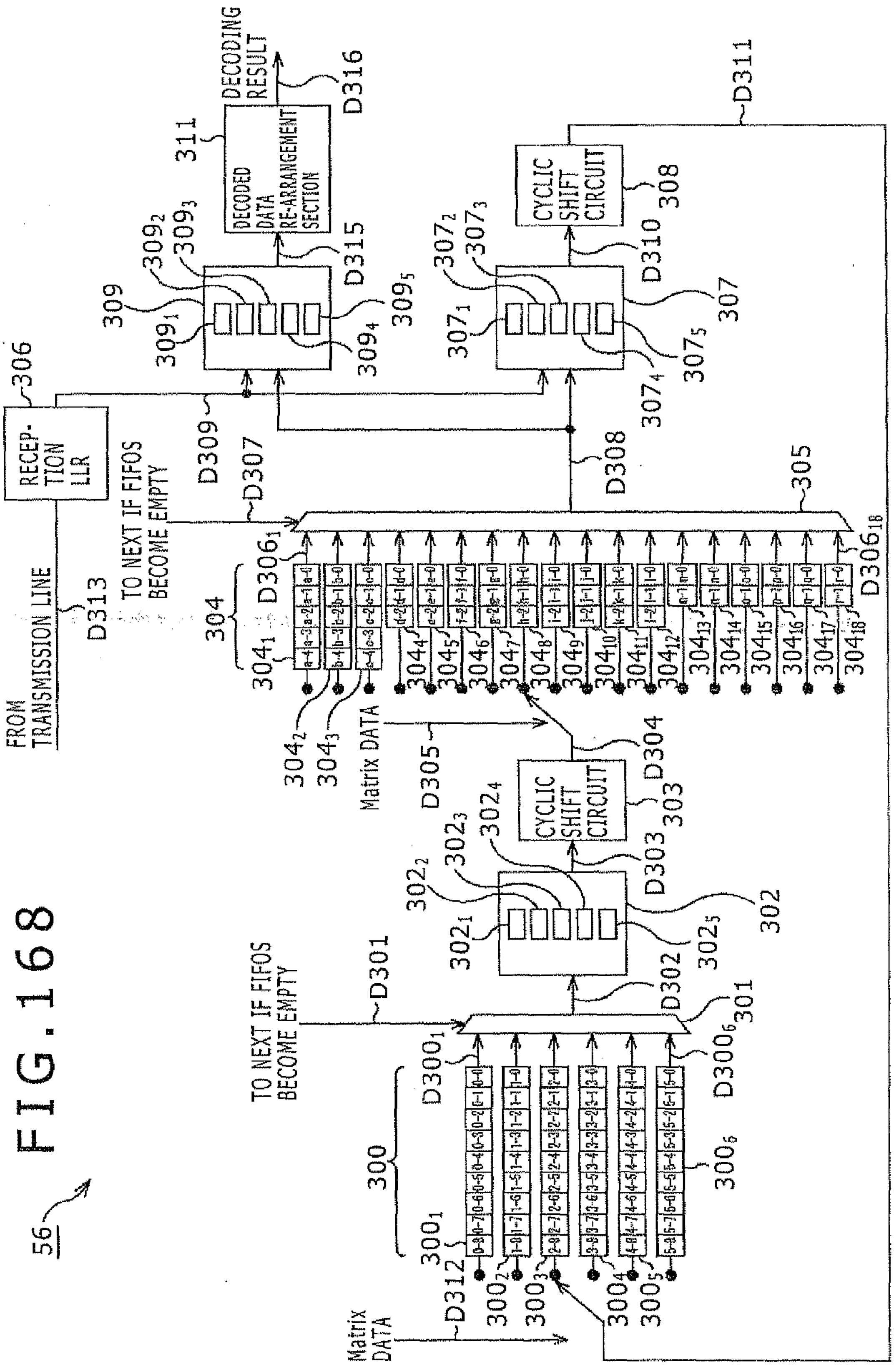
56
FROM TRANSMISSION LINE
D313
RECEPTION LLR
306
D309
D307
TO NEXT IF FIFOS BECOME EMPTY
309
D315
DECODED DATA RE-ARRANGEMENT SECTION
311
D316
DECODING RESULT
307
D310
CYCLIC SHIFT CIRCUIT
308
D311
D308
305
304
Matrix DATA
D305
D304
CYCLIC SHIFT CIRCUIT
303
D303
302
D302
301
D301
TO NEXT IF FIFOS BECOME EMPTY
300
D312
Matrix DATA

FIG. 168

FIG.169

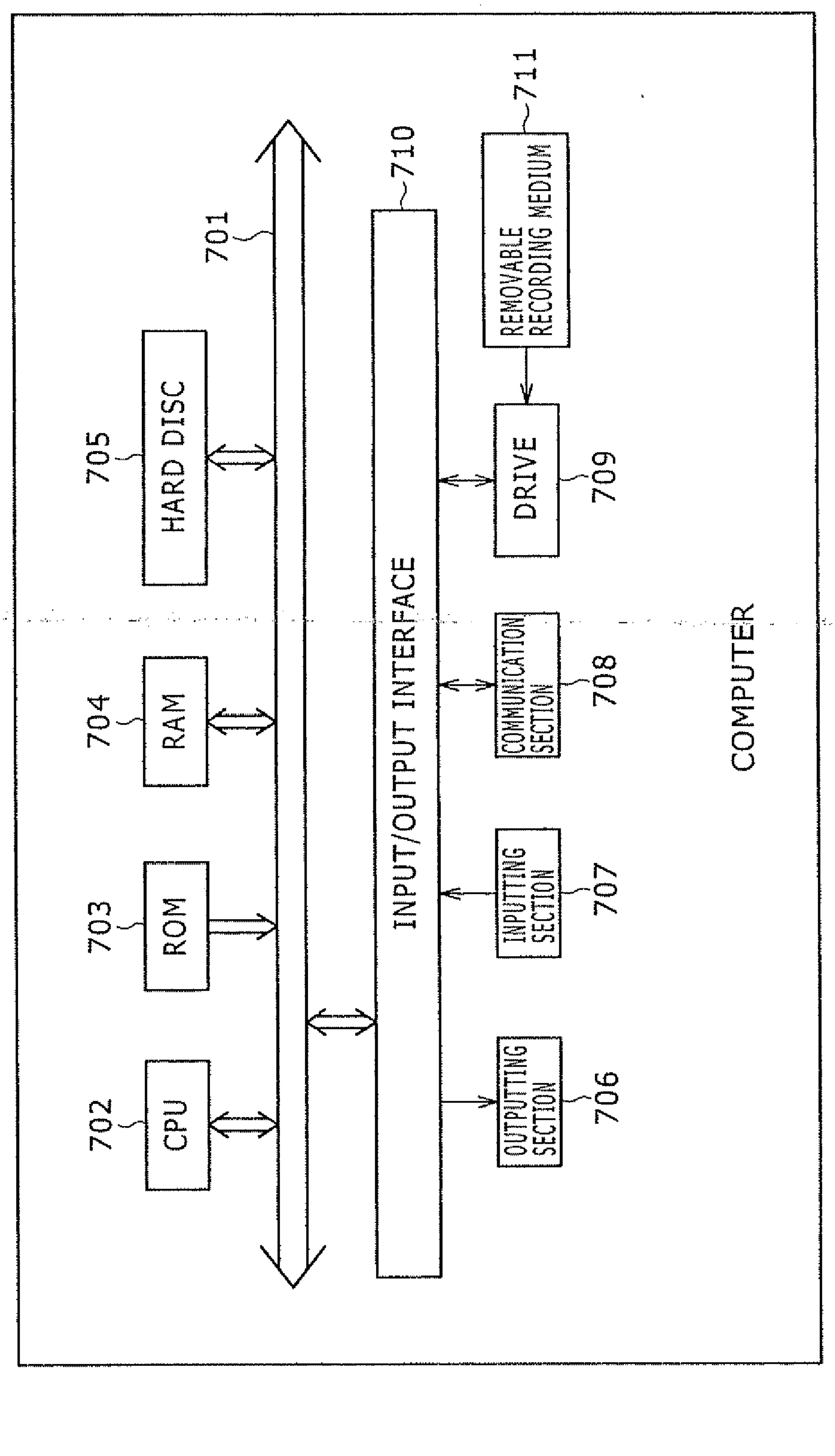
701
702
CPU
703
ROM
704
RAM
705
HARD DISC
INPUT/OUTPUT INTERFACE
710
706
OUTPUTTING SECTION
707
INPUTTING SECTION
708
COMMUNICATION SECTION
709
DRIVE
711
REMOVABLE RECORDING MEDIUM
COMPUTER

FIG.170

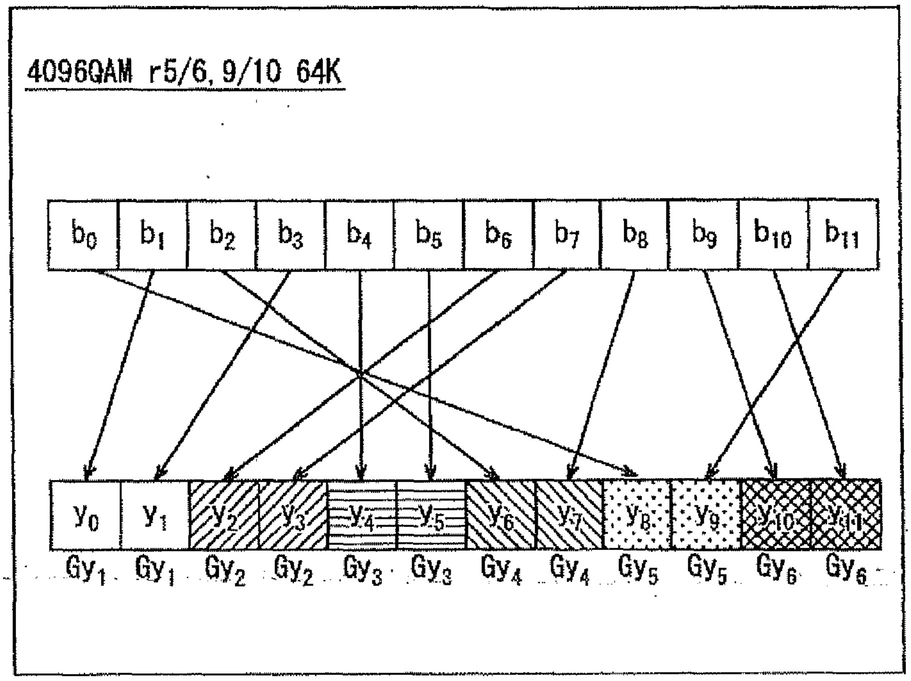
4096QAM r5/6, 9/10 64K
b0 b1 b2 b3 b4 b5 b6 b7 b8 b9 b10 b11
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6

FIG.171

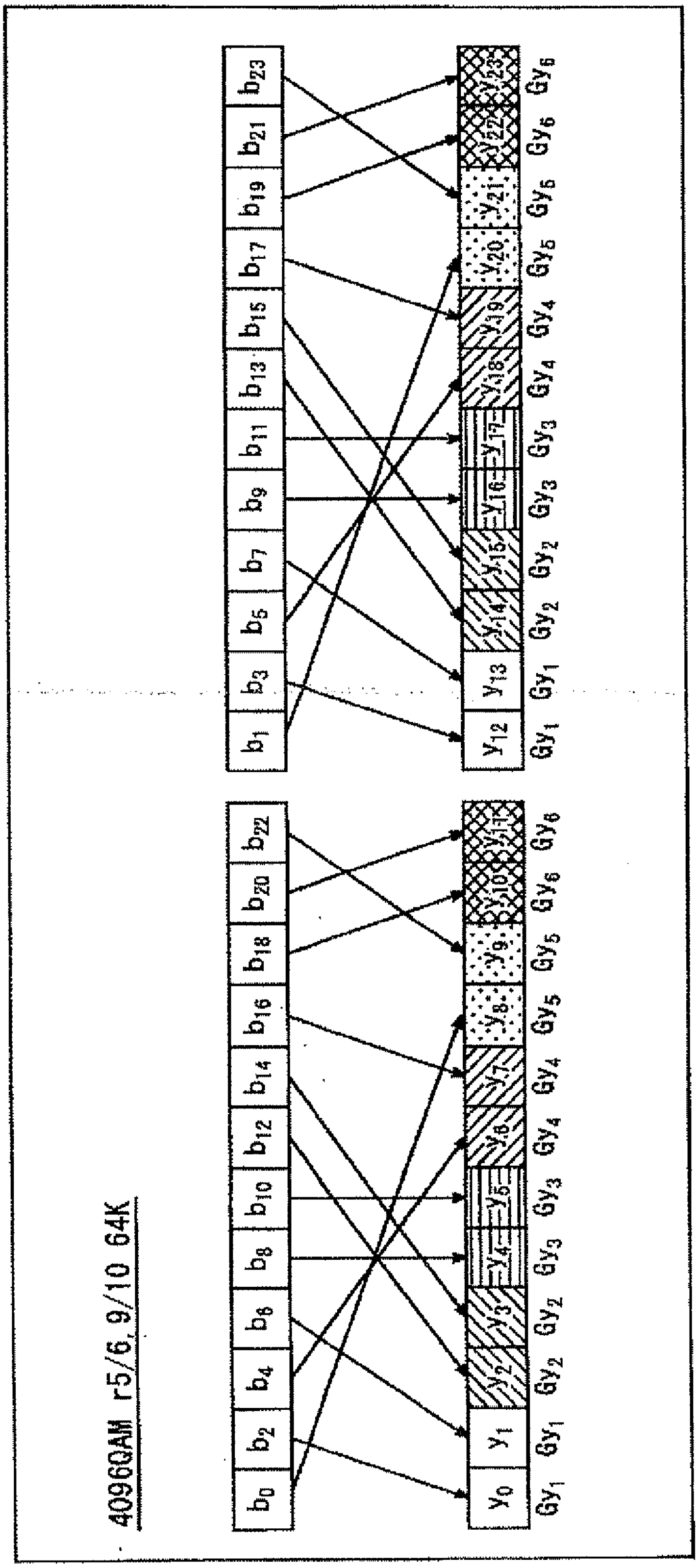
4096QAM r5/6, 9/10 64K
b0 b2 b4 b6 b8 b10 b12 b14 b16 b18 b20 b22
y0 y1 y2 y3 y4 y5 y6 y7 y8 y9 y10 y11
Gy1 Gy1 Gy2 Gy2 Gy3 Gy3 Gy4 Gy4 Gy5 Gy5 Gy6 Gy6
b1 b3 b5 b7 b9 b11 b13 b15 b17 b19 b21 b23
y12 y13 y14 y15 y16 y17 y18 y19 y20 y21 y22 y23
Gy1 Gy1 Gy2 Gy2 Gy3 Gy3 Gy4 Gy4 Gy5 Gy5 Gy6 Gy6

FIG. 172

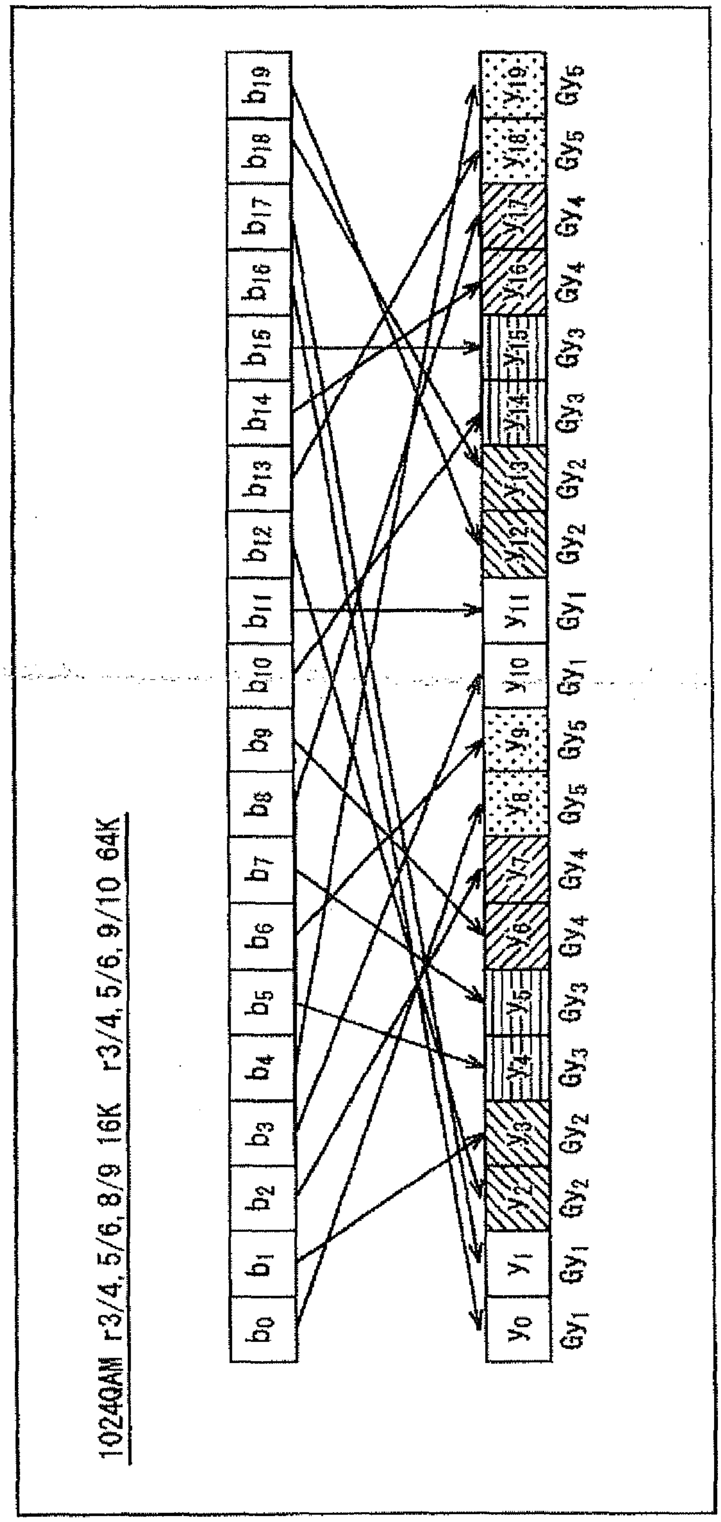
1024QAM r3/4, 5/6, 8/9 16K r3/4, 5/6, 9/10 64K
b0 b1 b2 b3 b4 b5 b6 b7 b8 b9 b10 b11 b12 b13 b14 b15 b16 b17 b18 b19
y0 y1 y2 y3 y4 y5 y6 y7 y8 y9 y10 y11 y12 y13 y14 y15 y16 y17 y18 y19
Gy1 Gy1 Gy2 Gy2 Gy3 Gy3 Gy4 Gy4 Gy5 Gy5 Gy1 Gy1 Gy2 Gy2 Gy3 Gy3 Gy4 Gy4 Gy5 Gy5

FIG.173

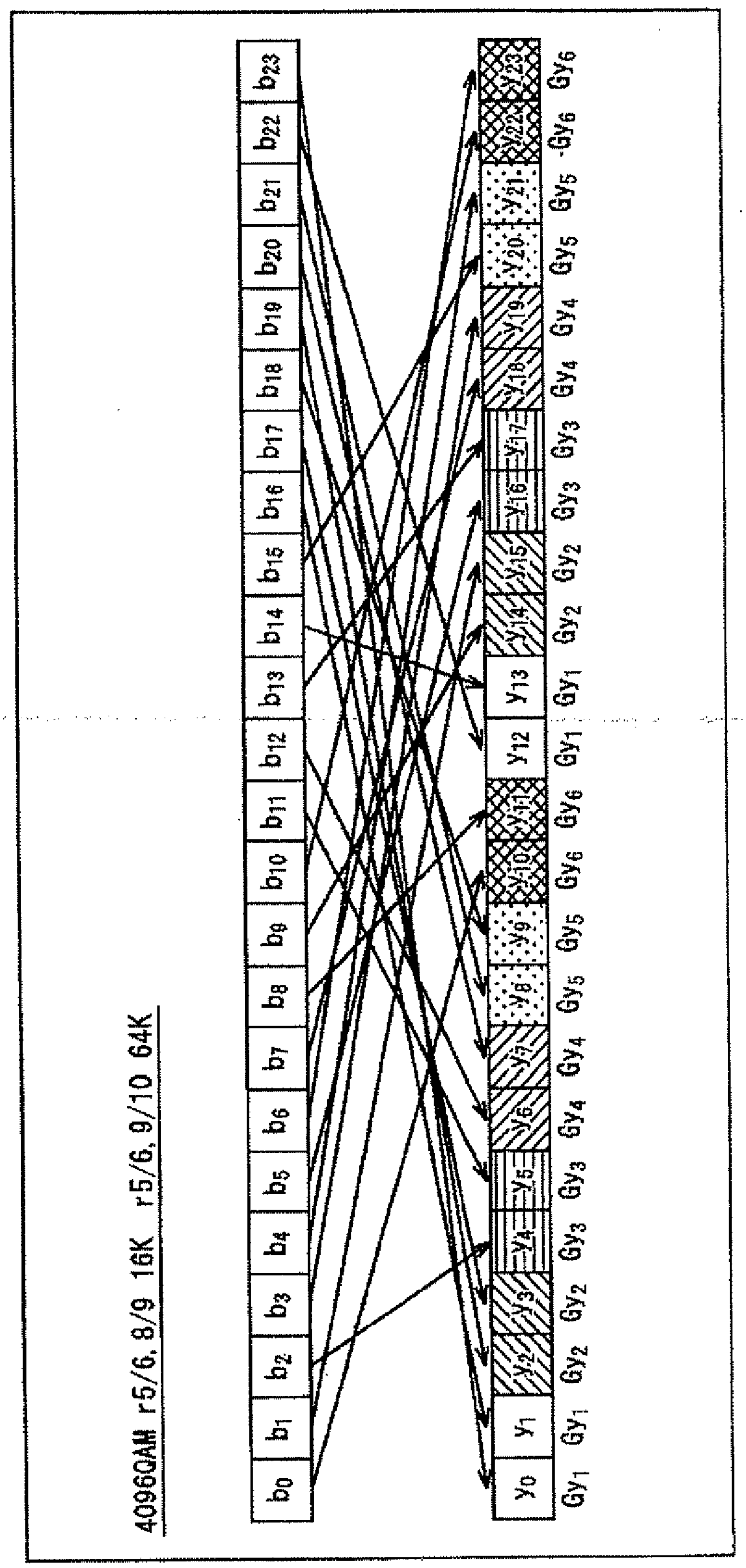
4096QAM r5/6, 8/9 16K r5/6, 9/10 64K
b0 b1 b2 b3 b4 b5 b6 b7 b8 b9 b10 b11 b12 b13 b14 b15 b16 b17 b18 b19 b20 b21 b22 b23
y0 y1 y2 y3 y4 y5 y6 y7 y8 y9 y10 y11 y12 y13 y14 y15 y16 y17 y18 y19 y20 y21 y22 y23
Gy1 Gy1 Gy2 Gy2 Gy3 Gy3 Gy4 Gy4 Gy5 Gy5 Gy6 Gy6 Gy1 Gy1 Gy2 Gy2 Gy3 Gy3 Gy4 Gy4 Gy5 Gy5 Gy6 Gy6

FIG.174

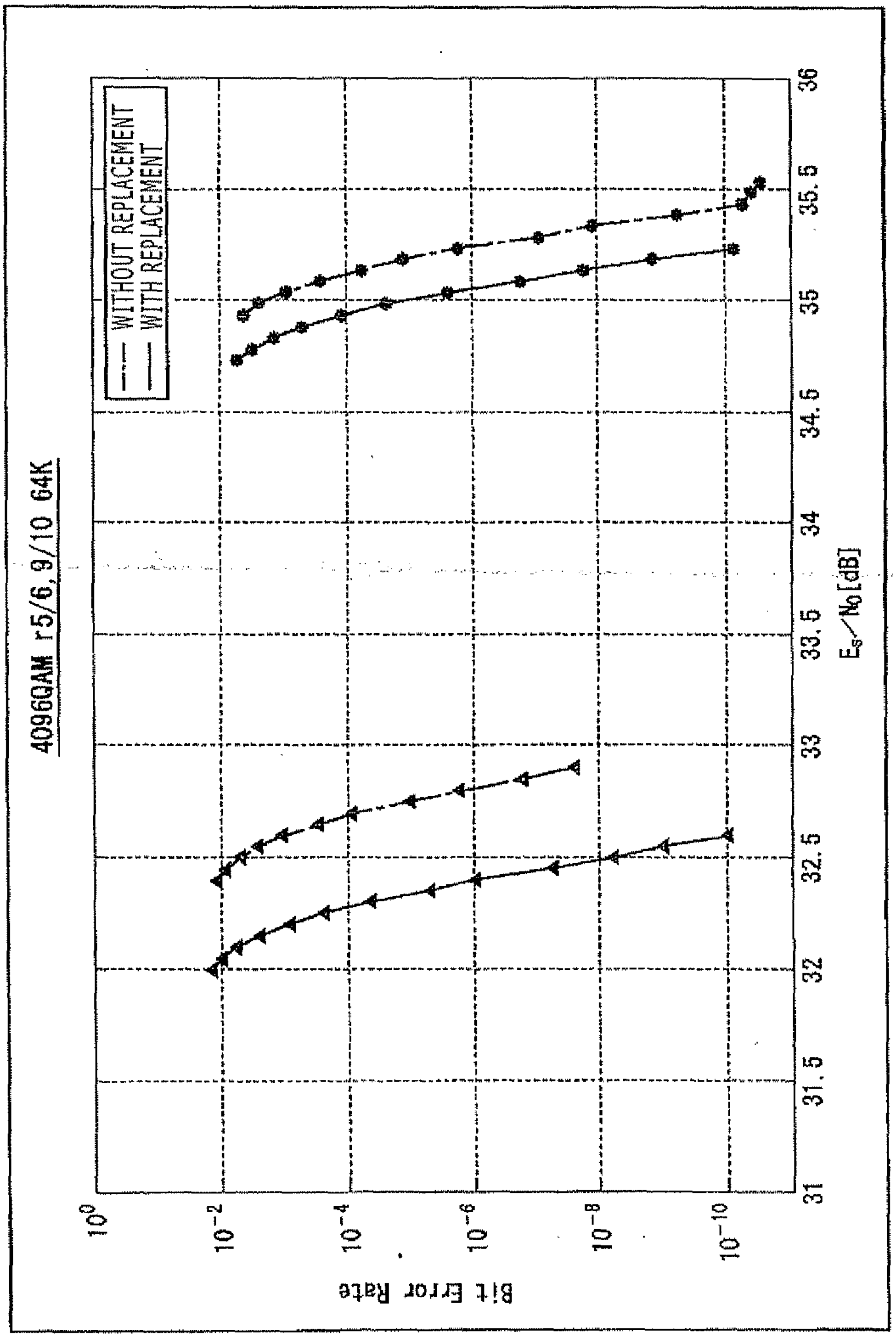
4096QAM r5/6,9/10 64K
WITHOUT REPLACEMENT
WITH REPLACEMENT
Bit Error Rate
$10^{0}$
$10^{-2}$
$10^{-4}$
$10^{-6}$
$10^{-8}$
$10^{-10}$
31
31.5
32
32.5
33
33.5
34
34.5
35
35.5
36
$E_s/N_0$[dB]

FIG. 175

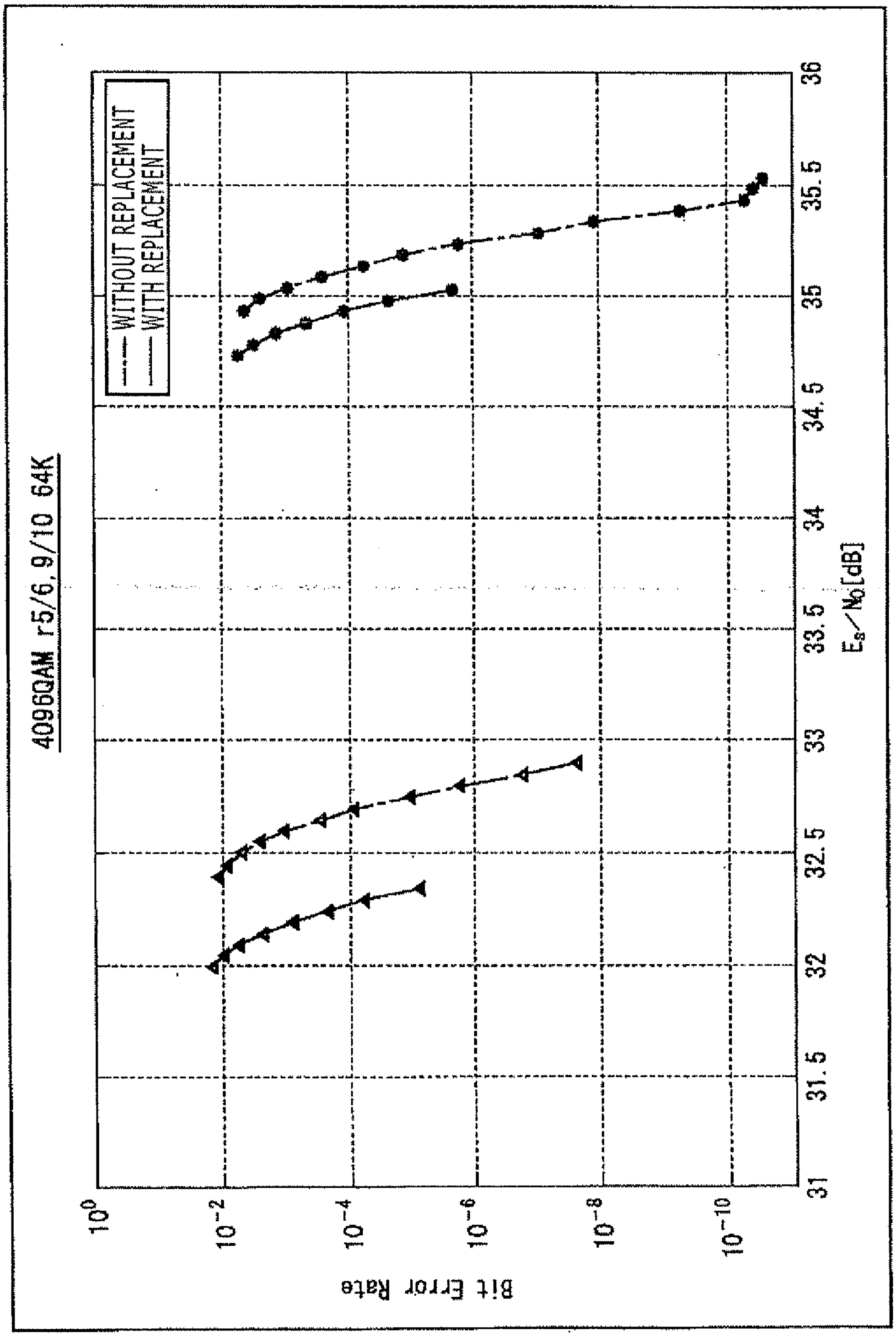
4096QAM r5/6, 9/10 64K
WITHOUT REPLACEMENT
WITH REPLACEMENT
Bit Error Rate
$10^0$
$10^{-2}$
$10^{-4}$
$10^{-6}$
$10^{-8}$
$10^{-10}$
31
31.5
32
32.5
33
33.5
34
34.5
35
35.5
36
$E_s/N_0$[dB]

FIG.176

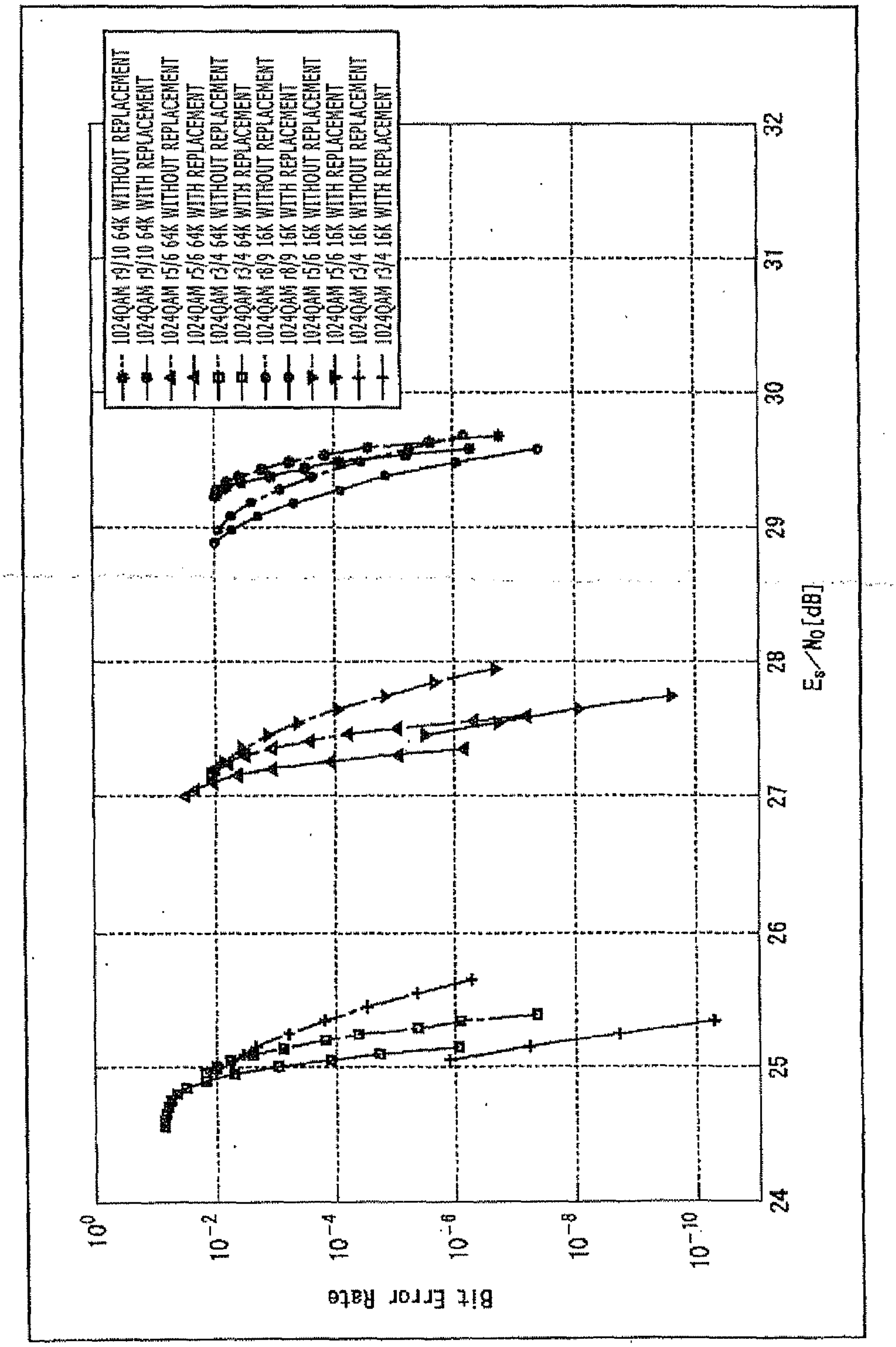
1024QAM r9/10 64K WITHOUT REPLACEMENT
1024QAM r9/10 64K WITH REPLACEMENT
1024QAM r5/6 64K WITHOUT REPLACEMENT
1024QAM r5/6 64K WITH REPLACEMENT
1024QAM r3/4 64K WITHOUT REPLACEMENT
1024QAM r3/4 64K WITH REPLACEMENT
1024QAM r8/9 16K WITHOUT REPLACEMENT
1024QAM r8/9 16K WITH REPLACEMENT
1024QAM r5/6 16K WITHOUT REPLACEMENT
1024QAM r5/6 16K WITH REPLACEMENT
1024QAM r3/4 16K WITHOUT REPLACEMENT
1024QAM r3/4 16K WITH REPLACEMENT
Bit Error Rate
$10^0$
$10^{-2}$
$10^{-4}$
$10^{-6}$
$10^{-8}$
$10^{-10}$
24
25
26
27
28
29
30
31
32
$E_s/N_0$[dB]

FIG.177

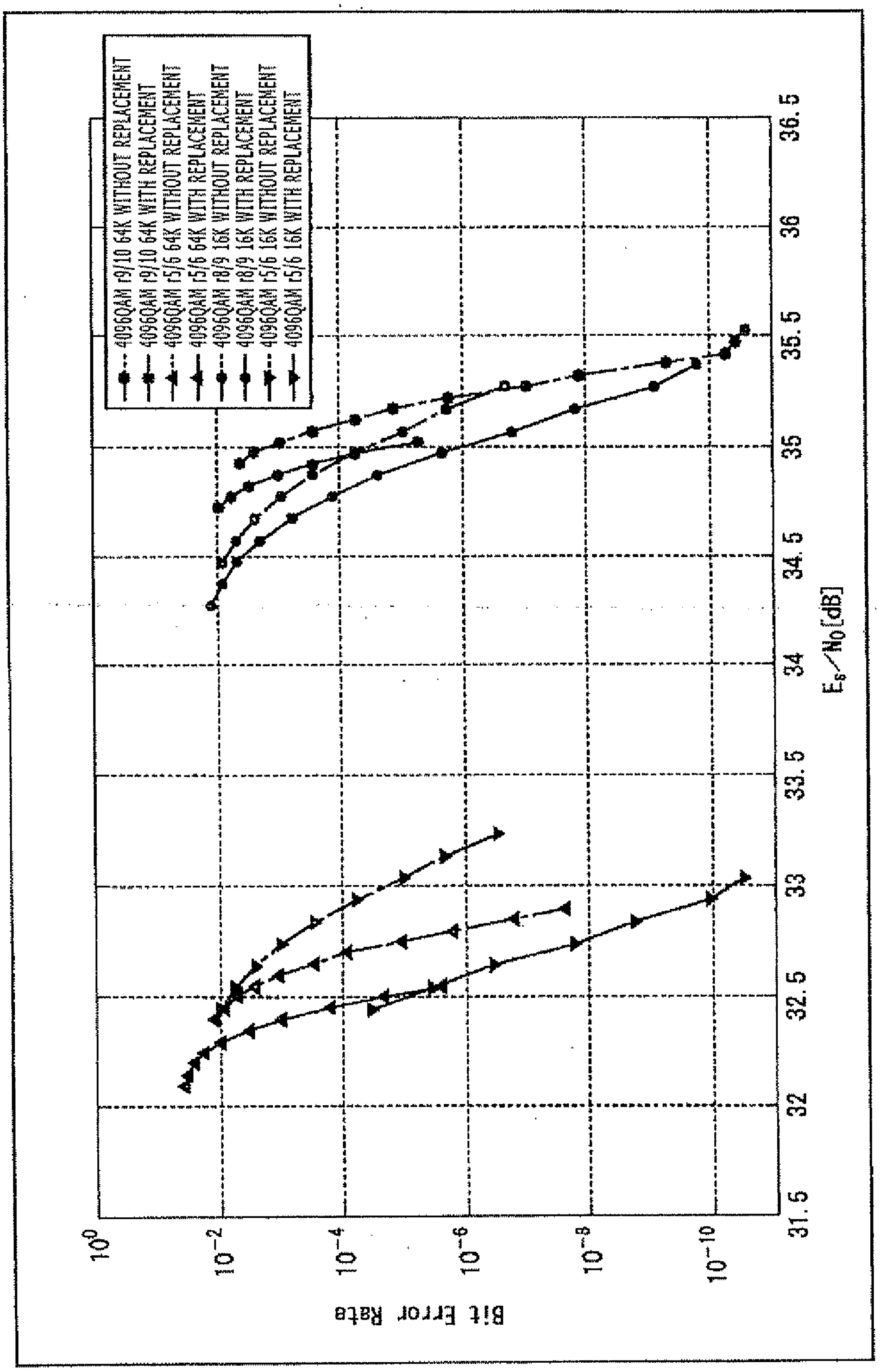
4096QAM r9/10 64K WITHOUT REPLACEMENT
4096QAM r9/10 64K WITH REPLACEMENT
4096QAM r5/6 64K WITHOUT REPLACEMENT
4096QAM r5/6 64K WITH REPLACEMENT
4096QAM r8/9 16K WITHOUT REPLACEMENT
4096QAM r8/9 16K WITH REPLACEMENT
4096QAM r5/6 16K WITHOUT REPLACEMENT
4096QAM r5/6 16K WITH REPLACEMENT
Bit Error Rate
$10^{0}$
$10^{-2}$
$10^{-4}$
$10^{-6}$
$10^{-8}$
$10^{-10}$
31.5
32
32.5
33
33.5
34
34.5
35
35.5
36
36.5
$E_s/N_0$[dB]

# FIG.178

r2/3 16K

0 2084 1613 1548 1286 1460 3196 4297 2481 3369 3451 4620 2622
1 122 1516 3448 2880 1407 1847 3799 3529 373 971 4358 3108
2 259 3399 929 2650 864 3996 3833 107 5287 164 3125 2350
3 342 3529
4 4198 2147
5 1880 4836
6 3864 4910
7 243 1542
8 3011 1436
9 2167 2512
10 4606 1003
11 2835 705
12 3426 2365
13 3848 2474
14 1360 1743
0 163 2536
1 2583 1180
2 1542 509
3 4418 1005
4 5212 5117
5 2155 2922
6 347 2696
7 226 4296
8 1560 487
9 3926 1640
10 149 2928
11 2364 563
12 635 688
13 231 1684
14 1129 3894

PARITY CHECK MATRIX INITIAL VALUE TABLE WHERE $r=\frac{2}{3}$, N=16200

# FIG.179

PARITY CHECK MATRIX INITIAL VALUE TABLE WHERE $r=\frac{2}{3}$, N=64800

r2/3 64K

0 10491 16043 506 12826 8065 8226 2767 240 18673 9279 10579 20928
1 17819 8313 6433 6224 5120 5824 12812 17187 9940 13447 13825 18483
2 17957 6024 8681 18628 12794 5915 14576 10970 12064 20437 4455 7151
3 19777 6183 9972 14536 8182 17749 11341 5556 4379 17434 15477 18532
4 4651 19689 1608 659 16707 14335 6143 3058 14618 17894 20684 5306
5 9778 2552 12096 12369 15198 16890 4851 3109 1700 18725 1997 15882
6 486 6111 13743 11537 5591 7433 15227 14145 1483 3887 17431 12430
7 20647 14311 11734 4180 8110 5525 12141 15761 18661 18441 10569 8192
8 3791 14759 15264 19918 10132 9062 10010 12786 10675 9682 19246 5454
9 19525 9485 7777 19999 8378 9209 3163 20232 6690 16518 716 7353
10 4588 6709 20202 10905 915 4317 11073 13576 16433 368 3508 21171
11 14072 4033 19959 12608 631 19494 14160 8249 10223 21504 12395 4322
12 13800 14161
13 2948 9647
14 14693 16027
15 20506 11082
16 1143 9020
17 13501 4014
18 1548 2190
19 12216 21556
20 2095 19897
21 4189 7958
22 15940 10048
23 515 12614
24 8501 8450
25 17595 16784
26 5913 8495
27 16394 10423
28 7409 6981
29 6678 15939
30 20344 12987
31 2510 14588
32 17918 6655
33 6703 19451
34 496 4217
35 7290 5766
36 10521 8925
37 20379 11905
38 4090 5838
39 19082 17040

# FIG.180

40 20233 12352
41 19365 19546
42 6249 19030
43 11037 19193
44 19760 11772
45 19644 7428
46 16076 3521
47 11779 21062
48 13062 9682
49 8934 5217
50 11087 3319
51 18892 4356
52 7894 3898
53 5963 4360
54 7346 11726
55 5182 5609
56 2412 17295
57 9845 20494
58 6687 1864
59 20564 5216
0 18226 17207
1 9380 8266
2 7073 3065
3 18252 13437
4 9161 15642
5 10714 10153
6 11585 9078
7 5359 9418
8 9024 9515
9 1206 16354
10 14994 1102
11 9375 20796
12 15964 6027
13 14789 6452
14 8002 18591
15 14742 14089
16 253 3045
17 1274 19286
18 14777 2044
19 13920 9900
20 452 7374

# FIG.181

| | | |
|---|---|---|
| 21 | 18206 | 9921 |
| 22 | 6131 | 5414 |
| 23 | 10077 | 9726 |
| 24 | 12045 | 5479 |
| 25 | 4322 | 7990 |
| 26 | 15616 | 5550 |
| 27 | 15561 | 10661 |
| 28 | 20718 | 7387 |
| 29 | 2518 | 18804 |
| 30 | 8984 | 2600 |
| 31 | 6516 | 17909 |
| 32 | 11148 | 98 |
| 33 | 20559 | 3704 |
| 34 | 7510 | 1569 |
| 35 | 16000 | 11692 |
| 36 | 9147 | 10303 |
| 37 | 16650 | 191 |
| 38 | 15577 | 18685 |
| 39 | 17167 | 20917 |
| 40 | 4256 | 3391 |
| 41 | 20092 | 17219 |
| 42 | 9218 | 5056 |
| 43 | 18429 | 8472 |
| 44 | 12093 | 20753 |
| 45 | 16345 | 12748 |
| 46 | 16023 | 11095 |
| 47 | 5048 | 17595 |
| 48 | 18995 | 4817 |
| 49 | 16483 | 3536 |
| 50 | 1439 | 16148 |
| 51 | 3661 | 3039 |
| 52 | 19010 | 18121 |
| 53 | 8968 | 11793 |
| 54 | 13427 | 18003 |
| 55 | 5303 | 3083 |
| 56 | 531 | 16668 |
| 57 | 4771 | 6722 |
| 58 | 5695 | 7960 |
| 59 | 3589 | 14630 |

# FIG.182

r3/4 16K

3 3198 478 4207 1481 1009 2616 1924 3437 554 683 1801
4 2681 2135
5 3107 4027
6 2637 3373
7 3830 3449
8 4129 2060
9 4184 2742
10 3946 1070
11 2239 984
0 1458 3031
1 3003 1328
2 1137 1716
3 132 3725
4 1817 638
5 1774 3447
6 3632 1257
7 542 3694
8 1015 1945
9 1948 412
10 995 2238
11 4141 1907
0 2480 3079
1 3021 1088
2 713 1379
3 997 3903
4 2323 3361
5 1110 986
6 2532 142
7 1690 2405
8 1298 1881
9 615 174
10 1648 3112
11 1415 2808

PARITY CHECK MATRIX INITIAL VALUE TABLE WHERE $r=\frac{3}{4}$, N=16200

# FIG.183

PARITY CHECK MATRIX INITIAL VALUE TABLE WHERE $r=\frac{3}{4}$, N=64800

r3/4 64K

0 6385 7901 14611 13389 11200 3252 5243 2504 2722 821 7374
1 11359 2698 357 13824 12772 7244 6752 15310 852 2001 11417
2 7862 7977 6321 13612 12197 14449 15137 13860 1708 6399 13444
3 1560 11804 6975 13292 3646 3812 8772 7306 5795 14327 7866
4 7626 11407 14599 9689 1628 2113 10809 9283 1230 15241 4870
5 1610 5699 15876 9446 12515 1400 6303 5411 14181 13925 7358
6 4059 8836 3405 7853 7992 15336 5970 10368 10278 9675 4651
7 4441 3963 9153 2109 12683 7459 12030 12221 629 15212 406
8 6007 8411 5771 3497 543 14202 875 9186 6235 13908 3563
9 3232 6625 4795 546 9781 2071 7312 3399 7250 4932 12652
10 8820 10088 11090 7069 6585 13134 10158 7183 488 7455 9238
11 1903 10818 119 215 7558 11046 10615 11545 14784 7961 15619
12 3655 8736 4917 15874 5129 2134 15944 14768 7150 2692 1469
13 8316 3820 505 8923 6757 806 7957 4216 15589 13244 2622
14 14463 4852 15733 3041 11193 12860 13673 8152 6551 15108 8758
15 3149 11981
16 13416 6906
17 13098 13352
18 2009 14460
19 7207 4314
20 3312 3945
21 4418 6248
22 2669 13975
23 7571 9023
24 14172 2967
25 7271 7138
26 6135 13670
27 7490 14559
28 8657 2466
29 8599 12834
30 3470 3152
31 13917 4365
32 6024 13730
33 10973 14182
34 2464 13167
35 5281 15049
36 1103 1849
37 2058 1069
38 9654 6095
39 14311 7667

# FIG.184

40 15617 8146
41 4588 11218
42 13660 6243
43 8578 7874
44 11741 2686
0 1022 1264
1 12604 9965
2 8217 2707
3 3156 11793
4 354 1514
5 6978 14058
6 7922 16079
7 15087 12138
8 5053 6470
9 12687 14932
10 15458 1763
11 8121 1721
12 12431 549
13 4129 7091
14 1426 8415
15 9783 7604
16 6295 11329
17 1409 12061
18 8065 9087
19 2918 8438
20 1293 14115
21 3922 13851
22 3851 4000
23 5865 1768
24 2655 14957
25 5565 6332
26 4303 12631
27 11653 12236
28 16025 7632
29 4655 14128
30 9584 13123
31 13987 9597
32 15409 12110
33 8754 15490
34 7416 15325
35 2909 15549

# FIG.185

36 2995 8257
37 9406 4791
38 11111 4854
39 2812 8521
40 8476 14717
41 7820 15360
42 1179 7939
43 2357 8678
44 7703 6216
0 3477 7067
1 3931 13845
2 7675 12899
3 1754 8187
4 7785 1400
5 9213 5891
6 2494 7703
7 2576 7902
8 4821 15682
9 10426 11935
10 1810 904
11 11332 9264
12 11312 3570
13 14916 2650
14 7679 7842
15 6089 13084
16 3938 2751
17 8509 4648
18 12204 8917
19 5749 12443
20 12613 4431
21 1344 4014
22 8488 13850
23 1730 14896
24 14942 7126
25 14983 8863
26 6578 8564
27 4947 396
28 297 12805
29 13878 6692
30 11857 11186
31 14395 11493

FIG.186

32 16145 12251
33 13462 7428
34 14526 13119
35 2535 11243
36 6465 12690
37 6872 9334
38 15371 14023
39 8101 10187
40 11963 4848
41 15125 6119
42 8051 14465
43 11139 5167
44 2883 14521

# FIG.187

r4/5 16K

5 896 1565
6 2493 184
7 212 3210
8 727 1339
9 3428 612
0 2663 1947
1 230 2695
2 2025 2794
3 3039 283
4 862 2889
5 376 2110
6 2034 2286
7 951 2068
8 3108 3542
9 307 1421
0 2272 1197
1 1800 3280
2 331 2308
3 465 2552
4 1038 2479
5 1383 343
6 94 236
7 2619 121
8 1497 2774
9 2116 1855
0 722 1584
1 2767 1881
2 2701 1610
3 3283 1732
4 168 1099
5 3074 243
6 3460 945
7 2049 1746
8 566 1427
9 3545 1168

PARITY CHECK MATRIX INITIAL VALUE TABLE WHERE $r=\frac{4}{5}$, N=16200

# FIG.188

PARITY CHECK MATRIX INITIAL VALUE TABLE WHERE $r=\frac{4}{5}$, N=64800

r4/5 64K

0 149 11212 5575 6360 12559 8108 8505 408 10026 12828
1 5237 490 10677 4998 3869 3734 3092 3509 7703 10305
2 8742 5553 2820 7085 12116 10485 564 7795 2972 2157
3 2699 4304 8350 712 2841 3250 4731 10105 517 7516
4 12067 1351 11992 12191 11267 5161 537 6166 4246 2363
5 6828 7107 2127 3724 5743 11040 10756 4073 1011 3422
6 11259 1216 9526 1466 10816 940 3744 2815 11506 11573
7 4549 11507 1118 1274 11751 5207 7854 12803 4047 6484
8 8430 4115 9440 413 4455 2262 7915 12402 8579 7052
9 3885 9126 5665 4505 2343 253 4707 3742 4166 1556
10 1704 8936 6775 8639 8179 7954 8234 7850 8883 8713
11 11716 4344 9087 11264 2274 8832 9147 11930 6054 5455
12 7323 3970 10329 2170 8262 3854 2087 12899 9497 11700
13 4418 1467 2490 5841 817 11453 533 11217 11962 5251
14 1541 4525 7976 3457 9536 7725 3788 2982 6307 5997
15 11484 2739 4023 12107 6516 551 2572 6628 8150 9852
16 6070 1761 4627 6534 7913 3730 11866 1813 12306 8249
17 12441 5489 8748 7837 7660 2102 11341 2936 6712 11977
18 10155 4210
19 1010 10483
20 8900 10250
21 10243 12278
22 7070 4397
23 12271 3887
24 11980 6836
25 9514 4356
26 7137 10281
27 11881 2526
28 1969 11477
29 3044 10921
30 2236 8724
31 9104 6340
32 7342 8582
33 11675 10405
34 6467 12775
35 3186 12198
0 9621 11445
1 7486 5611
2 4319 4879
3 2196 344

# FIG.189

4 7527 6650
5 10693 2440
6 6755 2706
7 5144 5998
8 11043 8033
9 4846 4435
10 4157 9228
11 12270 6562
12 11954 7592
13 7420 2592
14 8810 9636
15 689 5430
16 920 1304
17 1253 11934
18 9559 6016
19 312 7589
20 4439 4197
21 4002 9555
22 12232 7779
23 1494 8782
24 10749 3969
25 4368 3479
26 6316 5342
27 2455 3493
28 12157 7405
29 6598 11495
30 11805 4455
31 9625 2090
32 4731 2321
33 3578 2608
34 8504 1849
35 4027 1151
0 5647 4935
1 4219 1870
2 10968 8054
3 6970 5447
4 3217 5638
5 8972 669
6 5618 12472
7 1457 1280
8 8868 3883

# FIG.190

9 8866 1224
10 8371 5972
11 266 4405
12 3706 3244
13 6039 5844
14 7200 3283
15 1502 11282
16 12318 2202
17 4523 965
18 9587 7011
19 2552 2051
20 12045 10306
21 11070 5104
22 6627 6906
23 9889 2121
24 829 9701
25 2201 1819
26 6689 12925
27 2139 8757
28 12004 5948
29 8704 3191
30 8171 10933
31 6297 7116
32 616 7146
33 5142 9761
34 10377 8138
35 7616 5811
0 7285 9863
1 7764 10867
2 12343 9019
3 4414 8331
4 3464 642
5 6960 2039
6 786 3021
7 710 2086
8 7423 5601
9 8120 4885
10 12385 11990
11 9739 10034
12 424 10162
13 1347 7597

# FIG.191

14 1450 112
15 7965 8478
16 8945 7397
17 6590 8316
18 6838 9011
19 6174 9410
20 255 113
21 6197 5835
22 12902 3844
23 4377 3505
24 5478 8672
25 4453 2132
26 9724 1380
27 12131 11526
28 12323 9511
29 8231 1752
30 497 9022
31 9288 3080
32 2481 7515
33 2696 268
34 4023 12341
35 7108 5553

# FIG. 192

r5/6 16K

3 2409 499 1481 908 559 716 1270 333 2508 2264 1702 2805
4 2447 1926
5 414 1224
6 2114 842
7 212 573
0 2383 2112
1 2286 2348
2 545 819
3 1264 143
4 1701 2258
5 964 166
6 114 2413
7 2243 81
0 1245 1581
1 775 169
2 1696 1104
3 1914 2831
4 532 1450
5 91 974
6 497 2228
7 2326 1579
0 2482 256
1 1117 1261
2 1257 1658
3 1478 1225
4 2511 980
5 2320 2675
6 435 1278
7 228 503
0 1885 2369
1 57 483
2 838 1050
3 1231 1990
4 1738 68
5 2392 951
6 163 645
7 2644 1704

PARITY CHECK MATRIX INITIAL VALUE TABLE WHERE $r=\frac{5}{6}$, N=16200

# FIG.193

PARITY CHECK MATRIX INITIAL VALUE TABLE WHERE $r=\frac{5}{6}$, N=64800

r5/6 64K

0 4362 416 8909 4156 3216 3112 2560 2912 6405 8593 4969 6723
1 2479 1786 8978 3011 4339 9313 6397 2957 7288 5484 6031 10217
2 10175 9009 9889 3091 4985 7267 4092 8874 5671 2777 2189 8716
3 9052 4795 3924 3370 10058 1128 9996 10165 9360 4297 434 5138
4 2379 7834 4835 2327 9843 804 329 8353 7167 3070 1528 7311
5 3435 7871 348 3693 1876 6585 10340 7144 5870 2084 4052 2780
6 3917 3111 3476 1304 10331 5939 5199 1611 1991 699 8316 9960
7 6883 3237 1717 10752 7891 9764 4745 3888 10009 4176 4614 1567
8 10587 2195 1689 2968 5420 2580 2883 6496 111 6023 1024 4449
9 3786 8593 2074 3321 5057 1450 3840 5444 6572 3094 9892 1512
10 8548 1848 10372 4585 7313 6536 6379 1766 9462 2456 5606 9975
11 8204 10593 7935 3636 3882 394 5968 8561 2395 7289 9267 9978
12 7795 74 1633 9542 6867 7352 6417 7568 10623 725 2531 9115
13 7151 2482 4260 5003 10105 7419 9203 6691 8798 2092 8263 3755
14 3600 570 4527 200 9718 6771 1995 8902 5446 768 1103 6520
15 6304 7621
16 6498 9209
17 7293 6786
18 5950 1708
19 8521 1793
20 6174 7854
21 9773 1190
22 9517 10268
23 2181 9349
24 1949 5560
25 1556 555
26 8600 3827
27 5072 1057
28 7928 3542
29 3226 3762
0 7045 2420
1 9645 2641
2 2774 2452
3 5331 2031
4 9400 7503
5 1850 2338
6 10456 9774
7 1692 9276
8 10037 4038
9 3964 338

FIG.194

10 2640 5087
11 858 3473
12 5582 5683
13 9523 916
14 4107 1559
15 4506 3491
16 8191 4182
17 10192 6157
18 5668 3305
19 3449 1540
20 4766 2697
21 4069 6675
22 1117 1016
23 5619 3085
24 8483 8400
25 8255 394
26 6338 5042
27 6174 5119
28 7203 1989
29 1781 5174
0 1464 3559
1 3376 4214
2 7238 67
3 10595 8831
4 1221 6513
5 5300 4652
6 1429 9749
7 7878 5131
8 4435 10284
9 6331 5507
10 6662 4941
11 9614 10238
12 8400 8025
13 9156 5630
14 7067 8878
15 9027 3415
16 1690 3866
17 2854 8469
18 6206 630
19 363 5453
20 4125 7008

FIG.195

21 1612 6702
22 9069 9226
23 5767 4060
24 3743 9237
25 7018 5572
26 8892 4536
27 853 6064
28 8069 5893
29 2051 2885
0 10691 3153
1 3602 4055
2 328 1717
3 2219 9299
4 1939 7898
5 617 206
6 8544 1374
7 10676 3240
8 6672 9489
9 3170 7457
10 7868 5731
11 6121 10732
12 4843 9132
13 580 9591
14 6267 9290
15 3009 2268
16 195 2419
17 8016 1557
18 1516 9195
19 8062 9064
20 2095 8968
21 753 7326
22 6291 3833
23 2614 7844
24 2303 646
25 2075 611
26 4687 362
27 8684 9940
28 4830 2065
29 7038 1363
0 1769 7837
1 3801 1689

# FIG.196

2 10070 2359
3 3667 9918
4 1914 6920
5 4244 5669
6 10245 7821
7 7648 3944
8 3310 5488
9 6346 9666
10 7088 6122
11 1291 7827
12 10592 8945
13 3609 7120
14 9168 9112
15 6203 8052
16 3330 2895
17 4264 10563
18 10556 6496
19 8807 7645
20 1999 4530
21 9202 6818
22 3403 1734
23 2106 9023
24 6881 3883
25 3895 2171
26 4062 6424
27 3755 9536
28 4683 2131
29 7347 8027

# FIG.197

PARITY CHECK MATRIX INITIAL VALUE TABLE WHERE $r=\frac{8}{9}$, N=16200

r8/9 16K

0 1558 712 805
1 1450 873 1337
2 1741 1129 1184
3 294 806 1566
4 482 605 923
0 926 1578
1 777 1374
2 608 151
3 1195 210
4 1484 692
0 427 488
1 828 1124
2 874 1366
3 1500 835
4 1496 502
0 1006 1701
1 1155 97
2 657 1403
3 1453 624
4 429 1495
0 809 385
1 367 151
2 1323 202
3 960 318
4 1451 1039
0 1098 1722
1 1015 1428
2 1261 1564
3 544 1190
4 1472 1246
0 508 630
1 421 1704
2 284 898
3 392 577
4 1155 556
0 631 1000
1 732 1368
2 1328 329
3 1515 506
4 1104 1172

# FIG.198

PARITY CHECK MATRIX INITIAL VALUE TABLE WHERE $r=\frac{8}{9}$, N=64800

r8/9 64K

0 6235 2848 3222
1 5800 3492 5348
2 2757 927 90
3 6961 4516 4739
4 1172 3237 6264
5 1927 2425 3683
6 3714 6309 2495
7 3070 6342 7154
8 2428 613 3761
9 2906 264 5927
10 1716 1950 4273
11 4613 6179 3491
12 4865 3286 6005
13 1343 5923 3529
14 4589 4035 2132
15 1579 3920 6737
16 1644 1191 5998
17 1482 2381 4620
18 6791 6014 6596
19 2738 5918 3786
0 5156 6166
1 1504 4356
2 130 1904
3 6027 3187
4 6718 759
5 6240 2870
6 2343 1311
7 1039 5465
8 6617 2513
9 1588 5222
10 6561 535
11 4765 2054
12 5966 6892
13 1969 3869
14 3571 2420
15 4632 981
16 3215 4163
17 973 3117
18 3802 6198
19 3794 3948

# FIG.199

0 3196 6126
1 573 1909
2 850 4034
3 5622 1601
4 6005 524
5 5251 5783
6 172 2032
7 1875 2475
8 497 1291
9 2566 3430
10 1249 740
11 2944 1948
12 6528 2899
13 2243 3616
14 867 3733
15 1374 4702
16 4698 2285
17 4760 3917
18 1859 4058
19 6141 3527
0 2148 5066
1 1306 145
2 2319 871
3 3463 1061
4 5554 6647
5 5837 339
6 5821 4932
7 6356 4756
8 3930 418
9 211 3094
10 1007 4928
11 3584 1235
12 6982 2869
13 1612 1013
14 953 4964
15 4555 4410
16 4925 4842
17 5778 600
18 6509 2417
19 1260 4903
0 3369 3031

# FIG.200

1 3557 3224
2 3028 583
3 3258 440
4 6226 6655
5 4895 1094
6 1481 6847
7 4433 1932
8 2107 1649
9 2119 2065
10 4003 6388
11 6720 3622
12 3694 4521
13 1164 7050
14 1965 3613
15 4331 66
16 2970 1796
17 4652 3218
18 1762 4777
19 5736 1399
0 970 2572
1 2062 6599
2 4597 4870
3 1228 6913
4 4159 1037
5 2916 2362
6 395 1226
7 6911 4548
8 4618 2241
9 4120 4280
10 5825 474
11 2154 5558
12 3793 5471
13 5707 1595
14 1403 325
15 6601 5183
16 6369 4569
17 4846 896
18 7092 6184
19 6764 7127
0 6358 1951
1 3117 6960

# FIG.201

2 2710 7062
3 1133 3604
4 3694 657
5 1355 110
6 3329 6736
7 2505 3407
8 2462 4806
9 4216 214
10 5348 5619
11 6627 6243
12 2644 5073
13 4212 5088
14 3463 3889
15 5306 478
16 4320 6121
17 3961 1125
18 5699 1195
19 6511 792
0 3934 2778
1 3238 6587
2 1111 6596
3 1457 6226
4 1446 3885
5 3907 4043
6 6839 2873
7 1733 5615
8 5202 4269
9 3024 4722
10 5445 6372
11 370 1828
12 4695 1600
13 680 2074
14 1801 6690
15 2669 1377
16 2463 1681
17 5972 5171
18 5728 4284
19 1696 1459

# FIG.202

PARITY CHECK MATRIX INITIAL VALUE TABLE WHERE $r=\frac{9}{10}$, N=64800

r9/10 64K

0 5611 2563 2900
1 5220 3143 4813
2 2481 834 81
3 6265 4064 4265
4 1055 2914 5638
5 1734 2182 3315
6 3342 5678 2246
7 2185 552 3385
8 2615 236 5334
9 1546 1755 3846
10 4154 5561 3142
11 4382 2957 5400
12 1209 5329 3179
13 1421 3528 6063
14 1480 1072 5398
15 3843 1777 4369
16 1334 2145 4163
17 2368 5055 260
0 6118 5405
1 2994 4370
2 3405 1669
3 4640 5550
4 1354 3921
5 117 1713
6 5425 2866
7 6047 683
8 5616 2582
9 2108 1179
10 933 4921
11 5953 2261
12 1430 4699
13 5905 480
14 4289 1846
15 5374 6208
16 1775 3476
17 3216 2178
0 4165 884
1 2896 3744
2 874 2801
3 3423 5579

# FIG.203

4 3404 3552
5 2876 5515
6 516 1719
7 765 3631
8 5059 1441
9 5629 598
10 5405 473
11 4724 5210
12 155 1832
13 1689 2229
14 449 1164
15 2308 3088
16 1122 669
17 2268 5758
0 5878 2609
1 782 3359
2 1231 4231
3 4225 2052
4 4286 3517
5 5531 3184
6 1935 4560
7 1174 131
8 3115 956
9 3129 1088
10 5238 4440
11 5722 4280
12 3540 375
13 191 2782
14 906 4432
15 3225 1111
16 6296 2583
17 1457 903
0 855 4475
1 4097 3970
2 4433 4361
3 5198 541
4 1146 4426
5 3202 2902
6 2724 525
7 1083 4124
8 2326 6003

FIG.204

9 5605 5990
10 4376 1579
11 4407 984
12 1332 6163
13 5359 3975
14 1907 1854
15 3601 5748
16 6056 3266
17 3322 4085
0 1768 3244
1 2149 144
2 1589 4291
3 5154 1252
4 1855 5939
5 4820 2706
6 1475 3360
7 4266 693
8 4156 2018
9 2103 752
10 3710 3853
11 5123 931
12 6146 3323
13 1939 5002
14 5140 1437
15 1263 293
16 5949 4665
17 4548 6380
0 3171 4690
1 5204 2114
2 6384 5565
3 5722 1757
4 2805 6264
5 1202 2616
6 1018 3244
7 4018 5289
8 2257 3067
9 2483 3073
10 1196 5329
11 649 3918
12 3791 4581
13 5028 3803

FIG.205

14 3119 3506
15 4779 431
16 3888 5510
17 4387 4084
0 5836 1692
1 5126 1078
2 5721 6165
3 3540 2499
4 2225 6348
5 1044 1484
6 6323 4042
7 1313 5603
8 1303 3496
9 3516 3639
10 5161 2293
11 4682 3845
12 3045 643
13 2818 2616
14 3267 649
15 6236 593
16 646 2948
17 4213 1442
0 5779 1596
1 2403 1237
2 2217 1514
3 5609 716
4 5155 3858
5 1517 1312
6 2554 3158
7 5280 2643
8 4990 1353
9 5648 1170
10 1152 4366
11 3561 5368
12 3581 1411
13 5647 4661
14 1542 5401
15 5078 2687
16 316 1755
17 3392 1991

# FIG.206

r1/4 64K

23606 36098 1140 28859 18148 18510 6226 540 42014 20879 23802 47088
16419 24928 16609 17248 7693 24997 42587 16858 34921 21042 37024 20692
1874 40094 18704 14474 14004 11519 13106 28826 38669 22363 30255 31105
22254 40564 22645 22532 6134 9176 39998 23892 8937 15608 16854 31009
8037 40401 13550 19526 41902 28782 13304 32796 24679 27140 45980 10021
40540 44498 13911 22435 32701 18405 39929 25521 12497 9851 39223 34823
15233 45333 5041 44979 45710 42150 19416 1892 23121 15860 8832 10308
10468 44296 3611 1480 37581 32254 13817 6883 32892 40258 46538 11940
6705 21634 28150 43757 895 6547 20970 28914 30117 25736 41734 11392
22002 5739 27210 27828 34192 37992 10915 6998 3824 42130 4494 35739
8515 1191 13642 30950 25943 12673 16726 34261 31828 3340 8747 39225
18979 17058 43130 4246 4793 44030 19454 29511 47929 15174 24333 19354
16694 8381 29642 46516 32224 26344 9405 18292 12437 27316 35466 41992
15642 5871 46489 26723 23396 7257 8974 3156 37420 44823 35423 13541
42858 32008 41282 38773 26570 2702 27260 46974 1469 20887 27426 38553
22152 24261 8297
19347 9978 27802
34991 6354 33561
29782 30875 29523
9278 48512 14349
38061 4165 43878
8548 33172 34410
22535 28811 23950
20439 4027 24186
38618 8187 30947
35538 43880 21459
7091 45616 15063
5505 9315 21908
36046 32914 11836
7304 39782 33721
16905 29962 12980
11171 23709 22460
34541 9937 44500
14035 47316 8815
15057 45482 24461
30518 36877 879
7583 13364 24332
448 27056 4682
12083 31378 21670
1159 18031 2221
17028 38715 9350
17343 24530 29574

FIG.207

| | | |
|---|---|---|
| 46128 | 31039 | 32818 |
| 20373 | 36967 | 18345 |
| 46685 | 20622 | 32806 |

# FIG.208

r1/3 64K

34903 20927 32093 1052 25611 16093 16454 5520 506 37399 18518 21120
11636 14594 22158 14763 15333 6838 22222 37856 14985 31041 18704 32910
17449 1665 35639 16624 12867 12449 10241 11650 25622 34372 19878 26894
29235 19780 36056 20129 20029 5457 8157 35554 21237 7943 13873 14980
9912 7143 35911 12043 17360 37253 25588 11827 29152 21936 24125 40870
40701 36035 39556 12366 19946 29072 16365 35495 22686 11106 8756 34863
19165 15702 13536 40238 4465 40034 40590 37540 17162 1712 20577 14138
31338 19342 9301 39375 3211 1316 33409 28670 12282 6118 29236 35787
11504 30506 19558 5100 24188 24738 30397 33775 9699 6215 3397 37451
34689 23126 7571 1058 12127 27518 23064 11265 14867 30451 28289 2966
11660 15334 16867 15160 38343 3778 4265 39139 17293 26229 42604 13486
31497 1365 14828 7453 26350 41346 28643 23421 8354 16255 11055 24279
15687 12467 13906 5215 41328 23755 20800 6447 7970 2803 33262 39843
5363 22469 38091 28457 36696 34471 23619 2404 24229 41754 1297 18563
3673 39070 14480 30279 37483 7580 29519 30519 39831 20252 18132 20010
34386 7252 27526 12950 6875 43020 31566 39069 18985 15541 40020 16715
1721 37332 39953 17430 32134 29162 10490 12971 28581 29331 6489 35383
736 7022 42349 8783 6767 11871 21675 10325 11548 25978 431 24085
1925 10602 28585 12170 15156 34404 8351 13273 20208 5800 15367 21764
16279 37832 34792 21250 34192 7406 41488 18346 29227 26127 25493 7048
39948 28229 24899
17408 14274 38993
38774 15968 28459
41404 27249 27425
41229 6082 43114
13957 4979 40654
3093 3438 34992
34082 6172 28760
42210 34141 41021
14705 17783 10134
41755 39884 22773
14615 15593 1642
29111 37061 39860
9579 33552 633
12951 21137 39608
38244 27361 29417
2939 10172 36479
29094 5357 19224
9562 24436 28637

# FIG.209

40177 2326 13504
6834 21583 42516
40651 42810 25709
31557 32138 38142
18624 41867 39296
37560 14295 16245
6821 21679 31570
25339 25083 22081
8047 697 35268
9884 17073 19995
26848 35245 8390
18658 16134 14807
12201 32944 5035
25236 1216 38986
42994 24782 8681
28321 4932 34249
4107 29382 32124
22157 2624 14468
38788 27081 7936
4368 26148 10578
25353 4122 39751

# FIG.210

r2/5 64K

31413 18834 28884 947 23050 14484 14809 4968 455 33659 16666 19008
13172 19939 13354 13719 6132 20086 34040 13442 27958 16813 29619 16553
1499 32075 14962 11578 11204 9217 10485 23062 30936 17892 24204 24885
32490 18086 18007 4957 7285 32073 19038 7152 12486 13483 24808 21759
32321 10839 15620 33521 23030 10646 26236 19744 21713 36784 8016 12869
35597 11129 17948 26160 14729 31943 20416 10000 7882 31380 27858 33356
14125 12131 36199 4058 35992 36594 33698 15475 1566 18498 12725 7067
17406 8372 35437 2888 1184 30068 25802 11056 5507 26313 32205 37232
15254 5365 17308 22519 35009 718 5240 16778 23131 24092 20587 33385
27455 17602 4590 21767 22266 27357 30400 8732 5596 3060 33703 3596
6882 873 10997 24738 20770 10067 13379 27409 25463 2673 6998 31378
15181 13645 34501 3393 3840 35227 15562 23615 38342 12139 19471 15483
13350 6707 23709 37204 25778 21082 7511 14588 10010 21854 28375 33591
12514 4695 37190 21379 18723 5802 7182 2529 29936 35860 28338 10835
34283 25610 33026 31017 21259 2165 21807 37578 1175 16710 21939 30841
27292 33730 6836 26476 27539 35784 18245 16394 17939 23094 19216 17432
11655 6183 38708 28408 35157 17089 13998 36029 15052 16617 5638 36464
15693 28923 26245 9432 11675 25720 26405 5838 31851 26898 8090 37037
24418 27583 7959 35562 37771 17784 11382 11156 37855 7073 21685 34515
10977 13633 30969 7516 11943 18199 5231 13825 19589 23661 11150 35602
19124 30774 6670 37344 16510 26317 23518 22957 6348 34069 8845 20175
34985 14441 25668 4116 3019 21049 37308 24551 24727 20104 24850 12114
38187 28527 13108 13985 1425 21477 30807 8613 26241 33368 35913 32477
5903 34390 24641 26556 23007 27305 38247 2621 9122 32806 21554 18685
17287 27292 19033
25796 31795 12152
12184 35088 31226
38263 33386 24892
23114 37995 29796
34336 10551 36245
35407 175 7203
14654 38201 22605
28404 6595 1018
19932 3524 29305
31749 20247 8128
18026 36357 26735
7543 29767 13588
13333 25965 8463
14504 36796 19710
4528 25299 7318
35091 25550 14798

# FIG.211

7824 215 1248
30848 5362 17291
28932 30249 27073
13062 2103 16206
7129 32062 19612
9512 21936 38833
35849 33754 23450
18705 28656 18111
22749 27456 32187
28229 31684 30160
15293 8483 28002
14880 13334 12584
28646 2558 19687
6259 4499 26336
11952 28386 8405
10609 961 7582
10423 13191 26818
15922 36654 21450
10492 1532 1205
30551 36482 22153
5156 11330 34243
28616 35369 13322
8962 1485 21186
23541 17445 35561
33133 11593 19895
33917 7863 33651
20063 28331 10702
13195 21107 21859
4364 31137 4804
5585 2037 4830
30672 16927 14800

# FIG.212

r1/2 64K

54 9318 14392 27561 26909 10219 2534 8597
55 7263 4635 2530 28130 3033 23830 3651
56 24731 23583 26036 17299 5750 792 9169
57 5811 26154 18653 11551 15447 13685 16264
58 12610 11347 28768 2792 3174 29371 12997
59 16789 16018 21449 6165 21202 15850 3186
60 31016 21449 17618 6213 12166 8334 18212
61 22836 14213 11327 5896 718 11727 9308
62 2091 24941 29966 23634 9013 15587 5444
63 22207 3983 16904 28534 21415 27524 25912
64 25687 4501 22193 14665 14798 16158 5491
65 4520 17094 23397 4264 22370 16941 21526
66 10490 6182 32370 9597 30841 25954 2762
67 22120 22865 29870 15147 13668 14955 19235
68 6689 18408 18346 9918 25746 5443 20645
69 29982 12529 13858 4746 30370 10023 24828
70 1262 28032 29888 13063 24033 21951 7863
71 6594 29642 31451 14831 9509 9335 31552
72 1358 6454 16633 20354 24598 624 5265
73 19529 295 18011 3080 13364 8032 15323
74 11981 1510 7960 21462 9129 11370 25741
75 9276 29656 4543 30699 20646 21921 28050
76 15975 25634 5520 31119 13715 21949 19605
77 18688 4608 31755 30165 13103 10706 29224
78 21514 23117 12245 26035 31656 25631 30699
79 9674 24966 31285 29908 17042 24588 31857
80 21856 27777 29919 27000 14897 11409 7122
81 29773 23310 263 4877 28622 20545 22092
82 15605 5651 21864 3967 14419 22757 15896
83 30145 1759 10139 29223 26086 10556 5098
84 18815 16575 2936 24457 26738 6030 505
85 30326 22298 27562 20131 26390 6247 24791
86 928 29246 21246 12400 15311 32309 18608
87 20314 6025 26689 16302 2296 3244 19613
88 6237 11943 22851 15642 23857 15112 20947
89 26403 25168 19038 18384 8882 12719 7093
0 14567 24965
1 3908 100
2 10279 240

# FIG.213

3 24102 764
4 12383 4173
5 13861 15918
6 21327 1046
7 5288 14579
8 28158 8069
9 16583 11098
10 16681 28363
11 13980 24725
12 32169 17989
13 10907 2767
14 21557 3818
15 26676 12422
16 7676 8754
17 14905 20232
18 15719 24646
19 31942 8589
20 19978 27197
21 27060 15071
22 6071 26649
23 10393 11176
24 9597 13370
25 7081 17677
26 1433 19513
27 26925 9014
28 19202 8900
29 18152 30647
30 20803 1737
31 11804 25221
32 31683 17783
33 29694 9345
34 12280 26611
35 6526 26122
36 26165 11241
37 7666 26962
38 16290 8480
39 11774 10120
40 30051 30426
41 1335 15424
42 6865 17742
43 31779 12489
44 32120 21001
45 14508 6996

FIG.214

| | | |
|---|---|---|
| 46 | 979 | 25024 |
| 47 | 4554 | 21896 |
| 48 | 7989 | 21777 |
| 49 | 4972 | 20661 |
| 50 | 6612 | 2730 |
| 51 | 12742 | 4418 |
| 52 | 29194 | 595 |
| 53 | 19267 | 20113 |

# FIG.215

r3/5 64K

22422 10282 11626 19997 11161 2922 3122 99 5625 17064 8270 179
25087 16218 17015 828 20041 25656 4186 11629 22599 17305 22515 6463
11049 22853 25706 14388 5500 19245 8732 2177 13555 11346 17265 3069
16581 22225 12563 19717 23577 11555 25496 6853 25403 5218 15925 21766
16529 14487 7643 10715 17442 11119 5679 14155 24213 21000 1116 15620
5340 8636 16693 1434 5635 6516 9482 20189 1066 15013 25361 14243
18506 22236 20912 8952 5421 15691 6126 21595 500 6904 13059 6802
8433 4694 5524 14216 3685 19721 25420 9937 23813 9047 25651 16826
21500 24814 6344 17382 7064 13929 4004 16552 12818 8720 5286 2206
22517 2429 19065 2921 21611 1873 7507 5661 23006 23128 20543 19777
1770 4636 20900 14931 9247 12340 11008 12966 4471 2731 16445 791
6635 14556 18865 22421 22124 12697 9803 25485 7744 18254 11313 9004
19982 23963 18912 7206 12500 4382 20067 6177 21007 1195 23547 24837
756 11158 14646 20534 3647 17728 11676 11843 12937 4402 8261 22944
9306 24009 10012 11081 3746 24325 8060 19826 842 8836 2898 5019
7575 7455 25244 4736 14400 22981 5543 8006 24203 13053 1120 5128
3482 9270 13059 15825 7453 23747 3656 24585 16542 17507 22462 14670
15627 15290 4198 22748 5842 13395 23918 16985 14929 3726 25350 24157
24896 16365 16423 13461 16615 8107 24741 3604 25904 8716 9604 20365
3729 17245 18448 9862 20831 25326 20517 24618 13282 5099 14183 8804
16455 17646 15376 18194 25528 1777 6066 21855 14372 12517 4488 17490
1400 8135 23375 20879 8476 4084 12936 25536 22309 16582 6402 24360
25119 23586 128 4761 10443 22536 8607 9752 25446 15053 1856 4040
377 21160 13474 5451 17170 5938 10256 11972 24210 17833 22047 16108
13075 9648 24546 13150 23867 7309 19798 2988 16858 4825 23950 15125
20526 3553 11525 23366 2452 17626 19265 20172 18060 24593 13255 1552
18839 21132 20119 15214 14705 7096 10174 5663 18651 19700 12524 14033
4127 2971 17499 16287 22368 21463 7943 18880 5567 8047 23363 6797
10651 24471 14325 4081 7258 4949 7044 1078 797 22910 20474 4318
21374 13231 22985 5056 3821 23718 14178 9978 19030 23594 8895 25358
6199 22056 7749 13310 3999 23697 16445 22636 5225 22437 24153 9442
7978 12177 2893 20778 3175 8645 11863 24623 10311 25767 17057 3691
20473 11294 9914 22815 2574 8439 3699 5431 24840 21908 16088 18244
8208 5755 19059 8541 24924 6454 11234 10492 16406 10831 11436 9649
16264 11275 24953 2347 12667 19190 7257 7174 24819 2938 2522 11749
3627 5969 13862 1538 23176 6353 2855 17720 2472 7428 573 15036
0 18539 18661
1 10502 3002
2 9368 10761

# FIG.216

3 12299 7828
4 15048 13362
5 18444 24640
6 20775 19175
7 18970 10971
8 5329 19982
9 11296 18655
10 15046 20659
11 7300 22140
12 22029 14477
13 11129 742
14 13254 13813
15 19234 13273
16 6079 21122
17 22782 5828
18 19775 4247
19 1660 19413
20 4403 3649
21 13371 25851
22 22770 21784
23 10757 14131
24 16071 21617
25 6393 3725
26 597 19968
27 5743 8084
28 6770 9548
29 4285 17542
30 13568 22599
31 1786 4617
32 23238 11648
33 19627 2030
34 13601 13458
35 13740 17328
36 25012 13944
37 22513 6687
38 4934 12587
39 21197 5133
40 22705 6938
41 7534 24633
42 24400 12797
43 21911 25712
44 12039 1140
45 24306 1021

# FIG.217

46 14012 20747
47 11265 15219
48 4670 15531
49 9417 14359
50 2415 6504
51 24964 24690
52 14443 8816
53 6926 1291
54 6209 20806
55 13915 4079
56 24410 13196
57 13505 6117
58 9869 8220
59 1570 6044
60 25780 17387
61 20671 24913
62 24558 20591
63 12402 3702
64 8314 1357
65 20071 14616
66 17014 3688
67 19837 946
68 15195 12136
69 7758 22808
70 3564 2925
71 3434 7769

# FIG.218

r1/4 16K
6295 9626 304 7695 4839 4936 1660 144 11203 5567 6347 12557
10691 4988 3859 3734 3071 3494 7687 10313 5964 8069 8296 11090
10774 3613 5208 11177 7676 3549 8746 6583 7239 12265 2674 4292
11869 3708 5981 8718 4908 10650 6805 3334 2627 10461 9285 11120
7844 3079 10773
3385 10854 5747
1360 12010 12202
6189 4241 2343
9840 12726 4977

# FIG.219

r1/3 16K

416 8909 4156 3216 3112 2560 2912 6405 8593 4969 6723 6912
8978 3011 4339 9312 6396 2957 7288 5485 6031 10218 2226 3575
3383 10059 1114 10008 10147 9384 4290 434 5139 3536 1965 2291
2797 3693 7615 7077 743 1941 8716 6215 3840 5140 4582 5420
6110 8551 1515 7404 4879 4946 5383 1831 3441 9569 10472 4306
1505 5682 7778
7172 6830 6623
7281 3941 3505
10270 8669 914
3622 7563 9388
9930 5058 4554
4844 9609 2707
6883 3237 1714
4768 3878 10017
10127 3334 8267

# FIG.220

r2/5 16K

5650 4143 8750 583 6720 8071 635 1767 1344 6922 738 6658
5696 1685 3207 415 7019 5023 5608 2605 857 6915 1770 8016
3992 771 2190 7258 8970 7792 1802 1866 6137 8841 886 1931
4108 3781 7577 6810 9322 8226 5396 5867 4428 8827 7766 2254
4247 888 4367 8821 9660 324 5864 4774 227 7889 6405 8963
9693 500 2520 2227 1811 9330 1928 5140 4030 4824 806 3134
1652 8171 1435
3366 6543 3745
9286 8509 4645
7397 5790 8972
6597 4422 1799
9276 4041 3847
8683 7378 4946
5348 1993 9186
6724 9015 5646
4502 4439 8474
5107 7342 9442
1387 8910 2660

# FIG.221

r1/2 16K

20 712 2386 6354 4061 1062 5045 5158
21 2543 5748 4822 2348 3089 6328 5876
22 926 5701 269 3693 2438 3190 3507
23 2802 4520 3577 5324 1091 4667 4449
24 5140 2003 1263 4742 6497 1185 6202
0 4046 6934
1 2855 66
2 6694 212
3 3439 1158
4 3850 4422
5 5924 290
6 1467 4049
7 7820 2242
8 4606 3080
9 4633 7877
10 3884 6868
11 8935 4996
12 3028 764
13 5988 1057
14 7411 3450

# FIG.222

r3/5 16K

2765 5713 6426 3596 1374 4811 2182 544 3394 2840 4310 771
4951 211 2208 723 1246 2928 398 5739 265 5601 5993 2615
210 4730 5777 3096 4282 6238 4939 1119 6463 5298 6320 4016
4167 2063 4757 3157 5664 3956 6045 563 4284 2441 3412 6334
4201 2428 4474 59 1721 736 2997 428 3807 1513 4732 6195
2670 3081 5139 3736 1999 5889 4362 3806 4534 5409 6384 5809
5516 1622 2906 3285 1257 5797 3816 817 875 2311 3543 1205
4244 2184 5415 1705 5642 4886 2333 287 1848 1121 3595 6022
2142 2830 4069 5654 1295 2951 3919 1356 884 1786 396 4738
0 2161 2653
1 1380 1461
2 2502 3707
3 3971 1057
4 5985 6062
5 1733 6028
6 3786 1936
7 4292 956
8 5692 3417
9 266 4878
10 4913 3247
11 4763 3937
12 3590 2903
13 2566 4215
14 5208 4707
15 3940 3388
16 5109 4556
17 4908 4177

# FIG.223

r3/5 16K

71 1478 1901 2240 2649 2725 3592 3708 3965 4080 5733 6198
393 1384 1435 1878 2773 3182 3586 5465 6091 6110 6114 6327
160 1149 1281 1526 1566 2129 2929 3095 3223 4250 4276 4612
289 1446 1602 2421 3559 3796 5590 5750 5763 6168 6271 6340
947 1227 2008 2020 2266 3365 3588 3867 4172 4250 4865 6290
3324 3704 4447
1206 2565 3089
529 4027 5891
141 1187 3206
1990 2972 5120
752 796 5976
1129 2377 4030
6077 6108 6231
61 1053 1781
2820 4109 5307
2088 5834 5988
3725 3945 4010
1081 2780 3389
659 2221 4822
3033 6060 6160
756 1489 2350
3350 3624 5470
357 1825 5242
585 3372 6062
561 1417 2348
971 3719 5567
1005 1675 2062

# FIG.224

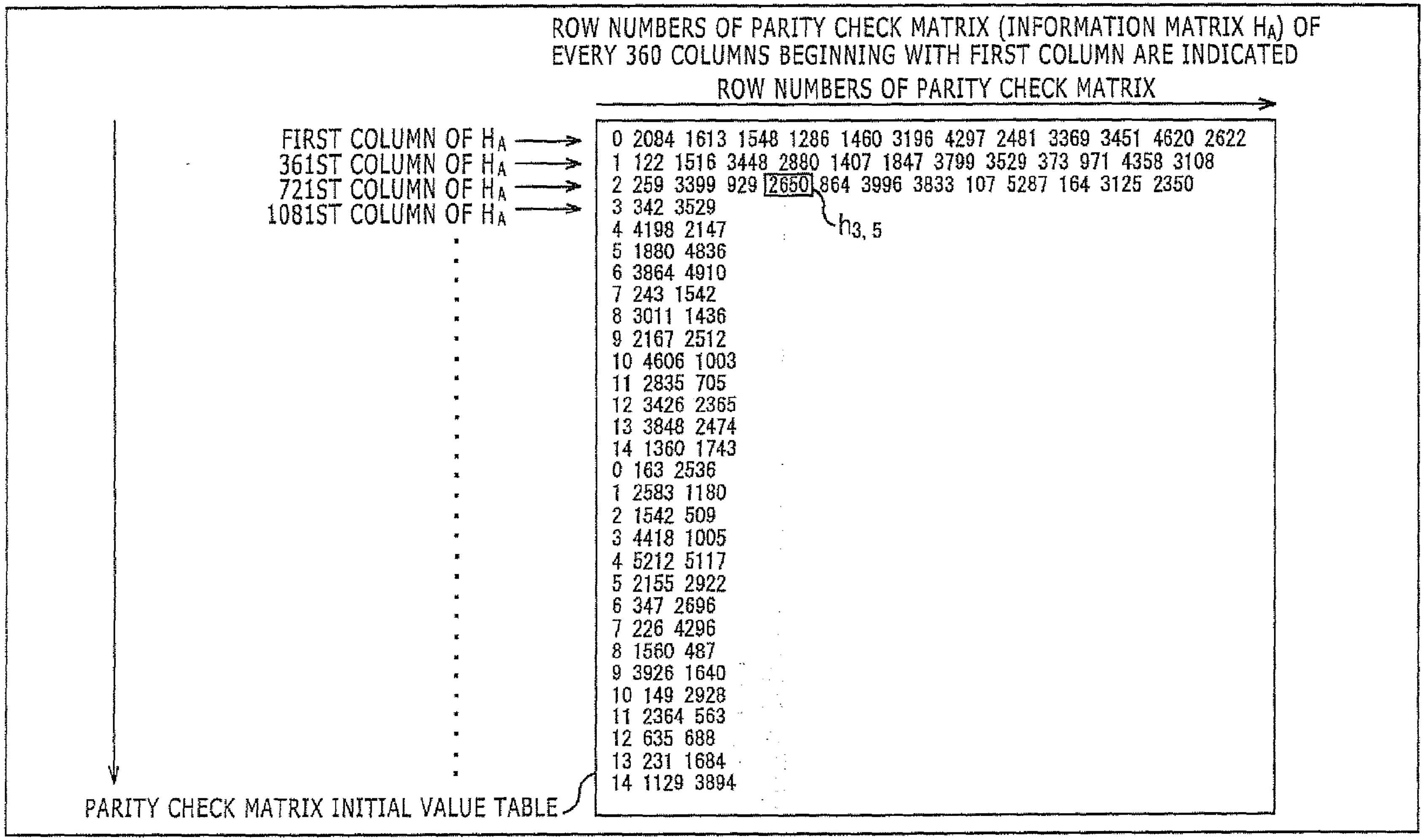
ROW NUMBERS OF PARITY CHECK MATRIX (INFORMATION MATRIX $H_A$) OF EVERY 360 COLUMNS BEGINNING WITH FIRST COLUMN ARE INDICATED
ROW NUMBERS OF PARITY CHECK MATRIX
FIRST COLUMN OF $H_A$
361ST COLUMN OF $H_A$
721ST COLUMN OF $H_A$
1081ST COLUMN OF $H_A$
0 2084 1613 1548 1286 1460 3196 4297 2481 3369 3451 4620 2622
1 122 1516 3448 2880 1407 1847 3799 3529 373 971 4358 3108
2 259 3399 929 2650 864 3996 3833 107 5287 164 3125 2350
3 342 3529
4 4198 2147
5 1880 4836
6 3864 4910
7 243 1542
8 3011 1436
9 2167 2512
10 4606 1003
11 2835 705
12 3426 2365
13 3848 2474
14 1360 1743
0 163 2536
1 2583 1180
2 1542 509
3 4418 1005
4 5212 5117
5 2155 2922
6 347 2696
7 226 4296
8 1560 487
9 3926 1640
10 149 2928
11 2364 563
12 635 688
13 231 1684
14 1129 3894
$h_{3,5}$
PARITY CHECK MATRIX INITIAL VALUE TABLE

# FIG.225

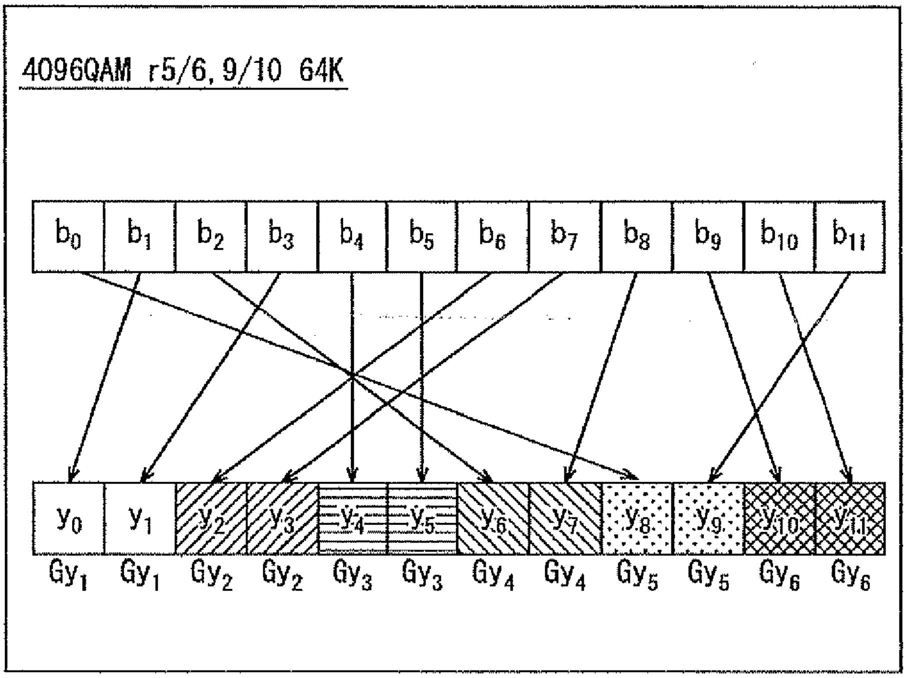
4096QAM r5/6,9/10 64K
b0
b1
b2
b3
b4
b5
b6
b7
b8
b9
b10
b11
y0
y1
y2
y3
y4
y5
y6
y7
y8
y9
y10
y11
Gy1
Gy1
Gy2
Gy2
Gy3
Gy3
Gy4
Gy4
Gy5
Gy5
Gy6
Gy6

FIG.226

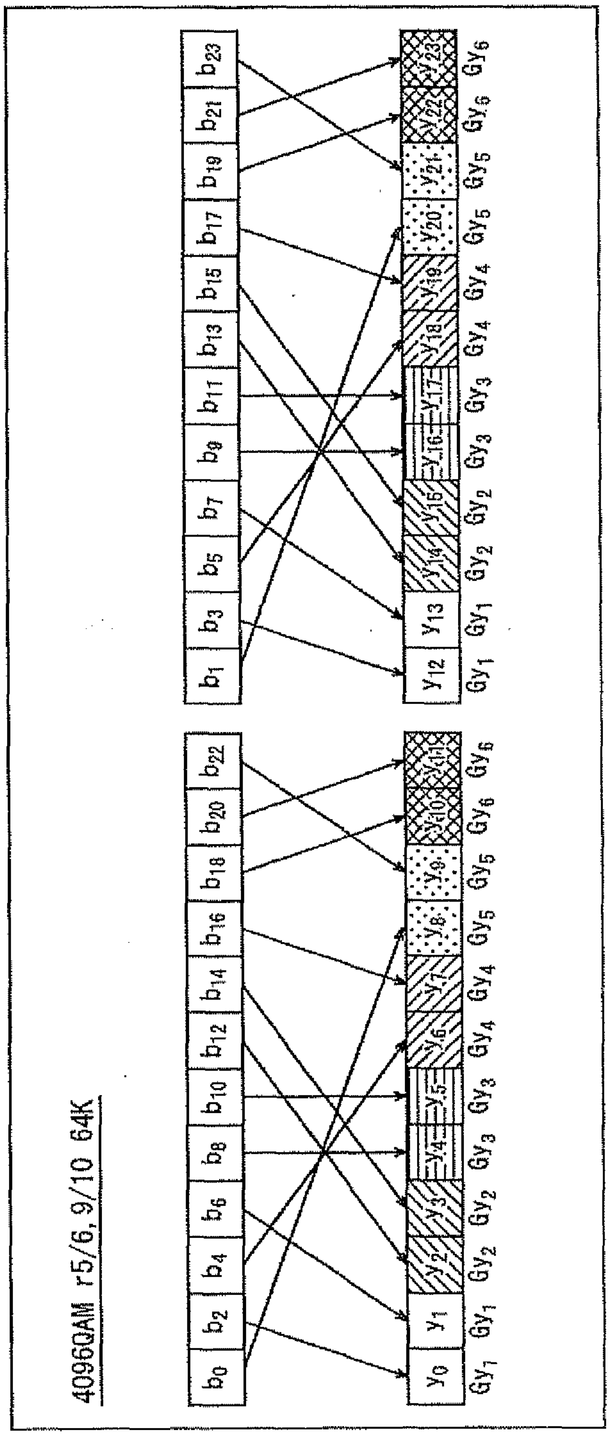

FIG.227

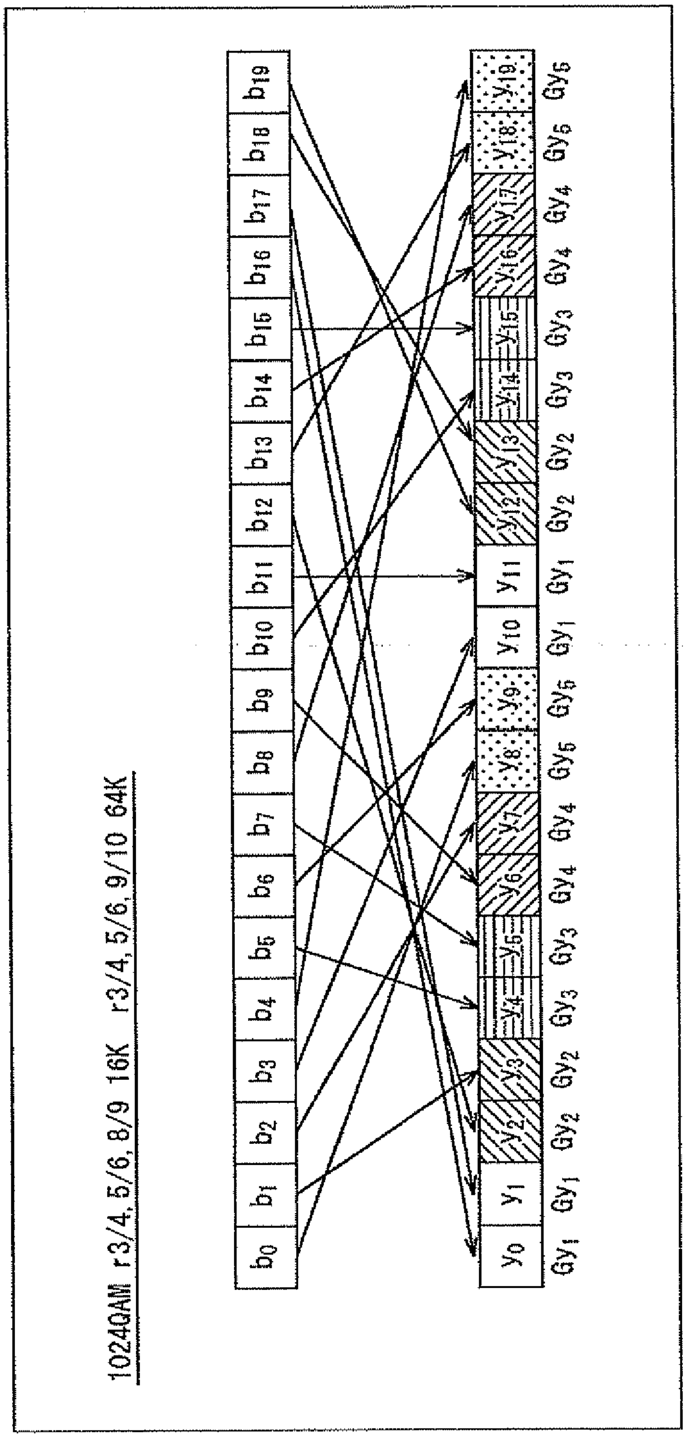
1024QAM r3/4, 5/6, 8/9 16K r3/4, 5/6, 9/10 64K
b0 b1 b2 b3 b4 b5 b6 b7 b8 b9 b10 b11 b12 b13 b14 b15 b16 b17 b18 b19
y0 y1 y2 y3 y4 y5 y6 y7 y8 y9 y10 y11 y12 y13 y14 y15 y16 y17 y18 y19
Gy1 Gy1 Gy2 Gy2 Gy3 Gy3 Gy4 Gy4 Gy5 Gy5 Gy1 Gy1 Gy2 Gy2 Gy3 Gy3 Gy4 Gy4 Gy5 Gy5

FIG. 228

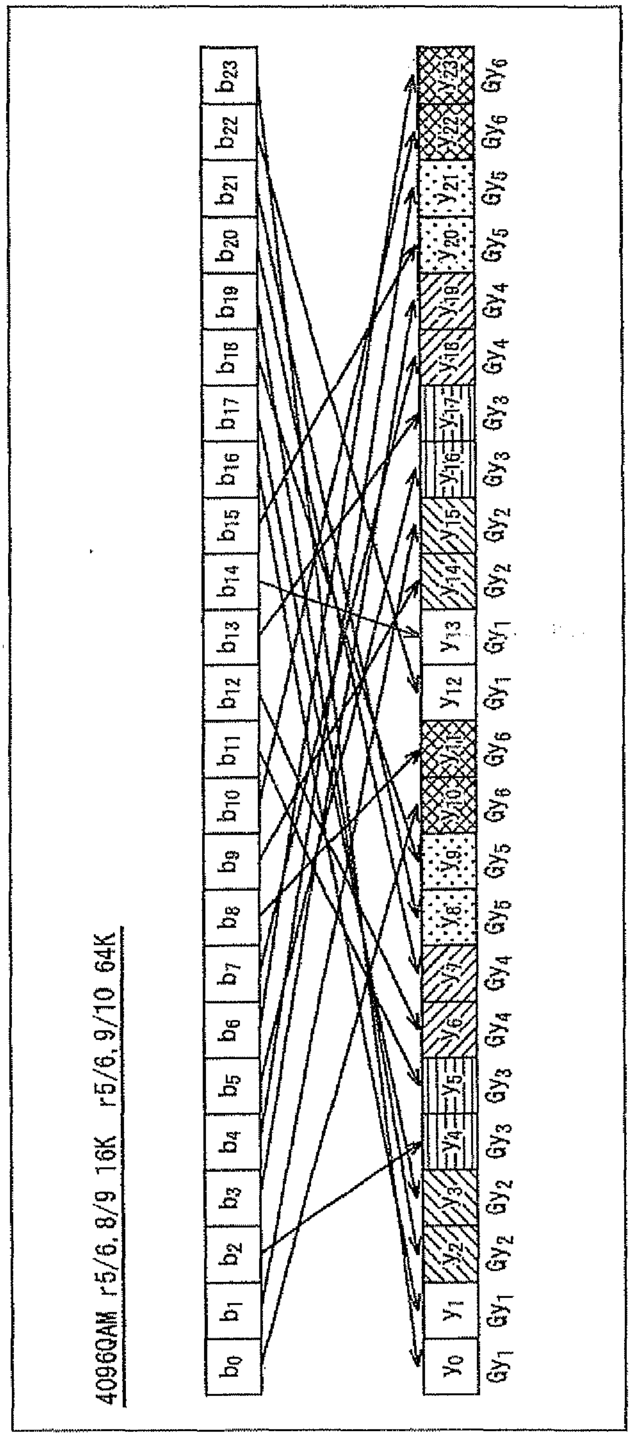
4096QAM r5/6, 8/9 16K r5/6, 9/10 64K
b0 b1 b2 b3 b4 b5 b6 b7 b8 b9 b10 b11 b12 b13 b14 b15 b16 b17 b18 b19 b20 b21 b22 b23
y0 y1 y2 y3 y4 y5 y6 y7 y8 y9 y10 y11 y12 y13 y14 y15 y16 y17 y18 y19 y20 y21 y22 y23
Gy1 Gy1 Gy2 Gy2 Gy3 Gy3 Gy4 Gy4 Gy5 Gy5 Gy6 Gy6 Gy1 Gy1 Gy2 Gy2 Gy3 Gy3 Gy4 Gy4 Gy5 Gy5 Gy6 Gy6

FIG.229

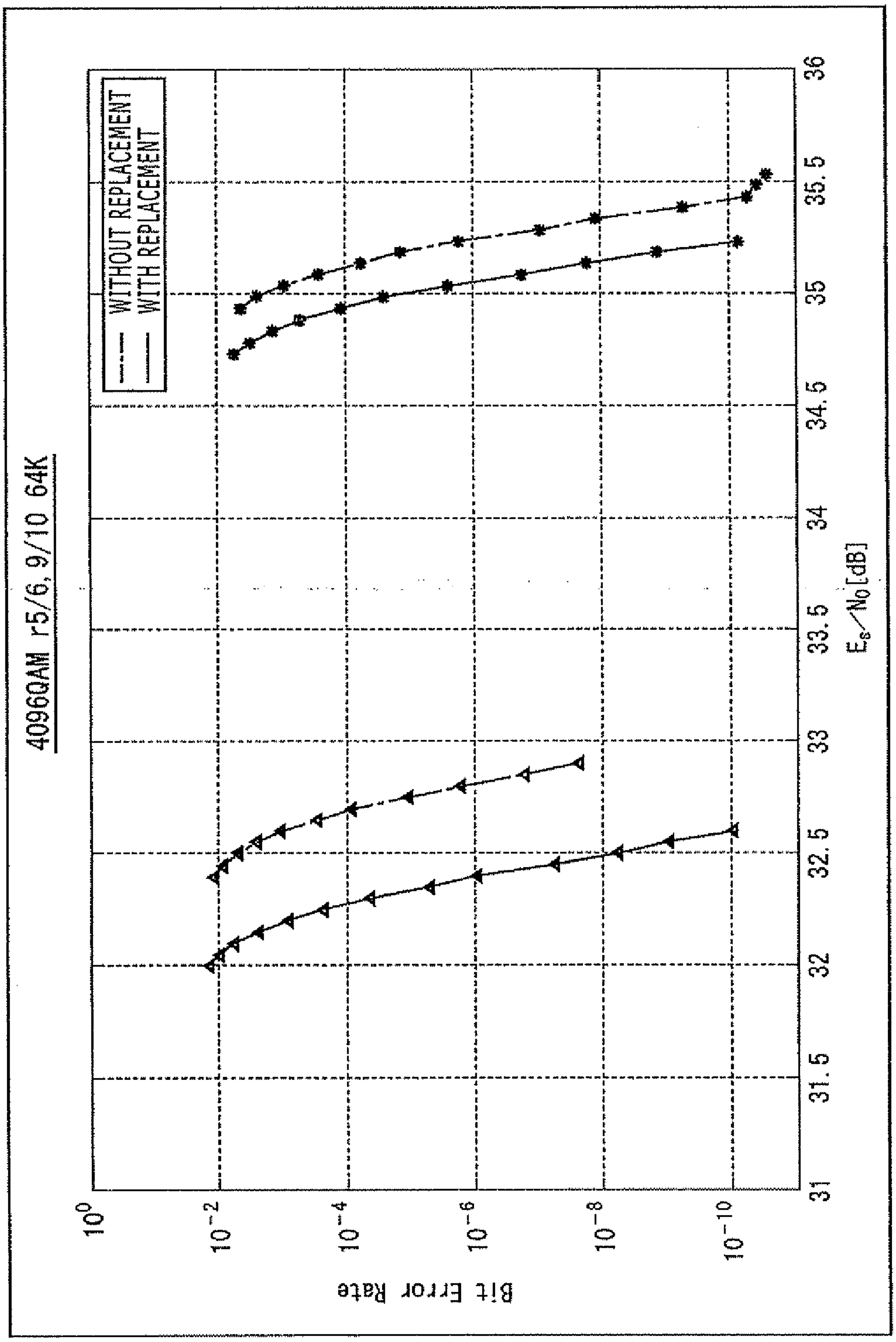
4096QAM r5/6,9/10 64K
WITHOUT REPLACEMENT
WITH REPLACEMENT
Bit Error Rate
$10^0$
$10^{-2}$
$10^{-4}$
$10^{-6}$
$10^{-8}$
$10^{-10}$
31
31.5
32
32.5
33
33.5
34
34.5
35
35.5
36
$E_s/N_0$[dB]

FIG. 230

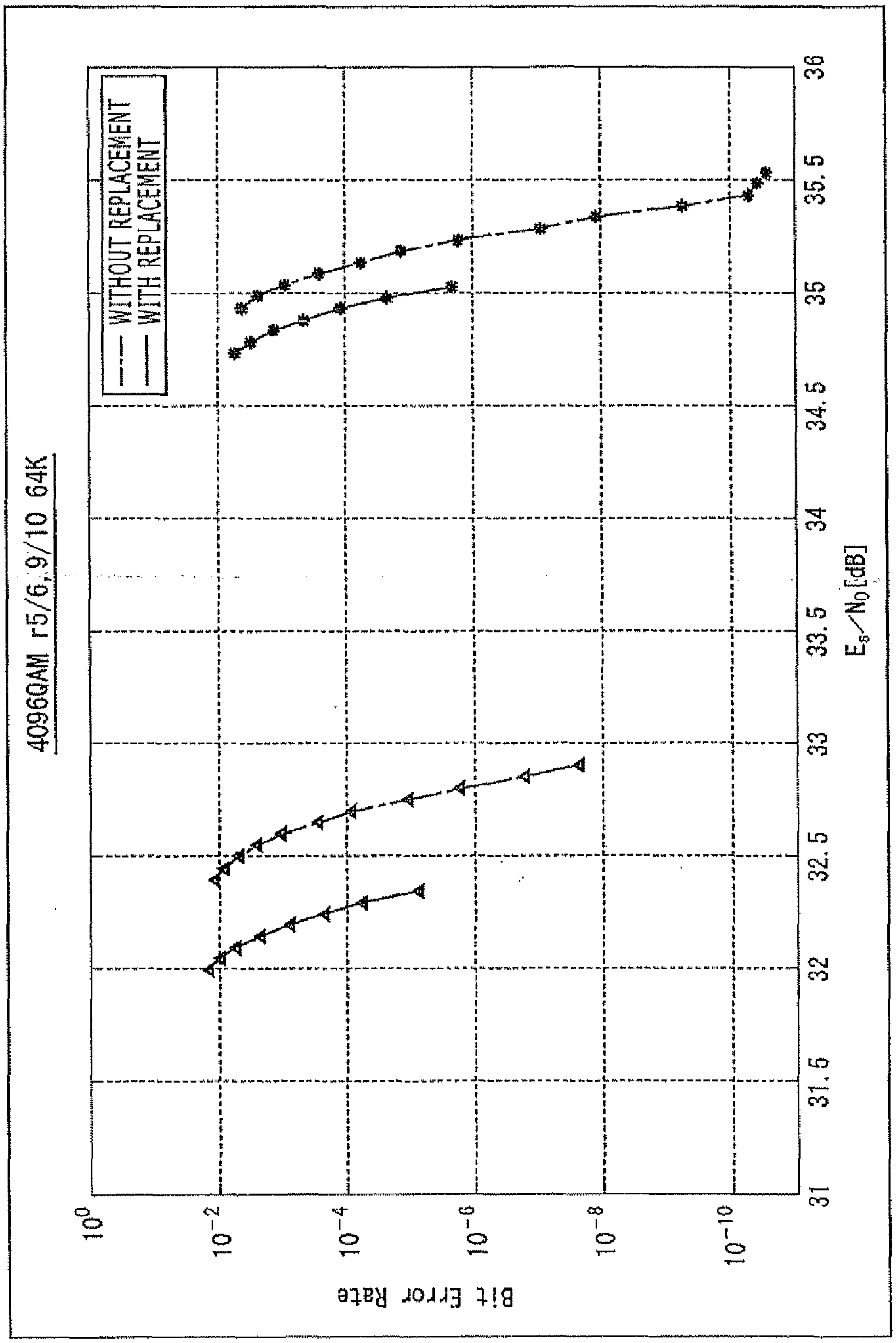
4096QAM r5/6,9/10 64K
WITHOUT REPLACEMENT
WITH REPLACEMENT
Bit Error Rate
$10^0$
$10^{-2}$
$10^{-4}$
$10^{-6}$
$10^{-8}$
$10^{-10}$
31
31.5
32
32.5
33
33.5
34
34.5
35
35.5
36
$E_s/N_0$[dB]

FIG. 231

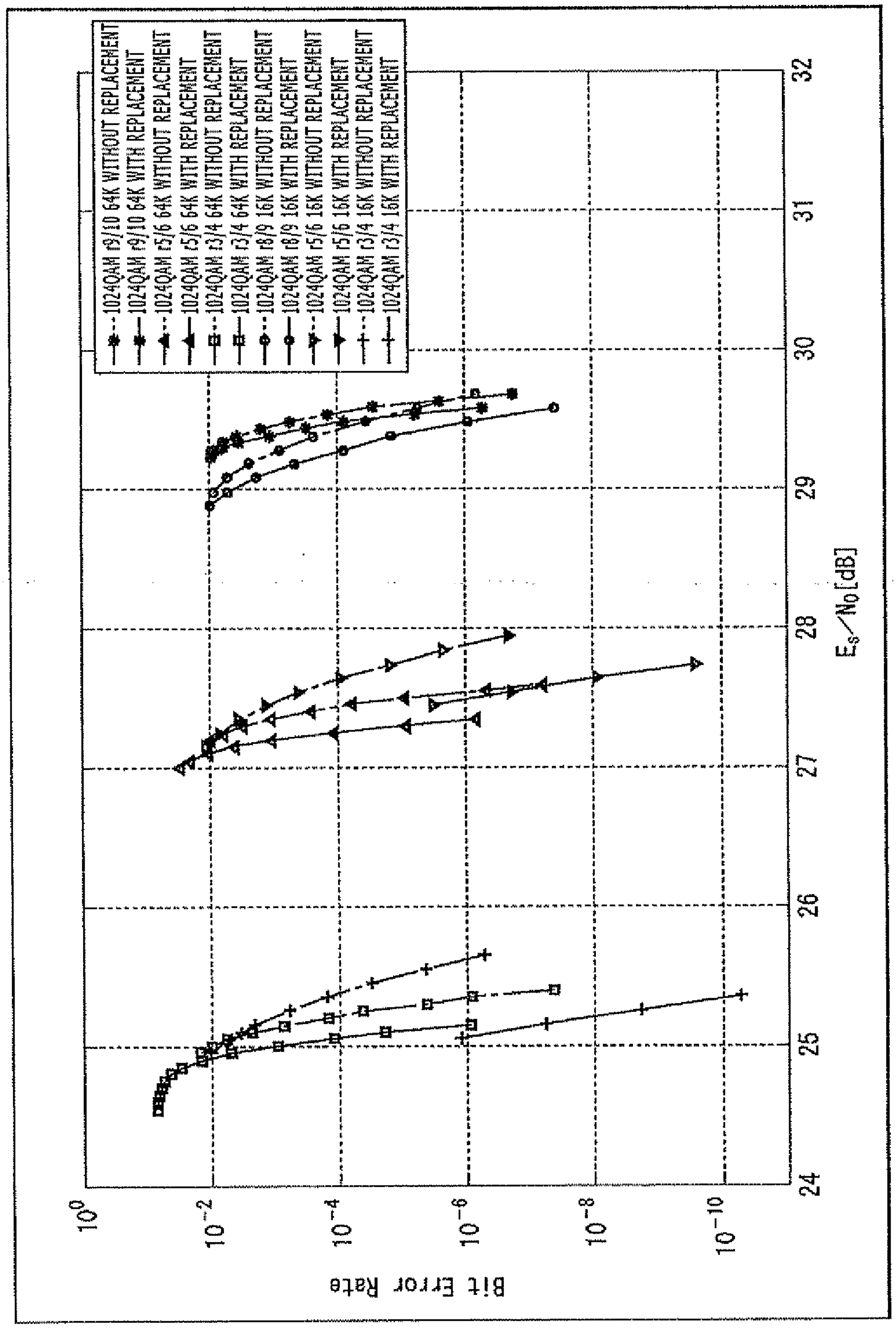
1024QAM r9/10 64K WITHOUT REPLACEMENT
1024QAM r9/10 64K WITH REPLACEMENT
1024QAM r5/6 64K WITHOUT REPLACEMENT
1024QAM r5/6 64K WITH REPLACEMENT
1024QAM r3/4 64K WITHOUT REPLACEMENT
1024QAM r3/4 64K WITH REPLACEMENT
1024QAM r8/9 16K WITHOUT REPLACEMENT
1024QAM r8/9 16K WITH REPLACEMENT
1024QAM r5/6 16K WITHOUT REPLACEMENT
1024QAM r5/6 16K WITH REPLACEMENT
1024QAM r3/4 16K WITHOUT REPLACEMENT
1024QAM r3/4 16K WITH REPLACEMENT
Bit Error Rate
$10^{0}$
$10^{-2}$
$10^{-4}$
$10^{-6}$
$10^{-8}$
$10^{-10}$
24
25
26
27
28
29
30
31
32
$E_s/N_0$ [dB]

FIG.232

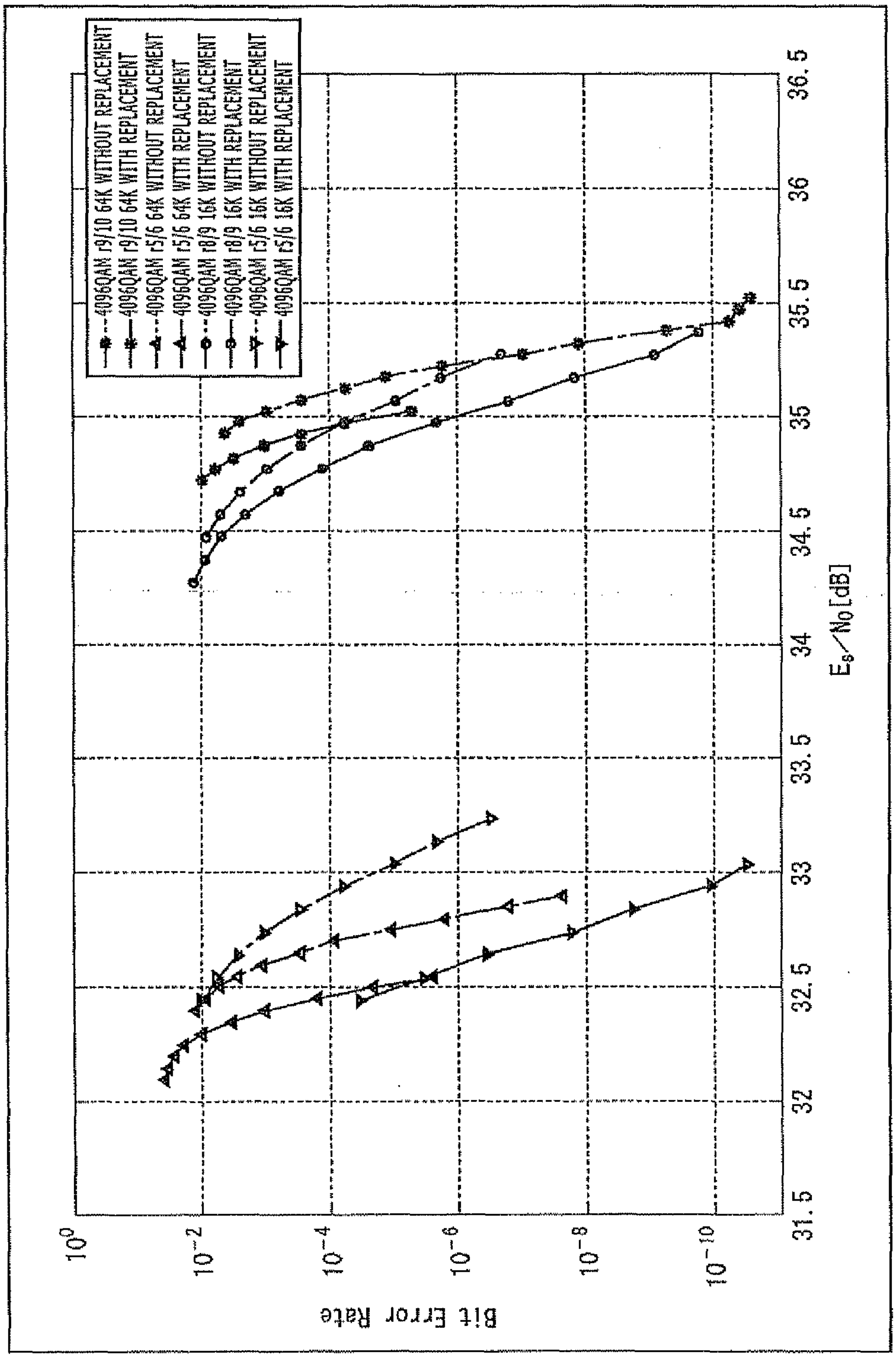
4096QAM r9/10 64K WITHOUT REPLACEMENT
4096QAM r9/10 64K WITH REPLACEMENT
4096QAM r5/6 64K WITHOUT REPLACEMENT
4096QAM r5/6 64K WITH REPLACEMENT
4096QAM r8/9 16K WITHOUT REPLACEMENT
4096QAM r8/9 16K WITH REPLACEMENT
4096QAM r5/6 16K WITHOUT REPLACEMENT
4096QAM r5/6 16K WITH REPLACEMENT
Bit Error Rate
$10^0$
$10^{-2}$
$10^{-4}$
$10^{-6}$
$10^{-8}$
$10^{-10}$
$E_s/N_0$[dB]
31.5
32
32.5
33
33.5
34
34.5
35
35.5
36
36.5

# FIG.233

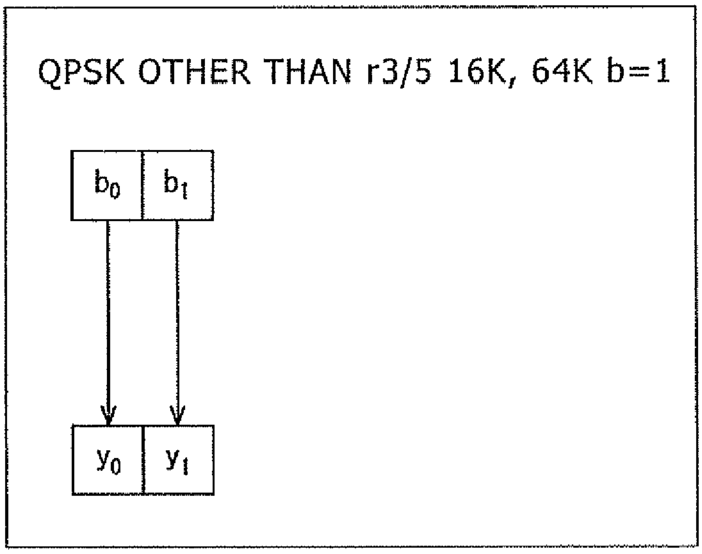


# FIG.234

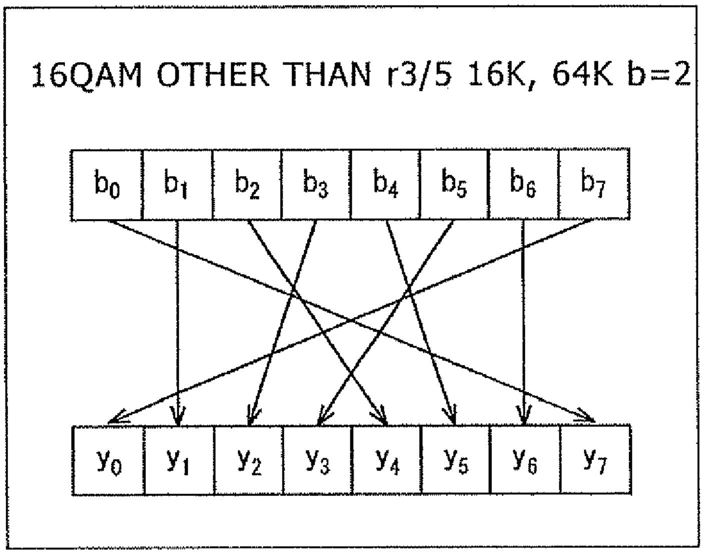

FIG.235

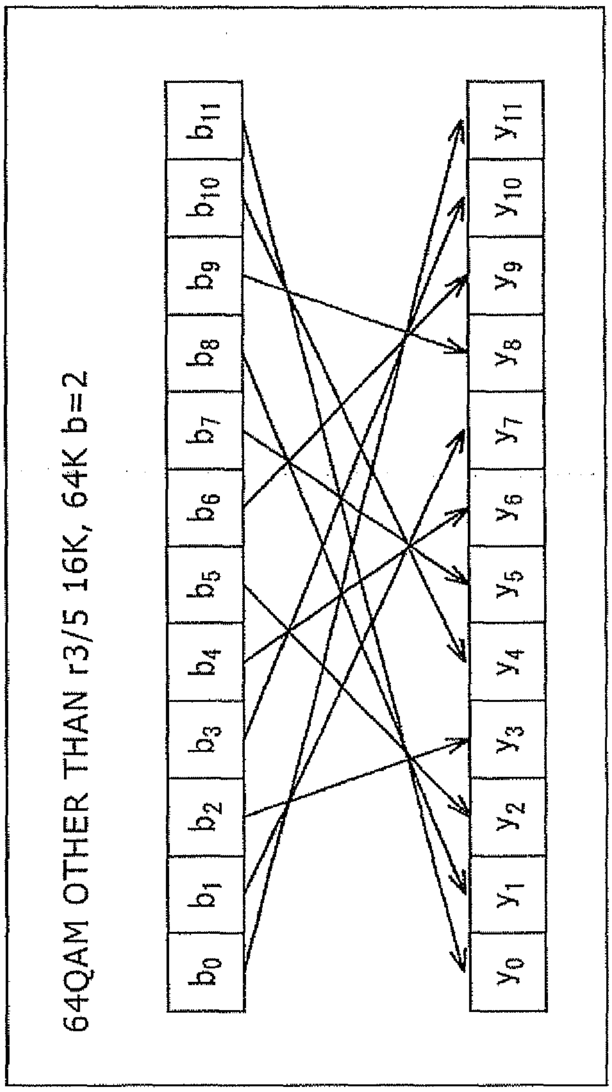
64QAM OTHER THAN r3/5 16K, 64K b=2
b0 b1 b2 b3 b4 b5 b6 b7 b8 b9 b10 b11
y0 y1 y2 y3 y4 y5 y6 y7 y8 y9 y10 y11

FIG.236

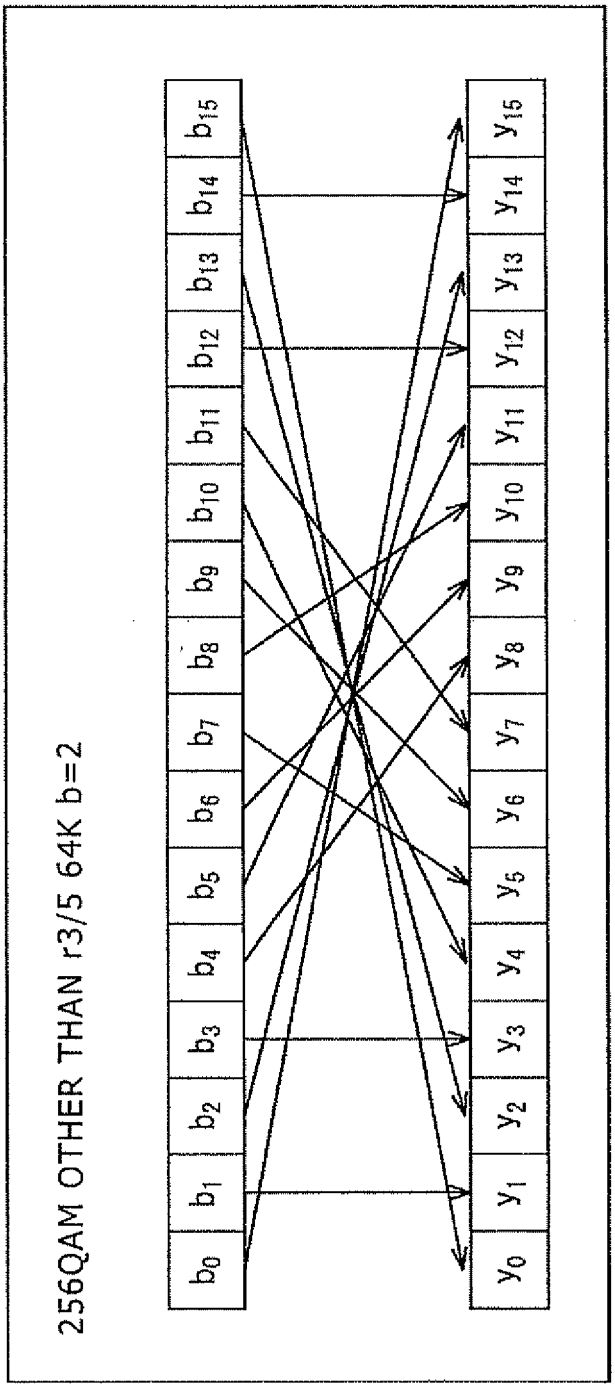
256QAM OTHER THAN r3/5 64K b=2
b0 b1 b2 b3 b4 b5 b6 b7 b8 b9 b10 b11 b12 b13 b14 b15
y0 y1 y2 y3 y4 y5 y6 y7 y8 y9 y10 y11 y12 y13 y14 y15

FIG.237

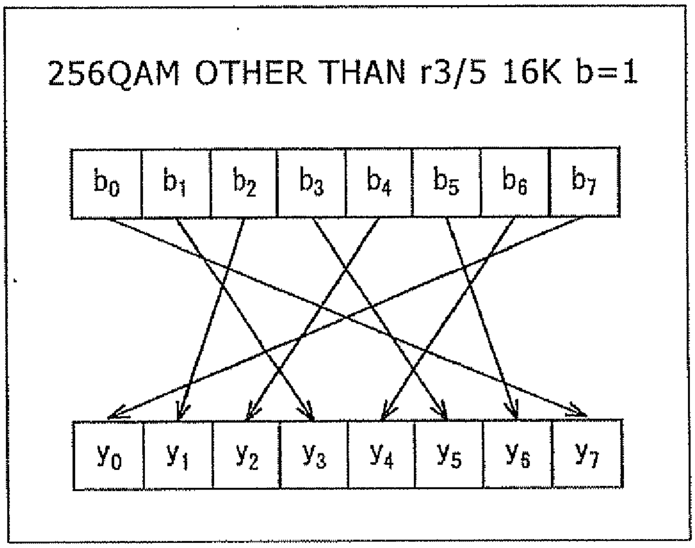


FIG.238

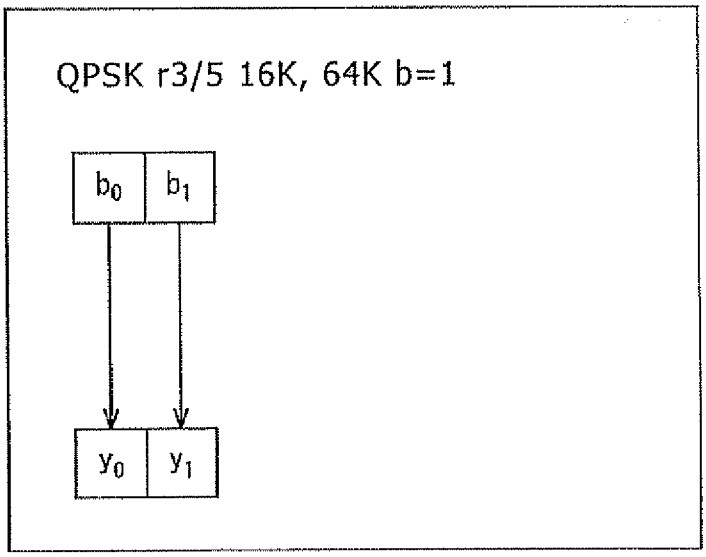

FIG.239

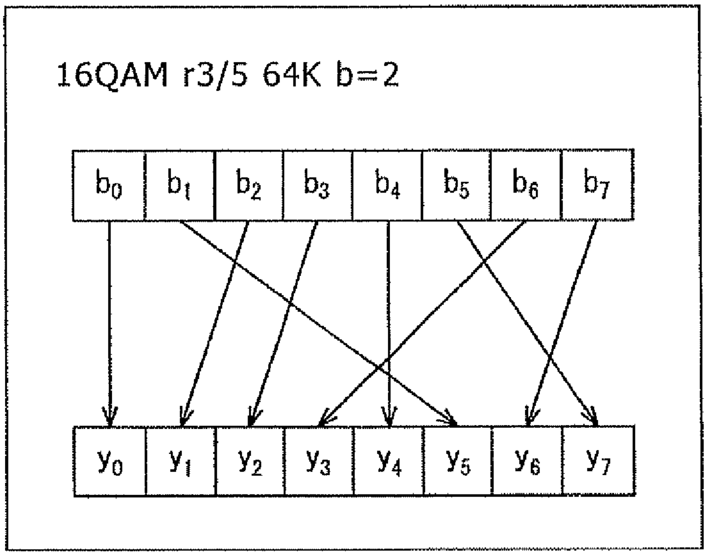


FIG.240

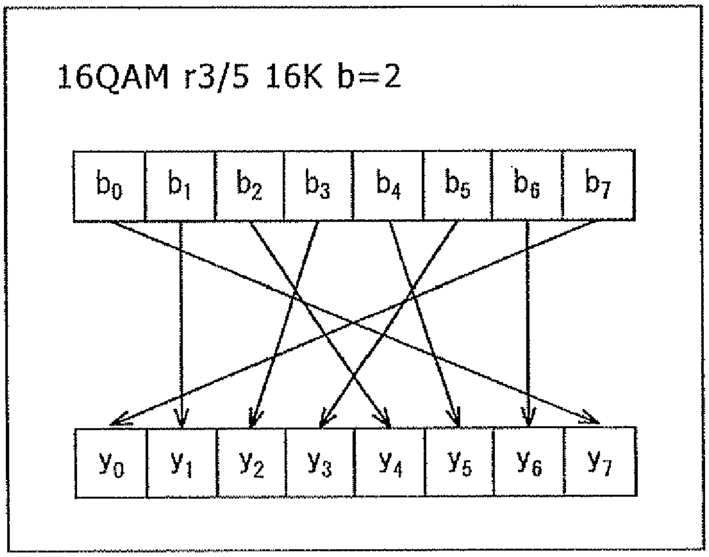

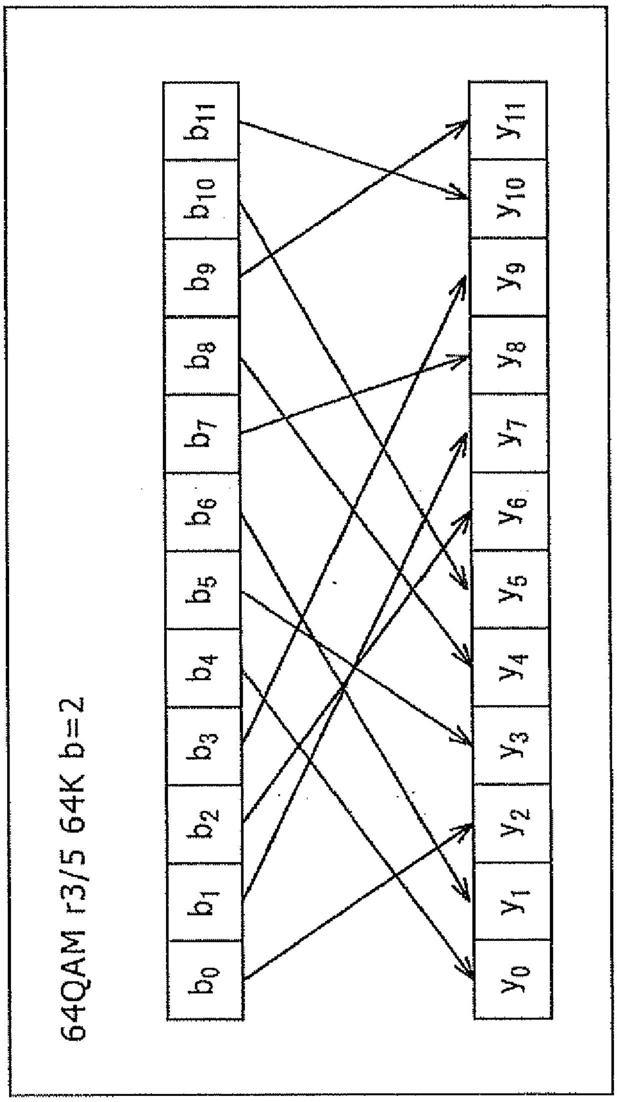
64QAM r3/5 64K b=2
$b_0$ $b_1$ $b_2$ $b_3$ $b_4$ $b_5$ $b_6$ $b_7$ $b_8$ $b_9$ $b_{10}$ $b_{11}$
$y_0$ $y_1$ $y_2$ $y_3$ $y_4$ $y_5$ $y_6$ $y_7$ $y_8$ $y_9$ $y_{10}$ $y_{11}$

FIG. 241

FIG.242

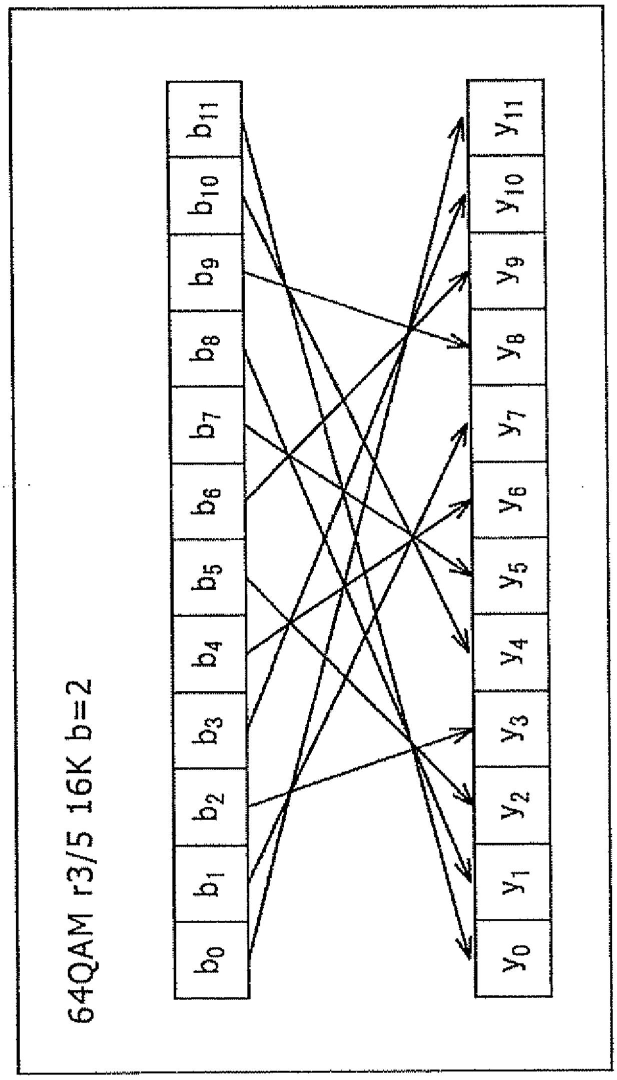
64QAM r3/5 16K b=2
$b_0$ $b_1$ $b_2$ $b_3$ $b_4$ $b_5$ $b_6$ $b_7$ $b_8$ $b_9$ $b_{10}$ $b_{11}$
$y_0$ $y_1$ $y_2$ $y_3$ $y_4$ $y_5$ $y_6$ $y_7$ $y_8$ $y_9$ $y_{10}$ $y_{11}$

FIG.243

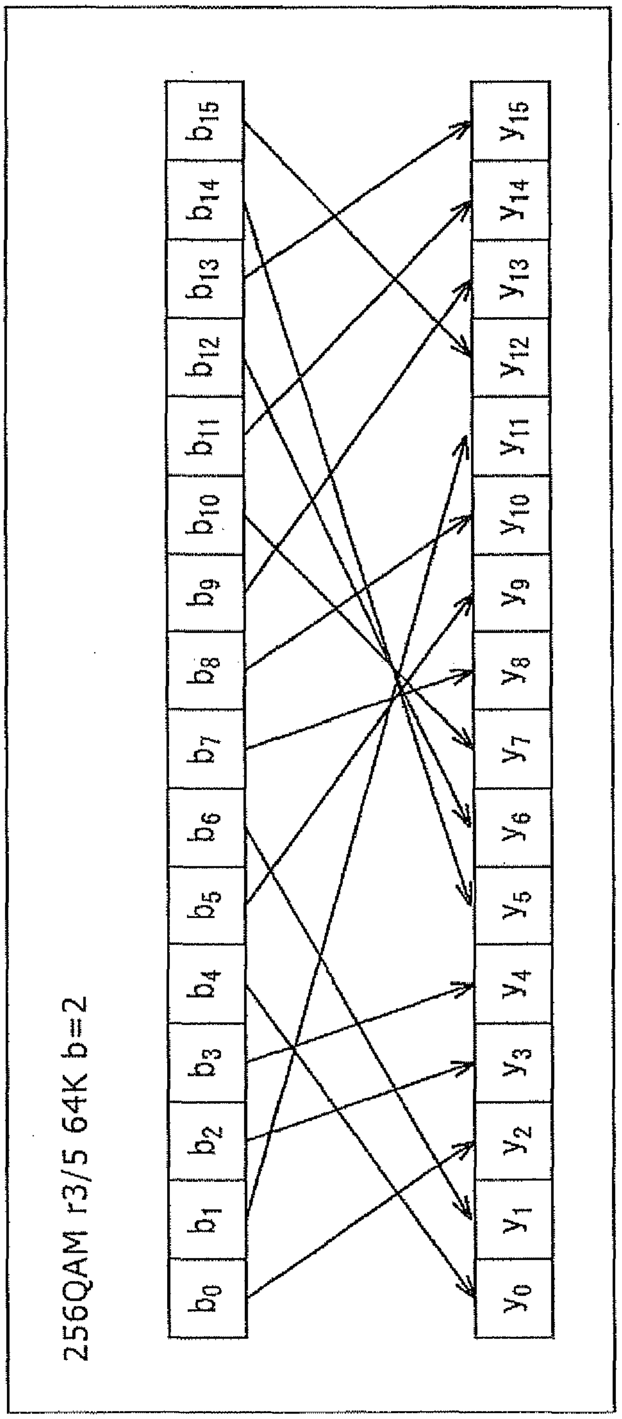

FIG.244

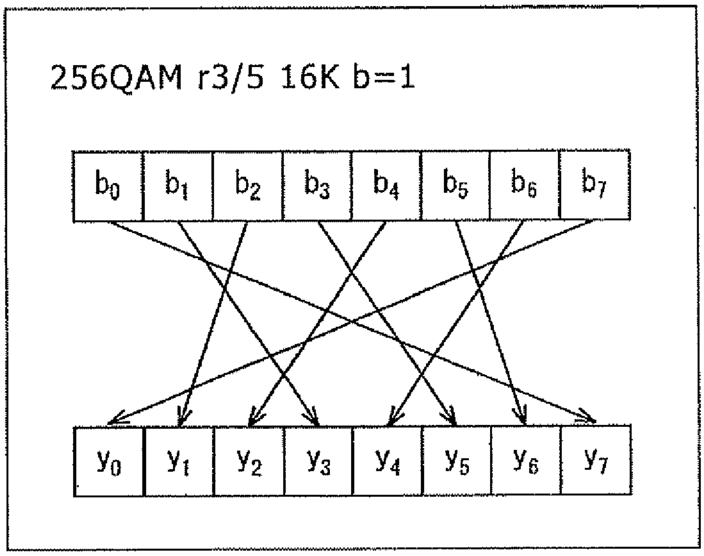

FIG.245

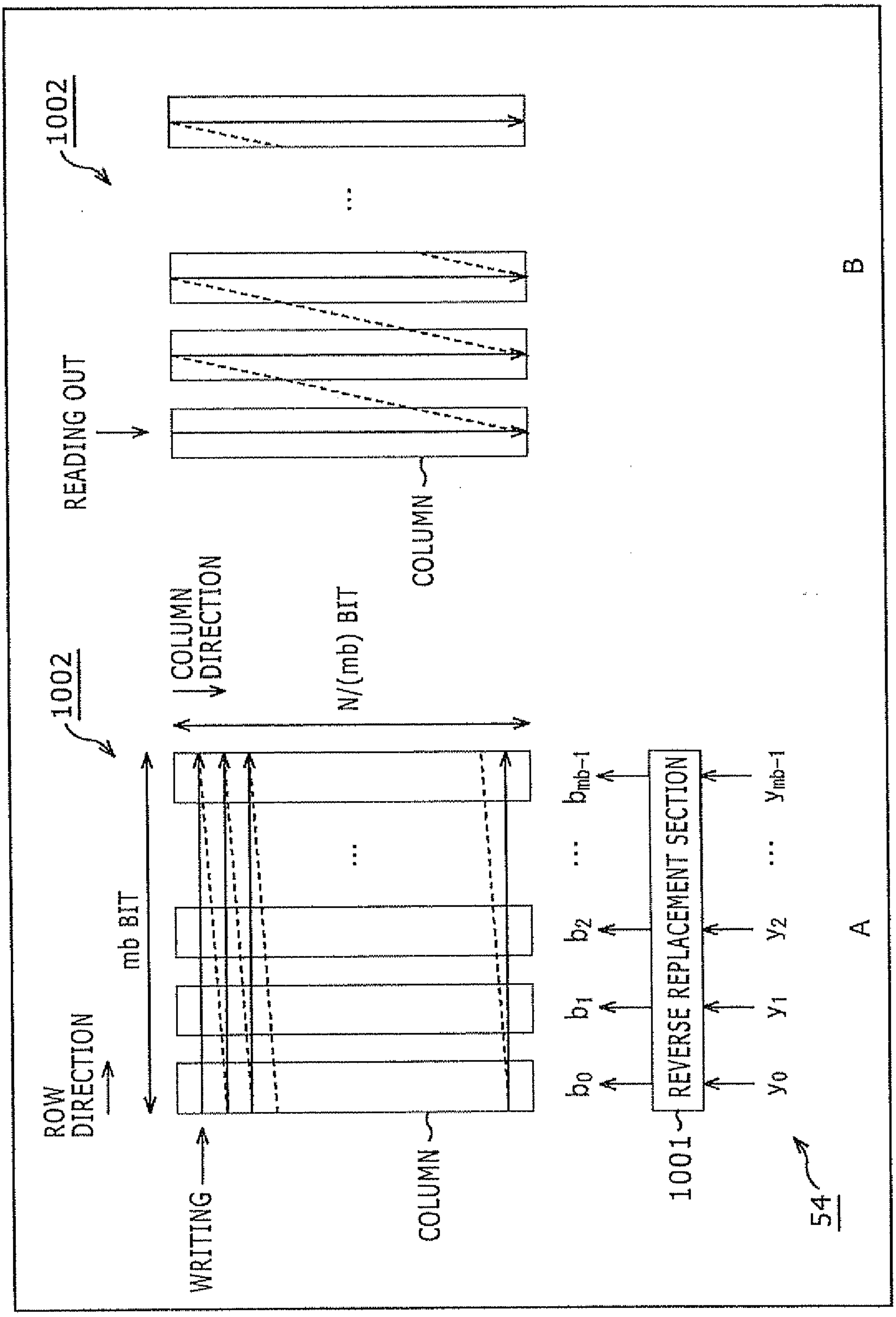
1002
READING OUT
COLUMN
B
1002
ROW DIRECTION
mb BIT
COLUMN DIRECTION
N/(mb) BIT
WRITING
COLUMN
$b_0$
$b_1$
$b_2$
...
$b_{mb-1}$
REVERSE REPLACEMENT SECTION
1001
$y_0$
$y_1$
$y_2$
...
$y_{mb-1}$
A
54

FIG.246

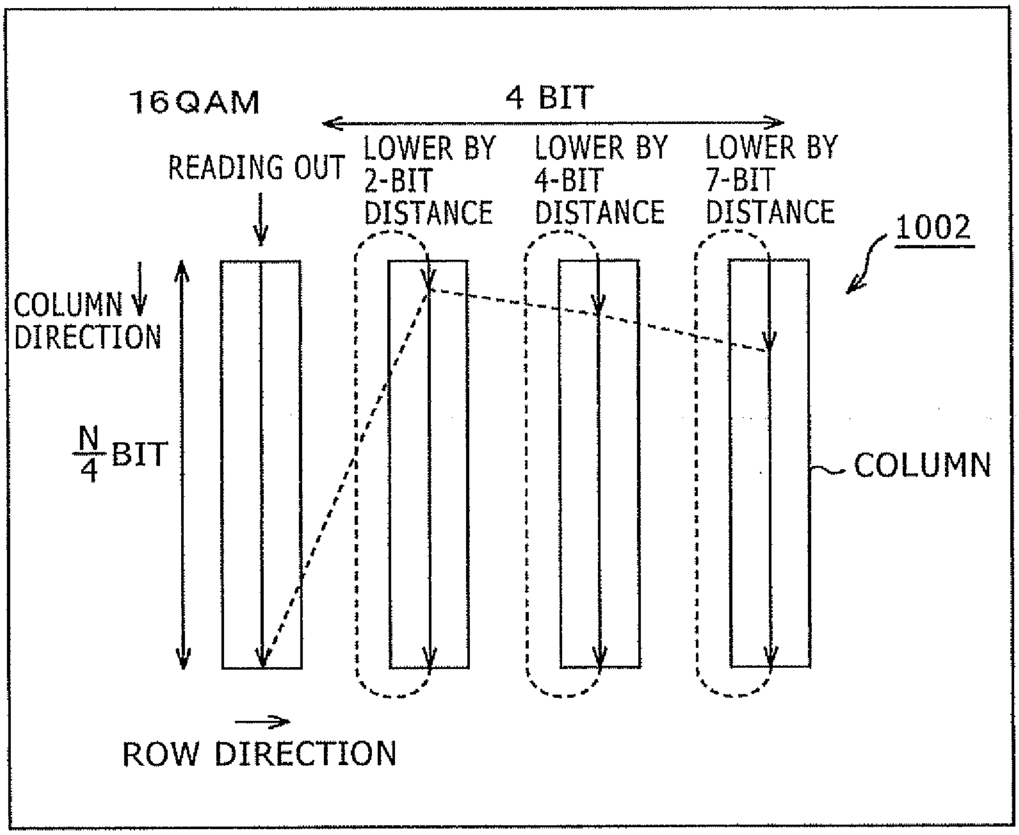
16QAM
4 BIT
READING OUT
LOWER BY 2-BIT DISTANCE
LOWER BY 4-BIT DISTANCE
LOWER BY 7-BIT DISTANCE
1002
COLUMN DIRECTION
N/4 BIT
COLUMN
ROW DIRECTION

FIG.247

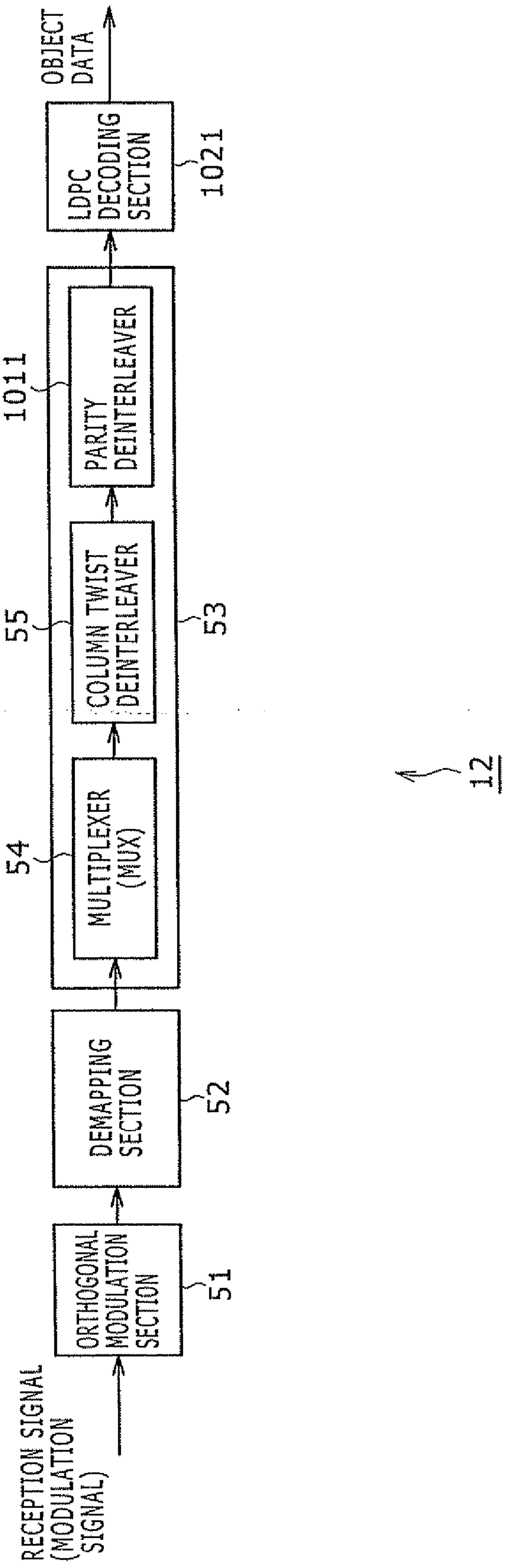
RECEPTION SIGNAL (MODULATION SIGNAL)
ORTHOGONAL MODULATION SECTION
51
DEMAPPING SECTION
52
MULTIPLEXER (MUX)
54
COLUMN TWIST DEINTERLEAVER
55
53
PARITY DEINTERLEAVER
1011
LDPC DECODING SECTION
1021
OBJECT DATA
12

FIG.248

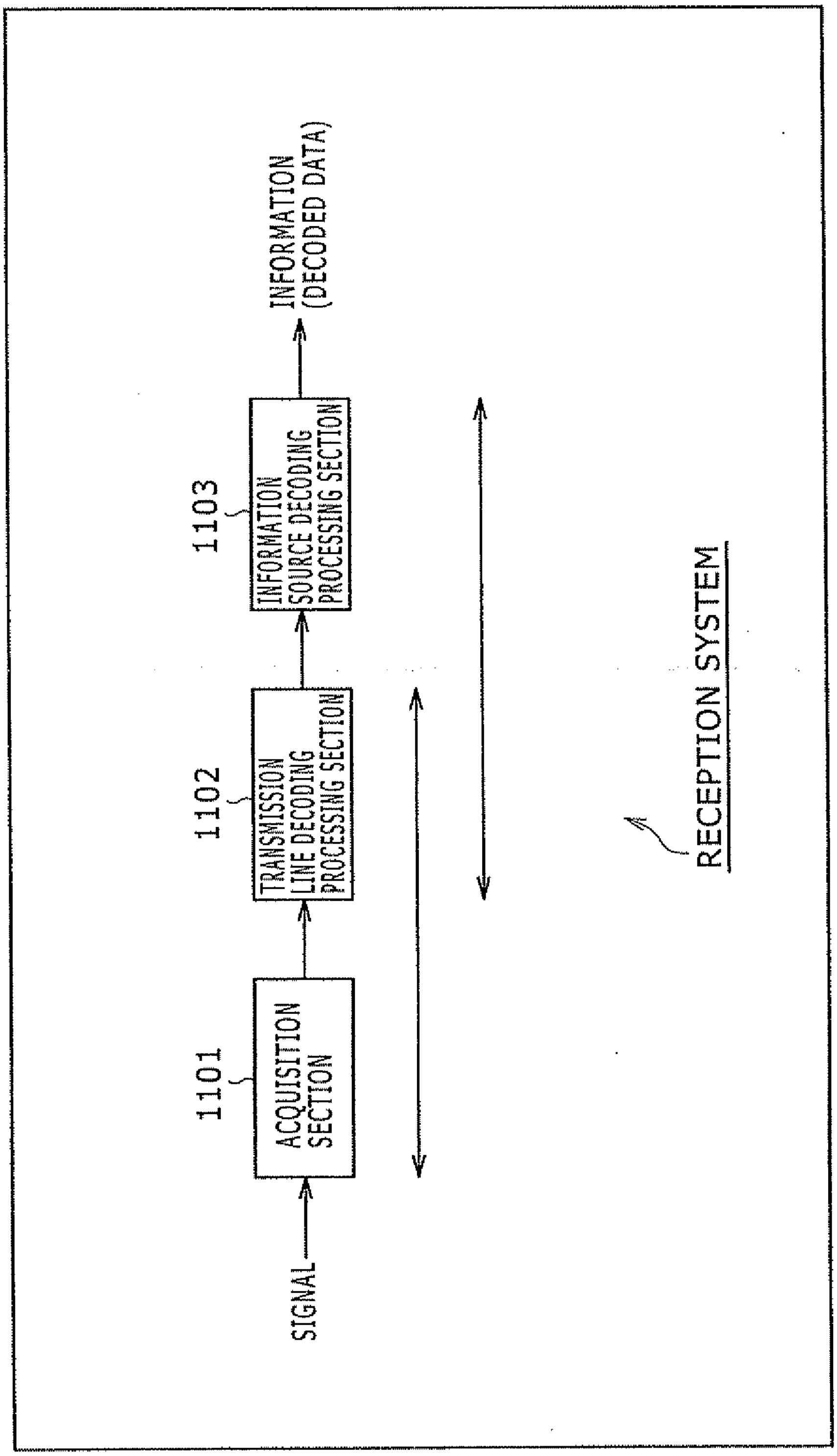
SIGNAL
1101
ACQUISITION SECTION
1102
TRANSMISSION LINE DECODING PROCESSING SECTION
1103
INFORMATION SOURCE DECODING PROCESSING SECTION
INFORMATION (DECODED DATA)
RECEPTION SYSTEM

FIG.249

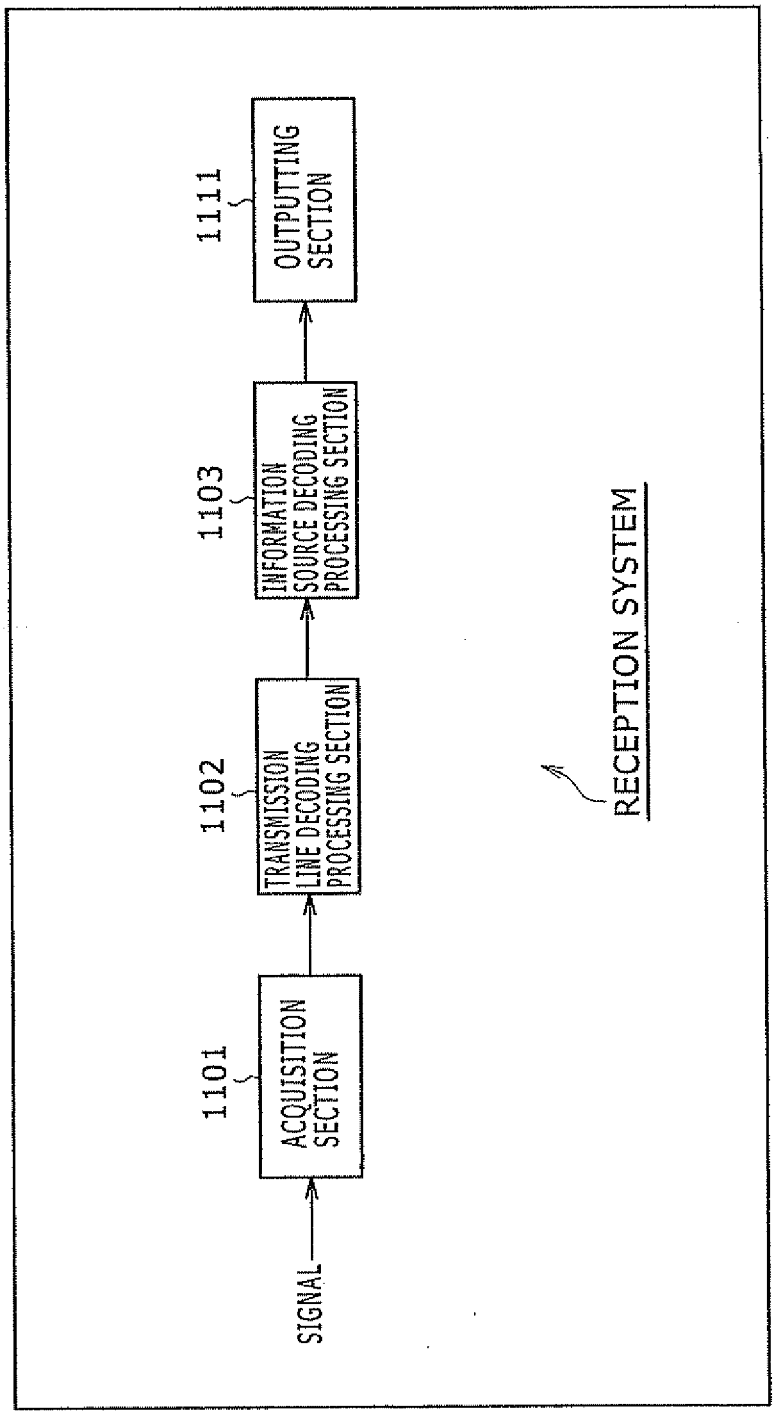
SIGNAL
1101
ACQUISITION SECTION
1102
TRANSMISSION LINE DECODING PROCESSING SECTION
1103
INFORMATION SOURCE DECODING PROCESSING SECTION
1111
OUTPUTTING SECTION
RECEPTION SYSTEM

FIG.250

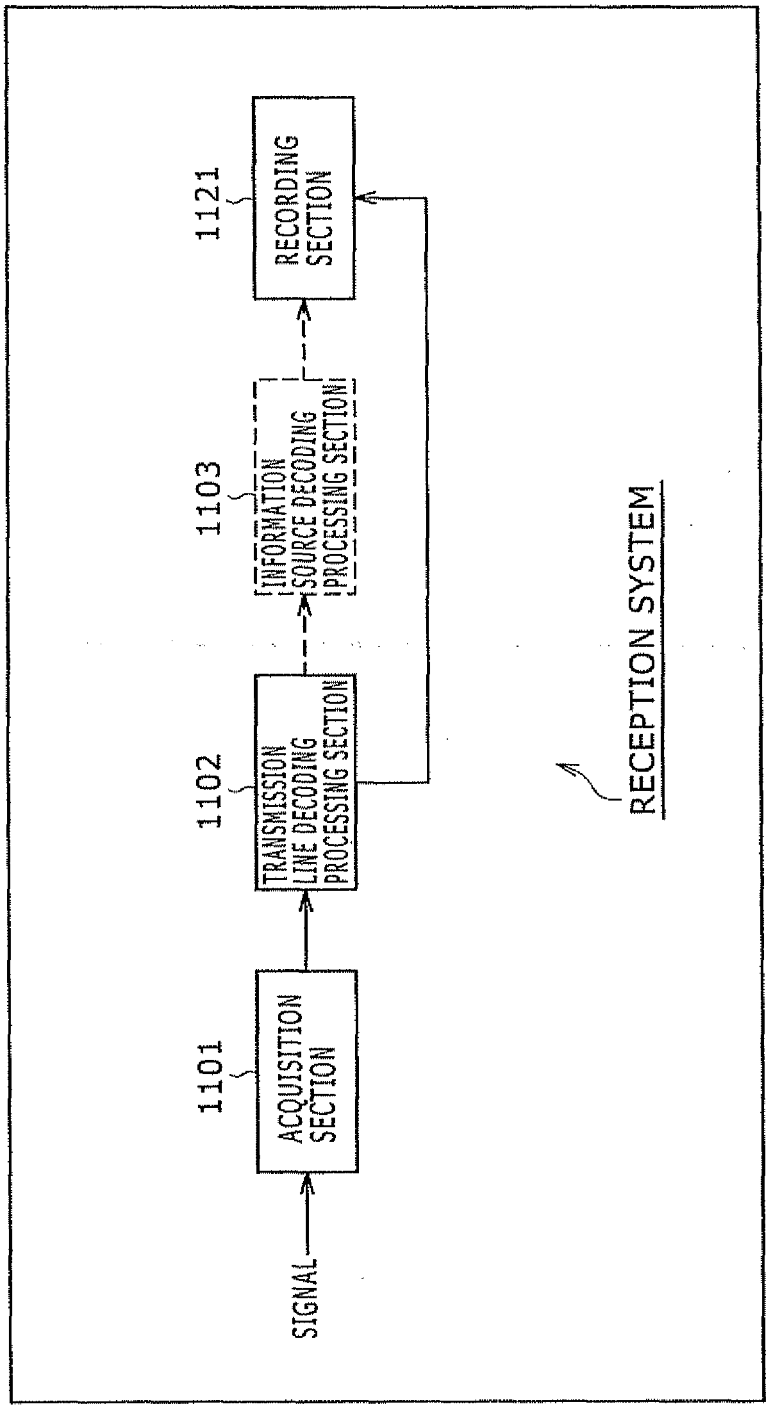
SIGNAL
1101
ACQUISITION SECTION
1102
TRANSMISSION LINE DECODING PROCESSING SECTION
1103
INFORMATION SOURCE DECODING PROCESSING SECTION
1121
RECORDING SECTION
RECEPTION SYSTEM

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2004343170 A

### Non-patent literature cited in the description

- **H. Jin. ; A. Khandekar ; R. J. McEliece.** Irregular Repeat-Accumulate Codes. *Proceedings of 2nd International Symposium on Turbo codes and Related Topics,* September 2000, 1-8